# EUROPEAN PATENT APPLICATION

(11) **EP 4 834 910 A2**
(43) Date of publication of application: **04.11.2026**
(21) Application number: 26175480.8
(22) Date of filing: 29.04.2026
(51) Int. Cl.: C07F 5/02, C09K 11/06, H10K 85/60

(54) **LIGHT-EMITTING ELEMENT, POLYCYCLIC COMPOUND FOR THE SAME, AND ELECTRONIC DEVICE INCLUDING THE SAME**

(30) Priority: 01.05.2025 JP 2025076048
(71) Applicant: Samsung Display Co., Ltd., Yongin-si, Gyeonggi-do (KR)
(72) Inventor: KUWABARA, Hirokazu, Yokohama-shi, 220-0011 (JP)
(74) Representative: Marks & Clerk LLP

(57) **Abstract**

A light-emitting element may include a first electrode, a second electrode on the first electrode, and a light emitting layer between the first electrode and the second electrode. The light emitting layer may include a first compound represented by Formula 1 and thus may exhibit long lifespan characteristics.

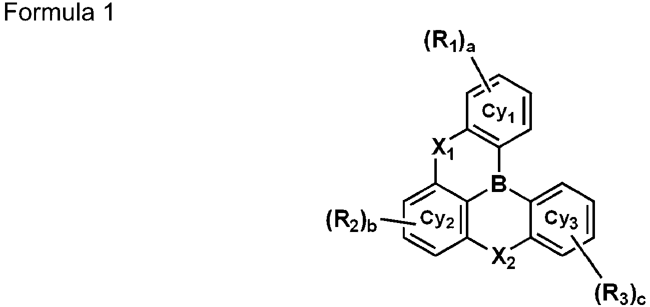

## Description

### BACKGROUND

### 1. Field

One or more embodiments of the present disclosure relate to a light-emitting element, a polycyclic compound used for the light-emitting element, and an electronic apparatus (electronic device) including the light-emitting element.

### 2. Description of the Related Art

As a display device in an electronic apparatus, organic electroluminescence display devices including organic electroluminescence elements are used. The organic electroluminescence display devices are display devices including self-luminous (self-emissive) light-emitting elements, in which holes and electrons are respectively injected into a light emitting layer from a first electrode and a second electrode, thereby causing an emission material in the light emitting layer to emit light to implement displaying.

For application of light-emitting elements to electronic devices or electronic apparatuses, improvements or enhancements in light efficiency and lifespan are desired or required, and development of materials for light-emitting elements that may stably achieve such requirements is increasingly demanded.

### SUMMARY

One or more aspects of embodiments of the present disclosure are directed toward a light-emitting element with an improved or enhanced lifespan.

One or more aspects of embodiments of the present disclosure are directed toward a polycyclic compound having improved or enhanced material stability.

One or more aspects of embodiments of the present disclosure are directed toward an electronic apparatus having excellent or suitable display quality by including the light-emitting element with an improved or enhanced lifespan.

Additional aspects of embodiments will be set forth in part in the description which follows and, in part, will be apparent from the description or may be learned by practice of the presented embodiments of the disclosure.

One or more embodiments of the present disclosure provide a polycyclic compound represented by Formula 1.

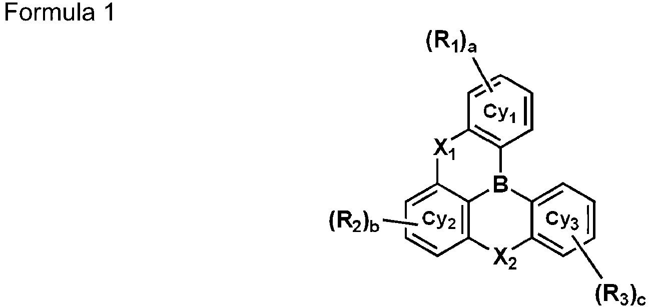

In Formula 1, X₁ and X₂ may each independently be O, S, or NRₓ, and at least one selected from among X₁ and X₂ may be NRₓ, and at least one selected from among rings Cy₁ to Cy₃ may be non-fused or fused to a structure of Formula 2:

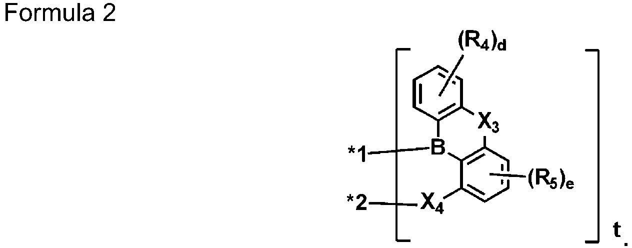

In Formula 2, t may be an integer of 0 to 2 (e.g., t may be 0 or 1), X₃ and X₄ may each independently be O, S, or NRₓ, and the rings Cy₁ to Cy₃ may be bonded at *1 and *2.

In Formula 1 and Formula 2, a, c, and d may each independently be an integer of 0 to 4, b and e may each independently be an integer of 0 to 3, R₁ to R₅ may each independently be a hydrogen atom, a deuterium atom, a halogen atom (e.g., F, Cl, Br, or I), a cyano group, a substituted or unsubstituted amino group, a substituted or unsubstituted alkyl group having 1 to 20 carbon atoms, a substituted or unsubstituted hydrocarbon ring having 6 to 30 ring-forming carbon atoms, or a substituted or unsubstituted heterocycle having 3 to 30 ring-forming carbon atoms, or may be bonded to an adjacent group to form a ring of Formula 3, and Rₓ may be represented by Formula 4-1 or Formula 4-2.

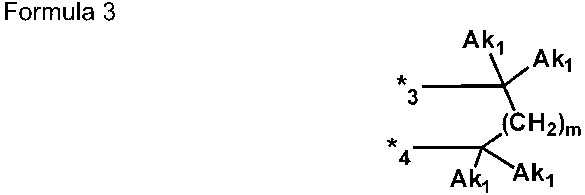

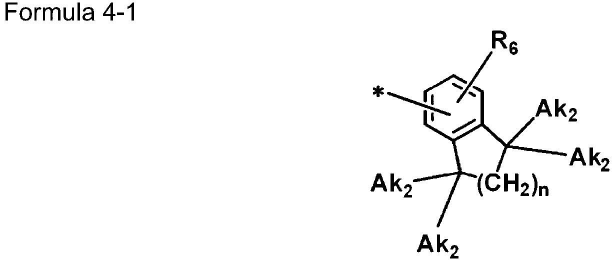

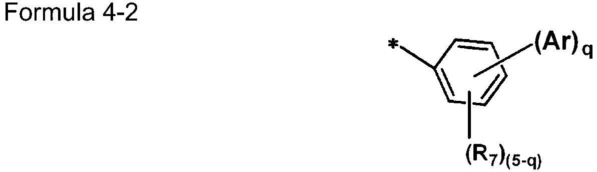

In Formula 3, Formula 4-1, and Formula 4-2, *3 and *4 may be portions to which an adjacent group is bonded, m and n may each independently be an integer of 1 to 3, Ak₁ and Ak₂ may each independently be a substituted or unsubstituted alkyl group having 1 to 10 carbon atoms, R₆ may be a hydrogen atom, a deuterium atom, a halogen atom, a substituted or unsubstituted amino group, a substituted or unsubstituted alkyl group having 1 to 10 carbon atoms, a substituted or unsubstituted aryl group having 6 to 30 ring-forming carbon atoms, or a substituted or unsubstituted heteroaryl group having 3 to 30 ring-forming carbon atoms, and if (e.g., when) Rₓ is represented by Formula 4-1 or if (e.g., when) t in Formula 2 is 0, R₆ may be a substituted or unsubstituted aryl group having 6 to 30 ring-forming carbon atoms, R₇ may be a hydrogen atom, a deuterium atom, a halogen atom, a cyano group, a substituted or unsubstituted alkyl group having 1 to 10 carbon atoms, or a substituted or unsubstituted aryl group having 6 to 30 ring-forming carbon atoms, and q may be an integer of 0 to 5. Ar may be a substituted or unsubstituted aryl group having 6 to 30 ring-forming carbon atoms or a substituted or unsubstituted heteroaryl group having 3 to 30 ring-forming carbon atoms. If (e.g., when), in Formula 2, t is 0, Rₓ may be represented by Formula 4-2, q may be an integer of 2 or greater (e.g., an integer of 2 to 5), and at least one selected from among R₁, R₂, and R₃ may be represented by Formula 4-1, if (e.g., when), in Formula 2, t is 1 and Rₓ is represented by Formula 4-2, q may be an integer of 2 or greater (e.g., an integer of 2 to 5), and if (e.g., when) all Rₓ are represented by Formula 4-2, at least one selected from among R₁ to R₅ may be represented by Formula 4-1 or at least one selected from among R₁ to R₅ may be bonded to an adjacent group to form a ring of Formula 3, and if (e.g., when), in Formula 2, t is 2 and all Rₓ are represented by Formula 4-2, at least one selected from among R₁ to R₅ may be represented by Formula 4-1 or at least one selected from among R₁ to R₅ may be bonded to an adjacent group to form a ring of Formula 3 above.

In one or more embodiments, Formula 1 may be represented by Formula 1A.

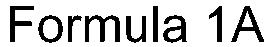

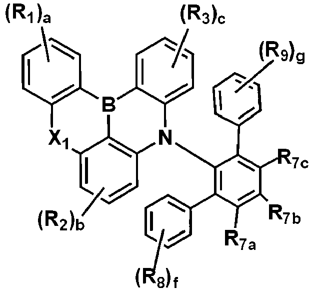

In Formula 1A, at least one selected from among R₁ to R₃ may be represented by Formula 4-1, R₆ in Formula 4-1 may be a substituted or unsubstituted aryl group having 6 to 30 ring-forming carbon atoms or a substituted or unsubstituted heteroaryl group having 3 to 30 ring-forming carbon atoms, f and g may each independently be an integer of 0 to 5, R₈, R₉, R₇ₐ, R_{7b}, and R_{7c} may each independently be a hydrogen atom, a deuterium atom, a halogen atom, a cyano group, a substituted or unsubstituted alkyl group having 1 to 10 carbon atoms, or a substituted or unsubstituted aryl group having 6 to 30 ring-forming carbon atoms, and X₁, R₁ to R₃, and a to c may each independently be the same as defined in Formula 1.

In one or more embodiments, Formula 1 may be represented by Formula 1B.

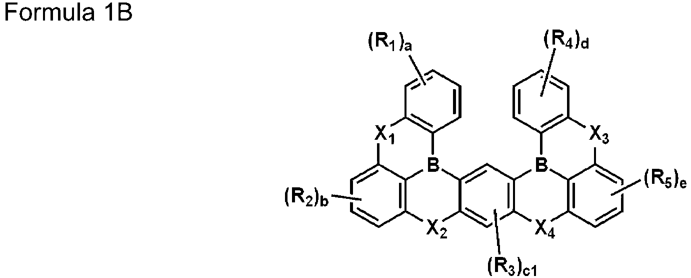

In Formula 1B, c1 may be an integer of 0 to 2, one or two selected from among X₁ to X₄ may be NRₓ, and the others may be O or S, and Rₓ, R₁ to R₅, and a, b, d, and e may each independently be the same as defined in Formula 1 and Formula 2.

In one or more embodiments, Formula 1B may be represented by any one selected from among Formulas 1B-1 to 1B-4.

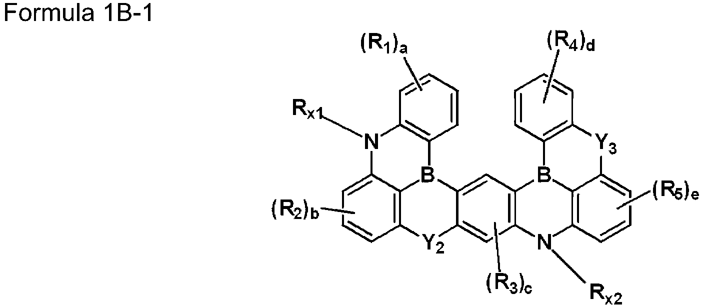

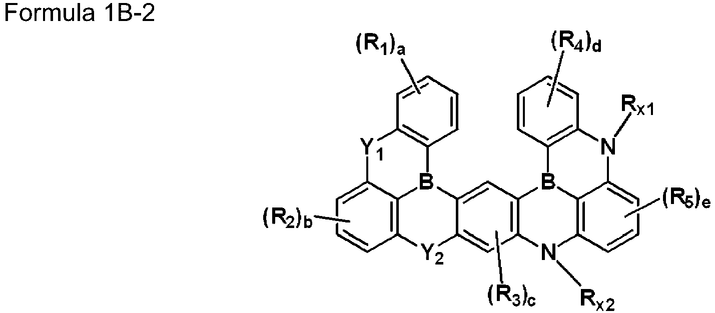

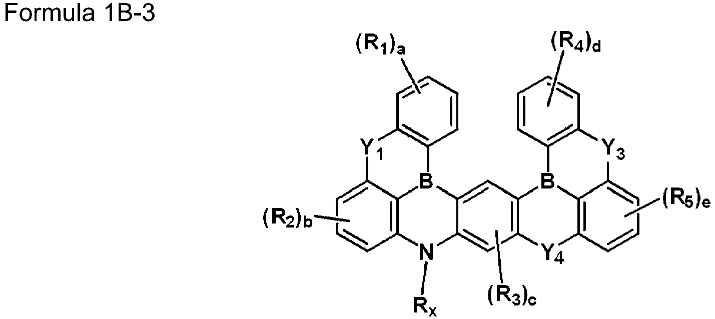

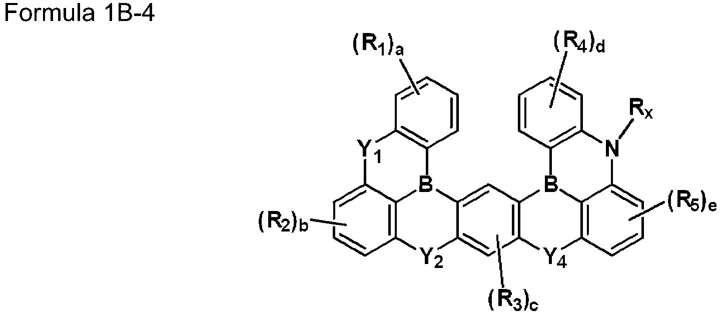

In Formulas 1B-1 to 1B-4, Y₁ to Y₄ may each independently be O or S, Rₓ₁ and Rₓ₂ may each independently be represented by Formula 4-1 or Formula 4-2, if (e.g., when) both (e.g., simultaneously) Rₓ₁ and Rₓ₂ are represented by Formula 4-2, at least one selected from among R₁ to R₅ may be represented by Formula 4-1 or at least one selected from among R₁ to R₅ may be bonded to an adjacent group to form a ring of Formula 3, and Rₓ, R₁ to R₅, and a to e may each independently be the same as defined in Formula 1 and Formula 2.

In one or more embodiments, Formula 1 may be represented by any one selected from among Formulas 1C-1 to 1C-3.

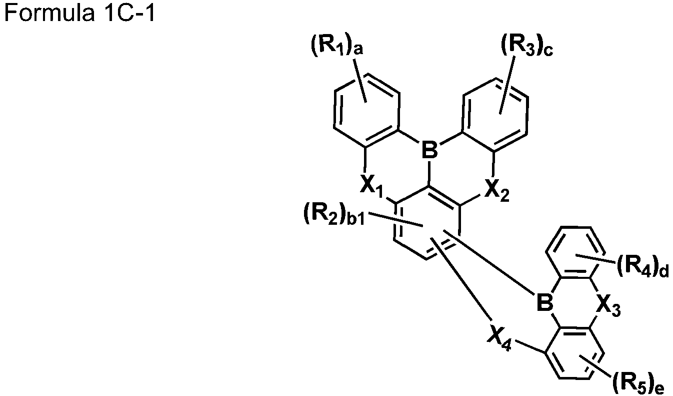

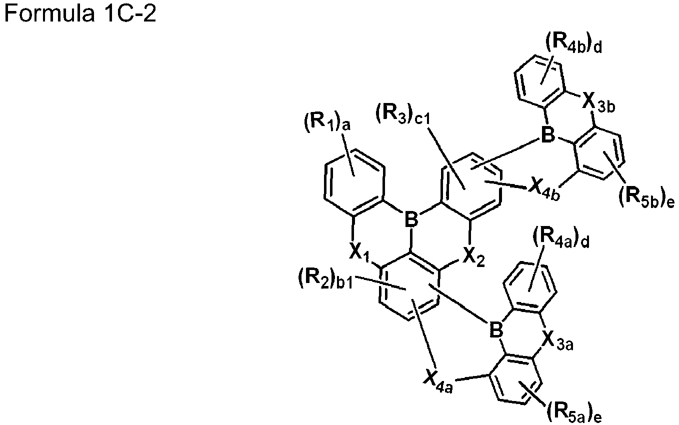

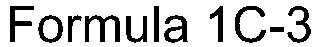

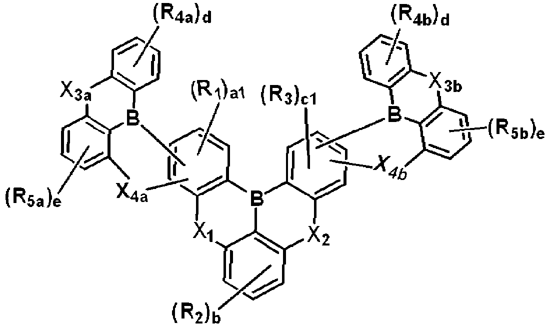

In Formulas 1C-2 and 1C-3, X₃ₐ, X_{3b}, X₄ₐ, and X_{4b} may each independently be O, S, or NRₓ, and R₄ₐ, R_{4b}, R₅ₐ, and R_{5b} may each independently be a hydrogen atom, a deuterium atom, a halogen atom, a cyano group, a substituted or unsubstituted amino group, a substituted or unsubstituted alkyl group having 1 to 20 carbon atoms, a substituted or unsubstituted hydrocarbon ring having 6 to 30 ring-forming carbon atoms, or a substituted or unsubstituted heterocycle having 3 to 30 ring-forming carbon atoms, or may be bonded to an adjacent group to form a ring of Formula 3, in Formulas 1C-1 and 1C-2, b1 may be 0 or 1, and c1 may be an integer of 0 to 2, and in Formulas 1C-1, 1C-2, and 1C-3, X₁ to X₄, R₁ to R₅, and a to e may each independently be the same as defined in Formula 1 and Formula 2.

In one or more embodiments, at least one hydrogen atom in Formula 1 and Formula 2 may be substituted with a deuterium atom.

In one or more embodiments, the compound represented by Formula 1 may be a blue emission dopant.

In one or more embodiments, the compound represented by Formula 1 may be a thermally activated delayed fluorescent compound.

One or more embodiments of the present disclosure provide a light-emitting element including a first electrode, a second electrode arranged on the first electrode, and a light emitting layer arranged between the first electrode and the second electrode and including the polycyclic compound according to one or more embodiments as a first compound.

In one or more embodiments, the light emitting layer may further include at least one selected from among a second compound represented by Formula HT-1 and a third compound represented by Formula ET-1.

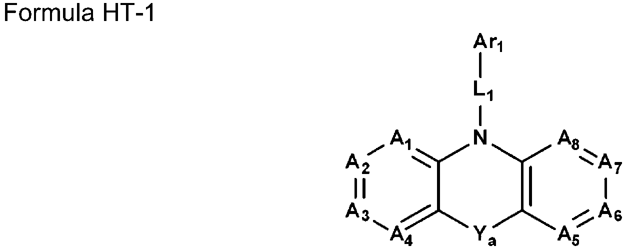

In Formula HT-1, A₁ to A₈ may each independently be N or CR₅₁, L₁ may be a direct linkage (e.g., a single covalent bond), a substituted or unsubstituted arylene group having 6 to 30 ring-forming carbon atoms, or a substituted or unsubstituted heteroarylene group having 2 to 30 ring-forming carbon atoms, Yₐ may be a direct linkage (e.g., a single covalent bond), CR₅₂R₅₃, or SiR₅₄R₅₅, Ar₁ may be a substituted or unsubstituted aryl group having 6 to 30 ring-forming carbon atoms or a substituted or unsubstituted heteroaryl group having 2 to 30 ring-forming carbon atoms, R₅₁ to R₅₅ may each independently be a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 ring-forming carbon atoms, a substituted or unsubstituted aryl group having 6 to 60 ring-forming carbon atoms, or a substituted or unsubstituted heteroaryl group having 2 to 60 ring-forming carbon atoms, or may be bonded to an adjacent group to form a ring.

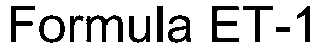

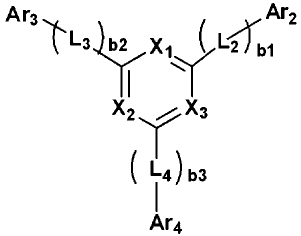

In Formula ET-1, at least one selected from among X₁ to X₃ may be N, and the others may be CR₅₆, R₅₆ may be a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, b1 to b3 may each independently be an integer of 0 to 10, Ar₂ to Ar₄ may each independently be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, L₂ to L₄ may each independently be a direct linkage (e.g., a single covalent bond), a substituted or unsubstituted arylene group having 6 to 30 ring-forming carbon atoms, or a substituted or unsubstituted heteroarylene group having 2 to 30 ring-forming carbon atoms.

In one or more embodiments, the light emitting layer may further include a fourth compound represented by Formula D-1.

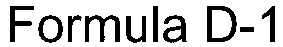

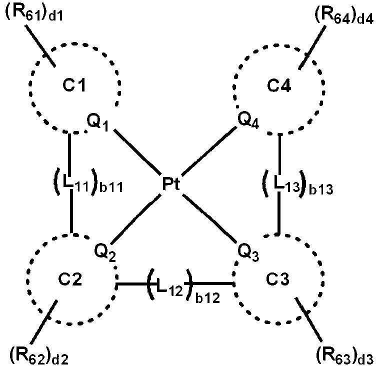

In Formula D-1, Q₁ to Q₄ may each independently be C or N, C1 to C4 may each independently be a substituted or unsubstituted hydrocarbon ring having 5 to 30 ring-forming carbon atoms or a substituted or unsubstituted heterocycle having 2 to 30 ring-forming carbon atoms, L₁₁ to L₁₃ may each independently be a direct linkage (e.g., a single covalent bond), *-O-*, *-S-*, 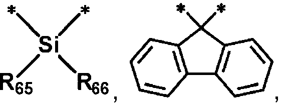 a substituted or unsubstituted alkylene group having 1 to 20 carbon atoms, a substituted or unsubstituted arylene group having 6 to 30 ring-forming carbon atoms, or a substituted or unsubstituted heteroarylene group having 2 to 30 ring-forming carbon atoms, b11 to b13 may each independently be 0 or 1, R₆₁ to R₆₆ may each independently be a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 ring-forming carbon atoms, a substituted or unsubstituted aryl group having 6 to 60 ring-forming carbon atoms, or a substituted or unsubstituted heteroaryl group having 2 to 60 ring-forming carbon atoms, and d1 to d4 may each independently be an integer of 0 to 4.

In one or more embodiments, the light emitting layer may be to emit (e.g., configured to emit) delayed fluorescence.

In one or more embodiments, the light emitting layer may be to emit (e.g., configured to emit) blue light.

In one or more embodiments of the present disclosure, an electronic apparatus includes a display module including a plurality of light-emitting elements, at least one selected from among the plurality of light-emitting elements includes a first electrode, a second electrode arranged on the first electrode, and a light emitting layer arranged between the first electrode and the second electrode and including the polycyclic compound according to one or more embodiments.

In one or more embodiments of the present disclosure, the electronic apparatus may further include at least one selected from among a processor, a memory, and a power module.

At least some of the above and other features of the invention are set out in the claims.

Accordingly, one or more embodiments of the present disclosure provide a light-emitting element including a polycyclic compound having a boron atom-containing fused ring core and at least one amine moiety, wherein the polycyclic compound is configured to exhibit thermally activated delayed fluorescence and to emit blue light with improved or enhanced material stability. In one or more embodiments, the light-emitting element includes a first electrode, a second electrode, and a light-emitting layer arranged between the first electrode and the second electrode, the light-emitting layer including the polycyclic compound as an emission dopant. One or more embodiments further provide an electronic apparatus (device) including the light-emitting element, wherein the electronic apparatus exhibits improved or enhanced emission efficiency and operational lifespan due to the enhanced stability and delayed fluorescence characteristics of the polycyclic compound. The foregoing embodiments provide technical advantages in light efficiency, color purity, and device reliability while remaining compatible with existing organic electroluminescence device architectures.

### BRIEF DESCRIPTION OF THE DRAWINGS

The accompanying drawings are included to provide a further understanding of embodiments of the subject matter of the present disclosure and are incorporated in and constitute a part of this specification. The drawings illustrate embodiments of the subject matter of the present disclosure and, together with the description, serve to explain principles of embodiments of the subject matter of the present disclosure. In the drawings:
FIG. 1 is a block diagram of an electronic apparatus according to one or more embodiments;
FIG. 2 illustrates schematic views of electronic apparatuses according to one or more embodiments;
FIG. 3 is a plan view illustrating a display module according to one or more embodiments;
FIG. 4 is a cross-sectional view illustrating a portion taken along the line I-I' in FIG. 3;
FIG. 5 is a cross-sectional view schematically illustrating a light-emitting element according to one or more embodiments;
FIG. 6 is a cross-sectional view schematically illustrating a light-emitting element according to one or more embodiments;
FIG. 7 is a cross-sectional view schematically illustrating a light-emitting element according to one or more embodiments;
FIG. 8 is a cross-sectional view schematically illustrating a light-emitting element according to one or more embodiments;
FIG. 9 is a cross-sectional view schematically illustrating a light-emitting element according to one or more embodiments;
FIG. 10 is a cross-sectional view illustrating a display module according to one or more embodiments;
FIG. 11 is a cross-sectional view illustrating a display module according to one or more embodiments;
FIG. 12 is a cross-sectional view illustrating a display module according to one or more embodiments;
FIG. 13 is a cross-sectional view illustrating a display module according to one or more embodiments;
FIG. 14 is a perspective view of an electronic apparatus according to one or more embodiments;
FIG. 15 is a perspective view of an electronic apparatus according to one or more embodiments; and
FIG. 16 is a view illustrating an interior of a vehicle in which an electronic apparatus according to one or more embodiments is arranged.

### DETAILED DESCRIPTION

The subject matter of the present disclosure will be described more fully hereinafter with reference to the accompanying drawings, in which embodiments of the present disclosure are shown. As those skilled in the art would realize, the described embodiments may be modified in one or more suitable different ways, all without departing from the scope of the present disclosure. The drawings and description are to be regarded as illustrative in nature and not restrictive. Like reference numerals designate like elements throughout the attached drawings and the written description, and duplicative descriptions thereof may not be provided in the specification.

The utilization of "may" if (e.g., when) describing embodiments of the present disclosure refers to "one or more embodiments of the present disclosure."

In the context of the present application and unless otherwise defined, the terms "use," "using," and "used" may be considered synonymous with the terms "utilize," "utilizing," and "utilized," respectively.

Throughout the present disclosure, the expressions, such as "at least one of," "one of," and "selected from," if (e.g., when) preceding a list of elements, modify the entire list of elements and do not modify the individual elements of the list. For example, "at least one of a, b, or c," "at least one selected from among a, b, and c," "at least one selected from among a to c," and/or the like indicates only a, only b, only c, both (e.g., simultaneously) a and b, both (e.g., simultaneously) a and c, both (e.g., simultaneously) b and c, all of a, b, and c, or variations thereof.

In the present disclosure, it will be understood that if (e.g., when) an element (or a region, a layer, a portion, and/or the like) is referred to as being "on," "above" "connected to," or "coupled to" another element, it may be directly on, directly above, directly connected to, or directly coupled to the other element, or intervening elements may be arranged therebetween. In contrast, if (e.g., when) an element is referred to as being "directly on" or "directly above" another element, there are no intervening elements present therebetween.

In the drawings, the thickness, the ratio, and the size of the element may be exaggerated for effective description of the technical contents.

As used herein, the term "and/or" or "or" includes any and all combinations of one or more of the associated listed elements.

It will be understood that, although the terms "first," "second," and/or the like may be used herein to describe one or more suitable elements, the elements are not to be limited by these terms. These terms are only used to distinguish one element, component, region, layer, or section from another element, component, region, layer, or section. For instance, a first element, a first component, a first region, a first layer, or a first section discussed may be termed a second element, a second component, a second region, a second layer, or a second section without departing from the scope of the present disclosure. Similarly, a second element, a second component, a second region, a second layer, or a second section may be termed a first element, a first component, a first region, a first layer, or a first section.

In the present disclosure, the singular expressions "a," "an," and "the" are intended to include the plural forms as well, unless the context clearly indicates otherwise.

In the present disclosure, the terms "below," "under," "on the lower side," "above," "over," "on the upper side," and/or the like may be used to describe the relationships between the elements illustrated in the drawings. These terms are relative concepts and are described on the basis of the directions indicated in the drawings.

In the present disclosure, it will be understood that the term "comprise(s)/comprising," "include(s)/including," or "have/has/having" specifies the presence of stated features, integers, steps (e.g., acts or tasks), operations, elements, and/or components, but do not preclude the presence or addition of one or more other features, integers, steps (e.g., acts or tasks), operations, elements, components, and/or groups thereof. Also, the terms "comprise(s)/comprising," "include(s)/including," "have/has/having," or similar terms include or support the terms "consisting of" and "consisting essentially of," indicating the presence of stated features, integers, steps (e.g., acts or tasks), operations, elements, and/or components, without or essentially without the presence of other features, integers, steps (e.g., acts or tasks), operations, elements, components, and/or groups thereof.

As utilized herein, the terms "substantially," "about," or similar terms are used as terms of approximation and not as terms of degree and are intended to account for the inherent deviations in measured or calculated values that would be recognized by those of ordinary skill in the art. "About" as used herein is inclusive of the stated value and refers to as being within an acceptable range of deviation for the particular value as determined by one of ordinary skill in the art, considering the measurement in question and the error associated with measurement of the particular quantity (e.g., the limitations of the measurement system). For example, "about" may refer to as being within one or more standard deviations or within ±30%, ±20%, ±10%, or ±5% of the stated value. Also, it should be understood that, even if (e.g., when) the terms "about," "approximately," or "substantially" are not expressly recited in a given element (e.g., a claim element), the scope of such element is intended to include variations that are insubstantial or within the understanding of one of ordinary skill in the art. For example, numerical values and ranges provided herein are intended to include tolerances and measurement uncertainties that would be recognized by those skilled in the art, and the elements (e.g., claim elements) should be construed accordingly to encompass such equivalents.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, for example, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in the present disclosure is intended to include all higher numerical limitations subsumed therein. Accordingly, Applicant reserves the right to amend the disclosure, including the claims, to expressly recite any sub-range subsumed within the ranges expressly recited herein.

In the context of the present disclosure and unless otherwise defined, plan view is an orthographic projection of a three-dimensional object from the position of a horizontal plane that intersects the object. For example, it is a top-down view, showing the layout and spatial relationships of one or more elements within the object or structure. A plan view based on a z-axis (thickness) direction refers to a top-down view of the object, as if (e.g., when) looking directly down onto the surface from above. In this context, the z-axis direction is perpendicular or normal to the horizontal plane defined by x-axis and y-axis directions. For example, as utilized herein, "opposite to" refers to being arranged on opposite sides of a spatial region if (e.g., when) viewed in plan (x-y plane), unless otherwise specified.

Unless otherwise defined, all terms (including technical and scientific terms) used herein have substantially the same meaning as generally understood by one of ordinary skill in the art to which the present disclosure belongs. It will be further understood that terms, such as those defined in generally used dictionaries, should be interpreted as having a meaning that is consistent with their meaning in the context of the relevant art and will not be interpreted in an idealized or overly formal sense unless expressly so defined herein.

In the present disclosure, the term "substituted or unsubstituted" may refer to being substituted or unsubstituted with at least one substituent selected from the group consisting of a deuterium atom, a halogen atom (e.g., F, Cl, Br, or I), a cyano group, a nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group. Also, each of the exemplified substituents may be substituted or unsubstituted. For example, a biphenyl group may be interpreted as an aryl group and may also be interpreted as a phenyl group substituted with a phenyl group.

In the present disclosure, the term "bonded to an adjacent group to form a ring" may indicate that one is bonded to an adjacent group to form a substituted or unsubstituted hydrocarbon ring or a substituted or unsubstituted heterocycle. The hydrocarbon ring may include an aliphatic hydrocarbon ring and an aromatic hydrocarbon ring. The heterocycle may include an aliphatic heterocycle and an aromatic heterocycle. The hydrocarbon ring and the heterocycle may be monocyclic or polycyclic. Also, a ring formed via mutual bonding may connect with another ring to form a spiro structure.

In the present disclosure, the term "an adjacent group" may indicate a substituent substituted for an atom which is directly connected to an atom substituted with the corresponding substituent, another substituent substituted for an atom which is substituted with the corresponding substituent or a substituent sterically closest to the corresponding substituent. For example, two methyl groups in 1,2-dimethylbenzene may be interpreted as mutually "adjacent groups" and two ethyl groups in 1,1-diethylcyclopentane may be interpreted as mutually "adjacent groups". Also, two methyl groups in 4,5-dimethylphenanthrene may be interpreted as "adjacent rings" to each other.

In the present disclosure, examples of a halogen atom include a fluorine atom (F), a chlorine atom (CI), a bromine atom (Br), or an iodine atom (I).

In the present disclosure, an alkyl group may be a linear chain or a branched chain. The number of carbon atoms of the alkyl group may be in the range of 1 to 60, 1 to 30, 1 to 20, 1 to 10, or 1 to 6. Examples of the alkyl group may include a methyl group, an ethyl group, an isopropyl group, an n-butyl group, an s-butyl group, a t-butyl group, an i-butyl group, a 2-ethylbutyl group, a 3,3-dimethylbutyl group, an n-pentyl group, an i-pentyl, a neopentyl group, a t-pentyl group, an 1-methylpentyl group, a 3-methylpentyl group, a 2-ethylpentyl group, a 4-methyl-2-pentyl group, an n-hexyl group, an 1-methylhexyl group, a 2-ethylhexyl group, a 2-butylhexyl group, an n-heptyl group, an 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-icosyl group, a 2-ethylicosyl group, a 2-butylicosyl group, a 2-hexylicosyl group, a 2-octylicosyl group, an n-henicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, and a n-triacontyl group, and/or the like, but embodiments of the present disclosure are not limited thereto.

In the present disclosure, a cycloalkyl group may refer to a cyclic alkyl group. The number of carbon atoms of the cycloalkyl group may be in the range of 3 to 60, 3 to 30, 3 to 20, or 3 to 10. Examples of the cycloalkyl group may include a cyclopropyl group, a cyclobutyl group, a cyclopentyl group, a cyclohexyl group, a 4-methylcyclohexyl group, a 4-t-butylcyclohexyl group, a cycloheptyl group, a cyclootyl group, a cyclononyl group, a cyclodecyl group, a norbornyl group, a 1-adamantyl group, a 2-adamantyl group, an isobornyl group, a bicycloheptyl group, and/or the like, but embodiments of the present disclosure are not limited thereto.

In the present disclosure, an alkenyl group indicates a hydrocarbon group including one or more carbon-carbon double bonds in the middle or at the terminal of an alkyl group having 2 or more carbon atoms. The alkenyl group may be a linear chain or a branched chain. The number of carbon atoms is not particularly limited, but the number of carbon atoms may be in the range of 2 to 60, 2 to 30, 2 to 20, 2 to 10, or 2 to 6. Examples of the alkenyl group may include a vinyl group, a 1-butenyl group, a 1-pentenyl group, a 1,3-butadienyl aryl group, a styrenyl group, a styrylvinyl group, and/or the like, but embodiments of the present disclosure are not limited thereto.

In the present disclosure, an alkynyl group indicates a hydrocarbon group including one or more carbon-carbon triple bonds in the middle or at the terminal of an alkyl group having 2 or more carbon atoms. The alkynyl group may be a linear chain or a branched chain. The number of carbon atoms is not particularly limited, but may be in the range of 2 to 30, 2 to 20, 2 to 10, or 2 to 6. Examples of the alkynyl group may include an ethynyl group, a propynyl group, and/or the like, but embodiments of the present disclosure are not limited thereto.

In the present disclosure, a hydrocarbon ring group indicates an optional functional group or substituent derived from an aliphatic hydrocarbon ring. The hydrocarbon ring group may be a saturated hydrocarbon ring group having 5 to 20 ring-forming carbon atoms.

In the present disclosure, an aryl group indicates an optional functional group or substituent derived from an aromatic hydrocarbon ring. The aryl group may be a monocyclic aryl group or polycyclic aryl group. The aryl group may have the number of ring-forming carbon atoms in the range of 6 to 60, 6 to 30, 6 to 20, or 6 to 15. Examples of the aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, and/or the like, but embodiments of the present disclosure are not limited thereto.

In the present disclosure, a fluorenyl group may be substituted, and two substituents may be bonded to each other to form a spiro structure. Examples in which the fluorenyl group is substituted are provided herein. However, the fluorenyl group is not limited thereto.

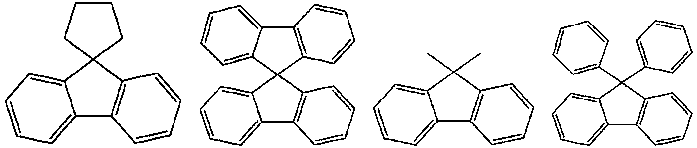

In the present disclosure, a heterocyclic group indicates a functional group or a substituent derived from a ring containing one or more selected from among B, O, N, P, S, Si, and Se as heteroatoms. The heterocyclic group may include an aliphatic heterocyclic group and an aromatic heterocyclic group. The aromatic heterocyclic group may be a heteroaryl group. The aliphatic heterocyclic group and the aromatic heterocyclic group may be monocyclic or polycyclic.

In the present disclosure, a heterocyclic group may contain one or more selected from among B, O, N, P, S, Si, and Se as heteroatoms. If (e.g., when) the heterocyclic group contains two or more heteroatoms, the two or more heteroatoms may be the same or different from each other. The heterocyclic group may be a monocyclic heterocyclic group or a polycyclic heterocyclic group and may include a heteroaryl group. The heteroaryl group may have the number of ring-forming carbon atoms in the range of 2 to 60, 2 to 30, 2 to 20, 2 to 10, 3 to 60, 3 to 30, 3 to 20, or 3 to 10.

In the present disclosure, an aliphatic heterocyclic group may contain one or more selected from among B, O, N, P, S, Si and Se as heteroatoms. The number of ring-forming carbon atoms in the aliphatic heterocyclic group may be in the range of 2 to 30, 2 to 20, 2 to 10, 3 to 30, 3 to 20, or 3 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, and/or the like, but embodiments of the present disclosure are not limited thereto.

In the present disclosure, a heteroaryl group may contain one or more selected from among B, O, N, P, S, Si, and Se as heteroatoms. If (e.g., when) the heteroaryl group includes two or more heteroatoms, the two or more heteroatoms may be the same or different from each other. The heteroaryl group may be a monocyclic heterocyclic group or a polycyclic heterocyclic group. The heteroaryl group may have the number of ring-forming carbon atoms in the range of 2 to 60, 2 to 30, 2 to 20, 2 to 10, 3 to 60, 3 to 30, 3 to 20, or 3 to 10. Examples of the heteroaryl group may include a thiophene group, a furan group, a pyrrole group, an imidazole group, a pyridine group, a bipyridine group, a pyrimidine group, a triazine group, a triazole group, an acridyl group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzimidazole group, a benzothiazole group, a benzocarbazole, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, and/or the like, but embodiments of the present disclosure are not limited thereto.

In the present disclosure, the details of the aryl group provided herein may be similarly applied to an arylene group, except that the arylene group is a divalent group. The details of the heteroaryl group provided herein may be similarly applied to a heteroarylene group, except that the heteroarylene group is a divalent group.

In the present disclosure, a silyl group may include an alkyl silyl group and an aryl silyl group. Examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and/or the like, but embodiments of the present disclosure are not limited thereto.

In the present disclosure, the number of carbon atoms of carbonyl group is not particularly limited, but may be in the range of 1 to 40, 1 to 30, 1 to 20, 1 to 10, or 1 to 6. For example, the carbonyl group may have a structure shown herein, but embodiments of the present disclosure are not limited thereto.

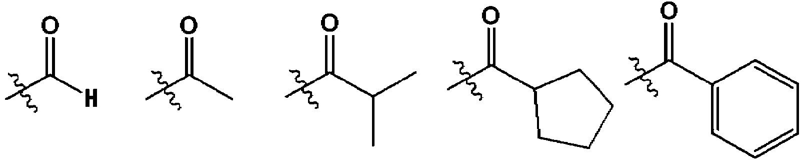

In the present disclosure, the number of carbon atoms of sulfinyl group and sulfonyl group is not particularly limited, but may be in the range of 1 to 30, 1 to 20, 1 to 10, or 1 to 6. The sulfinyl group may include an alkyl sulfinyl group and an aryl sulfinyl group. The sulfonyl group may include an alkyl sulfonyl group and an aryl sulfonyl group.

In the present disclosure, a thio group may include an alkyl thio group and an aryl thio group. The thio group may indicate a group in which the alkyl group or the aryl group, described herein, is bonded to a sulfur atom. Examples of the thio group may include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, and/or the like, but embodiments of the present disclosure are not limited thereto.

In the present disclosure, an oxy group may indicate a group in which the alkyl group or the aryl group, described herein, is bonded to an oxygen atom. The oxy group may include an alkoxy group and an aryl oxy group. The alkoxy group may be a linear chain, a branched chain, or a cyclic chain. The number of carbon atoms of alkoxy group is not particularly limited but may be, for example, in the range of 1 to 20 1 to 10, or 1 to 6. Examples of the oxy group may include methoxy, ethoxy, n-propoxy, isopropoxy, butoxy, pentyloxy, hexyloxy, octyloxy, nonyloxy, decyloxy, benzyloxy, and/or the like, but embodiments of the present disclosure are not limited thereto.

In the present disclosure, a boron group may indicate a group in which the alkyl group or the aryl group, described herein, is bonded to a boron atom. The boron group may include an alkyl boron group and an aryl boron group. Examples of the boron group may include a dimethylboron group, a diethylboron group, a t-butylmethylboron group, a diphenylboron group, a phenylboron group, and/or the like, but embodiments of the present disclosure are not limited thereto.

In the present disclosure, the number of carbon atoms of amine group is not particularly limited, but may be in the range of 1 to 30, 1 to 20, 1 to 10, or 1 to 6. The amine group may include an alkyl amine group and an aryl amine group. Examples of the amine group may include a methylamine group, a dimethylamine group, a phenylamine group, a diphenylamine group, a naphthylamine group, a 9-methyl-anthracenylamine group, and/or the like, but embodiments of the present disclosure are not limited thereto.

In the present disclosure, the alkyl group in an alkylthio group, an alkylsulfoxy group, an alkylaryl group, an alkylamino group, an alkylboron group, an alkyl silyl group, and an alkyl amine group may be the same as the examples of the alkyl group described herein.

In the present disclosure, the aryl group in an aryloxy group, an arylthio group, an arylsulfoxy group, an aryl amino group, an arylboron group, an aryl silyl group, and an aryl amine group may be the same as the examples of the aryl group described herein.

In the present disclosure, a direct linkage may indicate a single bond (e.g., a single covalent bond).

In the present disclosure, " 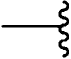 " and "-* " refer to connection positions.

Hereinafter, one or more embodiments according to the present disclosure will be described with reference to the accompanying drawings.

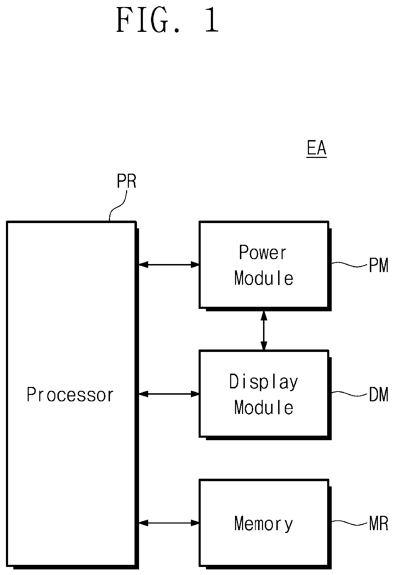

FIG. 1 is a block diagram of an electronic apparatus (device) according to one or more embodiments. Referring to FIG. 1, an electronic apparatus EA according to one or more embodiments may include a display module DM, a processor PR, a memory MR, and a power module PM.

The processor PR may include at least one selected from among a central processing unit (CPU), an application processor (AP), a graphic processing unit (GPU), a communication processor (CP), an image signal processor (ISP), and a controller.

In the memory MR, data information desired or needed for an operation of the processor PR or the display module DM may be stored. If (e.g., when) the processor PR executes an application stored in the memory MR, an image data signal and/or an input control signal are/is transmitted to the display module DM, and the display module DM may process the received signal and output image information through a display screen. The display module DM may include a display panel to display an image.

The power module PM may include a power supply module, such as a power adapter or a battery device, and a power conversion module that converts the supplied power by the power supply module to generate power desired or needed for operations of the electronic apparatus EA.

At least one selected from among the components of the electronic apparatus EA described herein may be included in a display module according to one or more embodiments and a display device according to one or more embodiments including the display module, which will be described herein in more detail. In one or more embodiments, one or more suitable individual modules functionally included in one module may be included in the display device, and one or more other suitable modules may be provided separately from the display device. For example, the display device may include the display module DM, and the processor PR, the memory MR, and the power module PM may be provided in the form of other devices within the electronic apparatus EA, not the display device.

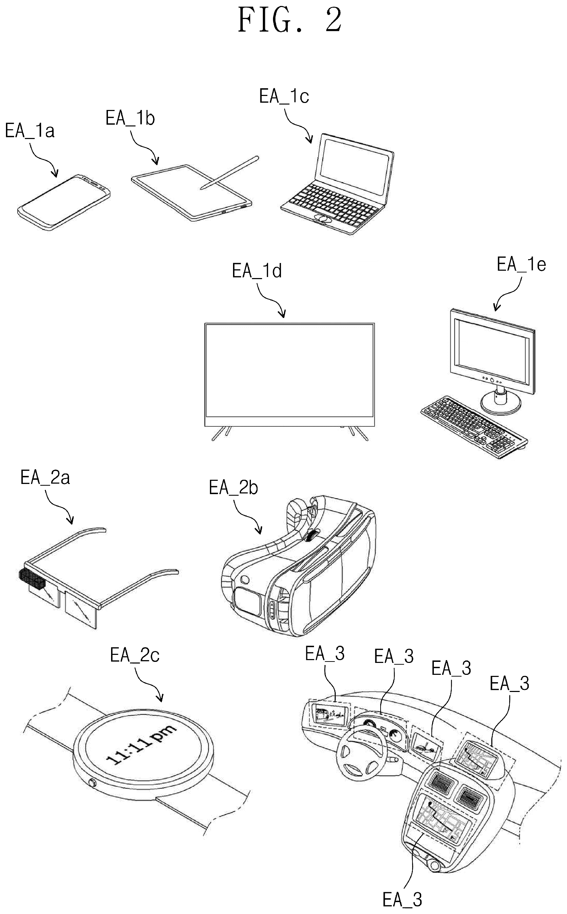

FIG. 2 illustrates schematic views of one or more suitable electronic apparatuses according to one or more embodiments.

Referring to FIG. 2, one or more suitable electronic apparatuses including the display module according to one or more embodiments may not include (e.g., may exclude) only an image-displaying electronic apparatus, such as a smart phone EA_1a, a tablet PC EA_1b, a laptop computer EA_1c, a TV EA_1d, and a desktop monitor EA_1e, but also include a wearable electronic apparatus, such as smart glasses EA_2a, a head mounted display EA_2b, or a smart watch EA_2c, and a vehicular electronic apparatus EA_3, such as a car dashboard, a center fascia, a center information display (CID) arranged in a dashboard, or a room mirror display, and/or the like.

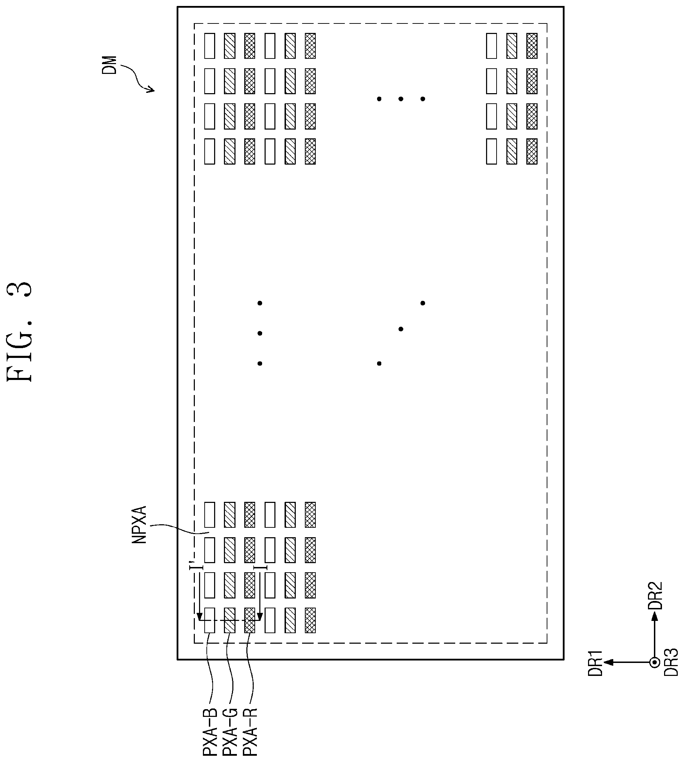

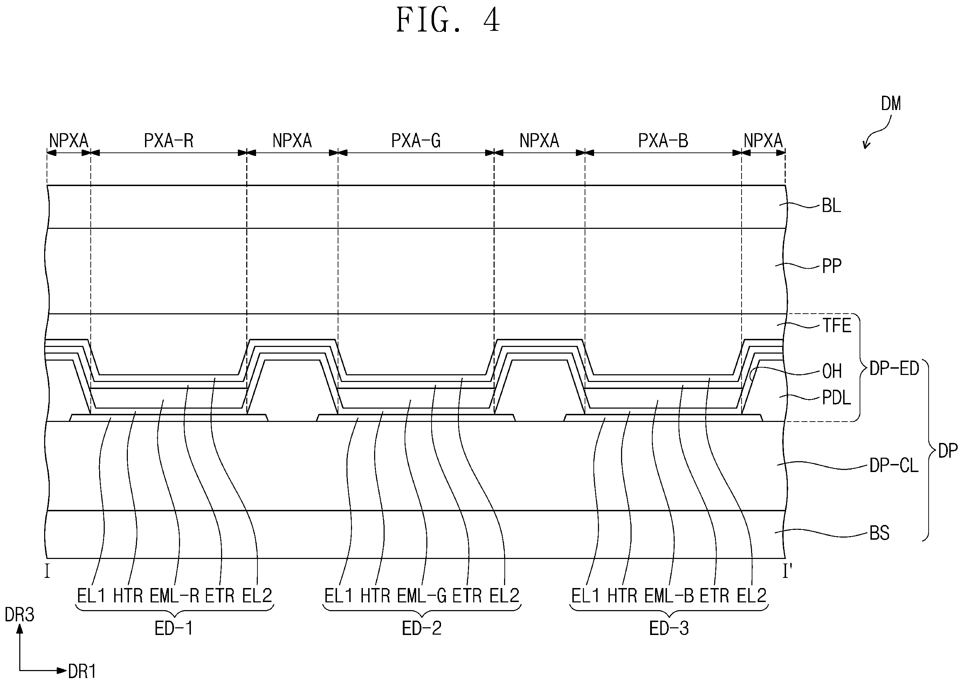

FIG. 3 is a plan view illustrating one or more embodiments of the display module DM. FIG. 4 is a cross-sectional view of the display module DM according to one or more embodiments. FIG. 4 is a cross-sectional view illustrating a portion taken along the line I-I' in FIG. 3.

The display module DM may include a plurality of light-emitting elements ED-1, ED-2, and ED-3. In one or more embodiments, the display module DM may further include a display panel DP including the plurality of light-emitting elements ED-1, ED-2, and ED-3, and an optical layer PP arranged on the display panel DP.

The display panel DP may include a base layer BS, a circuit layer DP-CL arranged on the base layer BS, and a display element layer DP-ED. The display element layer DP-ED may include a pixel-defining film PDL, light-emitting elements ED-1, ED-2, and ED-3 arranged between the pixel-defining films PDL, and an encapsulation layer TFE arranged on the light-emitting elements ED-1, ED-2, and ED-3.

The base layer BS may be a member that provides a base surface on which the display element layer DP-ED is arranged. The base layer BS may be a glass substrate, a metal substrate, a plastic substrate, and/or the like. However, embodiments of the present disclosure are not limited thereto, and the base layer BS may be an inorganic layer, an organic layer, or a composite material layer.

In one or more embodiments, the circuit layer DP-CL may be arranged on the base layer BS and include a plurality of transistors. The transistors may each include a control electrode, an input electrode, and an output electrode. For example, the circuit layer DP-CL may include a switching transistor, and a driving transistor to drive the light-emitting elements ED-1, ED-2, and ED-3 of the display element layer DP-ED.

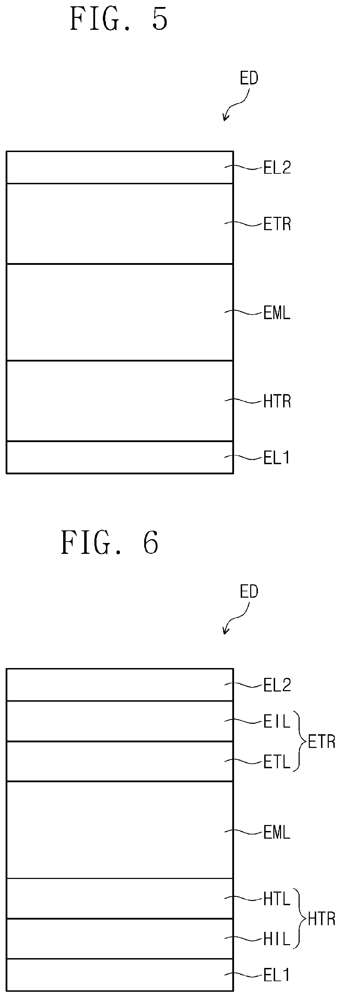

The light-emitting elements ED-1, ED-2, and ED-3 may each include a structure of the light-emitting element ED according to one or more embodiments with reference to FIG. 5 to FIG. 9 to be described herein in more detail. The light-emitting elements ED-1, ED-2, and ED-3 may respectively include a first electrode EL1, a hole transport region HTR, light emitting layers EML-R, EML-G, and EML-B, an electron transport region ETR, and a second electrode EL2.

The optical layer PP may be arranged on the display panel DP and may be to control, on the display panel DP, reflected light caused by external light. The optical layer PP may include, for example, a polarization layer or color filter layer. In one or more embodiments, the optical layer PP may not be provided in the display module DM according to one or more embodiments.

A base substrate BL may be arranged on the optical layer PP. The base substrate BL may be a member providing a base surface in which the optical layer PP is arranged. The base substrate BL may be a glass substrate, a metal substrate, a plastic substrate, and/or the like. However, embodiments of the present disclosure are not limited thereto, and the base substrate BL may be an inorganic layer, an organic layer, or a composite material layer. In one or more embodiments, the base substrate BL may not be provided in one or more embodiments.

The display module DM according to one or more embodiments may further include a filling layer. The filling layer may be arranged between the display element layer DP-ED and the base substrate BL. The filling layer may be an organic material layer. The filling layer may include at least one selected from among an acrylate-based resin, a silicon-based resin, and/or an epoxy-based resin.

FIG. 4 illustrates that the light emitting layers EML-R, EML-G, and EML-B of the light-emitting elements ED-1, ED-2, and ED-3 are arranged in an opening OH defined in the pixel-defining film PDL are arranged, and the hole transport region HTR, the electron transport region ETR, and the second electrode EL2 are provided as a common layer in the entire light-emitting elements ED-1, ED-2, and ED-3. However, embodiments of the present disclosure are not limited thereto, and, in one or more embodiments, the hole transport region HTR and the electron transport region ETR may be patterned and provided inside the opening OH which is defined in the pixel-defining film PDL. For example, in one or more embodiments, the hole transport region HTR, the light emitting layers EML-R, EML-G, and EML-B, the electron transport region ETR, and/or the like of the light-emitting elements ED-1, ED-2, and ED-3 may be provided by being patterned using an inkjet printing method.

The encapsulation layer TFE may cover the light-emitting elements ED-1, ED-2, and ED-3. The encapsulation layer TFE may seal the display element layer DP-ED. The encapsulation layer TFE may be a thin encapsulation layer. In the encapsulation layer TFE, a single layer or multiple layers may be stacked. The encapsulation layer TFE may include at least one insulation (e.g., electrical insulation) layer. The encapsulation layer TFE according to one or more embodiments may include at least one inorganic layer (hereinafter, referred to as an inorganic encapsulation layer). In one or more embodiments, the encapsulation layer TFE according to one or more embodiments may include at least one organic layer (hereinafter, referred to as an organic encapsulation layer).

The inorganic encapsulation layer may be to protect the display element layer DP-ED from moisture/oxygen, and the organic encapsulation layer may be to protect the display element layer DP-ED from foreign materials, such as dust particles. The inorganic encapsulation layer may include silicon nitride, silicon oxynitride, silicon oxide, titanium oxide, aluminium oxide, and/or the like, but embodiments of the present disclosure are not limited thereto. The organic encapsulation layer may include an acrylate-based compound, an epoxy-based compound, and/or the like. The organic encapsulation layer may include photopolymerizable organic materials, but embodiments of the present disclosure are not limited thereto.

The encapsulation layer TFE may be arranged on the second electrode EL2 and may be arranged so as to fill the opening OH.

Referring to FIG. 3 and FIG. 4, the display module DM may include a non-emission region NPXA and emission regions PXA-R, PXA-G, and PXA-B. The emission regions PXA-R, PXA-G, and PXA-B may be regions emitting light generated from the light-emitting elements ED-1, ED-2, and ED-3, respectively. The display module DM may include a first emission region PXA-R, a second emission region PXA-G, and a third emission region PXA-B, which are spaced and/or apart (e.g., spaced apart or separated) from each other on a plane (e.g., in plan view).

The first to third emission regions PXA-R, PXA-G, and PXA-B may be each a region that is separated by the pixel-defining film PDL. The non-emission regions NPXA may be regions between the adjacent emission regions PXA-R, PXA-G, and PXA-B, and may correspond to the pixel-defining film PDL. In one or more embodiments, the emission regions PXA-R, PXA-G, and PXA-B may respectively correspond to pixels. The pixel-defining film PDL may separate the light-emitting elements ED-1, ED-2, and ED-3. The light emitting layers EML-R, EML-G, and EML-B of the light-emitting elements ED-1, ED-2, and ED-3 may be arranged in the opening OH defined in the pixel-defining film PDL and separated.

The emission regions PXA-R, PXA-G, and PXA-B may be divided into a plurality of groups according to colors of light generated from the light-emitting elements ED-1, ED-2, and ED-3. FIG. 3 and FIG. 4 illustrate, as examples, a display module DM according to one or more embodiments in which three emission regions PXA-R, PXA-G, and PXA-B respectively emit red light, green light, and blue light. For example, the first emission region PXA-R, the second emission region PXA-G, and third emission region PXA-B may be referred to as a red emission region, a green emission region, and a blue emission region, respectively.

In the display module DM according to one or more embodiments, a plurality of light-emitting elements ED-1, ED-2, and ED-3 may be to emit light in mutually different wavelength regions. For example, in one or more embodiments, the display module DM may include a first light-emitting element ED-1 that emits red light, a second light-emitting element ED-2 that emits green light, and a third light-emitting element ED-3 that emits blue light. For example, the red emission region PXA-R, the green emission region PXA-G, and the blue emission region PXA-B of the display module DM may correspond to the first light-emitting element ED-1, the second light-emitting element ED-2, and the third light-emitting element ED-3, respectively.

However, embodiments of the present disclosure are not limited thereto, and the first to third light-emitting elements ED-1, ED-2, and ED-3 may be to emit light in substantially the same wavelength region, or at least one may be to emit light in a different wavelength region. For example, all the first to third light-emitting elements ED-1, ED-2, and ED-3 may be to emit blue light.

The emission regions PXA-R, PXA-G, and PXA-B in the display module DM according to one or more embodiments may be arranged in a stripe shape. Referring to FIG. 3, a plurality of first emission regions PXA-R, a plurality of second emission regions PXA-G, and a plurality of third emission regions PXA-B may each be arranged along a second direction axis DR2. In one or more embodiments, the emission regions may be arranged alternatively in orders of the first emission region PXA-R, the second emission region PXA-G, and the third emission region PXA-B along a first direction axis DR1.

FIG. 3 and FIG. 4 illustrate that the emission regions PXA-R, PXA-G, and PXA-B have similar areas, but embodiments of the present disclosure are not limited thereto. The areas of the emission regions PXA-R, PXA-G, and PXA-B may differ from each other according to the wavelength regions of light emitted. The areas of the emission regions PXA-R, PXA-G, and PXA-B may be planar areas if (e.g., when) viewed on a plane (e.g., in plan view) defined by the first direction axis DR1 and the second direction axis DR2.

The arrangement form of the emission regions PXA-R, PXA-G, and PXA-B is not limited to what is illustrated in FIG. 3, and the arrangement order of the first emission region PXA-R, the second emission region PXA-G, and the third emission region PXA-B may be provided in one or more suitable combinations according to display quality characteristics to be desired or required for the display module DM and a display device including the display module DM. For example, the arrangement form of the emission regions PXA-R, PXA-G, and PXA-B may be a PENTILE^{®} arrangement form (e.g., an RGBG matrix, an RGBG structure, or an RGBG matrix structure) or a DIAMOND PIXEL^{™} arrangement form. PENTILE^{®} is a duly registered trademark of Samsung Display Co., Ltd. and DIAMOND PIXEL^{™} is a trademark of Samsung Display Co., Ltd.

In one or more embodiments, the areas of the emission regions PXA-R, PXA-G, and PXA-B may differ from each other. For example, in one or more embodiments, the area of the second emission region PXA-G which is the green emission region may be smaller than the area of the third emission region PXA-B which is the blue emission region, but embodiments of the present disclosure are not limited thereto.

Hereinafter, FIG. 5 to FIG. 9 are each a cross-sectional view schematically illustrating a light-emitting element according to one or more embodiments. The light-emitting element ED according to one or more embodiments may include a first electrode EL1, a hole transport region HTR, a light emitting layer EML, an electron transport region ETR, and a second electrode EL2, stacked in sequence.

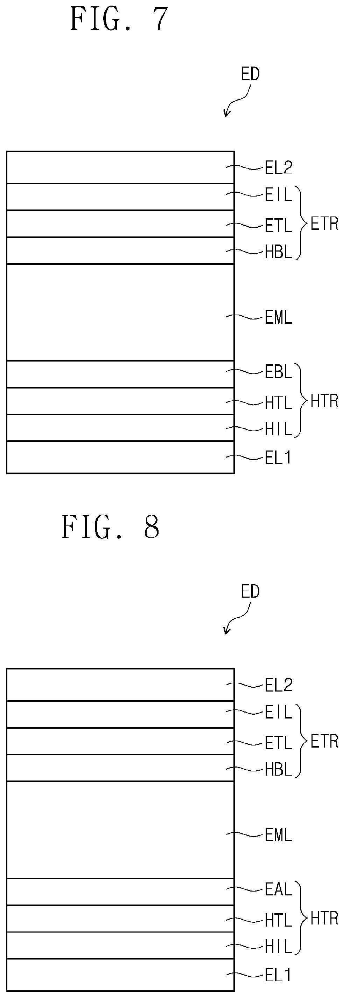

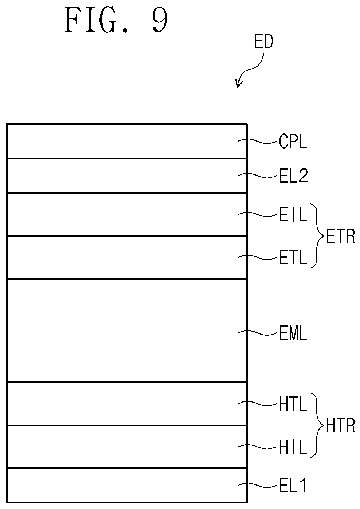

FIG. 6 illustrates, compared to FIG. 5, a cross-sectional view of a light-emitting element ED according to one or more embodiments, in which the hole transport region HTR includes a hole injection layer HIL, and a hole transport layer HTL, and the electron transport region ETR includes an electron injection layer EIL and an electron transport layer ETL. FIG. 7 illustrates, compared to FIG. 5, a cross-sectional view of a light-emitting element ED according to one or more embodiments in which the hole transport region HTR includes a hole injection layer HIL, a hole transport layer HTL, and an electron-blocking layer EBL, and the electron transport region ETR includes an electron injection layer EIL, an electron transport layer ETL, and a hole-blocking layer HBL. FIG. 8 illustrates, compared to FIG. 5, a cross-sectional view of a light-emitting element ED according to one or more embodiments in which the hole transport region HTR includes a hole injection layer HIL, a hole transport layer HTL, and an emission auxiliary layer EAL, and the electron transport region ETR includes an electron injection layer EIL, an electron transport layer ETL, and a hole-blocking layer HBL. FIG. 9 illustrates, compared to FIG. 6, a cross-sectional view of a light-emitting element ED according to one or more embodiments including a capping layer CPL arranged on a second electrode EL2.

The first electrode EL1 may have conductivity (e.g., electrical conductivity; may be a conductor). The first electrode EL1 may include a metal material, a metal alloy, or a conductive (e.g., electrically conductive) compound. The first electrode EL1 may be an anode or a cathode. However, embodiments of the present disclosure are not limited thereto. In one or more embodiments, the first electrode EL1 may be a pixel electrode. The first electrode EL1 may be a transmissive electrode, a transflective electrode, or a reflective electrode. The first electrode EL1 may include: at least one selected from among Ag, Mg, Cu, Al, Pt, Pd, Au, Ni, Nd, Ir, Cr, Li, Ca, LiF, Mo, Ti, W, In, Sn, and Zn; a compound of two or more selected therefrom, a mixture of two or more selected therefrom, or an oxide thereof.

If (e.g., when) the first electrode EL1 is a transmissive electrode, the first electrode EL1 may include a transparent metal oxide, such as indium tin oxide (ITO), indium zinc oxide (IZO), zinc oxide (e.g., ZnO), and indium tin zinc oxide (ITZO). If (e.g., when) the first electrode EL1 is the transflective electrode or the reflective electrode, the first electrode EL1 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, a compound thereof, or a mixture thereof (for example, a mixture of Ag and Mg). In one or more embodiments, the first electrode EL1 may have a multi-layered structure including a reflective film or a transflective film formed or composed of the materials described herein, and a transparent conductive (e.g., electrically conductive) film formed or composed of indium tin oxide (ITO), indium zinc oxide (IZO), zinc oxide (e.g., ZnO), and/or indium tin zinc oxide (ITZO). For example, the first electrode EL1 may have a three-layered structure of ITO/Ag/ITO but embodiments of the present disclosure are not limited thereto. The first electrode EL1 may include the metal materials described herein, a combination of two or more metal materials selected from among the metal materials described herein, oxides of the metal materials described herein, and/or the like. The first electrode EL1 may have a thickness of about 700 Å to about 10,000 Å. For example, the thickness of the first electrode EL1 may be in the range of about 1,000 Å to about 3,000 Å.

The hole transport region HTR may be provided on the first electrode EL1. The hole transport region HTR may include at least one selected from among the hole injection layer HIL, the hole transport layer HTL, the emission auxiliary layer EAL, and the electron-blocking layer EBL. The thickness of the hole transport region HTR may be, for example, in the range of about 50 Å to about 15,000 Å. The emission auxiliary layer EAL may also be referred to as a buffer layer.

The hole transport region HTR may have a single layer formed or composed of a single material, a single layer formed or composed of a plurality of different materials, or a multi-layered structure having a plurality of layers formed or composed of a plurality of different materials.

For example, the hole transport region HTR may have a single-layer structure of a hole injection layer HIL or a hole transport layer HTL, and may also have a single-layered structure formed or composed of a hole injection material and a hole transport material. In one or more embodiments, the hole transport region HTR may have a single-layered structure formed or composed of a plurality of different materials or may have a structure of hole injection layer HIL/hole transport layer HTL, hole injection layer HIL/hole transport layer HTL/emission auxiliary layer EAL, hole injection layer HIL/ emission auxiliary layer EAL, hole transport layer HTL/emission auxiliary layer EAL, hole injection layer HIL/hole transport layer HTL/emission auxiliary layer EAL, or hole injection layer HIL/hole transport layer HTL/electron-blocking layer EBL, sequentially stacked from the first electrode EL1, but embodiments of the present disclosure are not limited thereto.

The hole transport region HTR may be formed by using one or more suitable methods, such as a vacuum deposition method, a spin coating method, a cast method, a Langmuir-Blodgett (LB) method, an inkjet printing method, a laser printing method, and a laser induced thermal imaging (LITI) method.

The hole transport region HTR may include a compound represented by Formula H-1.

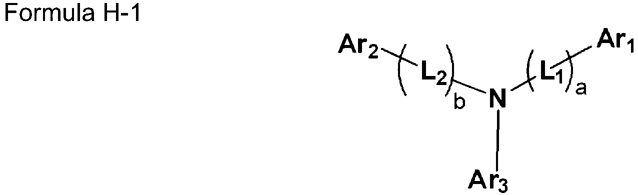

In Formula H-1, L₁ and L₂ may each independently be a direct linkage (e.g., a single covalent bond), a substituted or unsubstituted arylene group having 6 to 30 ring-forming carbon atoms, or a substituted or unsubstituted heteroarylene group having 2 to 30 ring-forming carbon atoms. a and b may each independently be an integer of 0 to 10. If (e.g., when) a or b is an integer of 2 or greater (e.g., an integer of 2 to 10), a plurality of L₁ and a plurality of L₂ may each independently be a substituted or unsubstituted arylene group having 6 to 30 ring-forming carbon atoms or a substituted or unsubstituted heteroarylene group having 2 to 30 ring-forming carbon atoms.

In Formula H-1, Ar₁ and Ar₂ may each independently be a substituted or unsubstituted aryl group having 6 to 30 ring-forming carbon atoms or a substituted or unsubstituted heteroaryl group having 2 to 30 ring-forming carbon atoms. In one or more embodiments, in Formula H-1, Ar₃ may be a substituted or unsubstituted aryl group having 6 to 30 ring-forming carbon atoms.

The compound represented by Formula H-1 may be a monoamine compound. In one or more embodiments, the compound represented by Formula H-1 may be a diamine compound in which at least one selected from among Ar₁ to Ar₃ includes an amine group as a substituent. In one or more embodiments, the compound represented by Formula H-1 may be a carbazole-based compound including a substituted or unsubstituted carbazole group in at least one selected from among Ar₁ and Ar₂ or a fluorene-based compound including a substituted or unsubstituted fluorene group in at least one selected from among Ar₁ and Ar₂.

The compound represented by Formula H-1 may be represented by any one selected from among the compounds in Compound Group H. However, the compounds listed in Compound Group H are provided as examples, and the compound represented by Formula H-1 is not limited to the compounds present in Compound Group H.

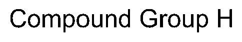

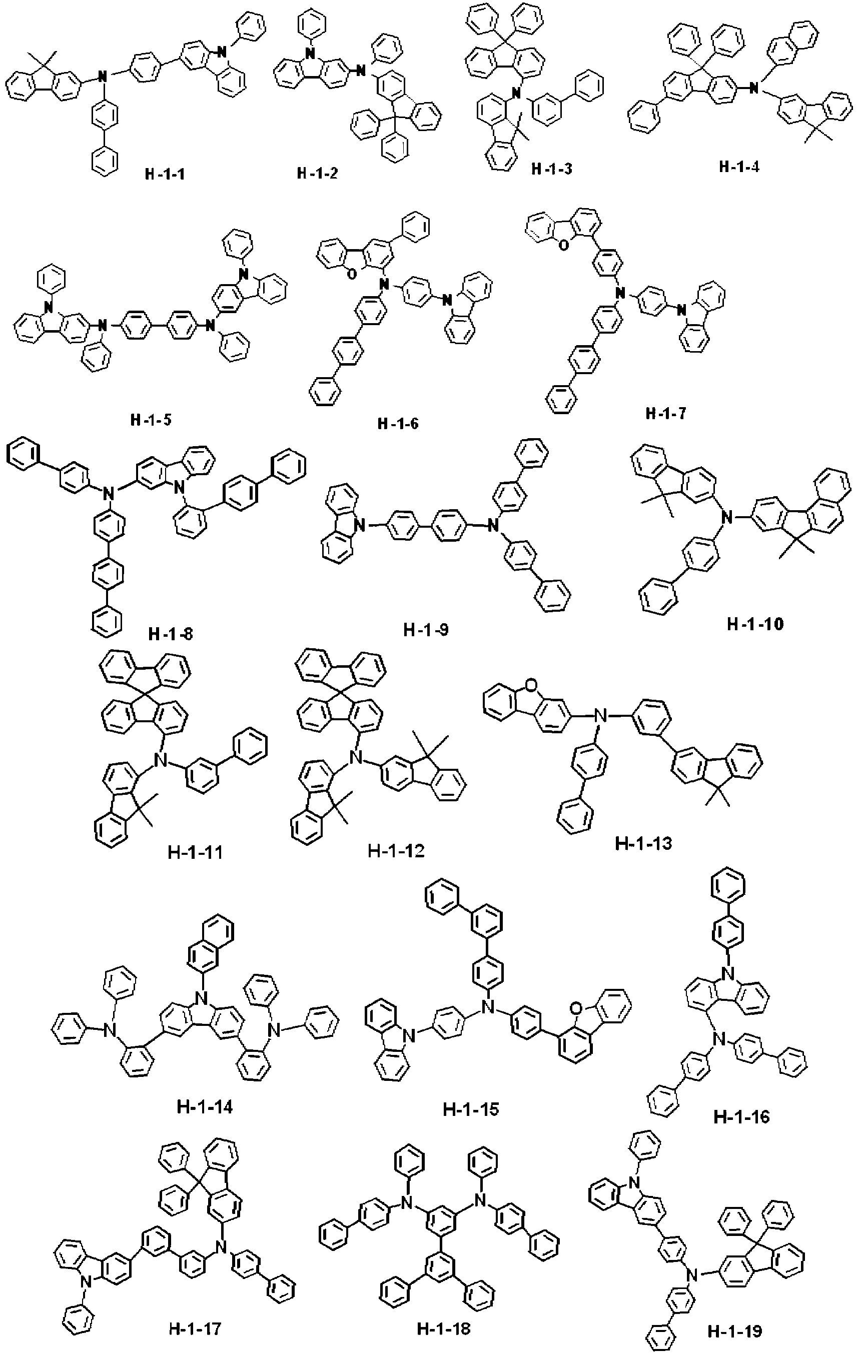

The hole transport region HTR may include a phthalocyanine compound, such as copper phthalocyanine, N¹,N^{1'}-([1,1'-biphenyl]-4,4'-diyl)bis(N¹-phenyl-N⁴,N⁴-dim-tolylbenzene-1,4-diamine) (DNTPD), 4,4',4"-tris[(3-methylphenyl)phenylamino]triphenylamine (m-MTDATA), 4,4'4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphorsulfonic acid (PANI/CSA), polyaniline/poly(4-styrenesulfonate) (PANI/PSS), N,N'-di(naphthalen-I-yl)-N,N'-diphenyl-benzidine (NPB), polyether ketone containing triphenylamine (TPAPEK), 4-isopropyl-4'-methyldiphenyliodonium [tetrakis(pentafluorophenyl)borate], dipyrazino[2,3-f: 2',3'-h] quinoxaline-2,3,6,7,10,11-hexacarbonitrile (HATCN), and/or the like.

The hole transport region HTR may include a carbazole-based derivative, such as N-phenyl carbazole, and polyvinyl carbazole, a fluorine-based derivative, N,N'-bis(3-methylphenyl)-N,N'-diphenyl-[1,1'-biphenyl]-4,4'-diamine (TPD), a triphenylamine-based derivative, such as 4,4',4"-tris(N-carbazolyl)triphenylamine (TCTA), N,N'-di(naphthalene-I-yl)-N,N'-diphenyl-benzidine (NPB), 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 1,3-bis(N-carbazolyl)benzene (mCP), and/or the like.

In one or more embodiments, the hole transport region HTR may further include 9-(4-tert-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), and/or the like.

The hole transport region HTR may include the compounds of the hole transport region described herein in at least one selected from among the hole injection layer HIL, the hole transport layer HTL, the emission auxiliary layer EAL, and the electron-blocking layer EBL.

The hole transport region HTR may have a thickness of about 100 Å to about 10000 Å, for example, about 100 Å to about 5000 Å. If (e.g., when) the hole transport region HTR includes the hole injection layer HIL, the hole injection layer HIL may have a thickness of, for example, about 30 Å to about 1000 Å. If (e.g., when) the hole transport region HTR includes the hole transport layer HTL, the hole transport layer HTL may have a thickness of about 30 Å to about 1000 Å. For example, the hole transport region HTR may include the electron-blocking layer EBL, the electron-blocking layer EBL may have a thickness of about 10 Å to about 1000 Å. If (e.g., when) the thicknesses of the hole transport region HTR, the hole injection layer HIL, the hole transport layer HTL, and the electron-blocking layer EBL fall within the foregoing ranges, satisfactory hole transport properties may be achieved without a substantial increase in a driving voltage.

The hole transport region HTR may further include a charge-generating material to increase conductivity (e.g., electrical conductivity) in addition to the materials described herein. The charge-generating material may be dispersed uniformly (e.g., substantially uniformly) or non-uniformly (e.g., substantially non-uniformly) in the hole transport region HTR. The charge-generating material may be, for example, a p-dopant. The p-dopant may include at least one selected from among a metal halide compound, a quinone derivative, a metal oxide, and a cyano group-containing compound, but embodiments of the present disclosure are not limited thereto. For example, the p-dopant may include a metal halide compound, such as Cul and Rbl, a quinone derivative, such as tetracyanoquinodimethane (TCNQ) and 2,3,5,6-tetrafluoro-7,7'8,8-tetracyanoquinodimethane (F4-TCNQ), a metal oxide, such as tungsten oxide and molybdenum oxide, a cyano group-containing compound, such as dipyrazino[2,3-f: 2',3'-h] quinoxaline-2,3,6,7,10,11-hexacarbonitrile (HATCN) and 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), and/or the like, but embodiments of the present disclosure are not limited thereto.

As described herein, the hole transport region HTR may further include at least one selected from among the emission auxiliary layer EAL and the electron-blocking layer EBL, in addition to the hole injection layer HIL and the hole transport layer HTL. The emission auxiliary layer EAL may be to compensate for a resonance distance according to a wavelength of light emitted from the light emitting layer EML and may be to increase light emission efficiency by controlling a hole charge balance. In one or more embodiments, the emission auxiliary layer EAL may also serve to prevent electrons from being injected into the hole transport region HTR (or to reduce a degree to or occurrence of which electrons are injected into the hole transport region HTR). The material capable of being included in the hole transport region HTR may be included in the emission auxiliary layer EAL. The electron-blocking layer EBL may be a layer that serves to prevent electrons from being injected into the hole transport region HTR from the electron transport region ETR (or to reduce a degree to or occurrence of which electrons are injected into the hole transport region HTR from the electron transport region ETR).

In the light-emitting element ED according to one or more embodiments, the light emitting layer EML may include a polycyclic compound according to one or more embodiments. The light emitting layer EML in the light-emitting element ED according to one or more embodiments may include a first compound, which is a polycyclic compound according to one or more embodiments, and at least one selected from among the second compound and the third compound. In one or more embodiments, in the light-emitting element ED according to one or more embodiments, the light emitting layer EML may further include a fourth compound. The second compound may include a fused ring with three rings, which contains a nitrogen atom as a ring-forming atom. The third compound may include a six-membered ring containing at least one nitrogen atom as a ring-forming atom. The fourth compound may include an organometallic complex. The second to fourth compounds will be described herein in more detail.

In the present disclosure, the first compound may be referred to as a polycyclic compound according to one or more embodiments. The polycyclic compound according to one or more embodiments may include a boron atom-containing fused ring as a core structure. The polycyclic compound according to one or more embodiments, which is the first compound, may include at least one boron atom as a ring-forming atom and at least one amine moiety. The polycyclic compound according to one or more embodiments may include a boron atom-containing hetero-fused ring structure in which five or more rings are fused as a core structure. In one or more embodiments, the polycyclic compound according to one or more embodiments may include a terphenyl derivative, which is a bulky substituent, and a fused ring derivative in which a cycloalkane is fused to a benzene ring. In one or more embodiments, the fused ring derivative in which cycloalkane is fused to a benzene ring further may include an aromatic substituent, and thus conjugation may be extended.

The polycyclic compound according to one or more embodiments may include a core having a boron atom-containing hetero-fused ring structure and a bulky substituent including a terphenyl derivative or a fused ring derivative in which cycloalkane is fused to a benzene ring, or a cycloalkane ring substituted with an alkyl group, thereby having high planarity, and suppressing or reducing interactions between adjacent molecules. Therefore, the polycyclic compound according to one or more embodiments may exhibit excellent or suitable material stability.

The polycyclic compound according to one or more embodiments may exhibit thermally activated delayed fluorescence (TADF) emission characteristics by reverse intersystem crossing.

The light-emitting element ED according to one or more embodiments may include a polycyclic compound according to one or more embodiments. The polycyclic compound according to one or more embodiments may be represented by Formula 1.

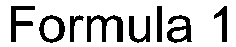

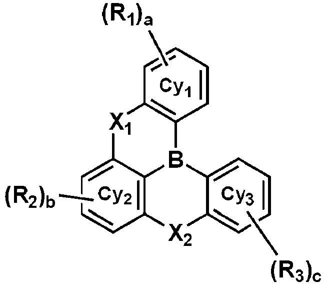

In Formula 1, X₁ and X₂ may each independently be O, S, or NRₓ, and at least one selected from among X₁ and X₂ may be NRₓ. At least one selected from among rings Cy₁ to Cy₃ in Formula 1 may be non-fused or fused to a structure of Formula 2 (e.g., all of Cy₁ to Cy₃ may be non-fused to a structure of Formula 2, or at least one selected from rings Cy₁ to Cy₃ may be fused to a structure of Formula 2).

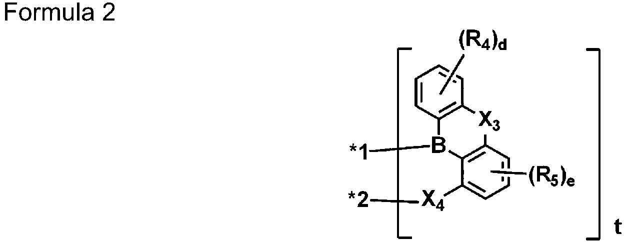

In Formula 2, t may be an integer of 0 to 2 (e.g., t may be 0 or 1), X₃ and X₄ may each independently be O, S, or NRₓ, and *1 and *2 may be bonding positions to which the rings Cy₁ to Cy₃ may be bonded.

For example, in Formula 2, if (e.g., when) t is 0, a structure of Formula 2 is not fused to the core structure in the polycyclic compound of Formula 1. If (e.g., when) t is 1 in Formula 2, the structure of Formula 2 may be fused to any one ring selected from among Cy₁ to Cy₃. Accordingly, if (e.g., when) t is 1, the polycyclic compound according to one or more embodiments may include two boron atoms as ring-forming atoms, and may have a core structure in which 9 or more rings are fused.

In one or more embodiments, if (e.g., when) t is 2 in Formula 2, two structures represented by Formula 2 may be fused to at least one ring selected from among Cy₁ to Cy₃ in Formula 1. For example, two fused ring structures represented by Formula 2 may be fused to different rings selected from among rings, Cy₁ to Cy₃, respectively. In one or more embodiments, one selected from among the two fused rings represented by Formula 2 may be fused to any one ring selected from among the rings Cy₁ to Cy₃, and the other one may be additionally fused to any one ring of a ring structure of Formula 2 which is fused to the rings Cy₁ to Cy₃.

In Formula 1 and Formula 2, a, c, and d may each independently be an integer of 0 to 4, and b and e may each independently be an integer of 0 to 3.

In one or more embodiments, in Formula 1 and Formula 2, R₁ to R₅ may each independently be a hydrogen atom, a deuterium atom, a halogen atom, a cyano group, a substituted or unsubstituted amino group, a substituted or unsubstituted alkyl group having 1 to 20 carbon atoms, a substituted or unsubstituted hydrocarbon ring having 6 to 30 ring-forming carbon atoms, or a substituted or unsubstituted heterocycle having 3 to 30 ring-forming carbon atoms, or may be bonded to an adjacent group to form a ring of Formula 3.

If (e.g., when) a to e are each independently an integer of 2 or greater, a plurality of R₁ to R₅ may be all the same or at least one thereof may be different from the others. For example, if (e.g., when) a is an integer of 2 or greater, a plurality of R₁ may be the same, or at least one may be different from the others. In one or more embodiments, if (e.g., when) b, c, d, e, and/or the like are each independently an integer of 2 or greater, a plurality of R₂ to R₅ may be all the same or at least one thereof may be different from the others.

If (e.g., when) a to e are each 0, substituents R₁ to R₅ are not included, and a benzene ring constituting a fused ring core of the polycyclic compound may be unsubstituted.

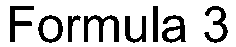

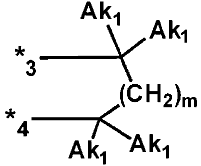

In Formula 3, *3 and *4 are portions to which an adjacent ring is fused. In Formula 3, m may be an integer of 1 to 3, and Ak₁ may be a substituted or unsubstituted alkyl group having 1 to 10 carbon atoms. Formula 3 may be fused with an adjacent ring and may form a cycloalkane ring substituted with an alkyl group. For example, a ring represented by Formula 3 may be fused to an adjacent benzene ring. In one or more embodiments, Ak₁ may be a methyl group, and m may be 2.

In Formula 1 and Formula 2, Rₓ may be represented by Formula 4-1 or Formula 4-2. If (e.g., when) the polycyclic compound according to one or more embodiments represented by Formula 1 or a combination of Formula 1 and Formula 2 includes a plurality of Rₓ, the plurality of Rₓ may each independently be represented by Formula 4-1 or Formula 4-2.

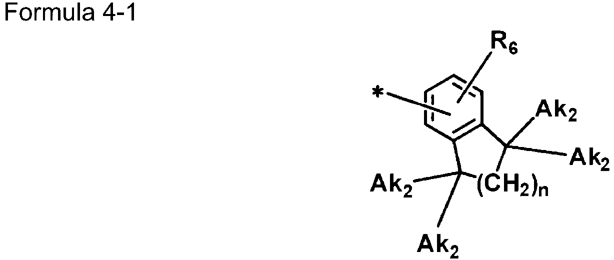

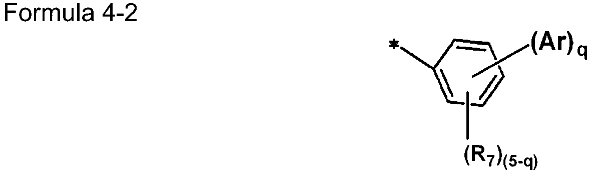

In Formula 4-1, n may be an integer of 1 to 3, and Ak₂ may be a substituted or unsubstituted alkyl group having 1 to 10 carbon atoms. For example, in Formula 4-1, n may be 2, and Ak₂ may be a methyl group.

In Formula 4-1, R₆ may be a hydrogen atom, a deuterium atom, a halogen atom, a substituted or unsubstituted amino group, a substituted or unsubstituted alkyl group having 1 to 10 carbon atoms, a substituted or unsubstituted aryl group having 6 to 30 ring-forming carbon atoms, or a substituted or unsubstituted heteroaryl group having 3 to 30 ring-forming carbon atoms.

In Formula 4-2, R₇ may be a hydrogen atom, a deuterium atom, a halogen atom, a cyano group, a substituted or unsubstituted alkyl group having 1 to 10 carbon atoms, or a substituted or unsubstituted aryl group having 6 to 30 ring-forming carbon atoms. In one or more embodiments, in Formula 4-2, q may be an integer of 0 to 5, and Ar may each independently be a substituted or unsubstituted aryl group having 6 to 30 ring-forming carbon atoms or a substituted or unsubstituted heteroaryl group having 3 to 30 ring-forming carbon atoms.

In one or more embodiments, Rₓ may be represented by Formula 4-1, and R₆ may be a substituted or unsubstituted aryl group having 6 to 30 ring-forming carbon atoms. In one or more embodiments, Rₓ may be represented by Formula 4-1, R₆ may be a substituted or unsubstituted aryl group having 6 to 30 ring-forming carbon atoms, and R₆ may be an ortho-substituent relative to -* (i.e., R₆ may be located adjacent to where Formula 4-1 forms an attachment point to the nitrogen atom in NRₓ).

In one or more embodiments, Rₓ may be represented by Formula 4-2, q may be an integer of 1 to 5 (e.g., q may be 1 or 2), and Ar may be a substituted or unsubstituted aryl group having 6 to 30 ring-forming carbon atoms. In one or more embodiments, Rₓ may be represented by Formula 4-2, q may be an integer of 1 to 5 (e.g., q may be 1 or 2), Ar may be a substituted or unsubstituted aryl group having 6 to 30 ring-forming carbon atoms, and at least one Ar (e.g., one Ar or two Ar) may be an ortho-substituent relative to -* (i.e., the at least one Ar (e.g., one Ar or two Ar) may be located adjacent to where Formula 4-2 forms an attachment point to the nitrogen atom in NRₓ).

For example, Rₓ may be represented by any one selected from among R-1 to R-4 (e.g., any one selected from among R-1, R-2 and R-4).

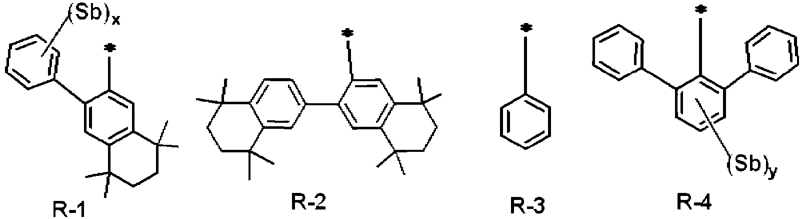

In R-1 and R-4, Sb may be a substituted or unsubstituted alkyl group having 1 to 10 carbon atoms, a cyano group, or a substituted or unsubstituted aryl group having 6 to 30 ring-forming carbon atoms. For example, Sb may be a t-butyl group, a substituted or unsubstituted phenyl group, and/or the like. In one or more embodiments, in R-1, x may be an integer of 0 to 5, and in R-4, y may be an integer of 0 to 3. In R-1 to R-4, at least one hydrogen atom may be substituted with a deuterium atom.

If (e.g., when) t in Formula 2 is 0, Rₓ in NRₓ may be represented by Formula 4-2, q in Formula 4-2 may be an integer of 2 or greater (e.g., an integer of 2 to 5), and at least one selected from among R₁, R₂, and R₃ in Formula 1 may be represented by Formula 4-1.

In Formula 2, if (e.g., when) t is 1 and Rₓ in NRₓ is represented by Formula 4-2, q may be an integer of 2 or greater (e.g., an integer of 2 to 5). If (e.g., when) all Rₓ is represented by Formula 4-2, at least one selected from among R₁ to R₅ may be represented by Formula 4-1, or at least one selected from among R₁ to R₅ may be bonded to an adjacent group to form a ring of Formula 3.

In Formula 2, if (e.g., when) t is 2 and all Rₓ are represented by Formula 4-2, at least one selected from among R₁ to R₅ may be represented by Formula 4-1 or at least one selected from among R₁ to R₅ may be bonded to an adjacent group to form a ring of Formula 3.

The polycyclic compound according to one or more embodiments may be represented by Formula 1A.

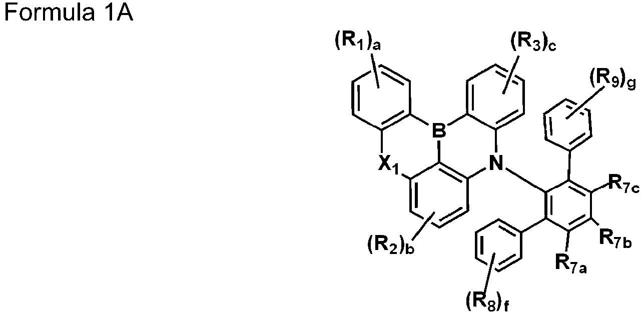

In Formula 1A, X₁ may be O, S, or NRₓ, and if (e.g., when) X₁ is NRₓ, Rₓ may be represented by Formula 4-2, and q in Formula 4-2 may be an integer of 2 or greater (e.g., an integer of 2 to 5).

In Formula 1A, at least one selected from among R₁ to R₃ may be represented by Formula 4-1, and R₆ in Formula 4-1 may be a substituted or unsubstituted aryl group having 6 to 30 ring-forming carbon atoms or a substituted or unsubstituted heteroaryl group having 3 to 30 ring-forming carbon atoms.

f and g may each independently be an integer of 0 to 5, and R₈, R₉, R₇ₐ, R_{7b}, and R_{7c} may each independently be a hydrogen atom, a deuterium atom, a halogen atom, a cyano group, a substituted or unsubstituted alkyl group having 1 to 10 carbon atoms, or a substituted or unsubstituted aryl group having 6 to 30 ring-forming carbon atoms.

The descriptions provided in Formula 1 may be similarly applied to R₁ to R₃, and a to c in Formula 1A.

The polycyclic compound according to one or more embodiments may be represented by Formula 1B.

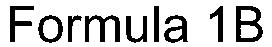

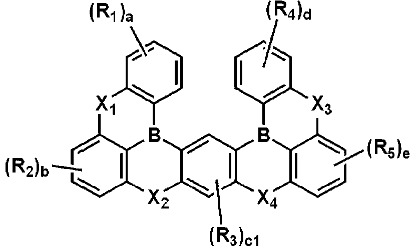

In Formula 1B, one or two selected from among X₁ to X₄ may be NRₓ, and the others may be O or S. Rₓ in NRₓ may be represented by Formula 4-1 or Formula 4-2, described herein. In Formula 1B, c1 may be an integer of 0 to 2.

In the polycyclic compound according to one or more embodiments, represented by Formula 1B, if (e.g., when) Rₓ is represented by Formula 4-2, q in Formula 4-2 may be an integer of 2 or greater (e.g., an integer of 2 to 5). In one or more embodiments, in Formula 1B, if (e.g., when) two selected from among X₁ to X₄ are NRₓ and all of two Rₓ are represented by Formula 4-2, at least one selected from among R₁ to R₅ may be represented by Formula 4-1 or at least one selected from among R₁ to R₅ may be bonded to an adjacent group to form a ring of Formula 3.

The descriptions provided in Formula 1 and Formula 2 may be similarly applied to Rₓ, R₁ to R₅, and a, b, d, and e in Formula 1B.

Formula 1B may be represented by any one selected from among Formulas 1B-1 to 1B-4.

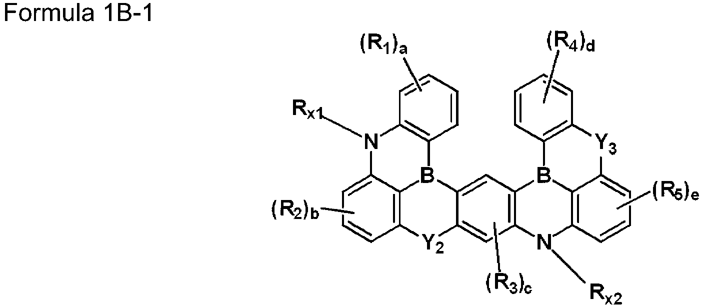

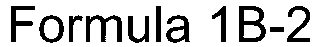

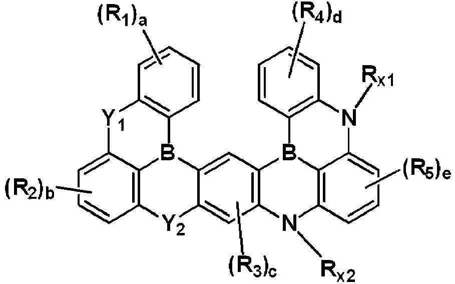

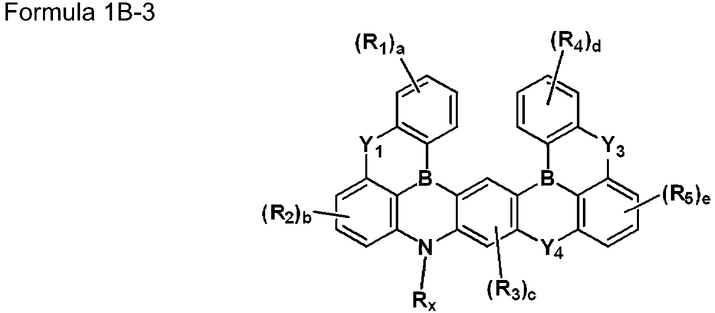

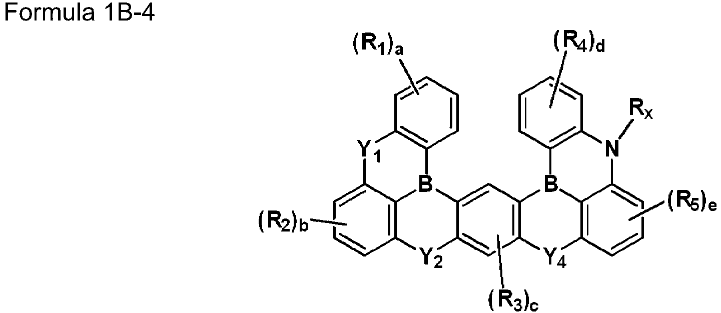

In Formulas 1B-1 to 1B-4, Y₁ to Y₄ may each independently be O or S. In Formulas 1B-1 to 1B-4, Rₓ₁ and Rₓ₂ may each independently be represented by Formula 4-1 or Formula 4-2, and if (e.g., when) both (e.g., simultaneously) Rₓ₁ and Rₓ₂ are represented by Formula 4-2, at least one selected from among R₁ to R₅ may be represented by Formula 4-1 or at least one selected from among R₁ to R₅ may be bonded to an adjacent group to form a ring of Formula 3.

The descriptions provided in Formula 1 and Formula 2 may be similarly applied to Rₓ, R₁ to R₅, and a to e in Formulas 1B-1 to 1B-4.

The polycyclic compound according to one or more embodiments may be represented by any one selected from among Formulas 1C-1 to 1C-3.

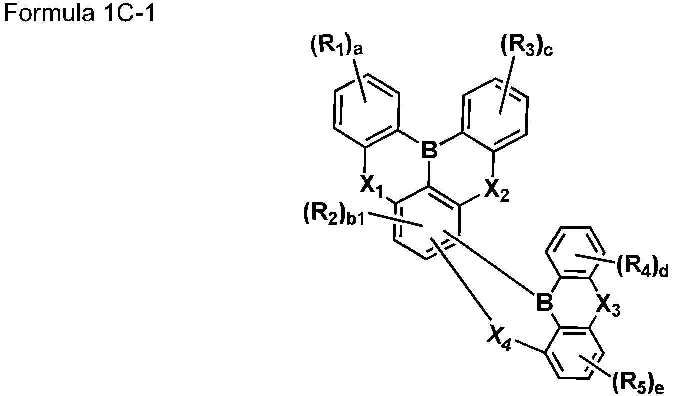

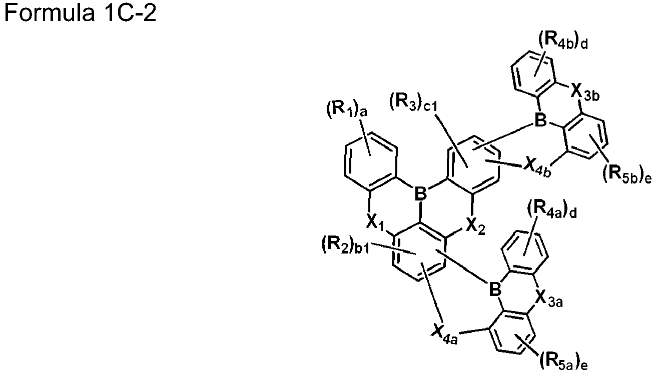

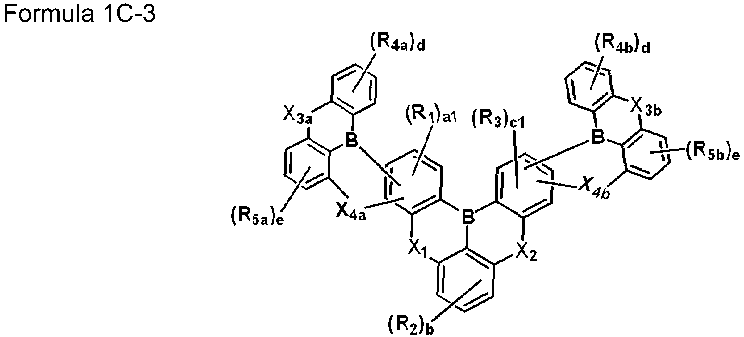

In Formulas 1C-2 and 1C-3, X₃ₐ, X_{3b}, X₄ₐ, and X_{4b} may each independently be O, S, or NRₓ, and R₄ₐ, R_{4b}, R₅ₐ, and R_{5b} may each independently be a hydrogen atom, a deuterium atom, a halogen atom, a cyano group, a substituted or unsubstituted amino group, a substituted or unsubstituted alkyl group having 1 to 20 carbon atoms, a substituted or unsubstituted hydrocarbon ring having 6 to 30 ring-forming carbon atoms, a substituted or unsubstituted heterocycle having 3 to 30 ring-forming carbon atoms, or may be bonded to an adjacent group to form a ring of Formula 3.

In Formulas 1C-1 and 1C-2, b1 may be 0 or 1, and c1 may be an integer of 0 to 2.

The descriptions provided in Formula 1 and Formula 2 may be similarly applied to X₁ to X₄, R₁ to R₅, and a to e in Formulas 1C-1, 1C-2, and 1C-3.

In the polycyclic compound according to one or more embodiments, represented by Formula 1 described herein, at least one hydrogen atom may be substituted with a deuterium atom.

The polycyclic compound according to one or more embodiments may be represented by any one selected from among the compounds in Compound Group 1. The light-emitting element ED according to one or more embodiments may include at least one selected from among the compounds in Compound Group 1. In Compound Group 1, D is a deuterium atom.

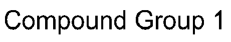

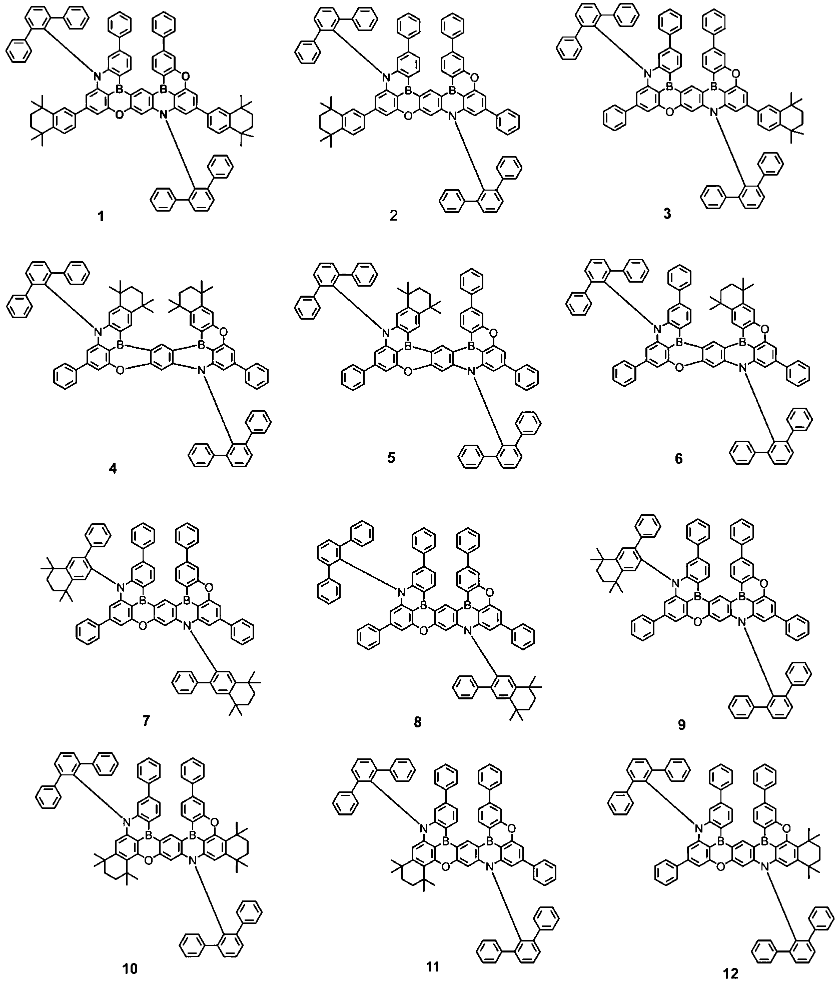

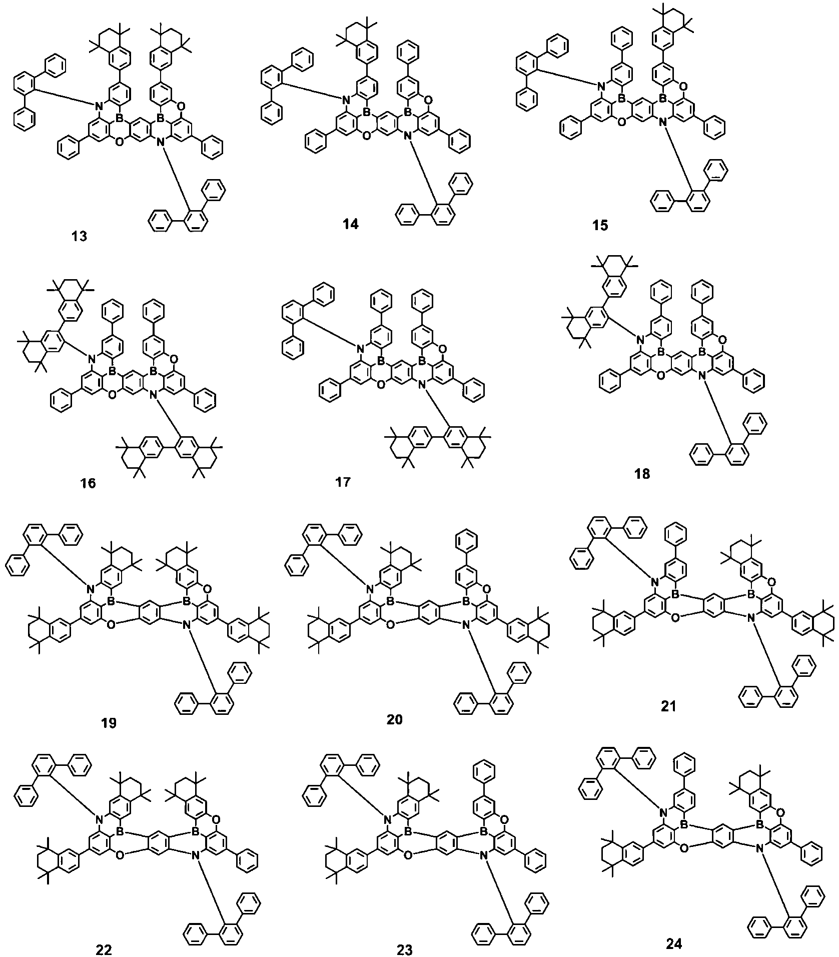

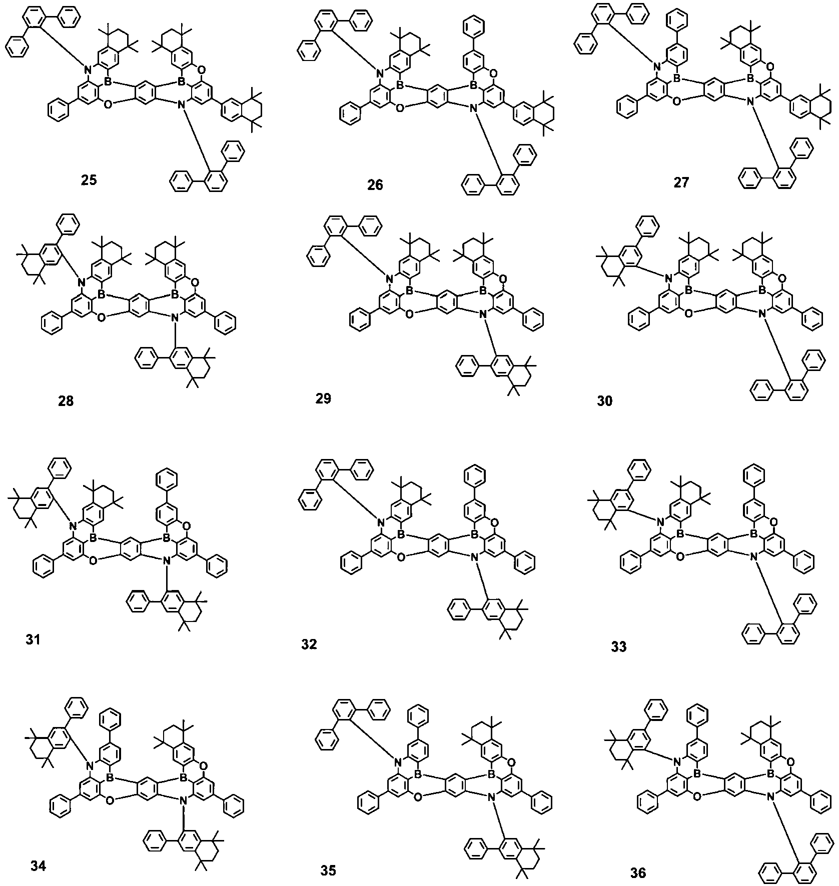

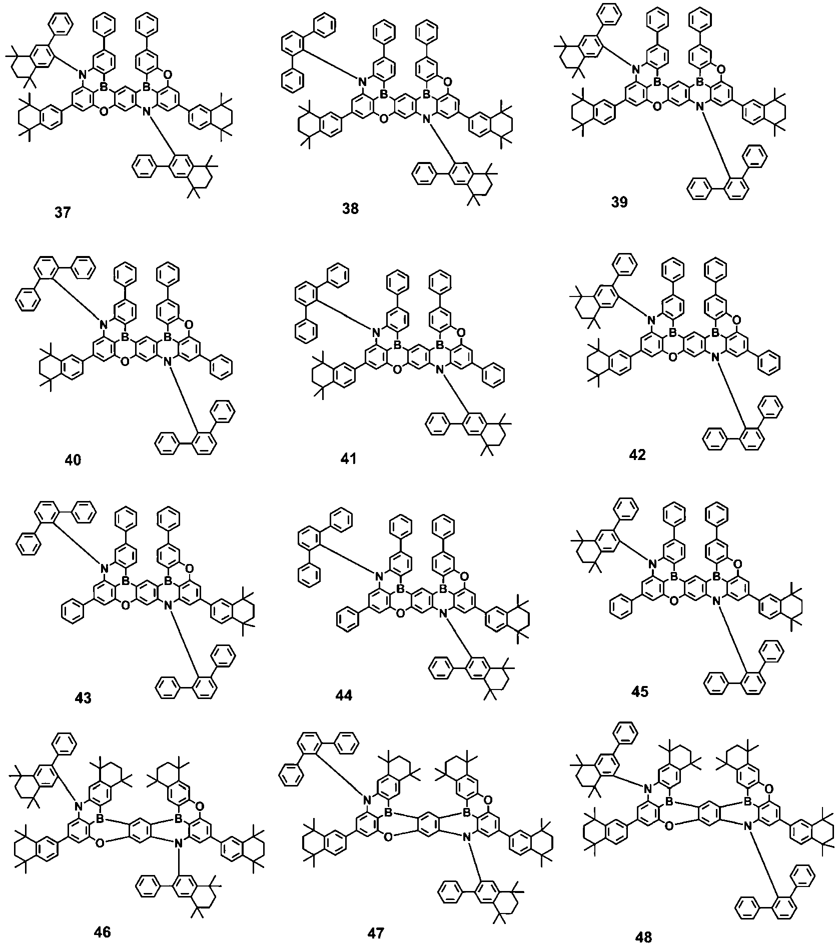

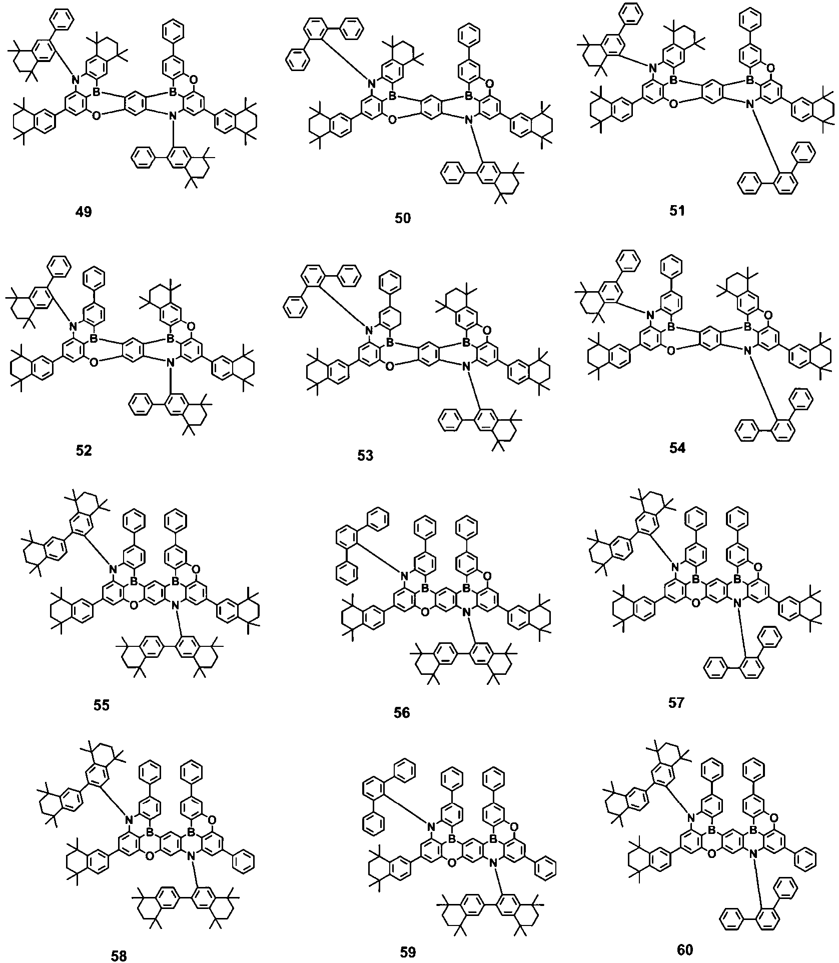

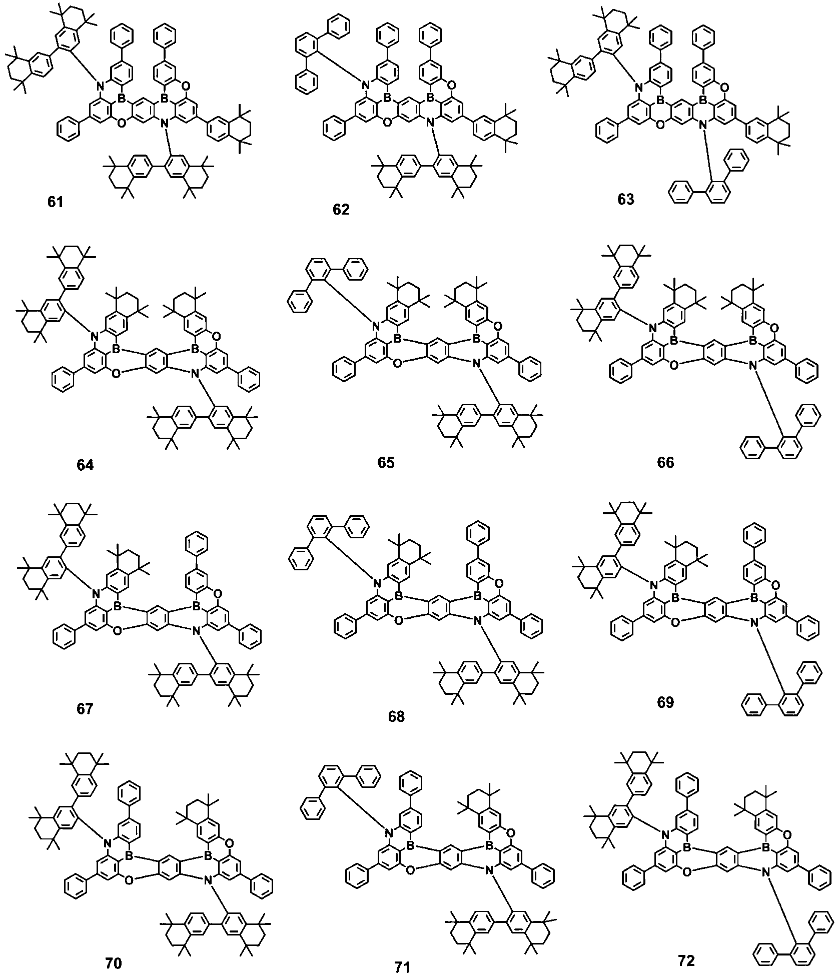

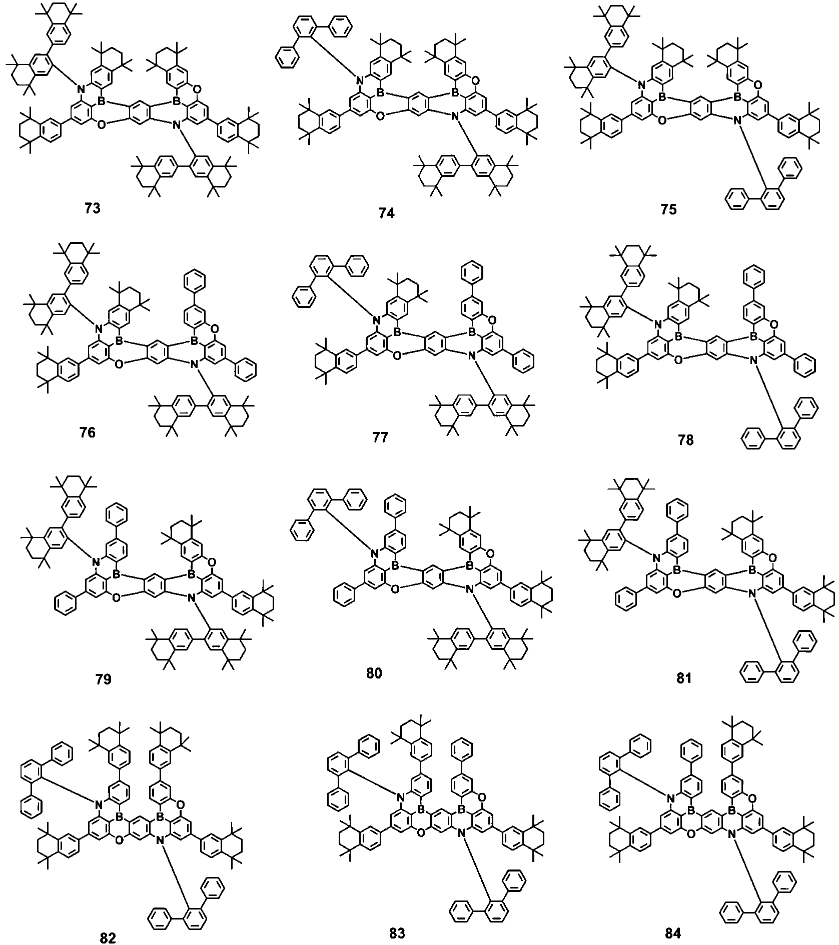

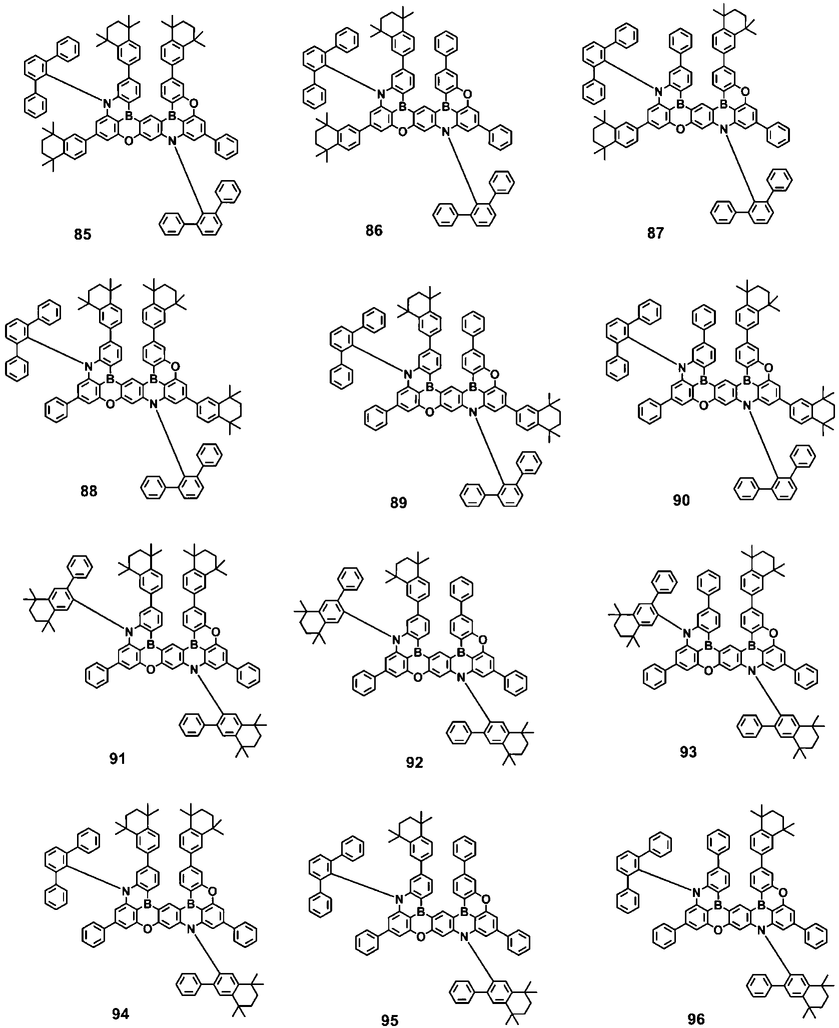

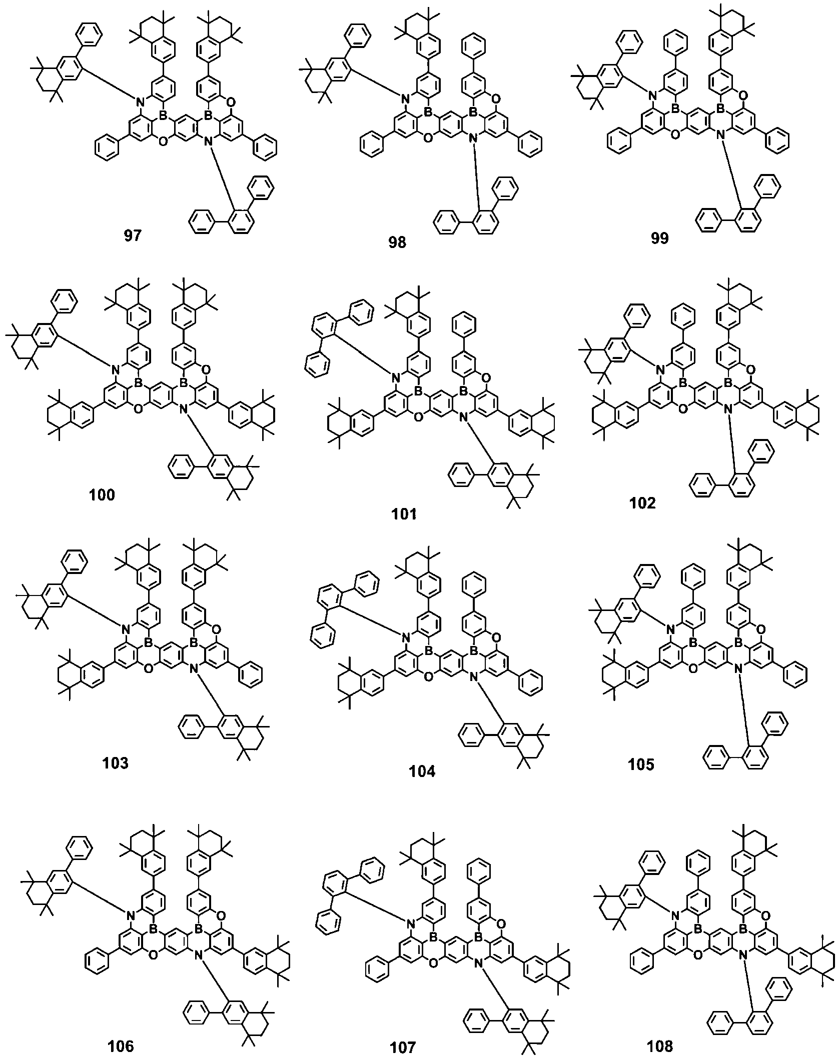

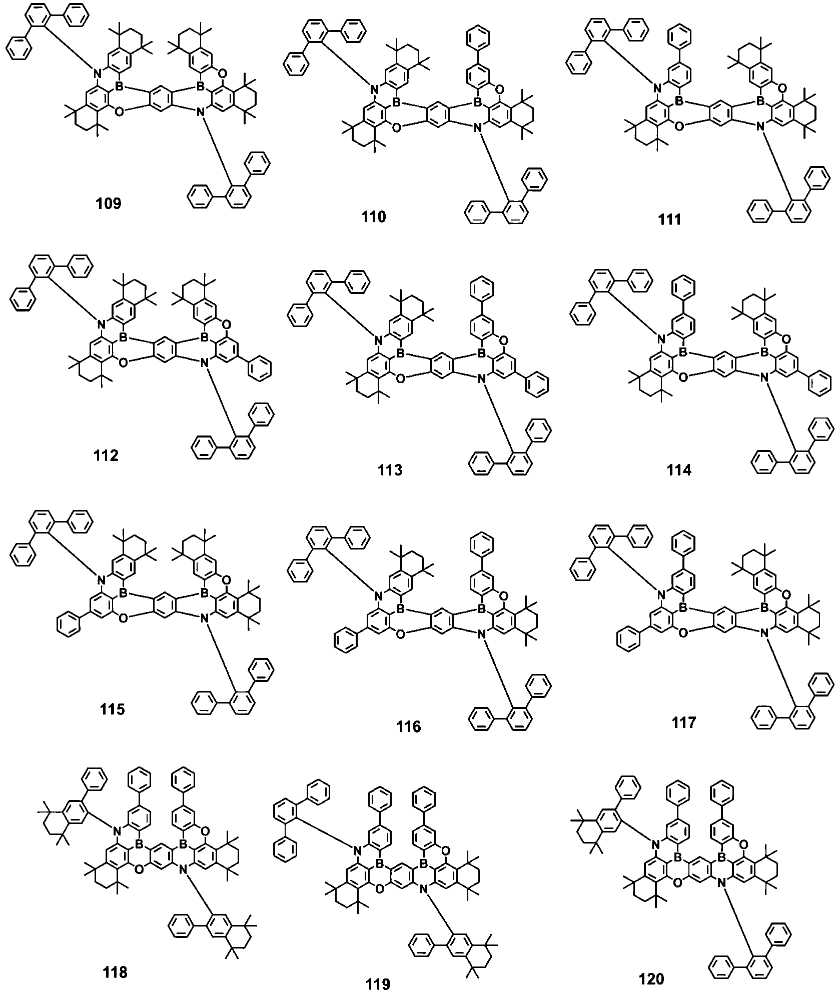

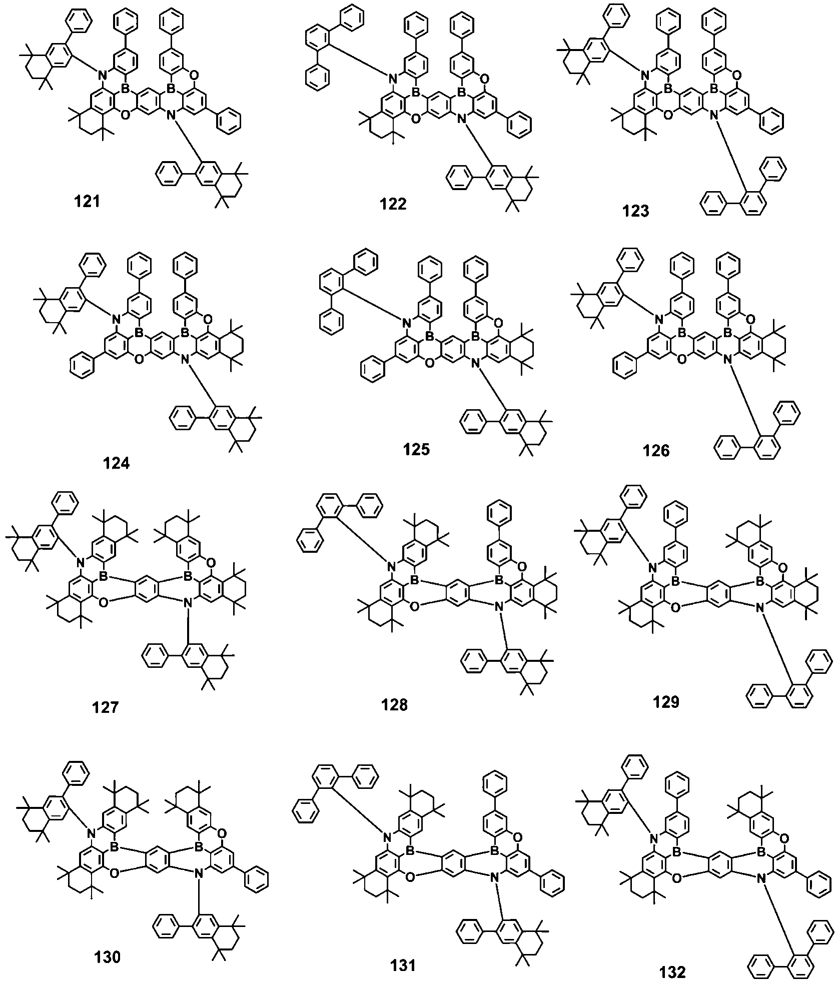

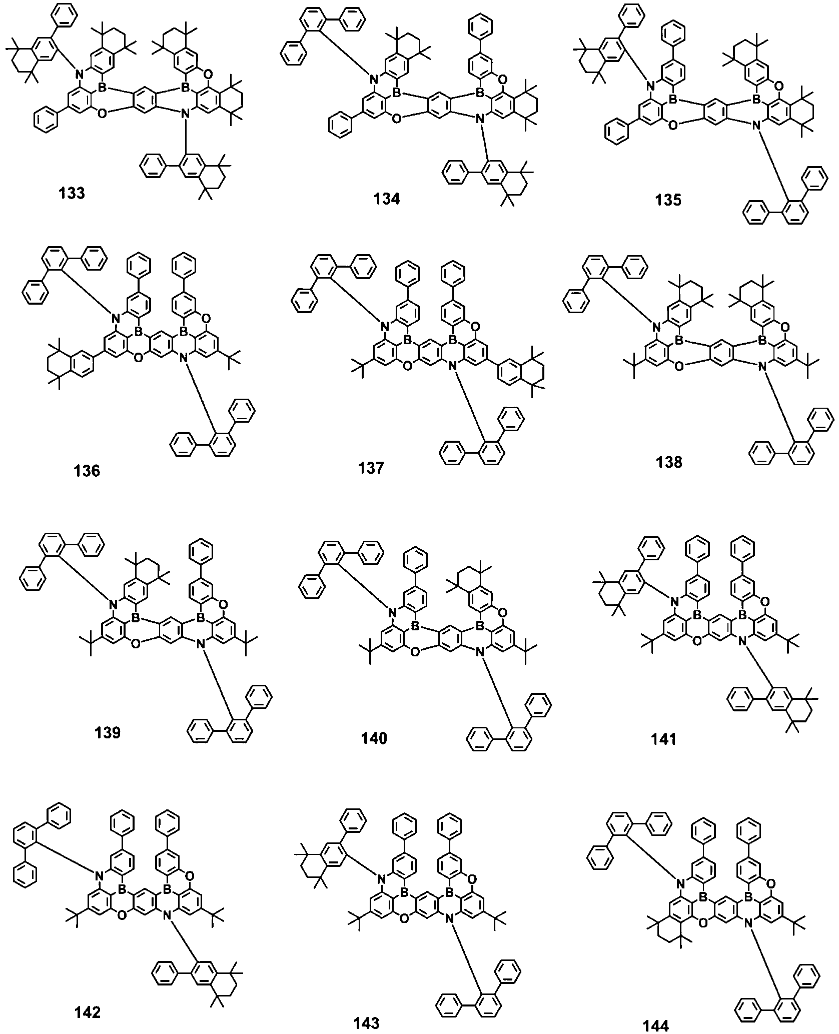

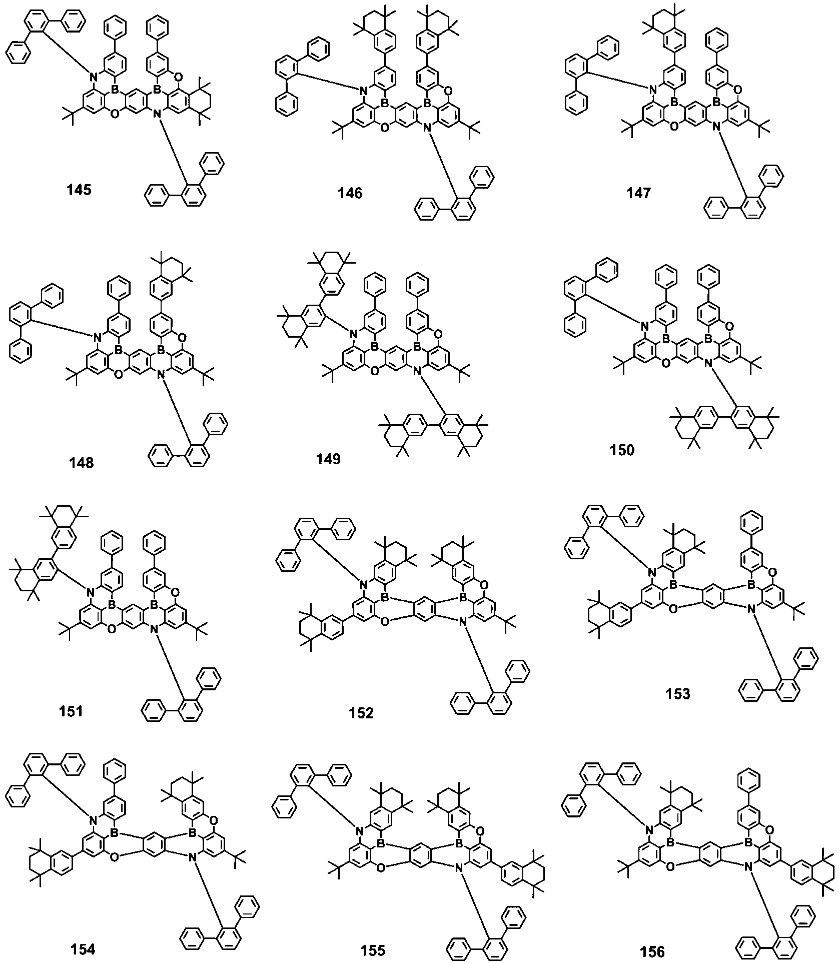

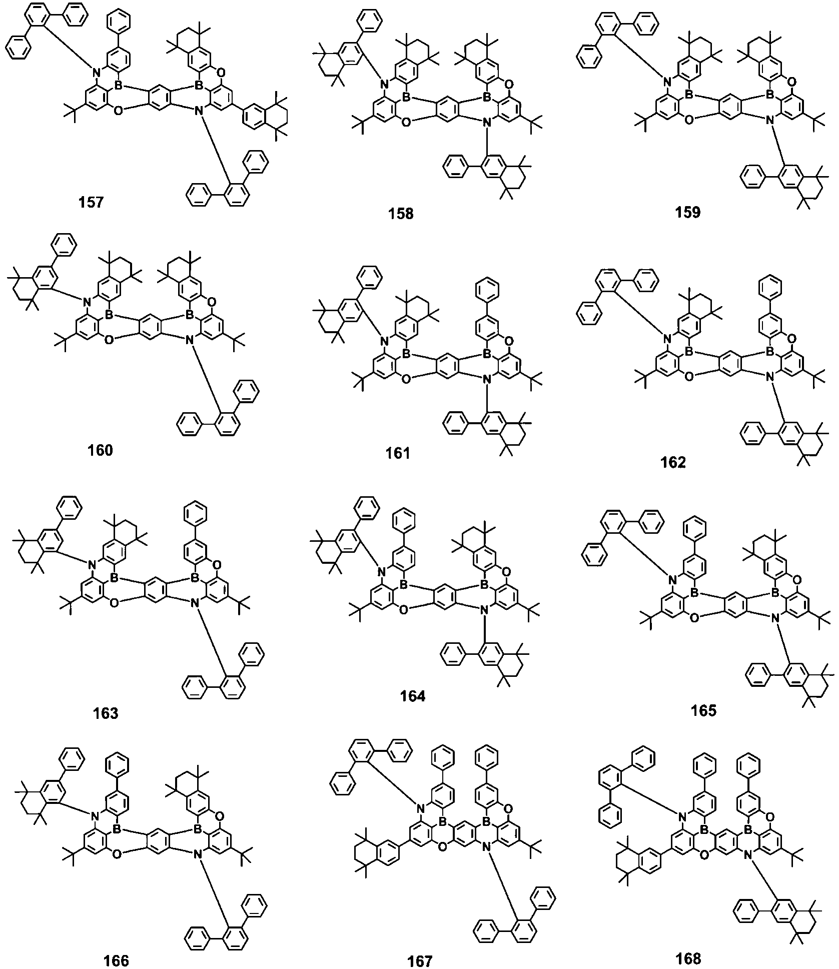

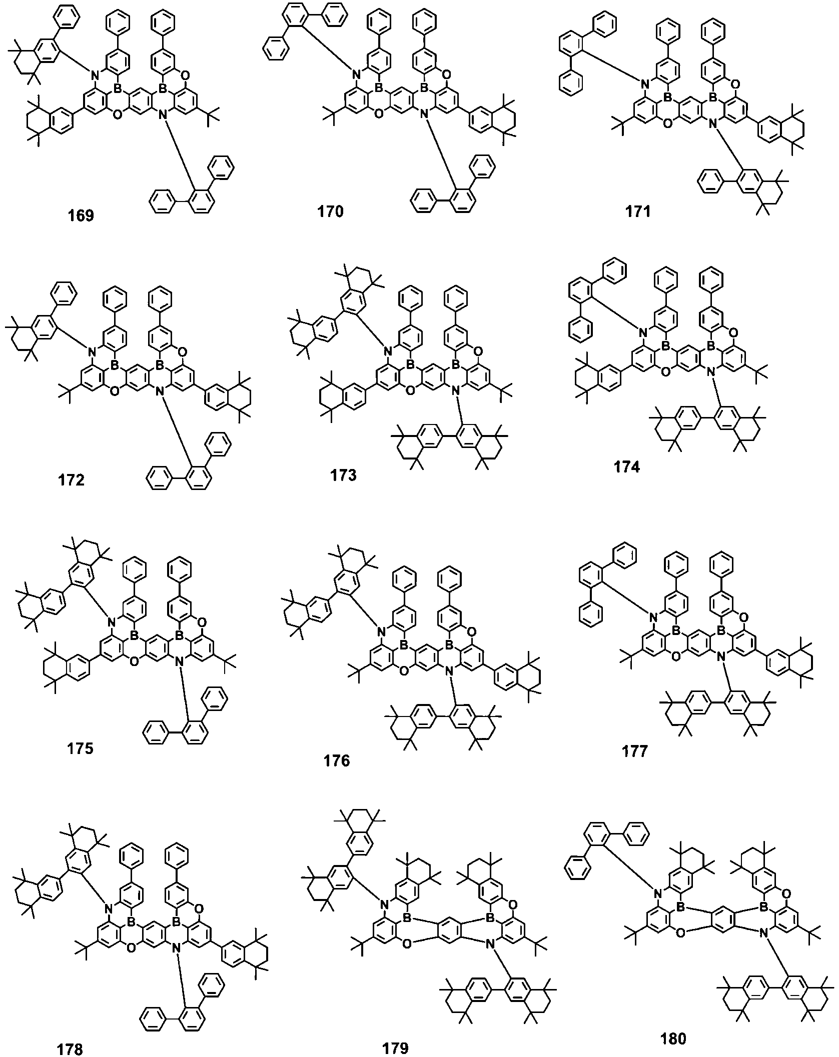

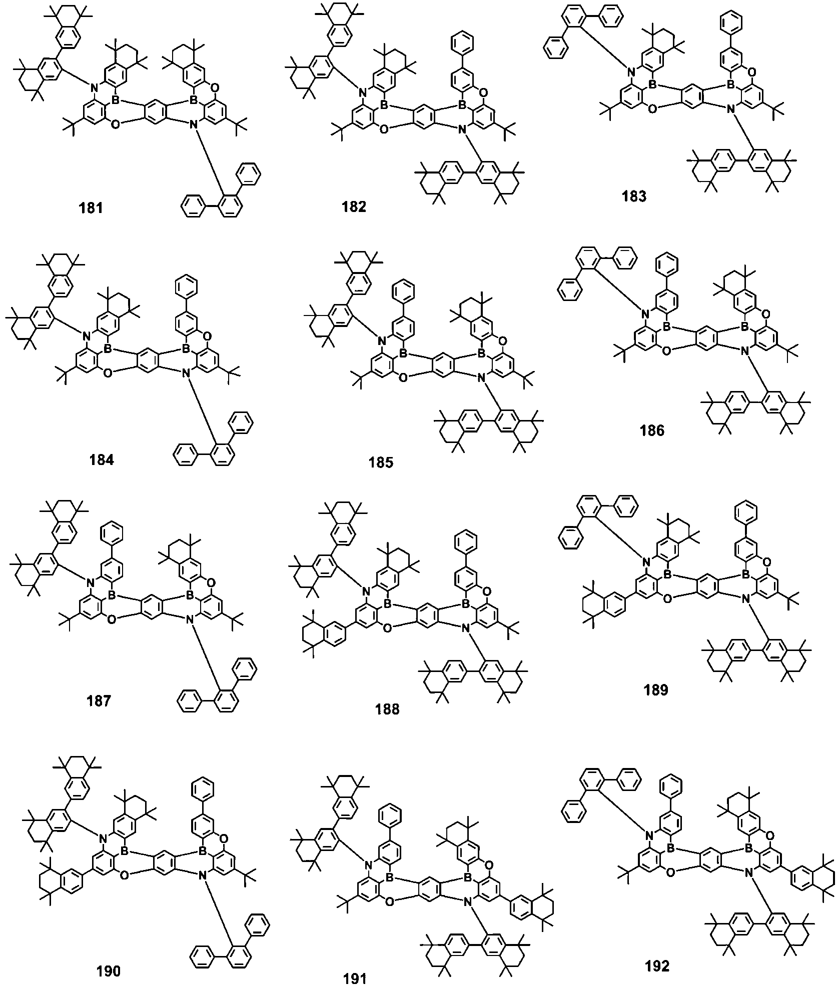

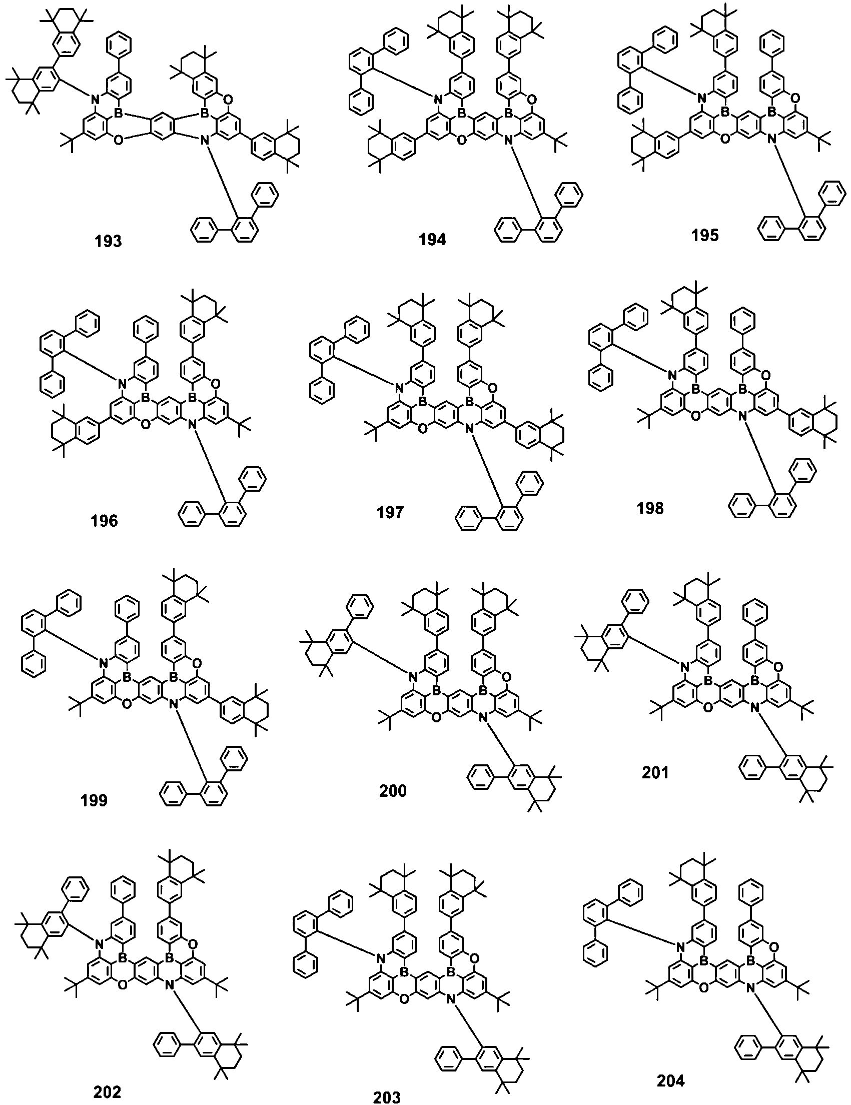

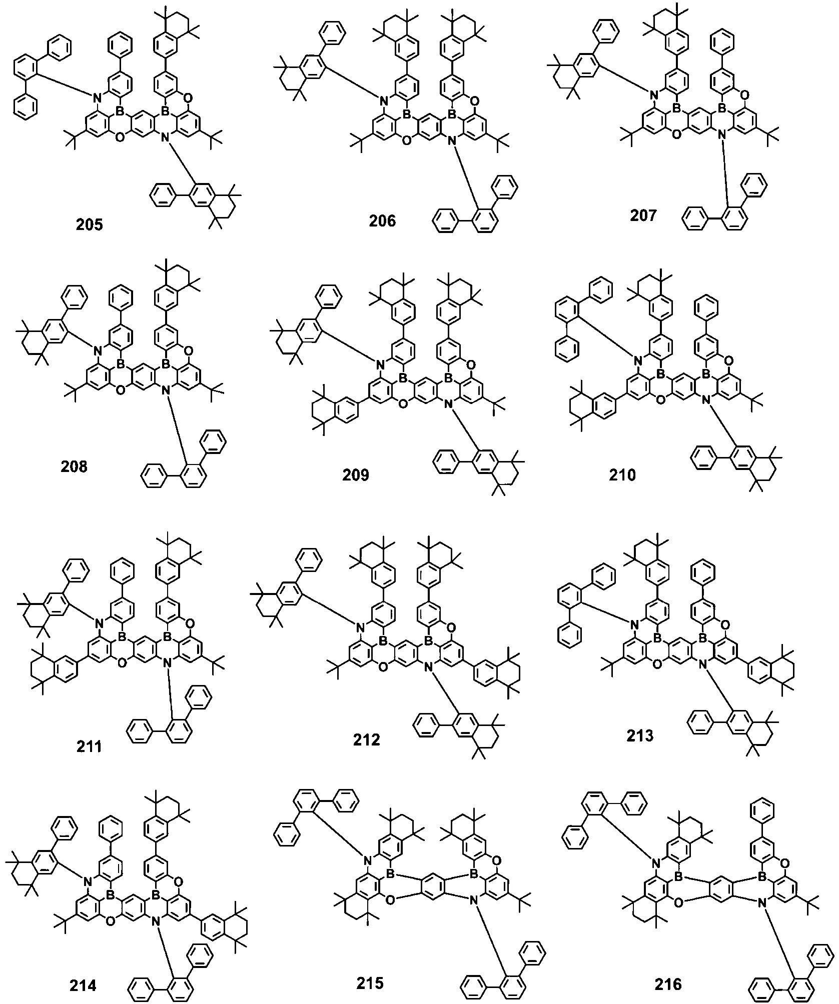

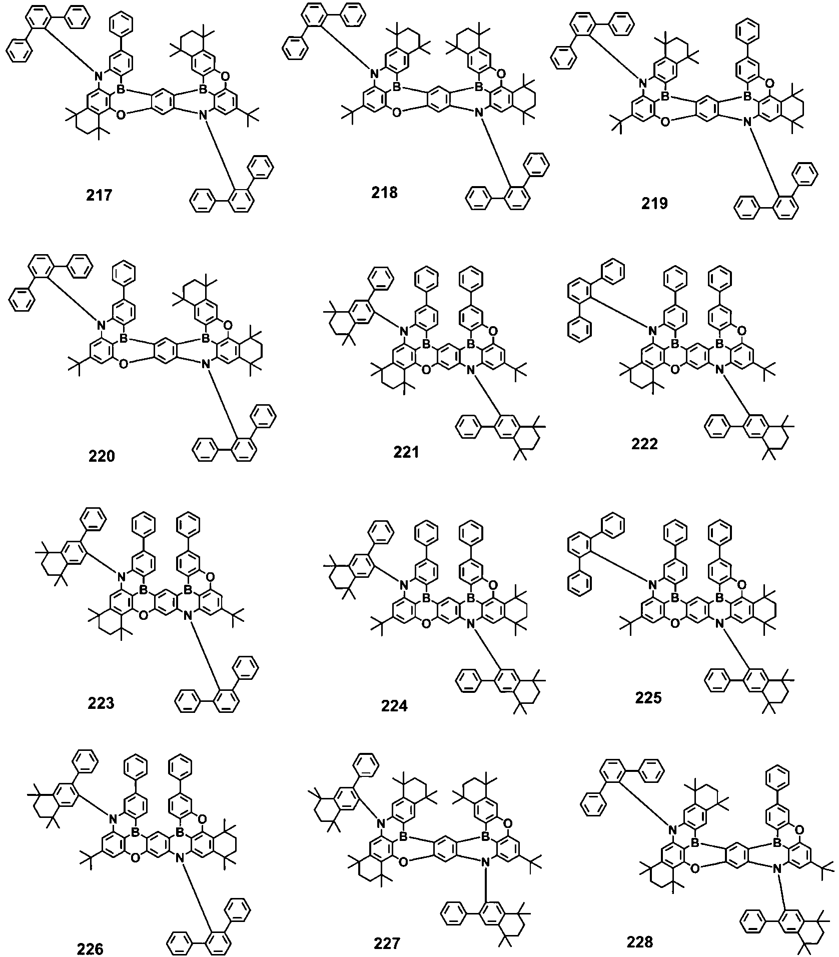

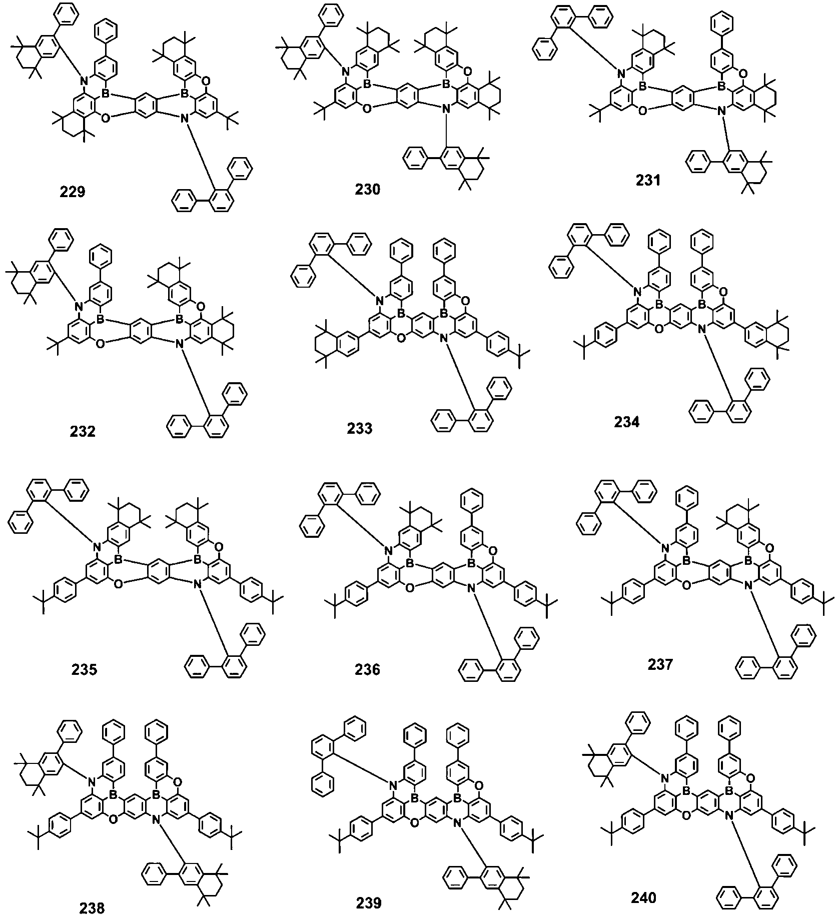

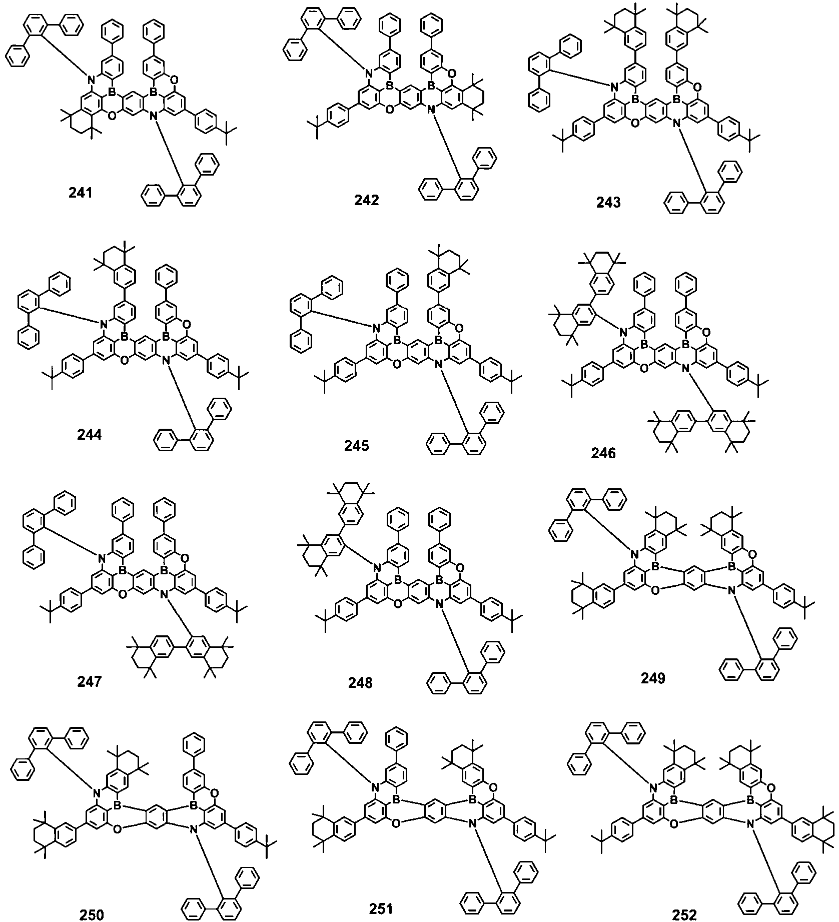

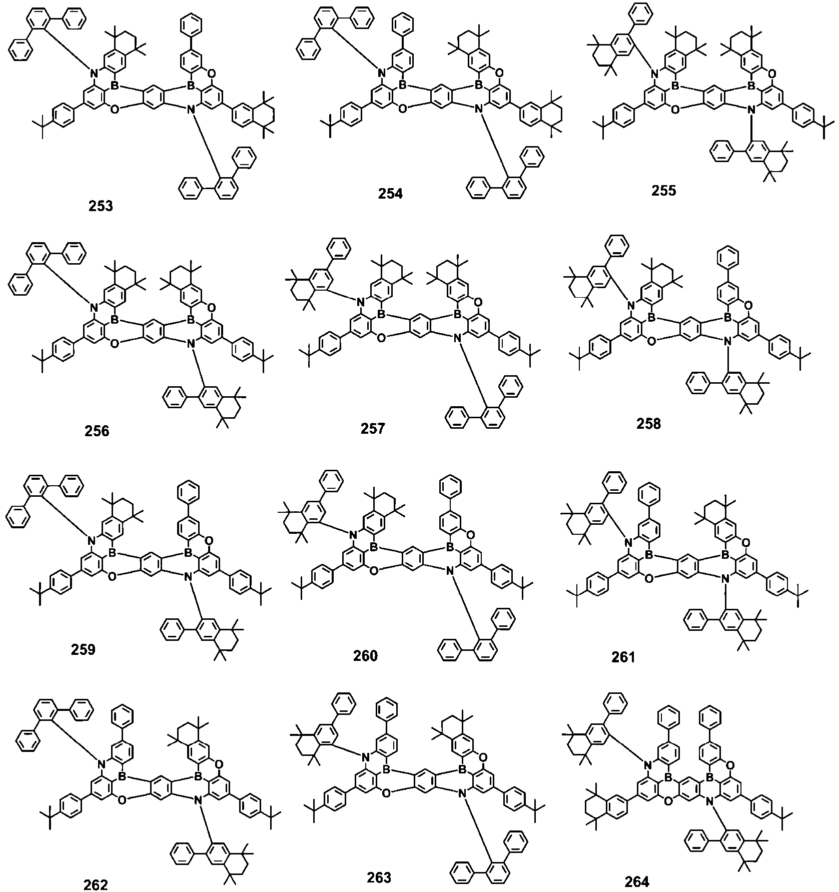

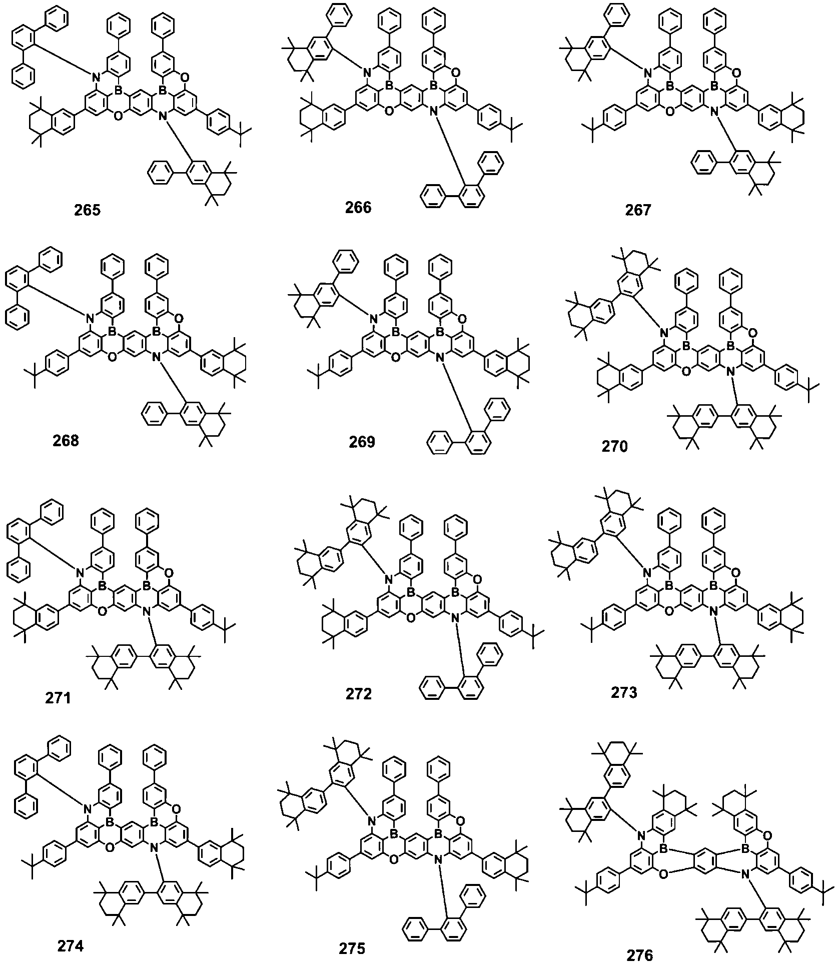

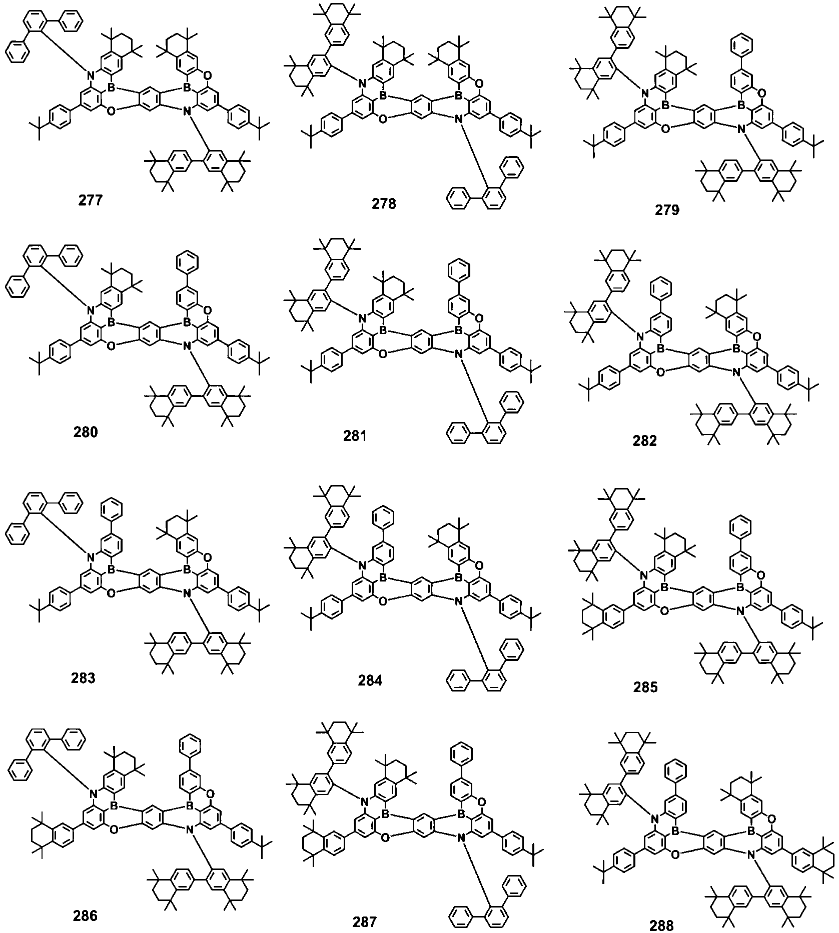

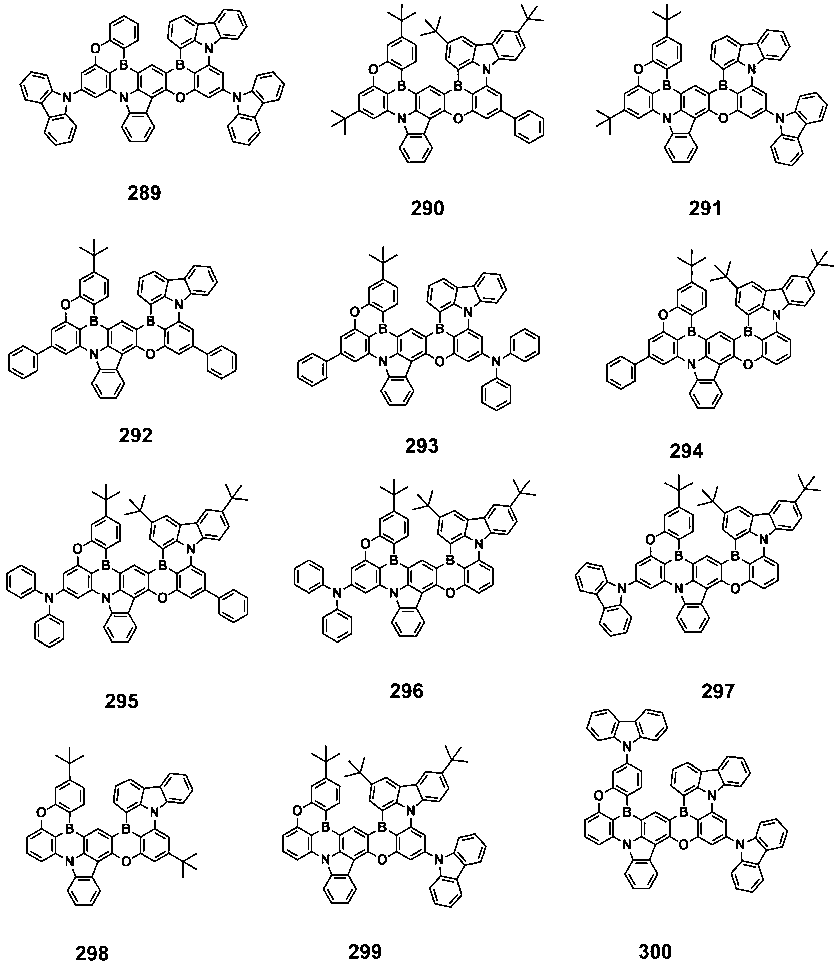

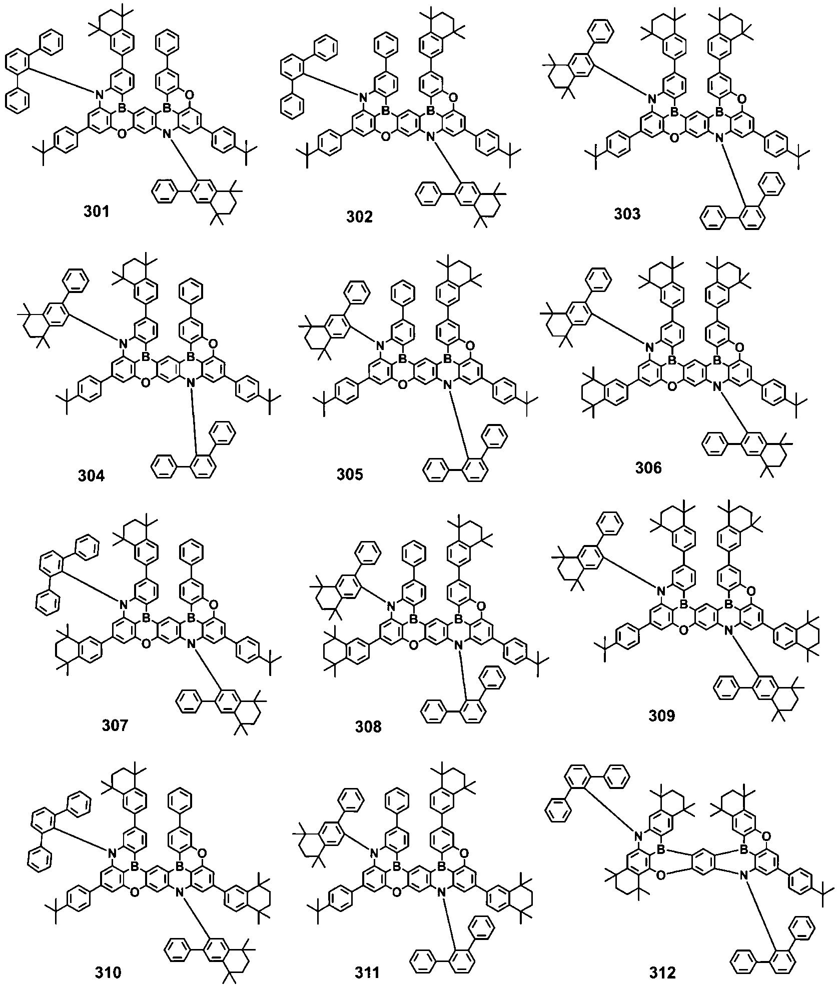

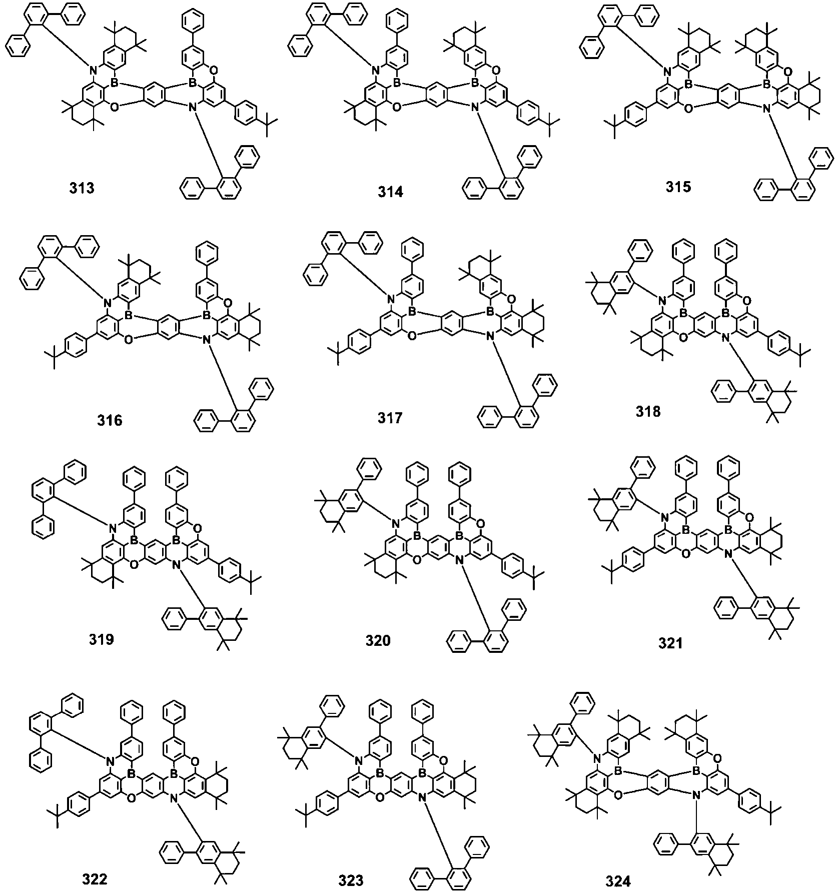

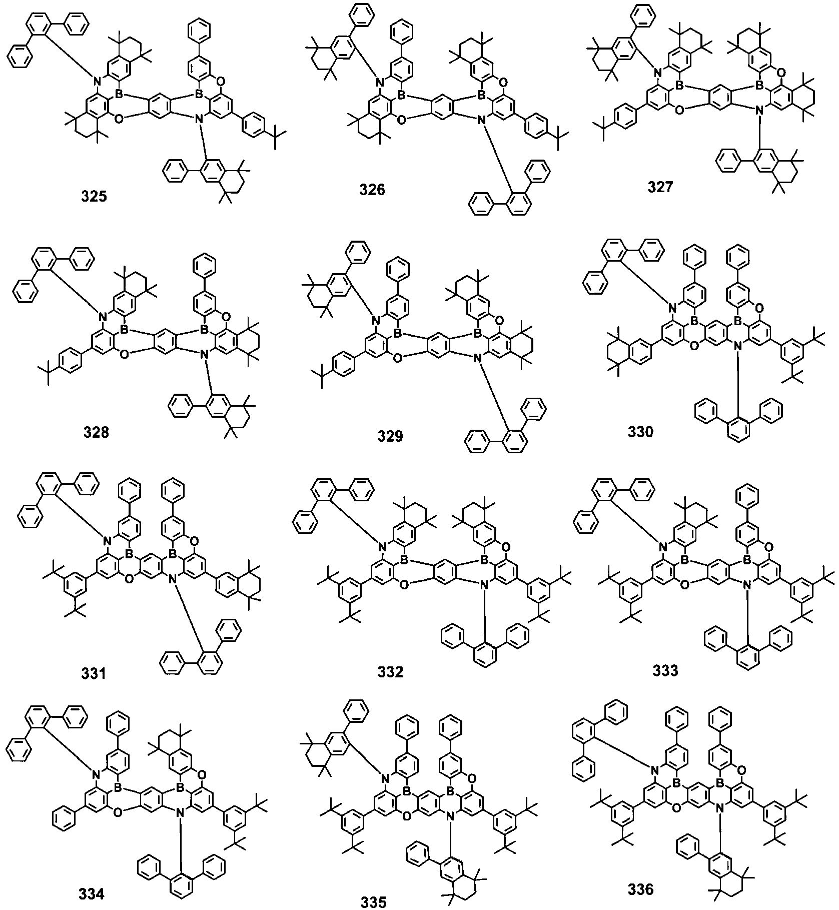

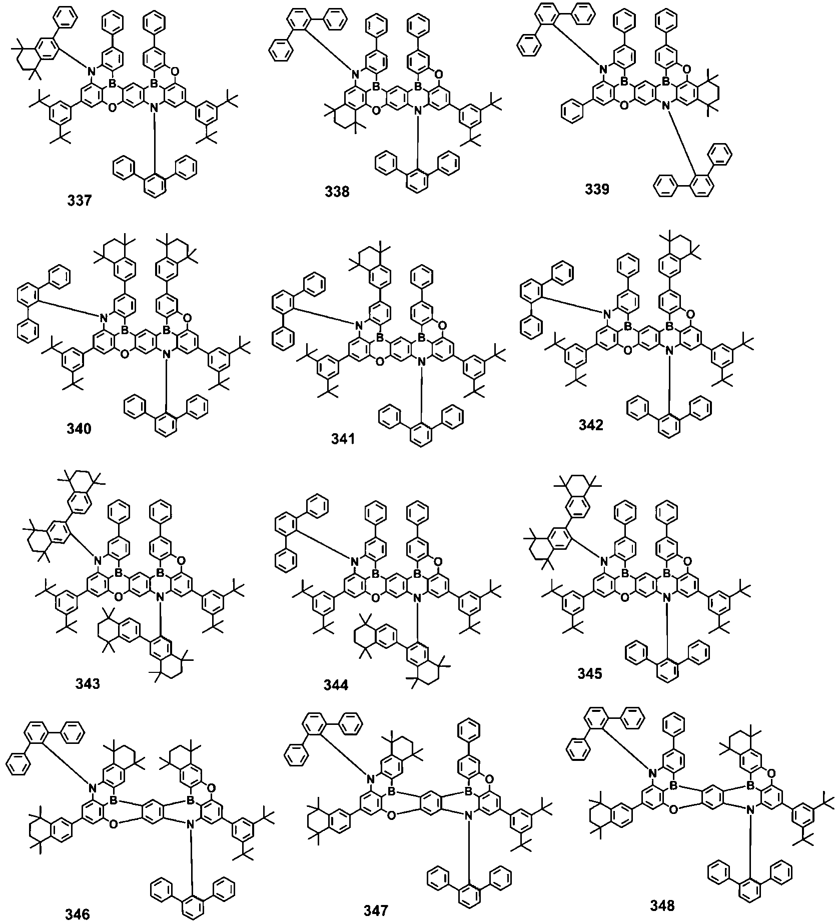

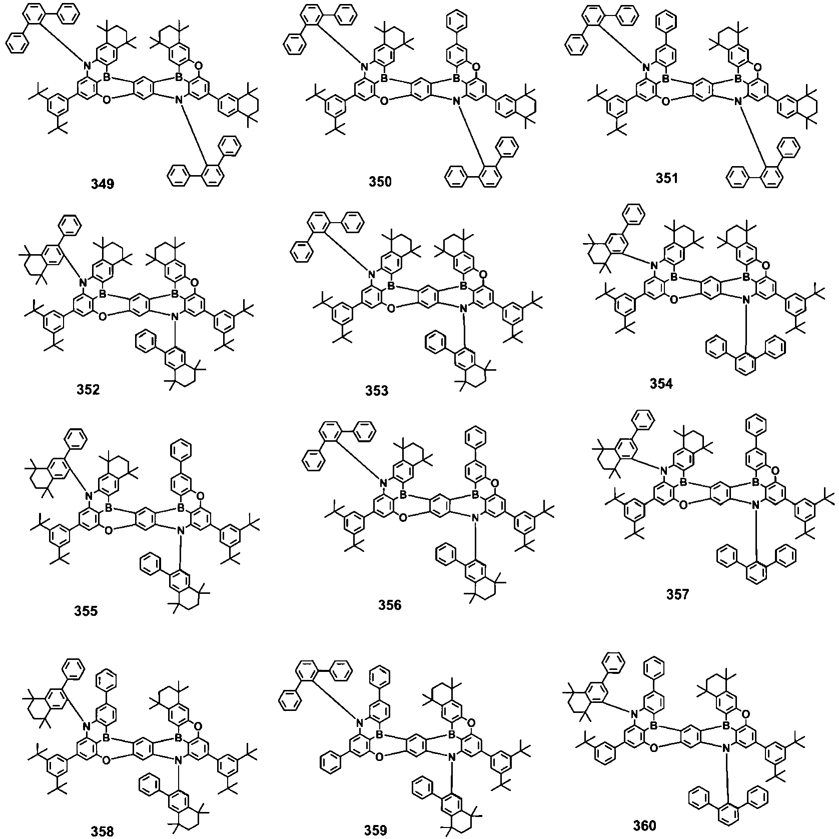

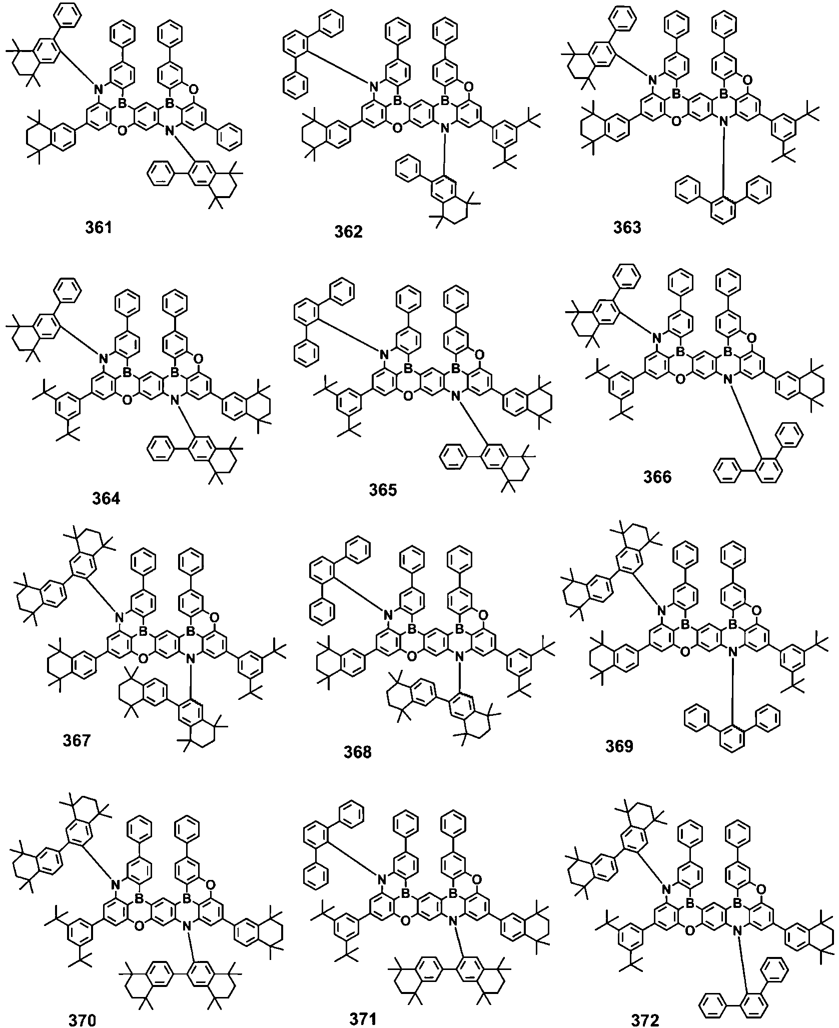

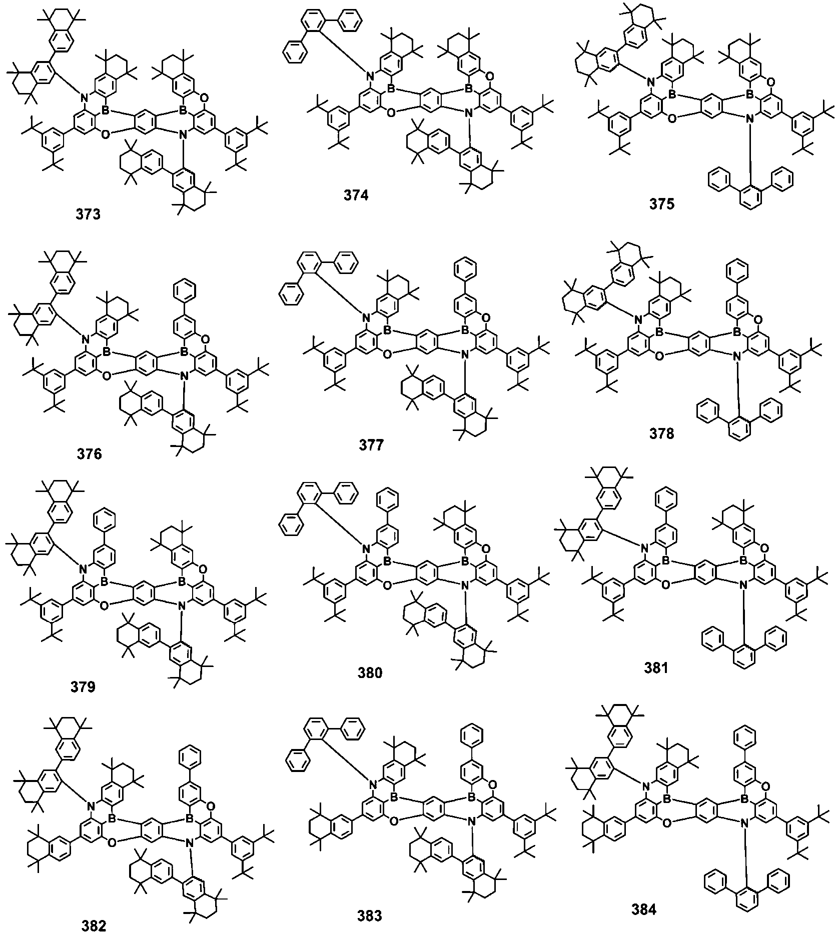

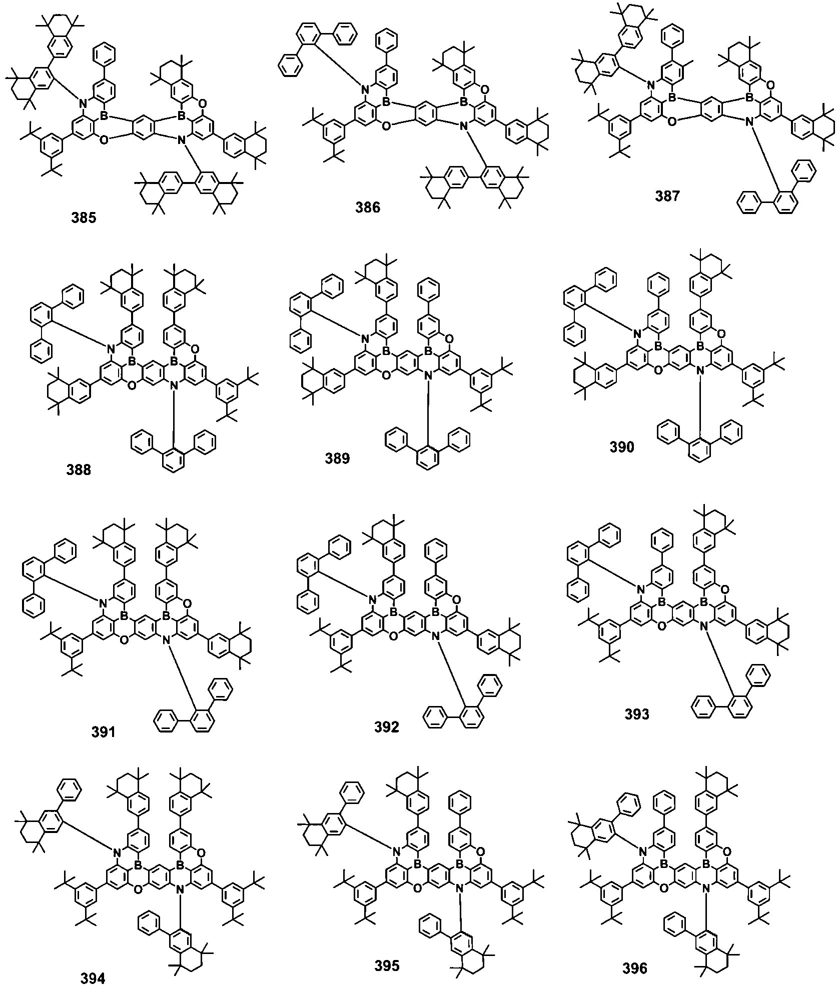

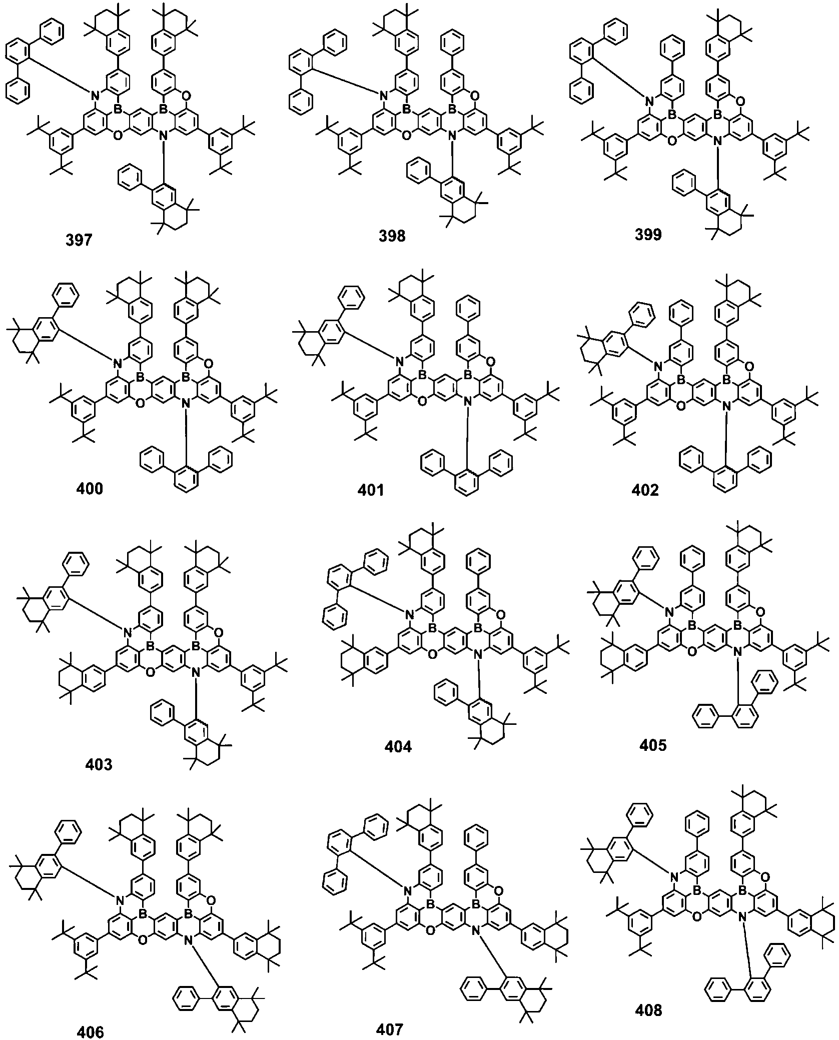

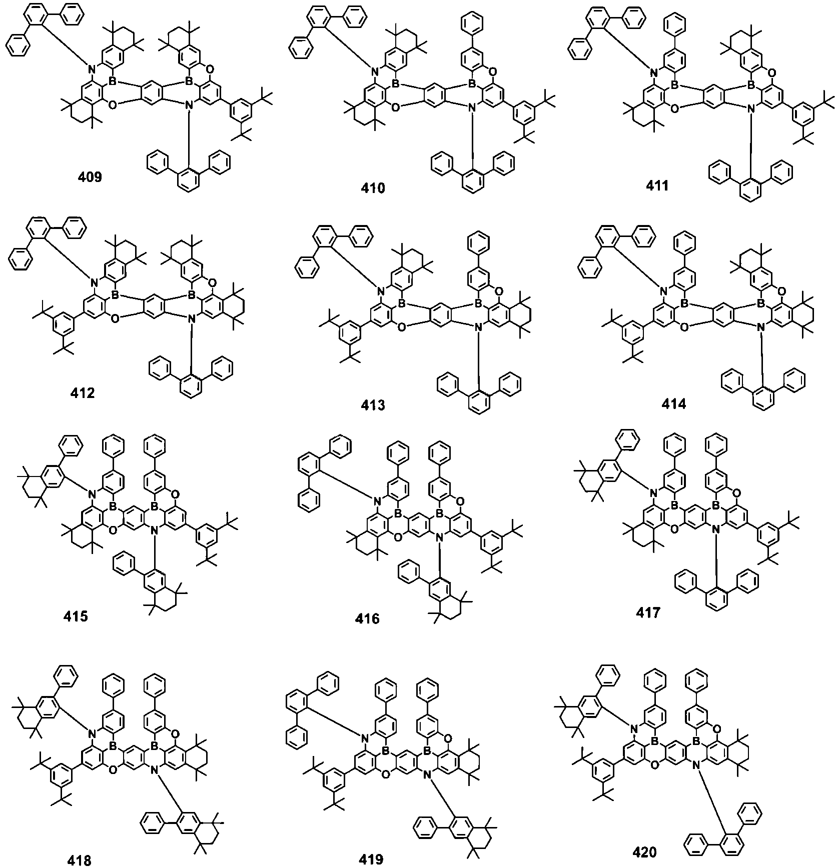

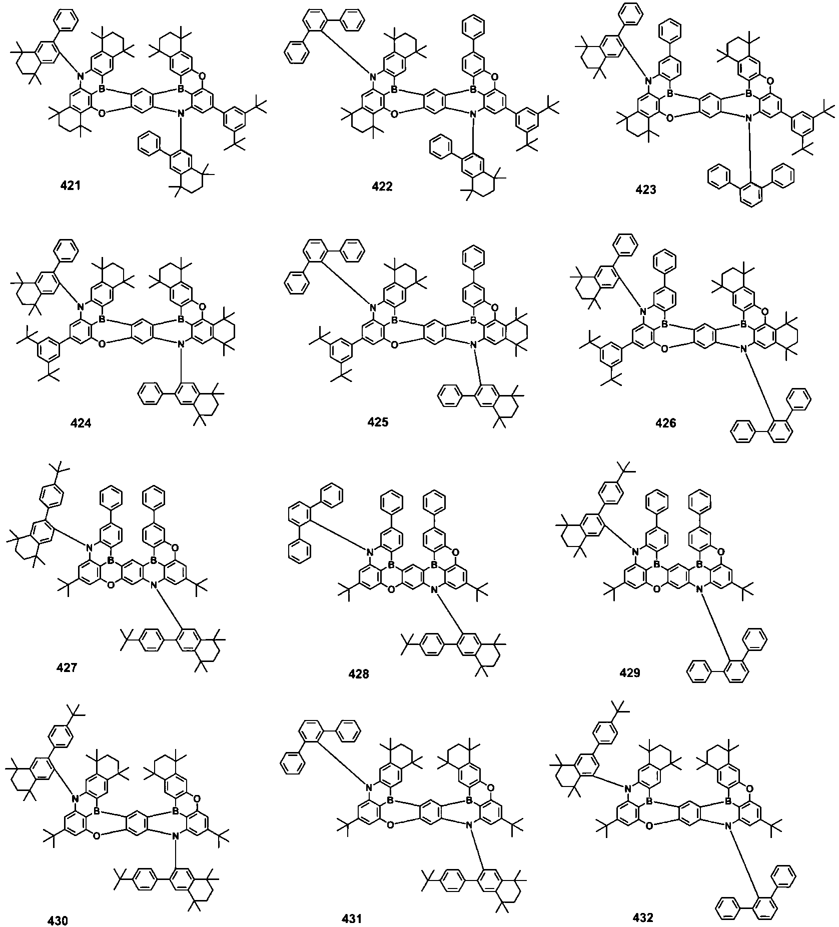

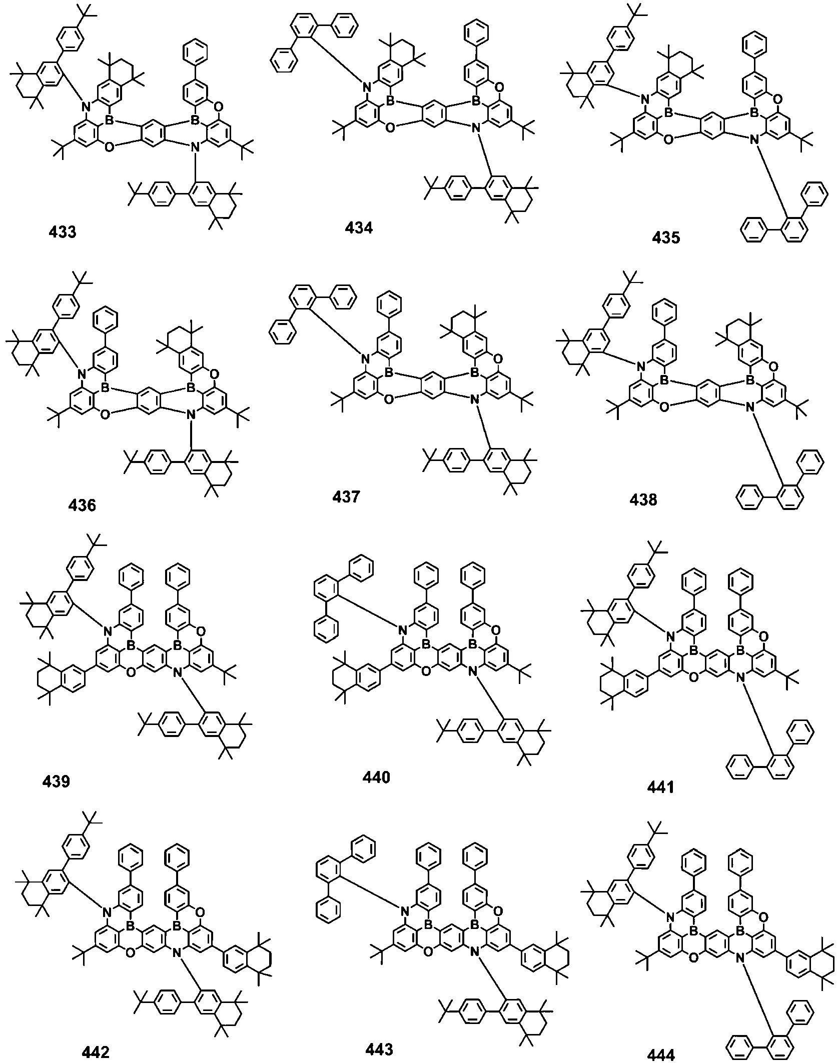

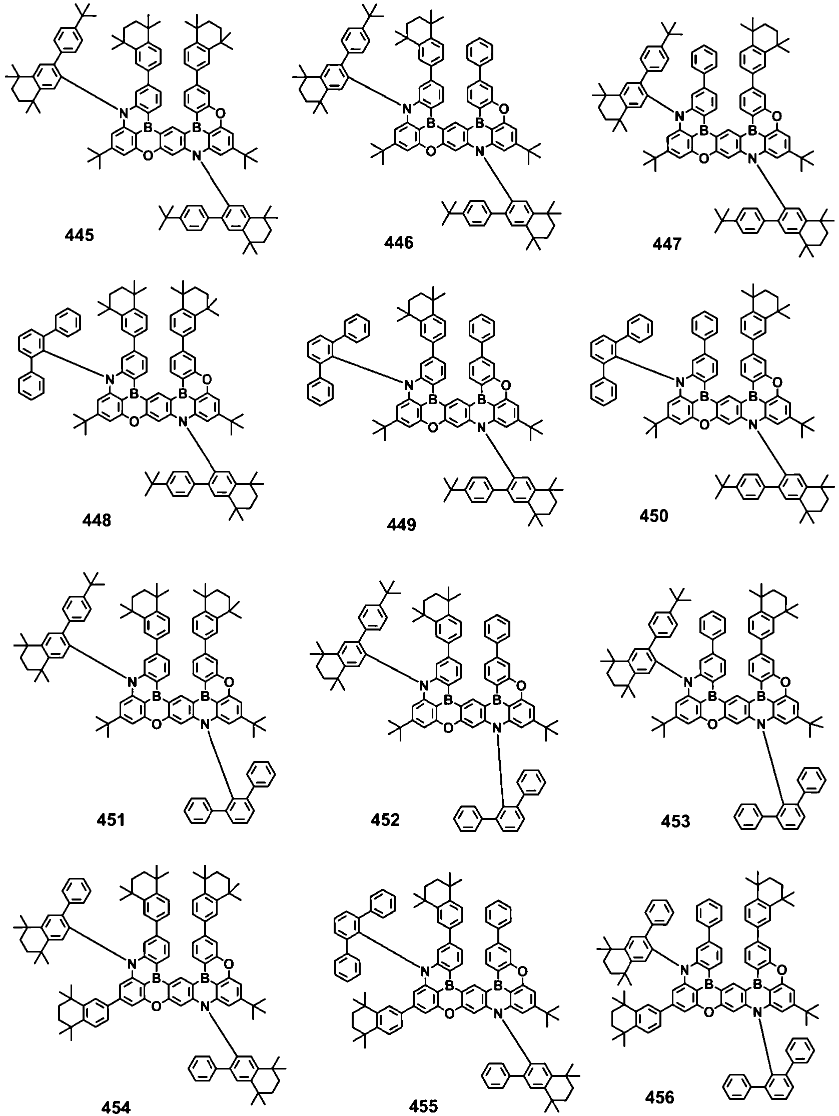

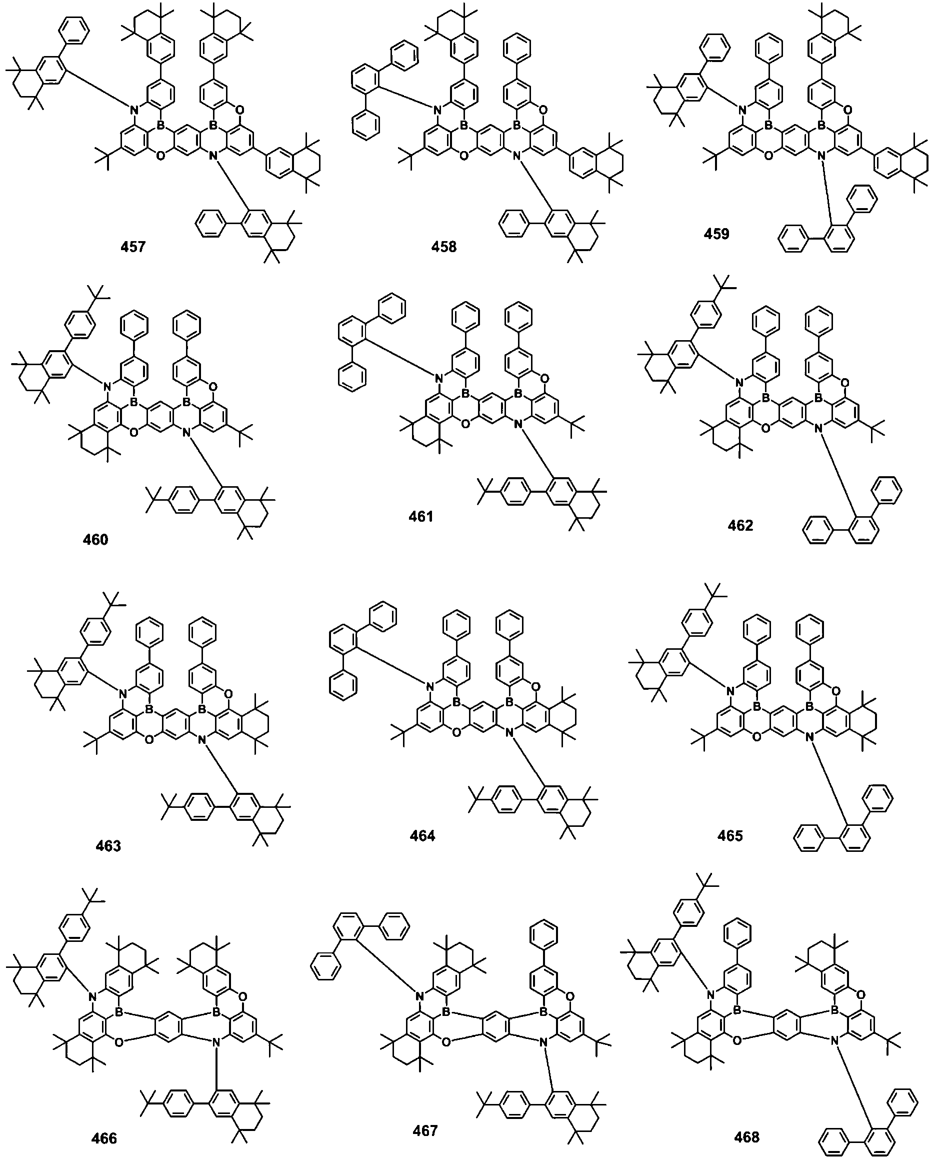

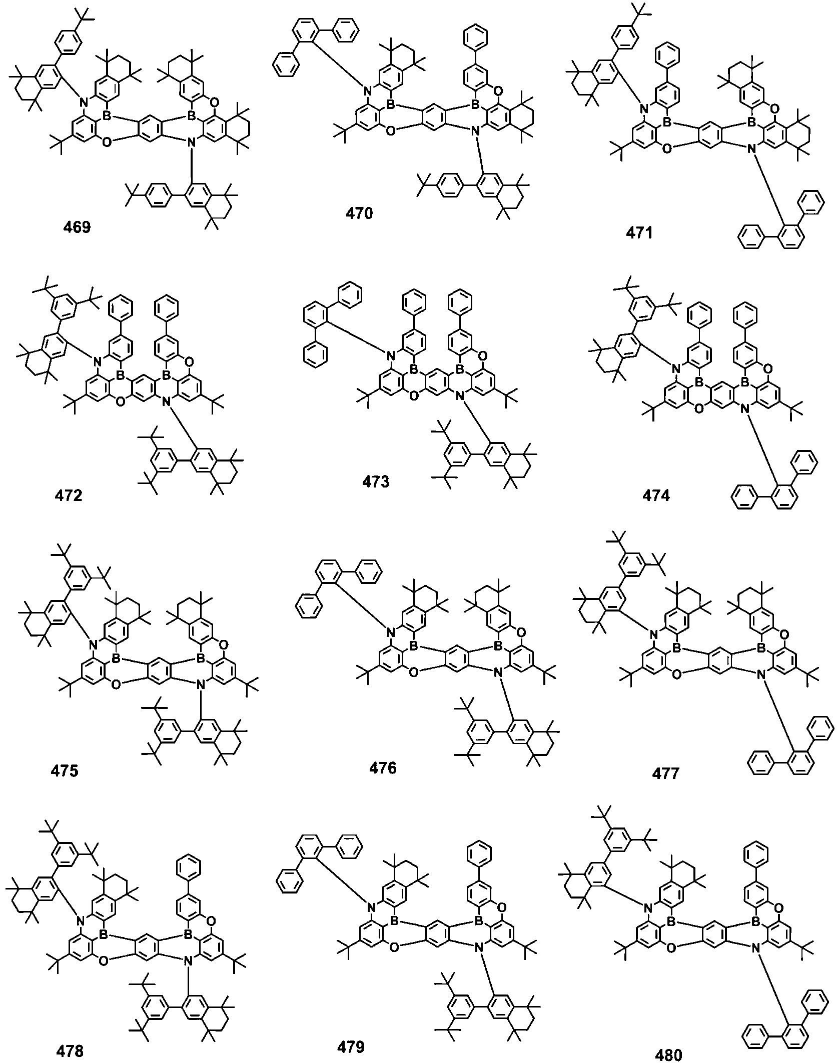

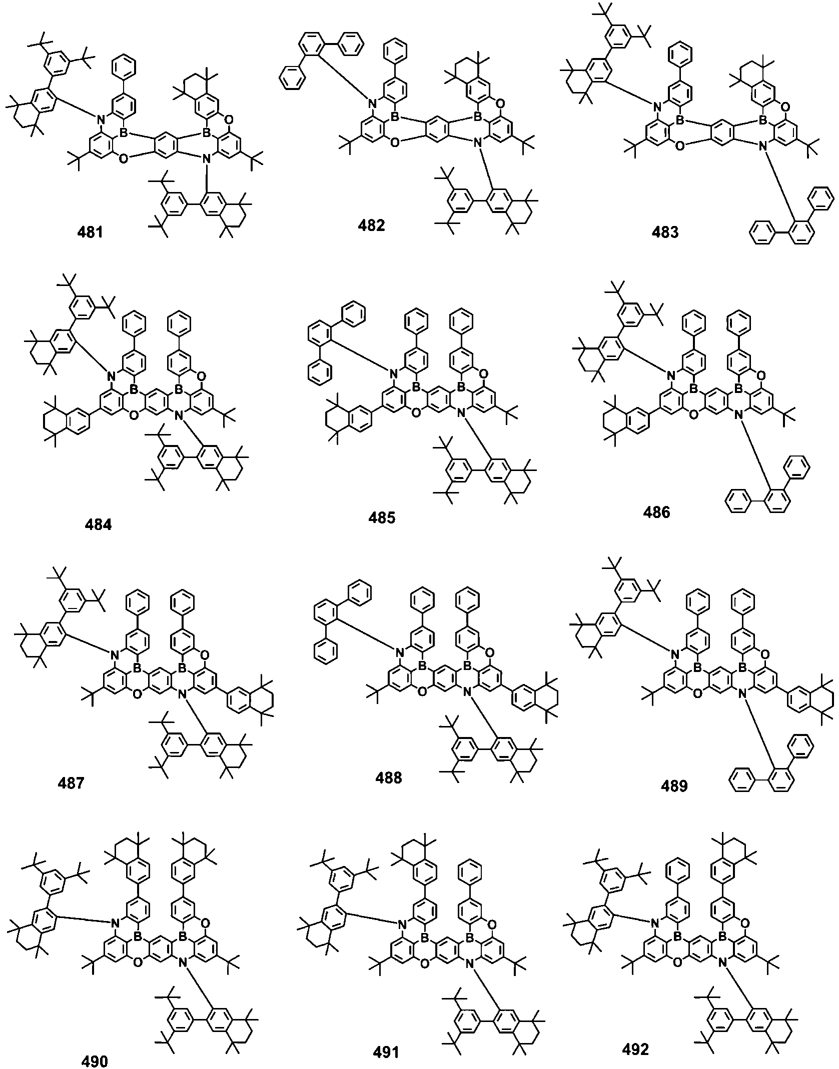

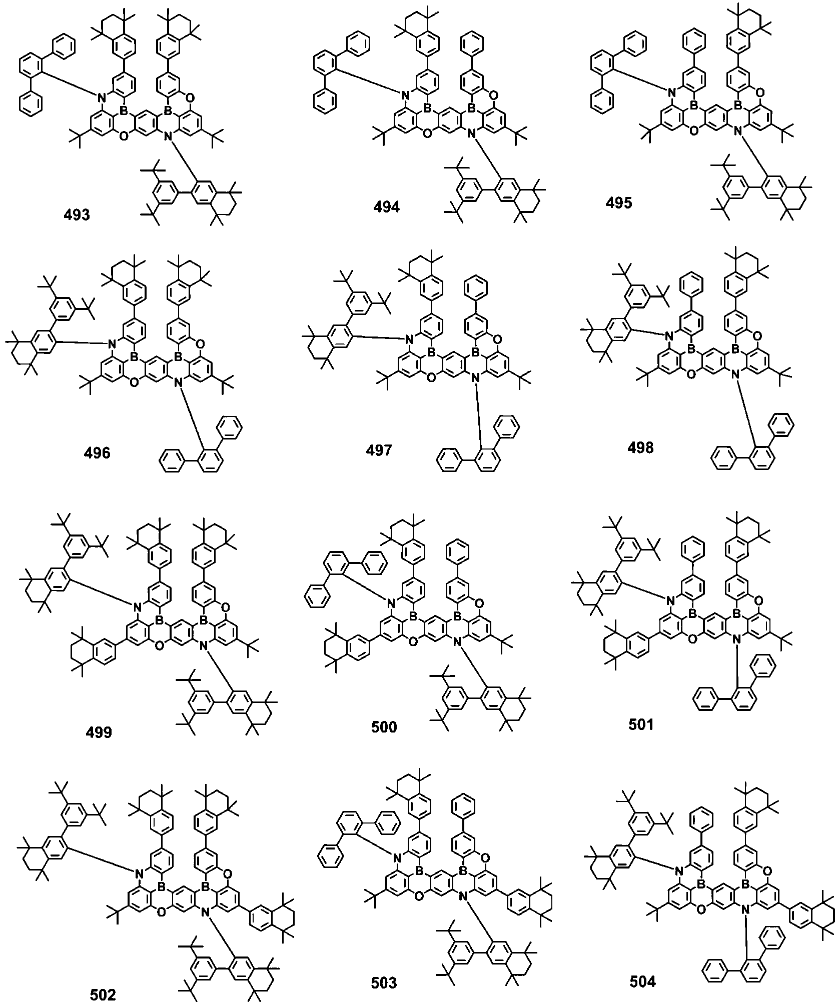

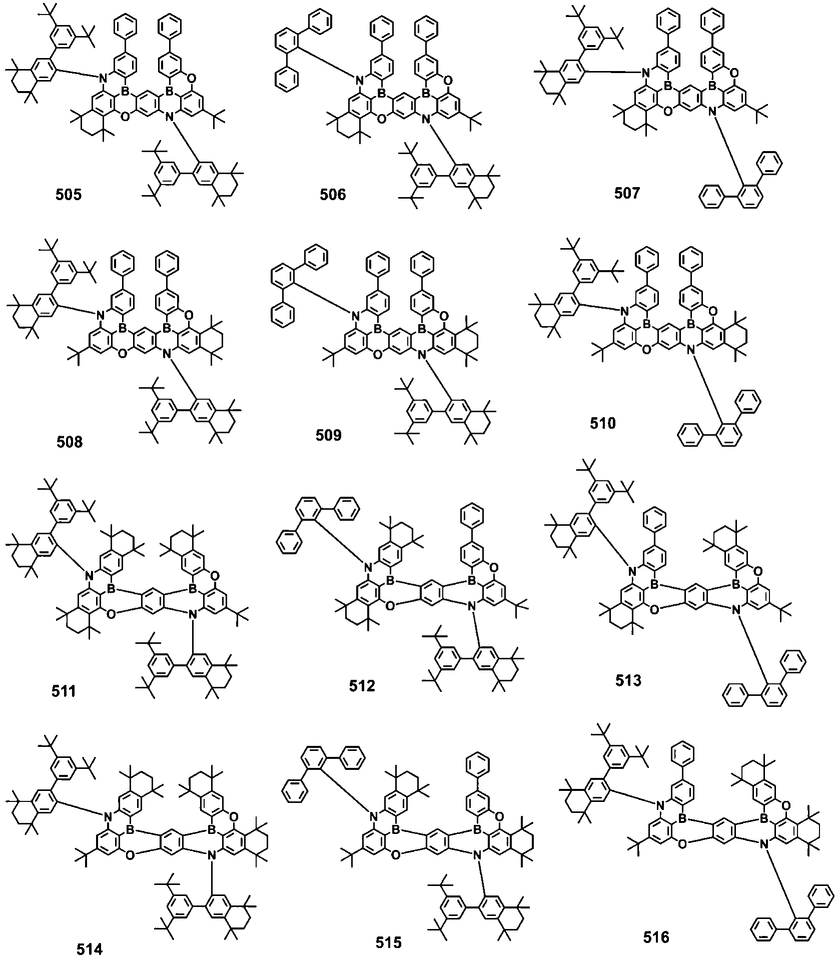

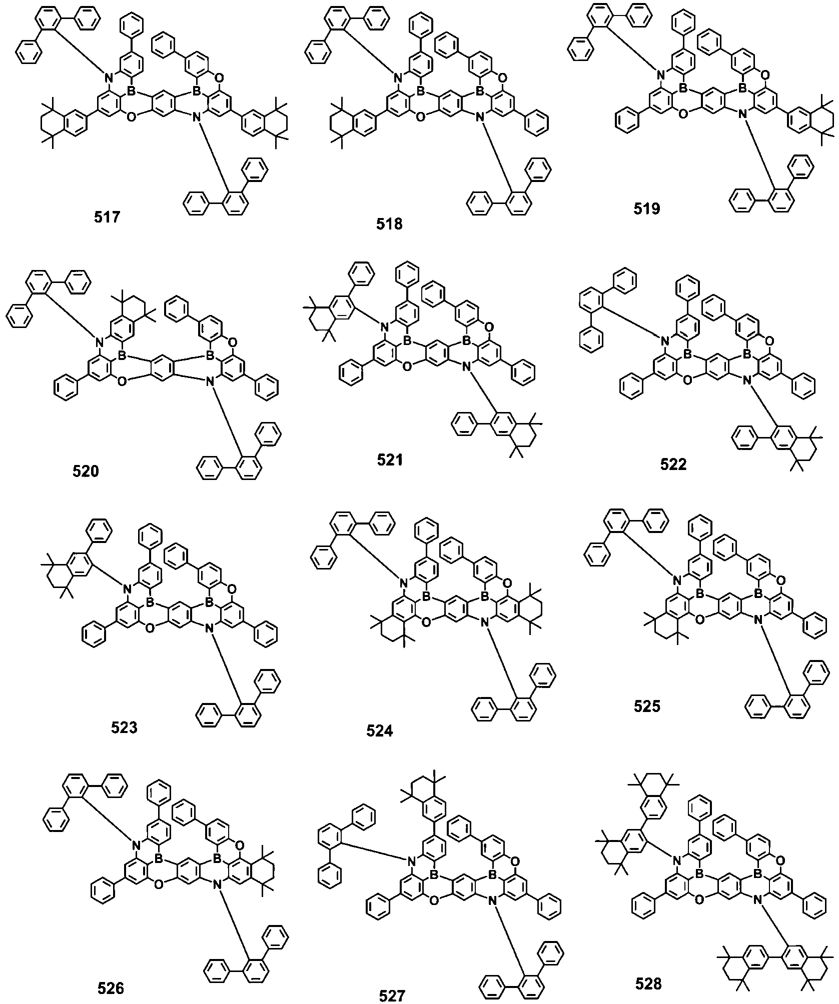

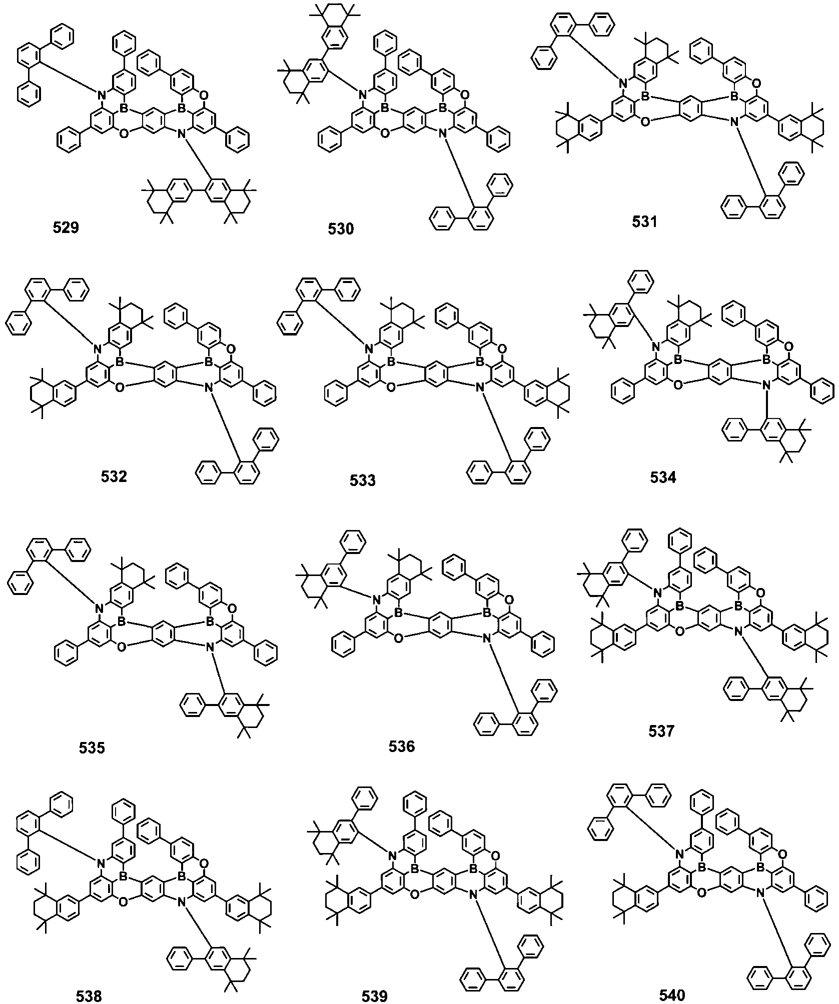

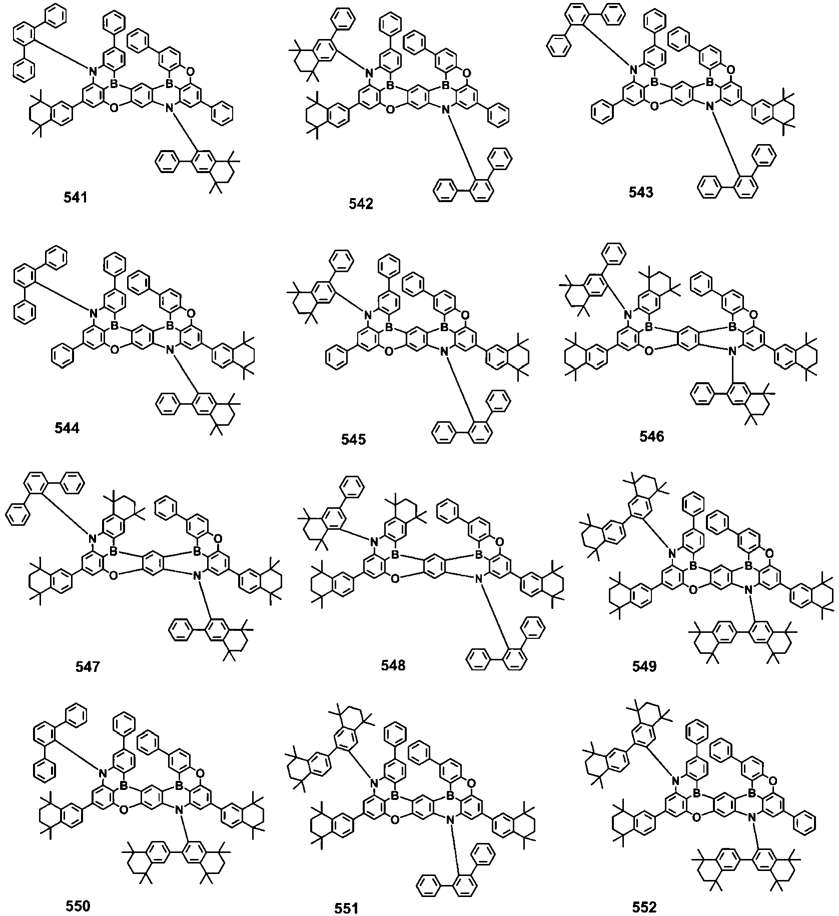

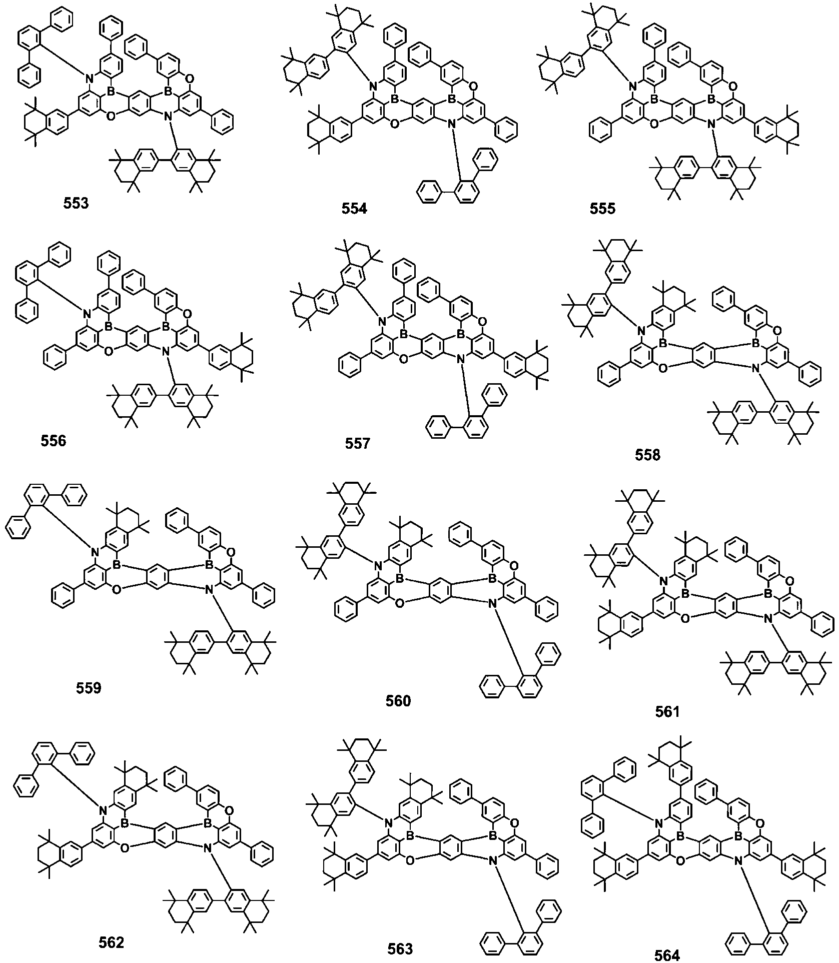

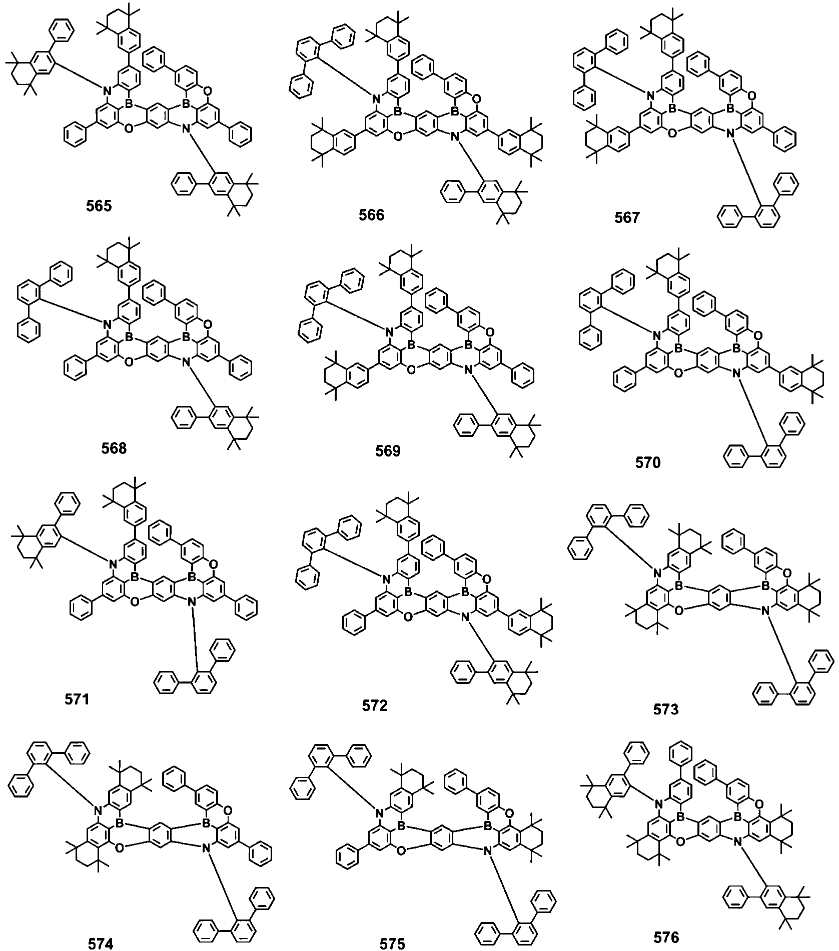

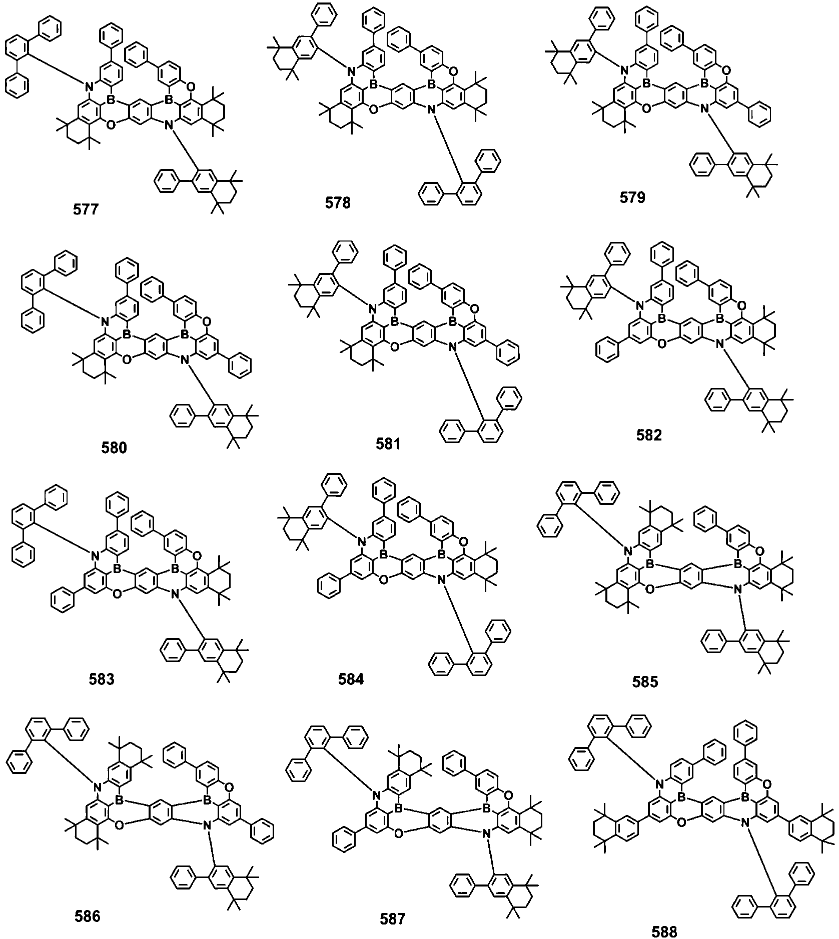

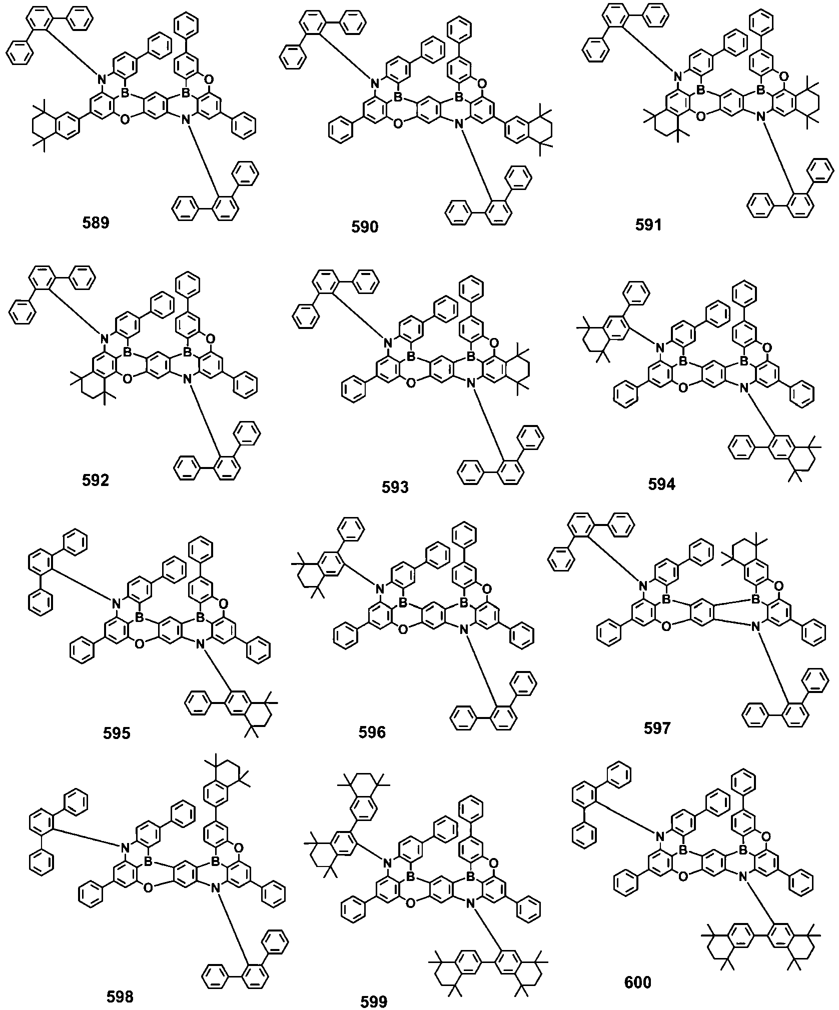

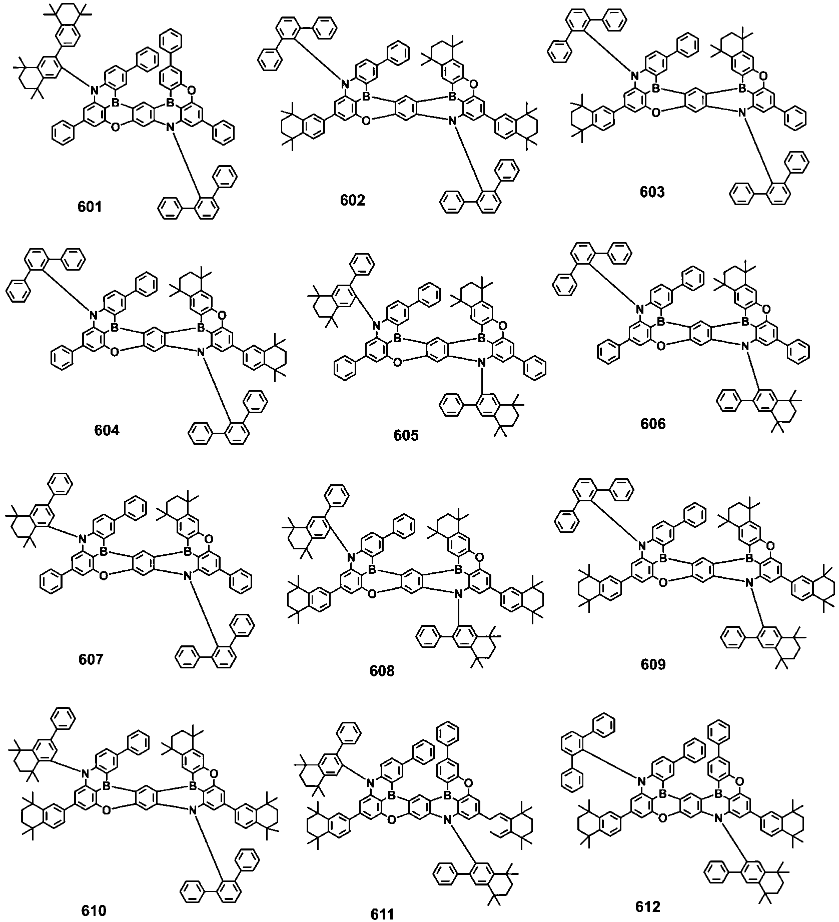

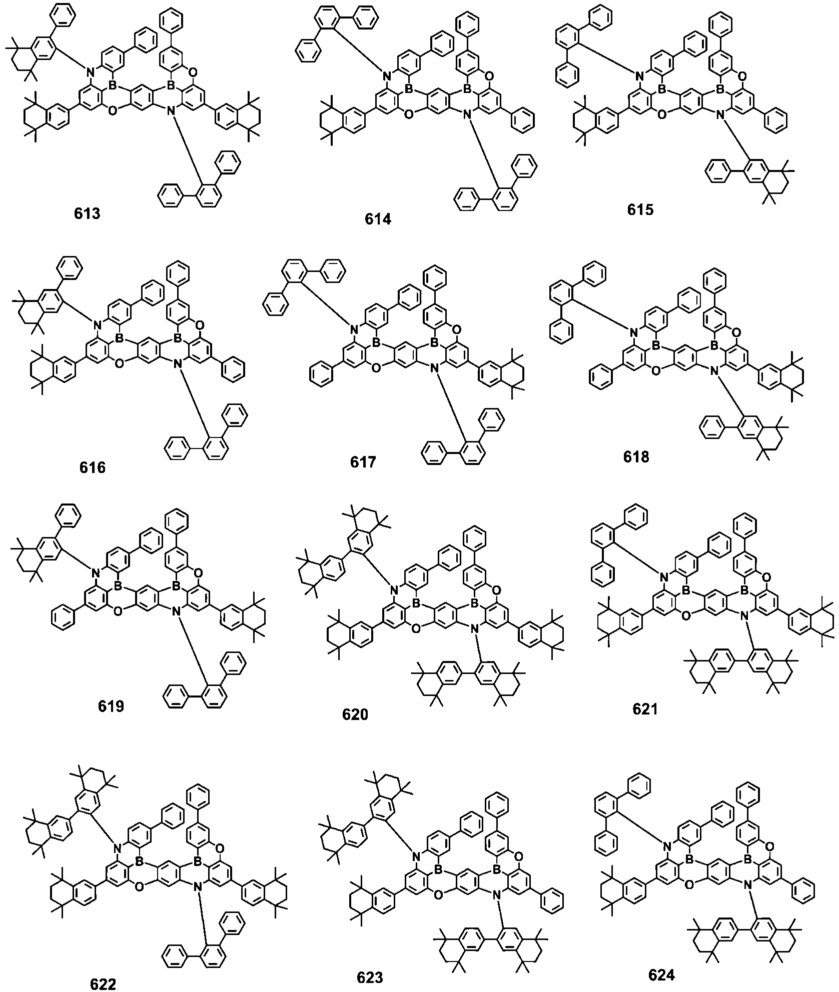

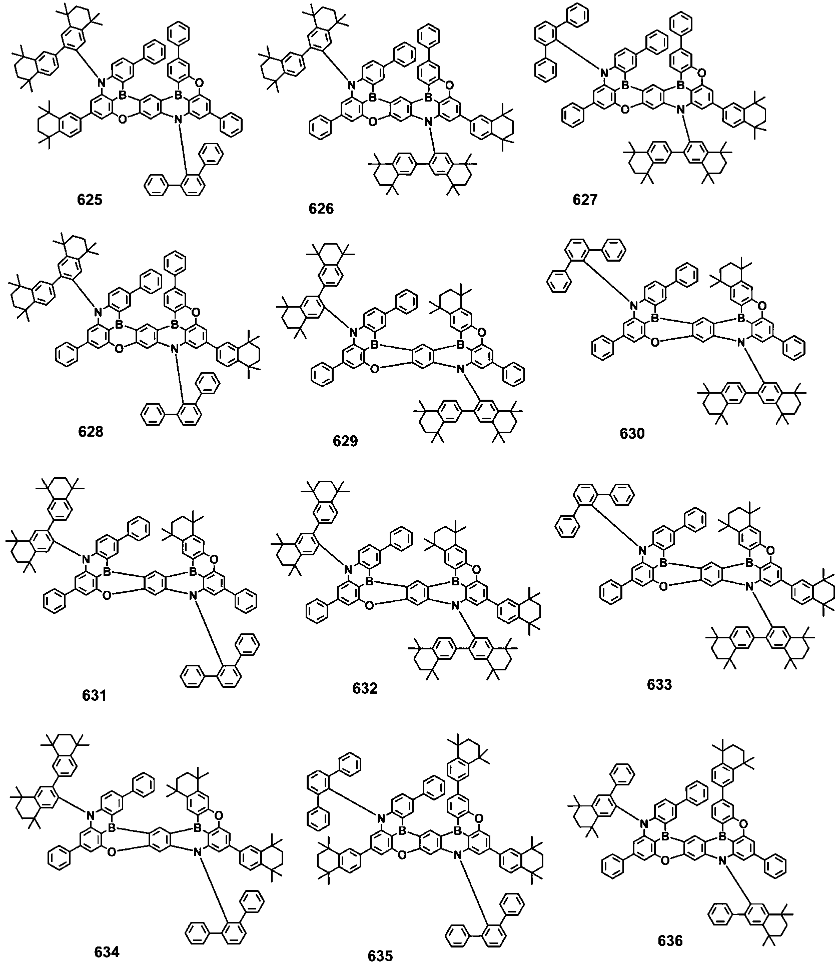

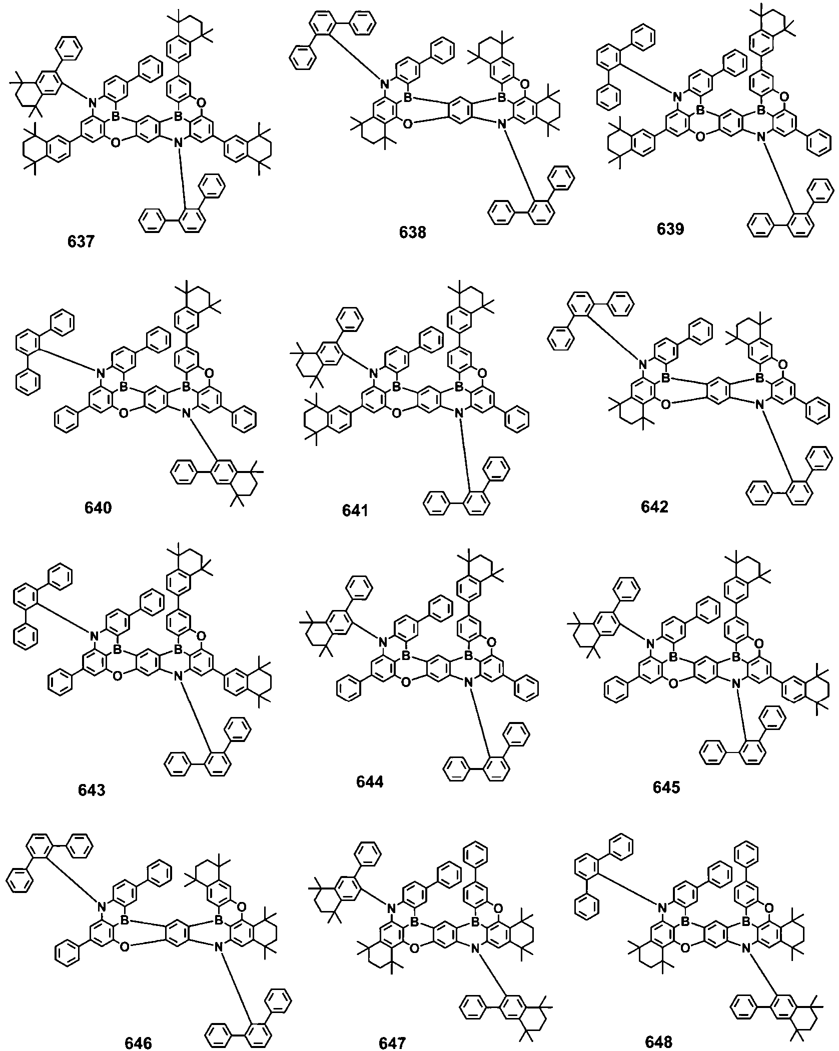

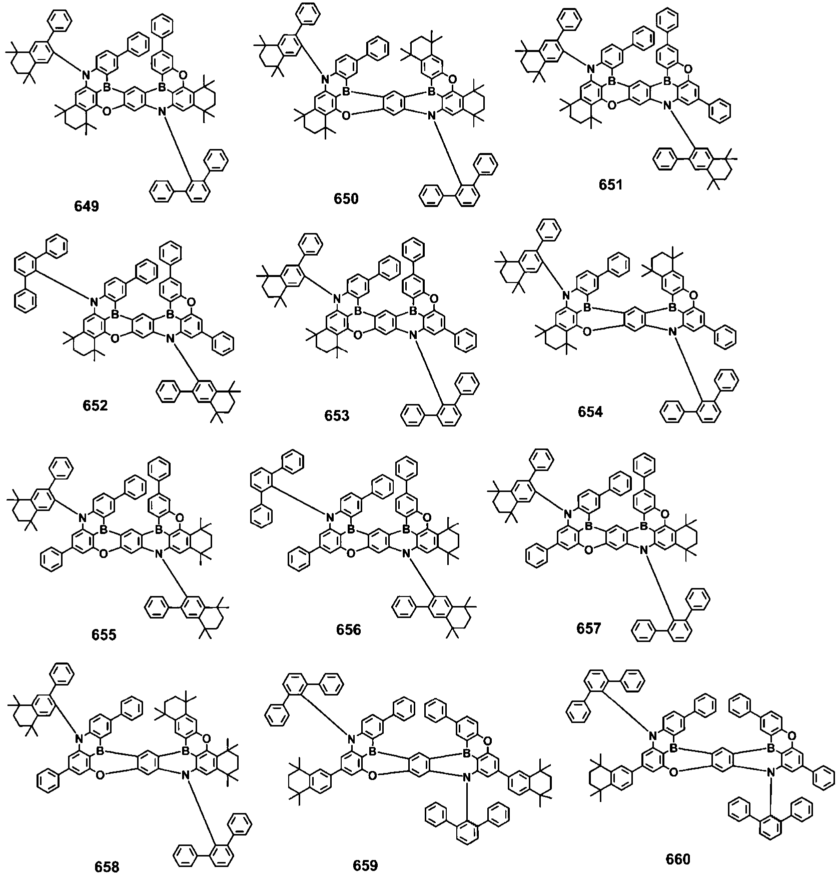

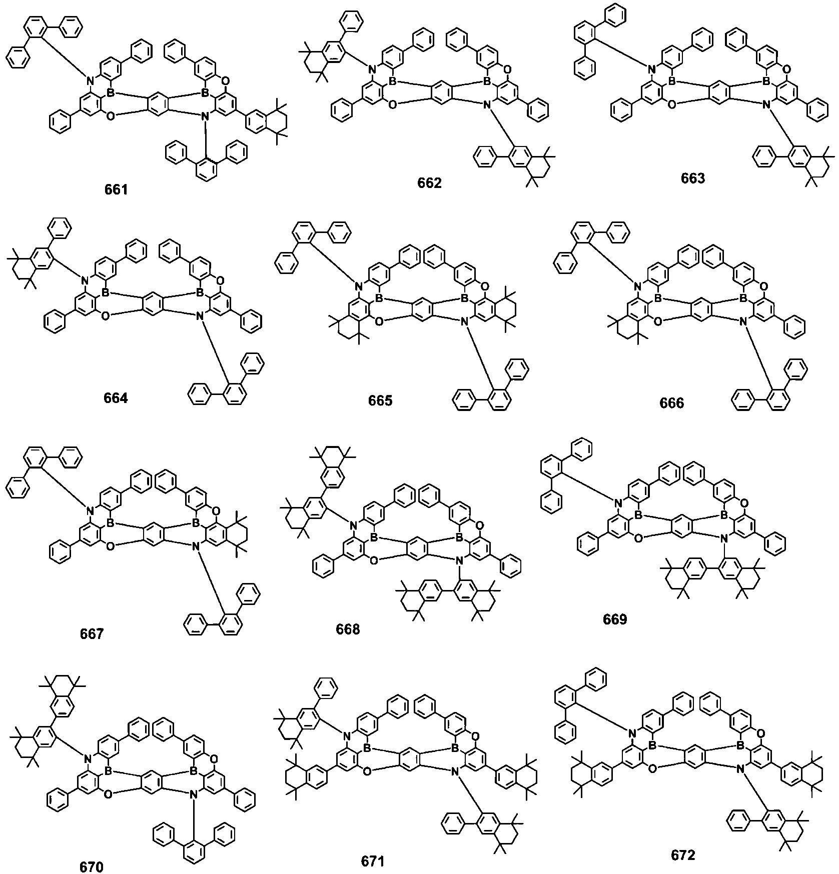

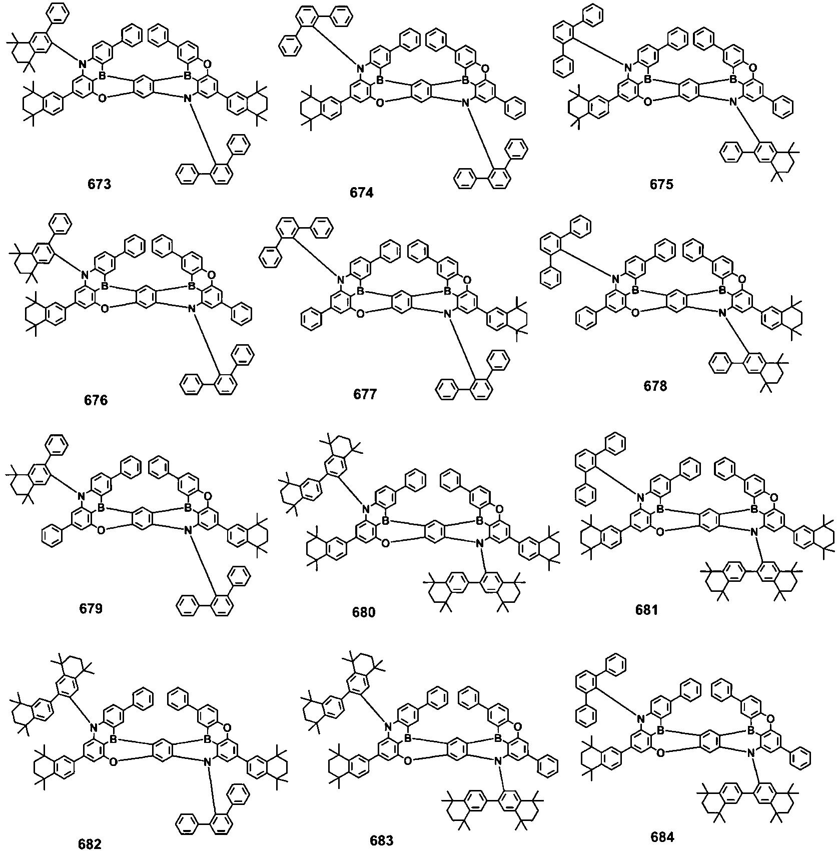

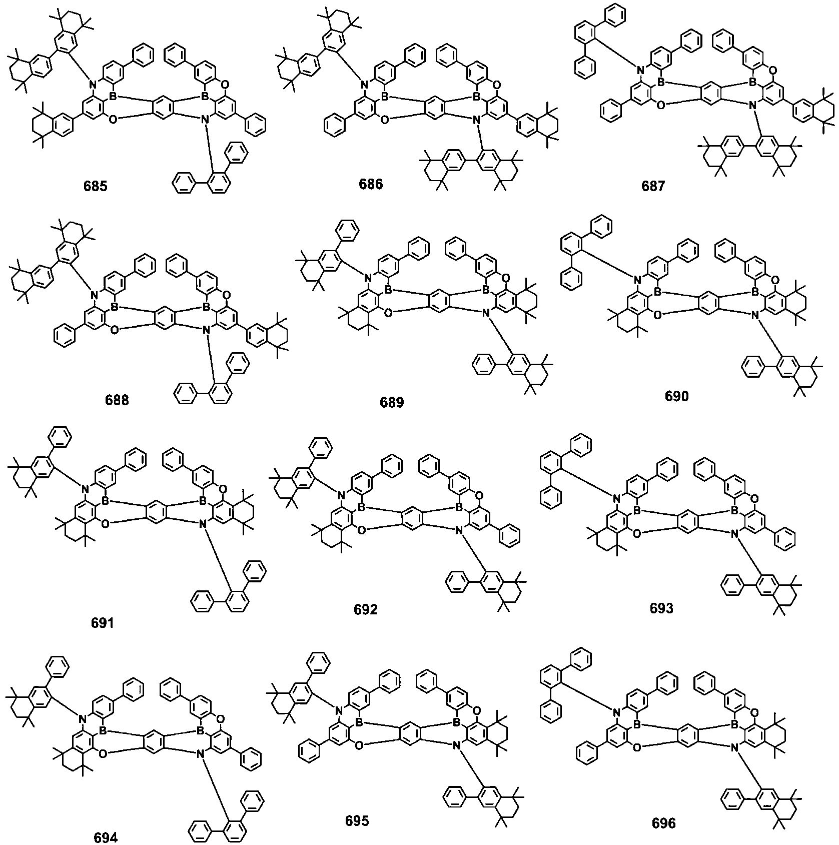

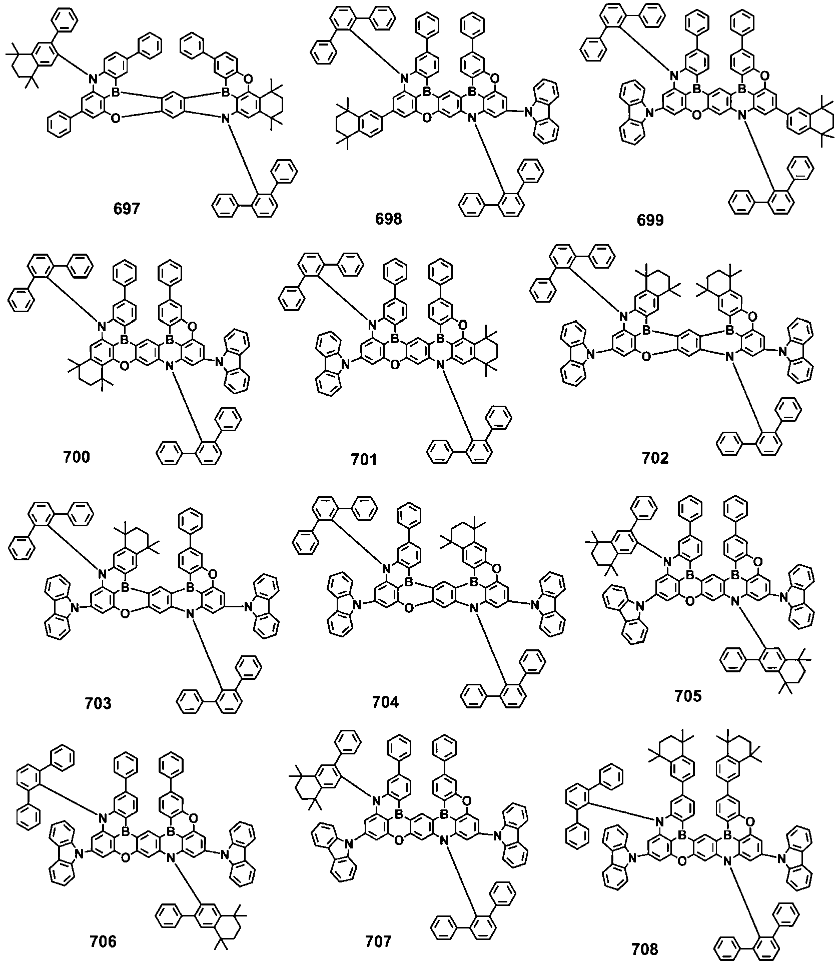

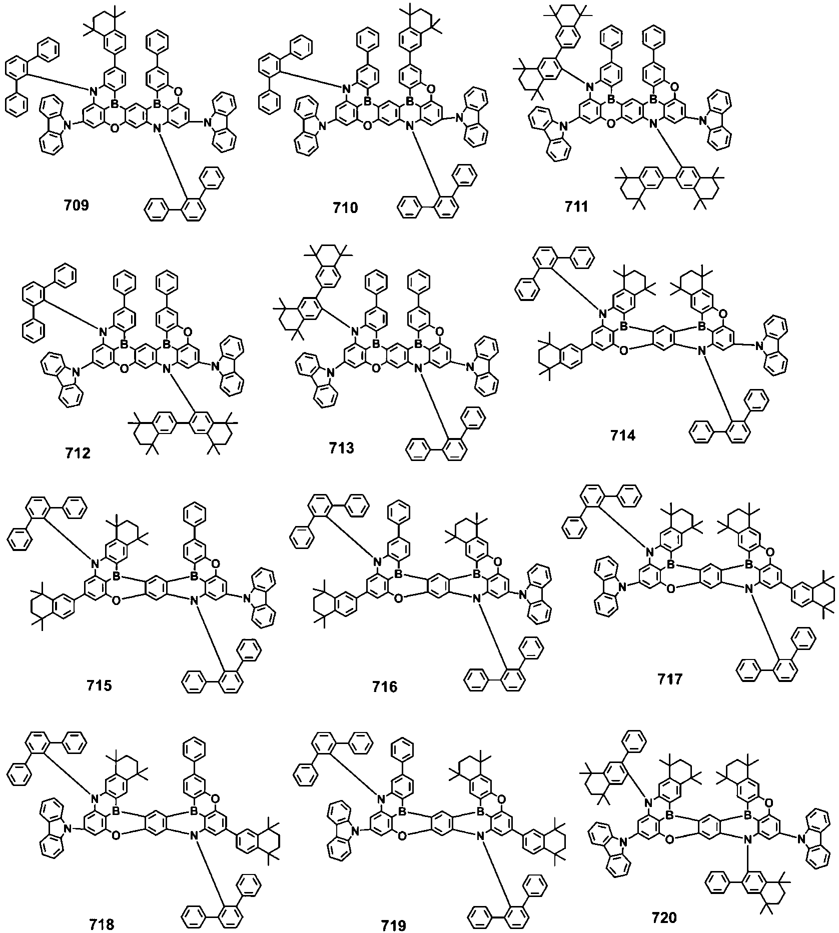

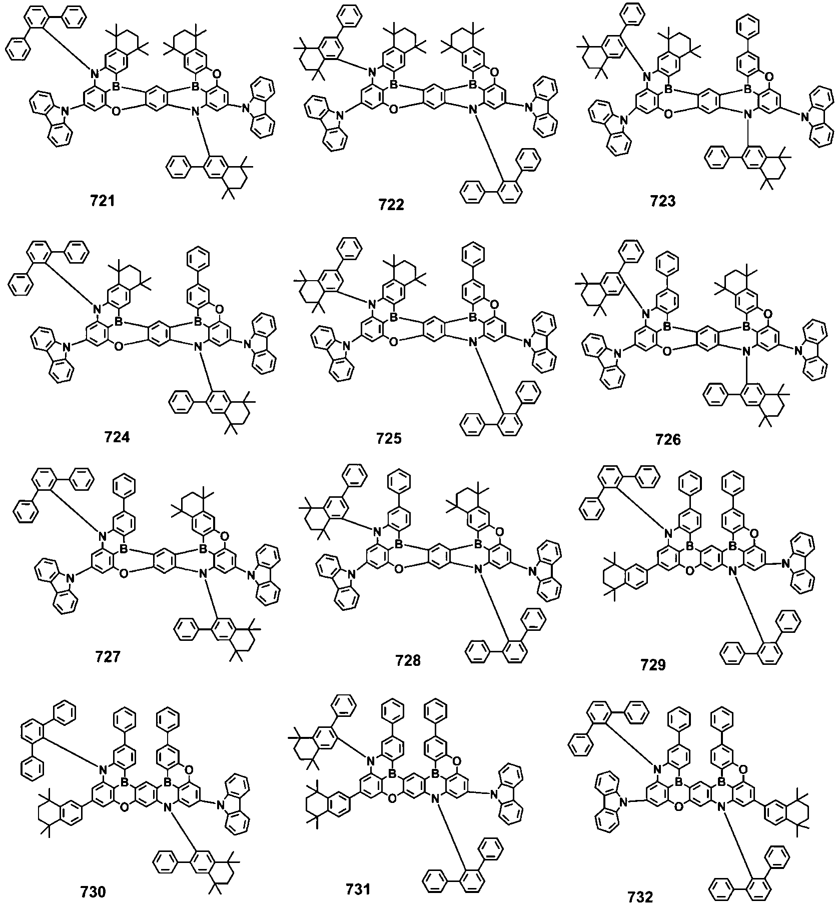

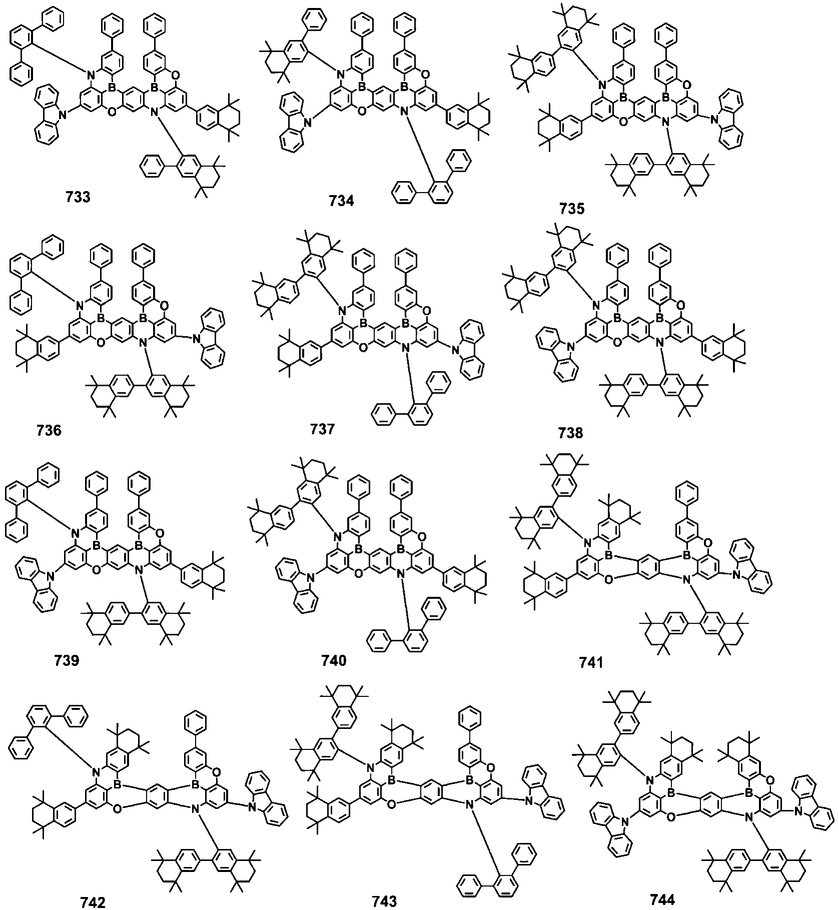

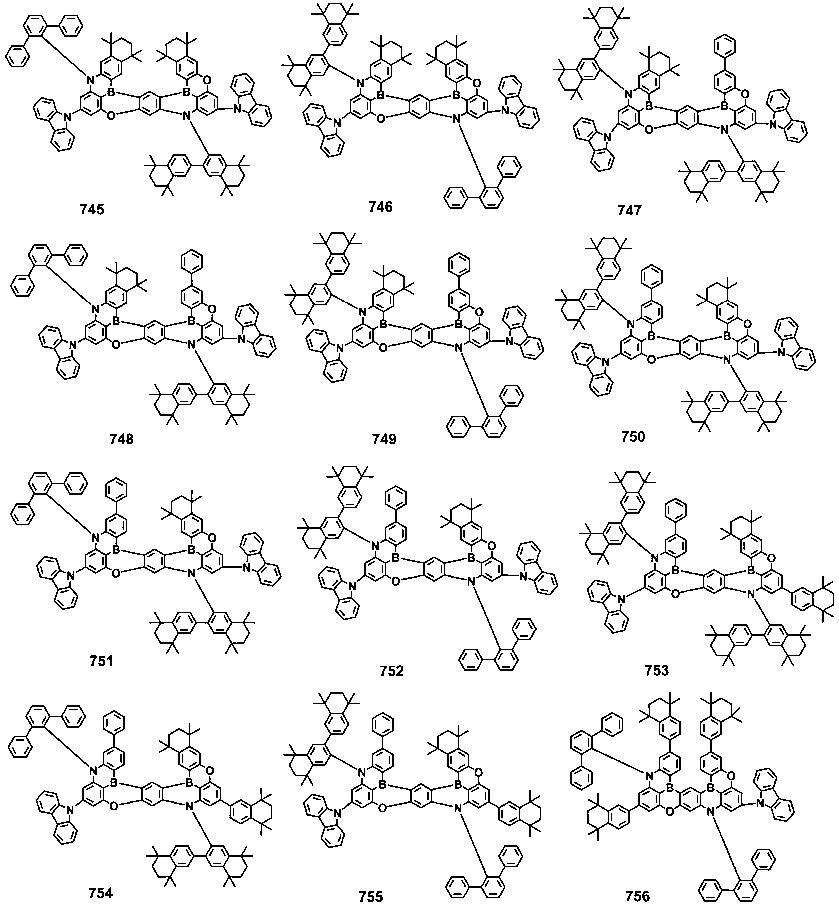

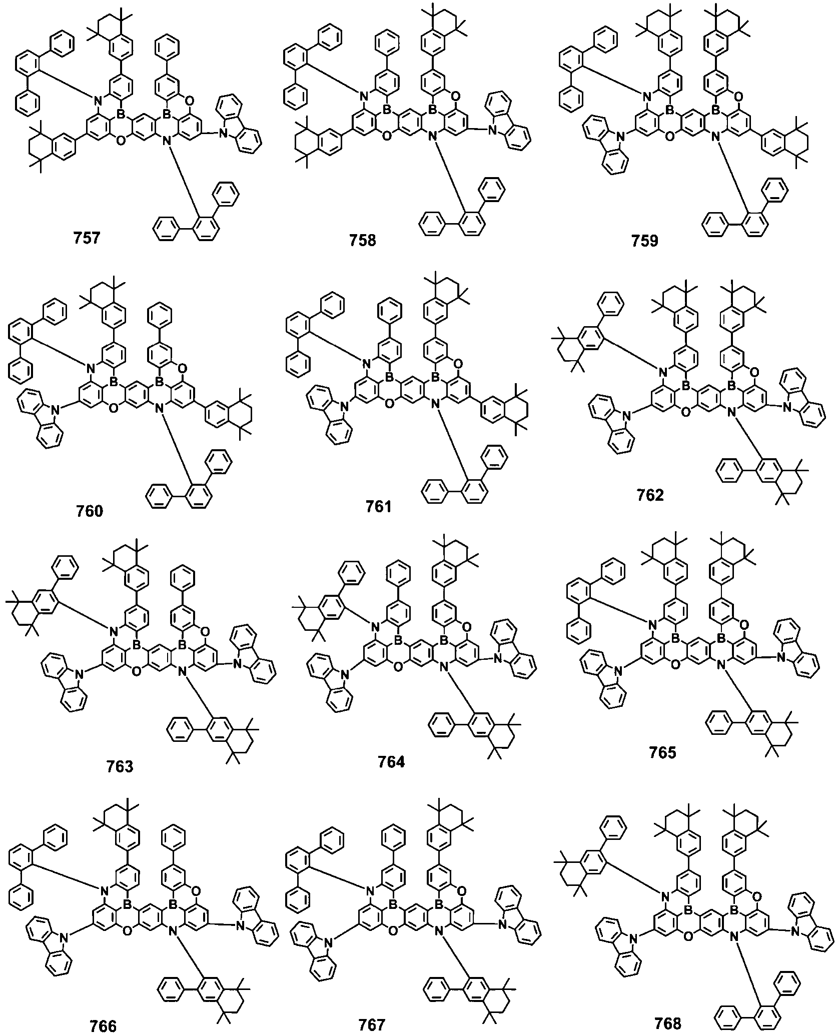

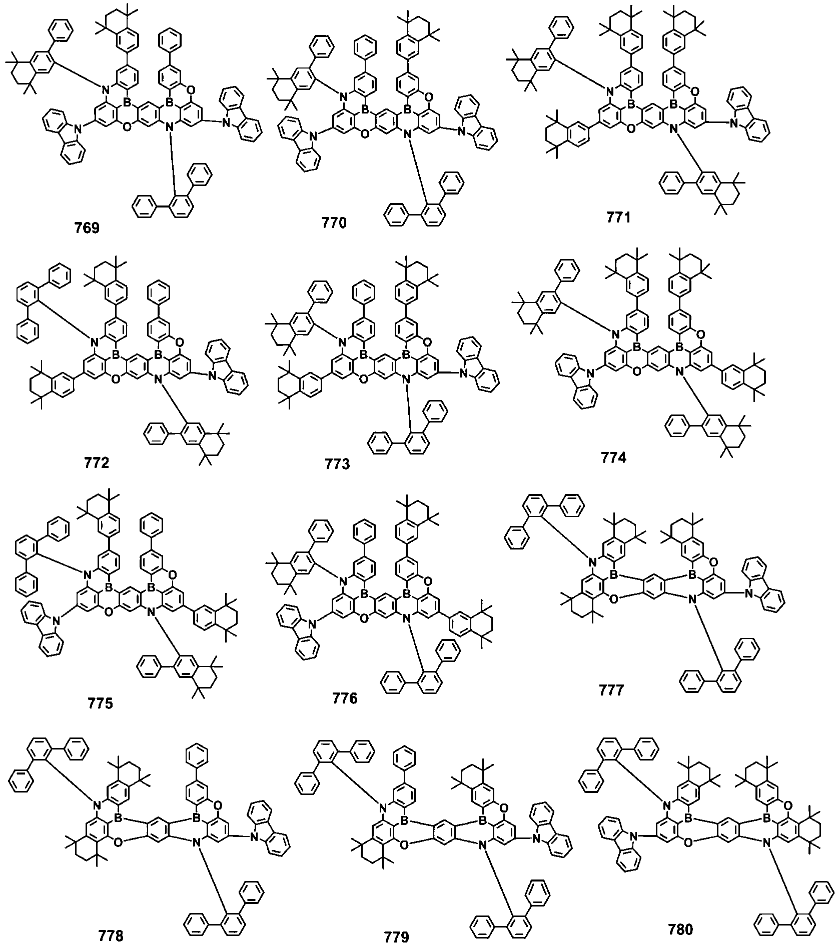

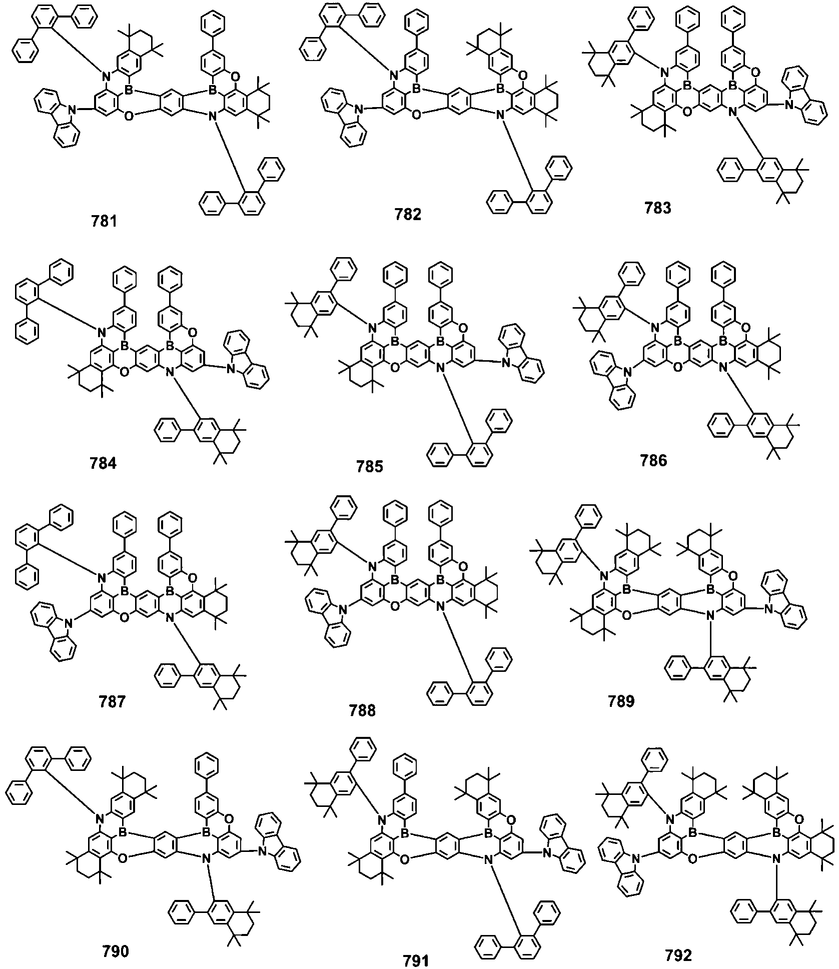

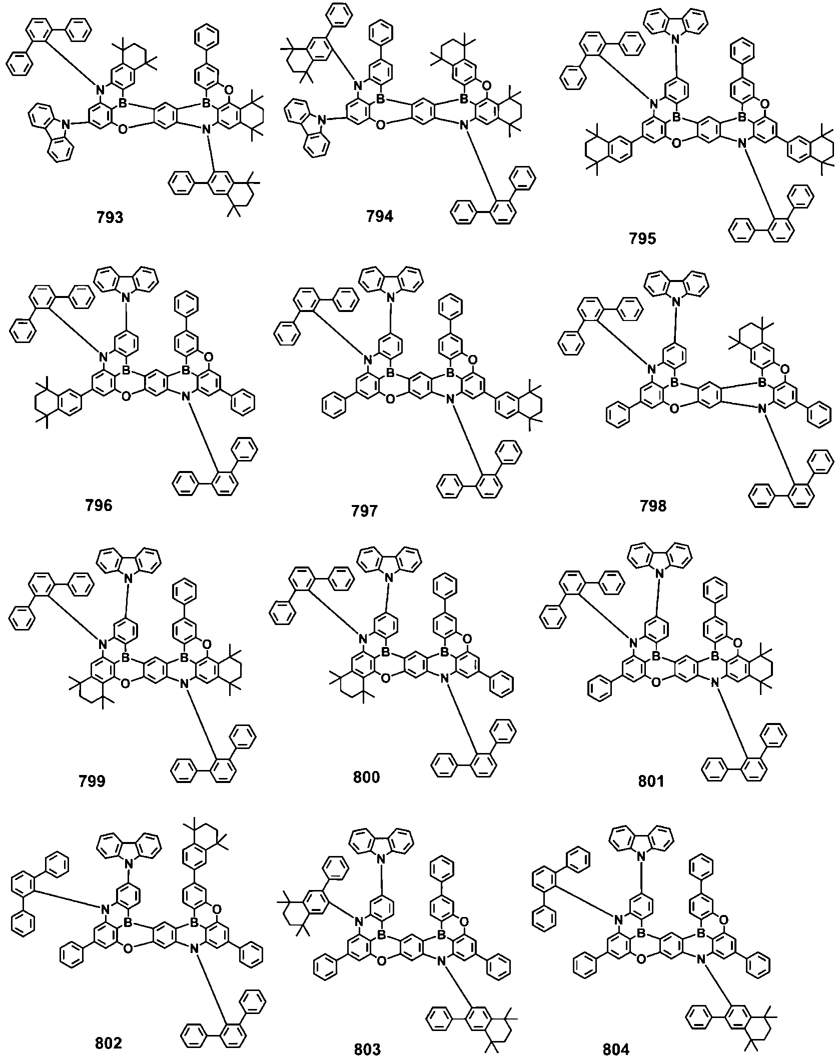

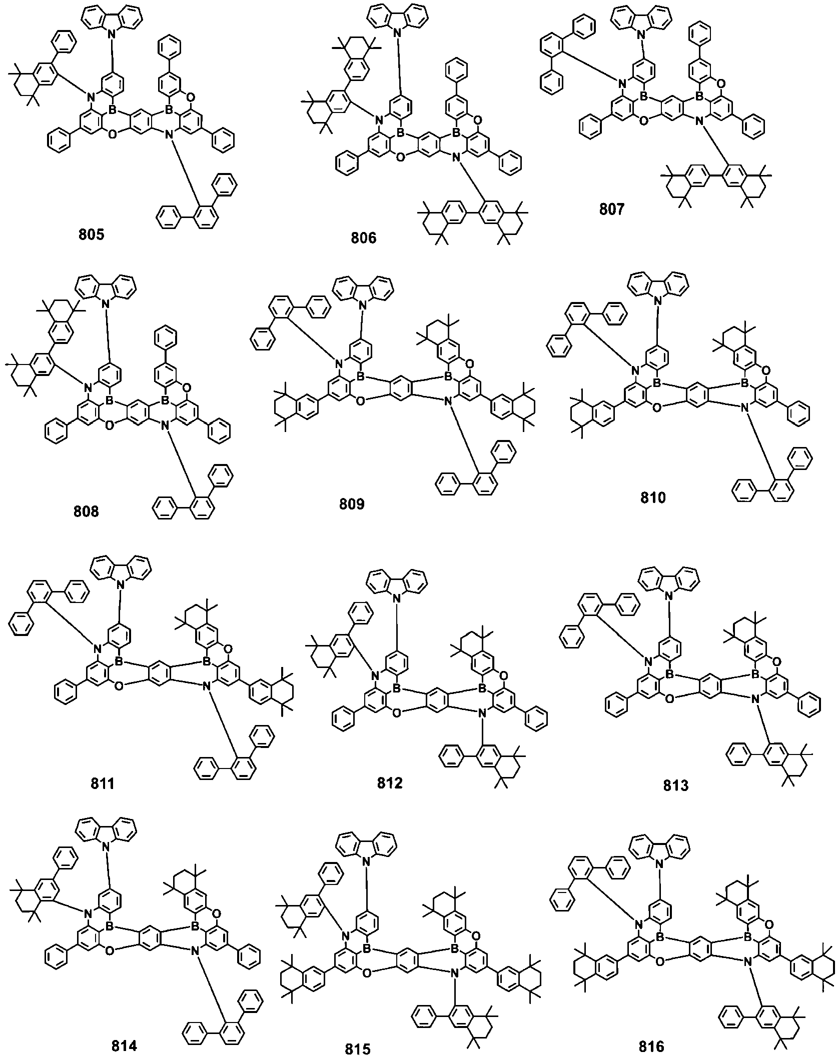

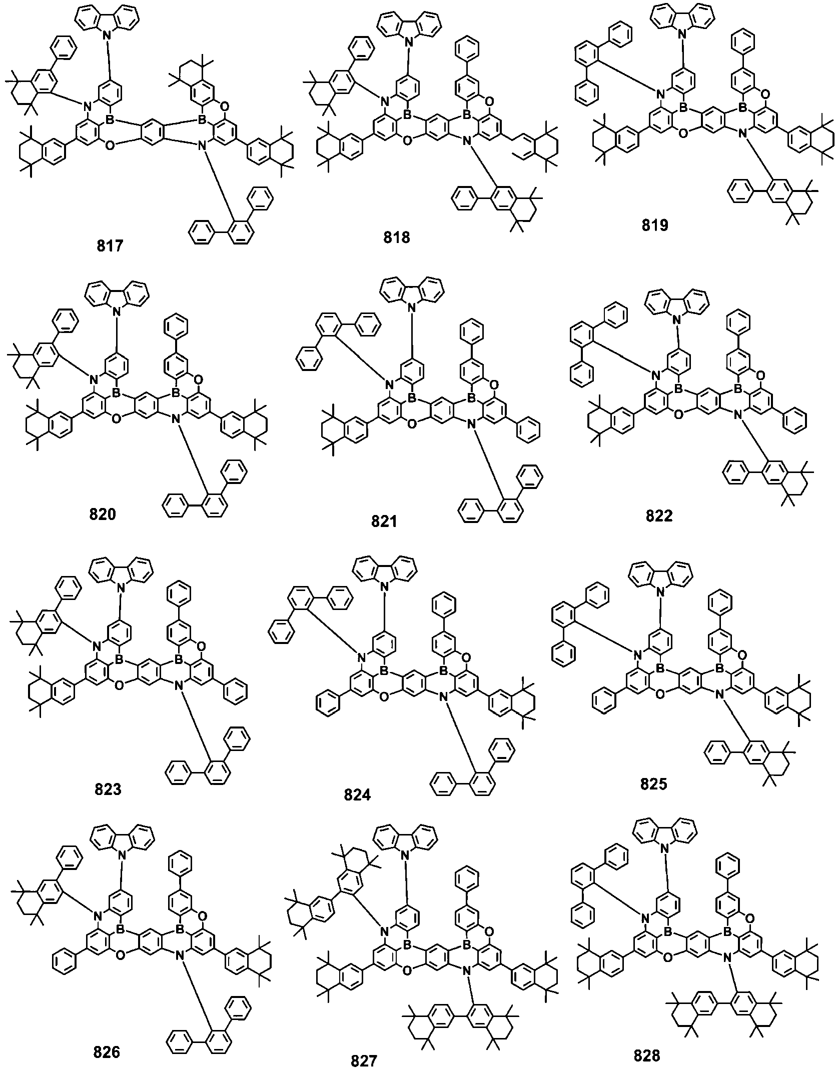

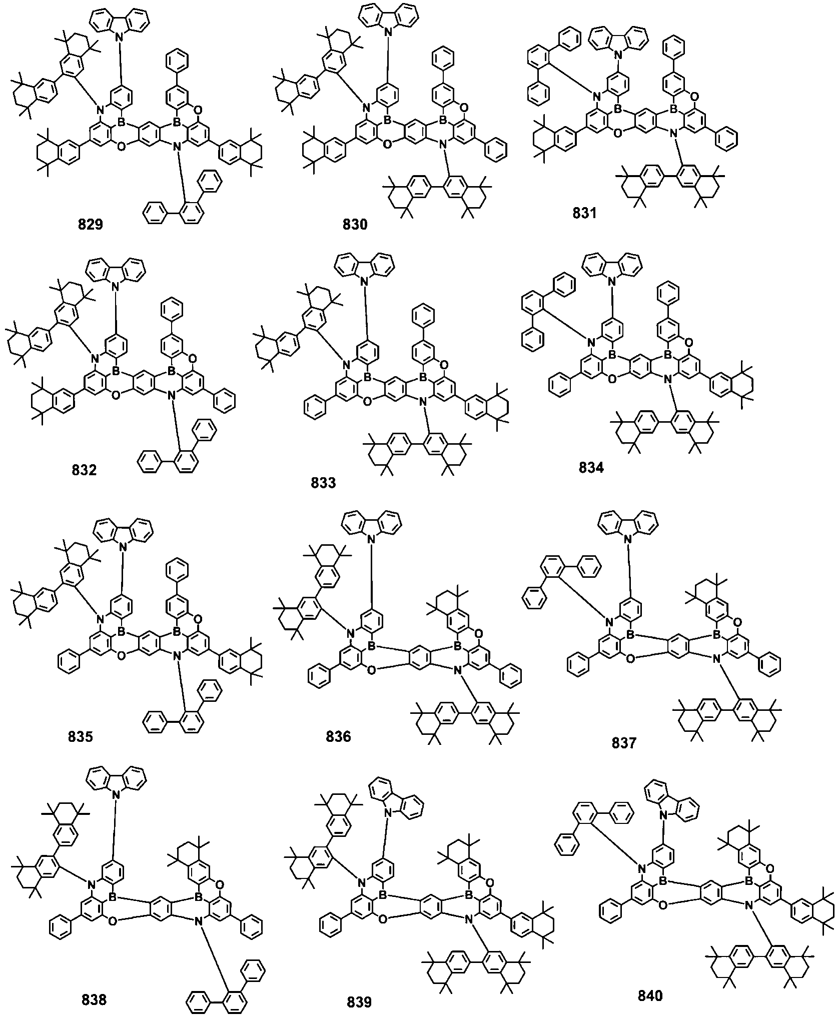

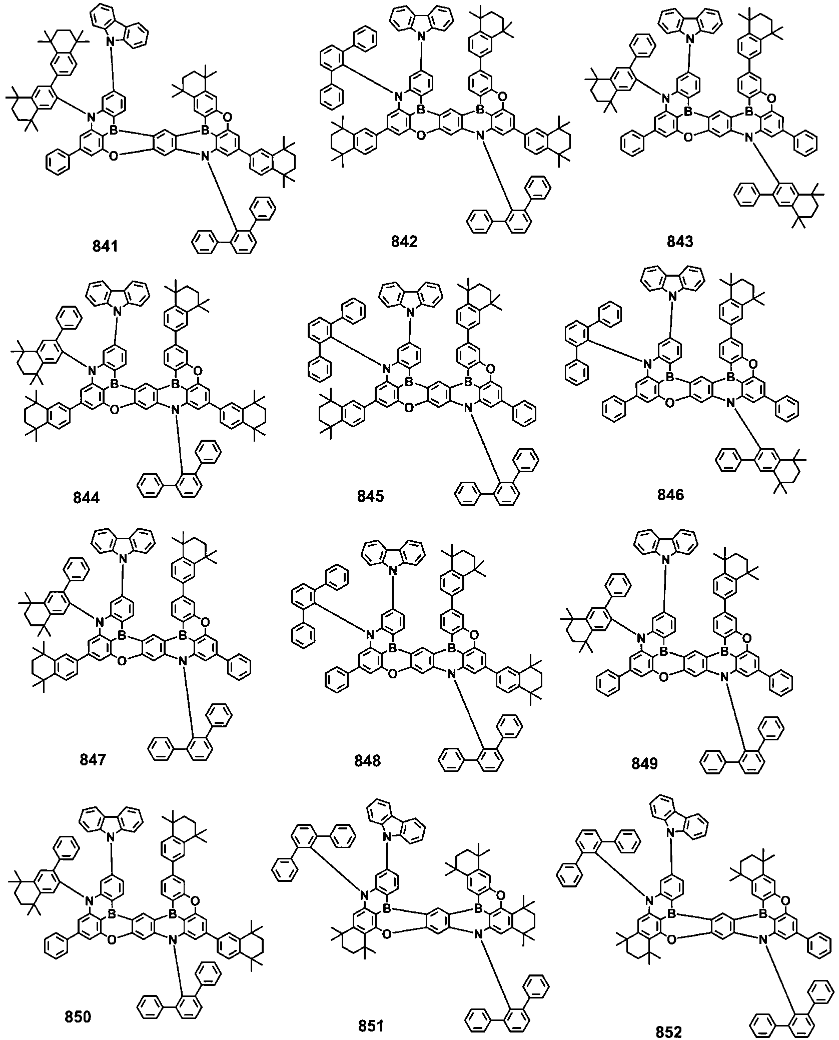

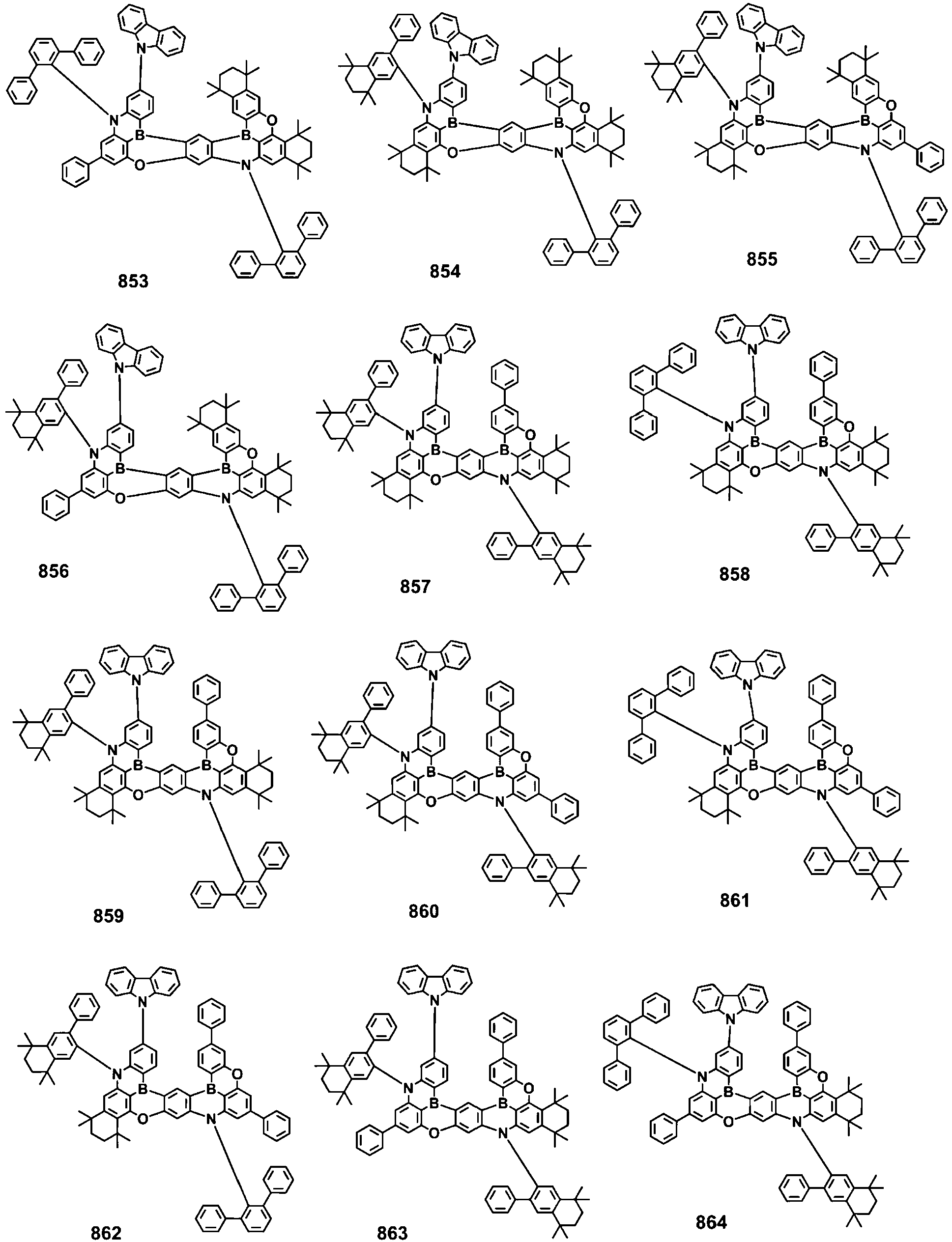

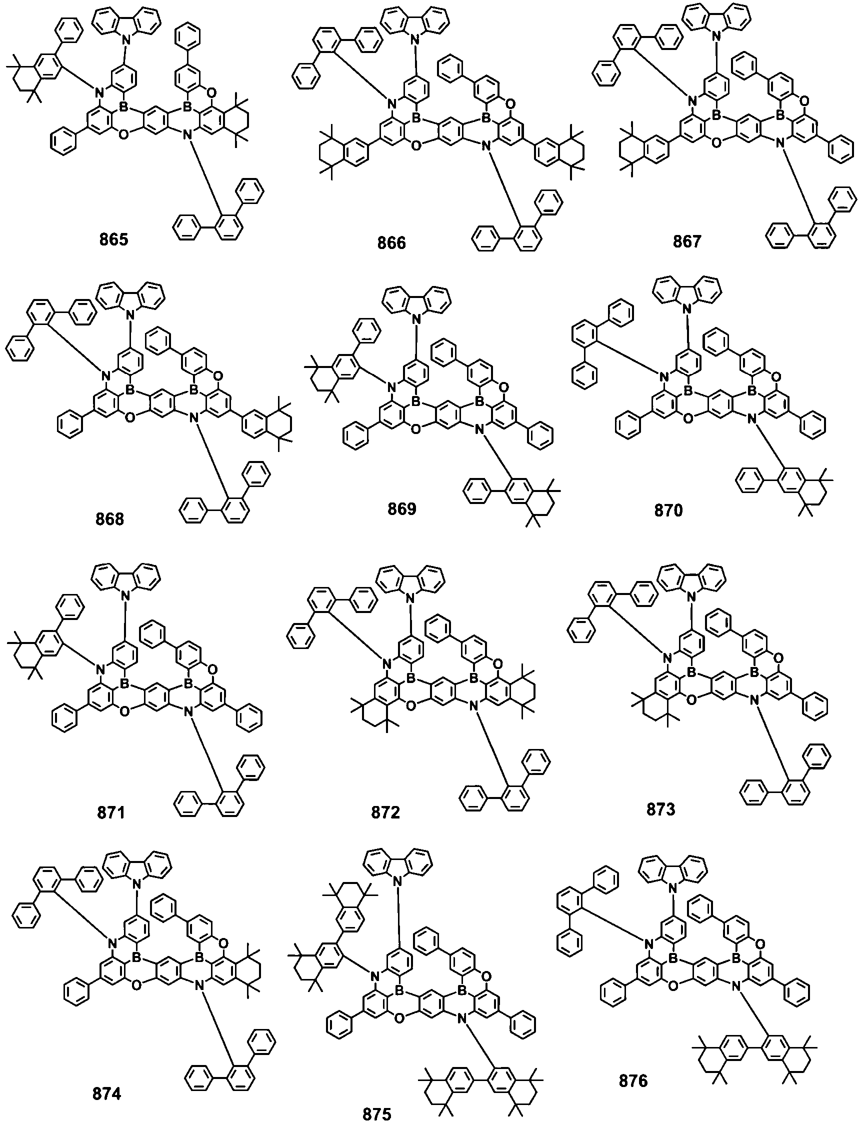

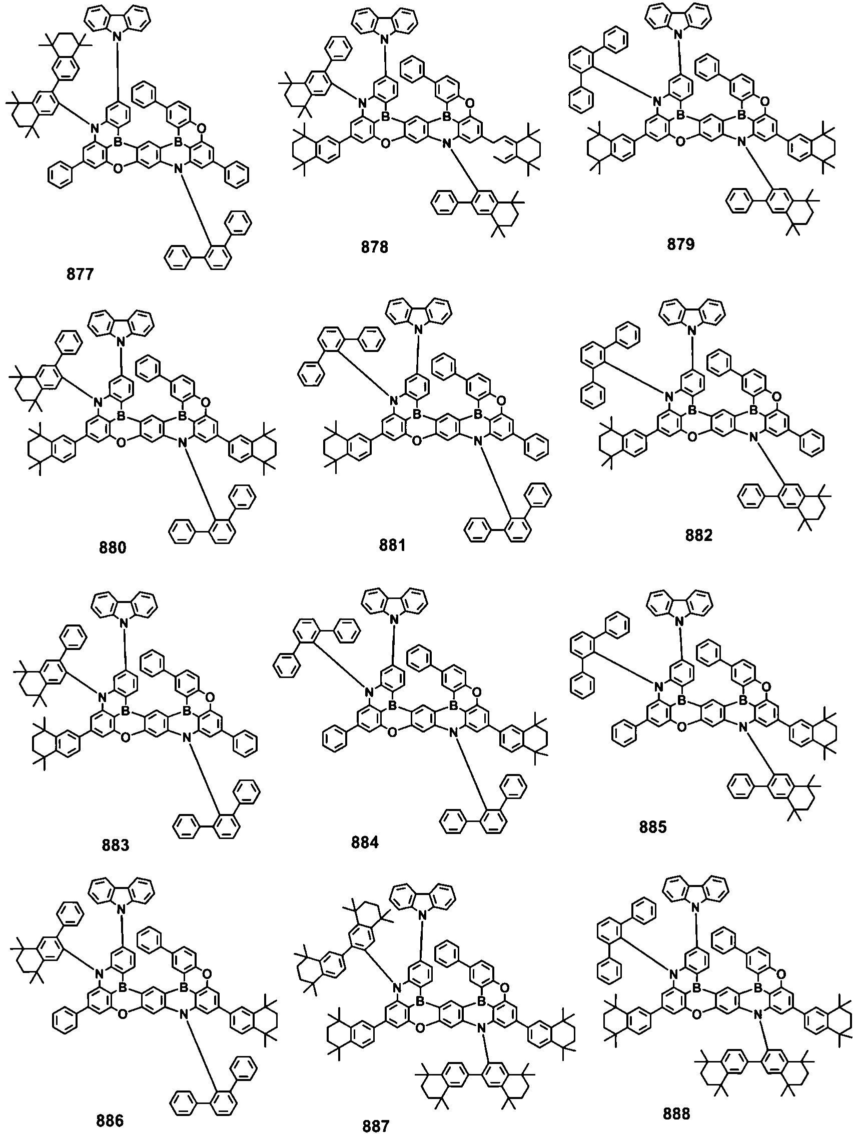

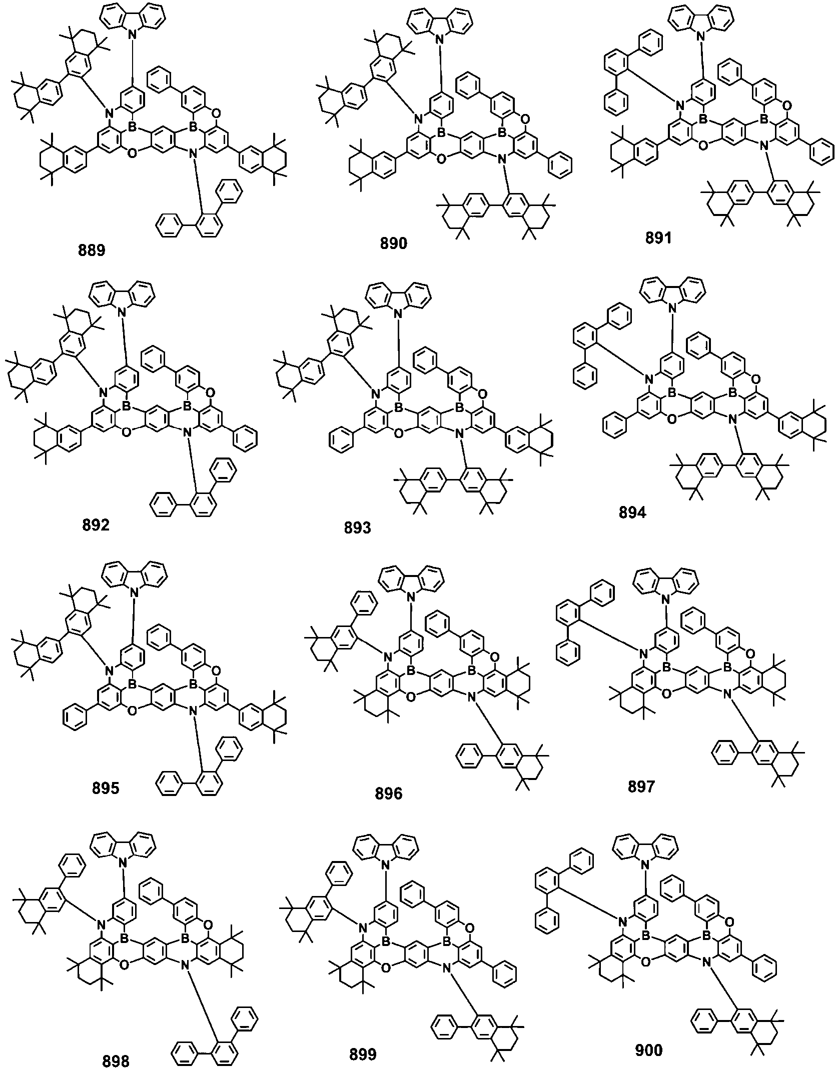

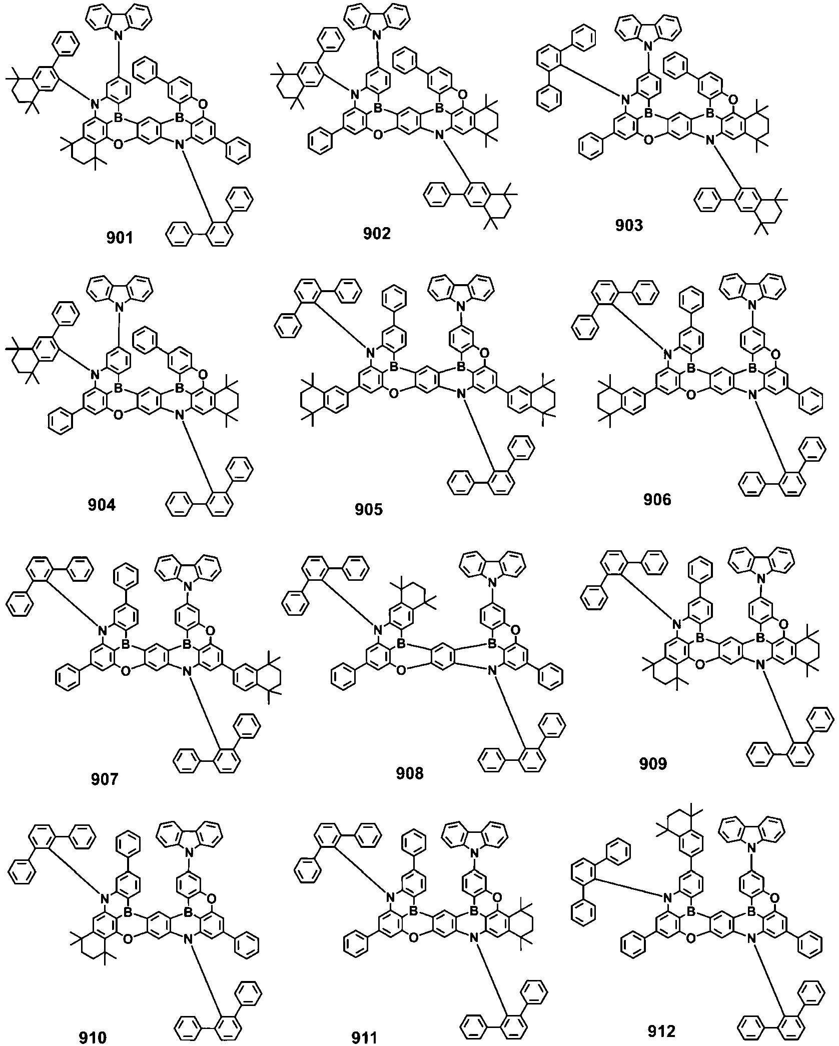

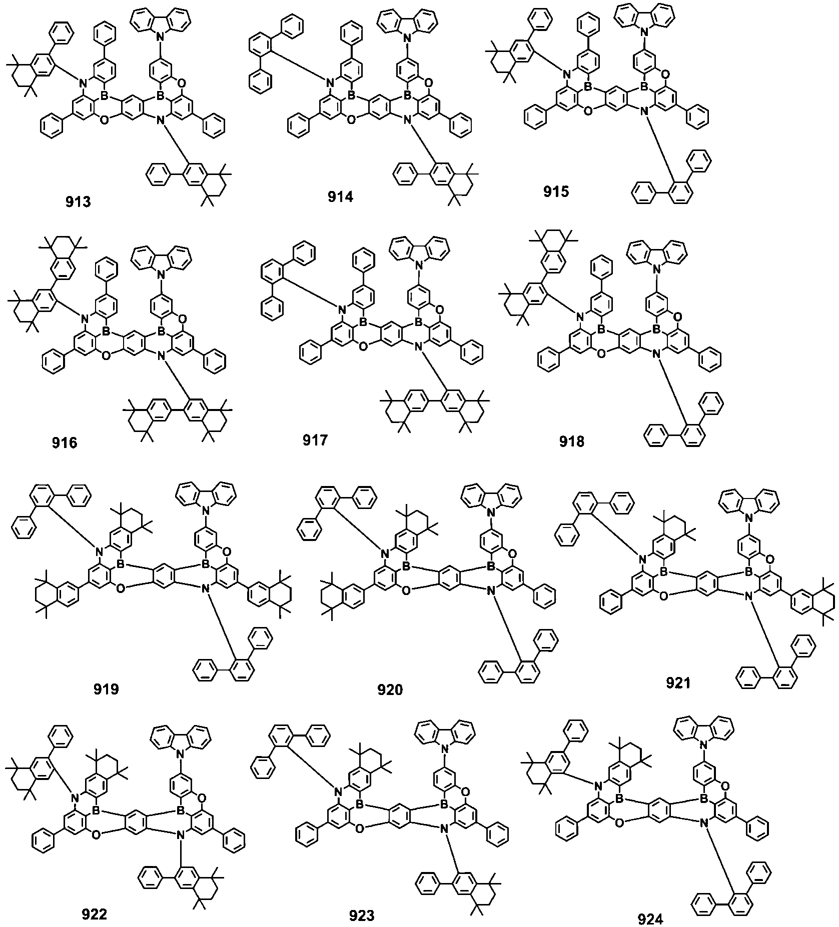

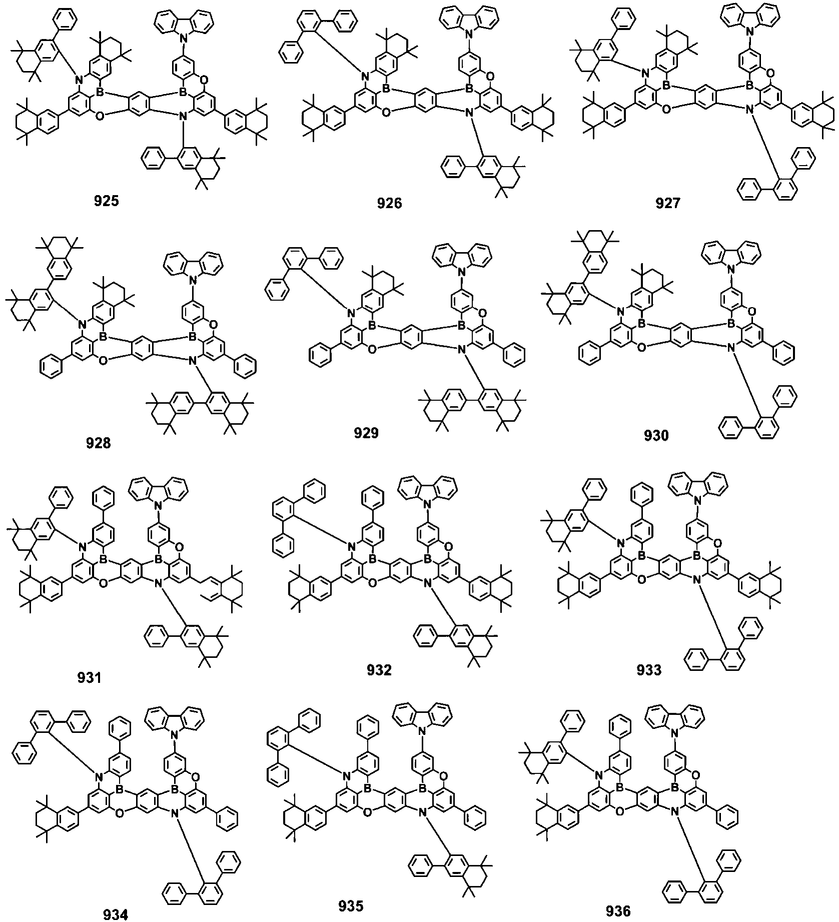

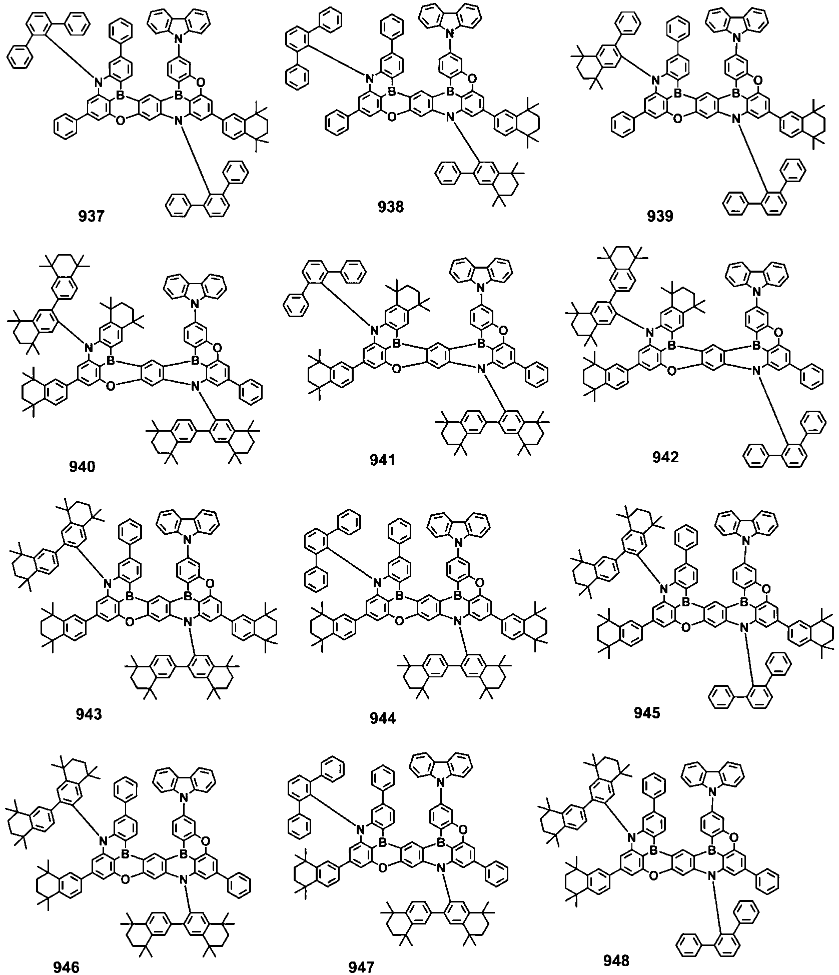

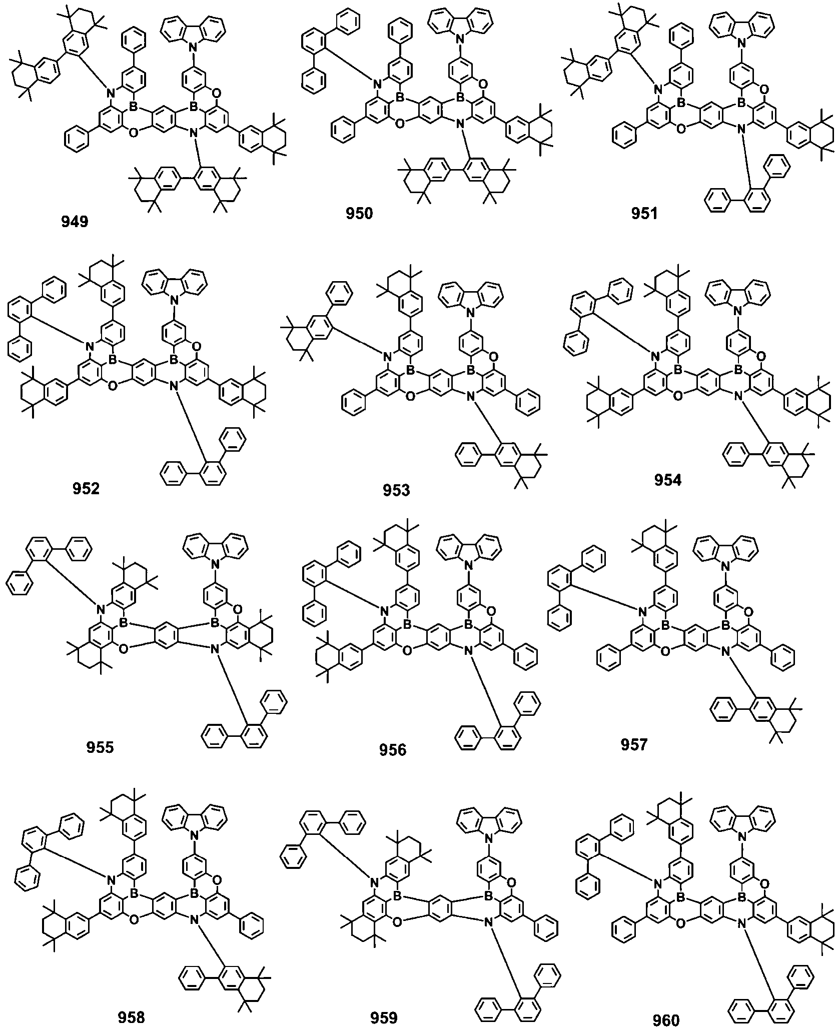

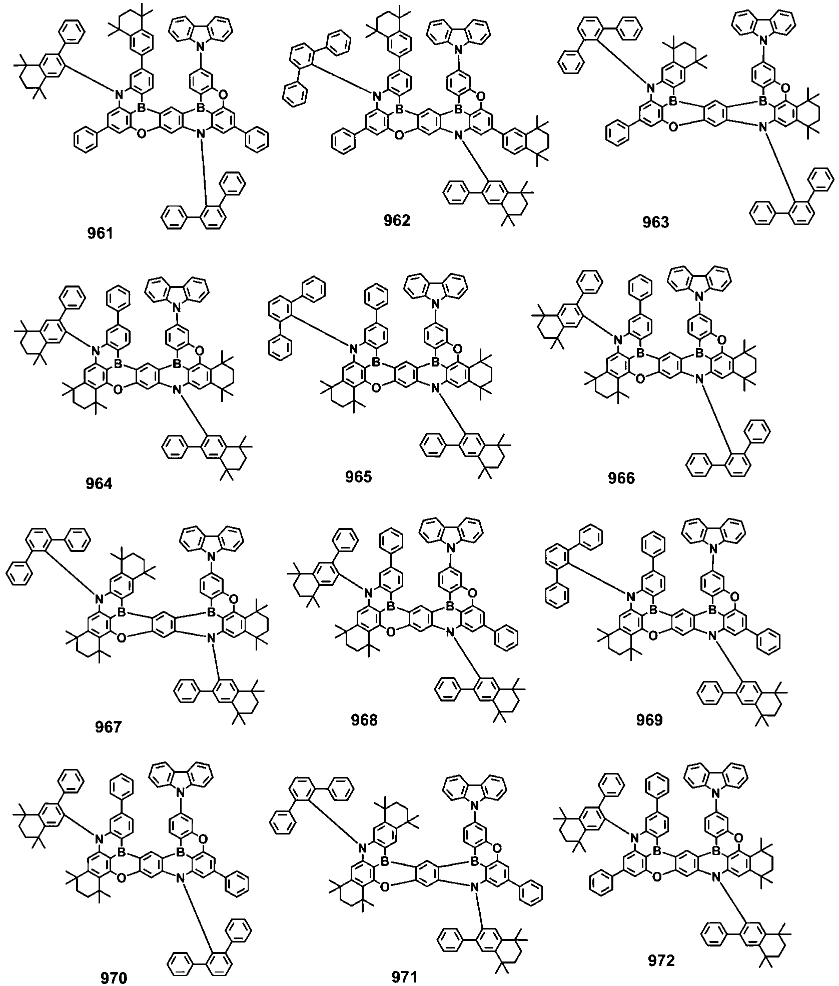

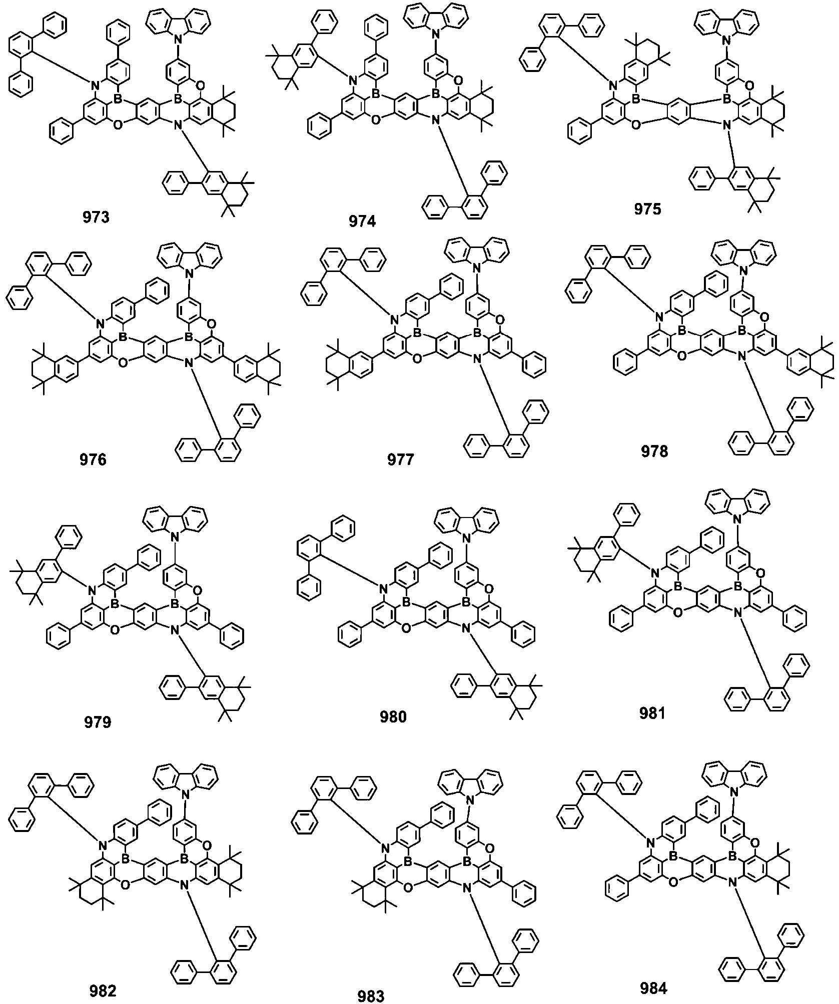

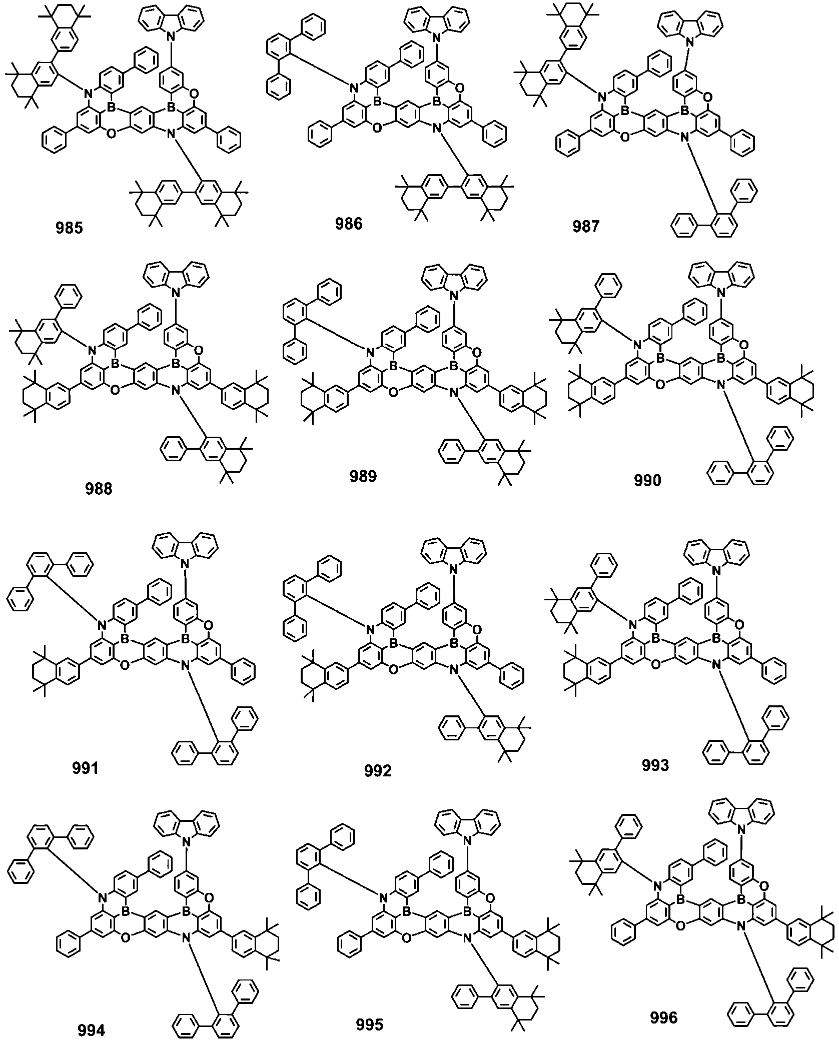

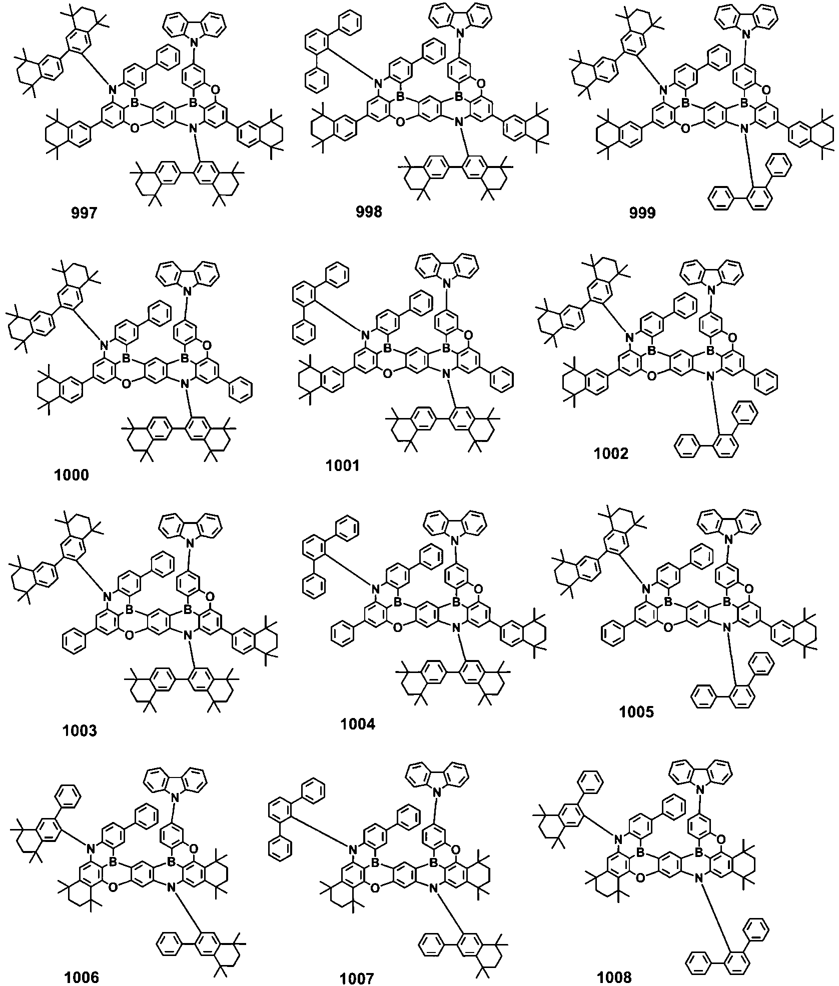

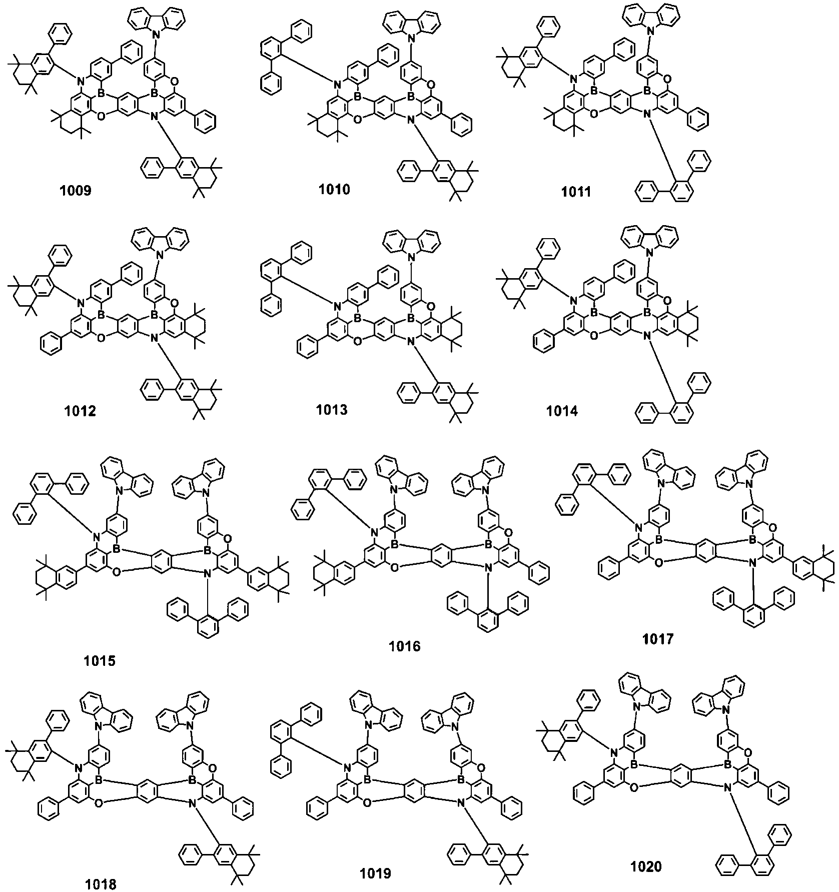

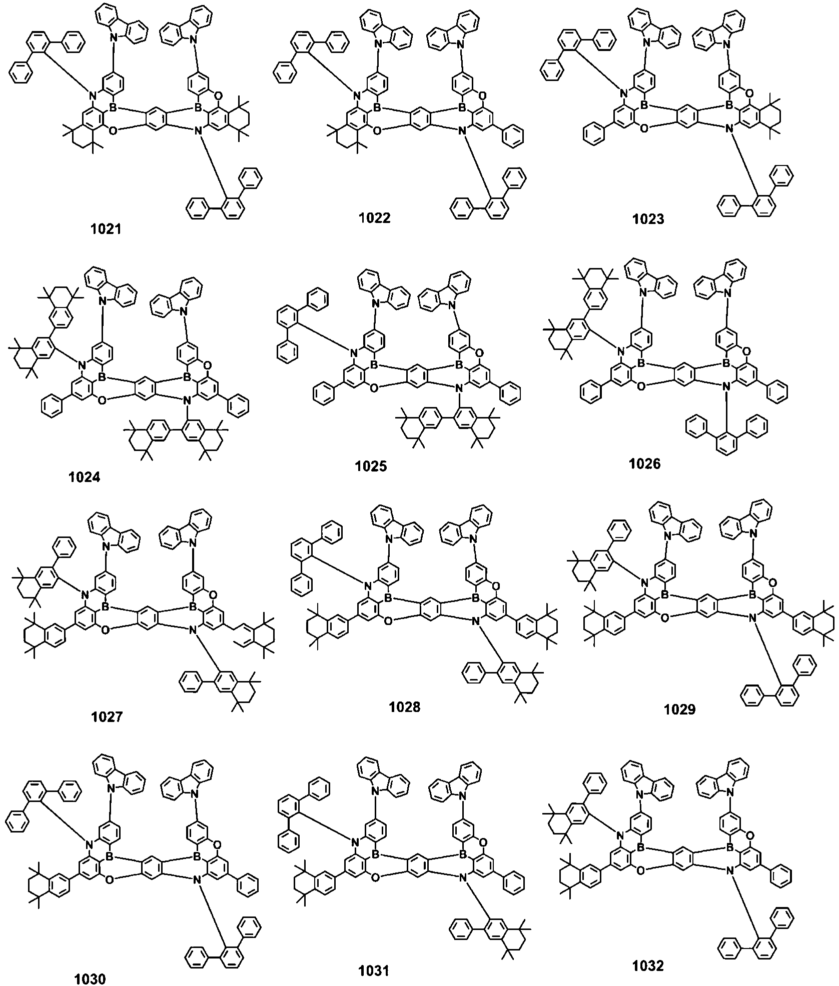

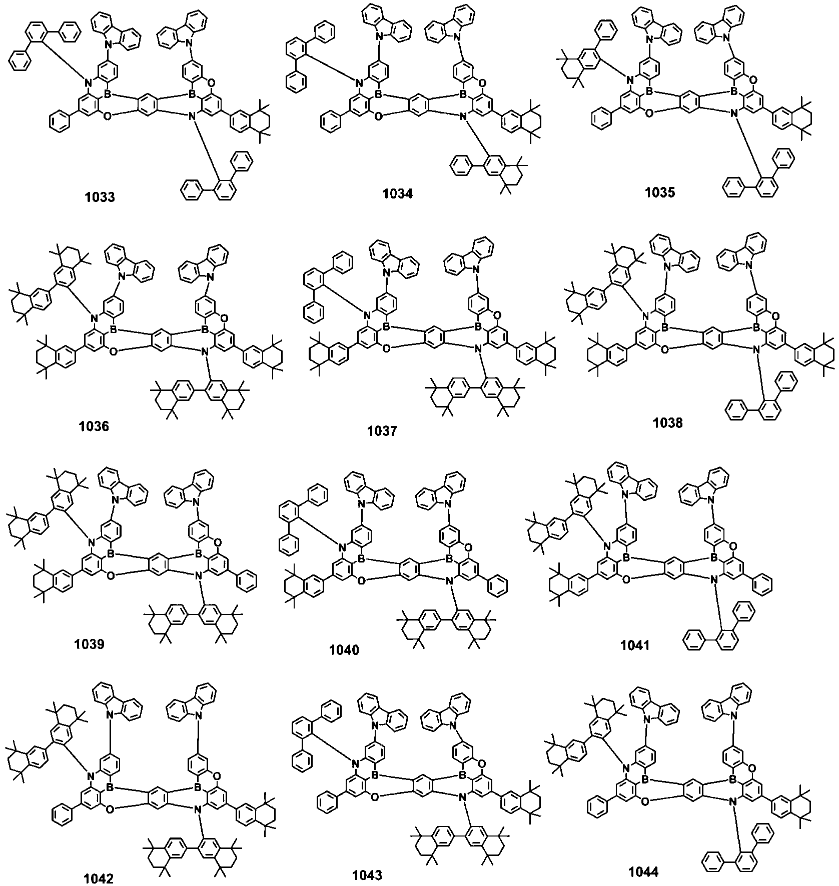

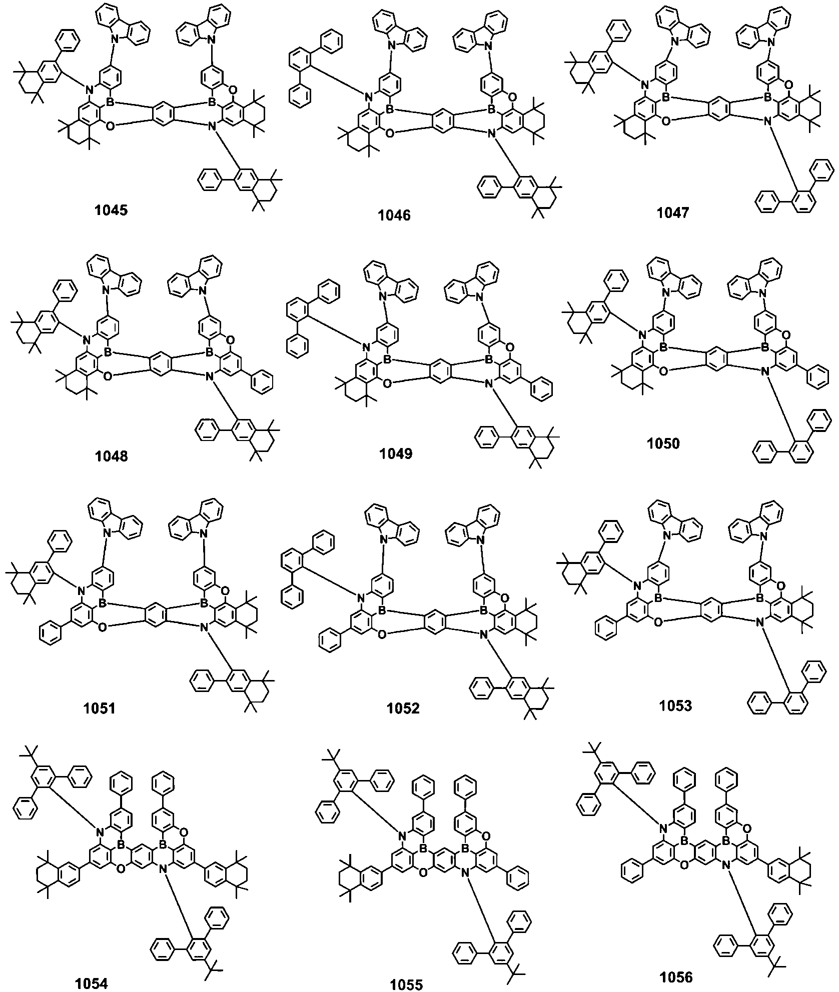

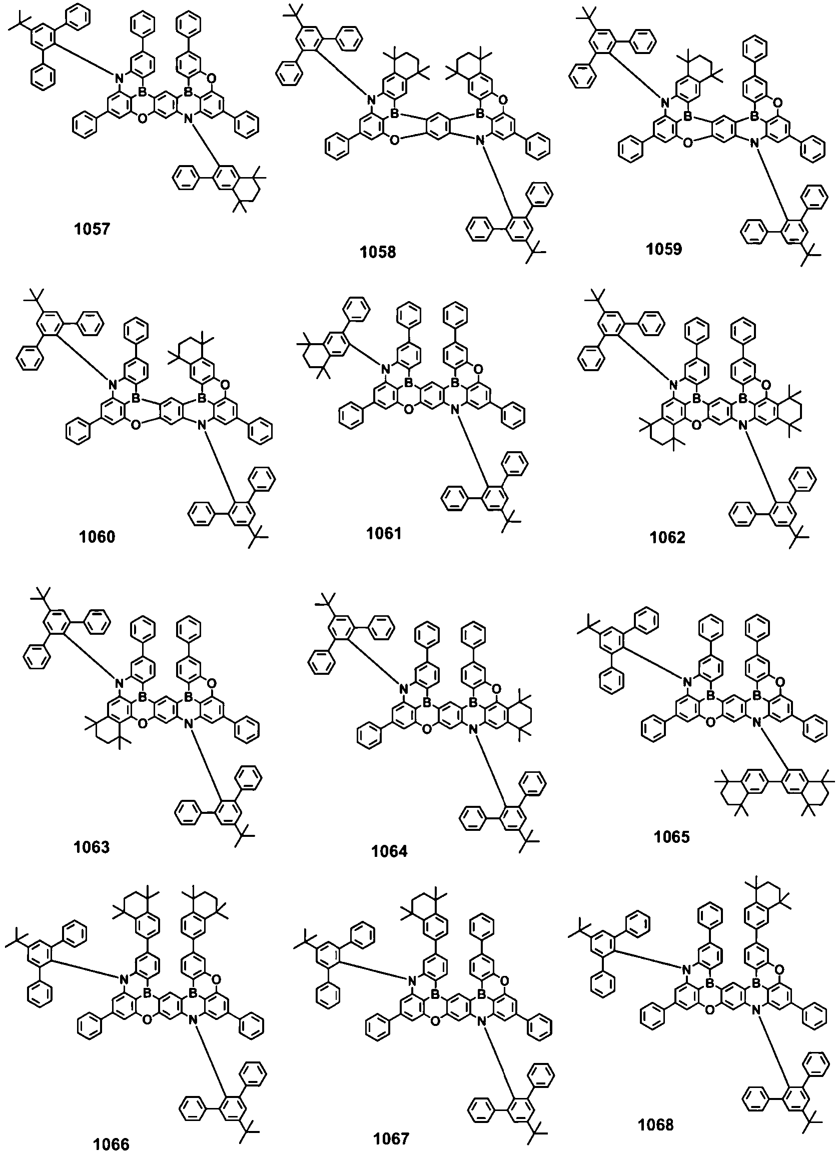

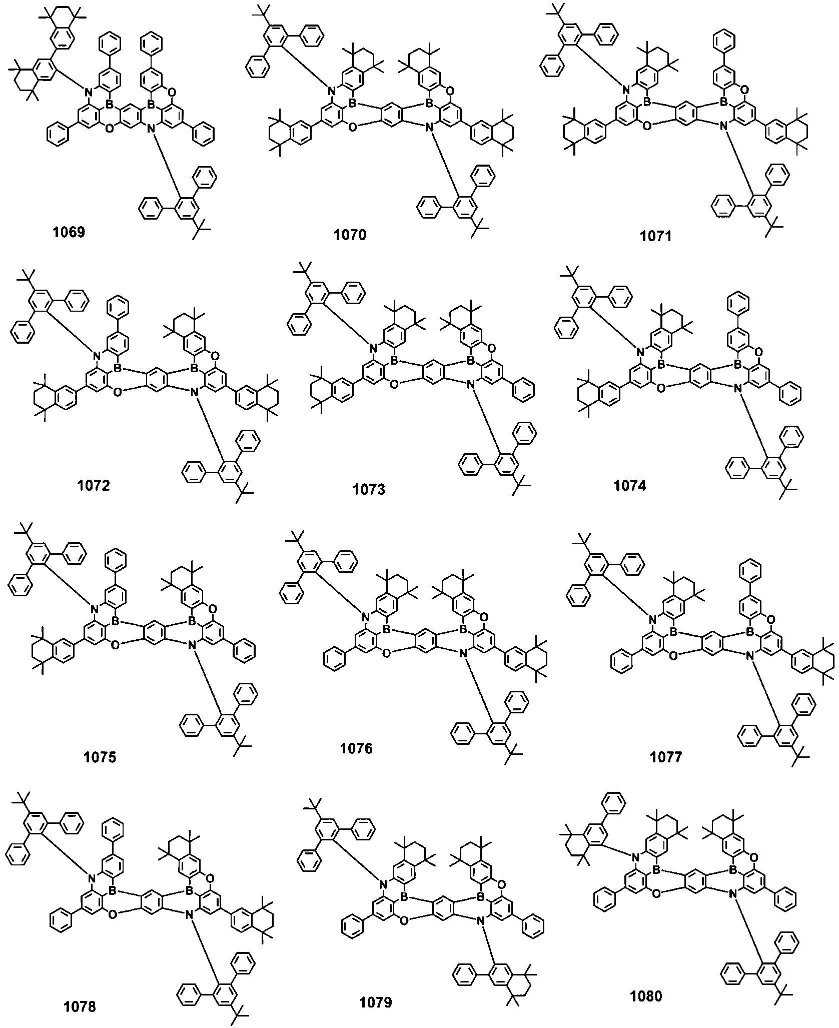

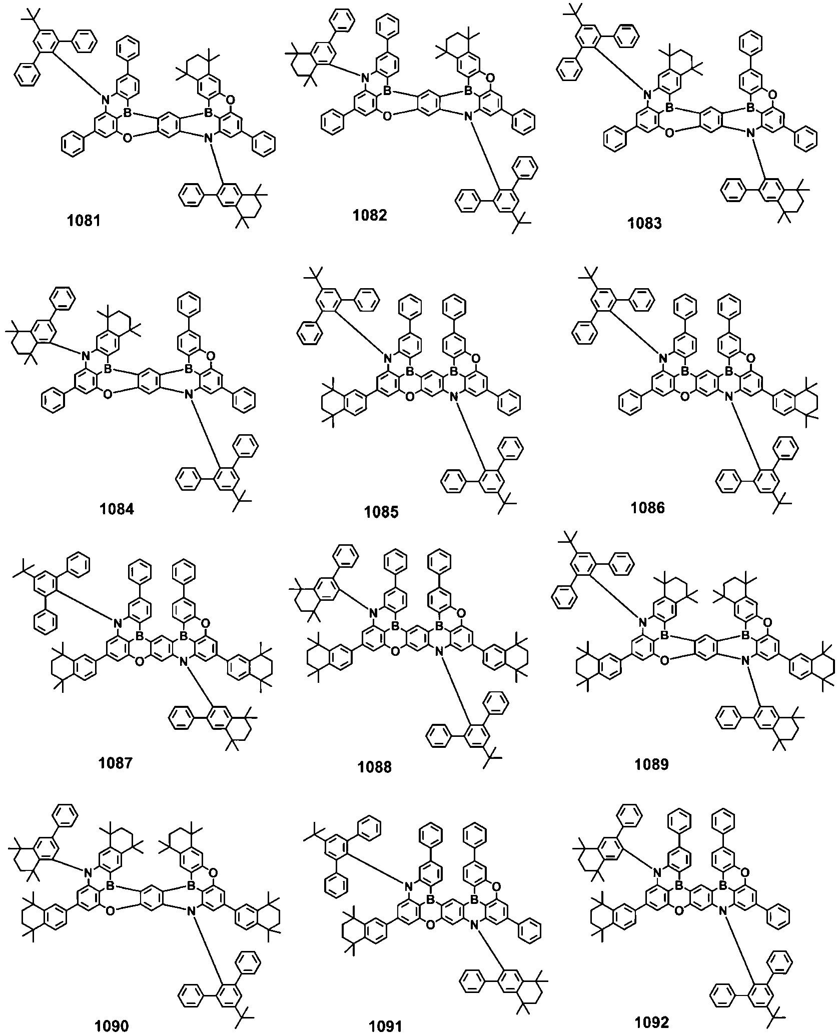

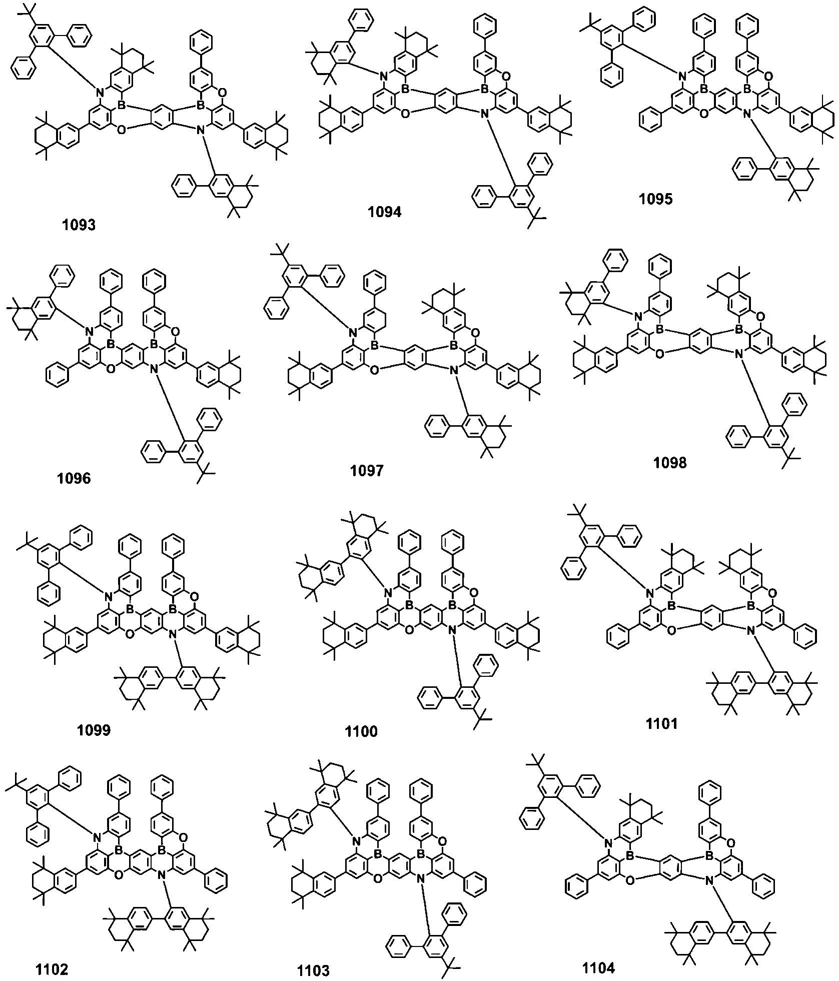

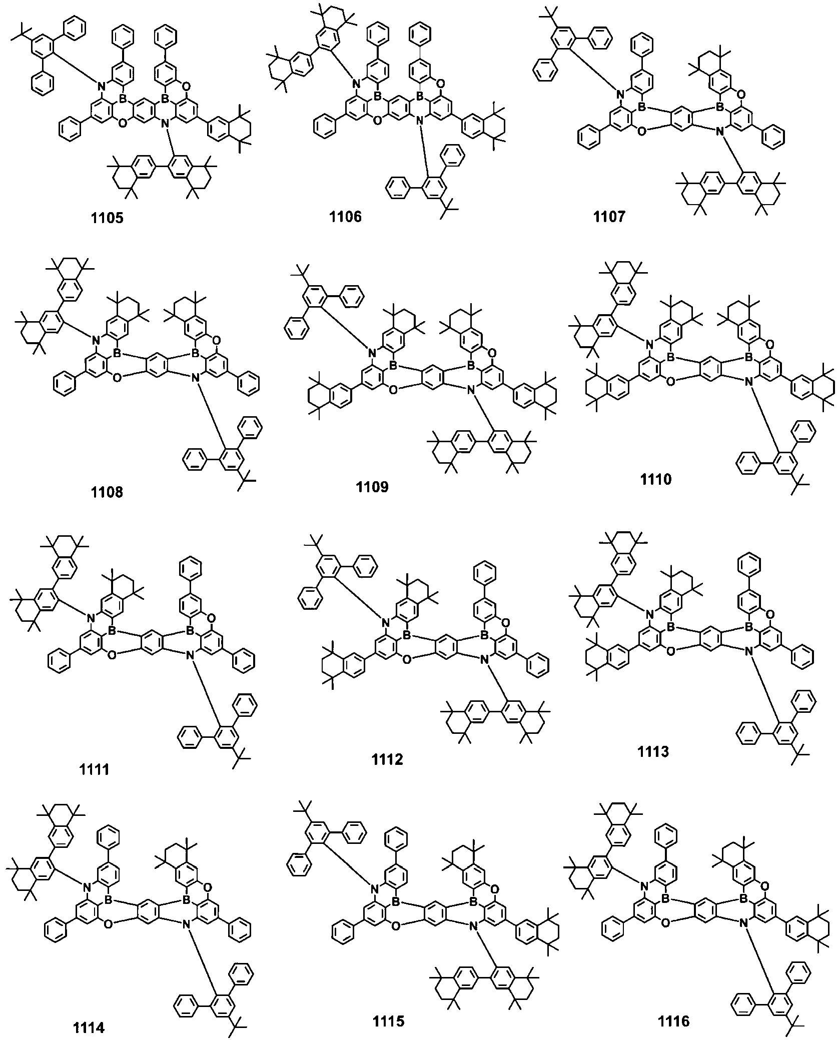

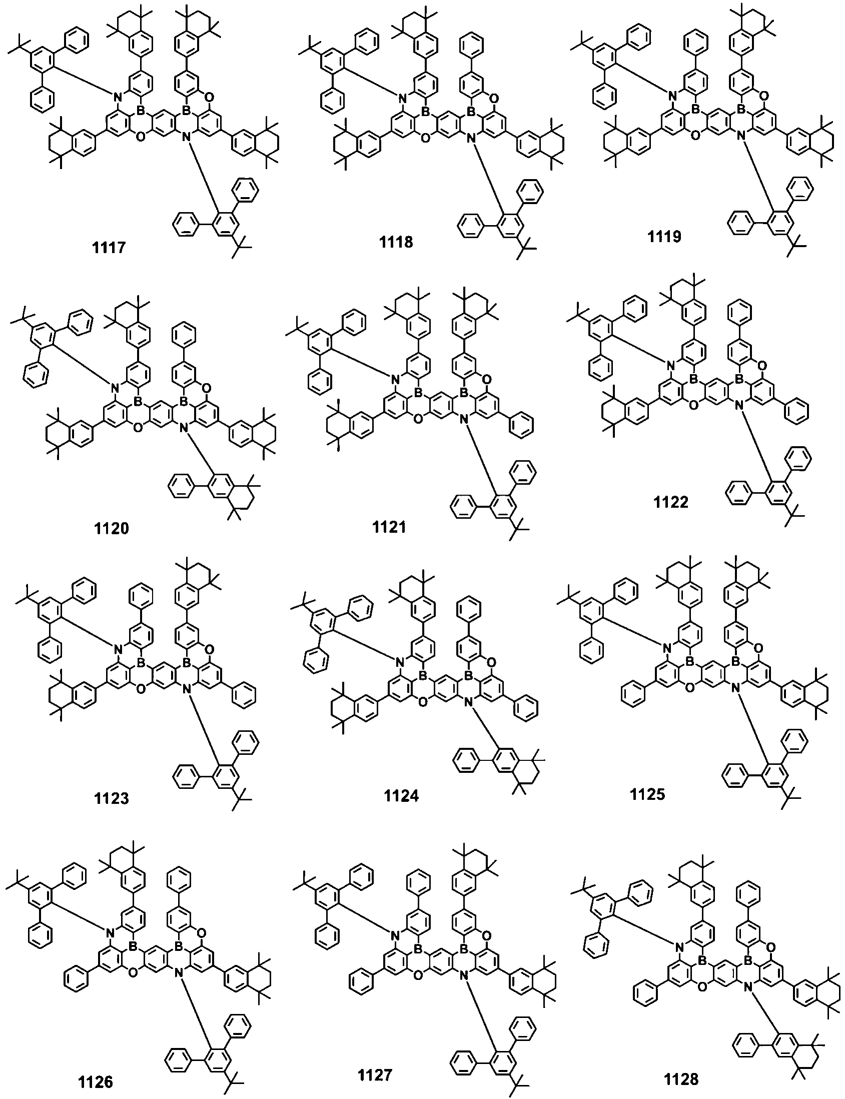

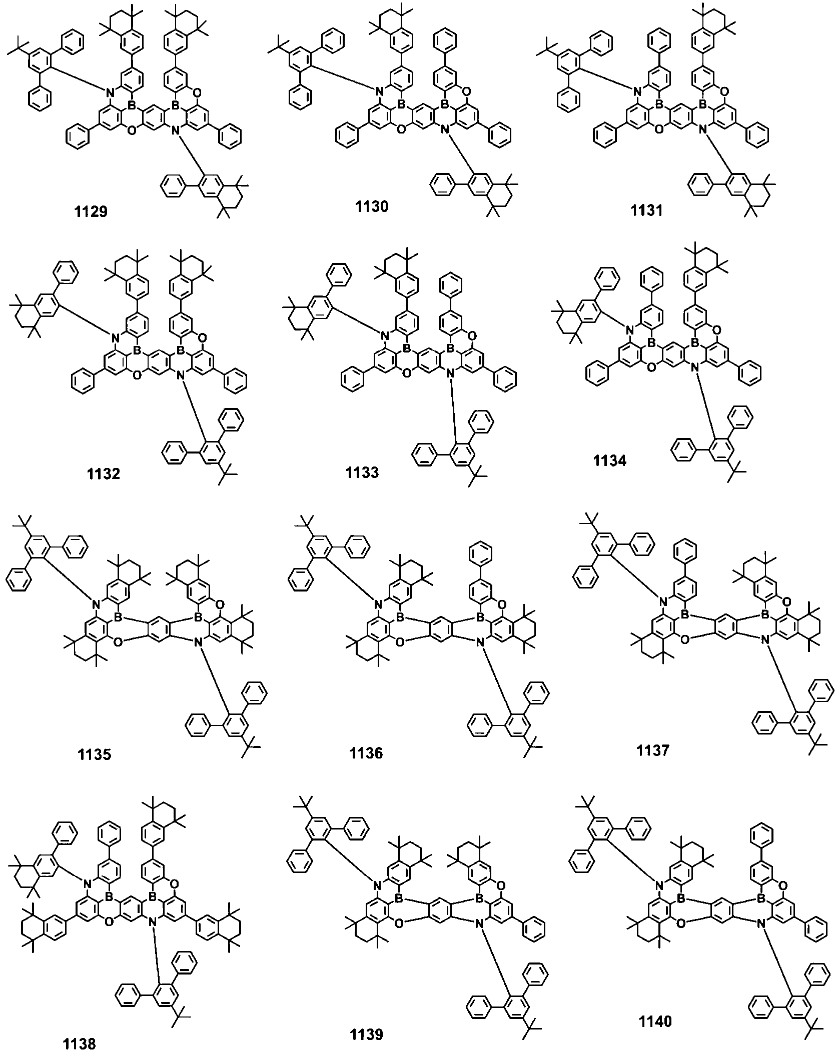

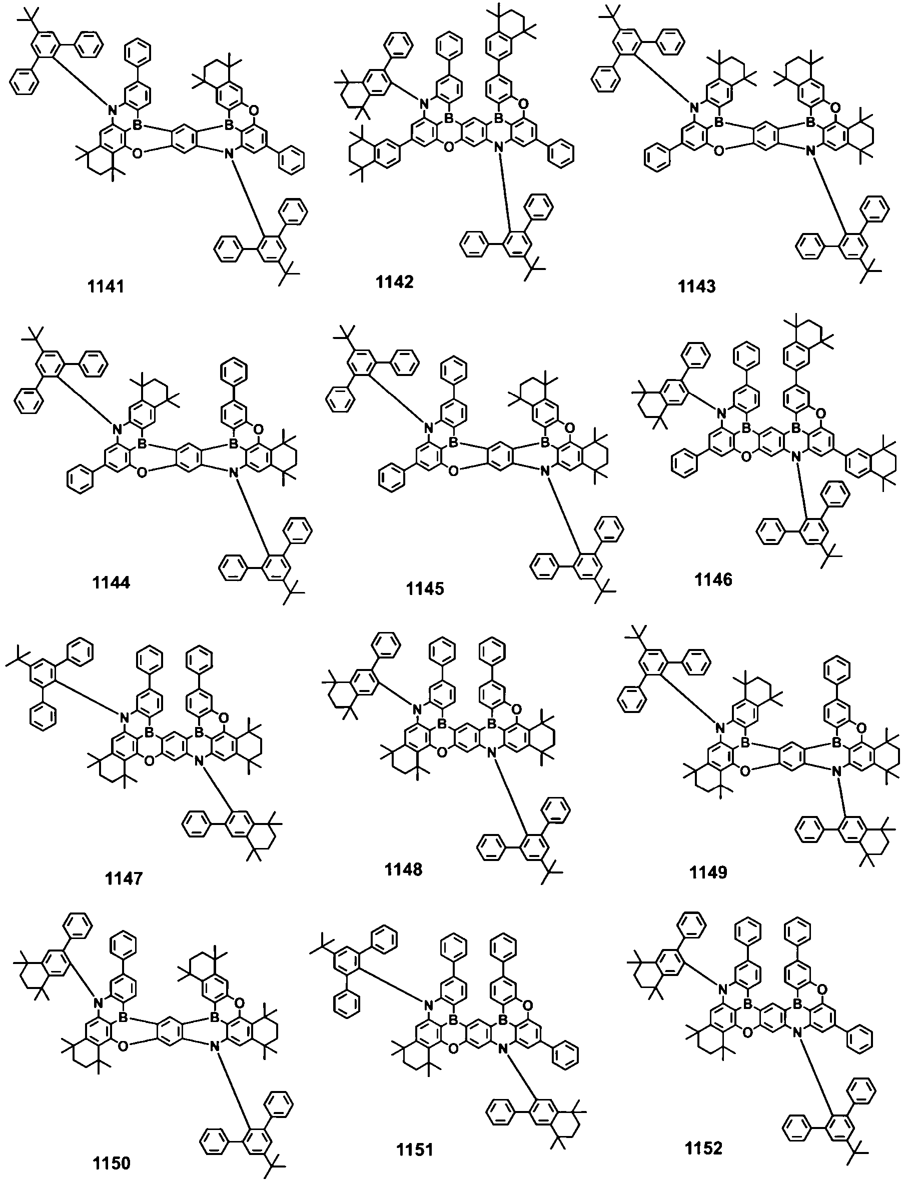

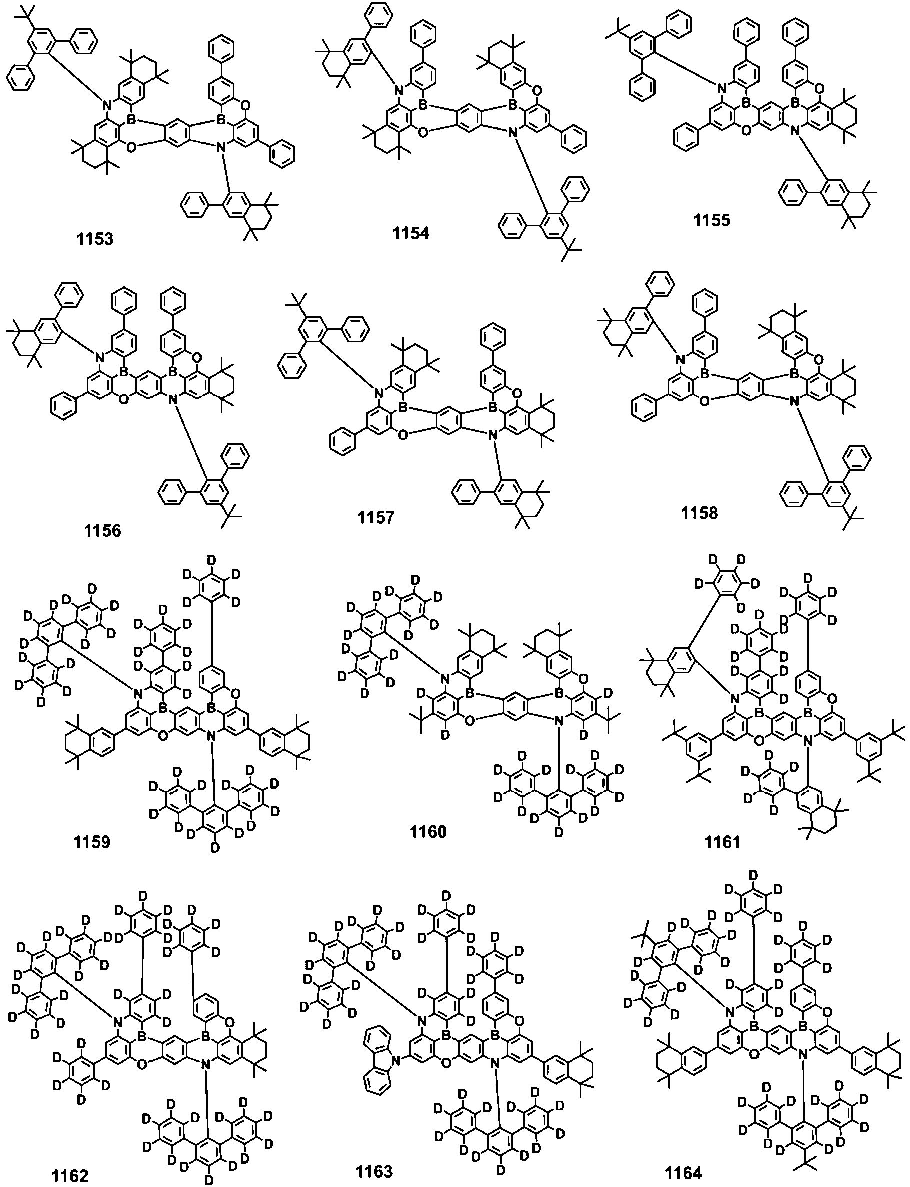

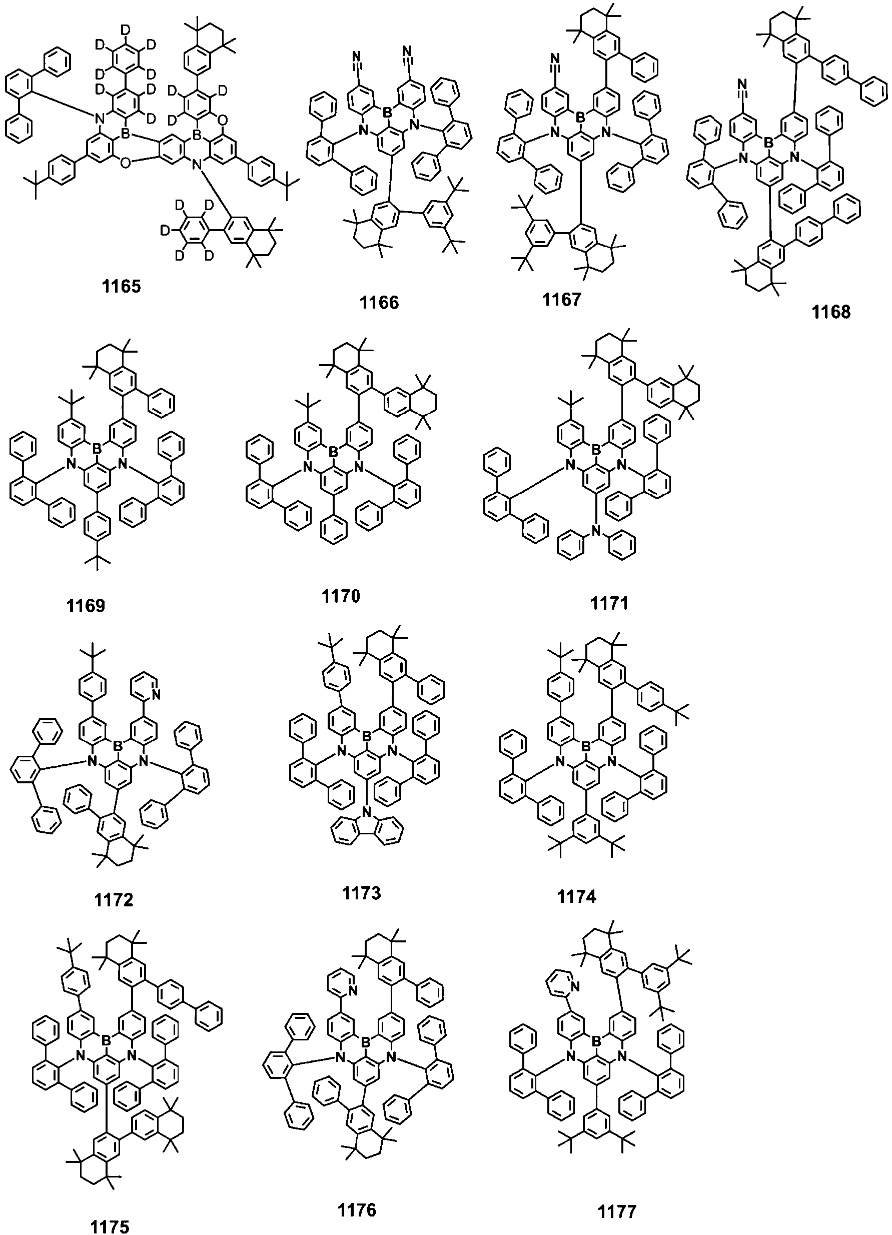

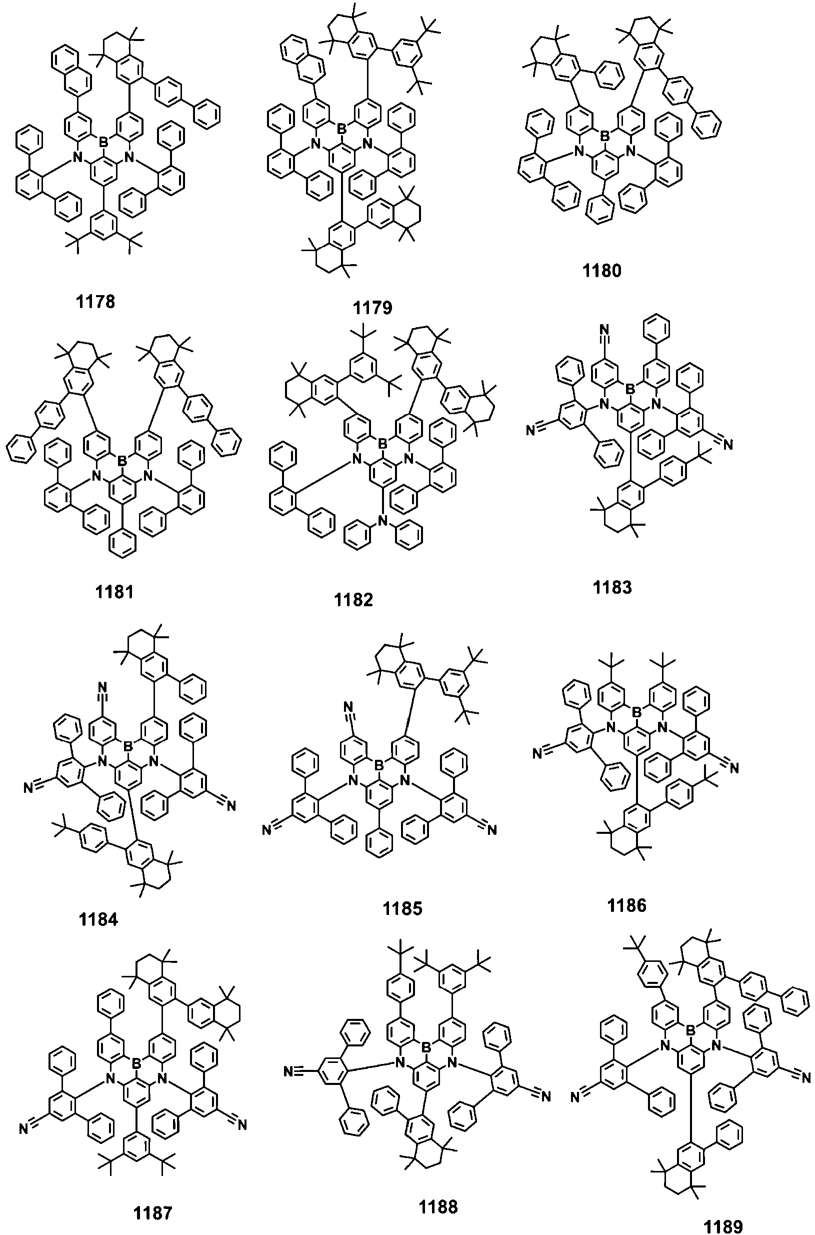

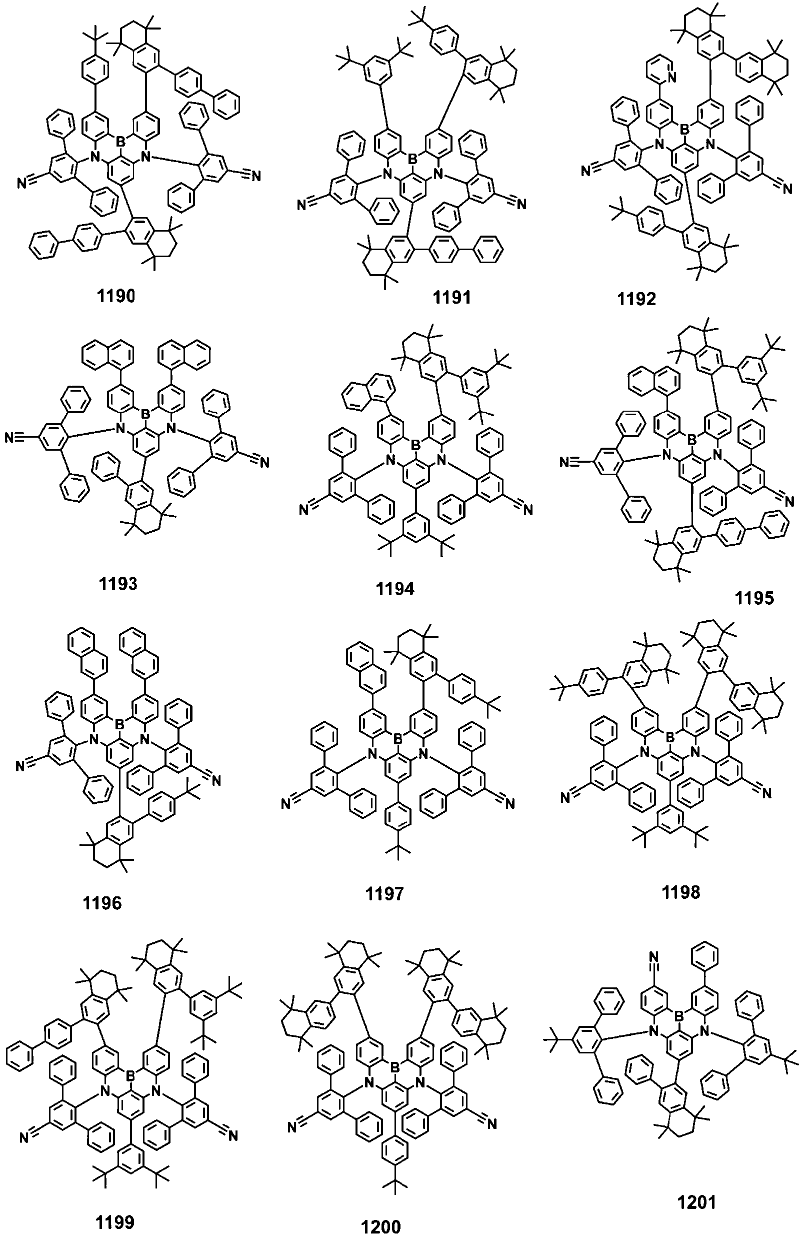

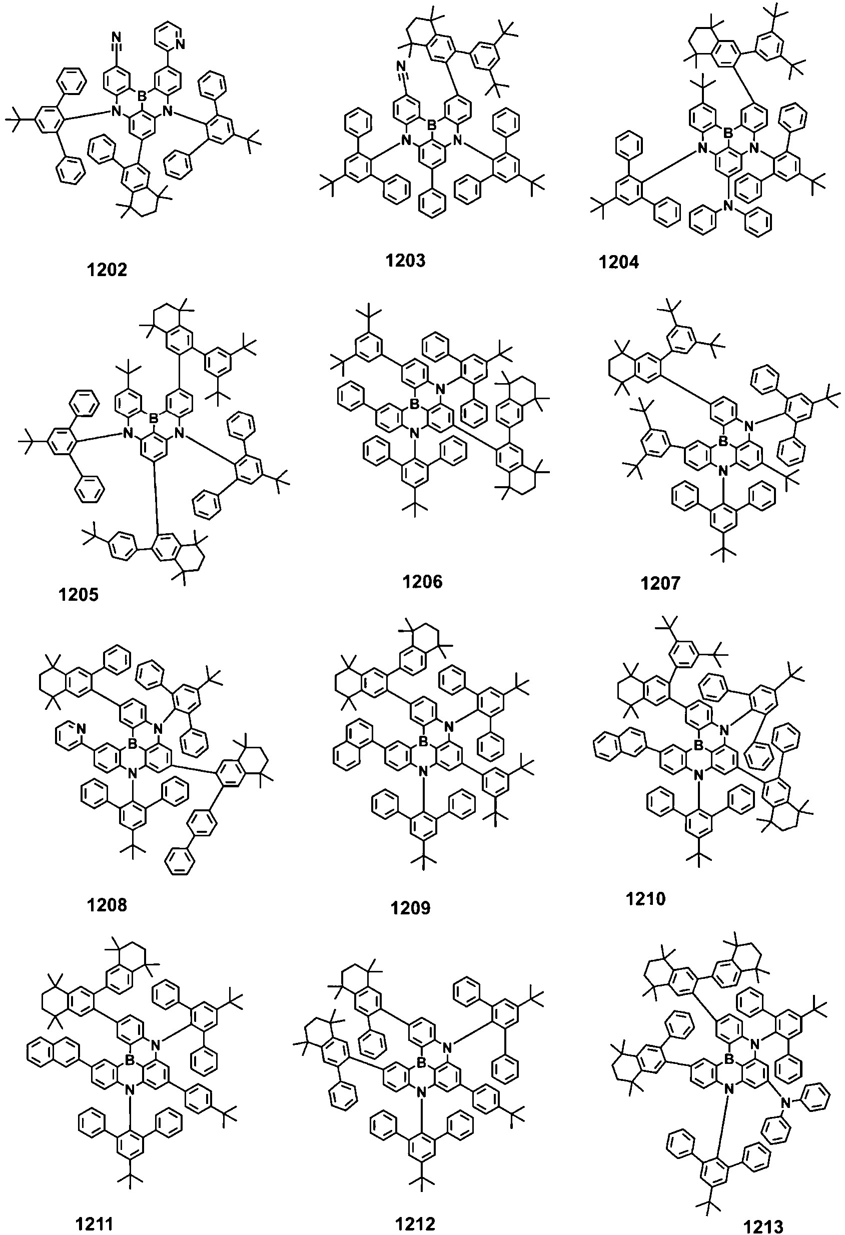

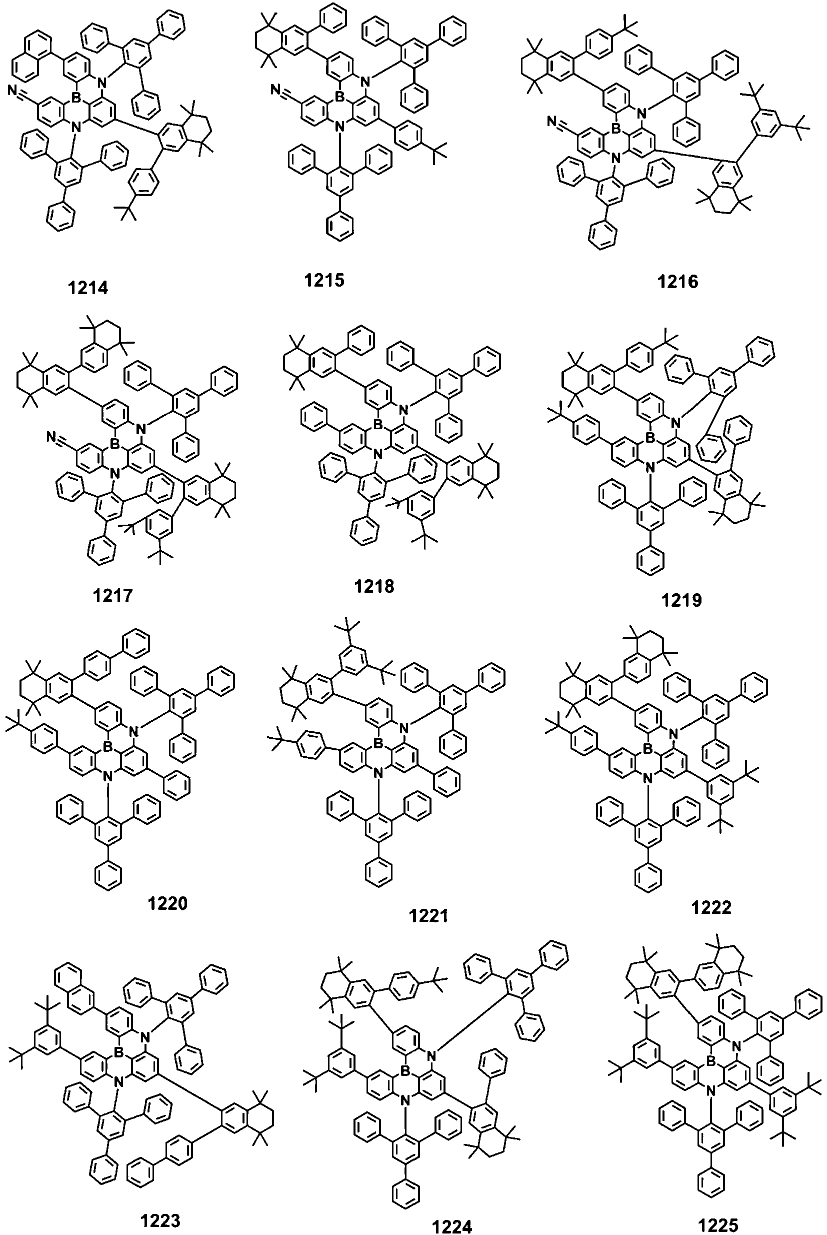

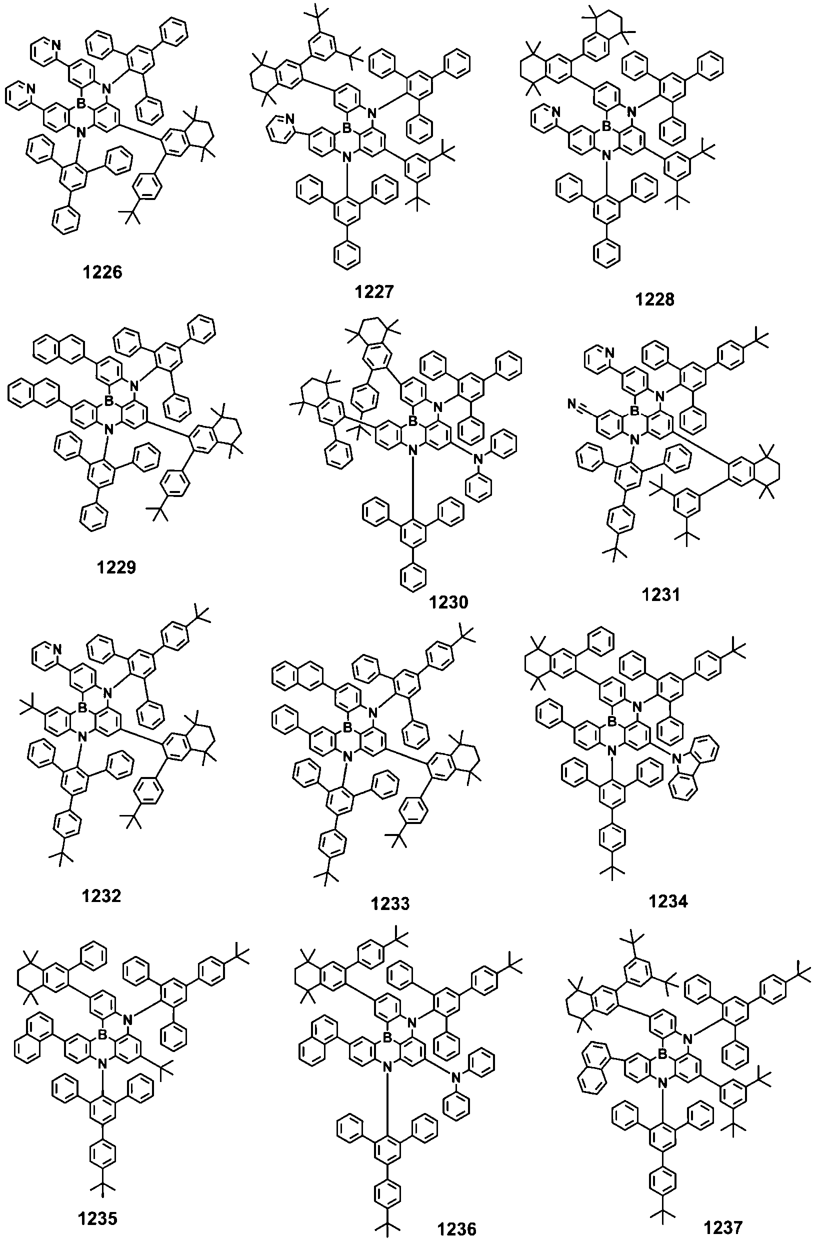

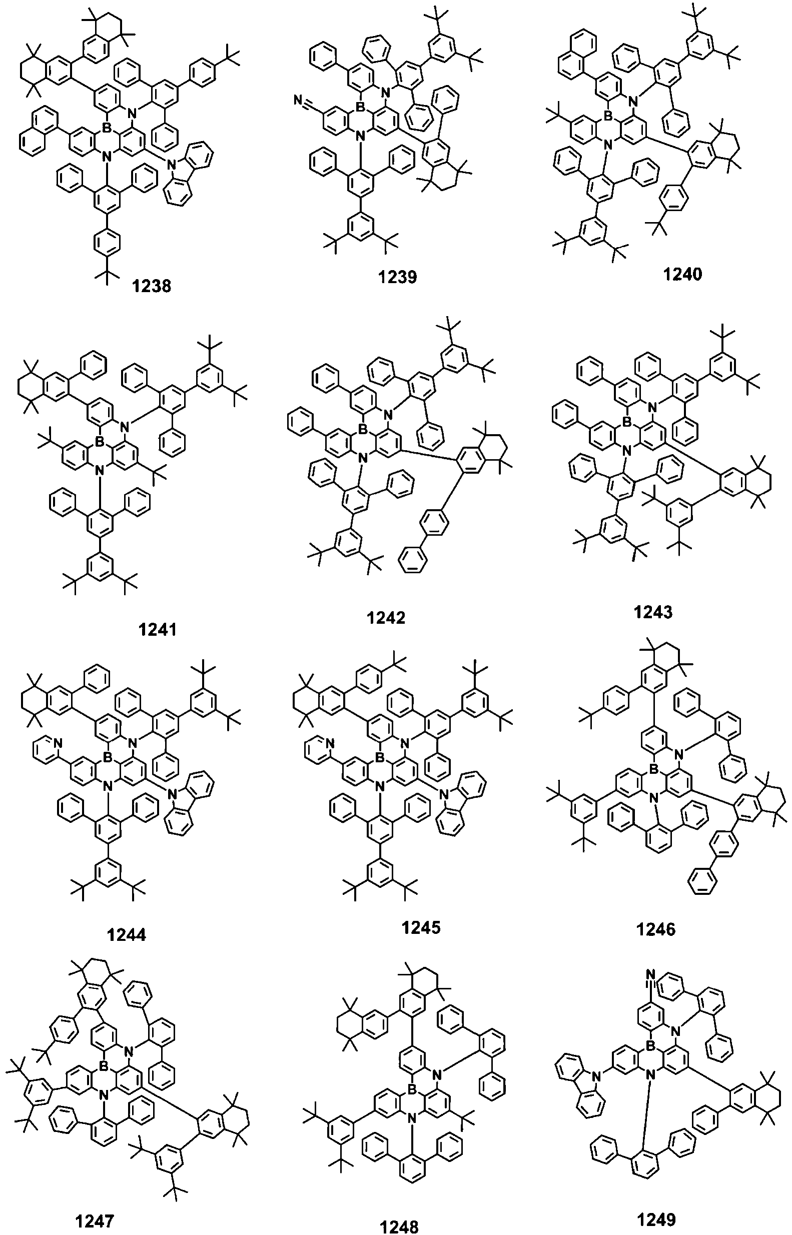

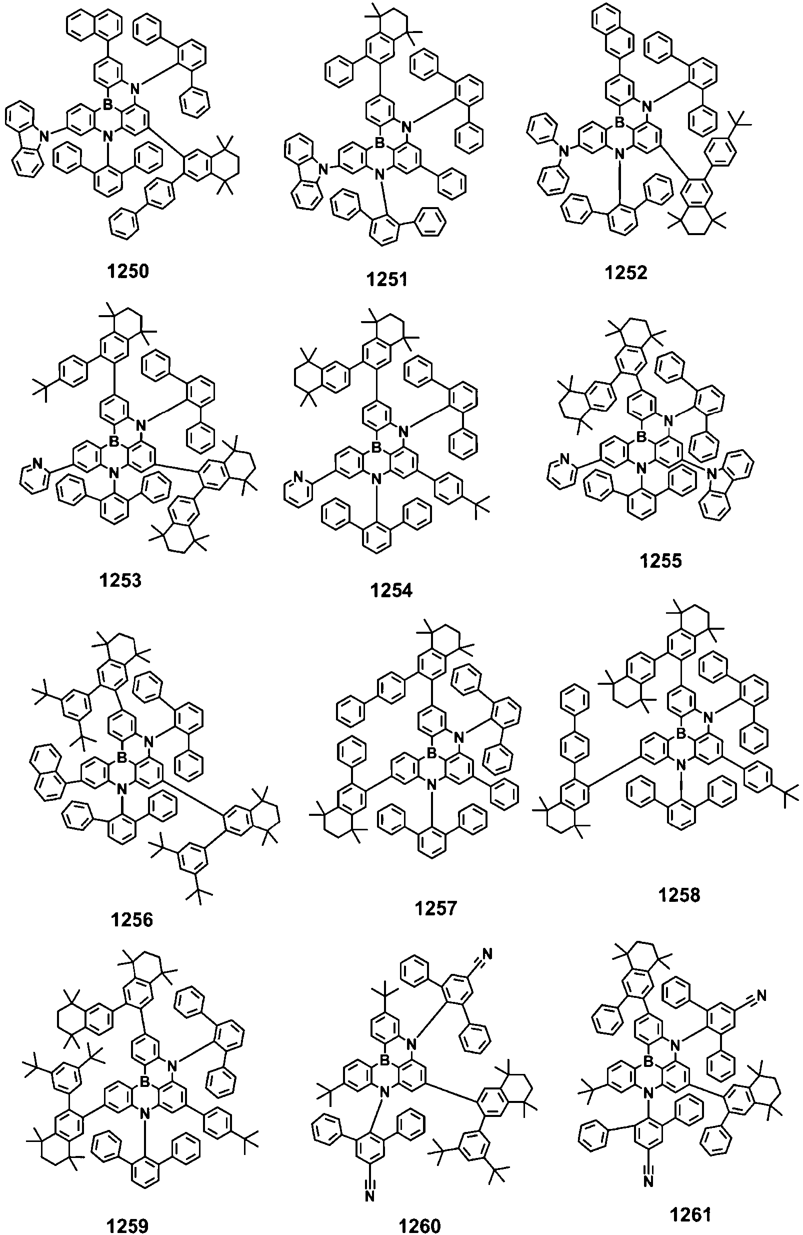

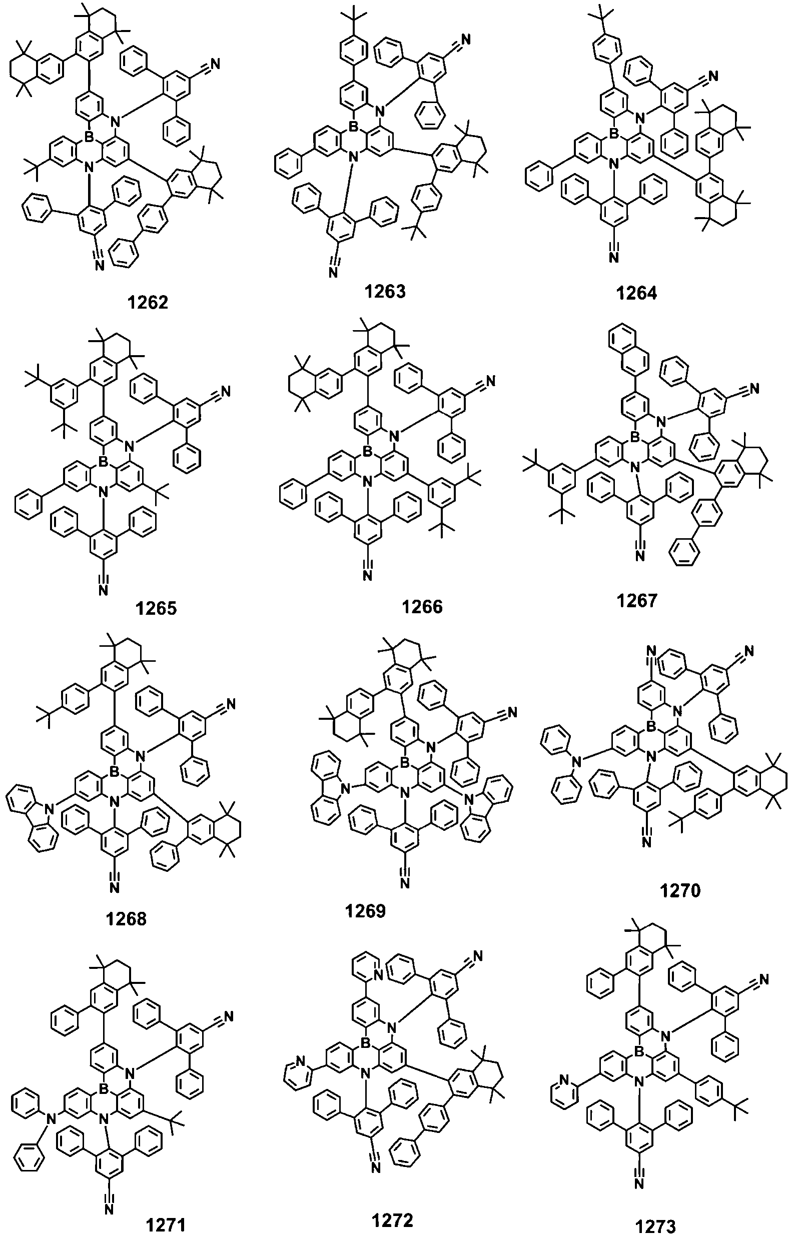

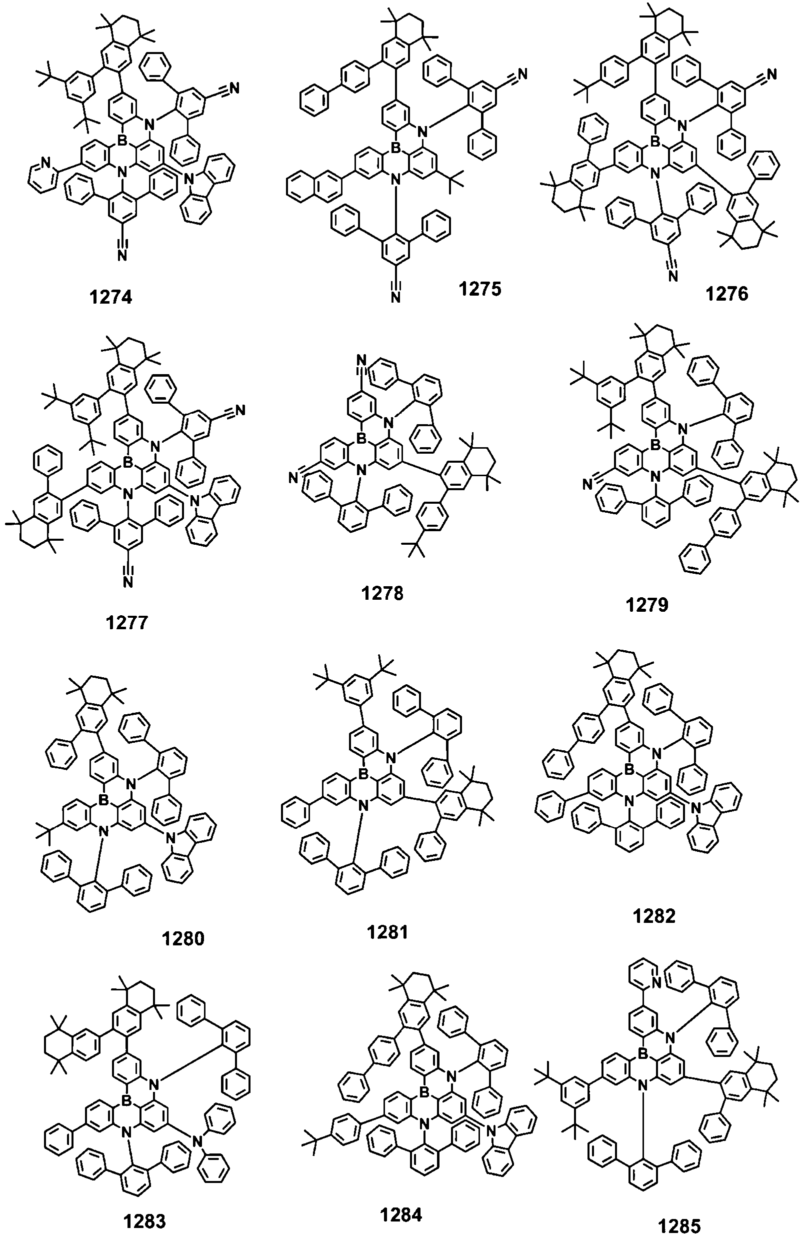

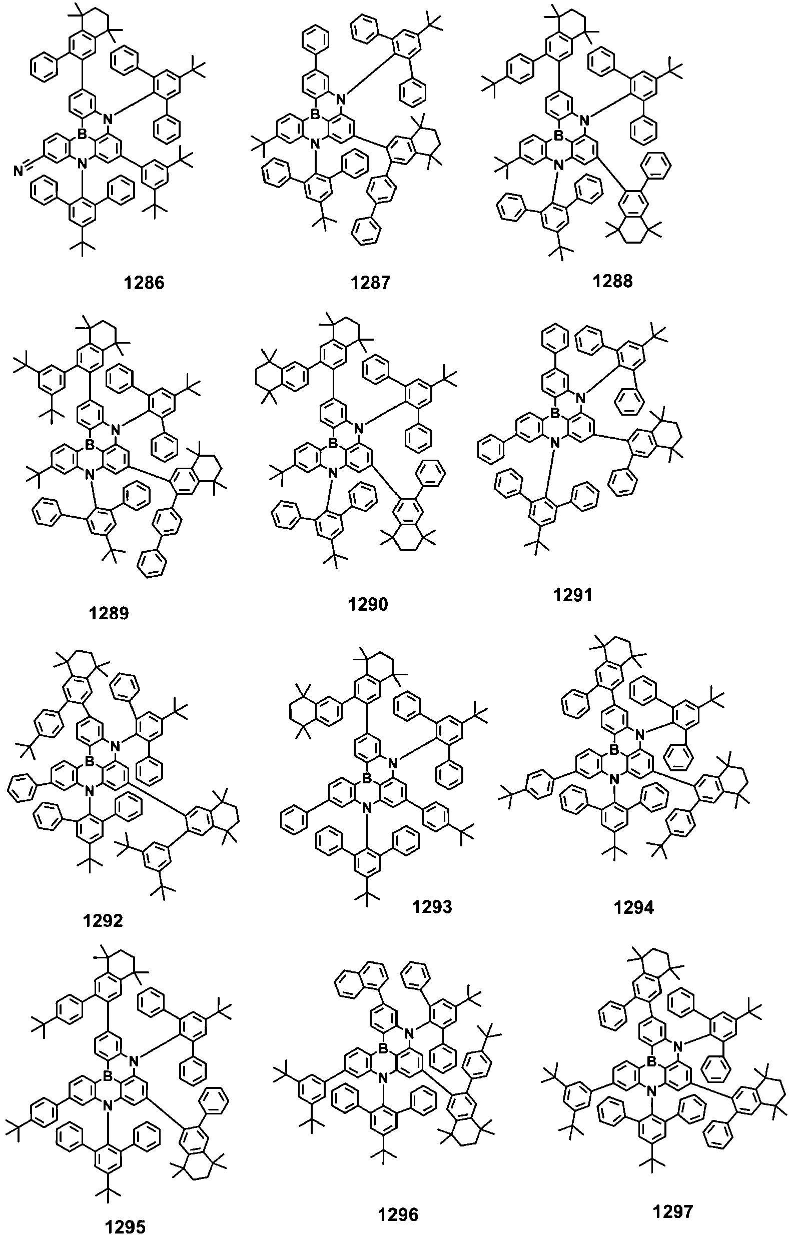

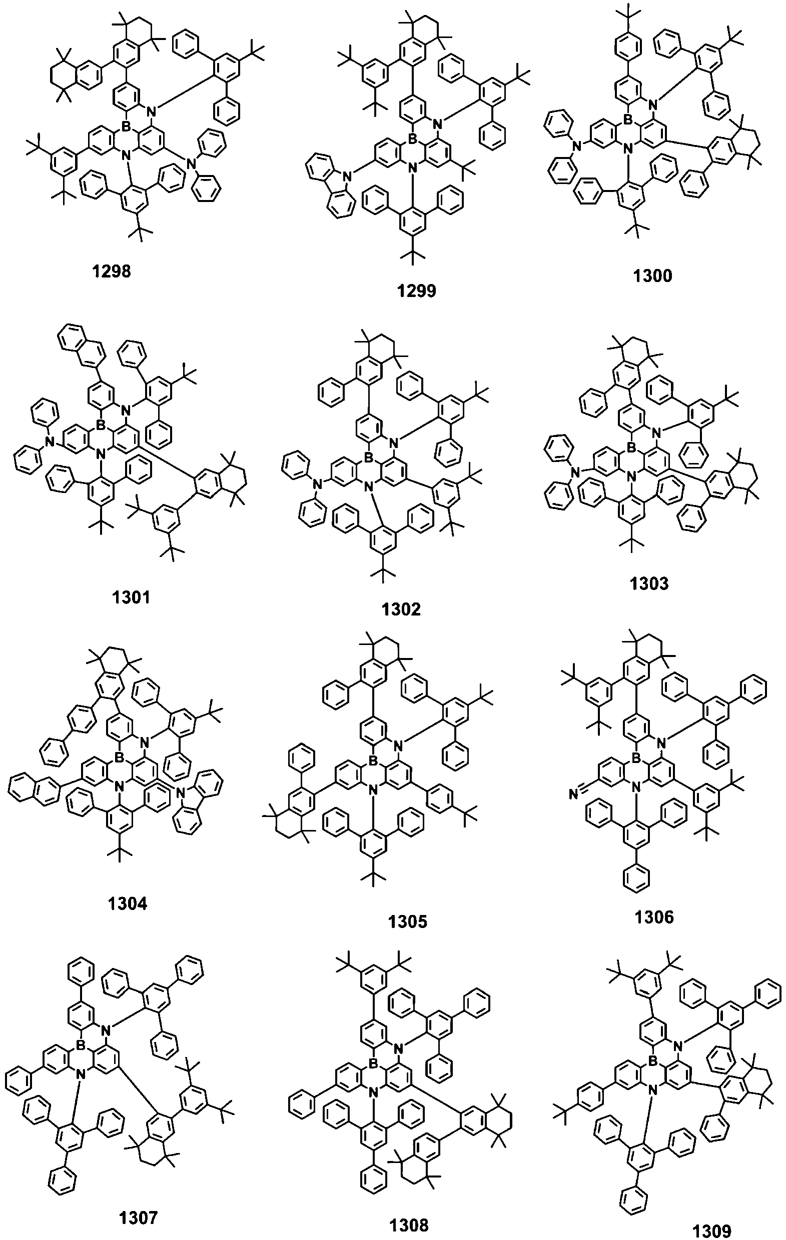

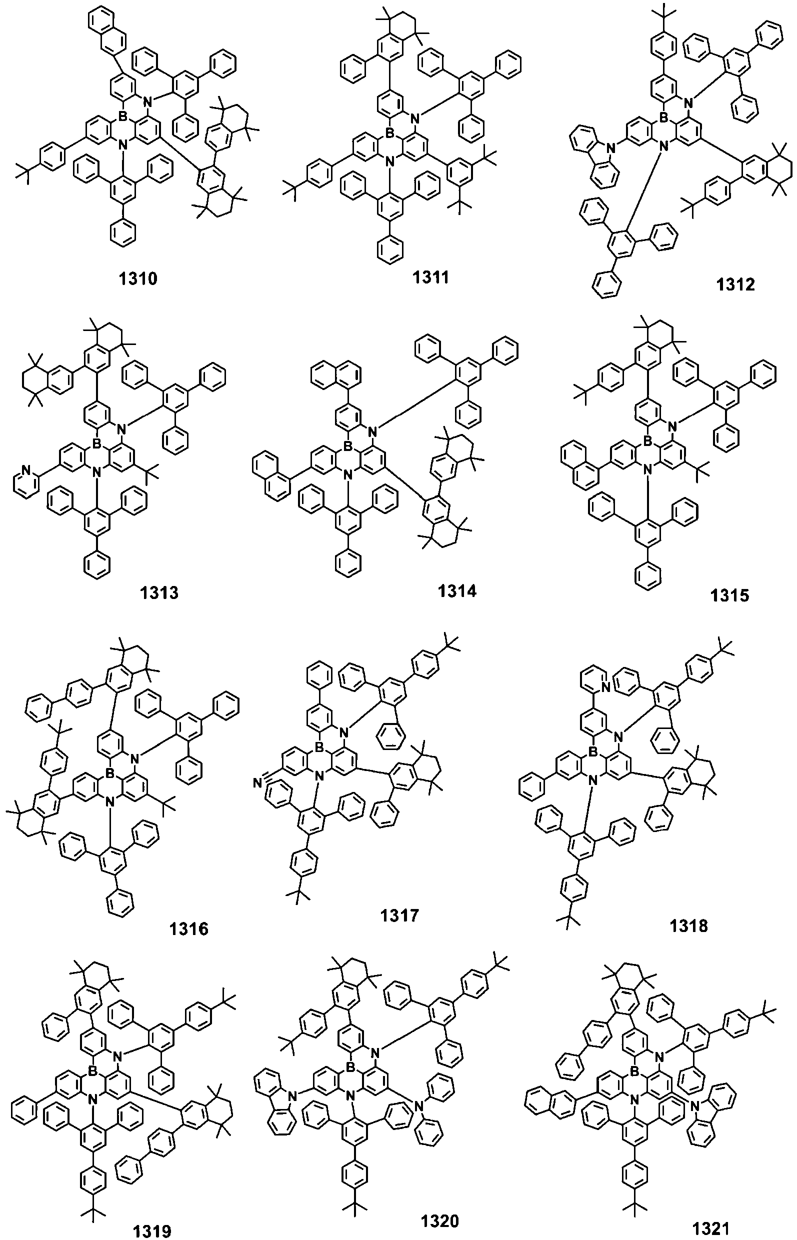

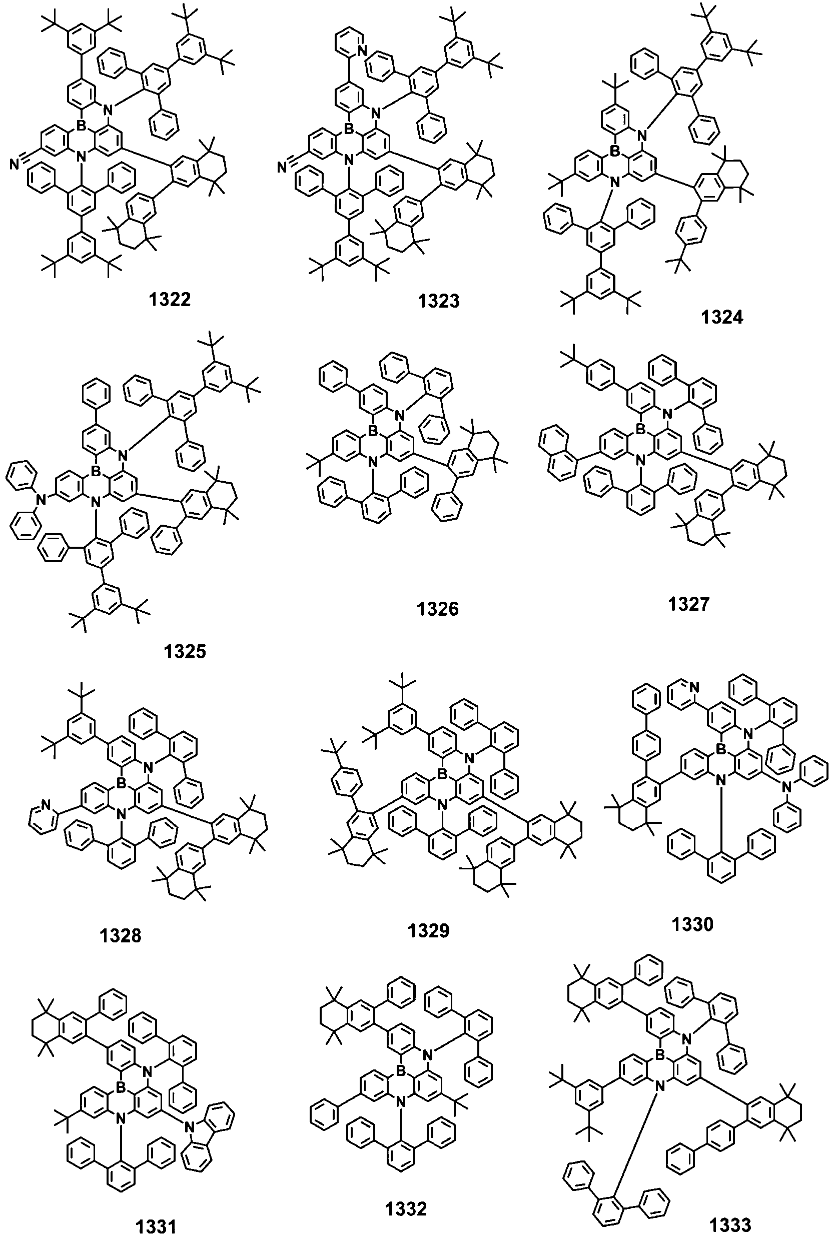

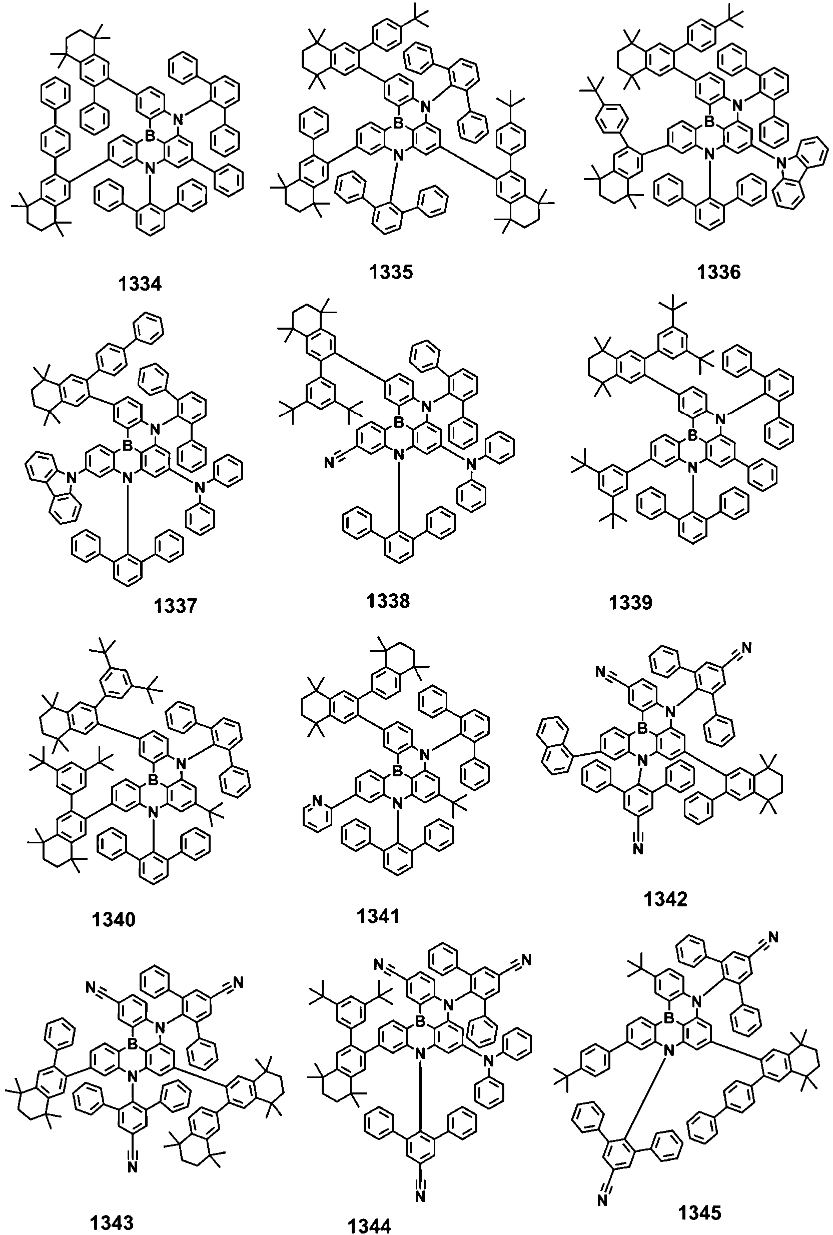

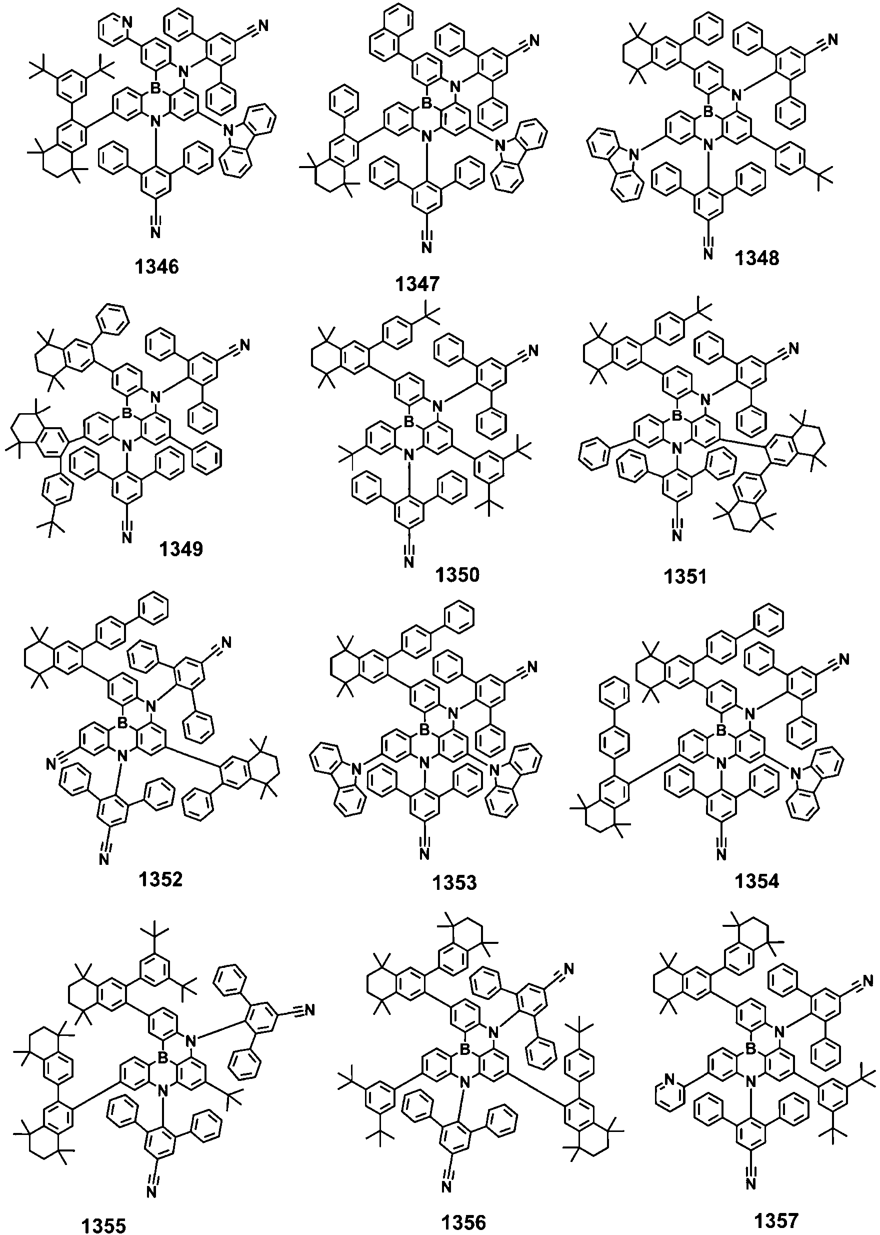

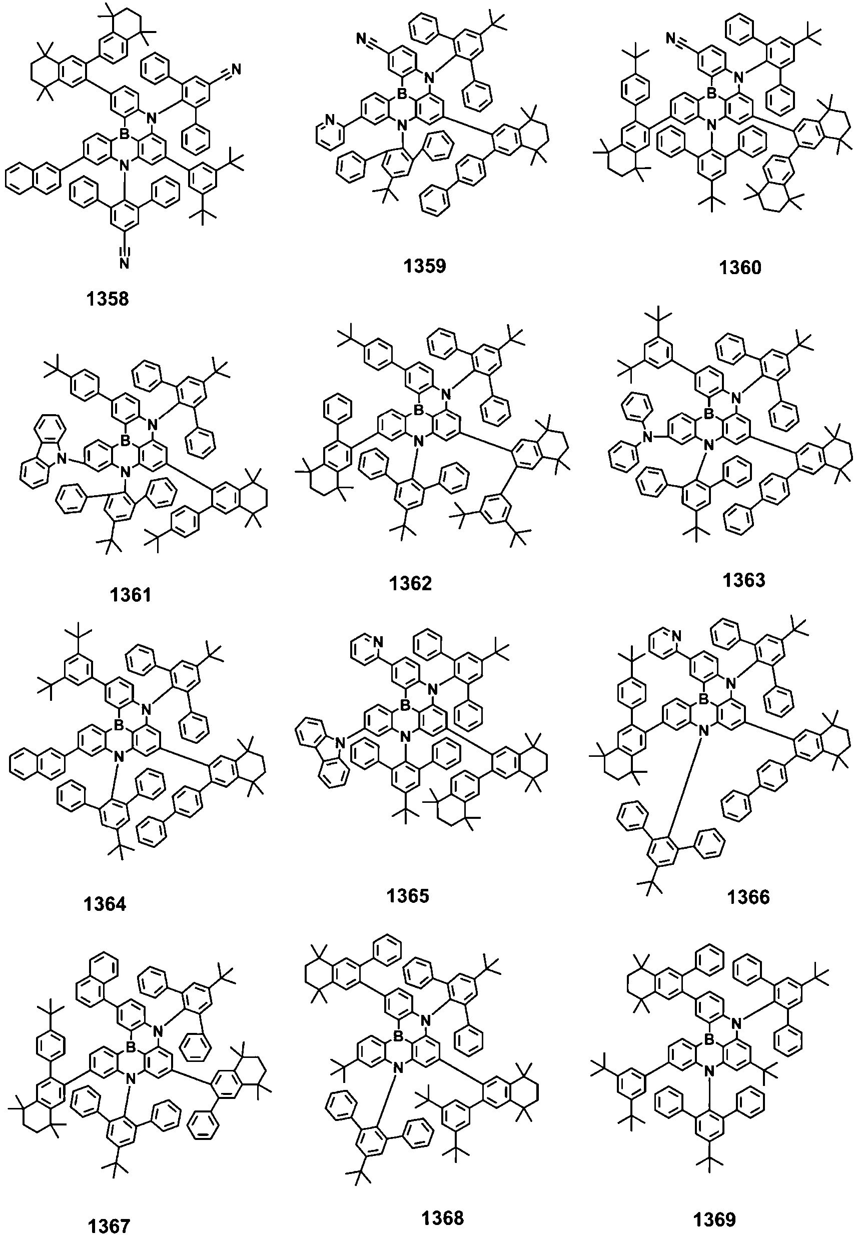

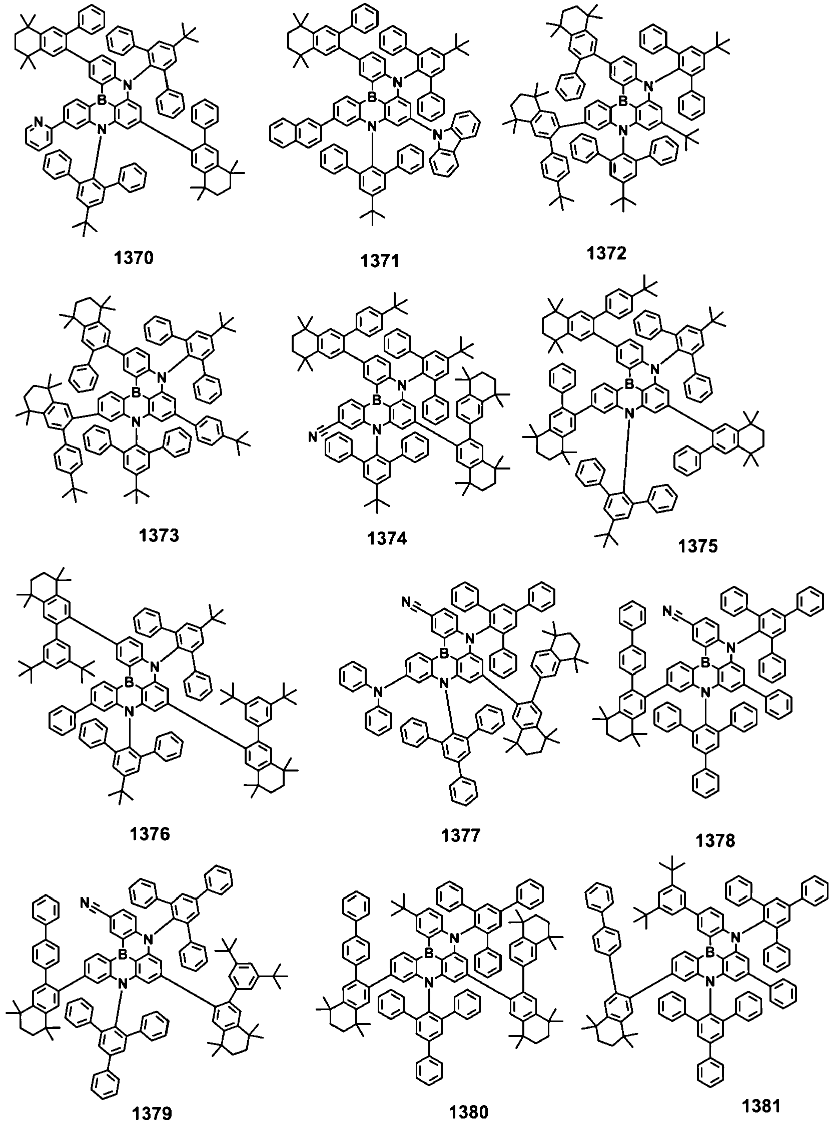

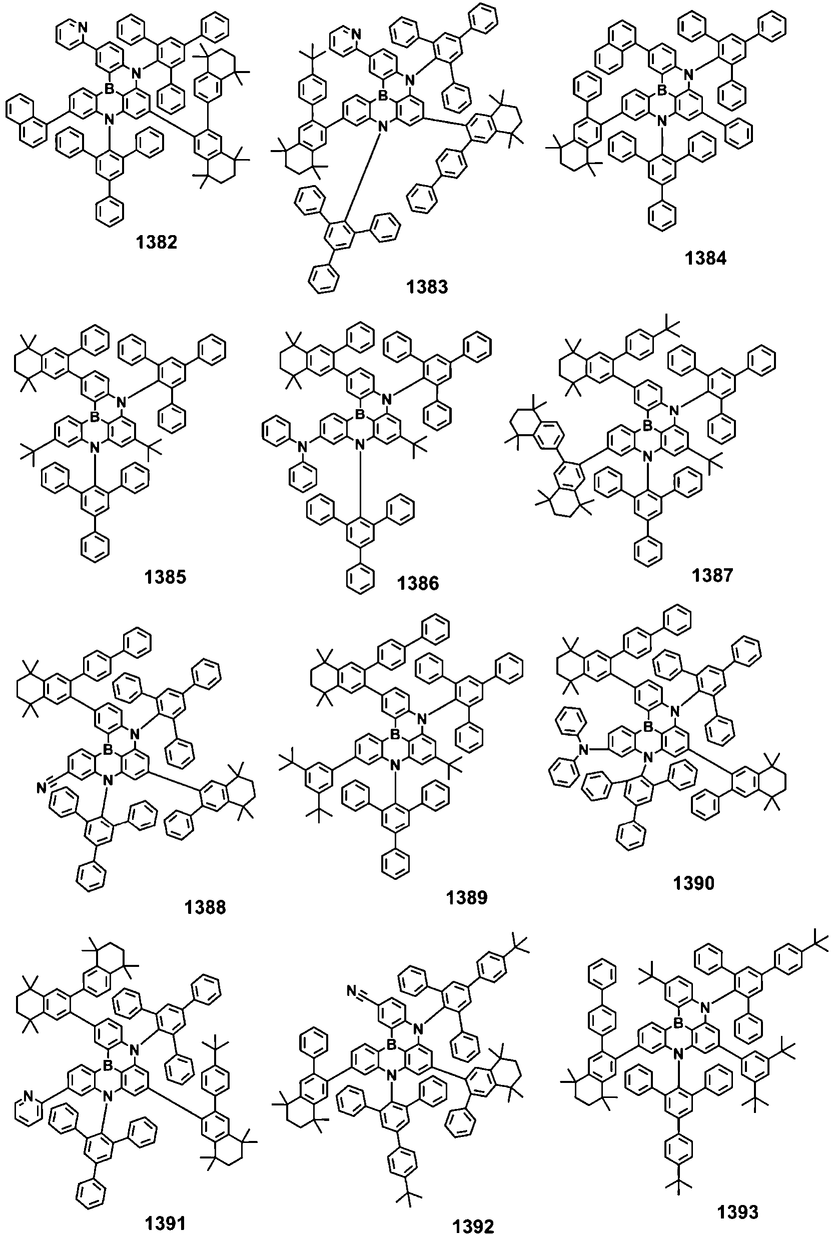

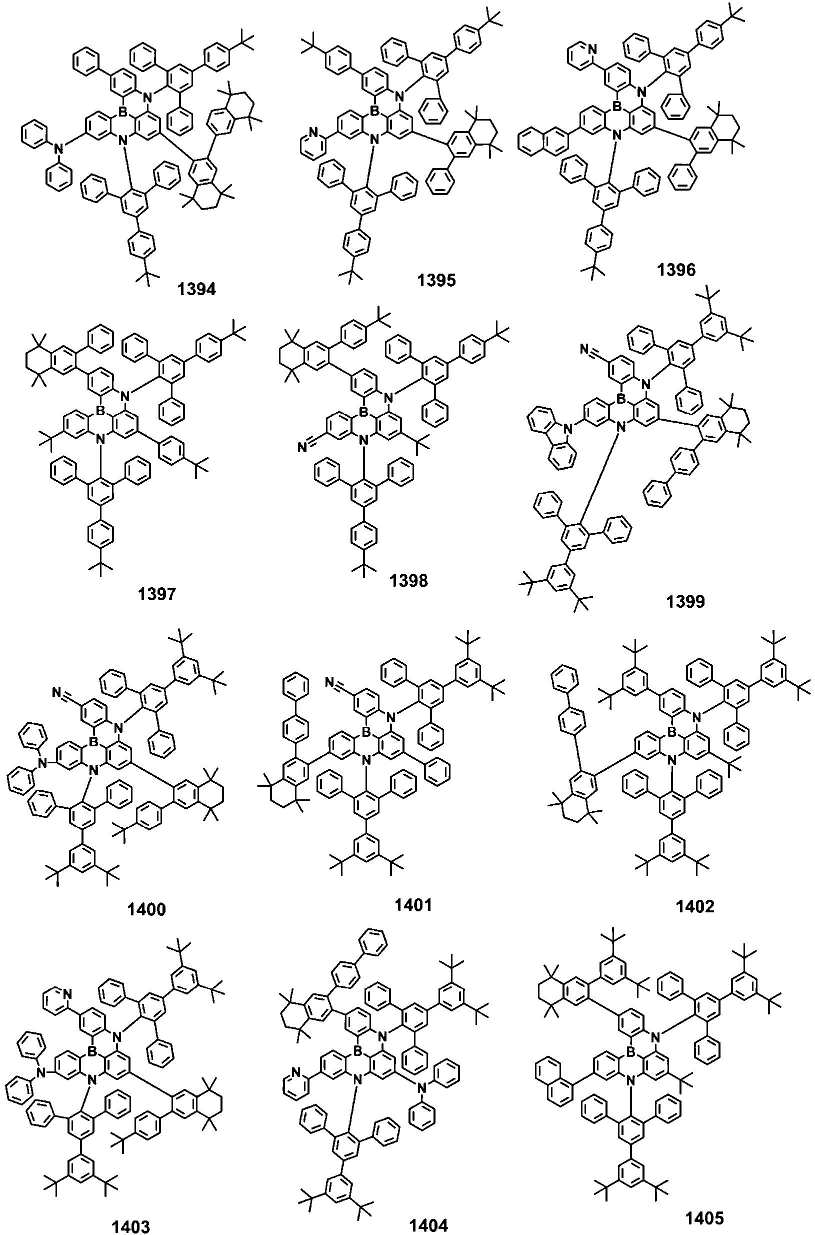

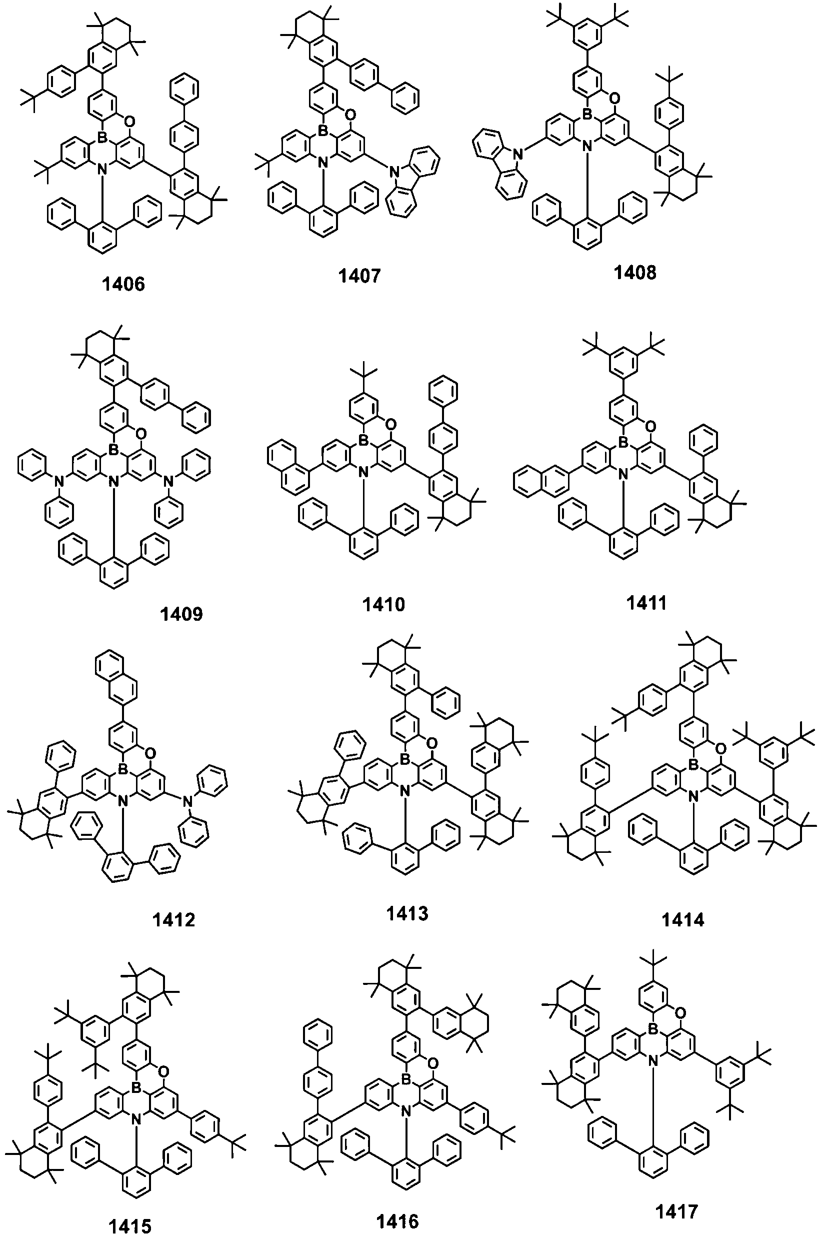

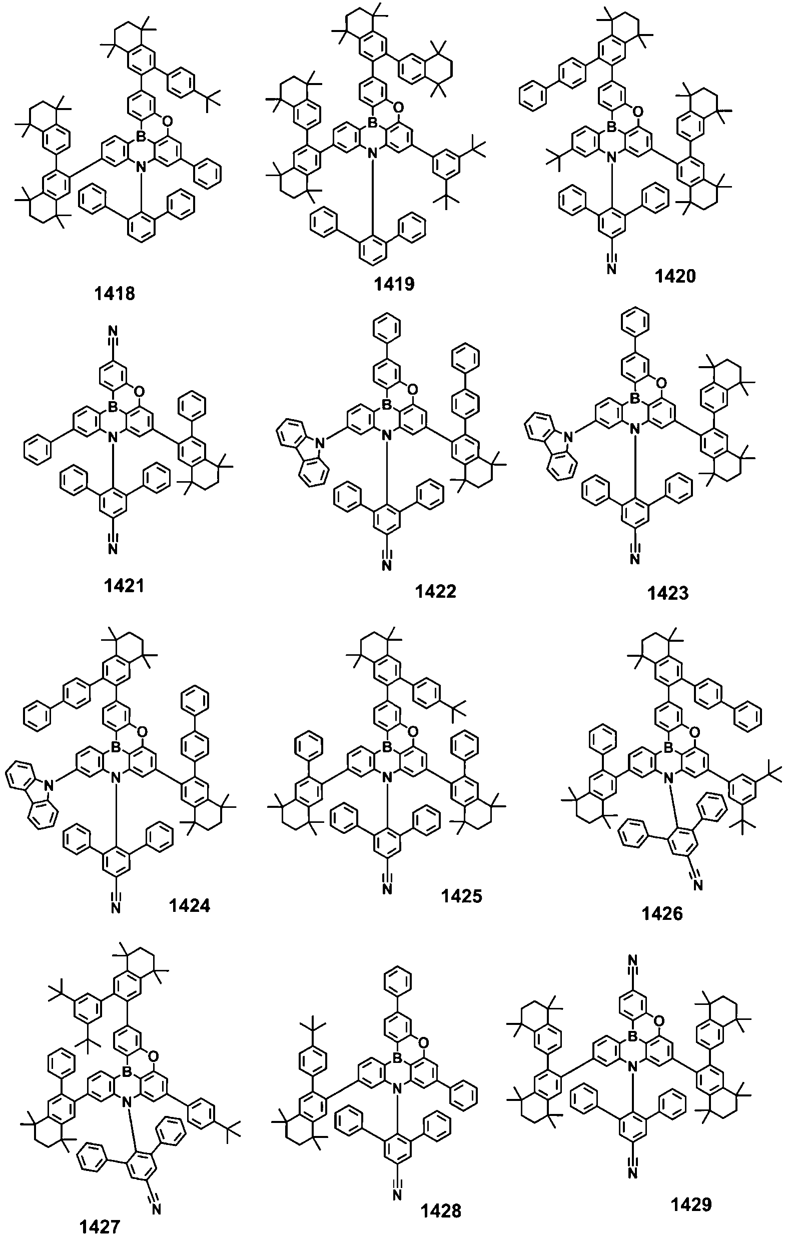

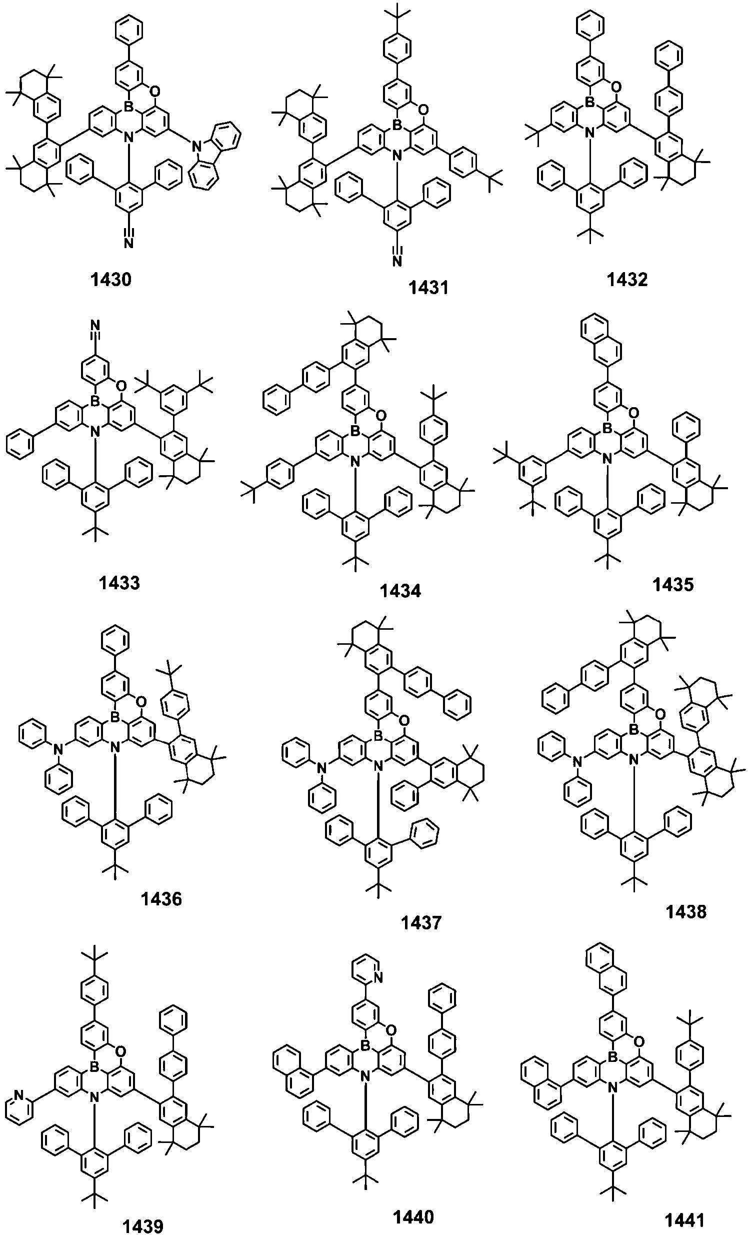

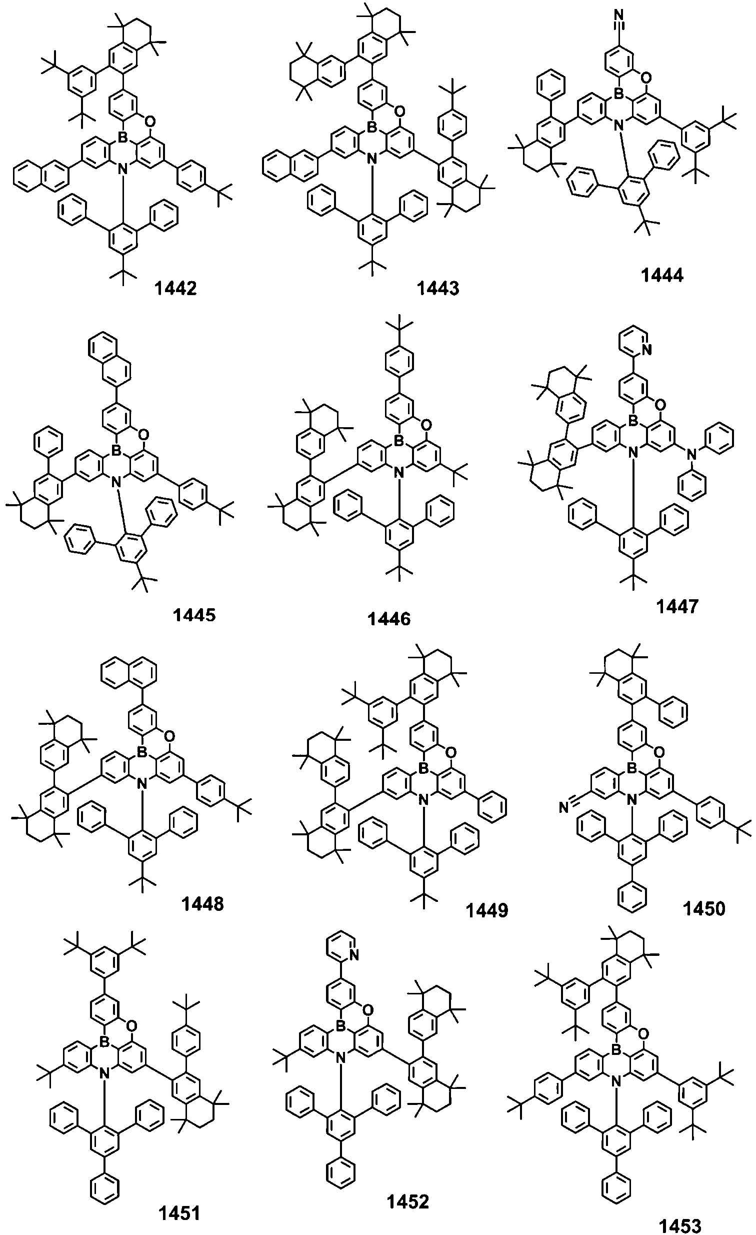

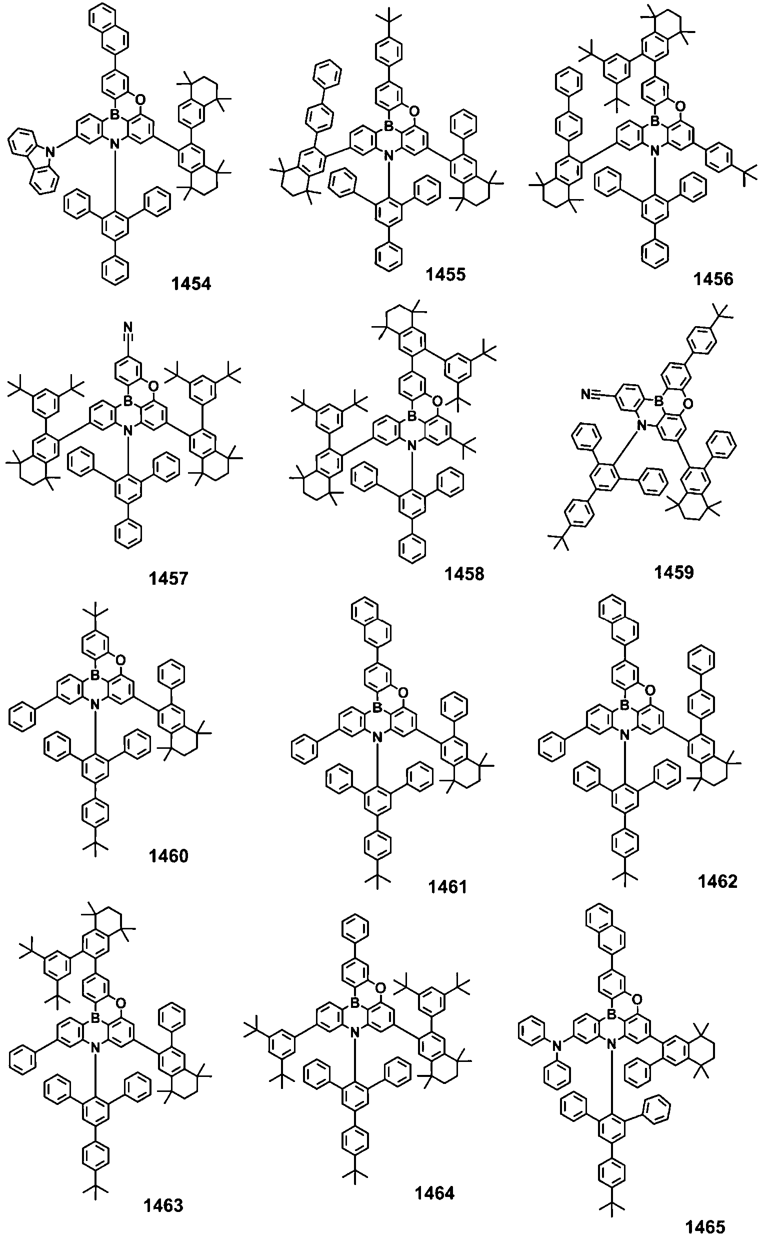

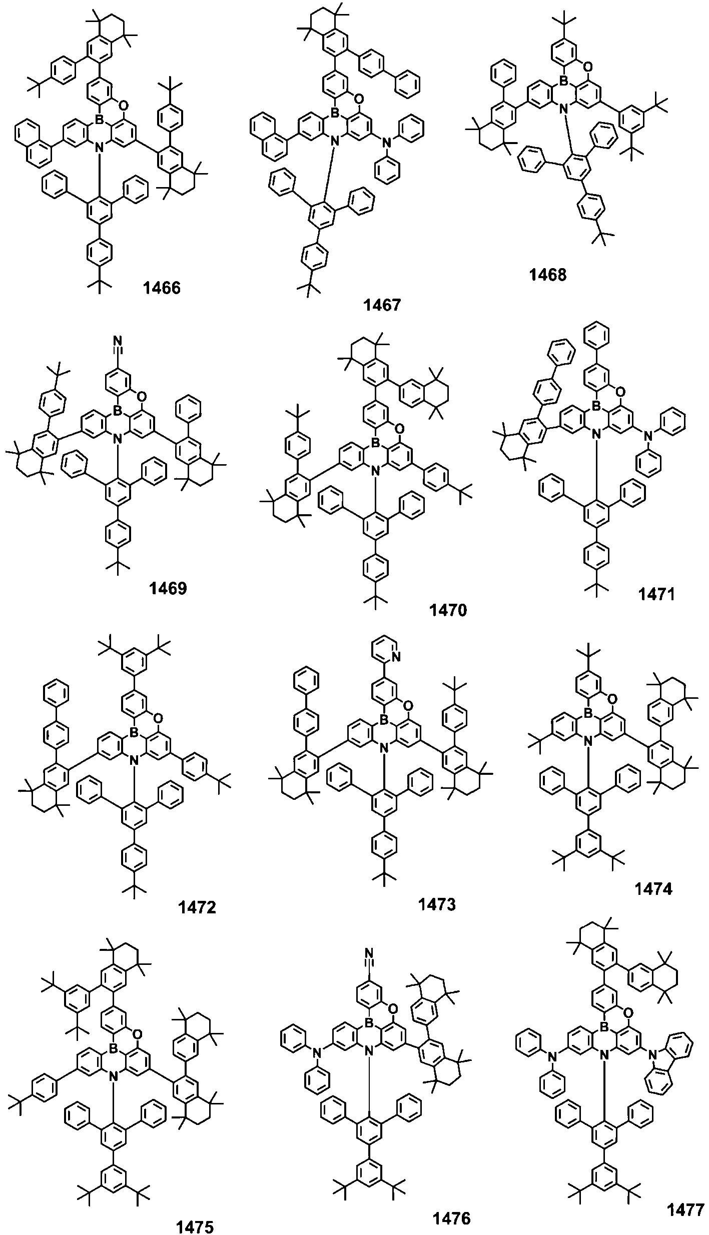

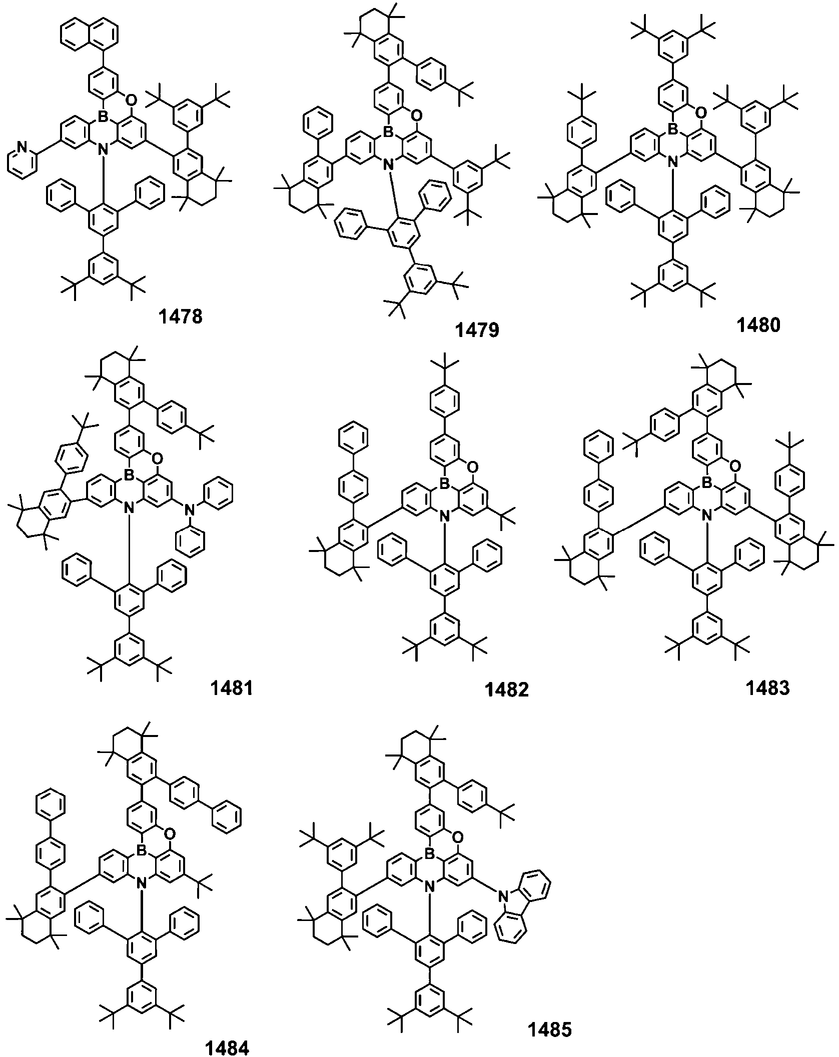

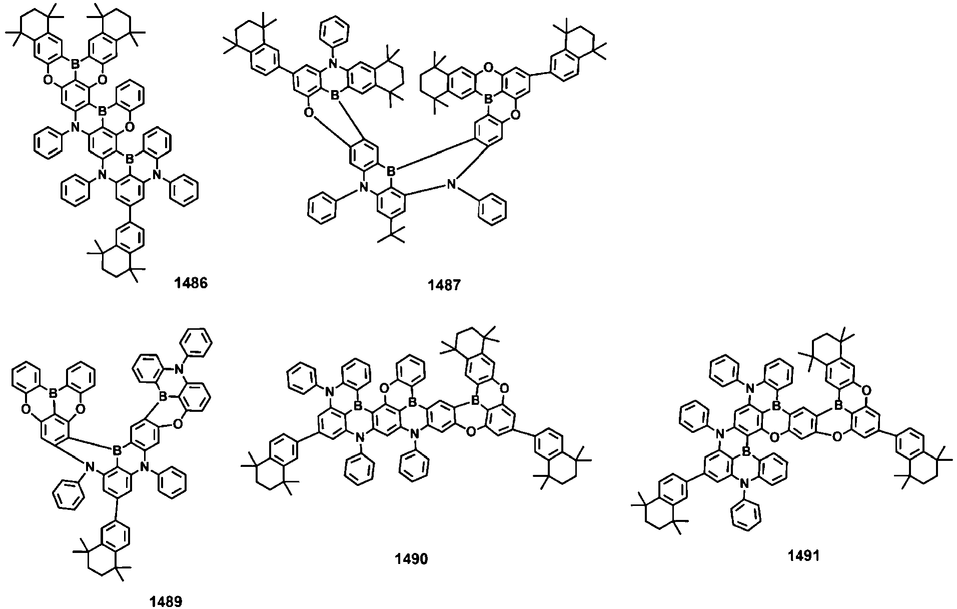

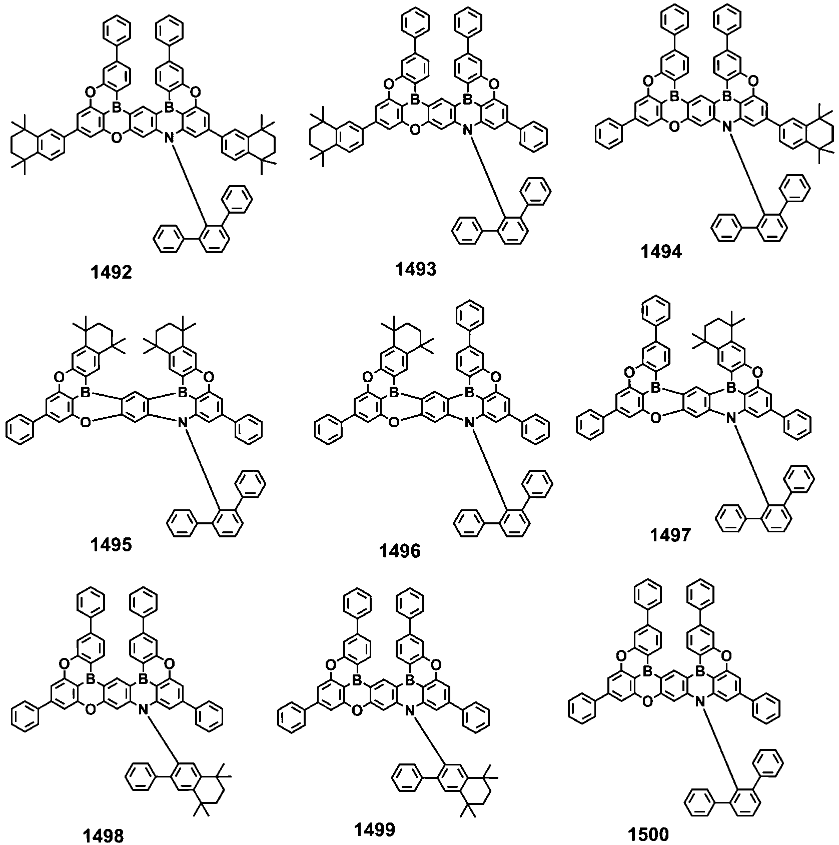

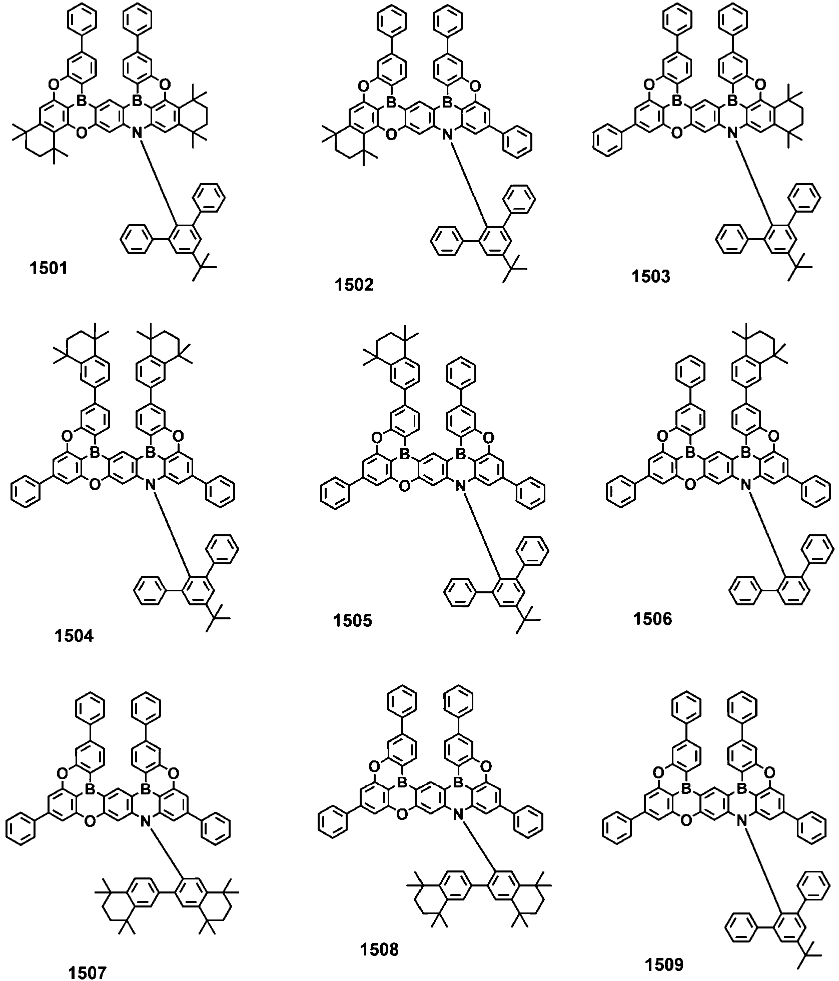

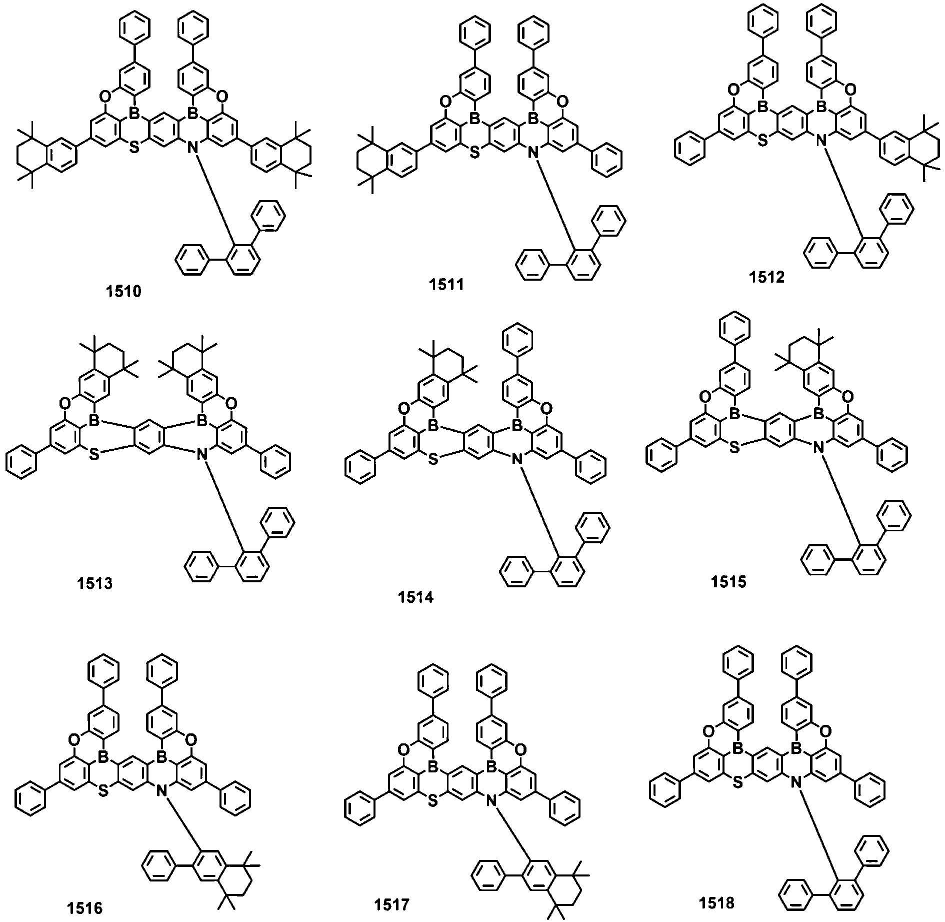

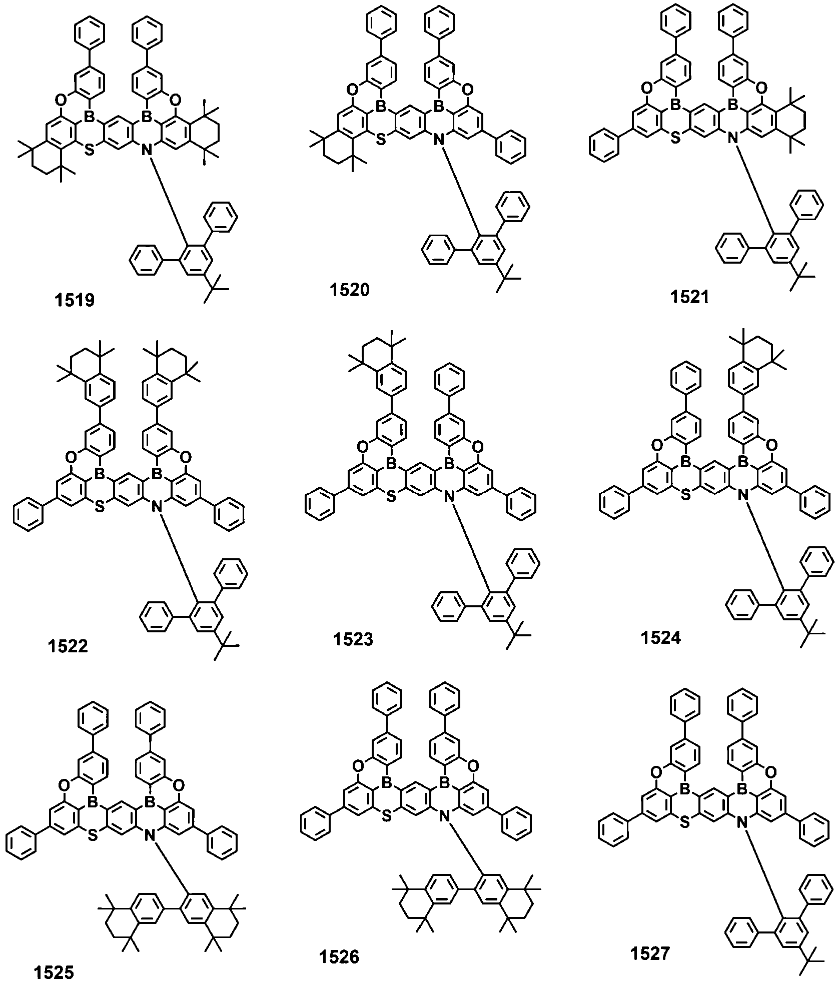

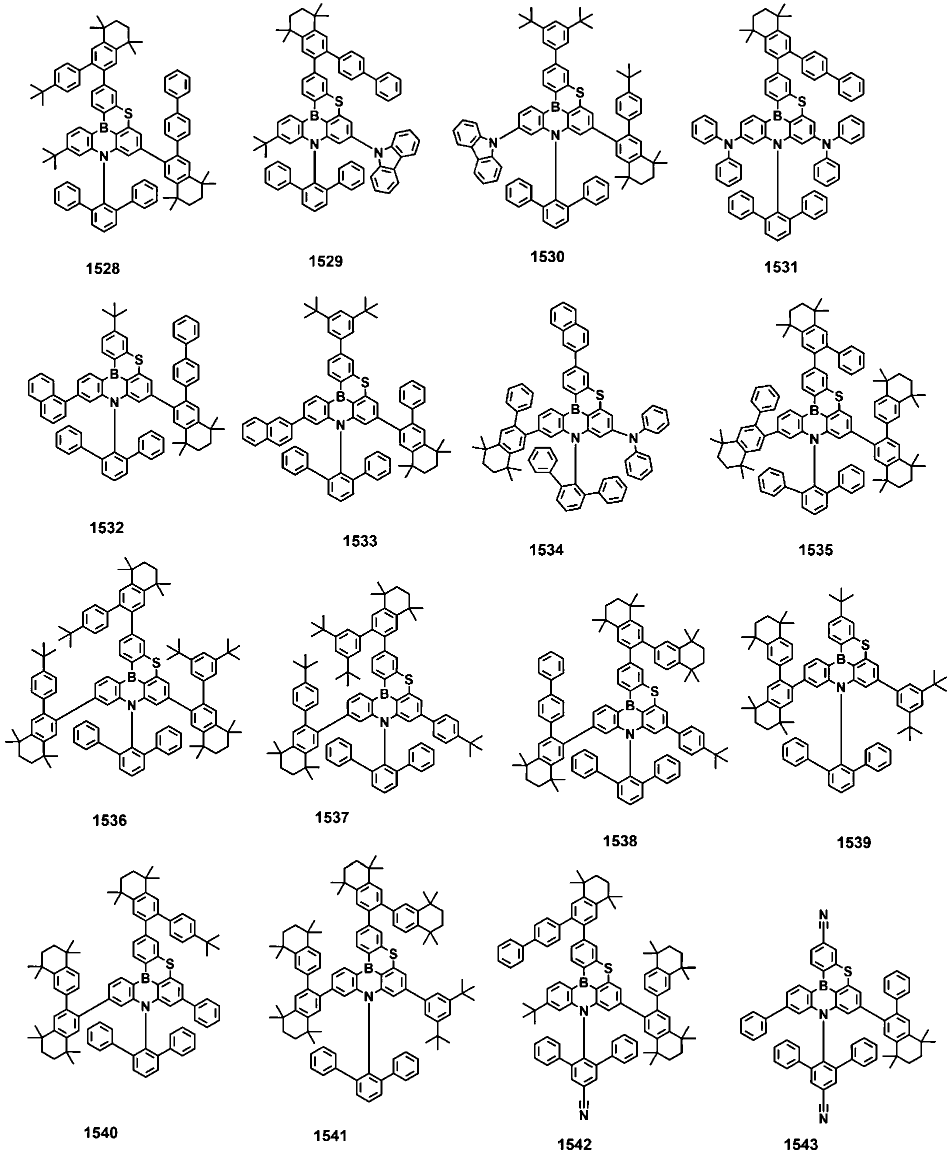

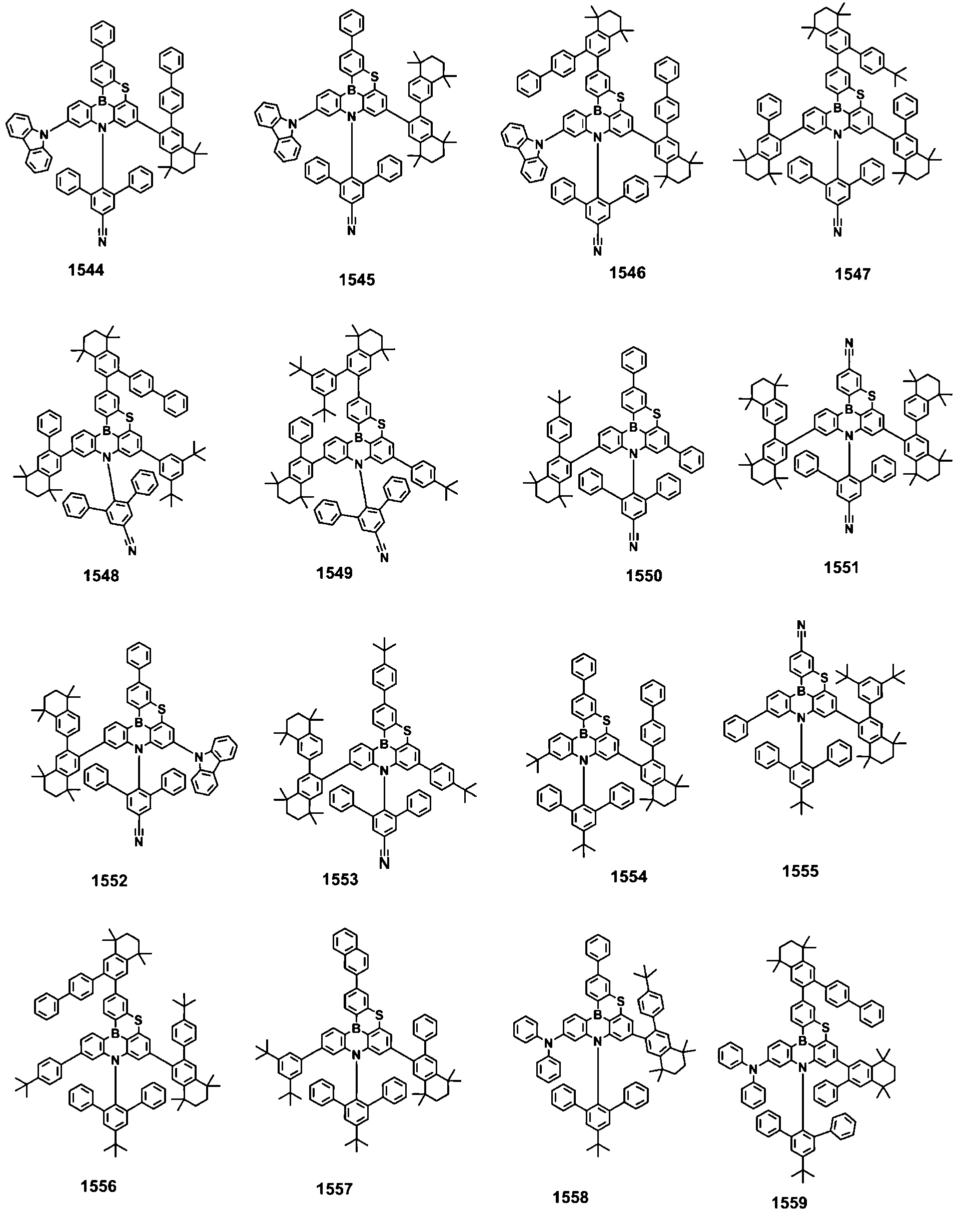

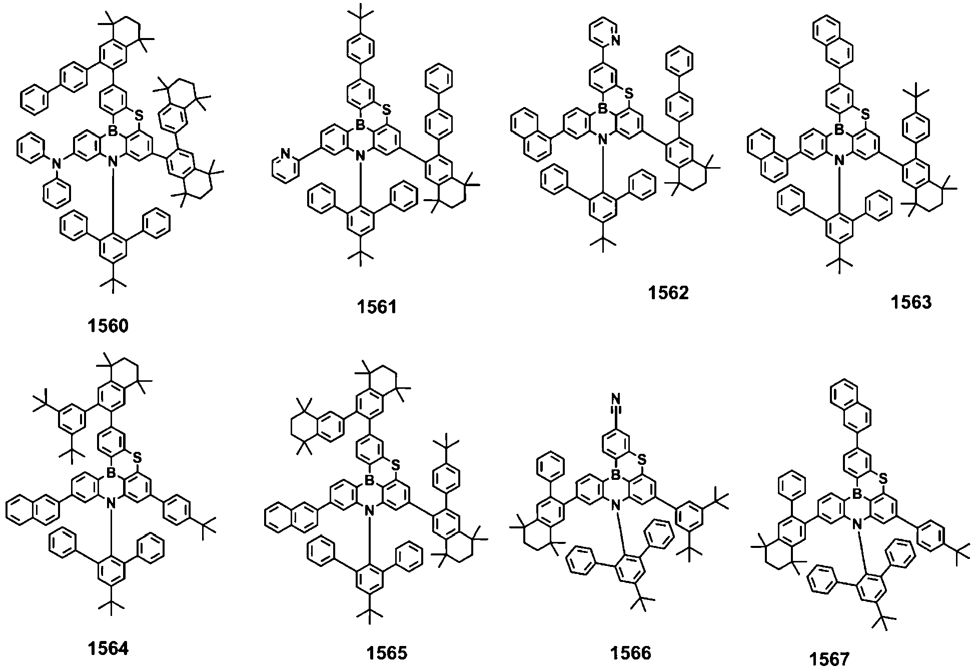

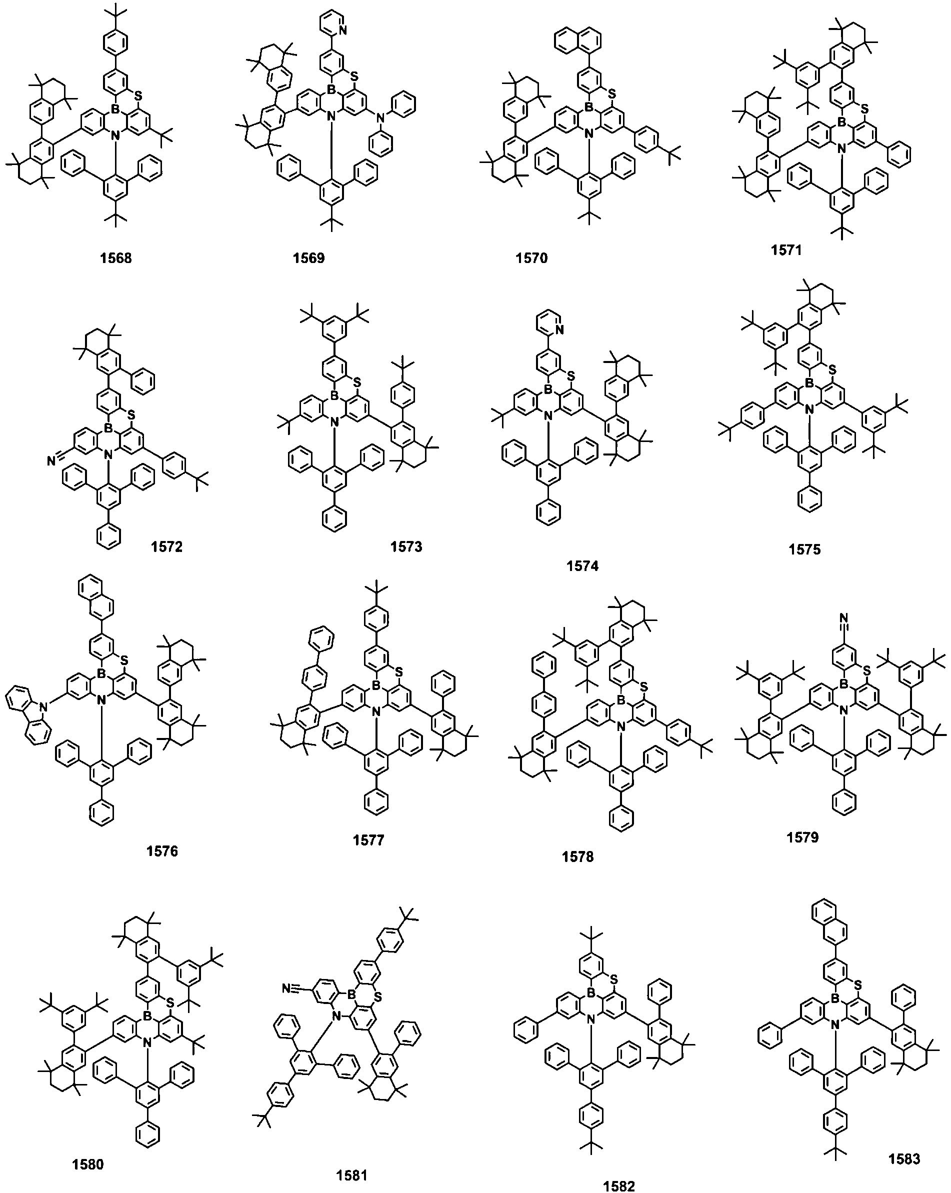

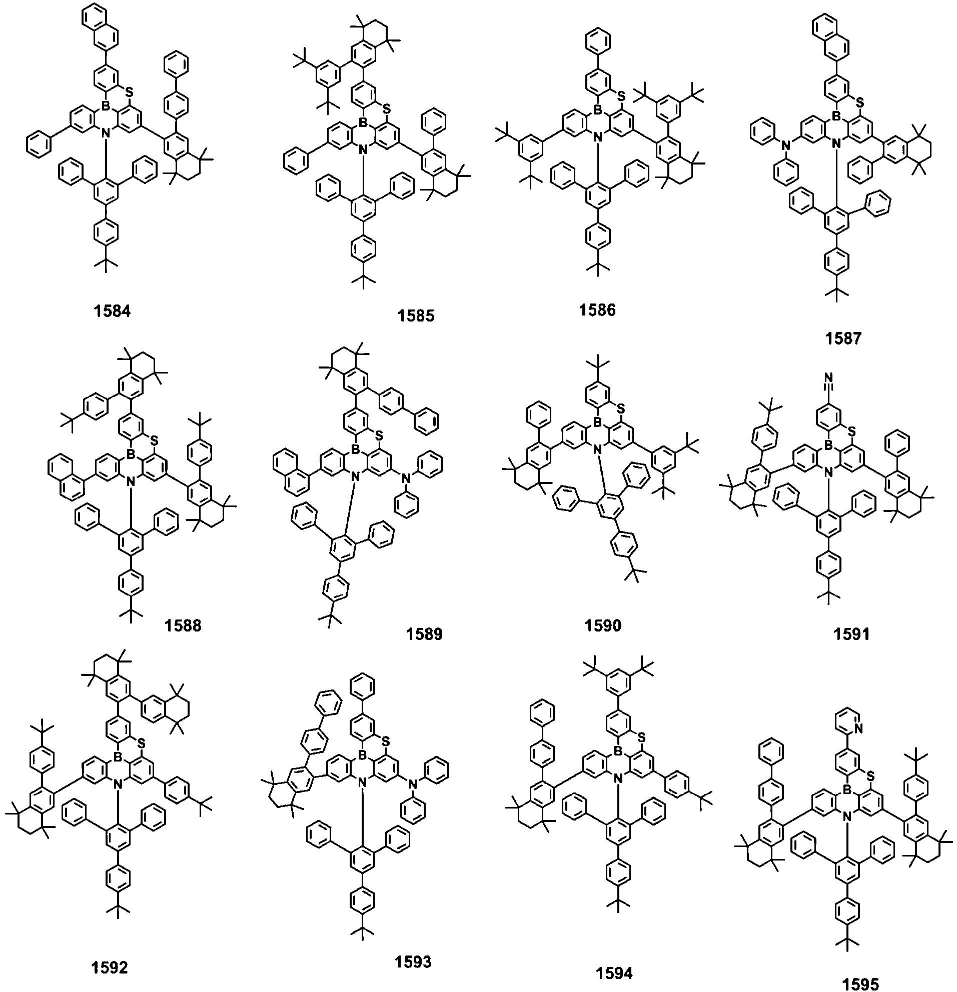

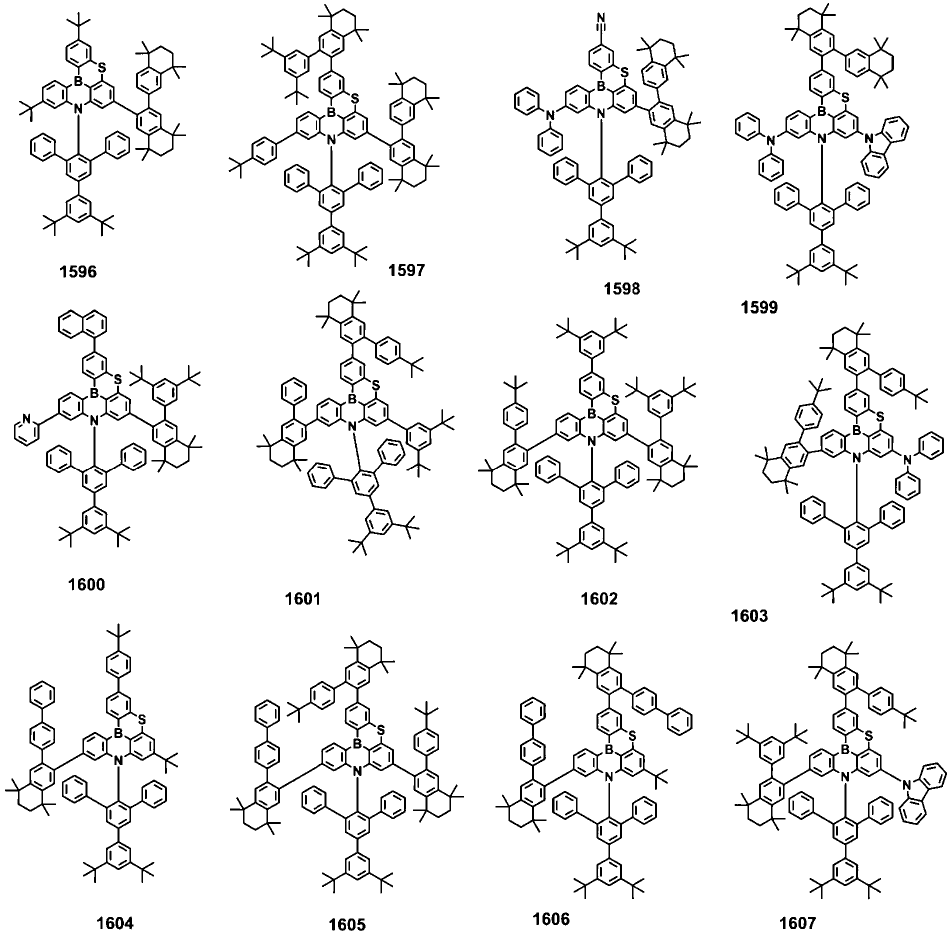

The polycyclic compound according to one or more embodiments may include a boron atom-containing fused ring core which includes a boron atom as a ring-forming atom and may include, as a substituent, an aryl group or an alkyl-substituted cycloalkane ring bonded to N in an amine group involved in ring formation of the core, and may further include an alkyl-substituted cycloalkane ring fused to a benzene ring of the core.

The polycyclic compound according to one or more embodiments may be used as a delayed fluorescent material. For example, the polycyclic compound according to one or more embodiments may be used as a thermally activated delayed fluorescent (TADF) material. The polycyclic compound according to one or more embodiments may be to emit light with a maximum peak wavelength of about 470 nm or less in a wavelength region of blue light.

The polycyclic compound according to one or more embodiments may include a core structure of a boron atom-containing fused ring, and, as a substituent, an aryl group substituted to N in an amine group included in the core structure, or a fused ring in which a benzene ring and an alkyl-substituted cycloalkane ring are fused. In one or more embodiments, the polycyclic compound according to one or more embodiments may include a core structure of a boron atom-containing fused ring, and a fused ring which is fused to the core structure and includes a fused ring in which a benzene ring and an alkyl-substituted cycloalkane ring are fused. Therefore, the polycyclic compound according to one or more embodiments may exhibit excellent or suitable material stability. In one or more embodiments, the polycyclic compound according to one or more embodiments may exhibit excellent or suitable lifespan characteristics in a wavelength region of blue light.

The light-emitting element according to one or more embodiments including the polycyclic compound according to one or more embodiments may exhibit long lifespan characteristics. The light-emitting element according to one or more embodiments including the polycyclic compound according to one or more embodiments having improved or enhanced material stability in the light emitting layer may be to emit blue light and may exhibit excellent or suitable lifespan characteristics.

In the light-emitting element ED according to one or more embodiments, the light emitting layer EML may be a delayed fluorescent light emitting layer including a host and a dopant. For example, the light emitting layer EML may be to emit (e.g., configured to emit) thermally activated delayed fluorescence. The polycyclic compound according to one or more embodiments may be a thermally activated delayed fluorescent dopant.

The light emitting layer EML may include a polycyclic compound according to one or more embodiments as a dopant. The polycyclic compound according to one or more embodiments may be to emit (e.g., configured to emit) blue light. For example, the polycyclic compound according to one or more embodiments may be an emission material having a peak emission wavelength in a wavelength region of about 430 nm to about 490 nm. For example, the polycyclic compound according to one or more embodiments may be an emission material having a peak emission wavelength in a wavelength region of about 440 nm to about 470 nm.

In one or more embodiments, the light emitting layer EML may include the polycyclic compound according to one or more embodiments and may further include at least one selected from among second to fourth compounds. In one or more embodiments, the light emitting layer EML may include a second compound represented by Formula HT-1. For example, the second compound may be used as a hole transporting host material in the light emitting layer EML.

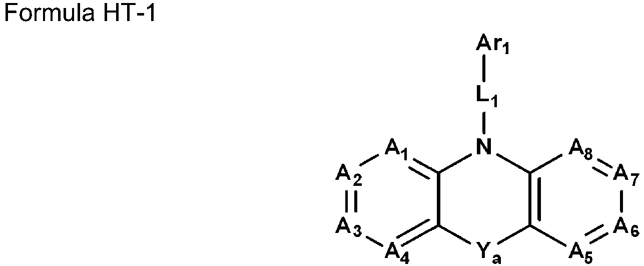

In Formula HT-1, A₁ to A₈ may each independently be N or CR₅₁. For example, all A₁ to A₈ may each independently be CR₅₁. In one or more embodiments, any one selected from among A₁ to A₈ may be N, and the others may be CR₅₁.

In Formula HT-1, L₁ may be a direct linkage (e.g., a single covalent bond), a substituted or unsubstituted arylene group having 6 to 30 ring-forming carbon atoms or a substituted or unsubstituted heteroarylene group having 2 to 30 ring-forming carbon atoms. For example, L₁ may be a direct linkage (e.g., a single covalent bond), a substituted or unsubstituted phenylene group, a substituted or unsubstituted divalent biphenyl group, a substituted or unsubstituted divalent carbazole group, and/or the like, but embodiments of the present disclosure are not limited thereto.

In Formula HT-1, Yₐ may be a direct linkage (e.g., a single covalent bond), CR₅₂R₅₃, or SiR₅₄R₅₅. For example, two benzene rings connected to a nitrogen atom in Formula HT-1 may indicate a direct linkage (e.g., a single covalent bond), 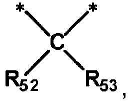 or being bonded via 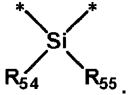 In Formula HT-1, if (e.g., when) Yₐ is a direct linkage (e.g., a single covalent bond), the second compound represented by Formula HT-1 may include a carbazole moiety.

In Formula HT-1, Ar₁ may be a substituted or unsubstituted aryl group having 6 to 30 ring-forming carbon atoms or a substituted or unsubstituted heteroaryl group having 2 to 30 ring-forming carbon atoms. For example, Ar₁ may be a substituted or unsubstituted carbazole group, a substituted or unsubstituted dibenzofuran group, a substituted or unsubstituted dibenzothiophene group, a substituted or unsubstituted biphenyl group, and/or the like, but embodiments of the present disclosure are not limited thereto.

In Formula HT-1, R₅₁ to R₅₅ may each independently be a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 ring-forming carbon atoms, a substituted or unsubstituted aryl group having 6 to 60 ring-forming carbon atoms, or a substituted or unsubstituted heteroaryl group having 2 to 60 ring-forming carbon atoms. In one or more embodiments, R₅₁ to R₅₅ may each independently be bonded to an adjacent group to form a ring. For example, R₅₁ to R₅₅ may each independently be a hydrogen atom or a deuterium atom. R₅₁ to R₅₅ may each independently be an unsubstituted methyl group or an unsubstituted phenyl group.

In one or more embodiments, the second compound represented by Formula HT-1 may be represented by any one selected from among the compounds present in Compound Group 2. The light emitting layer EML may include at least one selected from among the compounds present in Compound Group 2 as a hole transporting host material.

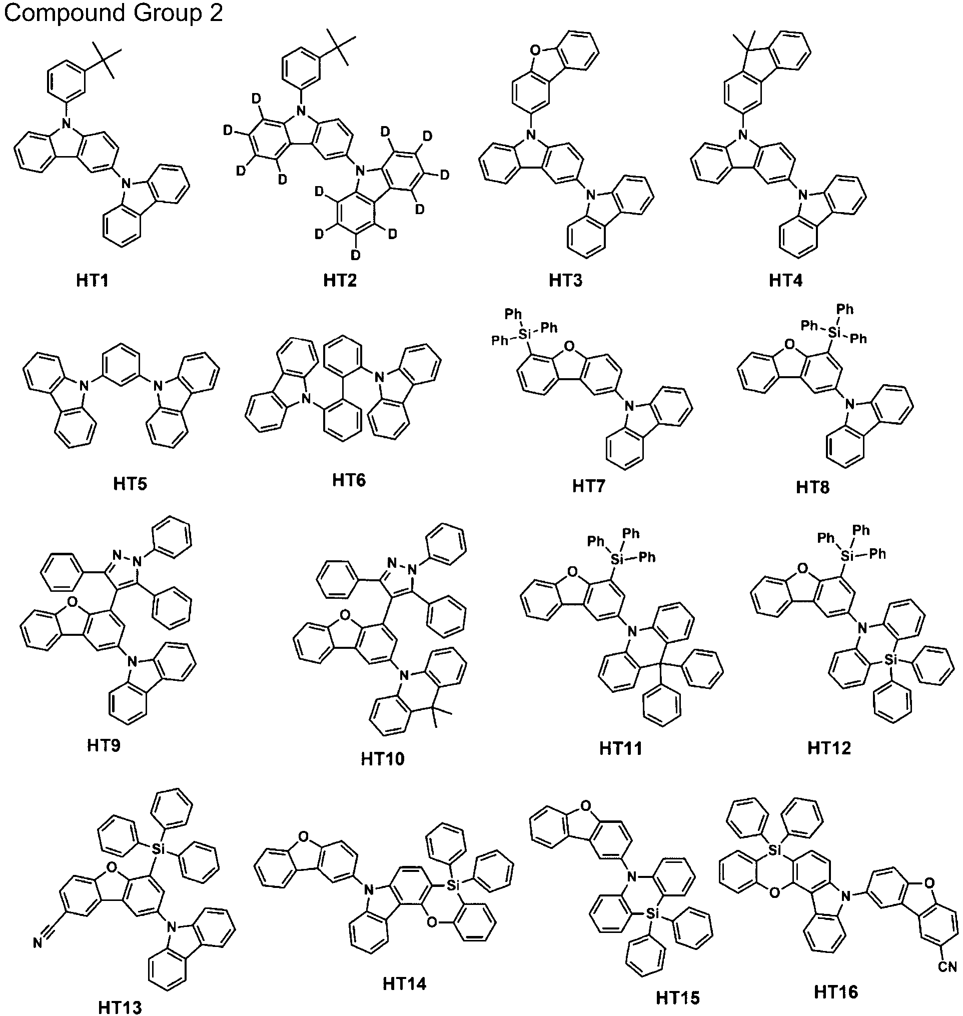

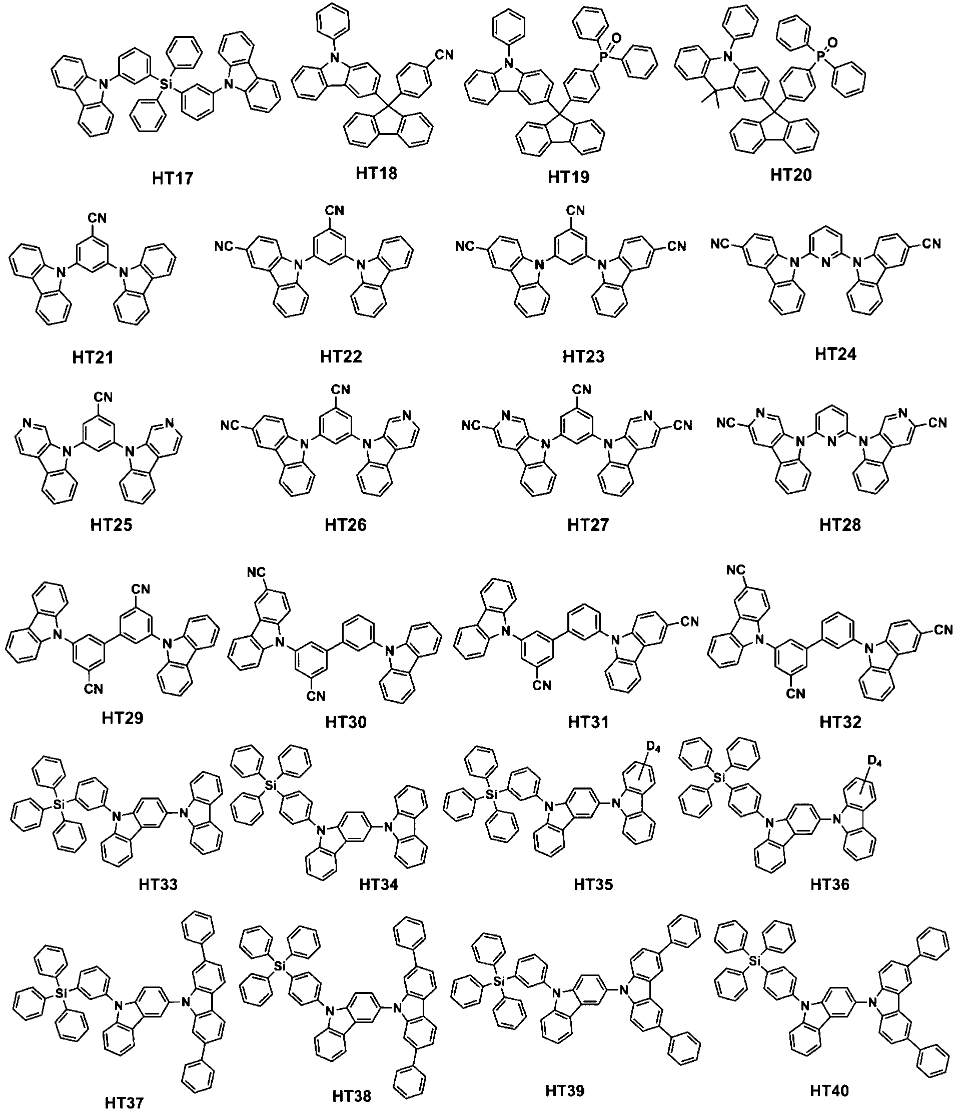

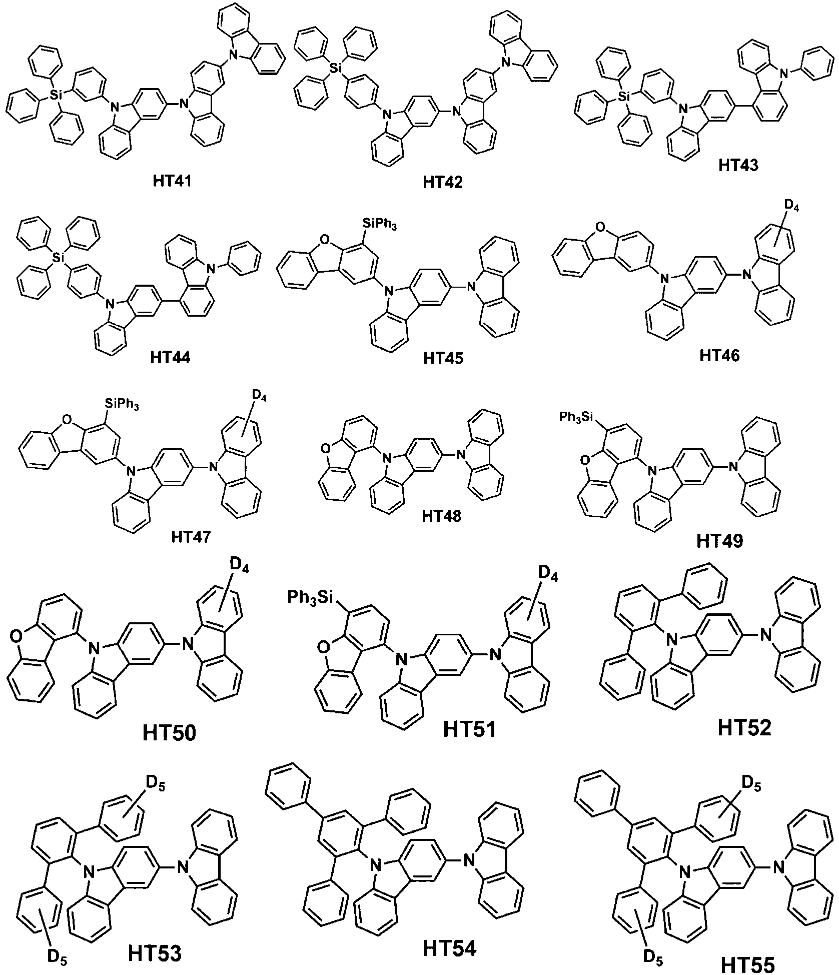

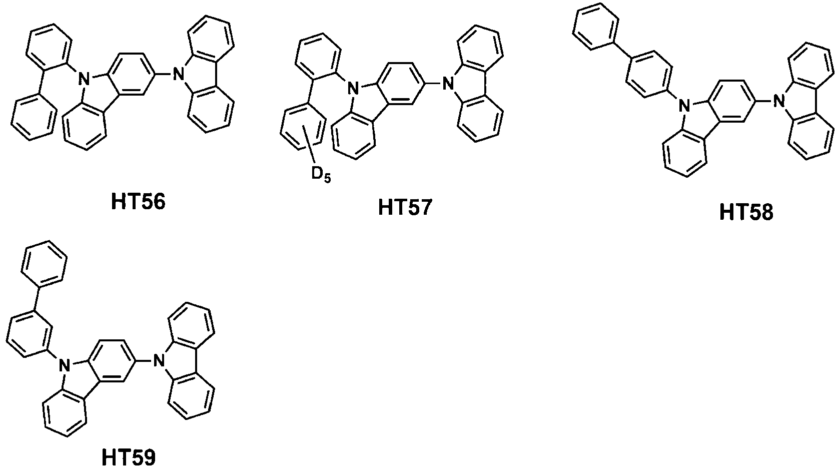

In the example compounds provided in Compound Group 2, "D" refers to a deuterium atom, and "Ph" refers to a substituted or unsubstituted phenyl group. For example, in the example compounds provided in Compound Group 2, "Ph" may be an unsubstituted phenyl group.

In one or more embodiments, the light emitting layer EML may include a third compound represented by Formula ET-1. For example, the third compound may be used as an electron transporting host material in the light emitting layer EML.

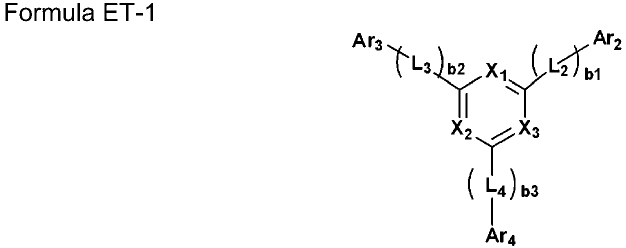

In Formula ET-1, at least one selected from among X₁ to X₃ may be N, and the others may be CR₅₆. For example, any one selected from among X₁ to X₃ may be N, and the remaining two may each independently be CR₅₆. In this case, the third compound represented by Formula ET-1 may include a pyridine moiety. In one or more embodiments, two selected from among A₁ to A₃ may be N, and the remaining one may be CR₅₆. In this case, the third compound represented by Formula ET-1 may include a pyrimidine moiety. In one or more embodiments, all X₁ to X₃ may be N. In this case, the third compound represented by Formula ET-1 may include a triazine moiety.

In Formula ET-1, R₅₆ may be a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms.

In Formula ET-1, b1 to b3 may each independently be an integer of 0 to 10.

In Formula ET-1, Ar₂ to Ar₄ may each independently be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, Ar₂ to Ar₄ may each independently be a substituted or unsubstituted phenyl group or a substituted or unsubstituted carbazole group.

In Formula ET-1, L₂ to L₄ may each independently be a direct linkage (e.g., a single covalent bond), a substituted or unsubstituted arylene group having 6 to 30 ring-forming carbon atoms, or a substituted or unsubstituted heteroarylene group having 2 to 30 ring-forming carbon atoms. If (e.g., when) b1 to b3 are each independently an integer of 2 or greater, L₂ to L₄ may each independently be a substituted or unsubstituted arylene group having 6 to 30 ring-forming carbon atoms or a substituted or unsubstituted heteroarylene group having 2 to 30 ring-forming carbon atoms.

In one or more embodiments, the third compound may be represented by any one selected from among the compounds in Compound Group 3. The light-emitting element ED according to one or more embodiments may include any one selected from among the compounds in Compound Group 3.

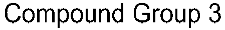

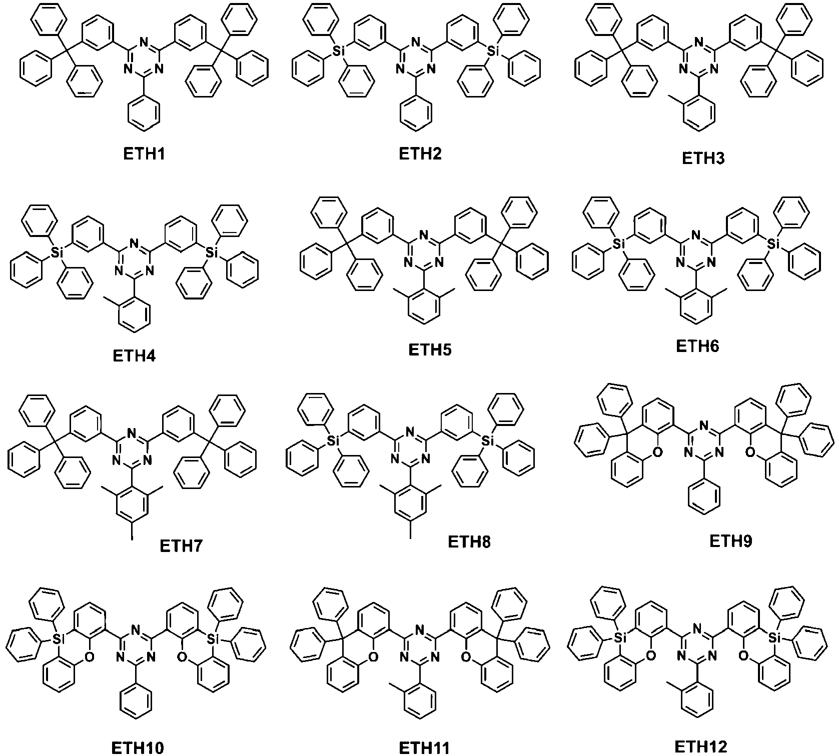

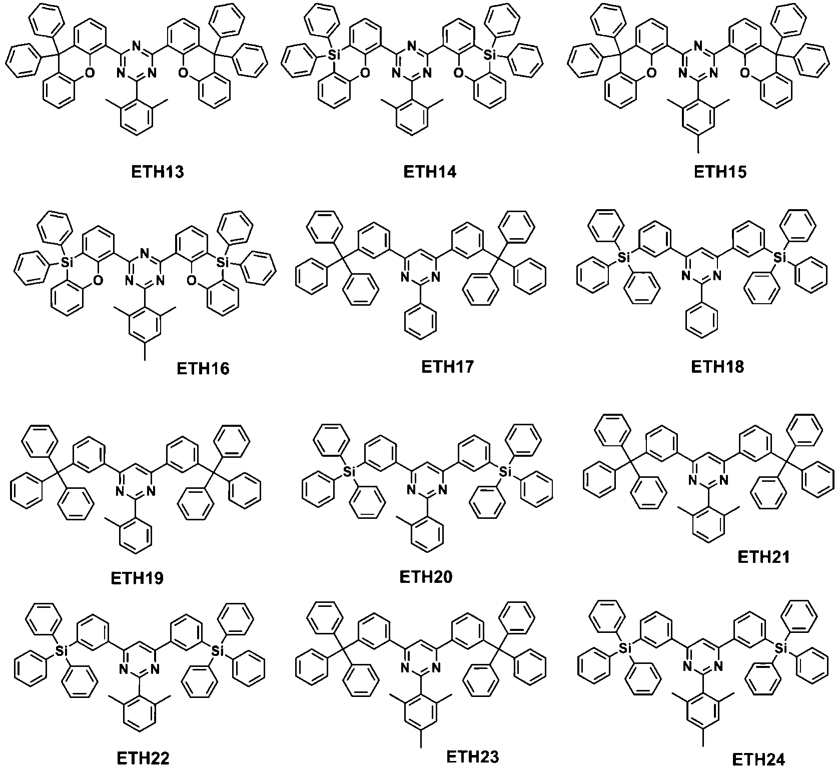

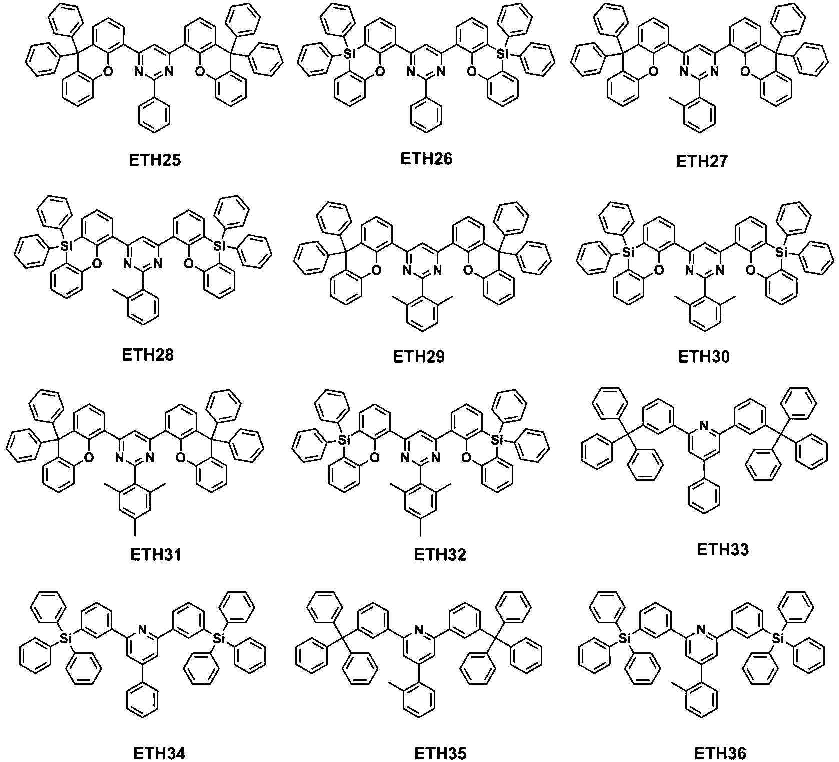

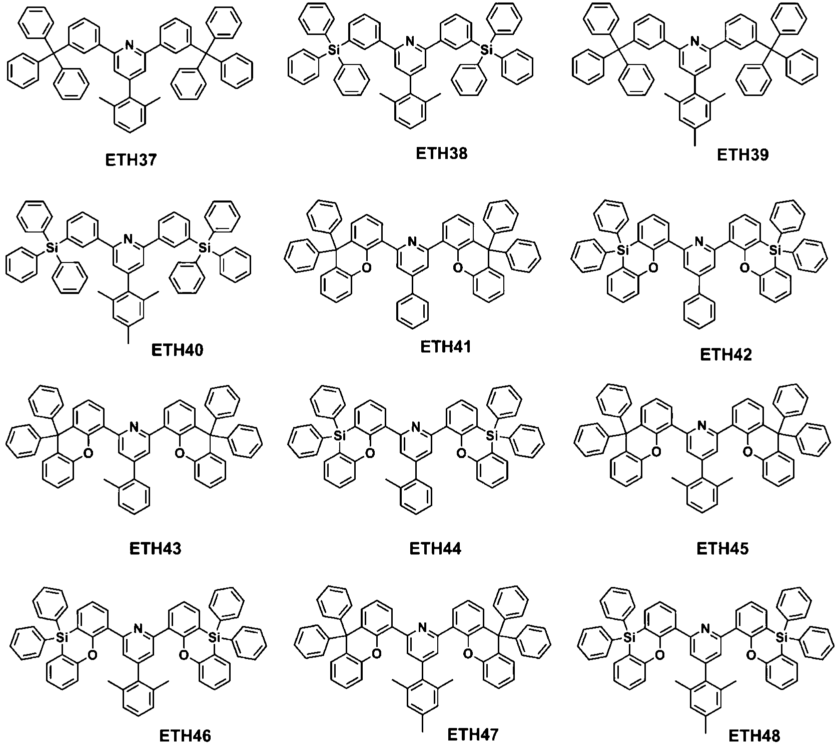

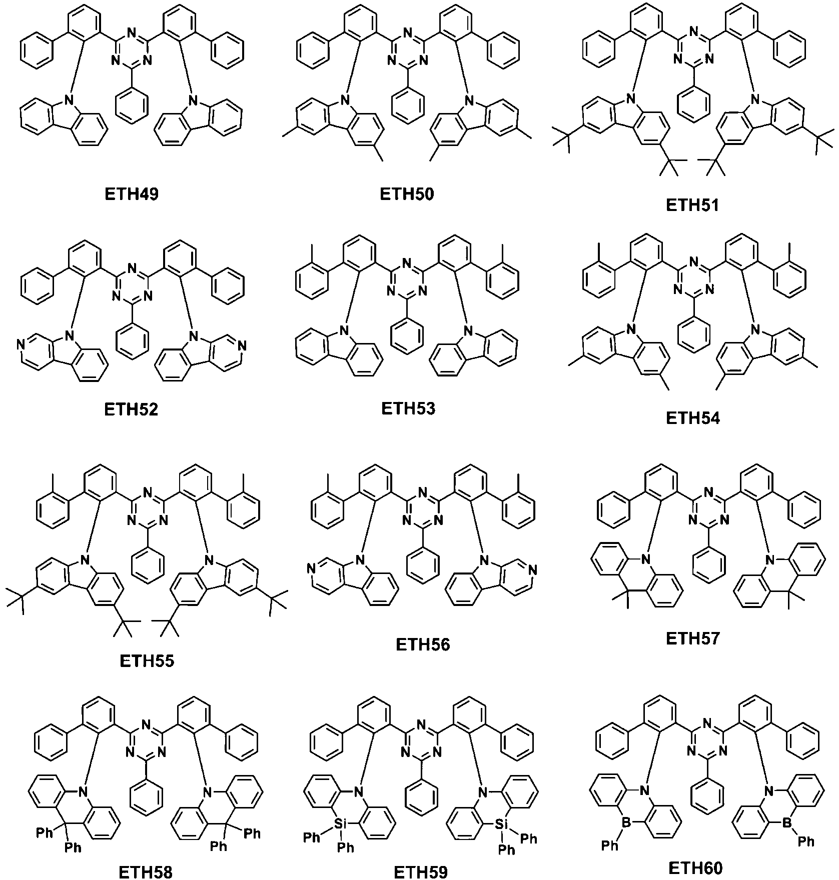

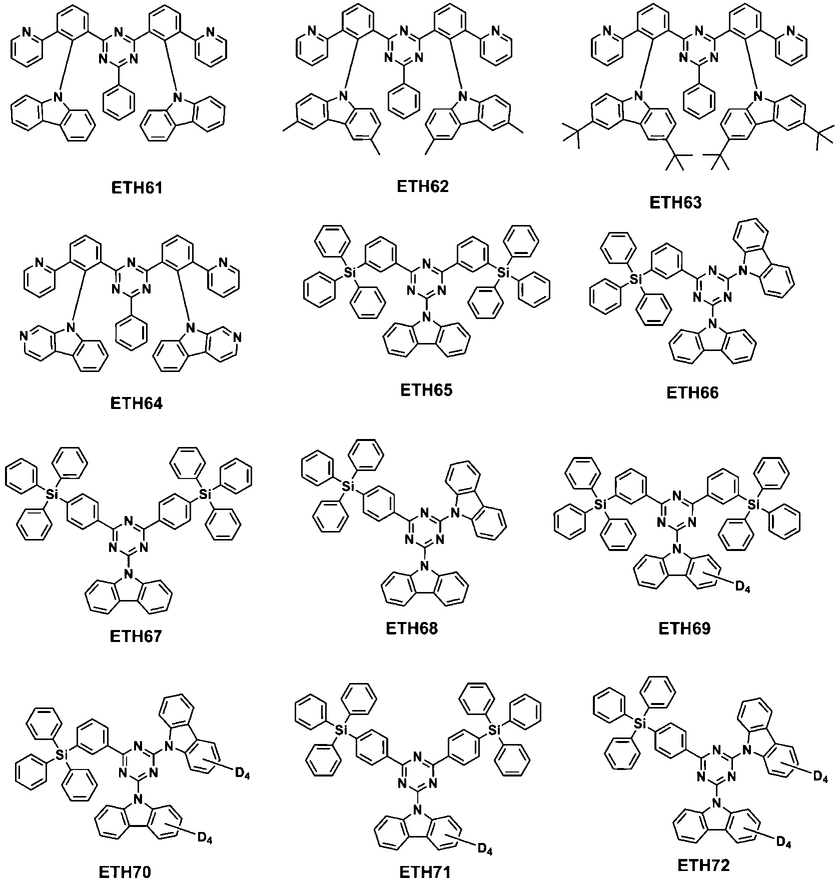

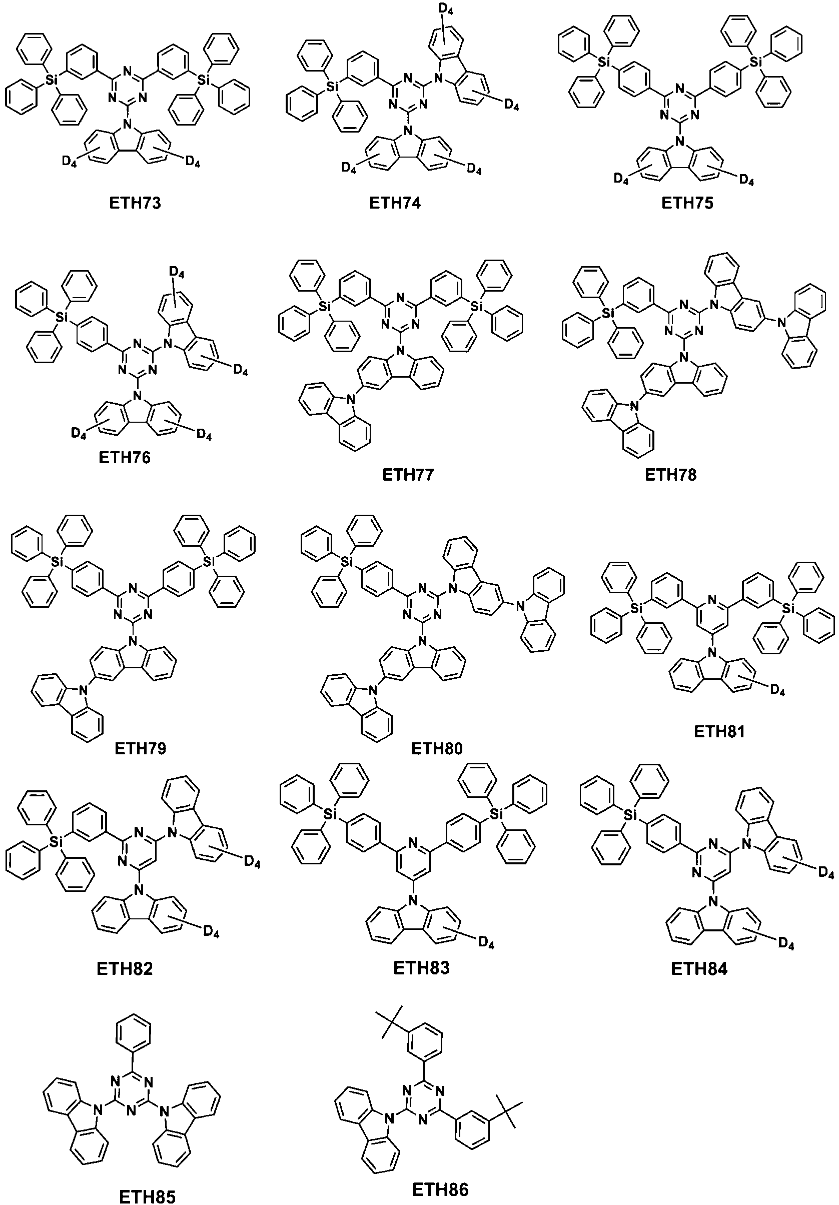

In the example compounds provided in Compound Group 3, "D" refers to a deuterium atom, and "Ph" refers to an unsubstituted phenyl group.

The light emitting layer EML may include the second compound and the third compound, and the second compound and the third compound may form an exciplex. In the light emitting layer EML, the exciplex may be formed by the hole transporting host and the electron transporting host. In this case, a triplet energy of the exciplex formed by the hole-transporting host and the electron-transporting host may correspond to an energy offset between a lowest unoccupied molecular orbital (LUMO) of the electron-transporting host and a highest occupied molecular orbital (HOMO) of the hole-transporting host.

For example, the exciplex formed by the hole transporting host and the electron-transporting host may have an absolute value of the triplet (T1) energy level of about 2.4 eV to about 3.0 eV. In one or more embodiments, the triplet energy of exciplex may be lower than an energy band gap of each host material. The exciplex may have triplet energy of about 3.0 eV or less which is the energy gap between the hole transporting host and the electron transporting host.

In one or more embodiments, the light emitting layer EML may further include a fourth compound in addition to the first compound to third compound, described herein. The fourth compound may be used as a phosphorescent sensitizer of the light emitting layer EML. Energy may be transferred from the fourth compound to the first compound, thereby causing emission.

For example, the light emitting layer EML may include platinum (Pt) as a central metal atom and may include, as the fourth compound, an organometallic complex including ligands bonded to the central metal atom. In the light-emitting element ED according to one or more embodiments, the light emitting layer EML may include a compound represented by Formula D-1 as the fourth compound.

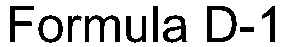

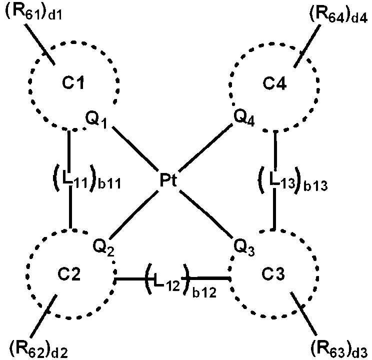

In Formula D-1, Q₁ to Q₄ may each independently be C or N. C1 and C4 may each independently be a substituted or unsubstituted hydrocarbon ring having 5 to 30 ring-forming carbon atoms or a substituted or unsubstituted heterocycle having 2 to 30 ring-forming carbon atoms.

In Formula D-1, L₁₁ to L₁₃ may each independently be a direct linkage (e.g., a single covalent bond), *-O-*, *-S-*, 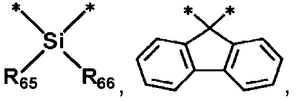 a substituted or unsubstituted alkylene group having 1 to 20 carbon atoms, a substituted or unsubstituted arylene group having 6 to 30 ring-forming carbon atoms, or a substituted or unsubstituted heteroarylene group having 2 to 30 ring-forming carbon atoms. In L₁₁ to L₁₃, "-*" indicates a portion to connected to C1 to C4.

In Formula D-1, b11 to b13 may each independently be 0 to 1. If (e.g., when) b11 is 0, C1 and C2 may not be connected to each other. If (e.g., when) b12 is 0, C2 and C3 may not be connected to each other. If (e.g., when) b13 is 0, C3 and C4 may not be connected to each other.

In Formula D-1, R₆₁ to R₆₆ may each independently be a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 ring-forming carbon atoms, a substituted or unsubstituted aryl group having 6 to 60 ring-forming carbon atoms, or a substituted or unsubstituted heteroaryl group having 2 to 60 ring-forming carbon atoms. In one or more embodiments, R₆₁ to R₆₆ may each independently be bonded to an adjacent group to form a ring. R₆₁ to R₆₆ may each independently be an unsubstituted methyl group or an unsubstituted t-butyl group.

In Formula D-1, d1 to d4 may each independently be an integer of 0 to 4. In Formula D-1, if (e.g., when) d1 to d4 are each 0, the fourth compound may not be substituted with R₆₁ to R₆₄. A case where d1 to d4 are each 4 and R₆₁ to R₆₄ are each a hydrogen atom may be the same as the case where d1 to d4 are each 0. If (e.g., when) d1 to d4 are each independently an integer of 2 or greater, R₆₁ to R₆₄ provided in plurality may be the same or at least one selected from among a plurality of R₆₁ to R₆₄ may be different.

In Formula D-1, C1 to C4 may each independently be a substituted or unsubstituted hydrocarbon ring or a substituted or unsubstituted heterocycle, which is represented by any one selected from among C-1 to C-4.

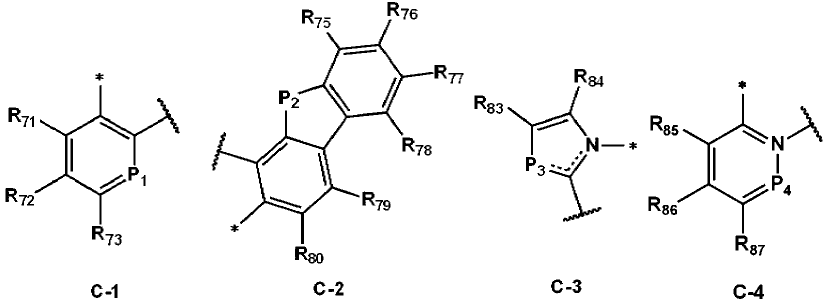

In C-1 to C-4, P₁ may be C-* or CR₇₄, P₂ may be N-* or NR₃₁, P₃ may be N-* or NR₈₂, and P₄ may be C-* or CR₈₈. R₇₁ to R₈₈ may each independently be a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring.

In one or more embodiments, in C-1 to C-4, " 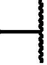 " is a portion bonded to Pt, which is a central metal atom, and "-*" corresponds to a portion connected to an adjacent cyclic group (C1 to C4) or linker (L₁₁ to L₁₃).

The light emitting layer EML according to one or more embodiments may include the first compound, which is the polycyclic compound, and at least one selected from among the second to fourth compounds. For example, the light emitting layer EML may include the first compound, the second compound, and the third compound. In the light emitting layer EML, the second compound and the third compound may form an exciplex, and energy may be transferred from the exciplex to the first compound, thereby causing emission.

In one or more embodiments, the light emitting layer EML may include the first compound, the second compound, the third compound, and the fourth compound. In the light emitting layer EML, the second compound and the third compound may form an exciplex, and energy may be transferred from the exciplex to the first compound, thereby causing emission. In one or more embodiments, the fourth compound may be a sensitizer. In the light-emitting element ED according to one or more embodiments, the fourth compound included in the light emitting layer EML may serve as a sensitizer and thus may serve to transfer energy from the host to the first compound, which is an emission dopant. For example, the fourth compound acting as an assistant dopant may be to accelerate energy transfer from the host to the first compound, which is an emission dopant, thereby increasing an emission rate of the first compound. Therefore, the light emitting layer EML according to one or more embodiments may have improved or enhanced emission efficiency. In one or more embodiments, if (e.g., when) energy transfer to the first compound is increased, excitons formed in the light emitting layer EML may not accumulate inside the light emitting layer EML but may emit light rapidly, thereby reducing deterioration of the light-emitting element. Therefore, the light-emitting element ED may have an improved or enhanced lifespan.

The light-emitting element ED according to one or more embodiments may include all the first compound, the second compound, the third compound, and the fourth compound, and thus the light emitting layer EML may include combinations of two host materials and two dopant materials. In the light-emitting element ED according to one or more embodiments, the light emitting layer EML may include the second compound and the third compound, which are two hosts different from each other, the first compound emitting delayed fluorescent, and the fourth compound including an organometallic complex at the same time and thus may exhibit characteristics of excellent or suitable emission efficiency.

In one or more embodiments, the fourth compound represented by Formula D-1 may be represented by any one selected from among the compounds present in Compound Group 4. The light emitting layer EML may include at least one selected from among the compounds present in Compound Group 4 as a sensitizer material.

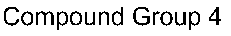

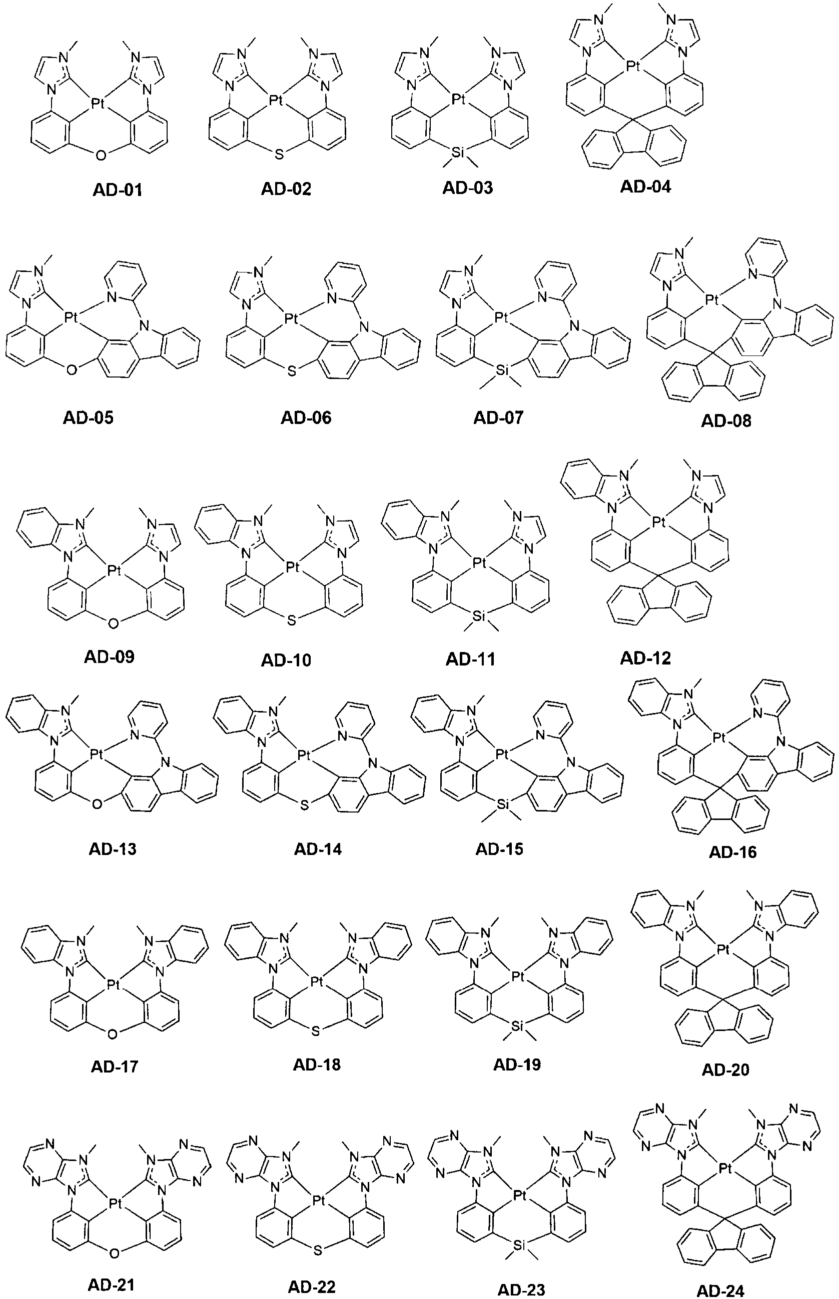

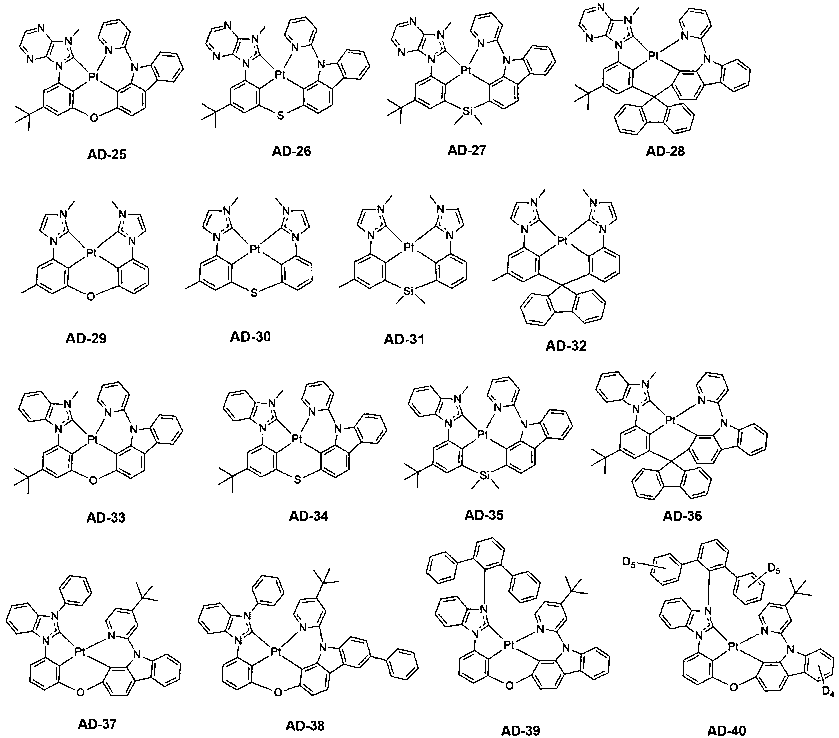

In the example compounds provided in Compound Group 4, "D" refers to a deuterium atom.

In the light-emitting element ED according to one or more embodiments, if (e.g., when) the light emitting layer EML includes all of the first compound, the second compound, and the third compound, described herein, the first compound may be included in an amount of about 0.1 wt% to about 5 wt% on a basis of the total weight (e.g., based on a total of 100 wt%) of the first compound, the second compound, and the third compound. However, embodiments of the present disclosure are not limited thereto. If (e.g., when) a content (e.g., amount) of the first compound falls within the foregoing ratio, energy transfer from the second compound and the third compound to the first compound may increase, and thus emission efficiency and element lifespan may be improved or enhanced.

In the light emitting layer EML, a content (e.g., amount) of the second compound and the third compound may be a remaining weight excluding the weight of the first compound described herein. For example, in the light emitting layer EML, the content (e.g., amount) of the second compound and the third compound may be about 95 wt% to about 99.9 wt% on the basis of the total weight (e.g., based on a total of 100 wt%) of the first compound, the second compound, and the third compound.

A weight ratio of the second compound to the third compound may be in the range of about 3:7 to about 7:3 on a basis of the total weight (e.g., based on a total of 100 wt%) of the second compound and the third compound.

If (e.g., when) the content (e.g., amount) of the second compound and the second compound falls within the foregoing ratio, charge balance characteristics in the light emitting layer EML may be improved or enhanced, and thus emission efficiency and an element lifespan may increase. If (e.g., when) the content (e.g., amount) of the second compound and the third compound is out of the foregoing ratio range, the charge balance in the light emitting layer EML is broken, and thus emission efficiency may be reduced, and the element may easily deteriorate.

If (e.g., when) the light emitting layer EML includes the fourth compound, the fourth compound in the light emitting layer EML may be included in an amount of about 10 wt% to about 30 wt% on a basis of the total weight (e.g., based on a total of 100 wt%) of the first compound, the second compound, the third compound, and the fourth compound. However, embodiments of the present disclosure are not limited thereto. If (e.g., when) a content (e.g., amount) of the fourth compound falls within the content (e.g., amount) described herein, energy transfer from the host to the first compound which is an emission dopant increases, and thus emission efficiency may be improved or enhanced. Therefore, the light emitting layer EML may have an improved or enhanced emission efficiency. If (e.g., when) the content (e.g., amount) of the first compound, the second compound, the third compound, and the fourth compound included in the light emitting layer EML falls within the content (e.g., amount) ratio described herein, excellent or suitable emission efficiency and long lifespan may be achieved.

The light emitting layer EML may have a thickness of, for example, about 100 Å to about 1000 Å or about 100 Å to about 300 Å. The light emitting layer EML may have a single layer formed or composed of a single material, a single layer formed or composed of a plurality of different materials, or a multi-layered structure having a plurality of layers formed or composed of a plurality of materials different from each other.

In the light-emitting element ED according to one or more embodiments illustrated in FIG. 5 to FIG. 9, the light emitting layer EML may include the polycyclic compound according to one or more embodiments as a dopant. In one or more embodiments, in the light-emitting element ED according to one or more embodiments illustrated in FIG. 5 to FIG. 9, the light emitting layer EML may include the first compound which is the polycyclic compound according to one or more embodiments, and at least one selected from among the second compound represented by Formula HT-1 and the third compound represented by Formula ET-1. In one or more embodiments, in the light-emitting element ED according to one or more embodiments illustrated in FIG. 5 to FIG. 9, the light emitting layer EML may include the first compound which is the polycyclic compound according to one or more embodiments, the second compound represented by Formula HT-1, the third compound represented by Formula ET-1, and the fourth compound represented by Formula D-1.

In the light-emitting element ED according to one or more embodiments, the light emitting layer EML may further include an anthracene derivative, a pyrene derivative, a fluoranthene derivative, a chrysene derivative, a dihydrobenzanthracene derivative, and/or a triphenylene derivative. For example, the light emitting layer EML may include an anthracene derivative and/or a pyrene derivative.

In the light-emitting element ED according to one or more embodiments illustrated in FIG. 5 to FIG. 9, the light emitting layer EML may include a host and a dopant and may further include a compound represented by Formula E-1. The compound represented by Formula E-1 may be used as a fluorescent host material.

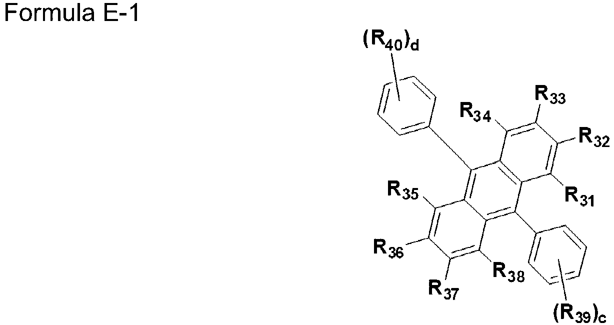

In Formula E-1, R₃₁ to R₄₀ may each independently be a hydrogen atom, a deuterium atom, a halogen atom, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 2 to 10 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring. R₃₁ to R₄₀ may be bonded to an adjacent group to form a saturated hydrocarbon ring, an unsaturated hydrocarbon ring, a saturated heterocycle, or an unsaturated heterocycle.

In Formula E-1, c and d may each independently be an integer of 0 to 5.

Formula E-1 may be represented by any one selected from among Compound E1 to Compound E19.

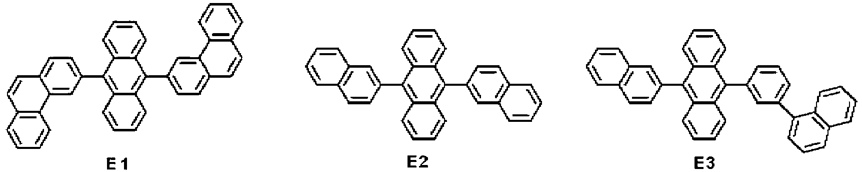

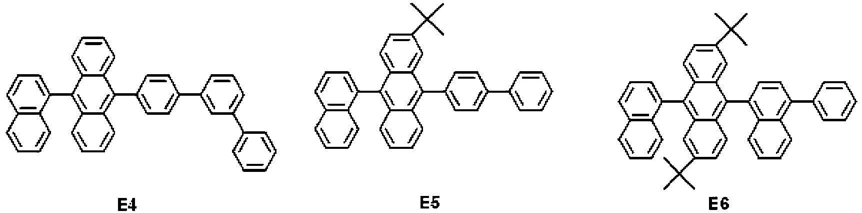

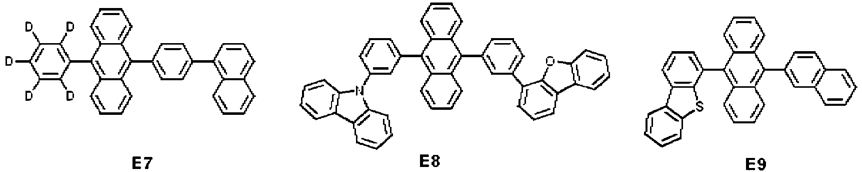

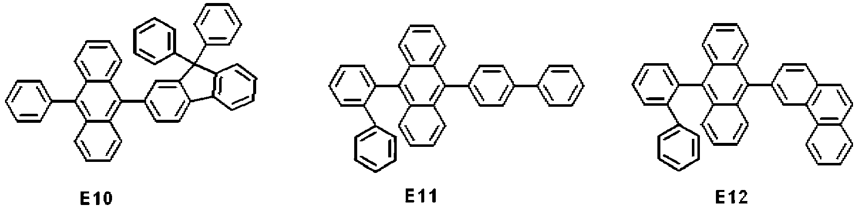

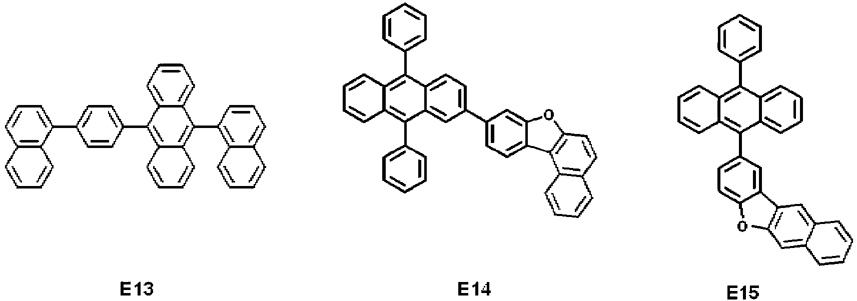

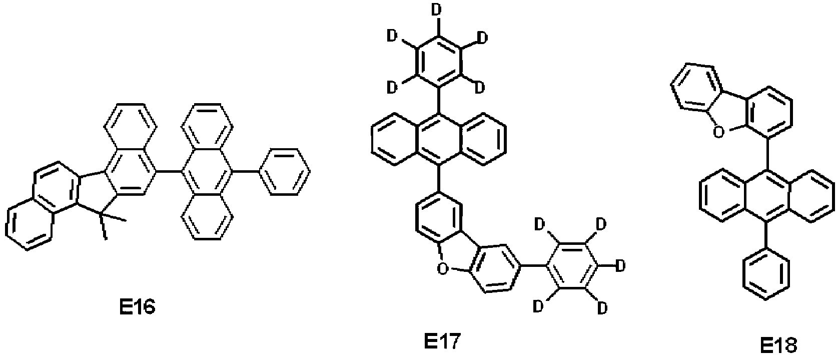

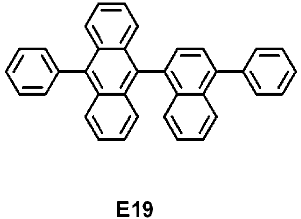

In one or more embodiments, the light emitting layer EML may further include a compound represented by Formula E-2a or Formula E-2b. The compound represented by Formula E-2a or Formula E-2b may be used as a host material of a phosphorescent light emitting layer.

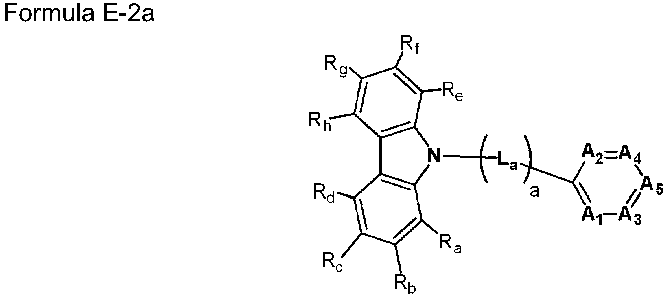

In Formula E-2a, a may be an integer of 0 to 10, and Lₐ may be a direct linkage (e.g., a single covalent bond), a substituted or unsubstituted arylene group having 6 to 30 ring-forming carbon atoms, or a substituted or unsubstituted heteroarylene group having 2 to 30 ring-forming carbon atoms. If (e.g., when) a is an integer of 2 or greater (e.g., an integer of 2 to 10), a plurality of Lₐ may each independently be a substituted or unsubstituted arylene group having 6 to 30 ring-forming carbon atoms or a substituted or unsubstituted heteroarylene group having 2 to 30 ring-forming carbon atoms.

In one or more embodiments, in Formula E-2a, A₁ to A₅ may each independently be N or CRᵢ. Rₐ to Rᵢ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring. Rₐ to Rᵢ may be bonded to an adjacent group to form a hydrocarbon ring or a heterocycle containing N, O, S, and/or the like as ring-forming atoms.

In Formula E-2a, two or three selected from among A₁ to A₅ may each independently be N, and the others may be CRᵢ.

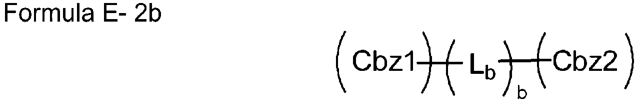

In Formula E-2b, Cbz1 and Cbz2 may each independently be an unsubstituted carbazole group or a carbazole group substituted with an aryl group having 6 to 30 ring-forming carbon atoms. L_{b} may be a direct linkage (e.g., a single covalent bond), a substituted or unsubstituted arylene group having 6 to 30 ring-forming carbon atoms, or a substituted or unsubstituted heteroarylene group having 2 to 30 ring-forming carbon atoms. If (e.g., when) b is an integer of 0 to 10, and, for example, if (e.g., when b is an integer of 2 or greater, a plurality of L_{b} may each independently be a substituted or unsubstituted arylene group having 6 to 30 ring-forming carbon atoms or a substituted or unsubstituted heteroarylene group having 2 to 30 ring-forming carbon atoms.

The compound represented by Formula E-2a or Formula E-2b may be represented by any one selected from among the compounds in Compound Group E-2. However, the compounds listed in Compound Group E-2 are provided as examples, and the compound represented by Formula E-2a or Formula E-2b is not limited to the compounds present in Compound Group E-2.

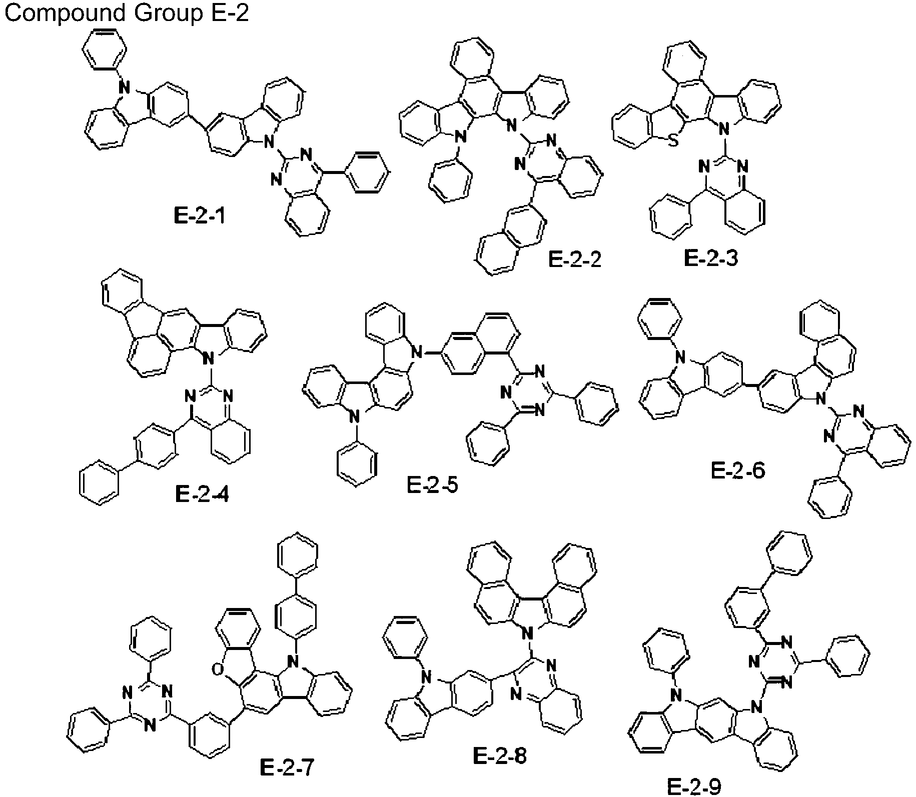

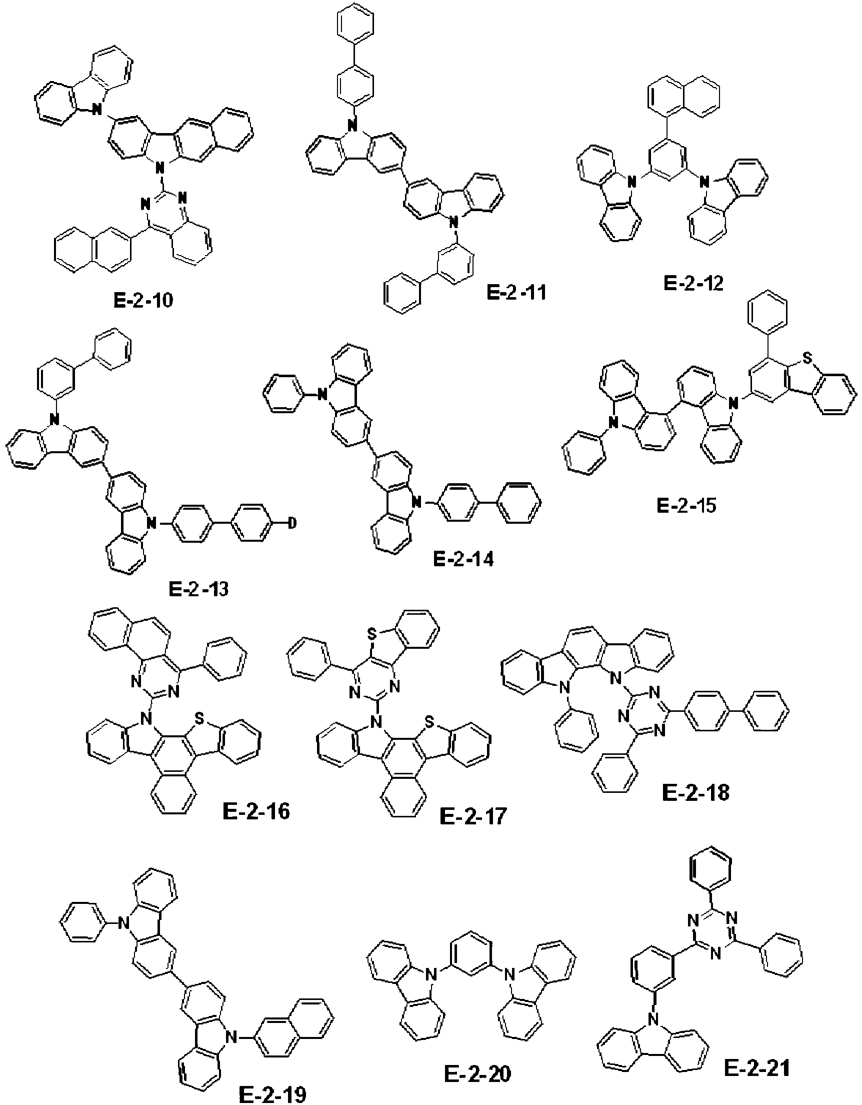

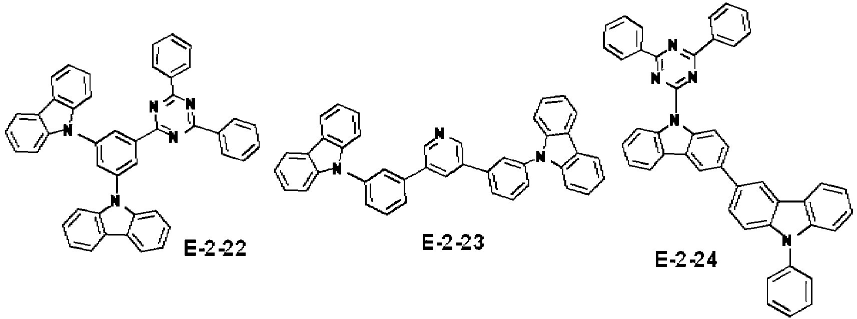

The light emitting layer EML may further include a compound represented by Formula M-a. The compound represented by Formula M-a may be used as a phosphorescent dopant material.

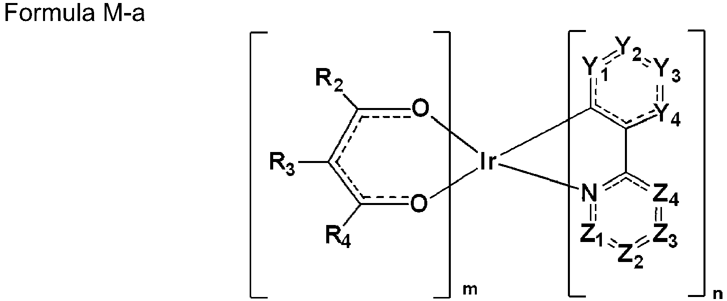

In Formula M-a, Y₁ to Y₄, and Z₁ to Z₄ may each independently be CR₁ or N, R₁ to R₄ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring. In Formula M-a, m may be 0 or 1, and n may be 2 or 3. In Formula M-a, if (e.g., when) m is 0, n may be 3, and if (e.g., when) m is 1, n may be 2.

The compound represented by Formula M-a may be used as a phosphorescent dopant.

The compound represented by Formula M-a may be represented by any one selected from among Compounds M-a1 to M-a25. However, Compounds M-a1 to Ma25 are provided as examples, and the compound represented by Formula M-a is not limited to the compounds represented by Compounds M-a1 to M-a25.

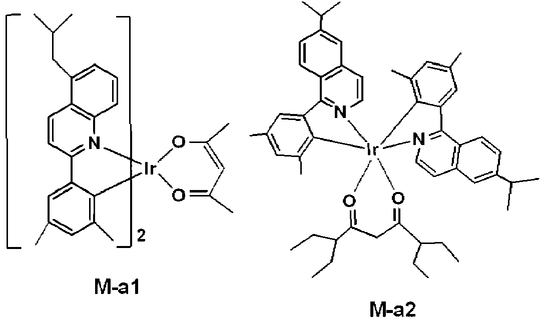

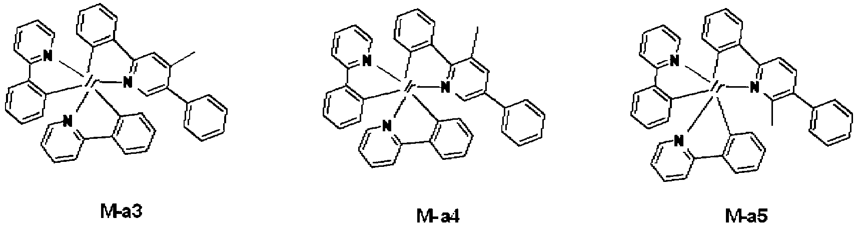

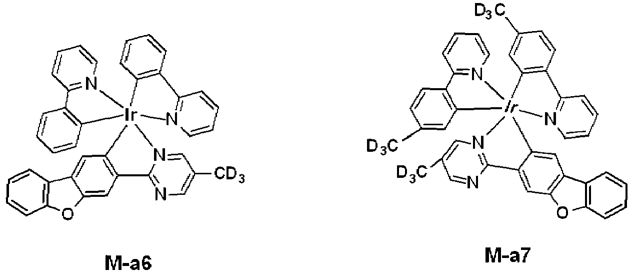

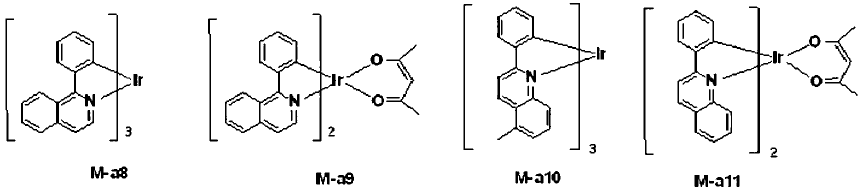

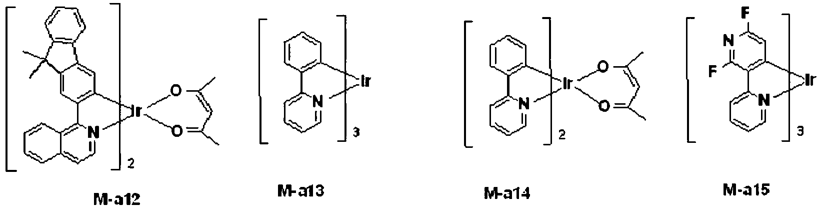

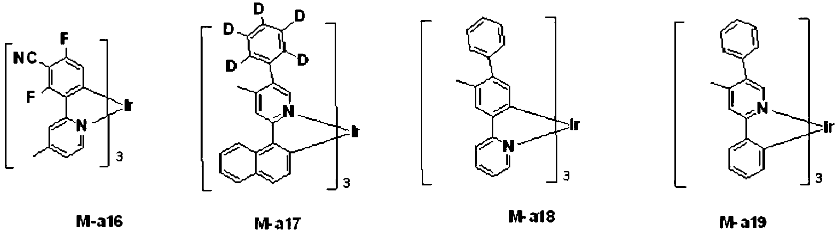

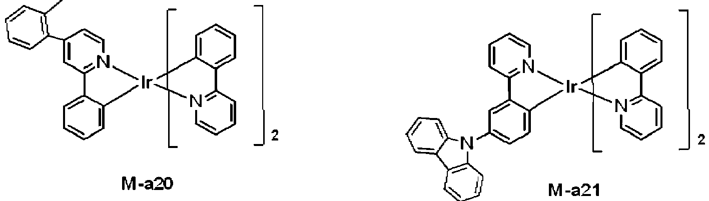

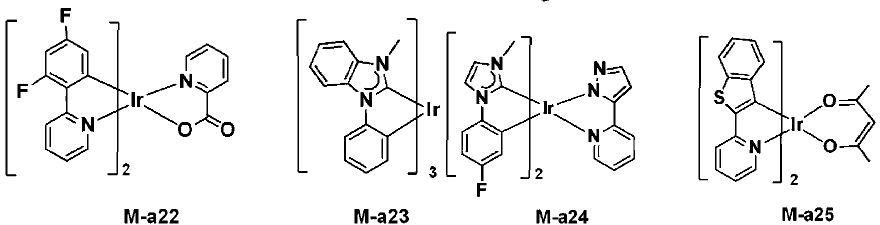

The light emitting layer EML may further include a compound represented by any one selected from among Formula F-a to Formula F-c. The compound represented by Formula F-a to Formula F-c may be used as a fluorescent dopant material.

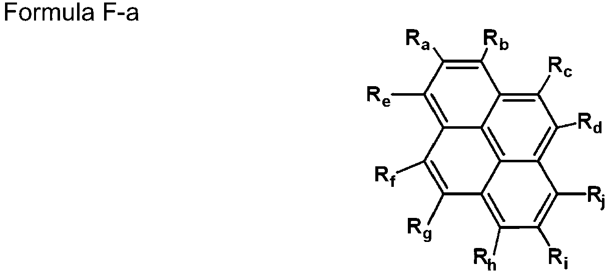

In Formula F-a, two selected from among Rₐ to Rⱼ may each independently be substituted with *-NAr₁Ar₂. The others, among Rₐ to Rⱼ, which are not substituted with *-NAr₁Ar₂ may each independently be a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In *-NAr₁Ar₂, Ar₁ and Ar₂ may each independently be a substituted or unsubstituted aryl group having 6 to 30 ring-forming carbon atoms or a substituted or unsubstituted heteroaryl group having 2 to 30 ring-forming carbon atoms. For example, at least one selected from among Ar₁ and Ar₂ may be a heteroaryl group containing O or S as a ring-forming atom.

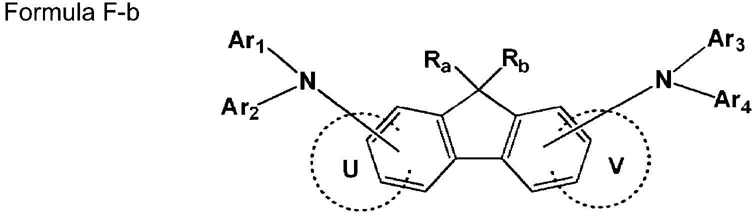

In Formula F-b, Rₐ and R_{b} may each independently be a hydrogen atom, a deuterium atom, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring. Ar₁ to Ar₄ may each independently be a substituted or unsubstituted aryl group having 6 to 30 ring-forming carbon atoms or a substituted or unsubstituted heteroaryl group having 2 to 30 ring-forming carbon atoms.

In Formula F-b, U and V may each independently be a substituted or unsubstituted hydrocarbon ring having 5 to 30 ring-forming carbon atoms or a substituted or unsubstituted heterocycle having 2 to 30 ring-forming carbon atoms. At least one selected from among Ar₁ to Ar₄ may be a heteroaryl group containing O or S as a ring-forming atom.

In Formula F-b, the number of rings designated by U and V may each independently be 0 or 1. For example, in Formula F-b, if (e.g., when) the number of U or V is 1, one ring forms a fused ring at a portion designated by U or V, and if (e.g., when) the number of U or V is 0, it indicates that no ring designated by U or V is present. For example, if (e.g., when) the number of U is 0 and the number of V is 1 or if (e.g., when) the number of U is 1 and the number of V is 0, a fused ring having a fluorene core of Formula F-b may be a cyclic compound having four rings. In one or more embodiments, if (e.g., when) the number of U and V are both (e.g., simultaneously) 0, the fused ring of Formula F-b may be a cyclic compound having three rings. In one or more embodiments, if (e.g., when) the number of U and V are both (e.g., simultaneously) 1, the fused ring having a fluorene core of Formula F-b may be a cyclic compound having five rings.

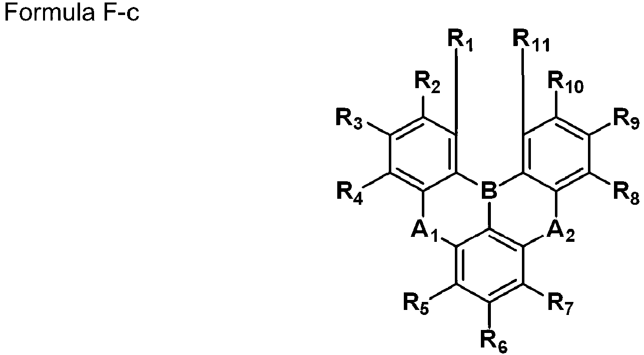

In Formula F-c, A₁ and A₂ may each independently be O, S, Se, or NRₘ, and Rₘ may be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. R₁ to R₁₁ may each independently be a hydrogen atom, a deuterium atom, a halogen atom, a cyano group, a substituted or unsubstituted amine group, a substituted or unsubstituted boron group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring.

In Formula F-c, A₁ and A₂ may each independently be bonded to substituents of an adjacent ring to form a fused ring. For example, if (e.g., when) A₁ and A₂ are each independently NRₘ, A₁ may be bonded to R₄ or R₅ to form a ring. In one or more embodiments, A₂ may be bonded to R₇ or R₈ to form a ring.

In one or more embodiments, the light emitting layer EML may be a dopant material that is generally available or generally used and may further include a styryl derivative (for example, 1,4-bis[2-(3-N-ethylcarbazolyl)vinyl]benzene (BCzVB), 4-(di-p-tolylamino)-4'-[(di-p-tolylamino)styryl]stilbene (DPAVB), N-(4-((E)-2-(6-((E)-4-(diphenylamino)styryl)naphthalen-2-yl)vinyl)phenyl)-N-phenylbenzenamine (N-BDAVBi), 4,4'-bis[2-(4-(N,N-diphenylamino)phenyl)vinyl]biphenyl (DPAVBi), perylene and a derivative thereof (for example, 2,5,8,11-tetra-t-butylperylene (TBP)), pyrene and a derivative thereof (for example, 1,1-dipyrene, 1 4-dipyrenylbenzene, 1,4-bis(N, N-diphenylamino)pyrene), and/or the like.

The light emitting layer EML may further include a phosphorescent dopant material that is generally available or generally used. For example, a metal complex including iridium (Ir), platinum (Pt), osmium (Os), gold (Au), titanium (Ti), zirconium (Zr), hafnium (Hf), europium (Eu), terbium (Tb), or thulium (Tm) may be used as the phosphorescent dopant. For example, iridium(III) bis(4,6-difluorophenylpyridinato-N,C2')picolinate (Flrpic), bis(2,4-difluorophenylpyridinato)-tetrakis(1-pyrazolyl)borate iridium(III) (FIr6), or platinum octaethyl porphyrin (PtOEP) may be used as a phosphorescent dopant. However, embodiments of the present disclosure are not limited thereto.

The light emitting layer EML may include a quantum dot material. A core of the quantum dot may be selected from among a group II-VI compound, a group I-II-VI compound, a group II-IV-VI compound, a group I-II-IV-VI compound, a group II-IV-V compound, a group III-VI compound, a group I-III-VI compound, a group III-V compound, a group III-II-V compound, a group IV-VI compound, a group IV element, a group IV compound, and a combination thereof.

The group II-VI compound may be selected from the group consisting of: a binary compound selected from the group consisting of CdSe, CdTe, CdS, ZnS, ZnSe, ZnTe, ZnO, HgS, HgSe, HgTe, MgSe, MgS, and a mixture thereof; a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof; and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, and a mixture thereof.

The group III-VI compound may include: a binary compound, such as In₂S₃ and In₂Se₃; a ternary compound, such as InGaS₃ and InGaSe₃; or any combination thereof.

The group I-III-VI compound may be selected from among a ternary compound selected from the group consisting of AgInS, AgInS₂, CulnS, CuInS₂, AgGaS₂, CuGaS₂ CuGaO₂, AgGaO₂, AgAlO₂ and a mixture thereof; or a quaternary compound, such as AgInGaS₂ and CuInGaS₂.

The group III-V compound may be selected from the group consisting of: a binary compound selected from the group consisting of GaN, GaP, GaAs, GaSb, AlN, AlP, AlAs, AlSb, InN, InP, InAs, InSb, and a mixture thereof; a ternary compound selected from the group consisting of GaNP, GaNAs, GaNSb, GaPAs, GaPSb, AINP, AlNAs, AlNSb, AlPAs, AlPSb, InGaP, InAlP, InNP, InNAs, InNSb, InPAs, InPSb, and a mixture thereof; and a quaternary compound selected from the group consisting of GaAlNP, GaAINAs, GaAINSb, GaAlPAs, GaAlPSb, GalnNP, GalnNAs, GalnNSb, GalnPAs, GalnPSb, InAlNP, InAINAs, InAlNSb, InAIPAs, InAIPSb, and a mixture thereof. The group III-V compound may further include a group II metal. For example, as the group III-II-V compound, InZnP and/or the like may be selected.

The group IV-VI compound may be selected from the group consisting of: a binary compound selected from the group consisting of SnS, SnSe, SnTe, PbS, PbSe, PbTe, and a mixture thereof; a ternary compound selected from the group consisting of SnSeS, SnSeTe, SnSTe, PbSeS, PbSeTe, PbSTe, SnPbS, SnPbSe, SnPbTe, and a mixture thereof; and a quaternary compound selected from the group consisting of SnPbSSe, SnPbSeTe, SnPbSTe, and a mixture thereof. The group IV element may be selected from the group consisting of Si, Ge, and a mixture thereof. The group IV compound may be a binary compound selected from the group consisting of SiC, SiGe, and a mixture thereof.

Each element contained in a multi-element compound, such as the binary compound, the ternary compound, and the quaternary compound, may be present in particles at a substantially uniform concentration or a substantially non-uniform concentration. For example, the formulas described herein indicate types (kinds) of elements included in the compound, and element ratios in the compound may vary. For example, AgInGaS₂ may refer to AgInₓGa₁₋ₓS₂ (where x is a real number between 0 to 1).

The quantum dot may have a single structure in which a concentration of each element contained in the corresponding quantum dot is substantially uniform, or a core-shell dual structure. For example, a material contained in the core may be different from a material contained in the shell.

The shell of the quantum dot may serve as a protection layer to protect the core from being chemically modified (or to reduce a degree to or occurrence of which the core is chemically modified) to maintain semiconductor properties and/or as a charging layer to impart or increase electrophoretic properties to the quantum dot. The shell may have a single layer or a multilayer. An interface between the core and the shell may have a concentration gradient in which a concentration of an element present in the shell decreases gradually toward the core.

Examples of the shell of the quantum dot may include an oxide of a metal or a non-metal, a semiconductor compound, a combination thereof, and/or the like. Examples of the oxide of metal or non-metal may include: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, and NiO; or a ternary compound, such as MgAl₂O₄, CoFe₂O₄, NiFe₂O₄, and CoMn₂O₄, but embodiments of the present disclosure are not limited thereto.

Also, examples of the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, and/or the like, but embodiments of the present disclosure are not limited thereto.

Each element included in a multi-element compound, such as the binary compound or the ternary compound, may be present at substantially uniform concentration or substantially non-uniform concentration within particles. For example, the formulas described herein indicate types (kinds) of elements included in the compound, and element ratios in the compound may vary.

The quantum dot may have a full width of half maximum (FWHM) of about 45 nm or less, for example, about 40 nm or less, and, for example, about 30 nm or less, in an emission wavelength spectrum, and if (e.g., when) FWHM falls within the foregoing range, color purity or color reproducibility may be improved or enhanced. In one or more embodiments, light emitted through the quantum dot may be emitted in all directions, and thus an optical viewing angle may be improved or enhanced.

In one or more embodiments, the shape of the quantum dot may be generally available in the art without particular limitation. However, for example, the quantum dot may adopt a spherical nanoparticle, a pyramidal nanoparticle, a multi-arm-shaped nanoparticle, a cubic nanoparticle, a nanotube, a nanowire, a nanofiber, a nanoplate particle, and/or the like.

An energy band gap may be controlled or selected by controlling the size of the quantum dot or by controlling the element ratio in the quantum dot compound, and thus light with one or more suitable wavelength bands may be emitted from the quantum dot light emitting layer. Therefore, by using the quantum dot described herein (using quantum dots in different sizes or with different element ratios in the quantum dot compound), a light-emitting element that emits light with one or more suitable wavelengths may be implemented. For example, the size of the quantum dot or the element ratio in the quantum dot compound may be selected such that red, green, and/or blue light are/is emitted. In one or more embodiments, the quantum dots may be configured to emit white light by combining one or more suitable colors of light.

In the light-emitting element ED according to one or more embodiments, illustrated in FIG. 5 to FIG. 9, the electron transport region ETR may be provided on the light emitting layer EML. The electron transport region ETR may include at least one selected from among a hole-blocking layer HBL, an electron transport layer ETL, and an electron injection layer EIL, but embodiments of the present disclosure are not limited thereto.

The electron transport region ETR may have a single layer formed or composed of a single material, a single layer formed or composed of a plurality of different materials, or a multi-layered structure having a plurality of layers formed or composed of a plurality of different materials.

For example, the electron transport region ETR may have a single-layered structure of an electron injection layer EIL or an electron transport layer ETL and may also have a single-layered structure formed or composed of an electron injection material and an electron transport material. In one or more embodiments, the electron transport region ETR may have a single-layered structure formed or composed of a plurality of different materials, or may have a structure of, stacked from the light emitting layer EML in sequence, electron transport layer ETL/electron injection layer EIL, or hole-blocking layer HBL/electron transport layer ETL/electron injection layer EIL, but embodiments of the present disclosure are not limited thereto. The electron transport region ETR may have a thickness of, for example, about 1000 Å to about 1500 Å.

The electron transport region ETR may be formed using one or more suitable methods, such as a vacuum deposition method, a spin coating method, a cast method, a Langmuir-Blodgett (LB) method, an inkjet printing method, a laser printing method, and a laser induced thermal imaging (LITI) method.

The electron transport region ETR may include a compound represented by Formula ET-2.

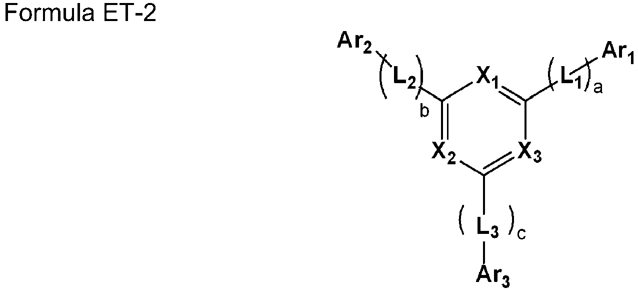

In Formula ET-2, at least one selected from among X₁ to X₃ may be N, and the others may be CRₐ. Rₐ may be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. Ar₁ to Ar₃ may each independently be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In Formula ET-2, a to c may each independently be an integer of 0 to 10. In Formula ET-2, L₁ to L₃ may each independently be a direct linkage (e.g., a single covalent bond), a substituted or unsubstituted arylene group having 6 to 30 ring-forming carbon atoms, or a substituted or unsubstituted heteroarylene group having 2 to 30 ring-forming carbon atoms. If (e.g., when) a to c are each independently an integer of 2 or greater, L₁ to L₃ may each independently be a substituted or unsubstituted arylene group having 6 to 30 ring-forming carbon atoms or a substituted or unsubstituted heteroarylene group having 2 to 30 ring-forming carbon atoms.

The electron transport region ETR may include an anthracene-based compound. However, embodiments of the present disclosure are not limited thereto, and the electron transport region ETR may include, for example, tris(8-hydroxyquinolinato)aluminium (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzimidazol-1-yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(biphenyl-4-yl)-4-phenyl-5-tert-butylphenyl-1,2,4-triazole (TAZ), 4-(naphthalen-1-yl)-3,5-diphenyl-4H-1,2,4-triazole (NTAZ), 2-(biphenyl-4-yl)-5-(4-tert-butylphenyl)-1,3,4-oxadiazole (tBu-PBD), bis(2-methyl-8-quinolinolato-N1,O8)-(1,1'-biphenyl-4-olato)aluminium (BAlq), berylliumbis(benzoquinolin-10-olate) (Bebq₂), 9,10-di(naphthalen-2-yl)anthracene (ADN), 1,3-bis[3,5-di(pyridin-3-yl)phenyl]benzene (BmPyPhB), and a mixture thereof.

The electron transport region ETR may include at least one selected from among Compounds ET1 to ET36.

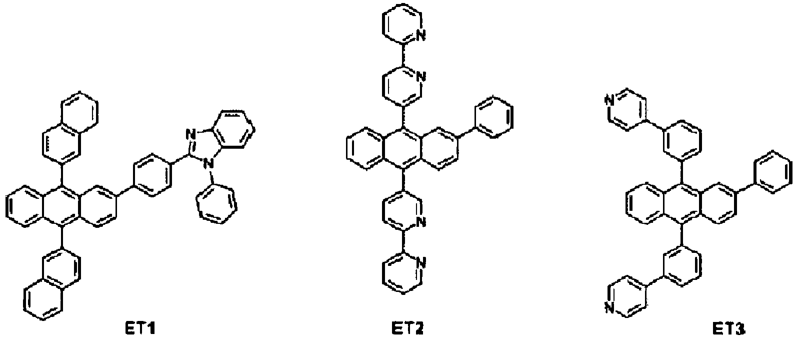

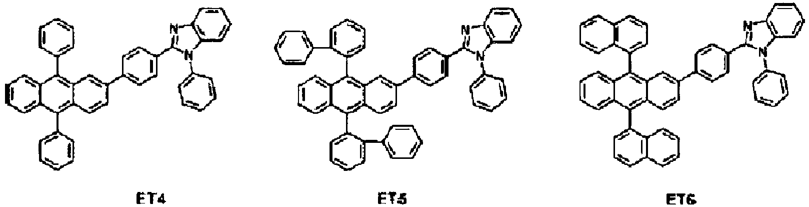

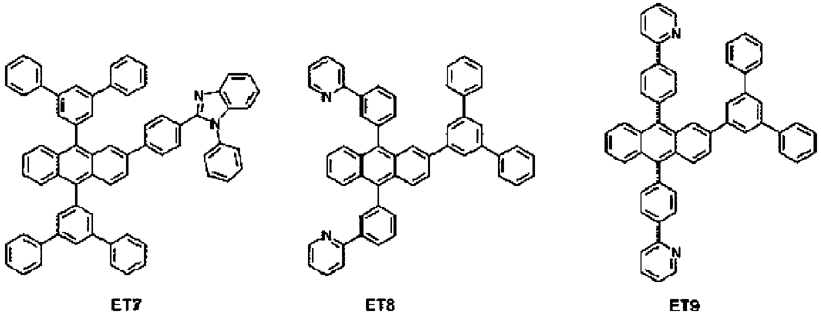

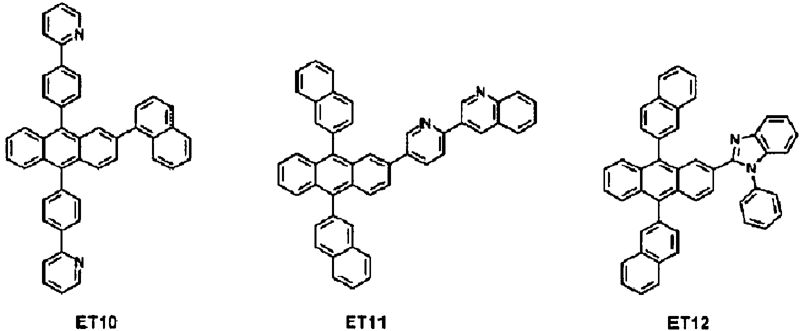

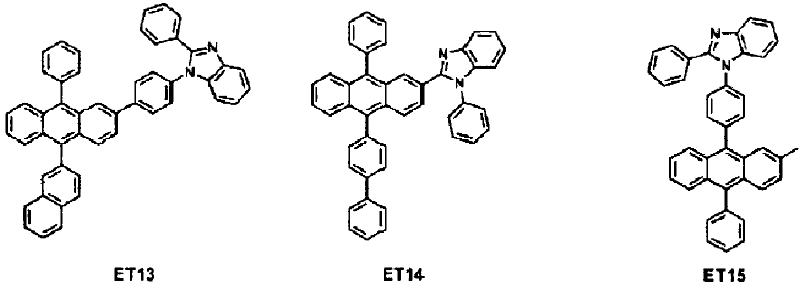

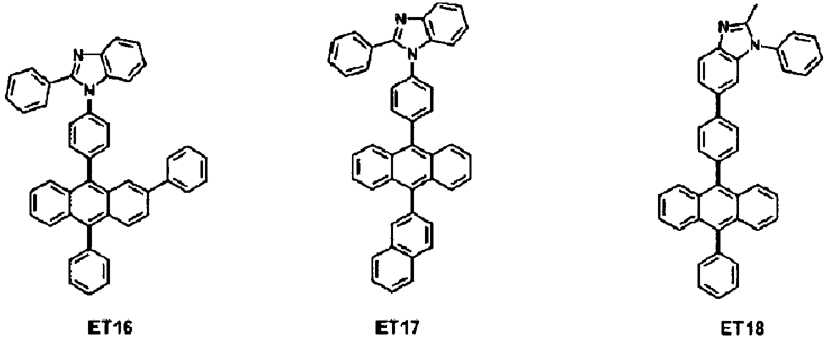

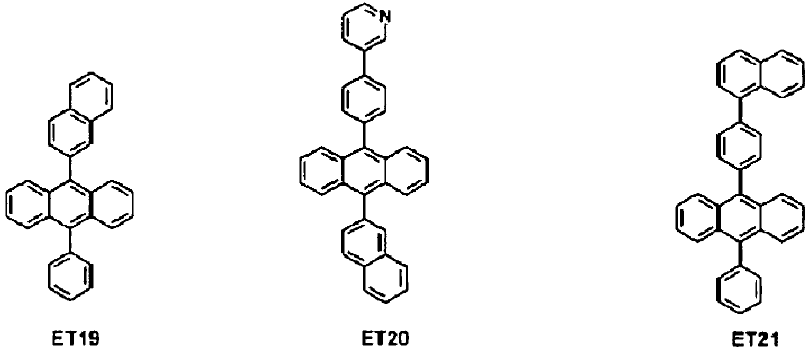

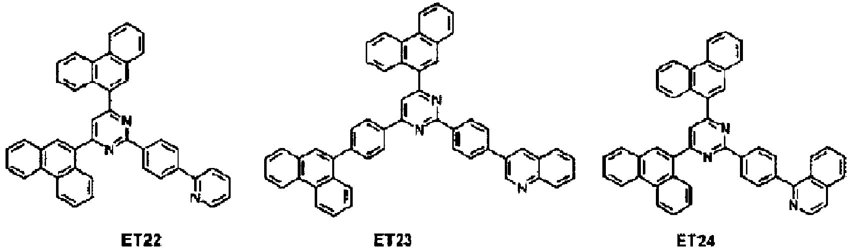

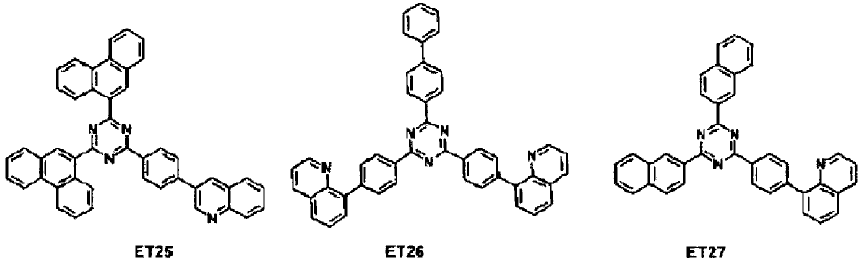

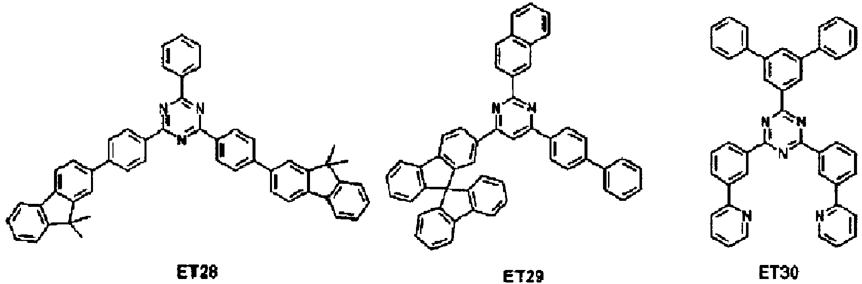

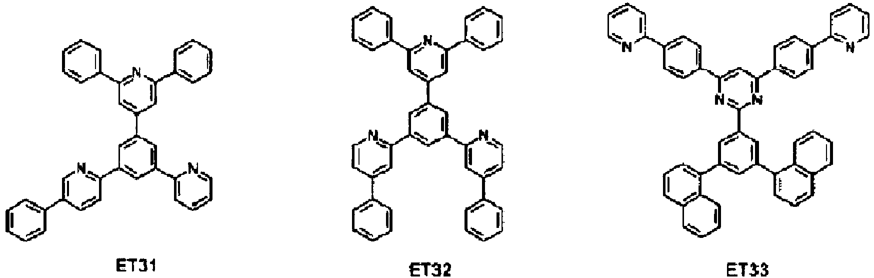

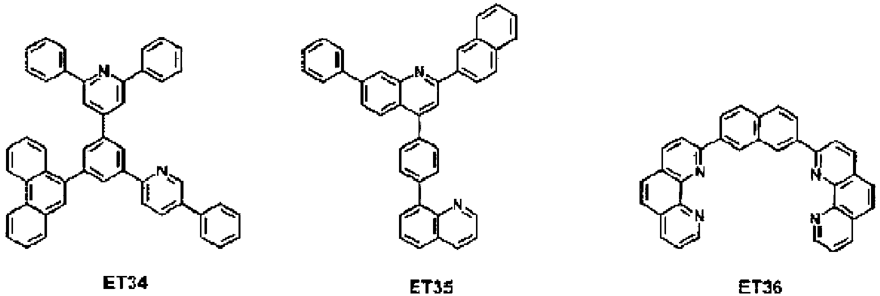

In one or more embodiments, the electron transport region ETR may include a metal halide, such as LiF, NaCl, CsF, RbCl, Rbl, Cul, and Kl, a lanthanide metal, such as Yb, or co-deposition materials of a metal halide and a lanthanide metal. For example, the electron transport region ETR may include KI:Yb, Rbl:Yb, LiF:Yb, and/or the like, as a co-deposition material. A metal oxide, such as Li₂O, and BaO, lithium-8-hydroxyquinolinolate (Liq), and/or the like may be used in the electron transport region ETR, but embodiments of the present disclosure are not limited thereto. The electron transport region ETR may also be formed or composed of mixed materials of an electron transport material and an insulating organo metal salt. The organo metal salt may be a material having an energy band gap of about 4 eV or greater. For example, the organo metal salt may include, for example, a metal acetate, a metal benzoate, a metal acetoacetate, a metal acetylacetonate, or a metal stearate.

The electron transport region ETR may further include at least one selected from among 2,9-dimethyl-4,7-diphenyl-1,10-phenanthroline (BCP), diphenyl(4-(triphenylsilyl)phenyl)phosphine oxide (TSPO1), and 4,7-diphenyl-1,10-phenanthroline (Bphen) in addition to the materials described herein, but embodiments of the present disclosure are not limited thereto.

The electron transport region ETR may include the compounds of the electron transport region described herein in at least one selected from among the electron injection layer EIL, the electron transport layer ETL, and the hole-blocking layer HBL.

If (e.g., when) the electron transport region ETR includes an electron transport layer ETL, the electron transport layer ETL may have a thickness of about 100 Å to about 1000 Å, for example, about 150 Å to about 500 Å. If (e.g., when) the thickness of the electron transport layer ETL falls within the foregoing range, satisfactory or suitable electron transport properties may be obtained without a substantial increase in a driving voltage. If (e.g., when) the electron transport region ETR includes an electron injection layer EIL, the electron injection layer EIL may have a thickness of about 1 Å to about 100 Å and, for example, about 3 Å to about 90 Å. If (e.g., when) the thickness of the electron injection layers EIL falls within the foregoing range, satisfactory or suitable electron injection properties may be obtained without a substantial increase in a driving voltage.

The second electrode EL2 may be provided on the electron transport region ETR. The second electrode EL2 may be a common electrode. The second electrode EL2 may be a cathode or an anode, but embodiments of the present disclosure are not limited thereto. For example, if (e.g., when) the first electrode EL1 is an anode, the second electrode EL2 may be a cathode, and if (e.g., when) the first electrode EL1 is a cathode, the second electrode EL2 may be an anode.

The second electrode EL2 may be a transmissive electrode, a transflective electrode, or a reflective electrode. If (e.g., when) the second electrode EL2 is a transmissive electrode, the second electrode EL2 may be formed or composed of a transparent (e.g., substantially transparent) metal oxide, such as indium tin oxide (ITO), indium zinc oxide (IZO), zinc oxide (e.g., ZnO), and/or indium tin zinc oxide (ITZO).

If (e.g., when) the second electrode EL2 is a transflective electrode or a reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, Na, or a compound or mixture thereof (for example, AgMg, AgYb, MgYb, AgLi, or AgNa). In one or more embodiments, the second electrode EL2 may have a multi-layered structure including a reflective layer or a transflective layer formed or composed of the material described herein or a transparent conductive (e.g., electrically conductive) layer formed or composed of indium tin oxide (ITO), indium zinc oxide (IZO), zinc oxide (e.g., ZnO), indium tin zinc oxide (ITZO), and/or the like. For example, the second electrode EL2 may include the metal materials described herein, a combination of two or more metal materials selected from among the metal materials described herein, or an oxide of the metal materials described herein.

In one or more embodiments, the second electrode EL2 may be connected to an auxiliary electrode. If (e.g., when) the second electrode EL2 is connected to the auxiliary electrode, resistance (e.g., electrical resistance) of the second electrode EL2 may decrease.

A capping layer CPL may be further arranged on the second electrode EL2 of the light-emitting element ED according to one or more embodiments. The capping CPL may include a multi-layer or a single layer.

In one or more embodiments, the capping layer CPL may be an organic layer or an inorganic layer. For example, if (e.g., when) the capping layer CPL includes an inorganic material, the inorganic material may include: an alkali metal compound, such as LiF; an alkaline earth metal compound, such as MgF₂; SiON; silicon nitride (e.g., SiₓN_{y}, wherein 0 < x ≤ 3 and 0 < y ≤ 4; e.g., Si₃N₄); silicon oxide (e.g., SiOₓ, wherein 0 < x ≤ 2; e.g., SiO₂); and/or the like.

For example, if (e.g., when) the capping layer CPL includes an organic material, the organic material may include α-NPD, NPB, TPD, m-MTDATA, Alq₃, CuPc, N4,N4,N4',N4'-tetra[(1,1'-biphenyl)-4-yl]-(1,1'-biphenyl)-4,4'-diamine (TPD15), tris(4-carbazoyl-9-ylphenyl)amine (TCTA), and/or the like, or may include an epoxy resin or acrylate, such as methacrylate. However, embodiments of the present disclosure are not limited thereto, and the capping layer CPL may include at least one selected from among Compounds P1 to P5.

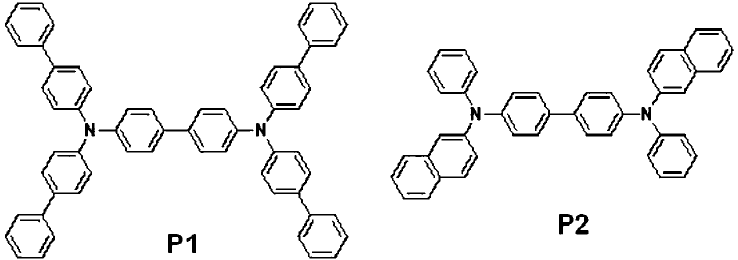

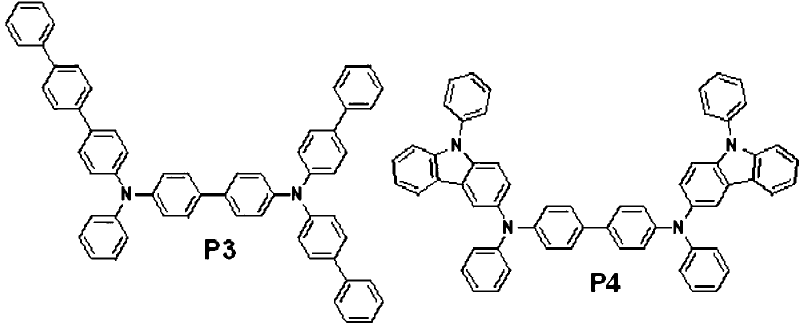

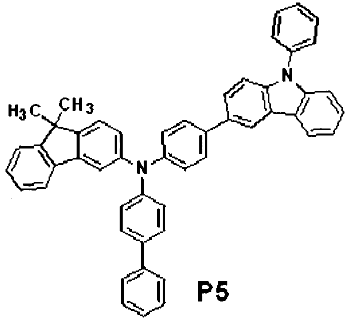

The capping layer CPL may have a refractive index of about 1.6 or greater. For example, the capping layer CPL may have a refractive index of about 1.6 or greater for light in a wavelength range of about 550 nm to about 660 nm.

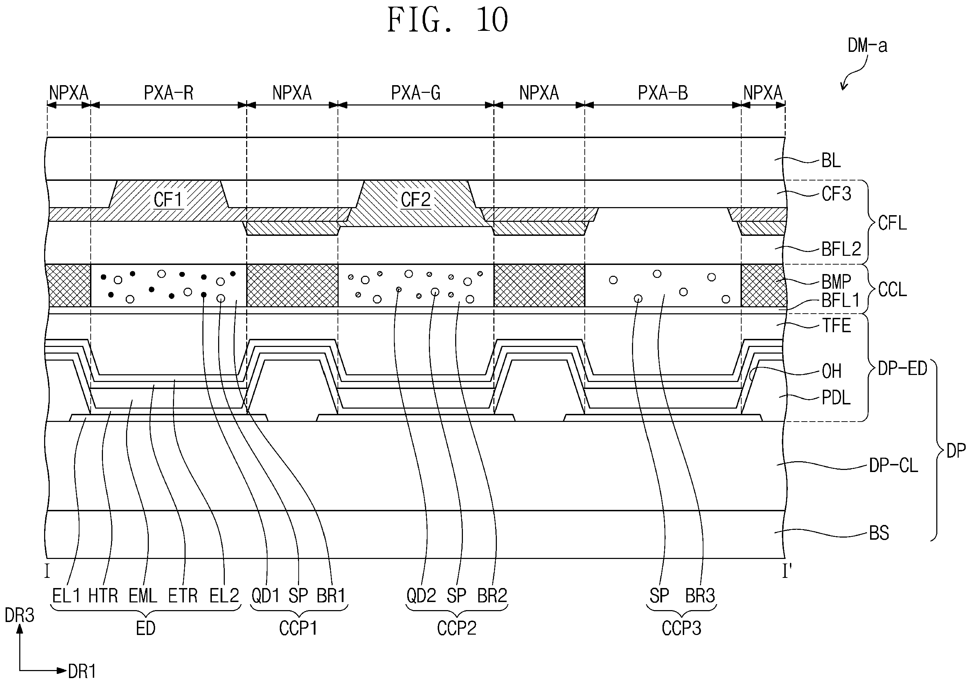

FIG. 10 to FIG. 13 are each a cross-sectional view of a display module according to one or more embodiments. Hereinafter, for descriptions of the display module according to one or more embodiments, to be described with reference to FIG. 10 to FIG. 13, the duplicated content as the descriptions provided with reference to FIG. 1 to FIG. 9 may not be provided again, and different features may be mainly described.

Referring to FIG. 10, a display module DM-a according to one or more embodiments may include a display panel DP that includes a display element layer DP-ED, a light control layer CCL, and a color filter layer CFL, arranged on the display panel DP. In one or more embodiments illustrated in FIG. 10, the display panel DP may include a base layer BS, a circuit layer DP-CL, and a display element layer DP-ED, provided on the base layer BS, and the element layer DP-ED may include a light emitting element ED.

The light-emitting element ED may include a first electrode EL1, a hole transport region HTR arranged on the first electrode EL1, a light emitting layer EML arranged on the hole transport region HTR, an electron transport region ETR arranged on the light emitting layer EML, and a second electrode EL2 arranged on the electron transport region ETR. The structure of the light-emitting element ED illustrated in FIG. 5 to FIG. 9 may be similarly applied to a structure of the light-emitting element ED illustrated in FIG. 10. The light-emitting element ED illustrated in FIG. 10 may include a polycyclic compound according to one or more embodiments. Therefore, the light-emitting element ED may exhibit long lifespan characteristics. In one or more embodiments, the light-emitting element ED may exhibit long lifespan characteristics in an emission region of blue light.

Referring to FIG. 10, the light emitting layer EML may be arranged in an opening OH defined in a pixel-defining film PDL. For example, the light emitting layer EML, which is separated by the pixel-defining film PDL and correspondingly and respectively provided in emission regions PXA-R, PXA-G, and PXA-B, may be to emit light of the same wavelength region. In a display module DM-a according to one or more embodiments, the light emitting layer EML may be to emit blue light. In one or more embodiments, the light emitting layer EML may be provided across all the emission regions PXA-R, PXA-G, and PXA-G as a common layer.

The light control layer CCL may be arranged on the display panel DP. Although the light control layer CCL is illustrated as being arranged above the display element layer DP-ED, embodiments of the present disclosure are not limited thereto, and the light control layer CCL may be arranged below the display element layer DP-ED. The light control layer CCL may include a light converter. The light converter may be quantum dots or a fluorescent substance. The light converter may be to convert a wavelength of provided light and emit the light. For example, the light control layer CCL may be a layer including quantum dots or a layer including a fluorescent substance.

The light control layer CCL may include a plurality of light control parts CCP1, CCP2, and CCP3. The light control parts CCP1, CCP2, and CCP3 may be spaced and/or apart (e.g., spaced apart or separated) from each other.

Referring to FIG. 10, a partition pattern BMP may be arranged between the light control parts CCP1, CCP2, and CCP3, spaced and/or apart (e.g., spaced apart or separated) from each other, but embodiments of the present disclosure are not limited thereto. FIG. 10 illustrates that the partition pattern BMP does not overlap the light control parts CCP1, CCP2, and CCP3, but at least a portion of an edge of the light control parts CCP1, CCP2, and CCP3 may overlap the partition pattern BMP.

The light control layer CCL may include a first light control part CCP1 including a first quantum dot QD1 that converts first color light provided from the light-emitting element ED into second color light, a second light control part CCP2 including a second quantum dot QD2 that converts first color light into third color light, and a third light control part CCP3 transmitting first color light.

In one or more embodiments, the first light control part CCP1 may be to provide red light which is the second color light, and the second light control part CCP2 may be to provide green light which is the third color light. The third light control part CCP3 may be to transmit and provide blue light which is the first color light provided from the light-emitting element ED. For example, the first quantum dot QD1 may be a red quantum dot, and the second quantum dot QD2 may be a green quantum dot. The details provided herein may be similarly applied to the quantum dots QD1 and QD2.

In one or more embodiments, the light control layer CCL may further include a scatterer (a light scatterer) SP. The first light control part CCP1 may include the first quantum dot QD1 and the scatterer SP, the second light control part CCP2 may include the second quantum dot QD2 and the scatterer SP, and the third light control part CCP3 may not include (e.g., may exclude) a quantum dot but include the scatterer SP.

The scatterer SP may be an inorganic particle. For example, the scatterer SP may include at least one selected from among TiO₂, ZnO, Al₂O₃, SiO₂, and hollow silica. The scatterer SP may include any one selected from among TiO₂, ZnO, Al₂O₃, SiO₂, and hollow silica, or may be a mixture of two or more materials selected from among TiO₂, ZnO, Al₂O₃, SiO₂, and hollow silica.

The first light control part CCP1, the second light control part CCP2, and the third light control part CCP3 may respectively include base resins BR1, BR2, and BR3 which disperse the quantum dots QD1 and QD2, and the scatterer SP. In one or more embodiments, the first light control part CCP1 may include the first quantum dot QD1 and the scatterer SP dispersed in a first base resin BR1, the second light control part CCP2 may include the second quantum dot QD2 and the scatterer SP dispersed in a second base resin BR2, and the third light control part CCP3 may include the scatterer SP dispersed in a third base resin BR3.

The base resins BR1, BR2, and BR3 may be each a medium through which the quantum dots QD1 and QD2 and the scatterer SP are dispersed and may be formed of one or more suitable resin compositions, which may be generally referred to as a binder. For example, the base resins BR1, BR2, and BR3 may each independently be an acrylate-based resin, a urethane-based resin, a silicon-based resin, an epoxy-based resin, and/or the like. The base resins BR1, BR2, and BR3 may be transparent (e.g., substantially transparent) resins. In one or more embodiments, the first base resin BR1, the second base resin BR2, and the third base resin BR3 may be substantially the same as or different from each other.

The light control layer CCL may include a barrier layer BFL1. The barrier layer BFL1 may serve to prevent penetration of moisture and/or oxygen (or to reduce a degree or occurrence of penetration of moisture and/or oxygen) (hereinafter, referred to as "moisture/oxygen"). The barrier layer BFL1 may be arranged on the light control parts CCP1, CCP2, and CCP3 and prevent the light control parts CCP1, CCP2, and CCP3 from being exposed to moisture/oxygen (or reduce a degree to or occurrence of which the light control parts CCP1, CCP2, and CCP3 are exposed to moisture/oxygen). The barrier layer BFL1 may cover the light control parts CCP1, CCP2, and CCP3. In one or more embodiments, a barrier layer BFL2 may also be provided between the light control parts CCP1, CCP2, and CCP3 and a color filter layer CFL.

The barrier layers BFL1 and BFL2 may include at least one inorganic layer. For example, the barrier layers BFL1 and BFL2 may be formed by including an inorganic material. For example, the barrier layers BFL1 and BFL2 may include silicon nitride, aluminium nitride, zirconium nitride, titanium nitride, hafnium nitride, tantalum nitride, silicon oxide, aluminium oxide, titanium oxide, tin oxide, cerium oxide, silicon oxynitride, a metal thin film having secured light transmittance, and/or the like. The barrier layers BFL1 and BFL2 may further include an organic film. The barrier layers BFL1 and BFL2 may include (e.g., consist of) a single layer or a plurality of layers.

In the display module DM-a according to one or more embodiments, the color filter layer CFL may be arranged on the light control layer CCL. For example, the color filter layer CFL may be directly arranged on the light control layer CCL. In this case, the barrier layer BFL2 may not be provided.

The color filter layer CFL may include filters CF1, CF2, and CF3. The color filter layer CFL may include a first filter CF1 transmitting the second color light, a second filter CF2 transmitting the third color light, and a third filter CF3 transmitting the first color light. For example, the first filter CF1 may be a red filter, the second filter CF2 may be a green filter, and the third filter CF3 may be a blue filter. The filters CF1, CF2, and CF3 may each include a polymer photosensitive resin and a pigment and/or a dye. The first filter CF1 may include a red pigment and/or a red dye, the second filter CF2 may include a green pigment and/or a green dye, and the third filter CF3 may include a blue pigment and/or a blue dye.

Embodiments of the present disclosure are not limited thereto, and the third filter CF3 may not include (e.g., may exclude) a pigment or a dye. The third filter CF3 may include a polymer photosensitive resin and may not include (e.g., may exclude) a pigment or a dye. The third filter CF3 may be transparent (e.g., substantially transparent). The third filter CF3 may be formed of a transparent (e.g., substantially transparent) photosensitive resin.

In one or more embodiments, the first filter CF1 and the second filter CF2 may be yellow filters. The first filter CF1 and the second filter CF2 may not be separated from each other and be provided as one body.

In one or more embodiments, the color filter layer CFL may further include a light-blocking part. The light-blocking part may be a black matrix. The light-blocking part may include an organic light-blocking material or an inorganic light-blocking material, containing a black pigment and/or a black dye. The light-blocking part may prevent a light-leakage phenomenon (or reduce a degree or occurrence of a light-leakage phenomenon), and may set boundaries between the adjacent filters CF1, CF2, and CF3. In one or more embodiments, the light-blocking part may be formed of a blue filter.

The first to third filters CF1, CF2, and CF3 may be respectively and correspondingly arranged in the first emission region PXA-R, the second emission region PXA-G, and the third emission region PXA-B.

A base substrate BL may be arranged on the color filter layer CFL. The base substrate BL may be a member that provides a base surface on which the color filter layer CFL, the light control layer CCL, and/or the like are arranged. The base substrate BL may be a glass substrate, a metal substrate, a plastic substrate, and/or the like. However, embodiments of the present disclosure are not limited thereto, and the base substrate BL may be an inorganic layer, an organic layer, or a composite material layer. In one or more embodiments, the base substrate BL may also not be provided.

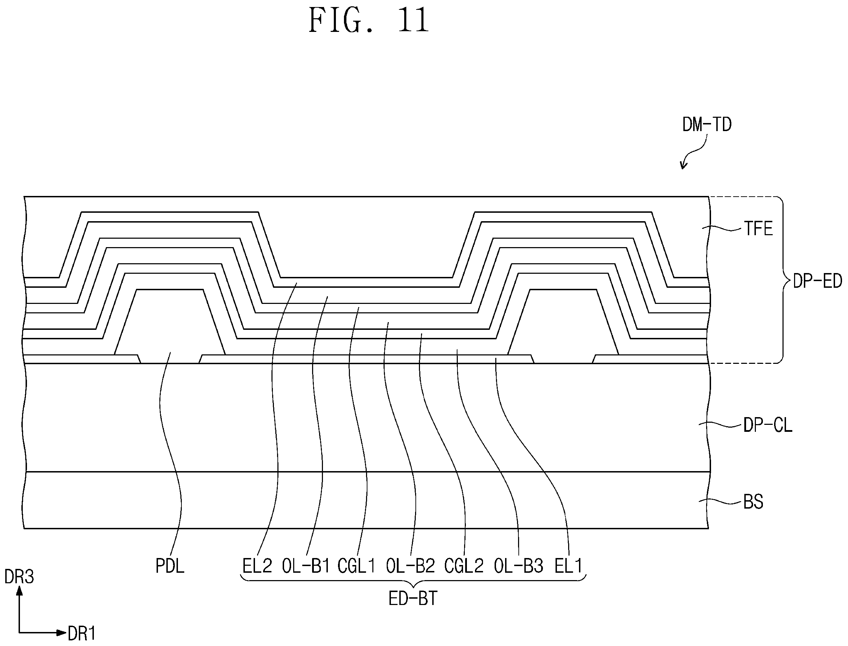

FIG. 11 is a cross-sectional view illustrating a portion of a display module according to one or more embodiments. In a display module DM-TD according to one or more embodiments, a light-emitting element ED-BT may include a plurality of emission structures OL-B1, OL-B2, and OL-B3. At least one selected from among the plurality of emission structures OL-B1, OL-B2, and OL-B3 may include the polycyclic compound according to one or more embodiments. Therefore, the light-emitting element ED-BT may exhibit long lifespan characteristics. In one or more embodiments, the light-emitting element ED-BT may exhibit long lifespan characteristics in an emission region of blue light.

The light-emitting element ED-BT may include a first electrode EL1, a second electrode EL2, opposite to (e.g., facing) each other, and a plurality of emission structures OL-B1, OL-B2, and OL-B3, stacked in sequence and provided in a thickness direction between the first electrode EL1 and the second electrode EL2. The emission structures OL-B1, OL-B2, and OL-B3 may each include a light emitting layer EML (FIG. 5), and a hole transport region HTR and an electron transport region ETR arranged with the light emitting layer EML (FIG. 8) therebetween. For example, the light-emitting element ED-BT included in the display module DM-TD according to one or more embodiments may be a light-emitting element having a tandem structure, which includes a plurality of light emitting layers.

In FIG. 11, light emitted from each of the emission structures OL-B1, OL-B2, and OL-B3 may be blue light. However, embodiments of the present disclosure are not limited thereto, and the emission structures OL-B1, OL-B2, and OL-B3 may be to emit light of different wavelength regions. For example, the light-emitting element ED-BT, which includes the plurality of emission structures OL-B1, OL-B2, and OL-B3, emitting light of different wavelength regions, may be to emit white light.

Charge-generating layers CGL1 and CGL2 may be arranged between the adjacent emission structures OL-B1, OL-B2, and OL-B3. In FIG. 11, the charge-generating layers CGL1 and CGL2 may include a first charge-generating layer CGL1 arranged between a first emission structure OL-B1 and a second emission structure OL-B2, and a second charge-generating layer CGL2 arranged between the second emission structure OL-B2 and a third emission structure OL-B3. The first and second charge-generating layers CGL1 and CGL2 may each independently include a positive type (kind) (p-type (kind)) charge-generating layer and/or a negative type (kind) (n-type (kind)) charge-generating layer.

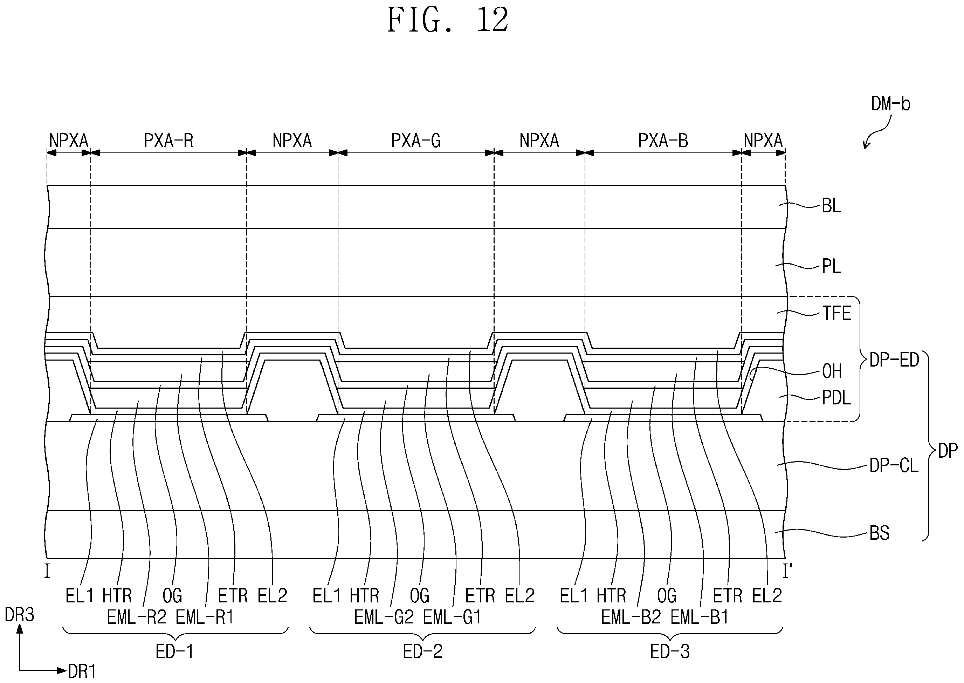

Referring to FIG. 12, a display module DM-b according to one or more embodiments may include light-emitting elements ED-1, ED-2, and ED-3 in which two light emitting layers are stacked. At least one selected from among the light-emitting elements ED-1, ED-2, and ED-3 may include the polycyclic compound according to one or more embodiments. Therefore, the light-emitting elements ED-1, ED-2, and ED-3 may exhibit long lifespan characteristics. In one or more embodiments, the light-emitting element ED-3 may exhibit long lifespan characteristics in an emission region of blue light.

The embodiment illustrated in FIG. 12 differs from the display module DM according to the embodiment illustrated in FIG. 3, in that the first to third light-emitting elements ED-1, ED-2, and ED-3 each include two light emitting layers stacked in a thickness direction. The two light emitting layers in each of the first to third light-emitting elements ED-1, ED-2, and ED-3 may be to emit light in substantially the same wavelength region.

The first light-emitting element ED-1 may include a first red light emitting layer EML-R1 and a second red light emitting layer EML-R2. The second light-emitting element ED-2 may include a first green light emitting layer EML-G1 and a second green light emitting layer EML-G2. In one or more embodiments, the third light-emitting element ED-3 may include a first blue light emitting layer EML-B1 and a second blue light emitting layer EML-B2. An auxiliary emission part OG may be arranged between the first red light emitting layer EML-R1 and the second red light emitting layer EML-R2, between the first green light emitting layer EML-G1 and the second green light emitting layer EML-G2, and between the first blue light emitting layer EML-B1 and the second blue light emitting layer EML-B2.

The auxiliary emission part OG may include a single layer or multi-layers. The auxiliary emission part OG may include a charge-generating layer. For example, the auxiliary emission part OG may include an electron transport region, a charge-generating layer, and a hole transport region, stacked in sequence. The auxiliary emission part OG may be provided as a common layer across all the first to third light-emitting elements ED-1, ED-2, and ED-3. However, embodiments of the present disclosure are not limited thereto, and the auxiliary emission part OG may be provided by being patterned in the opening OH defined by the pixel-defining film PDL.

The first red light emitting layer EML-R1, the first green light emitting layer EML-G1, and the first blue light emitting layer EML-B1 may be arranged between the auxiliary emission part OG and the electron transport region ETR. The second red light emitting layer EML-R2, the second green light emitting layer EML-G2, and the second blue light emitting layer EML-B2 may be arranged between the hole transport region HTR and the auxiliary emission part OG.

For example, the first light-emitting element ED-1 may include the first electrode EL1, the hole transport region HTR, the second red light emitting layer EML-R2, the auxiliary emission part OG, the first red light emitting layer EML-R1, the electron transport region ETR, and the second electrode EL2, stacked in sequence. The second light-emitting element ED-2 may include the first electrode EL1, the hole transport region HTR, the second green light emitting layer EML-G2, the auxiliary emission part OG, the first green light emitting layer EML-G1, the electron transport region ETR, and the second electrode EL2, stacked in sequence. The third light-emitting element ED-3 may include the first electrode EL1, the hole transport region HTR, the second blue light emitting layer EML-B2, the auxiliary emission part OG, the first blue light emitting layer EML-B1, the electron transport region ETR, and the second electrode EL2, stacked in sequence.

An auxiliary optical layer PL may be arranged on the display element layer DP-ED. The auxiliary optical layer PL may include a polarization layer. The auxiliary optical layer PL may be arranged on the display panel DP and may be to control reflected light caused by external light at the display panel DP. In one or more embodiments, the auxiliary optical layer PL may not be provided in the display device according to one or more embodiments.

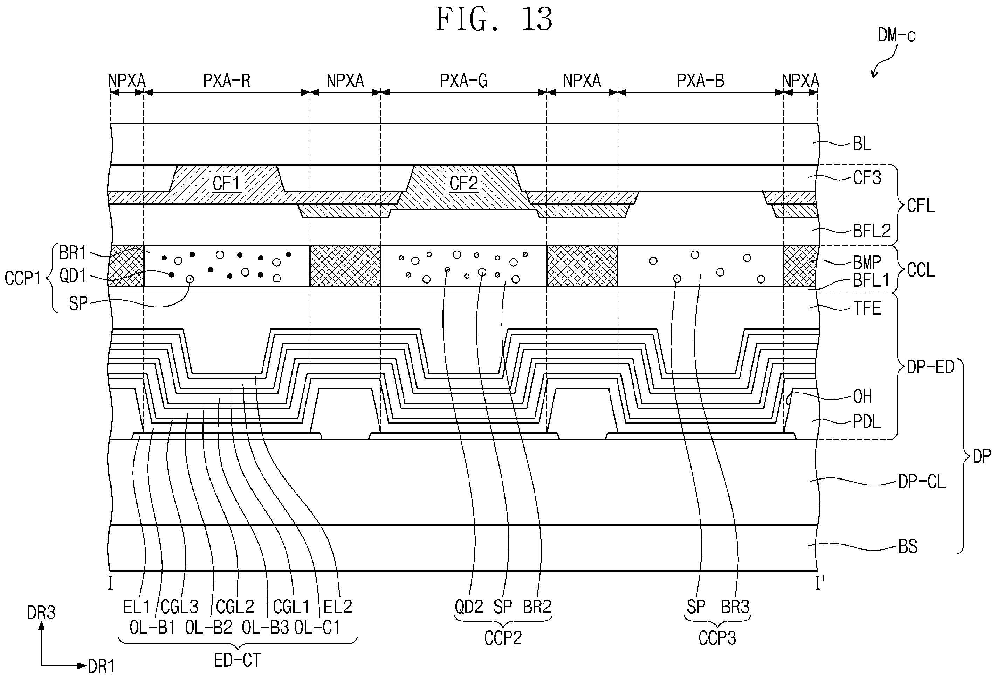

In one or more embodiments, FIG. 13 illustrates that a display module DM-c according to one or more embodiments includes four emission structures OL-B3, OL-B2, OL-B1, and OL-C1. The light-emitting element ED-CT may include a first electrode EL1 and a second electrode EL2, opposite to (e.g., facing) each other, and first to fourth emission structures OL-B1, OL-B2, OL-B3, and OL-C1, stacked in sequence in a thickness direction between the first electrode EL1 and the second electrode EL2. At least one selected from among the first to fourth emission structures OL-B1, OL-B2, OL-B3, and OL-C1 may include the polycyclic compound according to one or more embodiments. Therefore, the light-emitting element ED-CT may exhibit long lifespan characteristics. In one or more embodiments, the light-emitting element ED-CT may exhibit long lifespan characteristics in an emission region of blue light.

Charge-generating layers CGL3, CGL2, and CGL1 may be arranged between the first to fourth emission structures OL-B1, OL-B2, OL-B3, and OL-C1. The first to third emission structures OL-B1, OL-B2, and OL-B3 among the four emission structures may be to emit blue light, and the fourth emission structure OL-C1 may be to emit green light. However, embodiments of the present disclosure are not limited thereto, and the first to fourth emission structures OL-B1, OL-B2, OL-B3, and OL-C1 may be to emit light in different wavelength regions from each other. The charge-generating layers CGL3, CGL2, and CGL1 arranged between adjacent emission structures OL-B1, OL-B2, OL-B3, and OL-C1 may include a p-type (kind) charge-generating layer and/or an n-type (kind) charge-generating layer.

In one or more embodiments, the electronic apparatus may include a display device that includes a plurality of light-emitting elements, and a control part that controls the display device. In an electronic apparatus according to one or more embodiments, at least one selected from among the plurality of light-emitting elements may include the polycyclic compound according to one or more embodiments in the light emitting layer.

The electronic apparatus according to one or more embodiments may be activated in response to an electrical signal. The electronic apparatus according to one or more embodiments may include display devices which include the display module according to one or more embodiments, described with reference to FIG. 3, FIG. 10 to FIG. 13, and/or the like. For example, the electronic apparatus may not only include a large-size electronic apparatus, such as a television, a monitor, or an outdoor billboard, but also include a small- and medium-size electronic apparatus, such as a personal computer, a laptop computer, a personal digital assistant, a vehicular display device, a game console, a portable electronic apparatus, or a camera.

The electronic apparatus according to one or more embodiments may include the display module including the polycyclic compound according to one or more embodiments and thus may exhibit long lifespan characteristics. The electronic apparatus according to one or more embodiments may have improved or enhanced display efficiency and display lifespan and may exhibit excellent or suitable display quality.

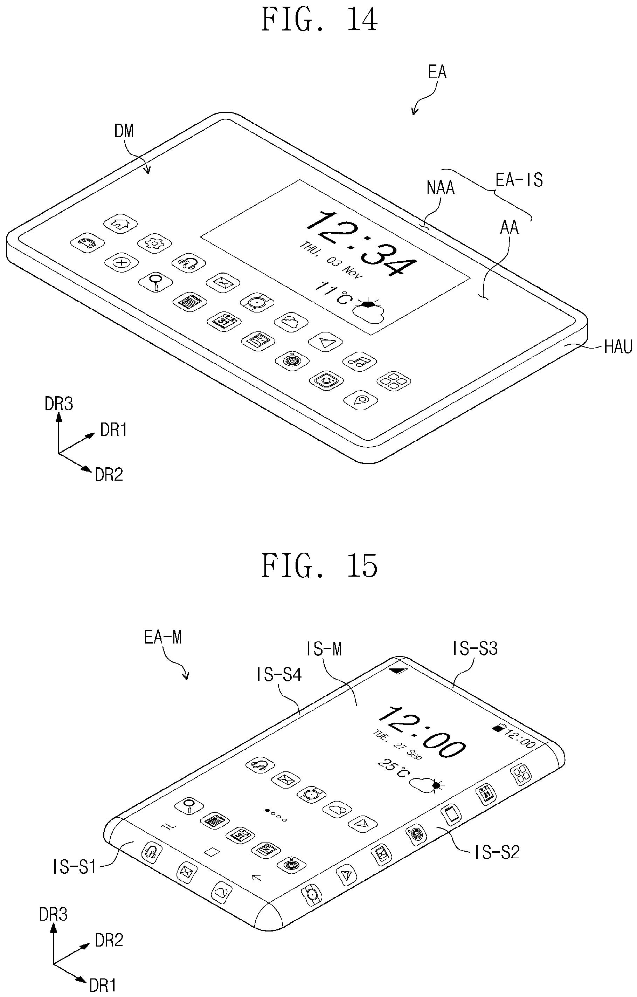

FIG. 14 illustrates a tablet computer as an example of the electronic apparatus EA. The electronic apparatus EA according to one or more embodiments may include a display module DM according to one or more embodiments. For example, electronic modules, a camera module, a power module, and/or the like, mounted on a main board, may be arranged in a bracket/housing HAU and/or the like, together with the display module DM to thereby configure the tablet computer.

The electronic apparatus EA according to one or more embodiments, illustrated in FIG. 14, may include the display module according to one or more embodiments, described with reference to FIG. 3, FIG. 10 to FIG. 13, and/or the like.

In one or more embodiments, the electronic apparatus EA including the display module DM, which includes a flat display surface, is illustrated, but embodiments of the present disclosure are not limited thereto. The electronic apparatus EA may also include a curved display surface or a three-dimensional display surface. For example, the three-dimensional display surface may include a plurality of display regions indicating different directions and may include a bent display surface. The electronic apparatus EA according to one or more embodiments may be a flexible electronic apparatus. The flexible electronic apparatus may be a foldable electronic apparatus capable of being folded.

As illustrated in FIG. 14, a display surface EA-IS may include an active region AA in which an image is displayed, and a bezel region NAA adjacent to the active region AA. The bezel region NAA may be a region where an image is not displayed. FIG. 14 illustrates icon images as examples of an image. The active region AA may be referred to as a display region of the display module DM, and the bezel region NAA may be referred to as a non-display region of the display module DM.

FIG. 15 illustrates a portable device as an example of an electronic apparatus EA-M according to one or more embodiments. Referring to FIG. 15, the electronic apparatus EA-M according to one or more embodiments may include a plurality of display surfaces. The electronic apparatus EA-M according to one or more embodiments may include display surfaces IS-M, IS-S1, IS-S2, IS-S3, and IS-S4 whose main display directions are different from each other.

In one or more embodiments, the electronic apparatus EA-M may be a three-dimensional display device which includes a top display surface IS-M, and a plurality of side display surfaces IS-S1, IS-S2, IS-S3, and IS-S4. The plurality of side display surfaces IS-S1, IS-S2, IS-S3, and IS-S4 may each be a display surface extended from one side of the top display surface IS-M. In one or more embodiments, the electronic apparatus EA-M may include a main display surface mainly providing an image in one direction, and a plurality of sub display surfaces providing an image in different directions from the one direction. In an embodiment of the electronic apparatus EA-M, illustrated in FIG. 15, the main display surface may be the top display surface IS-M, and the sub display surfaces may be the side display surfaces IS-S1, IS-S2, IS-S3, and IS-S4.

The side display surfaces IS-S1, IS-S2, IS-S3, and IS-S4 may have a display surface that is not substantially parallel to the top display surface IS-M. In one or more embodiments, the plurality of side display surfaces IS-S1, IS-S2, IS-S3, and IS-S4 may each be a display region bent and extended from one side of the top display surface IS-M, and, for example, the plurality of side display surfaces IS-S1, IS-S2, IS-S3, and IS-S4 may be bent display regions.

The electronic apparatus EA-M according to one or more embodiments, illustrated in FIG. 15, may include the display module according to one or more embodiments, described with reference to FIG. 3, FIG. 10 to FIG. 13, and/or the like.

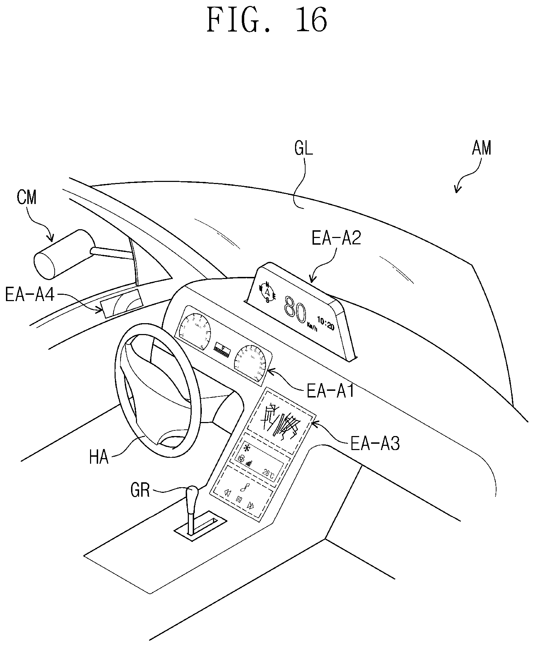

FIG. 16 is a view illustrating a vehicle AM in which first to fourth electronic apparatuses EA-1, EA-2, EA-3, and EA-4 are arranged. At least one selected from among the first to fourth electronic apparatuses EA-1, EA-2, EA-3, and EA-4 may include the display module according to one or more embodiments, described with reference to FIG. 3 and FIG. 10 to FIG. 13.

FIG. 16 illustrates a car as a vehicle AM, but this is an example, and the first to fourth electronic apparatuses EA-1, EA-2, EA-3, and EA-4 may also be arranged in other transportation, such as a bicycle, a motorcycle, a train, a ship, and a plane.

At least one selected from among the first to fourth electronic apparatuses EA-1, EA-2, EA-3, and EA-4 may include the light-emitting element ED according to one or more embodiments, described with reference to FIG. 5 to FIG. 9. At least one selected from among the first to fourth electronic apparatuses EA-1, EA-2, EA-3, and EA-4 may include the polycyclic compound according to one or more embodiments. Therefore, the first to fourth electronic apparatuses EA-1, EA-2, EA-3, and EA-4, including the polycyclic compound according to one or more embodiments, may have an improved or enhanced display lifespan. In one or more embodiments, the first to fourth electronic apparatuses EA-1, EA-2, EA-3, and EA-4, including the polycyclic compound according to one or more embodiments, may exhibit excellent or suitable display quality.

Referring to FIG. 16, the vehicle AM may include a handle HA and a gear GR to control operation and may include a front windshield GL arranged in front of a driver.

The first electronic apparatus EA-1 may be a digital cluster to display first information of the vehicle AM. The first information may include a first scale to indicate a traveling speed, a second scale to indicate revolutions per minute (RPM) of an engine, and an image indicating a fuel state, and/or the like. The first scale and the second scale may be represented as digital images. In one or more embodiments illustrated in FIG. 16, a first electronic apparatus EA-1 may be arranged in a first region overlapping the handle HA. However, embodiments of the present disclosure are not limited thereto, and the first electronic apparatus EA-1 may be arranged across an entire dashboard or may be separated and arranged in each of a portion opposite to (e.g., facing) a driver seat and a portion opposite to (e.g., facing) a passenger seat.

A second electronic apparatus EA-2 may be arranged in a second region between the driver seat and the front windshield GL. For example, the second electronic apparatus EA-2 may be a head up display (HUD) displaying second information of the vehicle AM. The second electronic apparatus EA-2 may be optically transparent (e.g., substantially transparent). The second information may include digital numerals representing a traveling speed of the vehicle AM and may further include information, such as a current time. In one or more embodiments, the second information of the second electronic apparatus EA-2 may also be projected onto and displayed on the front windshield GL. The display surface of the second electronic apparatus EA-2 may be opposite to (e.g., face) the driver's seat. In one or more embodiments, the second electronic apparatus EA-2 may be to provide an image to a direction of the front windshield GL.

A third electronic apparatus EA-3 may be arranged in a third region adjacent to the gear GR. For example, the third electronic apparatus EA-3 may be arranged between the driver's seat and the passenger's seat and may be a center information display (CID) for a vehicle. The passenger's seat may be a seat spaced and/or apart (e.g., spaced apart or separated) from the driver's seat with the gear GR therebetween. The third information may include information on road conditions (for example, navigation information), on playing music or radio, on playing a dynamic image (or image), on the temperature in the vehicle AM, and/or the like.

A fourth display apparatus EA-4 may be arranged in a fourth region spaced and/or apart (e.g., spaced apart or separated) from the handle HA and the gear GR and adjacent to a side of the vehicle AM. For example, the fourth electronic apparatus EA-4 may be a digital side mirror showing fourth information. The fourth electronic apparatus EA-4 may be to display an external image captured by a camera module CM arranged at the outside of the vehicle AM. The fourth information may include an external image of the vehicle AM.

The first to fourth information described herein are examples, and the first to fourth electronic apparatuses EA-1, EA-2, EA-3, and EA-4 may further display information on the inside and outside of the vehicle. The first to fourth information may include information different from each other. However, embodiments of the present disclosure are not limited thereto, and a portion of the first to fourth information may include substantially the same information.

FIG. 14 to FIG. 16 illustrate one or more embodiments of an electronic apparatus or one or more embodiments including the electronic apparatus as examples, and a display module including a light-emitting element that includes the polycyclic compound according to one or more embodiments may be employed in other suitable electronic apparatuses without departing from the scope of the present disclosure.

Hereinafter, with reference to Examples and Comparative Examples, the polycyclic compound according to one or more embodiments of the present disclosure and the light-emitting element according to one or more embodiments will be described in more detail. The examples provided herein are exemplified only to help the understanding of the present disclosure, and the scope of the present disclosure is not limited thereto.

### Examples

### 1. Synthesis of polycyclic compound

Synthetic methods of the polycyclic compounds according to the present disclosure will be described herein in more detail by exemplifying the synthetic methods of Compounds 1, 138, 335, 526, 689, and 1054. The synthetic methods of the polycyclic compounds described herein are examples, and the synthetic methods of the compound according to one or more embodiments of the present disclosure are not limited thereto.

In the Examples section, the molecular weight of each compound was determined from its mass-to-charge (m/z) ratio as measured by fast atom bombardment mass spectrometry (FAB-MS).

### (1) Synthesis of Compound 1

Polycyclic Compound 1 according to one example may be synthesized by, for example, the synthetic methods described in Reaction Scheme 1.

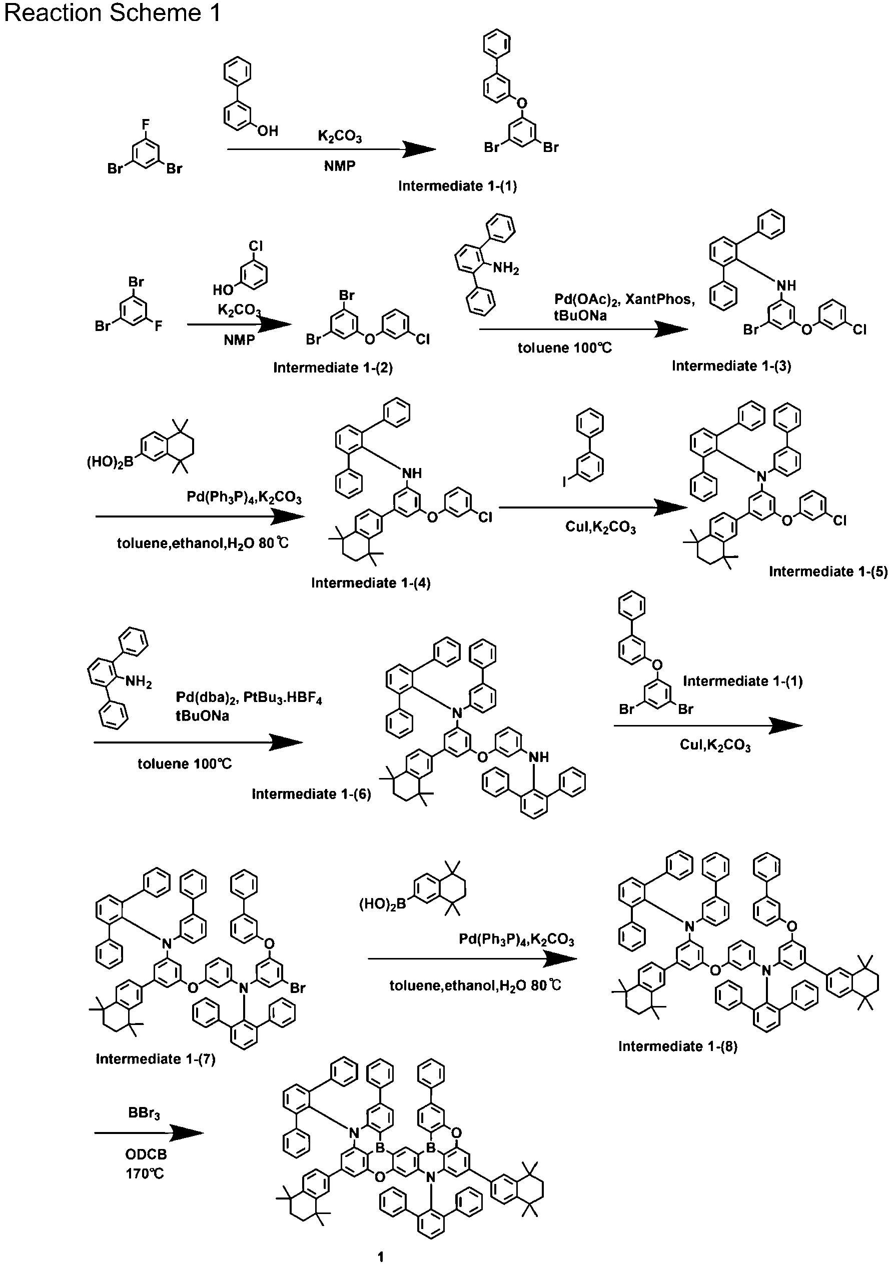

### Synthesis of Intermediate 1-(1)

Under an argon atmosphere, N-methyl-2-pyrrolidone (NMP) 250 mL was added to 1,3-dibromo-5-fluorobenzene (25.01 g, 98.5 mmol), [1,1'-biphenyl]-3-ol (20.12 g, 118.2 mmol), and K₂CO₃ (34.04 g, 246.26 mmol), followed by heating for about 24 hours while maintaining an external temperature at about 140 °C. The reaction mixture was diluted with CH₂Cl₂, and water was added thereto. The resultant mixture was filtered through Celite and extracted, and an organic layer was then concentrated. Purification by silica gel column chromatography was performed to obtain Intermediate 1-(1) (33.04 g, yield of 83%). A molecular weight of Intermediate 1-(1) was 404, as measured by FAB-MS.

### Synthesis of Intermediate 1-(2)

Under an argon atmosphere, NMP 251 mL was added to 1,3-dibromo-5-fluorobenzene (25.11 g, 98.9 mmol), 3-chlorophenol (16.53 g, 128.57 mmol), and K₂CO₃ (34.17 g, 247.24 mmol), followed by heating for about 24 hours while maintaining an external temperature at about 140 °C. The reaction mixture was diluted with CH₂Cl₂, and water was added thereto. The resultant mixture was filtered through Celite and extracted, and an organic layer was then concentrated. Purification by silica gel column chromatography was performed to obtain Intermediate 1-(2) (27.96 g, yield of 78%). A molecular weight of Intermediate 1-(2) was 362, as measured by FAB-MS.

### Synthesis of Intermediate 1-(3)

Under an argon atmosphere, Intermediate 1-(2) (13.55 g, 37.38 mmol), [1,1':3',1"-terphenyl]-2'-amine(9.17 g, 37.38 mmol), Pd(OAc)₂ (0.25 g, 1.12 mmol), XantPhos (1.3 g, 2.24 mmol), and tBuONa (4.31 g, 44.86 mmol) were added to toluene (186 mL), followed by heating and stirring at about 100 °C for about 8 hours. Water was added, the resultant mixture was filtered through Celite and extracted, and an organic layer was concentrated. Purification by silica gel column chromatography was performed to obtain Intermediate 1-(3) (16.54 g, yield of 84%). A molecular weight of Intermediate 1-(3) was 527, as measured by FAB-MS.

### Synthesis of Intermediate 1-(4)

Under an argon atmosphere, toluene (127.84 mL) and a 1:1 mixture (63.92 mL) of EtOH and water were added to Intermediate 1-(3) (15.98 g, 30.33 mmol), (5,5,8,8-tetramethyl-5,6,7,8-tetrahydronaphthalen-2-yl)boronic acid (16.19 g, 69.76 mmol), K₂CO₃ (25.15 g, 181.98 mmol), and Pd(Ph₃P)₄ (5.43 g, 4.7 mmol), followed by heating for about 24 hours while maintaining an external temperature at about 80 °C. The resultant mixture was filtered through Celite and extracted, and an organic layer was concentrated. Purification by silica gel column chromatography was performed to obtain Intermediate 1-(4) (13.08 g, yield of 68%). A molecular weight of Intermediate 1-(4) was 634, as measured by FAB-MS.

### Synthesis of Intermediate 1-(5)

Toluene (about 10 mL) was added to Intermediate 1-(4) (12.88 g, 20.31 mmol), 3-iodo-1,1'-biphenyl (45.51 g, 162.46 mmol), Cul (9.67 g, 50.77 mmol), and K₂CO₃ (42.1 g, 304.61 mmol), followed by heating for about 24 hours while maintaining an external temperature at about 215 °C. The reaction mixture was diluted with CH₂Cl₂, and water was added thereto. The mixture was filtered through Celite and extracted, and an organic layer was then concentrated. Purification by silica gel column chromatography was performed to obtain Intermediate 1-(5) (10.38 g, yield of 65%). A molecular weight of Intermediate 1-(5) was 786, as measured by FAB-MS.

### Synthesis of Intermediate 1-(6)

Under an argon atmosphere, Intermediate 1-(5) (10.22 g, 12.99 mmol), [1,1':3',1"-terphenyl]-2'-amine (3.35 g, 13.64 mmol), Pd(dba)2 (0.75 g, 1.3 mmol), P(tBu)₃·HBF₄(0.75 g, 2.6 mmol), and tBuONa (2.87 g, 29.89 mmol) were added to toluene (64 mL), followed by heating and stirring at about 100 °C for about 8 hours. Water was added, the resultant mixture was filtered through Celite and extracted, and an organic layer was then concentrated. Purification by silica gel column chromatography was performed to obtain Intermediate 1-(6) (11.12 g, yield of 86%). A molecular weight of Intermediate 1-(6) was 995, as measured by FAB-MS.

### Synthesis of Intermediate 1-(7)

Toluene (about 10 mL) was added to Intermediate 1-(6) (10.84 g, 10.89 mmol), Intermediate 1-(1) (35.21 g, 87.13 mmol), Cul (5.19 g, 27.23 mmol), and K₂CO₃ (22.58 g, 163.36 mmol), followed by heating for about 24 hours while maintaining an external temperature at about 215 °C. The reaction mixture was diluted with CH₂Cl₂, and water was added thereto. The mixture was filtered through Celite and extracted, and the organic layer was then concentrated. Purification by silica gel column chromatography was performed to obtain Intermediate 1-(7) (6.46 g, yield of 45%). A molecular weight of Intermediate 1-(7) was 1319, as measured by FAB-MS.

### Synthesis of Intermediate 1-(8)

Under an argon atmosphere, toluene (49.76 mL) and a 1:1 mixture (24.88 mL) of EtOH and water were added to Intermediate 1-(7) (6.22 g, 4.72 mmol), (5,5,8,8-tetramethyl-5,6,7,8-tetrahydronaphthalen-2-yl)boronic acid (2.52 g, 10.85 mmol), K₂CO₃ (3.91 g, 28.3 mmol), and Pd(Ph₃P)₄ (0.84 g, 0.73 mmol), followed by heating for about 24 hours while maintaining an external temperature at about 80 °C. The resultant mixture was filtered through Celite and extracted, and the organic layer was then concentrated. Purification by silica gel column chromatography was performed to obtain Intermediate 1-(8) (4.37 g, yield of 65%). A molecular weight of Intermediate 1-(8) was 1426, as measured by FAB-MS.

### Synthesis of Compound 1

Under an argon atmosphere, Intermediate 1-(8) (4.05 g, 2.84 mmol) was dissolved in ortho-dichlorobenzene (ODCB) (28 mL), and BBr₃ (2.85 g, 11.36 mmol) was added, followed by heating and stirring at about 170 °C for about 10 hours. After cooling to a room temperature, N,N-diisopropylethylamine (DIPEA) (4.4 g, 34.08 mmol) and water were added. The resultant mixture was filtered through Celite and extracted, and then an organic layer was concentrated. Purification by silica gel column chromatography was performed to obtain Compound 1 (1.15 g, yield of 28%). A molecular weight of Compound 1, as measured by FAB-MS, was 1441.

The obtained Compound 1 was purified by sublimination (380 °C, 2.5 x 10⁻³ Pa) and was used in element evaluation.

### (2) Synthesis of Compound 138

Polycyclic Compound 138 according to one example may be synthesized by, for example, the synthetic methods described in Reaction Scheme 2.

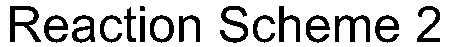

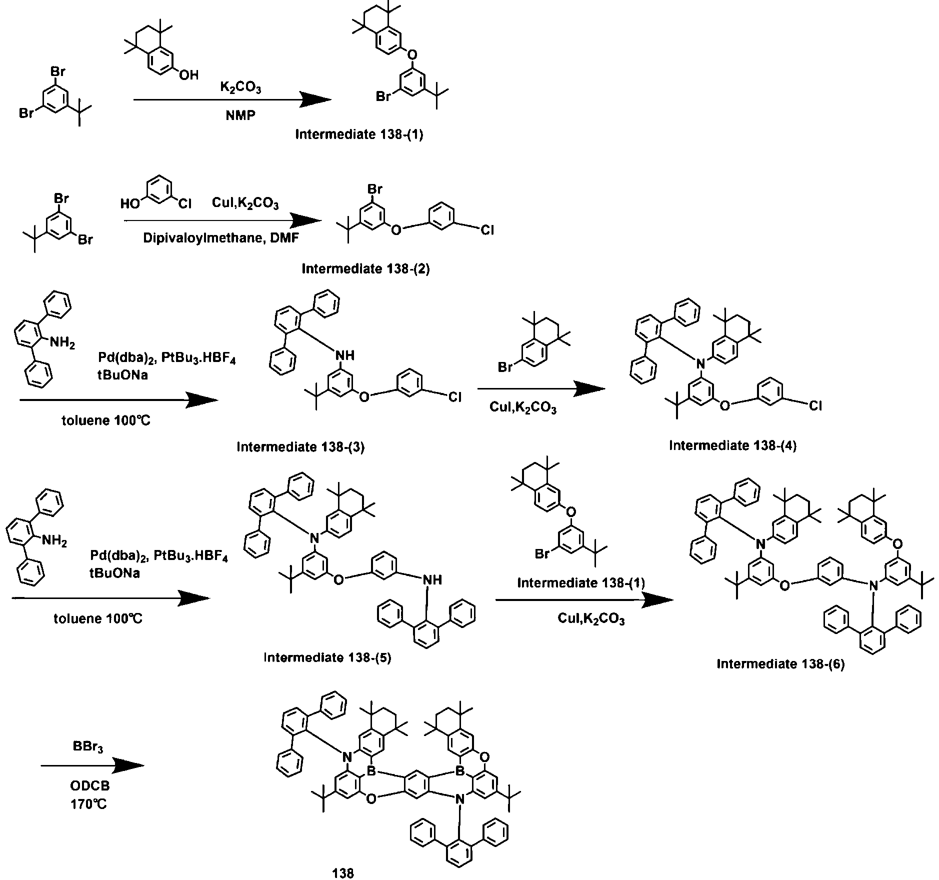

### Synthesis of Intermediate 138-(1)

NMP (1079 mL) was added to 1,3-dibromo-5-(tert-butyl)benzene (15.04 g, 51.51 mmol), 5,5,8,8-tetramethyl-5,6,7,8-tetrahydronaphthalen-2-ol (10.52 g, 51.51 mmol), and K₂CO₃ (28.47 g, 206.02 mmol), followed by heating for about 24 hours while maintaining an external temperature at about 100 °C. Thereafter, the reaction mixture was diluted with CH₂Cl₂, and water was added thereto. The resultant mixture was filtered through Celite and extracted, and an organic layer was then concentrated. Purification by silica gel column chromatography was performed to obtain Intermediate 138-(1) (17.33 g, yield of 81%). A molecular weight of Intermediate 138-(1) was 415, as measured by FAB-MS.

### Synthesis of Intermediate 138-(2)

1,3-Dibromo-5-(tert-butyl)benzene (15.15 g, 51.88 mmol), 3-chlorophenol (6.67 g, 51.88 mmol), Cul (10.87 g, 57.07 mmol), K₂CO₃ (28.68 g, 207.53 mmol), and dipivaloylmethane (108.69 g, 0.59 mmol) were added to DMF (1086 mL), followed by heating for about 24 hours while maintaining an external temperature at about 100 °C. Thereafter, the reaction mixture was diluted with CH₂Cl₂, and water was added thereto. The resultant mixture was filtered through Celite and extracted, and an organic layer was then concentrated. Purification by silica gel column chromatography was performed to obtain Intermediate 138-(2) (14.80 g, yield of 84%). A molecular weight of Intermediate 138-(2) was 340, as measured by FAB-MS.

### Synthesis of Intermediate 138-(3)

Under an argon atmosphere, Intermediate 138-(2) (14.62 g, 43.04 mmol), [1,1':3',1"-terphenyl]-2'-amine (11.09 g, 45.2 mmol), Pd(dba)₂ (2.48 g, 4.3 mmol), P(tBu)₃·HBF₄ (2.5 g, 8.61 mmol), and tBuONa (9.51 g, 99 mmol) were added to toluene (215 mL), followed by heating and stirring for about 8 hours at about 100 °C. Thereafter, water was added, the resultant mixture was filtered through Celite and extracted, and an organic layer was then concentrated. Purification by silica gel column chromatography was performed to obtain Intermediate 138-(3) (17.79 g, yield of 82%). A molecular weight of Intermediate 138-(3) was 504, as measured by FAB-MS.

### Synthesis of Intermediate 138-(4)

A small amount of toluene (about 10 mL) was added to Intermediate 138-(3) (10.21 g, 20.26 mmol), 6-bromo-1,1,4,4-tetramethyl-1,2,3,4-tetrahydronaphthalene (43.3 g, 162.04 mmol), Cul (9.64 g, 50.64 mmol), and K₂CO₃ (41.99 g, 303.83 mmol), followed by heating for about 24 hours while maintaining an external temperature at about 215 °C. Thereafter, the reaction mixture was diluted with CH₂Cl₂, and water was added thereto. The resultant mixture was filtered through Celite and extracted, and an organic layer was then concentrated. Purification by silica gel column chromatography was performed to obtain Intermediate 138-(4) (10.91 g, yield of 78%). A molecular weight of Intermediate 138-(4) was 690, as measured by FAB-MS.

### Synthesis of Intermediate 138-(5)

Under an argon atmosphere, Intermediate 138-(4) (10.58 g, 15.33 mmol), [1,1':3',1"-terphenyl]-2'-amine (3.95 g, 16.09 mmol), Pd(dba)₂ (0.88 g, 1.53 mmol), P(tBu)₃·HBF₄ (0.89 g, 3.07 mmol), and tBuONa (3.39 g, 35.25 mmol) were added to toluene (76 mL), followed by heating and stirring at about 100 °C for about 8 hours. Thereafter, water was added, the resultant mixture was filtered through Celite and extracted, and an organic layer was then concentrated. Purification by silica gel column chromatography was performed to obtain Intermediate 138-(5) (11.85 g, yield of 86%). A molecular weight of Intermediate 138-(5) was 899, as measured by FAB-MS.

### Synthesis of Intermediate 138-(6)

A small amount of toluene (about 10 mL) was added to Intermediate 138-(5) (4.35 g, 4.84 mmol), Intermediate 138-(1) (16.08 g, 38.7 mmol), Cul (2.3 g, 12.09 mmol), and K₂CO₃ (10.03 g, 72.56 mmol), followed by heating for about 24 hours while maintaining an external temperature at about 215 °C. Thereafter, the reaction mixture was diluted with CH₂Cl₂, and water was added thereto. The resultant mixture was filtered through Celite and extracted, and an organic layer was then concentrated. Purification by silica gel column chromatography was performed to obtain Intermediate 138-(6) (4.42 g, yield of 74%). A molecular weight of Intermediate 138-(6) was 1234, as measured by FAB-MS.

### Synthesis of Compound 138

Under an argon atmosphere, Intermediate 138-(6) (4.35 g, 3.53 mmol) was dissolved in ODCB (35 mL), and BBr₃ (3.53 g, 14.1 mmol) was added, followed by heating and stirring at about 170 °C for about 10 hours. After cooling to a room temperature, DIPEA (5.46 g, 42.31 mmol) and water were added. The resultant mixture was filtered through Celite and extracted, and then an organic layer was concentrated. Purification by silica gel column chromatography was performed to obtain Compound 138 (1.5 g, yield of 34%). A molecular weight of Compound 138, as measured by FAB-MS, was 1249.

The obtained Compound 138 was purified by sublimination (340 °C, 2.5x10⁻³ Pa) and used in element evaluation.

### (3) Synthesis of Compound 335

Polycyclic Compound 335 according to one example may be synthesized by, for example, the synthetic methods described in Reaction Scheme 3.

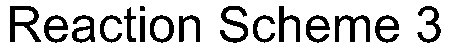

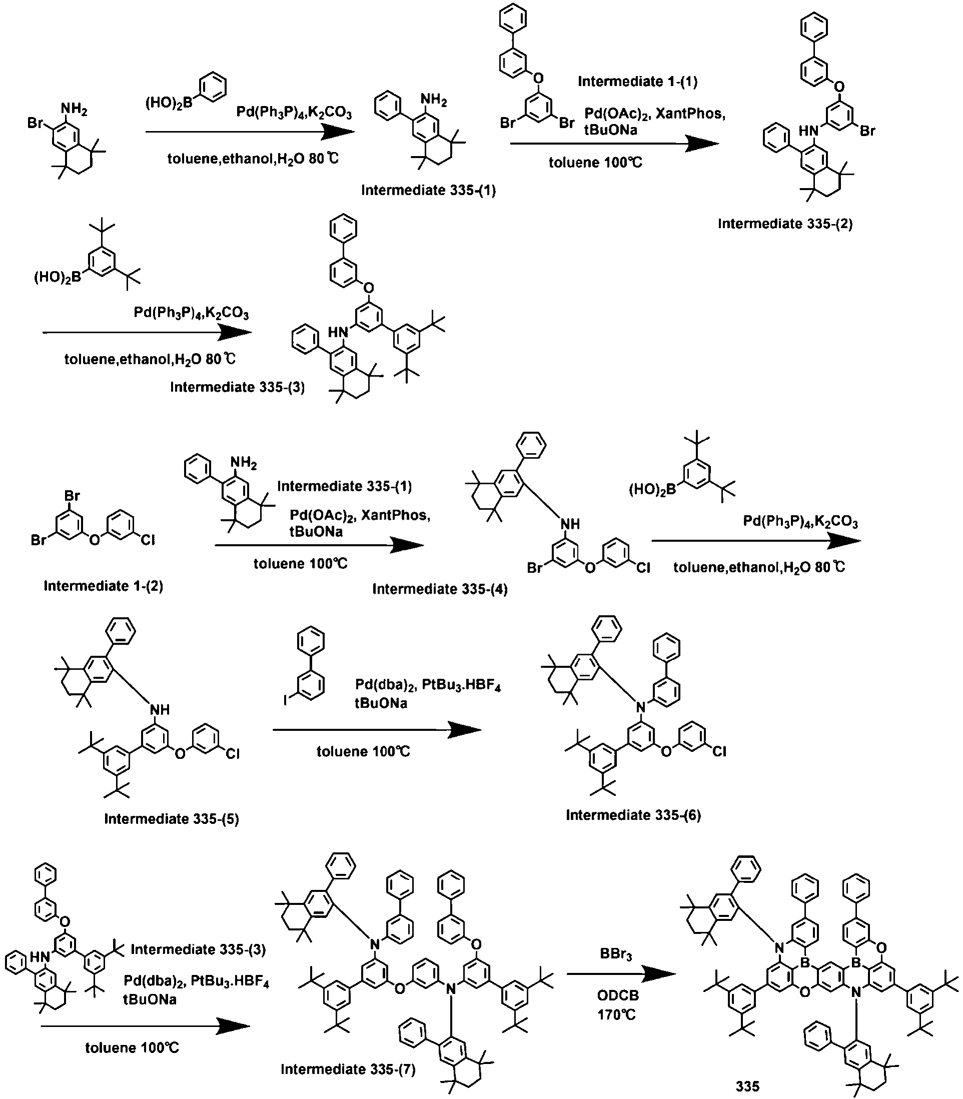

### Synthesis of Intermediate 335-(1)

Under an argon atmosphere, toluene (80.16 mL) and a 1:1 mixture (40.08 mL) of EtOH and water were added to 3-bromo-5,5,8,8-tetramethyl-5,6,7,8-tetrahydronaphthalen-2-amine (10.02 g, 35.5 mmol), phenylboronic acid (9.96 g, 81.66 mmol), K₂CO₃ (29.44 g, 213.02 mmol), and Pd(Ph₃P)₄ (6.36 g, 5.5 mmol), followed by heating for about 24 hours while maintaining an external temperature at about 80 °C. The resultant mixture was filtered through Celite and extracted, and an organic layer was then concentrated. Purification by silica gel column chromatography was performed to obtain Intermediate 335-(1) (8.73 g, yield of 88%). A molecular weight of Intermediate 335-(1) was 279, as measured by FAB-MS.

### Synthesis of Intermediate 335-(2)

Under an argon atmosphere, Intermediate 335-(1) (7.78 g, 27.84 mmol), Intermediate 1-(1) (11.25 g, 27.84 mmol), Pd(OAc)₂ (0.19 g, 0.84 mmol), XantPhos (0.97 g, 1.67 mmol), and tBuONa (3.21 g, 33.41 mmol) were added to toluene (139 mL), followed by heating and stirring at about 100 °C for about 8 hours. Thereafter, water was added, the resultant mixture was filtered through Celite and extracted, and an organic layer was then concentrated. Purification by silica gel column chromatography was performed to obtain Intermediate 335-(2) (14.09 g, yield of 84%). A molecular weight of Intermediate 335-(2) was 603, as measured by FAB-MS.

### Synthesis of Intermediate 335-(3)

Under an argon atmosphere, toluene (55.84 mL) and a 1:1 mixture (27.92 mL) of EtOH and water were added to Intermediate 335-(2) (6.98 g, 11.58 mmol), (3,5-di-tert-butylphenyl)boronic acid (6.24 g, 26.64 mmol), K₂CO₃ (9.61 g, 69.5 mmol), and Pd(Ph₃P)₄ (2.07 g, 1.8 mmol), followed by heating for about 24 hours while maintaining an external temperature at about 80 °C. The resultant mixture was filtered through Celite and extracted, and the organic layer was then concentrated. Purification by silica gel column chromatography was performed to obtain Intermediate 335-(3) (6.1 g, yield of 74%). A molecular weight of Intermediate 335-(3) was 712, as measured by FAB-MS.

### Synthesis of Intermediate 335-(4)

Under an argon atmosphere, Intermediate 1-(2) (7.66 g, 21.13 mmol), Intermediate 335-(1) (5.91 g, 21.13 mmol), Pd(OAc)₂ (0.14 g, 0.63 mmol), XantPhos (0.73 g, 1.27 mmol), and tBuONa (2.44 g, 25.36 mmol) were added to toluene (105 mL), followed by heating and stirring at about 100 °C for about 8 hours. Thereafter, water was added, the resultant mixture was filtered through Celite and extracted, and an organic layer was then concentrated. Purification by silica gel column chromatography was performed to obtain Intermediate 335-(4) (9.60 g, yield of 81%). A molecular weight of Intermediate 335-(4) was 561, as measured by FAB-MS.

### Synthesis of Intermediate 335-(5)

Under an argon atmosphere, toluene (76.4 mL) and a 1:1 mixture (38.2 mL) of EtOH and water were added to Intermediate 335-(4) (9.55 g, 15.85 mmol), (3,5-di-tert-butylphenyl)boronic acid (8.53 g, 36.45 mmol), K₂CO₃ (13.14 g, 95.08 mmol), and Pd(Ph₃P)₄ (2.84 g, 2.46 mmol), followed by heating for about 24 hours while maintaining an external temperature at about 80 °C. Thereafter, the resultant mixture was filtered through Celite and extracted, and an organic layer was then concentrated. Purification by silica gel column chromatography was performed to obtain Intermediate 335-(5) (7.65 g, yield of 72%). A molecular weight of Intermediate 335-(5) was 670, as measured by FAB-MS.

### Synthesis of Intermediate 335-(6)

Under an argon atmosphere, Intermediate 335-(5) (7.33 g, 10.93 mmol), 3-iodo-1,1'-biphenyl (3.22 g, 11.48 mmol), Pd(dba)₂ (0.63 g, 1.09 mmol), P(tBu)₃·HBF₄ (0.63 g, 2.19 mmol), and tBuONa (2.42 g, 25.15 mmol) were added to toluene (54 mL), followed by heating and stirring for about 8 hours at about 100 °C. Thereafter, water was added, the resultant mixture was filtered through Celite and extracted, and an organic layer was then concentrated. Purification by silica gel column chromatography was performed to obtain Intermediate 335-(6) (8.00 g, yield of 89%). A molecular weight of Intermediate 335-(6) was 823, as measured by FAB-MS.

### Synthesis of Intermediate 335-(7)

Under an argon atmosphere, Intermediate 335-(6) (5.11 g, 7.62 mmol), Intermediate 335-(3) (5.7 g, 8 mmol), Pd(dba)₂ (0.44 g, 0.76 mmol), P(tBu)₃·HBF₄ (0.44 g, 1.52 mmol), and tBuONa (1.68 g, 17.53 mmol) were added to toluene (38 mL), followed by heating and stirring for about 8 hours at about 100 °C. Thereafter, water was added, the resultant mixture was filtered through Celite and extracted, and an organic layer was then concentrated. Purification by silica gel column chromatography was performed to obtain Intermediate 335-(7) (8.68 g, yield of 76%). A molecular weight of Intermediate 335-(7) was 1498, as measured by FAB-MS.

### Synthesis of Compound 335

Under an argon atmosphere, Intermediate 335-(7) (4.35 g, 3.53 mmol) was dissolved in ODCB (35 mL), and BBr₃ (3.53 g, 14.1 mmol) was added, followed by heating and stirring at about 170 °C for about 10 hours. After cooling to a room temperature, DIPEA (5.46 g, 42.31 mmol) and water were added. The resultant mixture was filtered through Celite and extracted, and then an organic layer was concentrated. Purification by silica gel column chromatography was performed to obtain Compound 335 (1.65 g, yield of 31%). A molecular weight of Compound 335, as measured by FAB-MS, was 1514.

The obtained Compound 335 was purified by sublimination (370 °C, 2.4x10⁻³ Pa) and used in element evaluation.

### (4) Synthesis of Compound 526

Polycyclic Compound 526 according to one example may be synthesized by, for example, the synthetic methods described in Reaction Scheme 4.

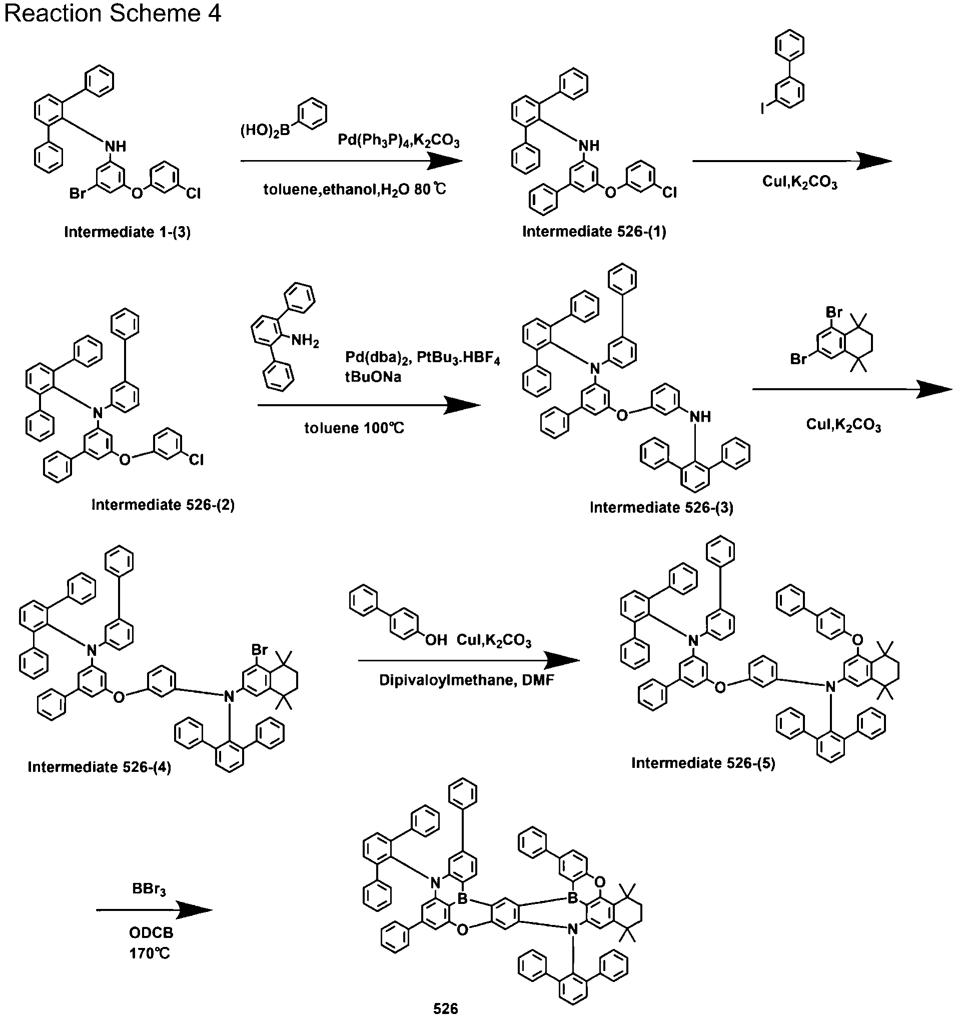

### Synthesis of Intermediate 526-(1)

Under an argon atmosphere, toluene (68.24 mL) and a 1:1 mixture (34.12 mL) of EtOH and water were added to Intermediate 1-(3) (8.53 g, 16.19 mmol), phenylboronic acid (4.54 g, 37.24 mmol), K₂CO₃ (13.43 g, 97.14 mmol), and Pd(Ph₃P)₄ (2.9 g, 2.51 mmol), followed by heating for about 24 hours while maintaining an external temperature at about 80 °C. Thereafter, the resultant mixture was filtered through Celite and extracted, and an organic layer was then concentrated. Purification by silica gel column chromatography was performed to obtain Intermediate 526-(1) (6.36 g, yield of 75%). A molecular weight of Intermediate 526-(1) was 524, as measured by FAB-MS.

### Synthesis of Intermediate 526-(2)

A small amount of toluene (about 10 mL) was added to Intermediate 526-(1) (6.28 g, 11.98 mmol), 3-iodo-1,1'-biphenyl (26.85 g, 95.87 mmol), Cul (5.71 g, 29.96 mmol), and K₂CO₃ (24.84 g, 179.75 mmol), followed by heating for about 24 hours while maintaining an external temperature at about 215 °C. The reaction mixture was diluted with CH₂Cl₂, and water was added thereto. The resultant mixture was filtered through Celite and extracted, and an organic layer was then concentrated. Purification by silica gel column chromatography was performed to obtain Intermediate 526-(2) (5.51 g, yield of 68%). A molecular weight of Intermediate 526-(2) was 676, as measured by FAB-MS.

### Synthesis of Intermediate 526-(3)

Under an argon atmosphere, Intermediate 526-(2) (5.42 g, 8.01 mmol), [1,1':3',1"-terphenyl]-2'-amine (2.06 g, 8.42 mmol), Pd(dba)₂ (0.46 g, 0.8 mmol), P(tBu)₃·HBF₄ (0.47 g, 1.6 mmol), and tBuONa (1.77 g, 18.43 mmol) were added to toluene (40 mL), followed by heating and stirring for about 8 hours at about 100 °C. Thereafter, water was added, the resultant mixture was filtered through Celite and extracted, and an organic layer was then concentrated. Purification by silica gel column chromatography was performed to obtain Intermediate 526-(3) (6.1 g, yield of 86%). A molecular weight of Intermediate 526-(3) was 885, as measured by FAB-MS.

### Synthesis of Intermediate 526-(4)

A small amount of toluene (about 10 mL) was added to Intermediate 526-(3) (6.28 g, 7.1 mmol), 5,7-dibromo-1,1,4,4-tetramethyl-1,2,3,4-tetrahydronaphthalene (19.65 g, 56.76 mmol), Cul (3.38 g, 17.74 mmol), and K₂CO₃ (14.71 g, 106.43 mmol), followed by heating for about 24 hours while maintaining an external temperature at about 215 °C. Thereafter, the reaction mixture was diluted with CH₂Cl₂, and water was added thereto. The resultant mixture was filtered through Celite and extracted, and an organic layer was then concentrated. Purification by silica gel column chromatography was performed to obtain Intermediate 526-(4) (2.53 g, yield of 31%). A molecular weight of Intermediate 526-(4) was 1150, as measured by FAB-MS.

### Synthesis of Intermediate 526-(5)

Intermediate 526-(4) (2.44 g, 2.12 mmol), [1,1'-biphenyl]-4-ol (0.36 g, 2.12 mmol), Cul (0.44 g, 2.33 mmol), K₂CO₃ (1.17 g, 8.48 mmol), and dipivaloylmethane (4.44 g, 0.02 mmol) were added to DMF (44 mL), followed by heating for about 24 hours while maintaining an external temperature at about 100 °C. The reaction mixture was diluted with CH₂Cl₂, and water was added thereto. The resultant mixture was filtered through Celite and extracted, and an organic layer was then concentrated. Purification by silica gel column chromatography was performed to obtain Intermediate 526-(5) (2.13 g, yield of 81%). A molecular weight of Intermediate 526-(5) was 1240, as measured by FAB-MS.

### Synthesis of Compound 526

Under an argon atmosphere, Intermediate 526-(5) (2.00 g, 1.61 mmol) was dissolved in ODCB (16 mL), and BBr₃ (1.62 g, 6.45 mmol) was added, followed by heating and stirring at about 170 °C for about 10 hours. After cooling to a room temperature, DIPEA (2.5 g, 19.36 mmol) and water were added. The resultant mixture was filtered through Celite and extracted, and then an organic layer was concentrated. Purification by silica gel column chromatography was performed to obtain Compound 526 (0.91 g, yield of 45%). A molecular weight of Compound 526, as measured by FAB-MS, was 1255.

The obtained Compound 526 was purified by sublimination (360 °C, 2.2x10⁻³ Pa) and used in element evaluation.

### (5) Synthesis of Compound 699

Polycyclic Compound 669 according to one example may be synthesized by, for example, the synthetic methods described in Reaction Scheme 5.

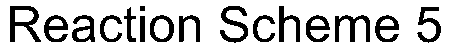

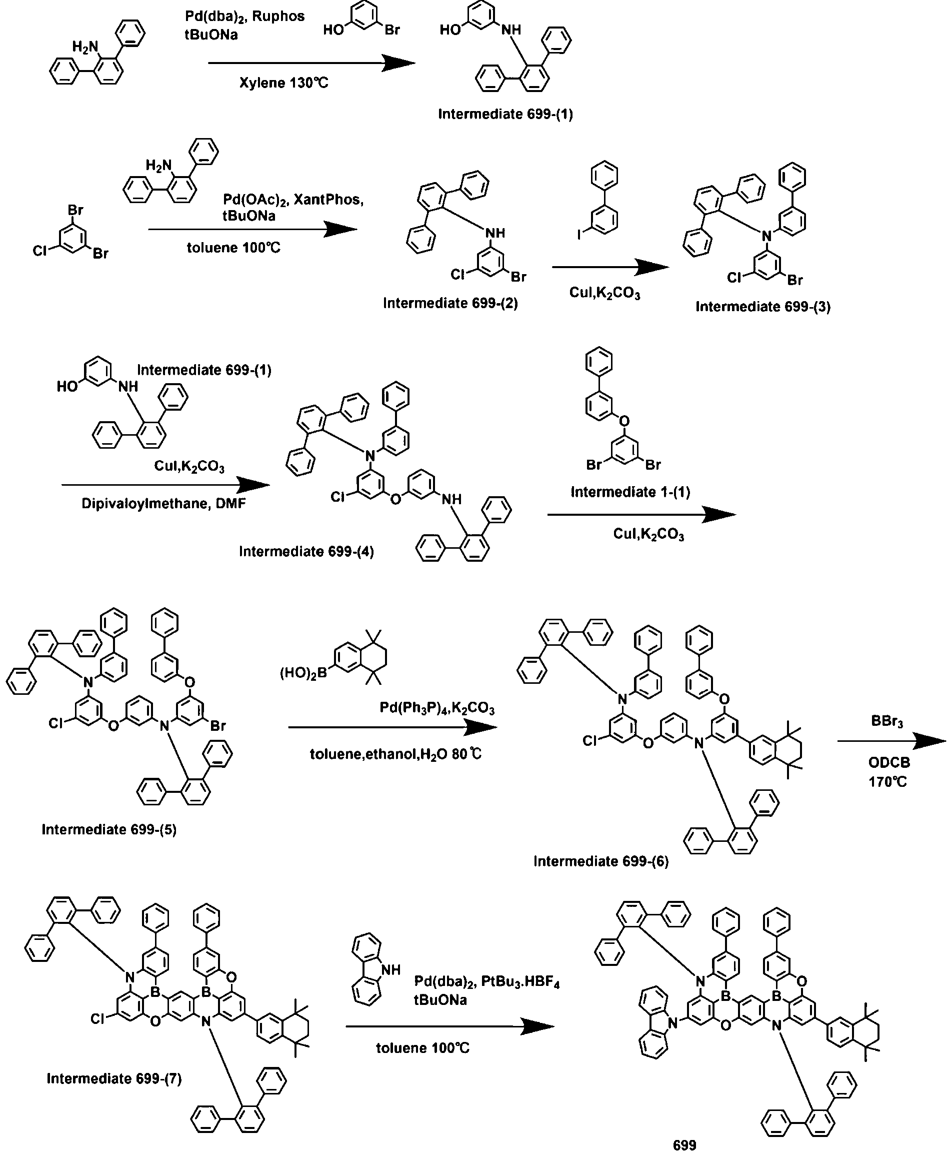

### Synthesis of Intermediate 699-(1)

Under an argon atmosphere, [1,1':3',1"-terphenyl]-2'-amine (15.02 g, 61.22 mmol), 3-bromophenol (12.71 g, 73.47 mmol), Pd(dba)2 (3.52 g, 6.12 mmol), Ruphos (5.63 g, 12.24 mmol), and tBuONa (13.53 g, 140.81 mmol) were added to xylene (306 mL), followed by heating and stirring at about 130 °C for about 24 hours. Thereafter, water was added, and the mixture was filtered through Celite. The filtrate was acidified with hydrochloric acid, neutralized to basic by adding aqueous NaHCO₃, and then extracted, and an organic layer was concentrated. Purification by silica gel column chromatography was performed to obtain Intermediate 699-(1) (13.43 g, yield of 65%). A molecular weight of Intermediate 699-(1) was 337, as measured by FAB-MS.

### Synthesis of Intermediate 699-(2)

Under an argon atmosphere, 1,3-dibromo-5-chlorobenzene (15.03 g, 55.59 mmol), [1,1':3',1"-terphenyl]-2'-amine (13.64 g, 55.59 mmol), Pd(OAc)₂ (0.37 g, 1.67 mmol), XantPhos (1.93 g, 3.34 mmol), and tBuONa (6.41 g, 66.71 mmol) were added to toluene (277 mL), followed by heating and stirring at about 100 °C for about 8 hours. Thereafter, water was added, the resultant mixture was filtered through Celite and extracted, and an organic layer was then concentrated. Purification by silica gel column chromatography was performed to obtain Intermediate 699-(2) (19.58 g, yield of 81%). A molecular weight of Intermediate 699-(2) was 435, as measured by FAB-MS.

### Synthesis of Intermediate 699-(3)

A small amount of toluene (about 10 mL) was added to Intermediate 699-(2) (10.14 g, 23.32 mmol), 3-iodo-1,1'-biphenyl (52.26 g, 186.59 mmol), Cul (11.1 g, 58.31 mmol), and K₂CO₃ (48.35 g, 349.85 mmol), followed by heating for about 24 hours while maintaining an external temperature at about 215 °C. The reaction mixture was diluted with CH₂Cl₂, and water was added thereto. The resultant mixture was filtered through Celite and extracted, and an organic layer was then concentrated. Purification by silica gel column chromatography was performed to obtain Intermediate 699-(3) (9.17 g, yield of 67%). A molecular weight of Intermediate 699-(3) was 587, as measured by FAB-MS.

### Synthesis of Intermediate 699-(4)

Intermediate 699-(3) (8.95 g, 15.25 mmol), Intermediate 699-(1) (5.14 g, 15.25 mmol), Cul (3.19 g, 16.77 mmol), K₂CO₃ (8.43 g, 60.99 mmol), and dipivaloylmethane (31.94 g, 0.17 mmol) were added to DMF (319 mL), followed by heating for about 24 hours while maintaining an external temperature at about 100 °C. The reaction mixture was diluted with CH₂Cl₂, and water was added thereto. The resultant mixture was filtered through Celite and extracted, and an organic layer was then concentrated. Purification by silica gel column chromatography was performed to obtain Intermediate 699-(4) (8.10 g, yield of 63%). A molecular weight of Intermediate 699-(4) was 843, as measured by FAB-MS.

### Synthesis of Intermediate 699-(5)

A small amount of toluene (about 10 mL) was added to Intermediate 699-(4) (7.95 g, 9.43 mmol), Intermediate 1-(1) (30.47 g, 75.4 mmol), Cul (4.49 g, 23.56 mmol), and K₂CO₃ (19.54 g, 141.38 mmol), followed by heating for about 24 hours while maintaining an external temperature at about 215 °C. The reaction mixture was diluted with CH₂Cl₂, and water was added thereto. The resultant mixture was filtered through Celite and extracted, and an organic layer was then concentrated. Purification by silica gel column chromatography was performed to obtain Intermediate 699-(5) (6.82 g, yield of 62%). A molecular weight of Intermediate 699-(5) was 1167, as measured by FAB-MS.

### Synthesis of Intermediate 699-(6)

Under an argon atmosphere, toluene (53.92 mL) and a 1:1 mixture (26.96 mL) of EtOH and water were added to Intermediate 699-(5) (6.74 g, 5.78 mmol), (5,5,8,8-tetramethyl-5,6,7,8-tetrahydronaphthalen-2-yl)boronic acid (3.08 g, 13.29 mmol), K₂CO₃ (4.79 g, 34.66 mmol), and Pd(Ph₃P)₄ (1.03 g, 0.9 mmol), followed by heating for about 24 hours while maintaining an external temperature at about 80 °C. The resultant mixture was filtered through Celite and extracted, and an organic layer was then concentrated. Purification by silica gel column chromatography was performed to obtain Intermediate 699-(6) (5.45 g, yield of 74%). A molecular weight of Intermediate 699-(6) was 1274, as measured by FAB-MS.

### Synthesis of Intermediate 699-(7)

Under an argon atmosphere, Intermediate 699-(6) (5.33 g, 4.18 mmol) was dissolved in ODCB (42 mL), and BBr₃ (4.19 g, 16.73 mmol) was added, followed by heating and stirring at about 170 °C for about 10 hours. After cooling to a room temperature, DIPEA (6.48 g, 50.2 mmol) and water were added. The resultant mixture was filtered through Celite and extracted, and an organic layer was concentrated. Purification by silica gel column chromatography was performed to obtain Intermediate 699-(7) (2.05 g, yield of 38%). A molecular weight of Intermediate 699-(7) was 1290, as measured by FAB-MS.

### Synthesis of Compound 699

Under an argon atmosphere, Intermediate 699-(7) (1.85 g, 1.43 mmol), 9H-carbazole (0.5 g, 3.01 mmol), Pd(dba)₂ (0.08 g, 0.14 mmol), P(tBu)₃·HBF₄ (0.08 g, 0.29 mmol), and tBuONa (0.45 g, 4.73 mmol) were added to toluene (7 mL), followed by heating and stirring for about 8 hours at about 100 °C. Water was added, the resultant mixture was filtered through Celite and extracted, and an organic layer was then concentrated. Purification by silica gel column chromatography was performed to obtain Compound 699 (1.77 g, yield of 87%). A molecular weight of Compound 699, as measured by FAB-MS, was 1420.

The obtained Compound 699 was purified by sublimination (370 °C, 2.8x10⁻³ Pa) and used in element evaluation.

### (6) Synthesis of Compound 1054

Polycyclic Compound 1054 according to one example may be synthesized by, for example, the synthetic methods described in Reaction Scheme 6.

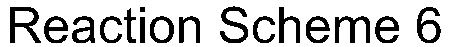

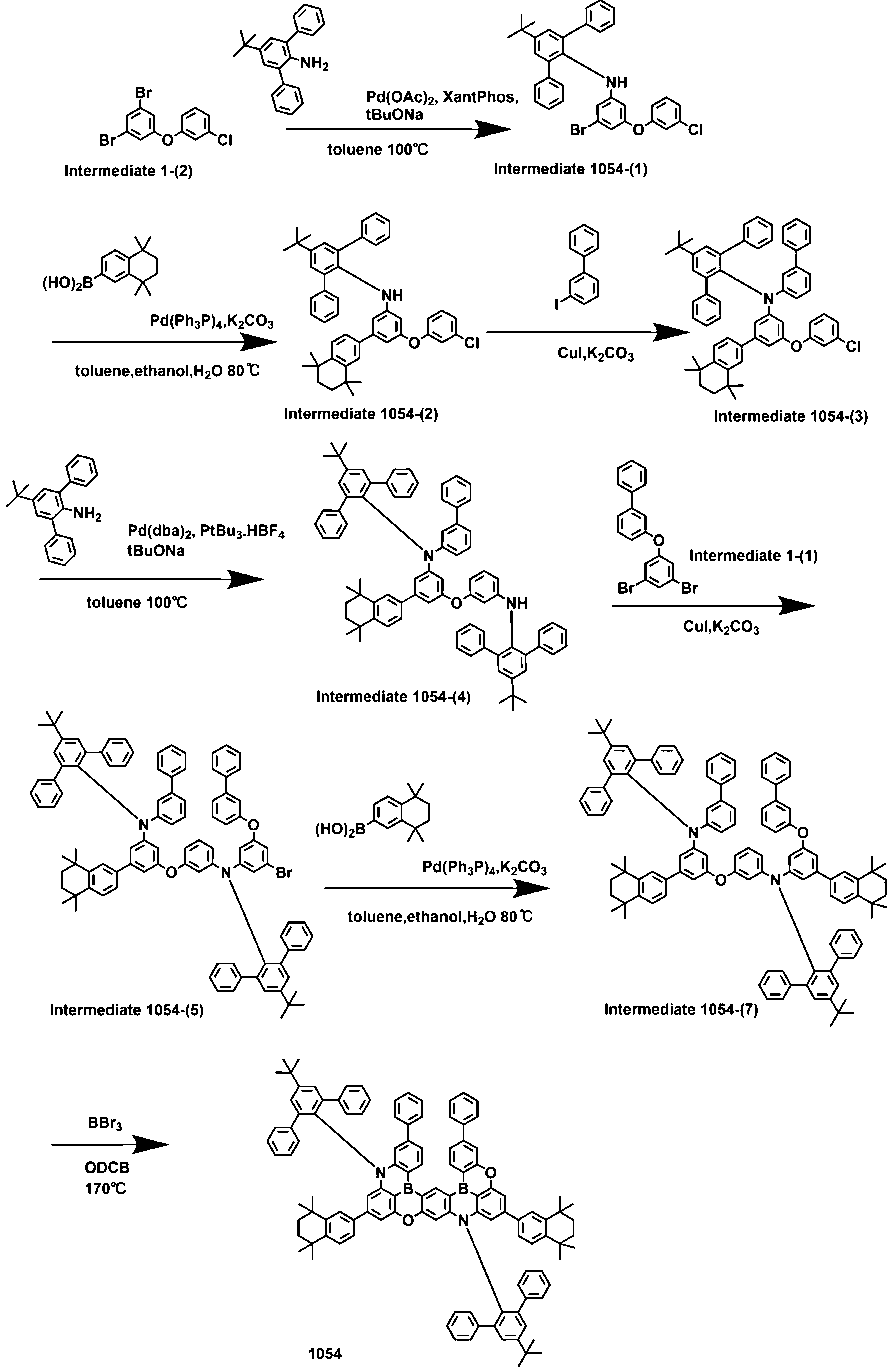

### Synthesis of Intermediate 1054-(1)

Under an argon atmosphere, Intermediate 1-(2) (10.11 g, 27.89 mmol), 5'-(tert-butyl)-[1,1':3',1"-terphenyl]-2'-amine (8.41 g, 27.89 mmol), Pd(OAc)₂ (0.19 g, 0.84 mmol), XantPhos (0.97 g, 1.67 mmol), and tBuONa (3.22 g, 33.47 mmol) were added to toluene (139 mL), followed by heating and stirring at about 100 °C for about 8 hours. Water was added, the resultant mixture was filtered through Celite and extracted, and an organic layer was then concentrated. Purification by silica gel column chromatography was performed to obtain Intermediate 1054-(1) (14.31 g, yield of 88%). A molecular weight of Intermediate 1054-(1) was 583, as measured by FAB-MS.

### Synthesis of Intermediate 1054-(2)

Under an argon atmosphere, toluene (112.16 mL) and a 1:1 mixture (56.08 mL) of EtOH and water were added to Intermediate 1054-(1) (14.02 g, 24.05 mmol), (5,5,8,8-tetramethyl-5,6,7,8-tetrahydronaphthalen-2-yl)boronic acid (12.84 g, 55.31 mmol), K₂CO₃ (19.94 g, 144.3 mmol), and Pd(Ph₃P)₄ (4.31 g, 3.73 mmol), followed by heating for about 24 hours while maintaining an external temperature at about 80 °C. The resultant mixture was filtered through Celite and extracted, and an organic layer was then concentrated. Purification by silica gel column chromatography was performed to obtain Intermediate 1054-(2) (12.29 g, yield of 74%). A molecular weight of Intermediate 1054-(2) was 690, as measured by FAB-MS.

### Synthesis of Intermediate 1054-(3)

A small amount of toluene (about 10 mL) was added to Intermediate 1054-(2) (12.07 g, 17.48 mmol), 3-iodo-1,1'-biphenyl (39.18 g, 139.87 mmol), Cul (8.32 g, 43.71 mmol), and K₂CO₃ (36.25 g, 262.25 mmol) followed by heating for about 24 hours while maintaining an external temperature at about 215 °C. The reaction mixture was diluted with CH₂Cl₂, and water was added thereto. The resultant mixture was filtered through Celite and extracted, and an organic layer was then concentrated. Purification by silica gel column chromatography was performed to obtain Intermediate 1054-(3) (9.87 g, yield of 67%). A molecular weight of Intermediate 1054-(3) was 843, as measured by FAB-MS.

### Synthesis of Intermediate 1054-(4)

Under an argon atmosphere, Intermediate 1054-(3) (9.55 g, 11.33 mmol), 5'-(tert-butyl)-[1,1':3',1"-terphenyl]-2'-amine (3.59 g, 11.9 mmol), Pd(dba)₂ (0.65 g, 1.13 mmol), P(tBu)₃·HBF₄ (0.66 g, 2.27 mmol), and tBuONa (2.51 g, 26.07 mmol) were added to toluene (56 mL), followed by heating and stirring for about 8 hours at about 100 °C. Water was added, the resultant mixture was filtered through Celite and extracted, and an organic layer was then concentrated. Purification by silica gel column chromatography was performed to obtain Intermediate 1054-(4) (10.92 g, yield of 87%). A molecular weight of Intermediate 1054-(4) was 1108, as measured by FAB-MS.

### Synthesis of Intermediate 1054-(5)

A small amount of toluene (about 10 mL) was added to Intermediate 1054-(4) (10.88 g, 9.82 mmol), Intermediate 1-(1) (31.76 g, 78.59 mmol), Cul (4.68 g, 24.56 mmol), and K₂CO₃ (20.37 g, 147.35 mmol), followed by heating for about 24 hours while maintaining an external temperature at about 215 °C. The reaction mixture was diluted with CH₂Cl₂, and water was added thereto. The resultant mixture was filtered through Celite and extracted, and an organic layer was then concentrated. Purification by silica gel column chromatography was performed to obtain Intermediate 1054-(5) (8.15 g, yield of 58%). A molecular weight of Intermediate 1054-(5) was 1431, as measured by FAB-MS.

### Synthesis of Intermediate 1054-(6)

Under an argon atmosphere, toluene (64.08 mL) and a 1:1 mixture (32.04 mL) of EtOH and water were added to Intermediate 1054-(5) (8.01 g, 5.45 mmol), (5,5,8,8-tetramethyl-5,6,7,8-tetrahydronaphthalen-2-yl)boronic acid (2.91 g, 12.53 mmol), K₂CO₃ (4.52 g, 32.68 mmol), and Pd(Ph₃P)₄ (0.98 g, 0.84 mmol), followed by heating for about 24 hours while maintaining an external temperature at about 80 °C. The resultant mixture was filtered through Celite and extracted, and an organic layer was then concentrated. Purification by silica gel column chromatography was performed to obtain Intermediate 1054-(7) (6.79 g, yield of 81%). A molecular weight of Intermediate 1054-(7) was 1538, as measured by FAB-MS.

### Synthesis of Intermediate 1054-(7)

Under an argon atmosphere, toluene (64.08 mL) and a 1:1 mixture (32.04 mL) of EtOH and water were added to Intermediate 1054-(5) (8.01 g, 5.45 mmol), (5,5,8,8-tetramethyl-5,6,7,8-tetrahydronaphthalen-2-yl)boronic acid (2.91 g, 12.53 mmol), K₂CO₃ (4.52 g, 32.68 mmol), and Pd(Ph₃P)₄ (0.98 g, 0.84 mmol), followed by heating for about 24 hours while maintaining an external temperature at about 80 °C. The resultant mixture was filtered through Celite and extracted, and an organic layer was then concentrated. Purification by silica gel column chromatography was performed to obtain Intermediate 1054-(7) (6.79 g, yield of 81%). A molecular weight of Intermediate 1054-(7) was 1538, as measured by FAB-MS.

### Synthesis of Compound 1054

Under an argon atmosphere, Intermediate 1054-(7) (3.35 g, 2.18 mmol) was dissolved in ODCB (22 mL), and BBr₃ (2.18 g, 8.71 mmol) was added, followed by heating and stirring at about 170 °C for about 10 hours. After cooling to a room temperature, DIPEA (3.37 g, 26.14 mmol) and water were added. The resultant mixture was filtered through Celite and extracted, and then an organic layer was concentrated. Purification by silica gel column chromatography was performed to obtain Compound 1054 (0.98 g, yield of 29%). A molecular weight of Compound 1054, as measured by FAB-MS, was 1554.

The obtained Compound 1054 was purified by sublimination (370 °C, 2.5x10⁻³ Pa) and used in element evaluation.

### (7) Synthesis of Compound 302

Polycyclic Compound 302 according to one example may be synthesized by, for example, the synthetic methods described in Reaction Scheme 7.

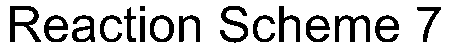

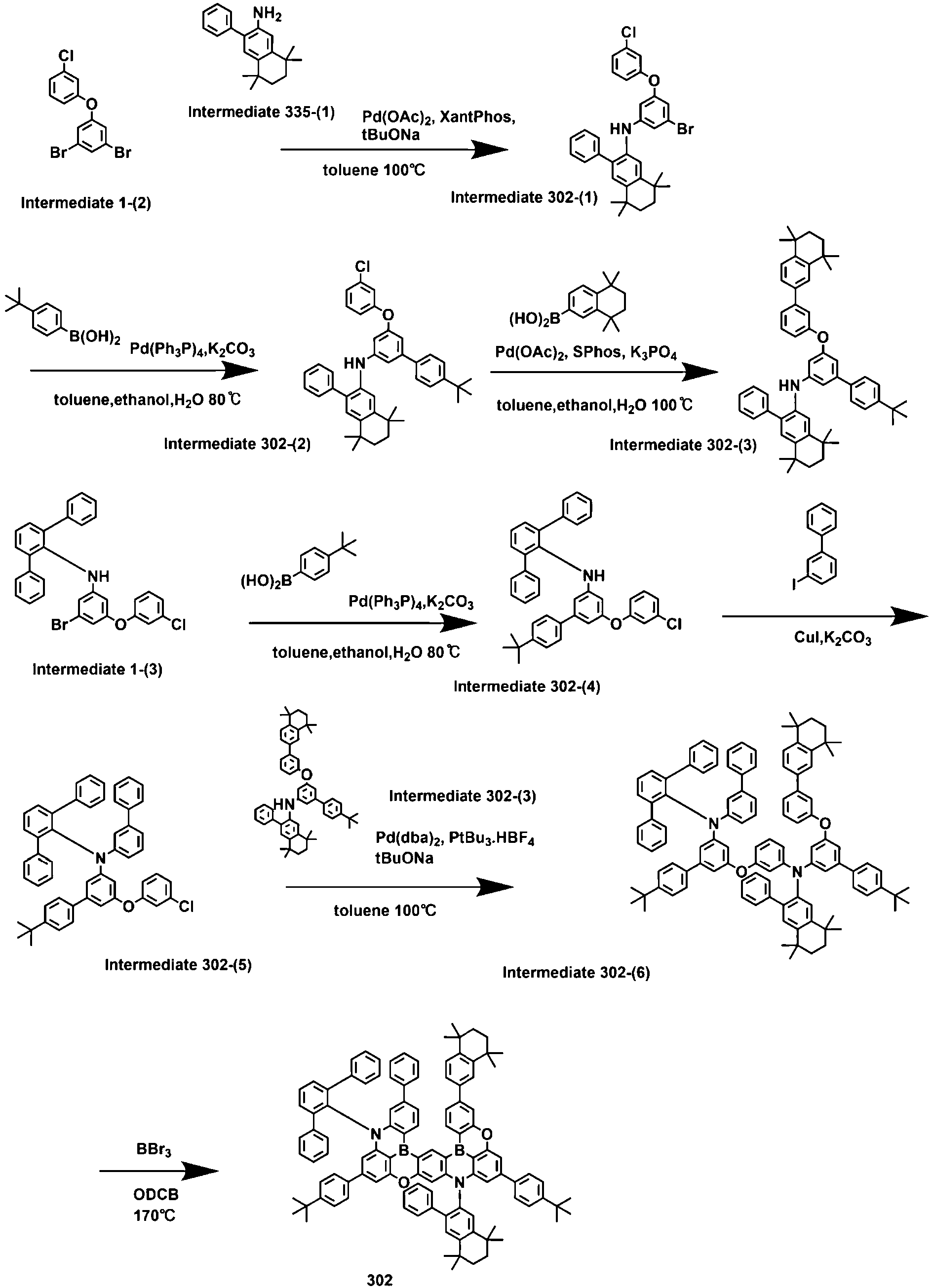

### Synthesis of Intermediate 302-(1)

Under an argon atmosphere, Intermediate 1-(2) (9.02 g, 24.89 mmol), Intermediate 335-(1) (6.95 g, 24.89 mmol), Pd(OAc)₂ (0.17 g, 0.75 mmol), XantPhos (0.86 g, 1.49 mmol), and tBuONa (2.87 g, 29.86 mmol) were added to toluene (124 mL), followed by heating and stirring at about 100 °C for about 8 hours. Water was added, the resultant mixture was filtered through Celite and extracted, and an organic layer was then concentrated. Purification by silica gel column chromatography was performed to obtain Intermediate 302-(1) (12.84 g, yield of 92%). A molecular weight of Intermediate 302-(1) was 561, as measured by FAB-MS.

### Synthesis of Intermediate 302-(2)

Under an argon atmosphere, toluene (101.28 mL) and a 1:1 mixture (50.64 mL) of EtOH and water were added to Intermediate 302-(1) (12.66 g, 22.57 mmol), (4-(tert-butyl)phenyl)boronic acid (9.24 g, 51.91 mmol), K₂CO₃ (18.72 g, 135.41 mmol), and Pd(Ph₃P)₄ (4.04 g, 3.5 mmol), followed by heating for about 24 hours while maintaining an external temperature at about 80 °C. The resultant mixture was filtered through Celite and extracted, and an organic layer was then concentrated. Purification by silica gel column chromatography was performed to obtain Intermediate 302-(2) (10.81 g, yield of 78%). A molecular weight of Intermediate 302-(2) was 614, as measured by FAB-MS.

### Synthesis of Intermediate 302-(3)

Under an argon atmosphere, toluene (321 mL) and EtOH (16.05 mL) were added to Intermediate 302-(2) (10.70 g, 17.42 mmol), (5,5,8,8-tetramethyl-5,6,7,8-tetrahydronaphthalen-2-yl)boronic acid (12.13 g, 52.26 mmol), Pd(OAc)₂ (1.56 g, 6.97 mmol), SPhos (5.72 g, 13.94 mmol), and K₃PO₄ (14.79 g, 69.68 mmol), followed by heating for about 24 hours while maintaining an external temperature at about 80 °C. The resultant mixture was filtered through Celite and extracted, and an organic layer was then concentrated. Purification by silica gel column chromatography was performed to obtain Intermediate 302-(3) (8.94 g, yield of 67%). A molecular weight of Intermediate 302-(3) was 766, as measured by FAB-MS.

### Synthesis of Intermediate 302-(4)

Under an argon atmosphere, toluene (45.28 mL) and a 1:1 mixture (22.64 mL) of EtOH and water were added to Intermediate 1-(3) (5.66 g, 10.74 mmol), (4-(tert-butyl)phenyl)boronic acid (4.4 g, 24.71 mmol), K₂CO₃ (8.91 g, 64.46 mmol), and Pd(Ph₃P)₄ (1.92 g, 1.67 mmol), followed by heating for about 24 hours while maintaining an external temperature at about 80 °C. The resultant mixture was filtered through Celite and extracted, and an organic layer was then concentrated. Purification by silica gel column chromatography was performed to obtain Intermediate 302-(4) (4.8 g, yield of 77%). A molecular weight of Intermediate 302-(4) was 580, as measured by FAB-MS.

### Synthesis of Intermediate 302-(5)

A small amount of toluene (about 10 mL) was added to Intermediate 302-(4) (8.77 g, 15.12 mmol), 3-iodo-1,1'-biphenyl (33.87 g, 120.93 mmol), Cul (7.2 g, 37.79 mmol), and K₂CO₃ (31.34 g, 226.74 mmol), followed by heating for about 24 hours while maintaining an external temperature at about 215 °C. The reaction mixture was diluted with CH₂Cl₂, and water was added thereto. The resultant mixture was filtered through Celite and extracted, and an organic layer was then concentrated. Purification by silica gel column chromatography was performed to obtain Intermediate 302-(5) (7.31 g, yield of 66%). A molecular weight of Intermediate 302-(5) was 732, as measured by FAB-MS.

### Synthesis of Intermediate 302-(6)

Under an argon atmosphere, Intermediate 302-(5) (7.14 g, 9.75 mmol), Intermediate 302-(3) (7.47 g, 9.75 mmol), Pd(dba)₂ (0.56 g, 0.97 mmol), P(tBu)₃·HBF₄ (0.57 g, 1.95 mmol), and tBuONa (2.15 g, 22.42 mmol) were added to toluene (48 mL), followed by heating and stirring for about 8 hours at about 100 °C. Water was added, the resultant mixture was filtered through Celite and extracted, and an organic layer was then concentrated. Purification by silica gel column chromatography was performed to obtain Intermediate 302-(6) (10.55 g, yield of 74%). A molecular weight of Intermediate 302-(6) was 1462, as measured by FAB-MS.

### Synthesis of Compound 302

Under an argon atmosphere, Intermediate 302-(6) (5.21 g, 3.56 mmol) was dissolved in ODCB (36 mL), and BBr₃ (3.57 g, 14.25 mmol) was added, followed by heating and stirring at about 170 °C for about 10 hours. After cooling to a room temperature, DIPEA (5.52 g, 42.76 mmol) and water were added. The resultant mixture was filtered through Celite and extracted, and an organic layer was concentrated. Purification by silica gel column chromatography was performed to obtain Compound 302 (1.84 g, yield of 35%). A molecular weight of Compound 302, as measured by FAB-MS, was 1478.

The obtained Compound 302 was purified by sublimination (380 °C, 2.3x10⁻³ Pa) and used in element evaluation.

### (8) Synthesis of Compound 1173

Polycyclic Compound 1173 according to one example may be synthesized by, for example, the synthetic methods described in Reaction Scheme 8.

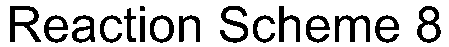

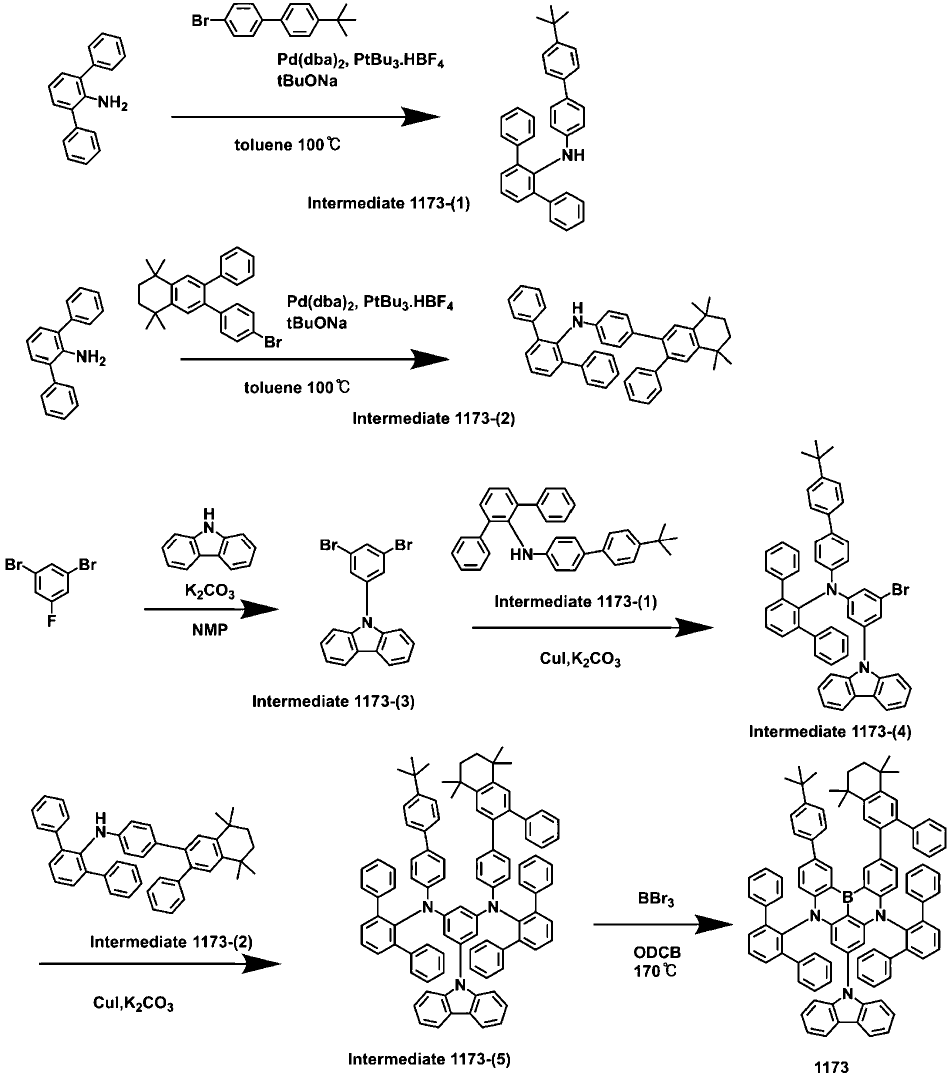

### Synthesis of Intermediate 1173-(1)

Under an argon atmosphere, [1,1':3',1"-terphenyl]-2'-amine (15.02 g, 61.22 mmol), 4-bromo-4'-(tert-butyl)-1,1'-biphenyl (17.71 g, 61.22 mmol), Pd(dba)₂ (3.52 g, 6.12 mmol), P(tBu)₃·HBF₄ (3.55 g, 12.24 mmol), and tBuONa (13.53 g, 140.81 mmol) were added to toluene (306 mL), followed by heating and stirring for about 8 hours at about 100 °C. Water was added, the resultant mixture was filtered through Celite and extracted, and an organic layer was then concentrated. Purification by silica gel column chromatography was performed to obtain Intermediate 1173-(1) (21.66 g, yield of 78%). A molecular weight of Intermediate 1173-(1) was 454, as measured by FAB-MS.

### Synthesis of Intermediate 1173-(2)

Under an argon atmosphere, [1,1':3',1"-terphenyl]-2'-amine (10.24 g, 41.74 mmol), 6-(4-bromophenyl)-1,1,4,4-tetramethyl-7-phenyl-1,2,3,4-tetrahydronaphthalene (17.51 g, 41.74 mmol), Pd(dba)2 (2.4 g, 4.17 mmol), P(tBu)₃·HBF₄ (2.42 g, 8.35 mmol), and tBuONa (9.23 g, 96 mmol) were added to toluene (208 mL), followed by heating and stirring at about 100 °C for about 8 hours. Water was added, the resultant mixture was filtered through Celite and extracted, and an organic layer was concentrated. Purification by silica gel column chromatography was performed to obtain Intermediate 1173-(2) (19.74 g, yield of 81%). A molecular weight of Intermediate 1173-(2) was 584, as measured by FAB-MS.

### Synthesis of Intermediate 1173-(3)

Under an argon atmosphere, NMP (258 mL) was added to 1,3-dibromo-5-fluorobenzene (25.88 g, 101.93 mmol), 9H-carbazole (22.16 g, 132.51 mmol), and K₂CO₃ (35.22 g, 254.82 mmol), followed by heating for about 24 hours while maintaining an external temperature at about 140 °C. The reaction mixture was diluted with CH₂Cl₂, and water was added thereto. The resultant mixture was filtered through Celite and extracted, and an organic layer was concentrated. Purification by silica gel column chromatography was performed to obtain Intermediate 1173-(3) (34.75 g, yield of 85%). A molecular weight of Intermediate 1173-(3) was 401, as measured by FAB-MS.

### Synthesis of Intermediate 1173-(4)

A small amount of toluene (about 10 mL) was added to Intermediate 1173-(1) (8.01 g, 17.66 mmol), Intermediate 1173-(3) (21.25 g, 52.97 mmol), Cul (8.41 g, 44.14 mmol), and K₂CO₃ (36.61 g, 264.86 mmol), followed by heating for about 24 hours while maintaining an external temperature at about 215 °C. The reaction mixture was diluted with CH₂Cl₂, and water was added thereto. The resultant mixture was filtered through Celite and extracted, and an organic layer was concentrated. Purification by silica gel column chromatography was performed to obtain Intermediate 1173-(4) (4.37 g, yield of 32%). A molecular weight of Intermediate 1173-(4) was 774, as measured by FAB-MS.

### Synthesis of Intermediate 1173-(5)

A small amount of toluene (about 10 mL) was added to Intermediate 1173-(4) (3.50 g, 4.52 mmol), Intermediate 1173-(2) (21.13 g, 36.18 mmol), Cul (2.15 g, 11.31 mmol), and K₂CO₃ (9.38 g, 67.85 mmol), followed by heating for about 24 hours while maintaining an external temperature at about 215 °C. The reaction mixture was diluted with CH₂Cl₂, and water was added thereto. The resultant mixture was filtered through Celite and extracted, and an organic layer was concentrated. Purification by silica gel column chromatography was performed to obtain Intermediate 1173-(5) (3.70 g, yield of 64%). A molecular weight of Intermediate 1173-(5) was 1277, as measured by FAB-MS.

### Synthesis of Compound 1173

Under an argon atmosphere, Intermediate 1173-(5) (3.5 g, 2.74 mmol) was dissolved in ODCB (27 mL), and BBr₃ (2.75 g, 10.97 mmol) was added, followed by heating and stirring at about 170 °C for about 10 hours. After cooling to a room temperature, DIPEA (4.24 g, 32.9 mmol) and water were added. The resultant mixture was filtered through Celite and extracted, and an organic layer was concentrated. Purification by silica gel column chromatography was performed to obtain Compound 1173 (0.63 g, yield of 18%). A molecular weight of Compound 1173, as measured by FAB-MS, was 1285.

The obtained Compound 1173 was purified by sublimination (360 °C, 2.2x10⁻³ Pa) and used in element evaluation.

### (9) Synthesis of Compound 1499

Polycyclic Compound 1499 according to one example may be synthesized by, for example, the synthetic methods described in Reaction Scheme 9.

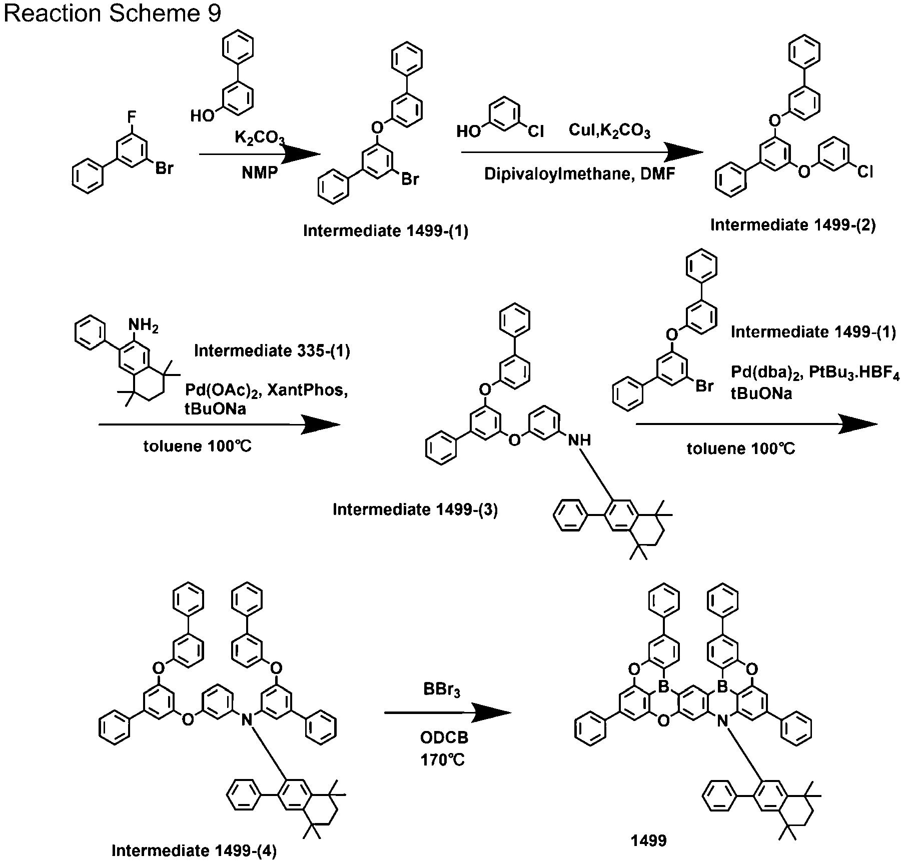

### Synthesis of Intermediate 1499-(1)

Under an argon atmosphere, NMP (100 mL) was added to 3-bromo-5-fluoro-1,1'-biphenyl (10.05 g, 40.02 mmol), [1,1'-biphenyl]-3-ol (8.86 g, 52.03 mmol), and K₂CO₃ (13.83 g, 100.06 mmol), followed by heating for about 24 hours while maintaining an external temperature at about 140 °C. The reaction mixture was diluted with CH₂Cl₂, and water was added thereto. The resultant mixture was filtered through Celite and extracted, and an organic layer was concentrated. Purification by silica gel column chromatography was performed to obtain Intermediate 1499-(1) (11.56 g, yield of 72%). A molecular weight of Intermediate 1499-(1) was 401, as measured by FAB-MS.

### Synthesis of Intermediate 1499-(2)

Intermediate 1499-(1) (11.25 g, 28.03 mmol), 3-chlorophenol (3.6 g, 28.03 mmol), Cul (5.87 g, 30.84 mmol), K₂CO₃ (15.5 g, 112.14 mmol), and dipivaloylmethane (58.73 g, 0.32 mmol) were added to DMF (587 mL), followed by heating for about 24 hours while maintaining an external temperature at about 100 °C. The reaction mixture was diluted with CH₂Cl₂, and water was added thereto. The resultant mixture was filtered through Celite and extracted, and an organic layer was concentrated. Purification by silica gel column chromatography was performed to obtain Intermediate 1499-(2) (9.69 g, yield of 77%). A molecular weight of Intermediate 1499-(2) was 449, as measured by FAB-MS.

### Synthesis of Intermediate 1499-(3)

Under an argon atmosphere, Intermediate 1499-(2) (9.55 g, 21.27 mmol), Intermediate 335-(1) (5.94 g, 21.27 mmol), Pd(OAc)₂ (0.14 g, 0.64 mmol), XantPhos (0.74 g, 1.28 mmol), and tBuONa (2.45 g, 25.53 mmol) were added to toluene (106 mL), followed by heating and stirring at about 100 °C for about 8 hours. Water was added, the resultant mixture was filtered through Celite and extracted, and an organic layer was concentrated. Purification by silica gel column chromatography was performed to obtain Intermediate 1499-(3) (12.22 g, yield of 83%). A molecular weight of Intermediate 1499-(3) was 692, as measured by FAB-MS.

### Synthesis of Intermediate 1499-(4)

Under an argon atmosphere, Intermediate 1499-(3) (5.26 g, 7.6 mmol), Intermediate 1499-(1) (3.05 g, 7.6 mmol), Pd(dba)₂ (0.44 g, 0.76 mmol), P(tBu)₃·HBF₄ (0.44 g, 1.52 mmol), and tBuONa (1.68 g, 17.48 mmol) were added to toluene (38 mL), followed by heating and stirring for about 8 hours at about 100 °C. Water was added, the resultant mixture was filtered through Celite and extracted, and an organic layer was concentrated. Purification by silica gel column chromatography was performed to obtain Intermediate 1499-(4) (6.46 g, yield of 84%). A molecular weight of Intermediate 1499-(4) was 1012, as measured by FAB-MS.

### Synthesis of Compound 1499

Under an argon atmosphere, Intermediate 1499-(4) (6.22 g, 2.01 mmol) was dissolved in ODCB (20 mL), and BBr₃ (2.01 g, 8.04 mmol) was added, followed by heating and stirring at about 170 °C for about 10 hours. After cooling to a room temperature, DIPEA (3.11 g, 24.12 mmol) and water were added. The resultant mixture was filtered through Celite and extracted, and an organic layer was concentrated. Purification by silica gel column chromatography was performed to obtain Compound 1499 (0.72 g, yield of 35%). A molecular weight of Compound 1499, as measured by FAB-MS, was 1028.

The obtained Compound 1499 was purified by sublimination (340 °C, 2.1x10⁻³ Pa) and used in element evaluation.

### (10) Synthesis of Compound 1511

Polycyclic Compound 1511 according to one example may be synthesized by, for example, the synthetic methods described in Reaction Scheme 10.

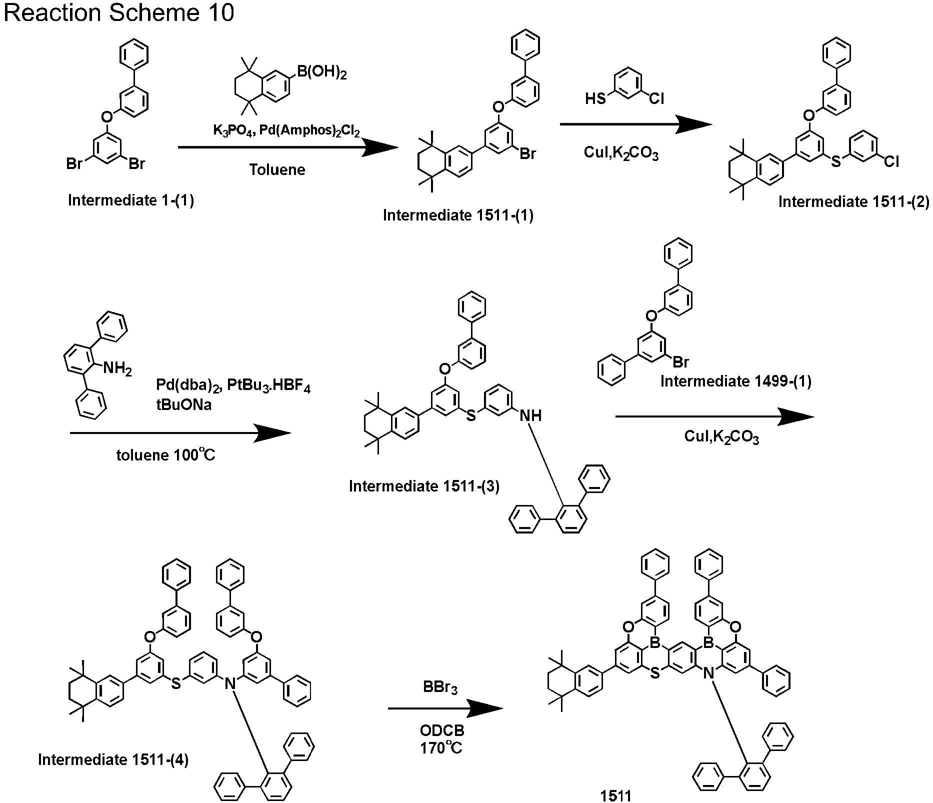

### Synthesis of Intermediate 1511-(1)

Under an argon atmosphere, toluene (98.64 mL) and a 1:1 mixture (49.32 mL) of EtOH and water were added to (5,5,8,8-tetramethyl-5,6,7,8-tetrahydronaphthalen-2-yl)boronic acid (12.33 g, 30.51 mmol), Intermediate 1-(1) (14.29 g, 61.02 mmol), K₃PO₄ (12.95 g, 61.02 mmol), and Pd(Amphos)₂Cl₂ (2.16 g, 3.05 mmol), followed by heating for about 24 hours while maintaining an external temperature at about 90 °C. The resultant mixture was filtered through Celite and extracted, and an organic layer was concentrated. Purification by silica gel column chromatography was performed to obtain Intermediate 1511-(1) (10.92 g, yield of 70%). A molecular weight of Intermediate 1511-(1) was 512, as measured by FAB-MS.

### Synthesis of Intermediate 1511-(2)

A small amount of toluene (about 10 mL) was added to Intermediate 1511-(1) (10.56 g, 20.65 mmol), 3-chlorobenzenethiol (23.89 g, 165.16 mmol), Cul (9.83 g, 51.61 mmol), and K₂CO₃ (42.8 g, 309.68 mmol), followed by heating for about 24 hours while maintaining an external temperature at about 215 °C. The reaction mixture was diluted with CH₂Cl₂, and water was added thereto. The resultant mixture was filtered through Celite and extracted, and an organic layer was concentrated. Purification by silica gel column chromatography was performed to obtain Intermediate 1511-(2) (6.89 g, yield of 58%). A molecular weight of Intermediate 1511-(2) was 575, as measured by FAB-MS.

### Synthesis of Intermediate 1511-(3)

Under an argon atmosphere, Intermediate 1511-(2) (6.77 g, 11.77 mmol), [1,1':3',1"-terphenyl]-2'-amine (2.89 g, 11.77 mmol), Pd(dba)₂ (0.68 g, 1.18 mmol), P(tBu)₃·HBF₄ (0.68 g, 2.35 mmol), and tBuONa (2.6 g, 27.07 mmol) were added to toluene (58 mL), followed by heating and stirring for about 8 hours at about 100 °C. Water was added, the resultant mixture was filtered through Celite and extracted, and an organic layer was concentrated. Purification by silica gel column chromatography was performed to obtain Intermediate 1511-(3) (7.83 g, yield of 84%). A molecular weight of Intermediate 1511-(3) was 784, as measured by FAB-MS.

### Synthesis of Intermediate 1511-(4)

A small amount of toluene (about 10 mL) was added to Intermediate 1511-(3) (7.26 g, 9.26 mmol), Intermediate 1499-(1) (29.43 g, 73.35 mmol), Cul (4.37 g, 22.92 mmol), and K₂CO₃ (19.01 g, 137.52 mmol), followed by heating for about 24 hours while maintaining an external temperature at about 215 °C. The reaction mixture was diluted with CH₂Cl₂, and water was added thereto. The resultant mixture was filtered through Celite and extracted, and an organic layer was concentrated. Purification by silica gel column chromatography was performed to obtain Intermediate 1511-(4) (5.57 g, yield of 55%). A molecular weight of Intermediate 1511-(4) was 1104, as measured by FAB-MS.

### Synthesis of Compound 1511

Under an argon atmosphere, Intermediate 1511-(4) (5.27 g, 2.01 mmol) was dissolved in ODCB (20 mL), and BBr₃ (2.01 g, 8.04 mmol) was added, followed by heating and stirring at about 170 °C for about 10 hours. After cooling to a room temperature, DIPEA (3.11 g, 24.12 mmol) and water were added. The resultant mixture was filtered through Celite and extracted, and an organic layer was concentrated. Purification by silica gel column chromatography was performed to obtain Compound 1511 (0.47 g, yield of 21%). A molecular weight of Compound 1511, as measured by FAB-MS, was 1120.

The obtained Compound 1511 was purified by sublimination (370 °C, 2.5x10⁻³ Pa) and used in element evaluation.

### (11) Synthesis of Compound 1552

Polycyclic Compound 1552 according to one example may be synthesized by, for example, the synthetic methods described in Reaction Scheme 11.

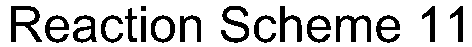

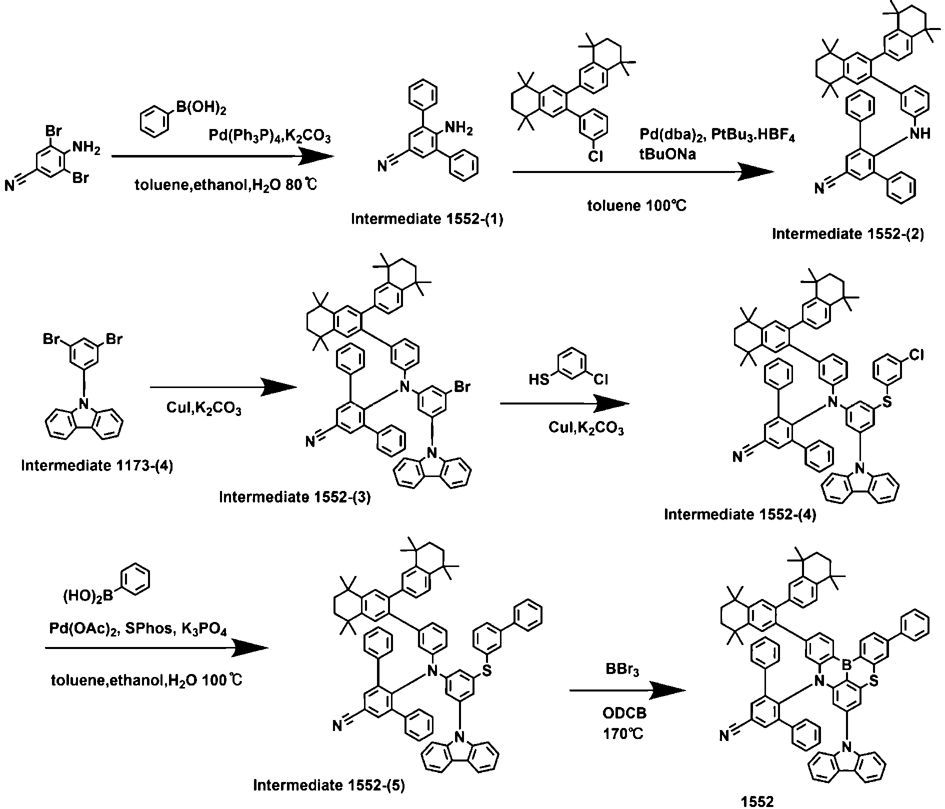

### Synthesis of Intermediate 1552-(1)

Under an argon atmosphere, toluene (82.64 mL) and a 1:1 mixture (41.32 mL) of EtOH and water were added to 4-amino-3,5-dibromobenzonitrile (10.33 g, 37.44 mmol), phenylboronic acid (10.5 g, 86.11 mmol), K₂CO₃ (31.05 g, 224.62 mmol), and Pd(Ph₃P)₄ (6.71 g, 5.8 mmol), followed and by heating for about 24 hours while maintaining an external temperature at about 80 °C. The resultant mixture was filtered through Celite and extracted, and an organic layer was then concentrated. Purification by silica gel column chromatography was performed to obtain Intermediate 1552-(1) (7.59 g, yield of 75%). A molecular weight of Intermediate 1552-(1) was 270, as measured by FAB-MS.

### Synthesis of Intermediate 1552-(2)

Under an Ar atmosphere, Intermediate 1552-(1) (7.33 g, 27.11 mmol), 3-(3-chlorophenyl)-5,5,5',5',8,8,8',8'-octamethyl-5,5',6,6',7,7',8,8'-octahydro-2,2'-binaphthalene (13.15 g, 27.11 mmol), Pd(dba)₂ (1.56 g, 2.71 mmol), P(tBu)₃·HBF₄ (1.57 g, 5.42 mmol), and tBuONa (5.99 g, 62.36 mmol) were added to toluene (135 mL), followed by heating and stirring for about 8 hours at about 100 °C. Water was added, the resultant mixture was filtered through Celite and extracted, and an organic layer was then concentrated. Purification by silica gel column chromatography was performed to obtain Intermediate 1552-(2) (16.38 g, yield of 84%). A molecular weight of Intermediate 1552-(2) was 719, as measured by FAB-MS.

### Synthesis of Intermediate 1552-(3)

A small amount of toluene (about 10 mL) was added to Intermediate 1552-(2) (5.01 g, 6.97 mmol), Intermediate 1173-(4) (22.37 g, 55.74 mmol), Cul (3.32 g, 17.42 mmol), and K₂CO₃ (41.92 g, 104.52 mmol), followed by heating for about 24 hours while maintaining an external temperature at about 215 °C. The reaction mixture was diluted with CH₂Cl₂, and water was added thereto. The resultant mixture was filtered through Celite and extracted, and an organic layer was then concentrated. Purification by silica gel column chromatography was performed to obtain Intermediate 1552-(3) (3.91 g, yield of 54%). A molecular weight of Intermediate 1552-(3) was 1039, as measured by FAB-MS.

### Synthesis of Intermediate 1552-(4)

A small amount of toluene (about 10 mL) was added to Intermediate 1552-(3) (3.62 g, 3.48 mmol), 3-chlorobenzenethiol (1.01 g, 6.97 mmol), Cul (1.66 g, 8.71 mmol), and K₂CO₃ (20.96 g, 52.25 mmol), followed by heating for about 24 hours while maintaining an external temperature at about 215 °C. The reaction mixture was diluted with CH₂Cl₂, and water was added thereto. The resultant mixture was filtered through Celite and extracted, and the organic layer was then concentrated. Purification by silica gel column chromatography was performed to obtain Intermediate 1552-(4) (2.38 g, yield of 62%). A molecular weight of Intermediate 1552-(4) was 1103, as measured by FAB-MS.

### Synthesis of Intermediate 1552-(5)

Under an argon atmosphere, toluene (63.9 mL) and EtOH (3.195 mL) were added to Intermediate 1552-(4) (2.13 g, 1.93 mmol), phenylboronic acid (0.71 g, 5.79 mmol), Pd(OAc)2 (0.17 g, 0.77 mmol), SPhos (0.63 g, 1.54 mmol), and K₃PO₄ (1.64 g, 7.72 mmol), followed by heating for about 24 hours while maintaining an external temperature at about 80 °C. The resultant mixture was filtered through Celite and extracted, and an organic layer was then concentrated. Purification by silica gel column chromatography was performed to obtain Intermediate 1552-(5) (1.44 g, yield of 65%). A molecular weight of Intermediate 1552-(5) was 1145, as measured by FAB-MS.

### Synthesis of Compound 1552

Under an argon atmosphere, Intermediate 1552-(5) (1.36 g, 2.01 mmol) was dissolved in ODCB (20 mL), and BBr₃ (2.01 g, 8.04 mmol) was added, followed by heating and stirring at about 170 °C for about 10 hours. After cooling to a room temperature, DIPEA (3.11 g, 24.12 mmol) and water were added. The resultant mixture was filtered through Celite and extracted, and an organic layer was concentrated. Purification by silica gel column chromatography was performed to obtain Compound 1552 (0.51 g, yield of 22%). A molecular weight of Compound 1552, as measured by FAB-MS, was 1152.

The obtained Compound 1552 was purified by sublimination (380 °C, 2.3x10⁻³ Pa) and used in element evaluation.

### 2. Manufacture and evaluation of light-emitting element

### (1) Manufacture of light-emitting element

Light-emitting elements including the polycyclic compounds according to Example Compounds and Comparative Example Compounds in the light emitting layer were manufactured by the following method. Light emitting elements according to Example 1 to Example 11 were manufactured respectively using the polycyclic compounds according to Examples as materials for the light emitting layer. Light-emitting elements according to Comparative Example 1 to Comparative Example 7 were manufactured using Comparative Example Compounds X1 to X7, respectively, as materials for the light emitting layer.

A glass substrate, on which ITO was patterned to a thickness of about 150 nm as a first electrode was ultrasonically cleaned with isopropyl alcohol and pure water for about 5 minutes each. After completion of ultrasonic cleaning, the glass substrate was subjected to UV irradiation for about 30 minutes and then ozone treatment was carried out. Next, HAT-CN, α-NPD, and mCP were sequentially and respectively deposited to thicknesses of about 10 nm, about 80 nm, and about 5 nm to form a hole transport region.

Next, Example Compounds or Comparative Example Compounds, and mCBP were co-deposited to form a light emitting layer to a thickness of about 20 nm. Example Compounds or Comparative Example Compounds, and mCBP were co-deposited at a weight ratio of about 1:99. In manufacture of a light-emitting element, Example Compounds or Comparative Example Compounds were used as a dopant material.

Thereafter, TPBi to a thickness of about 30 nm, LiF to a thickness of about 0.5 nm were sequentially deposited to form an electron transport region.

Next, aluminium (Al) was deposited at a thickness of about 100 nm to form a second electrode.

The hole transport region, the light emitting layer, the electron transport region, and the second electrode were formed using a vacuum deposition apparatus.

Compounds used in the light emitting layer of the light-emitting element according to Examples or Comparative Examples are listed in Table 1.

**Table 1**

| Classification | Compound | Classification | Compound |
|---|---|---|---|
| Example 1 | 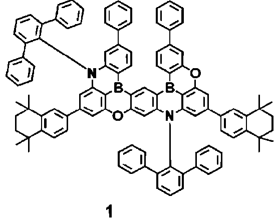 | Example 2 | 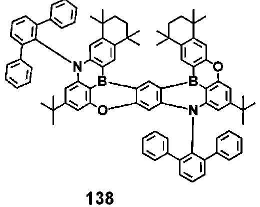 |
| Example 3 | 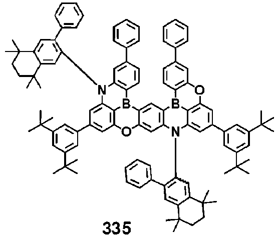 | Example 4 | 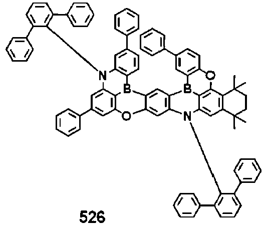 |
| Example 5 | 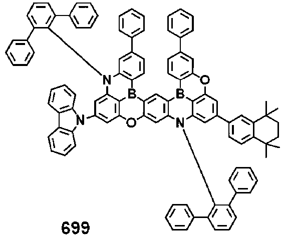 | Example 6 | 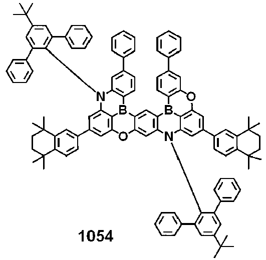 |
| Example 7 | 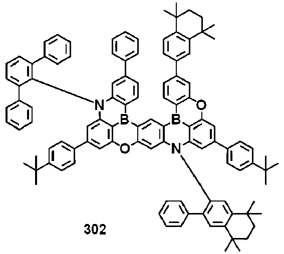 | Example 8 | 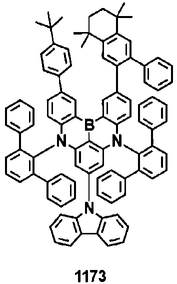 |
| Example 9 | 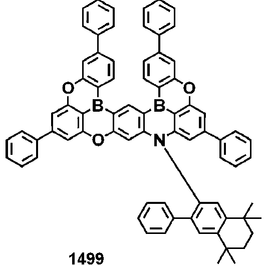 | Example 10 | 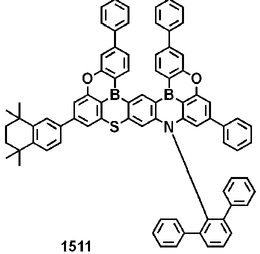 |
| Example 11 | 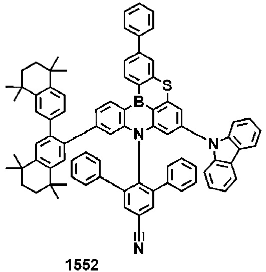 | | |
| Comparative Example 1 | 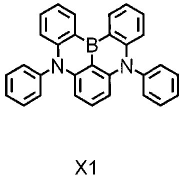 | Comparative Example 2 | 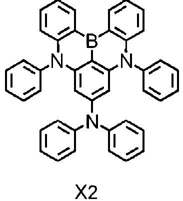 |
| Comparative Example 3 | 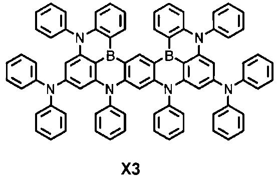 | Comparative Example 4 | 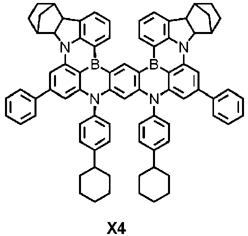 |
| Comparative Example 5 | 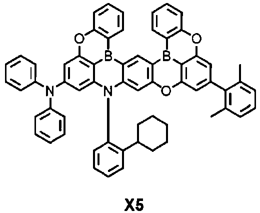 | Comparative Example 6 | 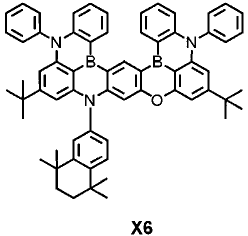 |
| Comparative Example 7 | 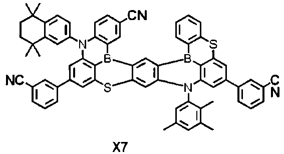 | | |

In one or more embodiments, Compounds used for the manufacture of the light-emitting elements are as follows.

### Materials used in manufacture of light-emitting element

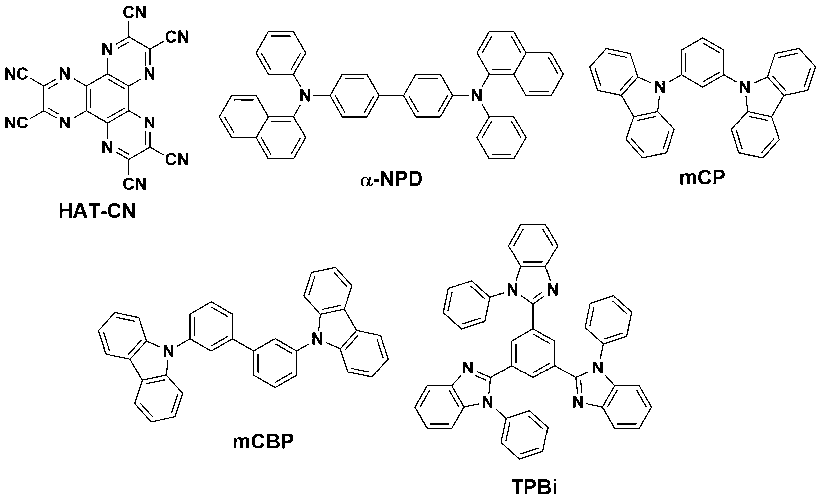

### (2) Evaluation of light-emitting element

The light-emitting elements according to Examples and Comparative Examples were evaluated, and the results are listed in Table 2. Table 2 represents a peak emission wavelength (λmax) and a relative element lifespan (LT50) of the light-emitting element according to Examples or Comparative Examples.

The peak emission wavelength (λmax) and the relative lifespan (LT50) were measured using an external quantum efficiency measurement system C9920-12 manufactured by Hamamatsu Photonics K.K. The peak emission wavelength (λmax) indicates a wavelength at which an emission spectrum has a maximum value. The relative lifespan (LT50) indicates the relative lifespan measured from the photoluminescence (PL) of a 1% dopant-doped mCBP thin film (20 nm) when a half-lifespan of the light-emitting element according to Comparative Example 3 was set to as 1.

**Table 2**

| Examples of element manufacture | Dopant materials | λmax (nm) | Relative element lifespan (LT50) |
|---|---|---|---|
| Example 1 | Compound 1 | 462 | 4.8 |
| Example 2 | Compound 138 | 458 | 4.1 |
| Example 3 | Compound 335 | 458 | 5.2 |
| Example 4 | Compound 526 | 457 | 5.0 |
| Example 5 | Compound 699 | 456 | 2.8 |
| Example 6 | Compound 1054 | 460 | 5.5 |
| Example 7 | Compound 302 | 459 | 3.8 |
| Example 8 | Compound 1173 | 457 | 3.6 |
| Example 9 | Compound 1499 | 455 | 3.2 |
| Example 10 | Compound 1511 | 460 | 4.1 |
| Example 11 | Compound 1552 | 461 | 2.9 |
| Comparative Example 1 | Comparative Example Compound X1 | 457 | 0.3 |
| Comparative Example 2 | Comparative Example Compound X2 | 446 | 0.2 |
| Comparative Example 3 | Comparative Example Compound X3 | 467 | 1.0 |
| Comparative Example 4 | Comparative Example Compound X4 | 472 | 0.1 |
| Comparative Example 5 | Comparative Example Compound X5 | 457 | 0.3 |
| Comparative Example 6 | Comparative Example Compound X6 | 456 | 0.5 |
| Comparative Example 7 | Comparative Example Compound X7 | 470 | 0.3 |

Referring to the results in Table 2, all the light-emitting elements according to Examples emit blue light in a peak emission wavelength range of about 455 nm to about 465 nm. In addition, the light-emitting elements according to Examples exhibit significantly improved or enhanced element lifespan characteristics, compared to the light-emitting elements according to Comparative Examples.

Example Compounds differ from Comparative Example Compounds in that a substituent, which is substituted at a ring-forming N atom of the fused ring core constituting the core, includes a bulky substituent moiety. If (e.g., when) the bulky substituent is included, an intermolecular distance of the polycyclic compound is sufficiently secured, thereby minimizing or reducing an intermolecular interaction, and thus material stability may be secured. Therefore, the light-emitting elements including the polycyclic compounds according to Examples may exhibit excellent or suitable element lifespan characteristics compared to the light-emitting elements according to Comparative Examples.

### Substituent moiety substituted at ring-forming N atom of core of Example Compounds

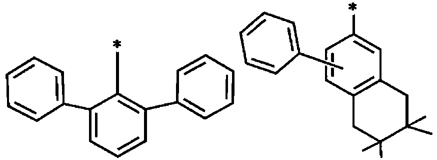

Comparative Example Compounds used in the light-emitting elements according to Comparative Example 1 to Comparative Example 7 each have a skeleton of the boron atom-containing fused ring core structure, which is included in each of Example Compounds, but differ in the substituent substituted at the amine group of the skeleton of the boron atom-containing core. Therefore, the light-emitting elements according to Comparative Example 1 to Comparative Example 7 exhibit deteriorated characteristics of element lifespan, compared to the light-emitting elements according to Examples.

The polycyclic compound according to the present disclosure has a structure which contains a boron atom-containing fused ring core including one or more boron atoms, the structure in which an aromatic substituent is substituted for an amine group forming a skeleton of the boron atom-containing fused ring core. The polycyclic compound according to the present disclosure includes, as the aromatic substituent, a terphenyl derivative, a fused ring derivative in which a benzene ring and a cycloalkane ring are fused, and/or the like, and thus molecular stability thereof may increase. Accordingly, the polycyclic compound according to the present disclosure may exhibit improved or enhanced lifespan characteristics.

In one or more embodiments, the polycyclic compound according to the present disclosure may be used as a thermally activated delayed fluorescent material. The light-emitting element according to the present disclosure including the polycyclic compound according to one or more embodiments in the light emitting layer may exhibit characteristics of excellent or suitable emission efficiency in the emission region of blue light and may exhibit characteristics of long lifespan.

The electronic apparatus including the light-emitting element that includes the polycyclic compound according to one or more embodiments may exhibit characteristics of excellent or suitable reliability due to the long lifespan characteristics of the light-emitting element. For example, the electronic apparatus according to one or more embodiments may exhibit properties of improved or enhanced lifespan and display quality by including the light-emitting element having long lifespan characteristics in a wavelength region of blue light.

The light-emitting element according to one or more embodiments includes the polycyclic compound according to one or more embodiments in the light emitting layer and thus may exhibit long lifespan characteristics.

The polycyclic compound according to one or more embodiments may contribute to improvements or enhancements of the light-emitting element.

The electronic apparatus according to one or more embodiments may exhibit excellent or suitable display quality and improved or enhanced reliability characteristics.

A light-emitting element and/or device, a display device, a display apparatus, an electronic apparatus (device), a device for manufacturing substantially the same and/or any other relevant devices or components according to one or more embodiments of the present disclosure may be implemented by utilizing any suitable hardware, firmware (e.g., an application-specific integrated circuit), software, or a (e.g., any suitable) combination of software, firmware, and hardware. For example, the one or more components of the device may be provided on one integrated circuit (IC) chip or on separate IC chips. Further, the one or more components of the device may be implemented on a flexible printed circuit film, a tape carrier package (TCP), and/or a printed circuit board (PCB), or provided on one substrate. Further, the one or more components of the device may be a process or thread, running on one or more processors, in one or more computing devices, executing computer program instructions and interacting with other system components for performing the one or more functionalities described herein. The computer program instructions may be stored in a memory which may be implemented in a computing device utilizing a standard memory device, such as, for example, a random access memory (RAM). The computer program instructions may also be stored in other non-transitory computer readable media, such as, for example, a CD-ROM, flash drive, and/or the like. Also, a person of skill in the art should recognize that the functionality of one or more computing devices may be combined or integrated into a single computing device, or the functionality of a particular computing device may be distributed across one or more other computing devices without departing from the scope of the present disclosure.

Although one or more embodiments of the present disclosure have been described, those skilled in the art or those of ordinary skill in the art will understand that one or more suitable modifications and changes can be made to the embodiments within the scope that does not depart from the scope of the present disclosure. Accordingly, the scope of the present disclosure should not be limited to the embodiments as described in the detailed description of the present disclosure, but should be determined by the appended claims and equivalents thereof.

## Claims

1. A polycyclic compound represented by Formula 1: 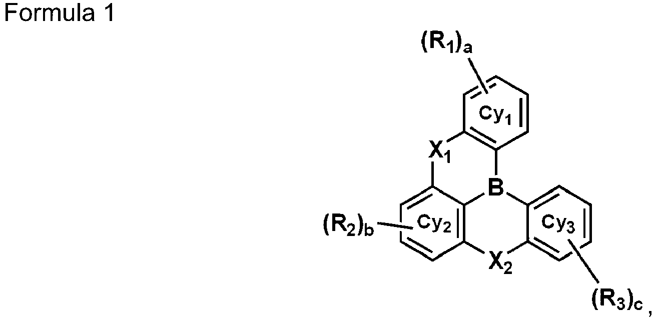 wherein, in Formula 1,
X₁ and X₂ are each independently O, S, or NRₓ, at least one selected from among X₁ and X₂ being NRₓ, and
at least one selected from among rings Cy₁ to Cy₃ is non-fused or fused to a structure of Formula 2, 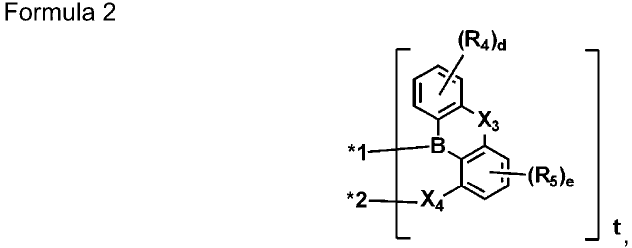 wherein, in Formula 2,
t is an integer of 0 to 2,
X₃ and X₄ are each independently O, S, or NRₓ, and
the rings Cy₁ to Cy₃ are bonded at *1 and *2:
in Formula 1 and Formula 2,
a, c, and d are each independently an integer of 0 to 4,
b and e are each independently an integer of 0 to 3,
R₁ to R₅ are each independently a hydrogen atom, a deuterium atom, a halogen atom, a cyano group, a substituted or unsubstituted amino group, a substituted or unsubstituted alkyl group having 1 to 20 carbon atoms, a substituted or unsubstituted hydrocarbon ring having 6 to 30 ring-forming carbon atoms, or a substituted or unsubstituted heterocycle having 3 to 30 ring-forming carbon atoms, or are bonded to an adjacent group to form a ring of Formula 3, 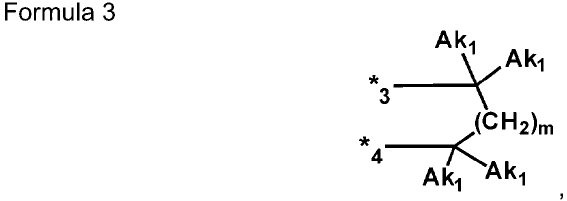 and
each Rₓ is independently represented by Formula 4-1 or Formula 4-2: 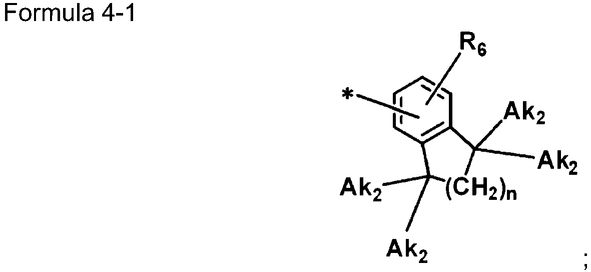 and 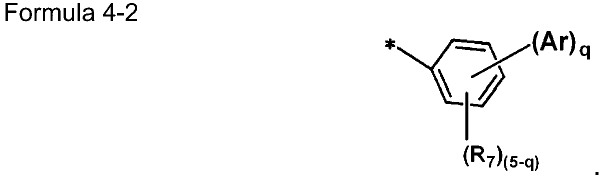 wherein, in Formula 3, Formula 4-1, and Formula 4-2,
*3 and *4 are portions to which the adjacent group is bonded,
m and n are each independently an integer of 1 to 3,
Ak₁ and Ak₂ are each independently a substituted or unsubstituted alkyl group having 1 to 10 carbon atoms,
R₆ is a hydrogen atom, a deuterium atom, a halogen atom, a substituted or unsubstituted amino group, a substituted or unsubstituted alkyl group having 1 to 10 carbon atoms, a substituted or unsubstituted aryl group having 6 to 30 ring-forming carbon atoms, or a substituted or unsubstituted heteroaryl group having 3 to 30 ring-forming carbon atoms, and when Rₓ is represented by Formula 4-1 or when t in Formula 2 is 0, R₆ is a substituted or unsubstituted aryl group having 6 to 30 ring-forming carbon atoms,
R₇ is a hydrogen atom, a deuterium atom, a halogen atom, a cyano group, a substituted or unsubstituted alkyl group having 1 to 10 carbon atoms, or a substituted or unsubstituted aryl group having 6 to 30 ring-forming carbon atoms,
q is an integer of 0 to 5,
Ar is a substituted or unsubstituted aryl group having 6 to 30 ring-forming carbon atoms or a substituted or unsubstituted heteroaryl group having 3 to 30 ring-forming carbon atoms,
when, in Formula 2, t is 0, then Rₓ is represented by Formula 4-2, q is an integer of 2 to 5, and at least one selected from among R₁, R₂, and R₃ is represented by Formula 4-1,
when, in Formula 2, t is 1 and Rₓ is represented by Formula 4-2, then q is an integer of 2 to 5, and when t is 1 and all Rₓ are represented by Formula 4-2, then at least one selected from among R₁ to R₅ is represented by Formula 4-1 or at least one selected from among R₁ to R₅ is bonded to an adjacent group to form a ring of Formula 3, and
when, in Formula 2, t is 2 and all Rₓ are represented by Formula 4-2, then at least one selected from among R₁ to R₅ is represented by Formula 4-1 or at least one selected from among R₁ to R₅ is bonded to an adjacent group to form a ring of Formula 3.

2. The polycyclic compound of claim 1, wherein the polycyclic compound is represented by any one selected from among Formula 1A, Formula 1B, and Formulas 1C-1 to 1C-3: 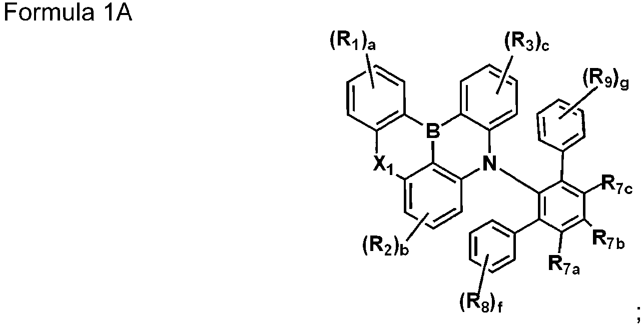 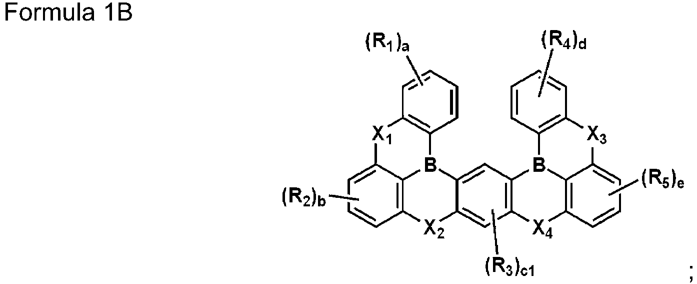 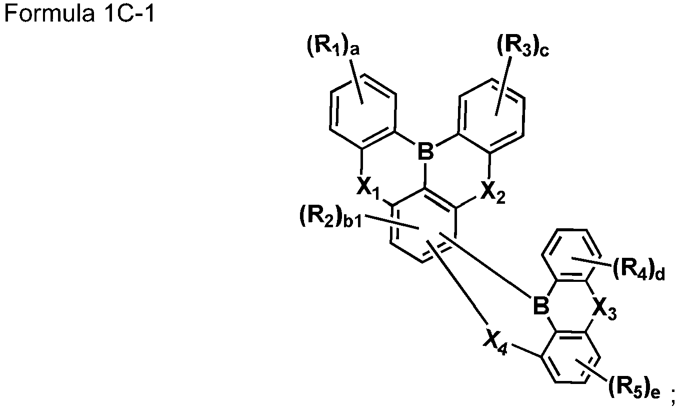 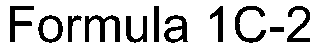 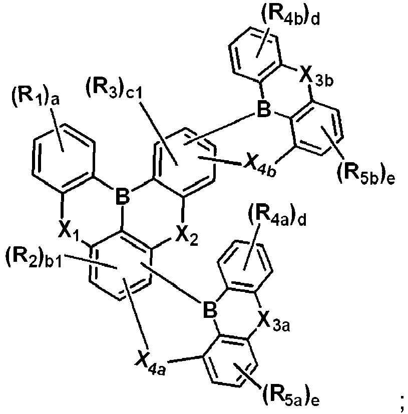 and 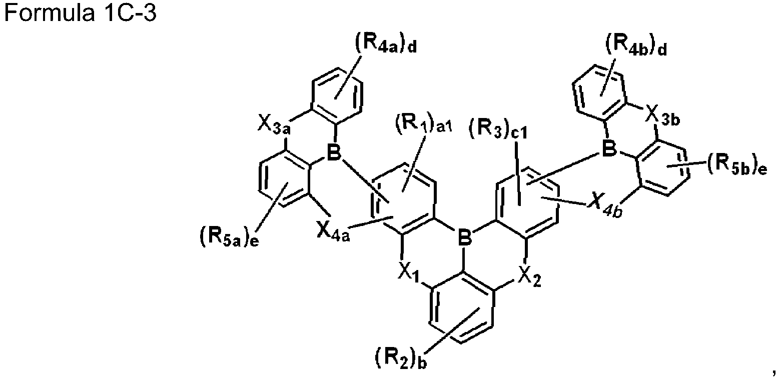 wherein, in Formula 1A,
f and g are each independently an integer of 0 to 5, and
R₈, R₉, R₇ₐ, R_{7b}, and R_{7c} are each independently a hydrogen atom, a deuterium atom, a halogen atom, a cyano group, a substituted or unsubstituted alkyl group having 1 to 10 carbon atoms, or a substituted or unsubstituted aryl group having 6 to 30 ring-forming carbon atoms,
in Formulas 1C-2 and 1C-3,
X₃ₐ, X_{3b}, X₄ₐ, and X_{4b} are each independently O, S, or NRₓ, and
R₄ₐ, R_{4b}, R₅ₐ, and R_{5b} are each independently a hydrogen atom, a deuterium atom, a halogen atom, a cyano group, a substituted or unsubstituted amino group, a substituted or unsubstituted alkyl group having 1 to 20 carbon atoms, a substituted or unsubstituted hydrocarbon ring having 6 to 30 ring-forming carbon atoms, or a substituted or unsubstituted heterocycle having 3 to 30 ring-forming carbon atoms, or are bonded to an adjacent group to form a ring of Formula 3,
in Formulas 1B, 1C-1, and 1C-2,
b1 is 0 or 1, and
c1 is an integer of 0 to 2, and
in Formulas 1A, 1B, 1C-1, 1C-2, and 1C-3, X₁ to X₄, R₁ to R₅, and a to e are the same as defined in Formula 1 and Formula 2.

3. The polycyclic compound of claim 1 or claim 2, wherein Formula 1 is represented by Formula 1A: 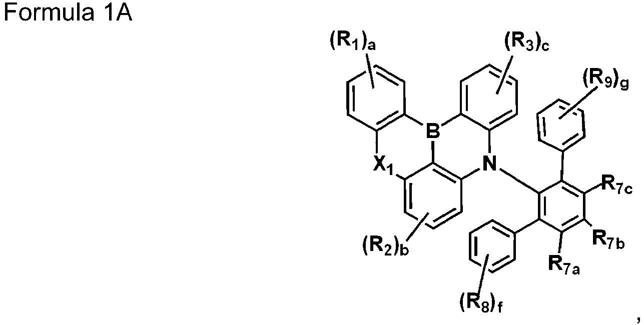
wherein, in Formula 1A, at least one selected from among R₁ to R₃ is represented by Formula 4-1, R₆ in Formula 4-1 is a substituted or unsubstituted aryl group having 6 to 30 ring-forming carbon atoms or a substituted or unsubstituted heteroaryl group having 3 to 30 ring-forming carbon atoms,
f and g are each independently an integer of 0 to 5,
R₈, R₉, R₇ₐ, R_{7b}, and R_{7c} are each independently a hydrogen atom, a deuterium atom, a halogen atom, a cyano group, a substituted or unsubstituted alkyl group having 1 to 10 carbon atoms, or a substituted or unsubstituted aryl group having 6 to 30 ring-forming carbon atoms, and
X₁, R₁ to R₃, and a to c are the same as defined in Formula 1.

4. The polycyclic compound of claim 1 or claim 2, wherein Formula 1 is represented by Formula 1B: 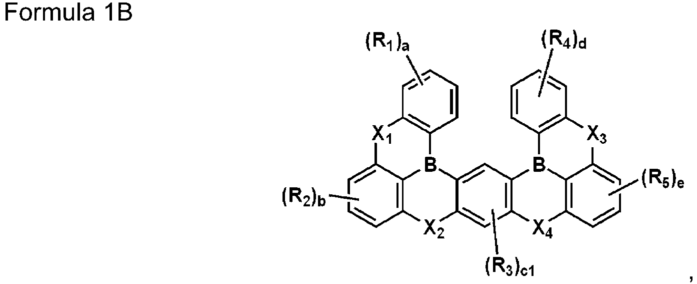 wherein, in Formula 1B,
c1 is an integer of 0 to 2,
one or two selected from among X₁ to X₄ are NRₓ, and the others are O or S, and
Rₓ, R₁ to R₅, and a, b, d, and e are the same as defined in Formula 1 and Formula 2.

5. The polycyclic compound of claim 4, wherein Formula 1B is represented by any one selected from among Formulas 1B-1 to 1B-4: 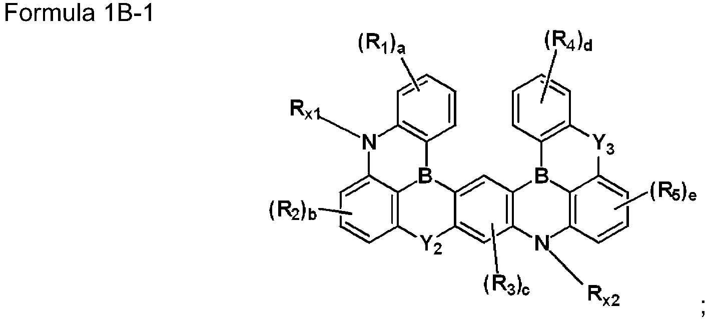 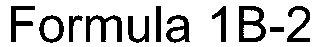 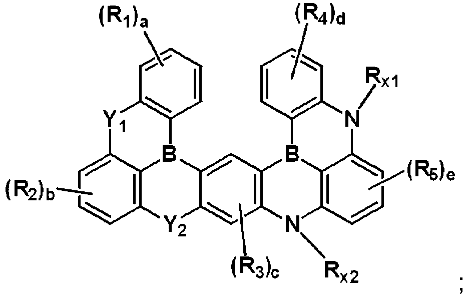 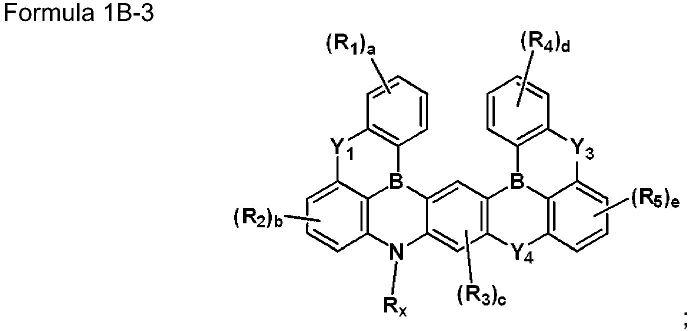 and 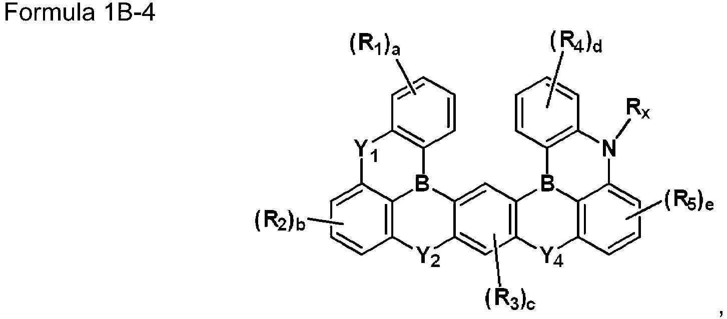 wherein, in Formulas 1B-1 to 1B-4,
Y₁ to Y₄ are each independently O or S,
Rₓ₁ and Rₓ₂ are each independently represented by Formula 4-1 or Formula 4-2,
when both Rₓ₁ and Rₓ₂ are represented by Formula 4-2, at least one selected from among R₁ to R₅ is represented by Formula 4-1 or at least one selected from among R₁ to R₅ is bonded to an adjacent group to form a ring of Formula 3, and
Rₓ, R₁ to R₅, and a to e are the same as defined in Formula 1 and Formula 2.

6. The polycyclic compound of claim 1 or claim 2, wherein Formula 1 is represented by any one selected from among Formulas 1C-1 to 1C-3: 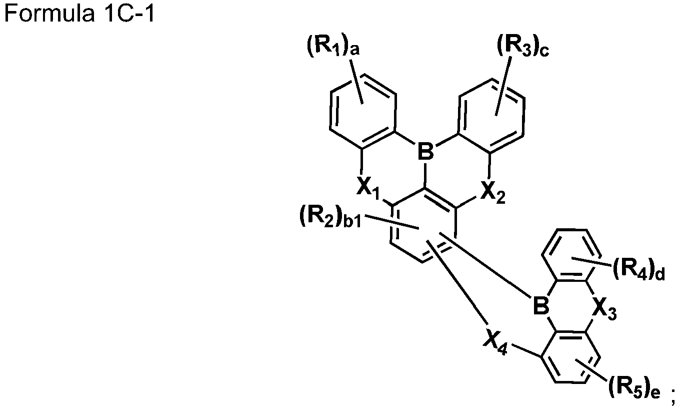 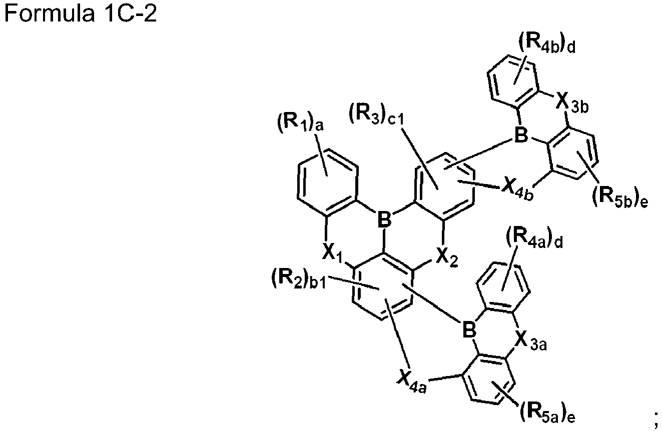 and 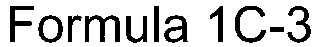 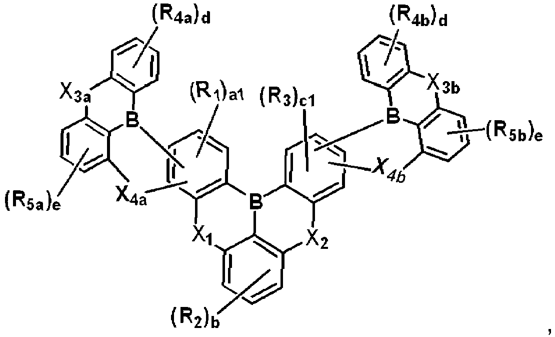 wherein, in Formulas 1C-2 and 1C-3,
X₃ₐ, X_{3b}, X₄ₐ, and X_{4b} are each independently O, S, or NRₓ, and
R₄ₐ, R_{4b}, R₅ₐ, and R_{5b} are each independently a hydrogen atom, a deuterium atom, a halogen atom, a cyano group, a substituted or unsubstituted amino group, a substituted or unsubstituted alkyl group having 1 to 20 carbon atoms, a substituted or unsubstituted hydrocarbon ring having 6 to 30 ring-forming carbon atoms, or a substituted or unsubstituted heterocycle having 3 to 30 ring-forming carbon atoms, or are bonded to an adjacent group to form a ring of Formula 3,
in Formulas 1C-1 and 1C-2,
b1 is 0 or 1, and
c1 is an integer of 0 to 2, and
in Formulas 1C-1, 1C-2, and 1C-3, X₁ to X₄, R₁ to R₅, and a to e are the same as defined in Formula 1 and Formula 2.

7. The polycyclic compound of any one of claims 1 to 6, wherein, in Formula 3 and Formula 4-1, m and n are 2, and Ak₁ and Ak₂ are methyl groups.

8. The polycyclic compound of any one of claims 1 to 7, wherein at least one hydrogen atom in the polycyclic compound is substituted with a deuterium atom.

9. The polycyclic compound of any one of claims 1 to 8, wherein at least one hydrogen atom in Formula 1 and Formula 2 is substituted with a deuterium atom.

10. The polycyclic compound of any one of claims 1 to 9, wherein the compound represented by Formula 1 is a blue emission dopant.

11. The polycyclic compound of any one of claims 1 to 10, wherein the compound represented by Formula 1 is a thermally activated delayed fluorescent compound.

12. The polycyclic compound of claim 1, wherein Formula 1 is represented by any one selected from among compounds in Compound Group 1: 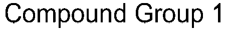 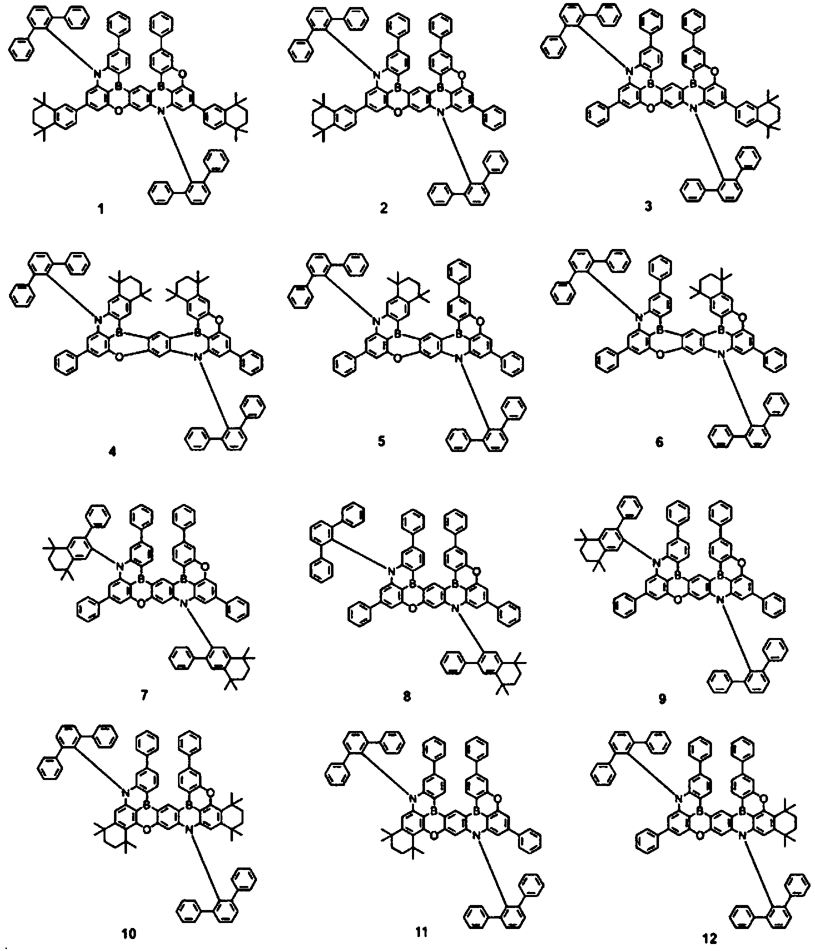 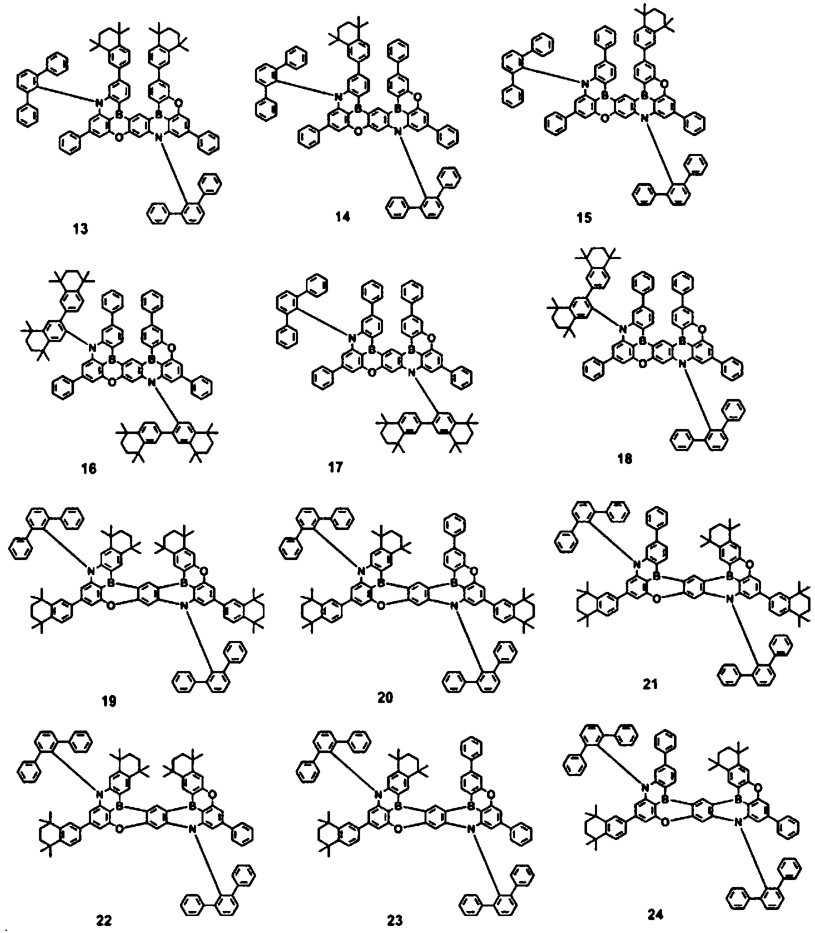 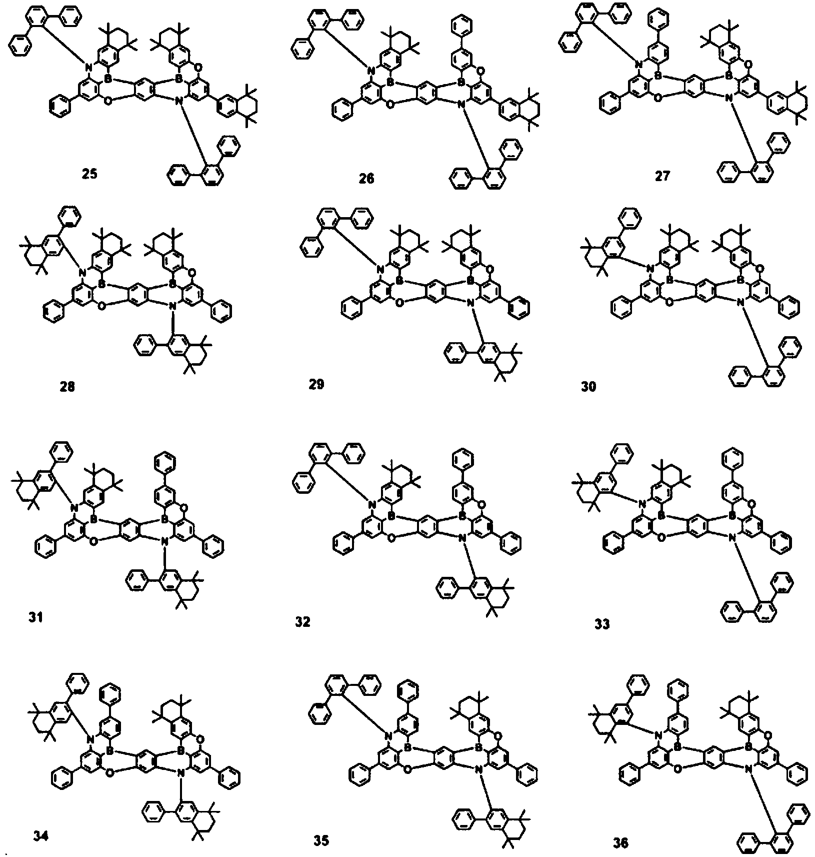 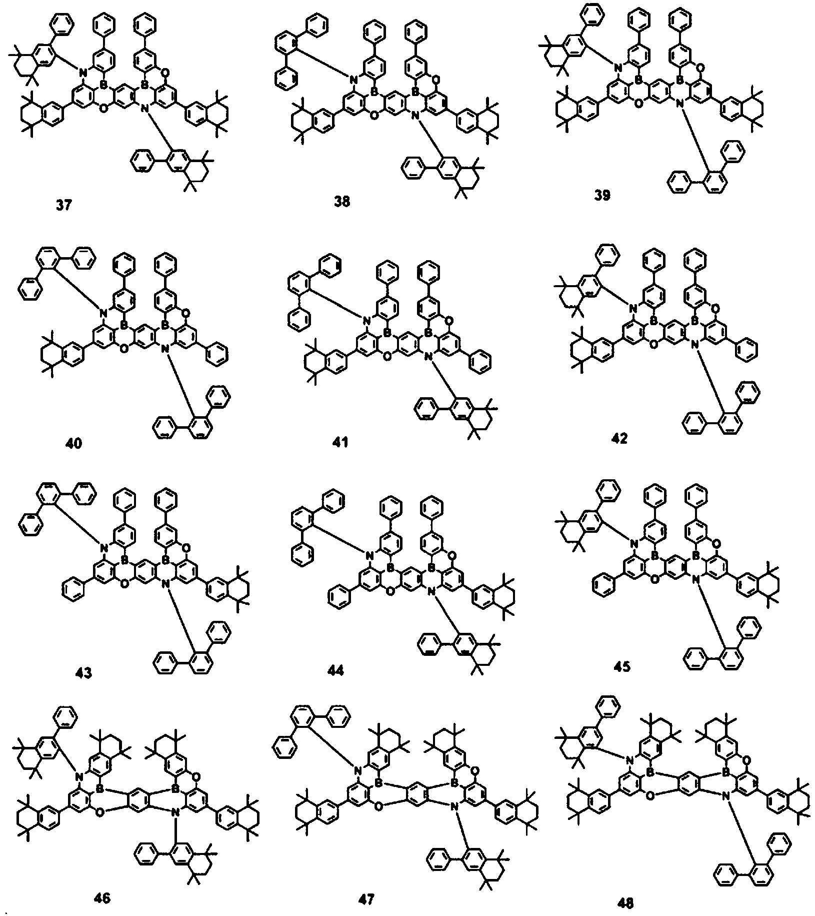 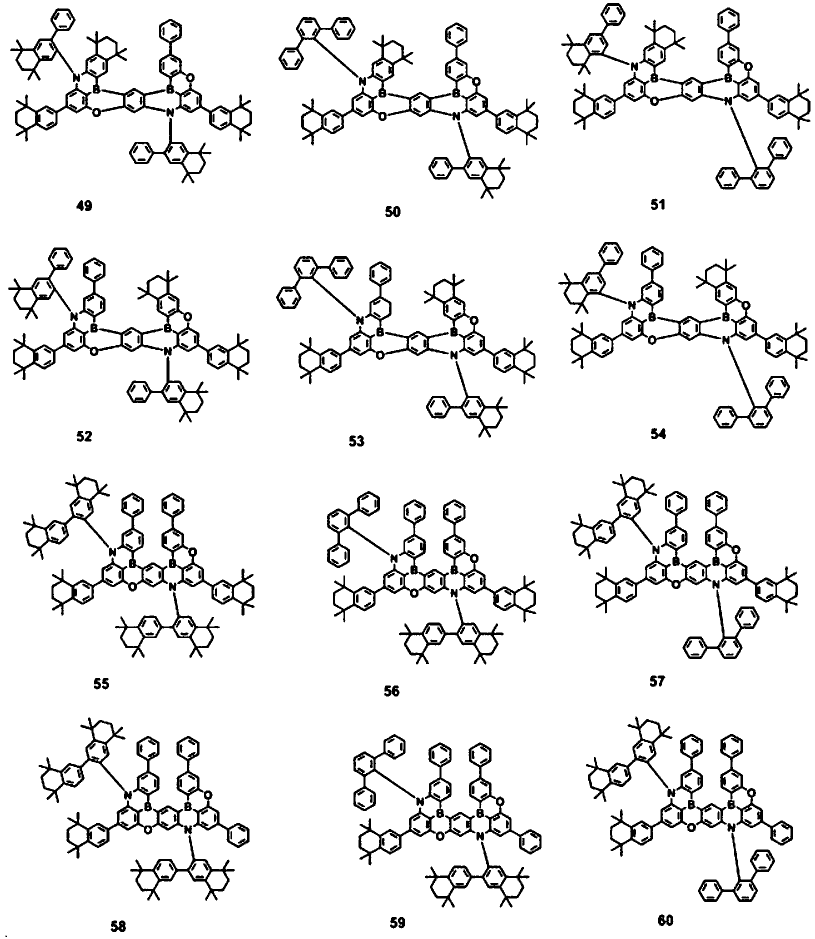 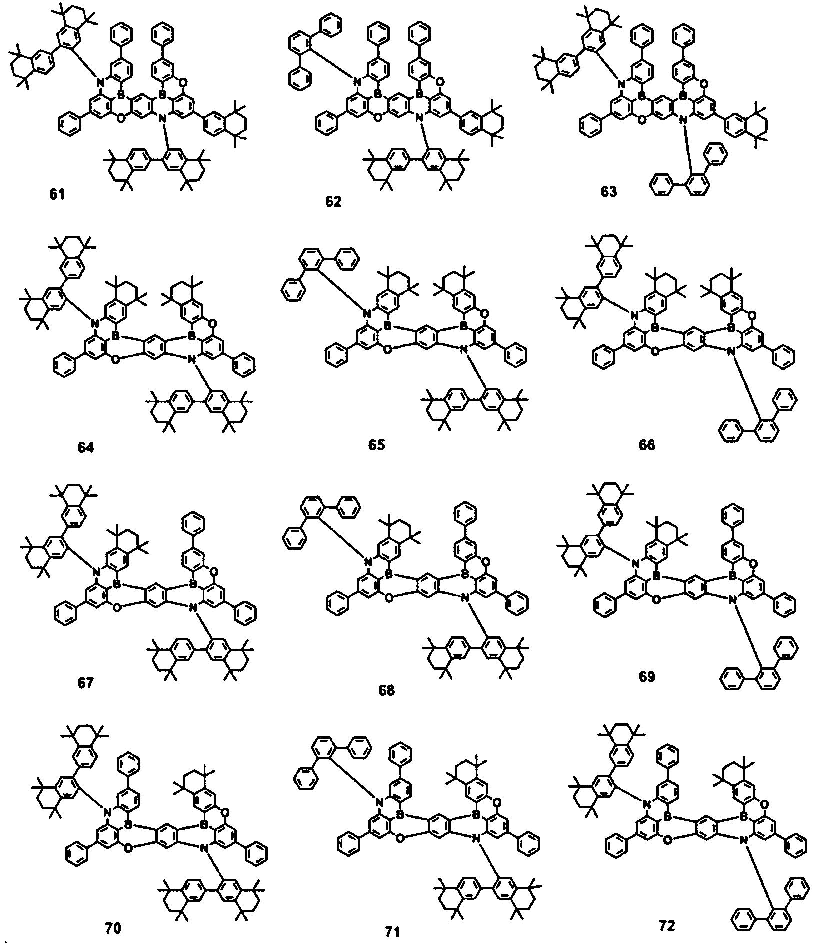 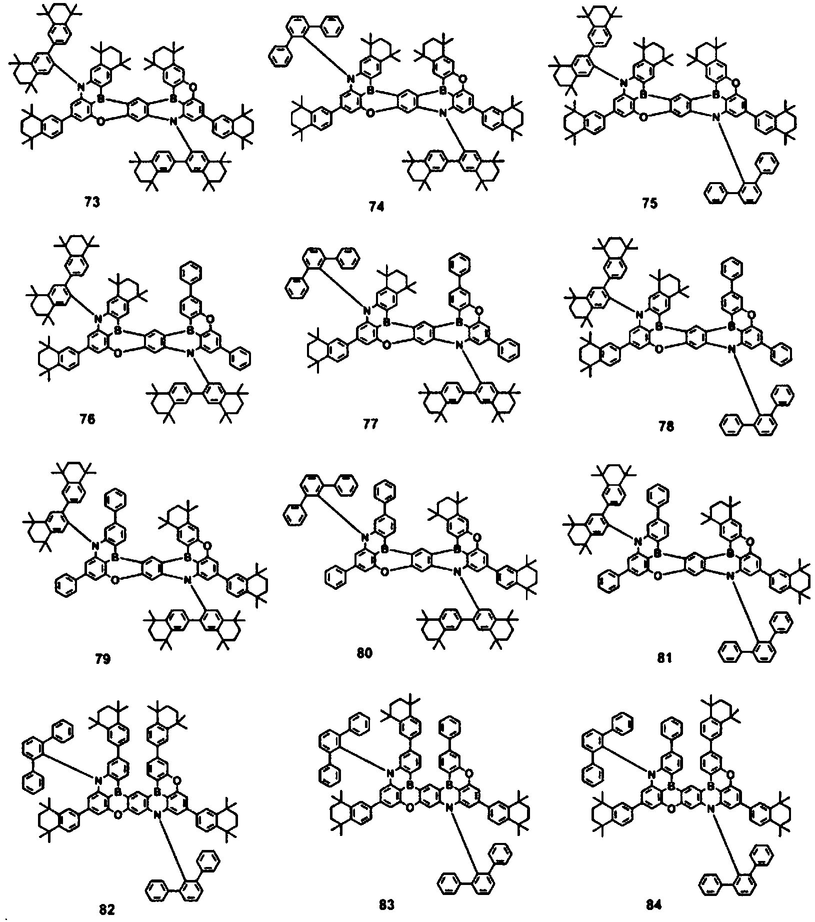 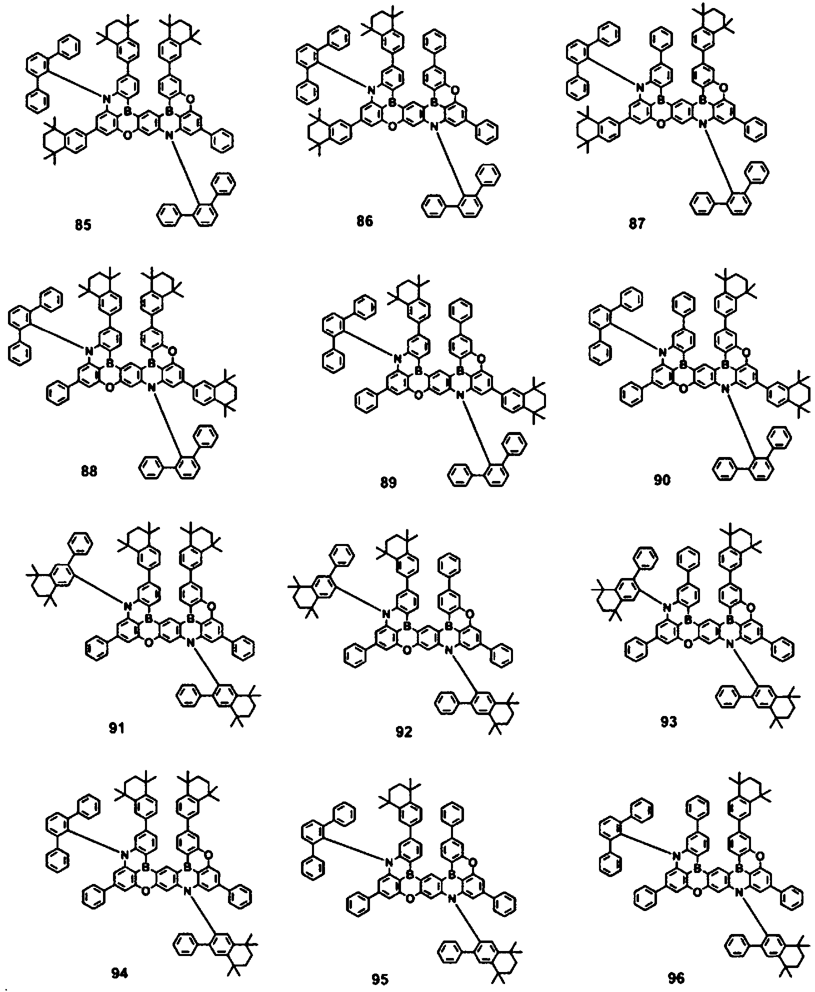 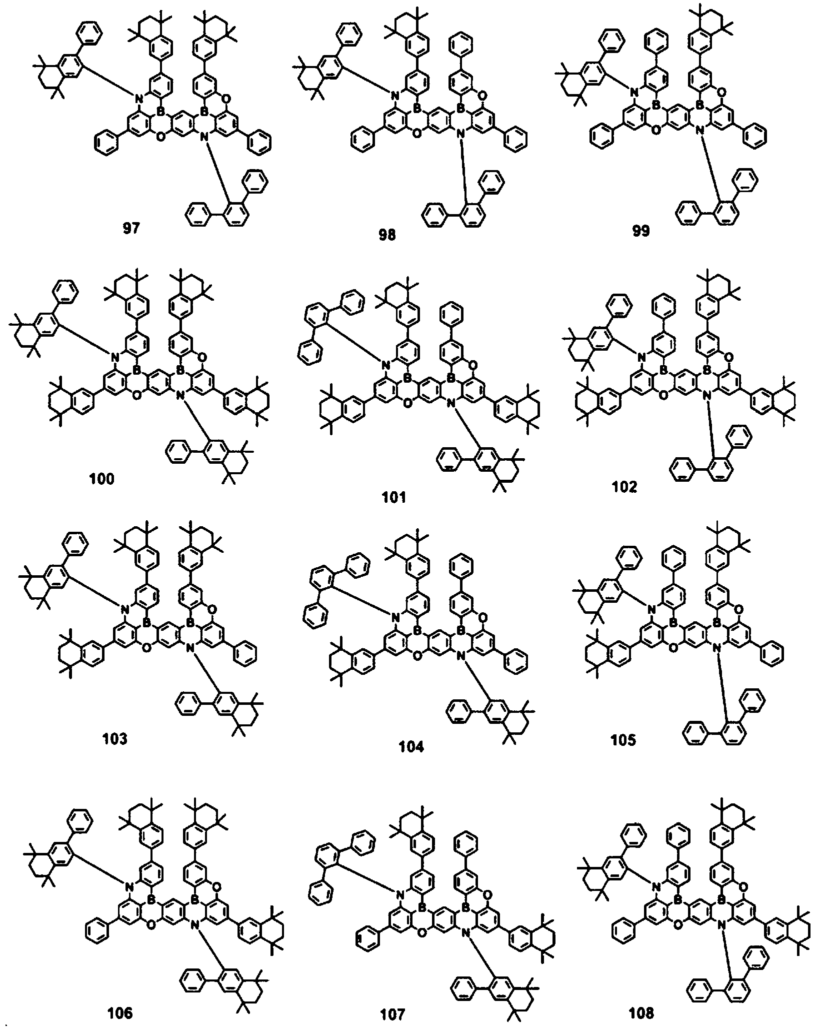 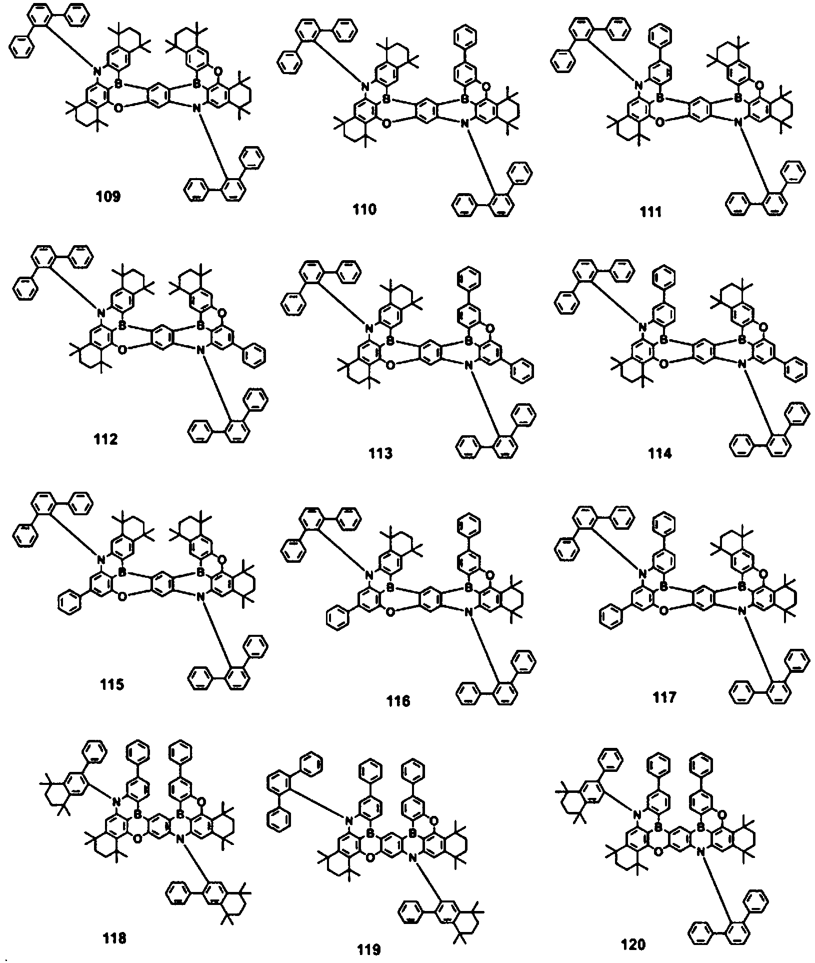 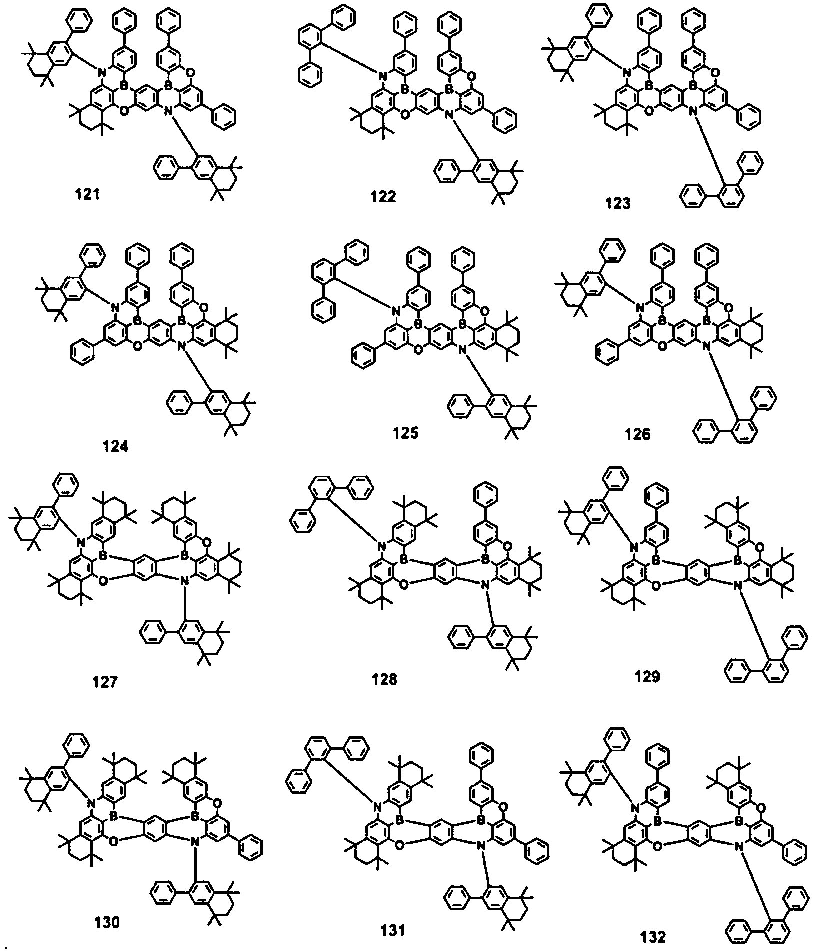 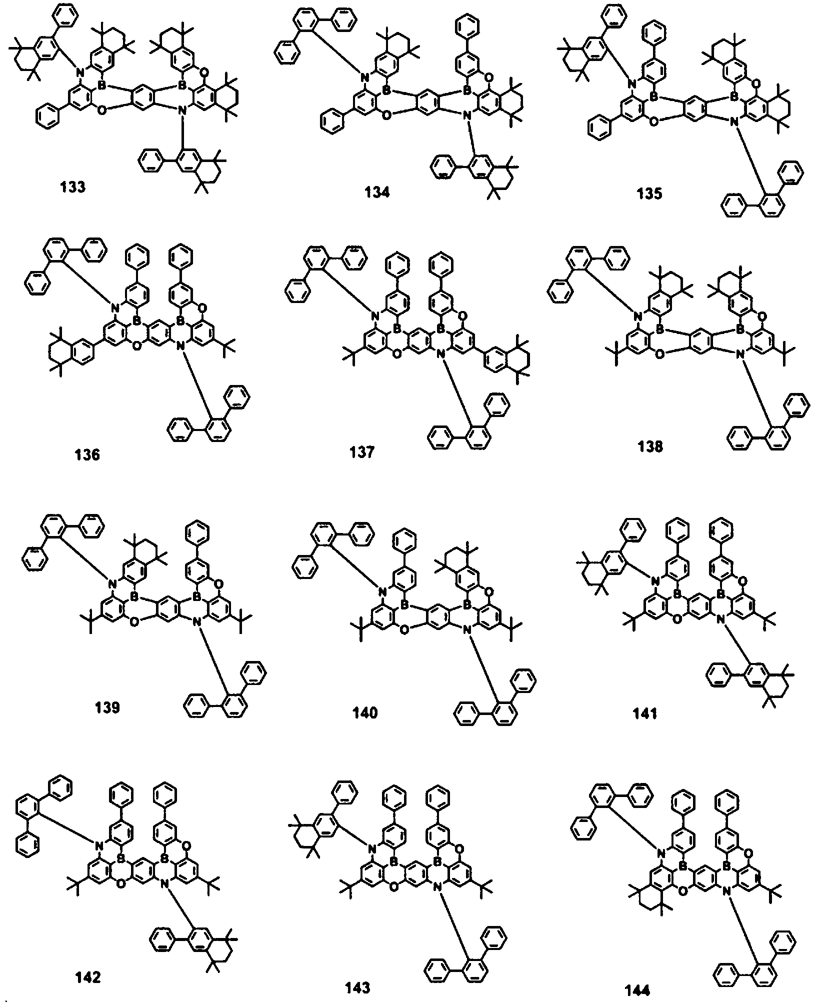 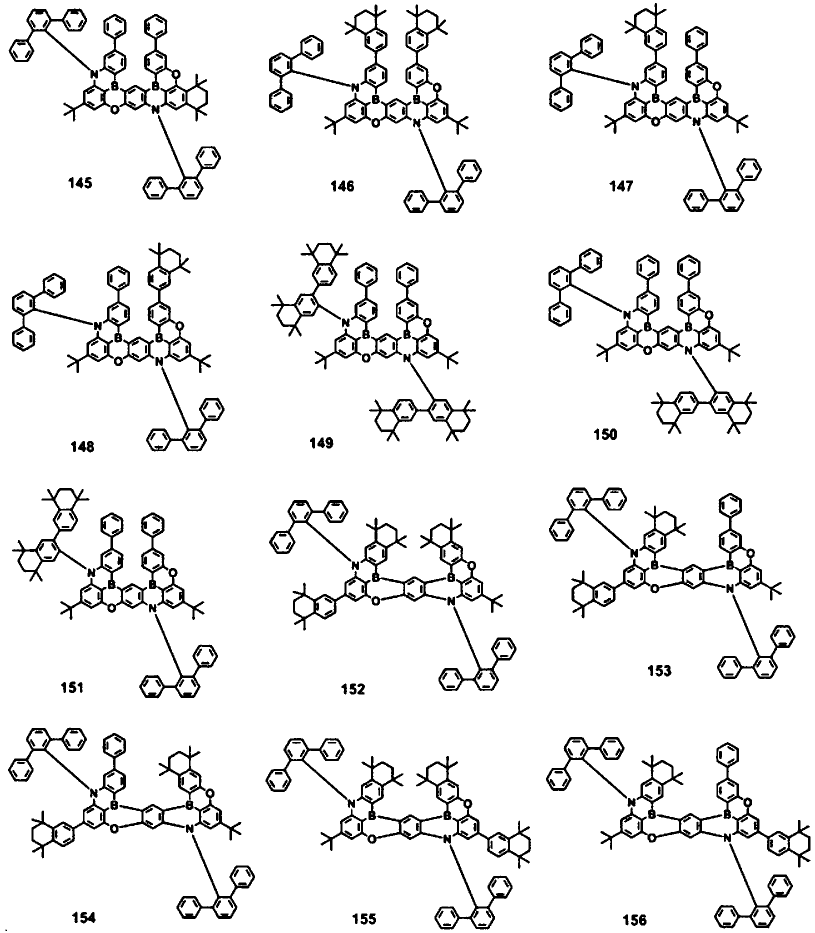 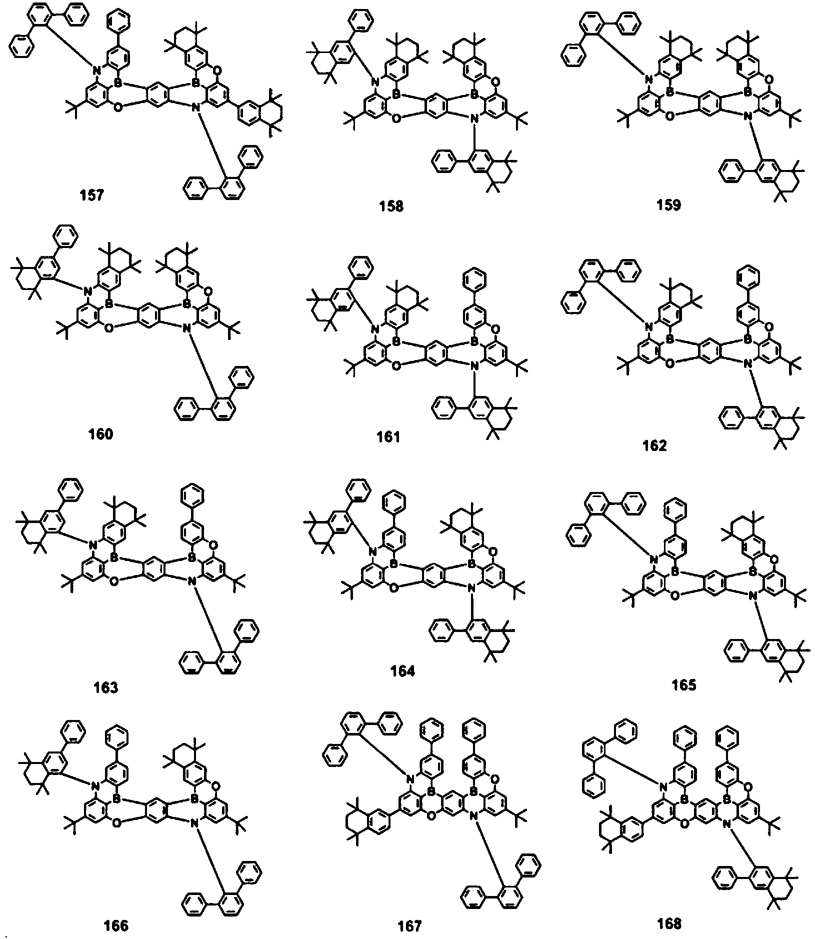 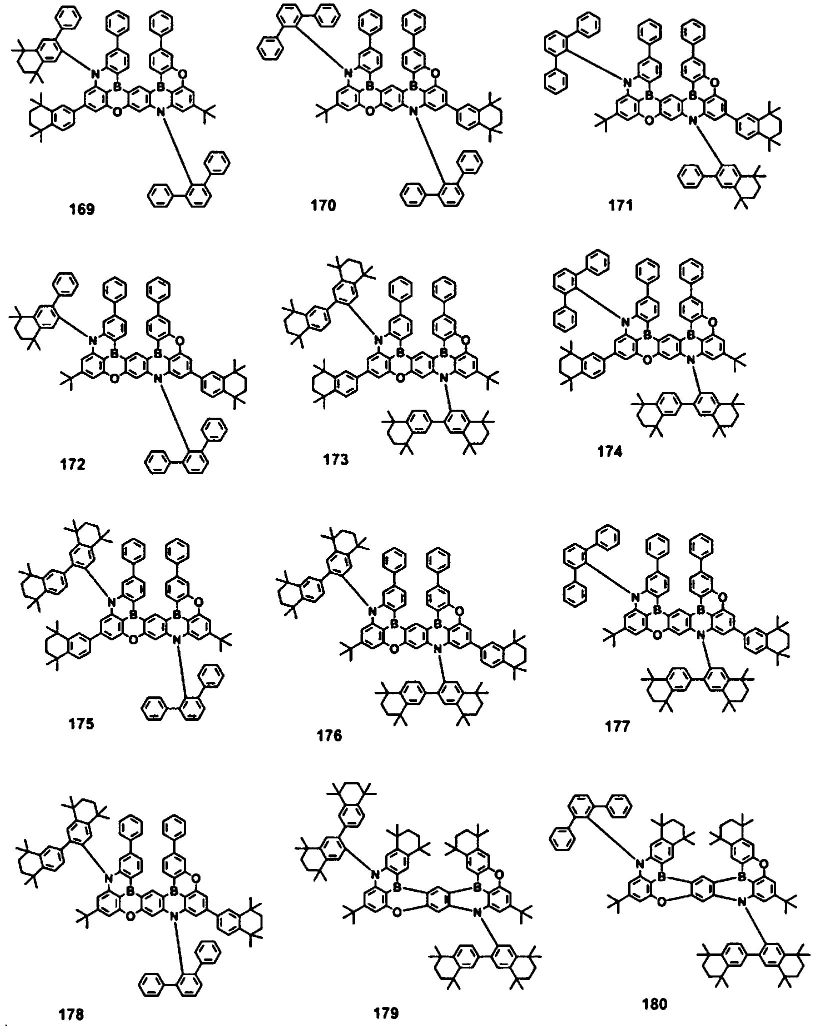 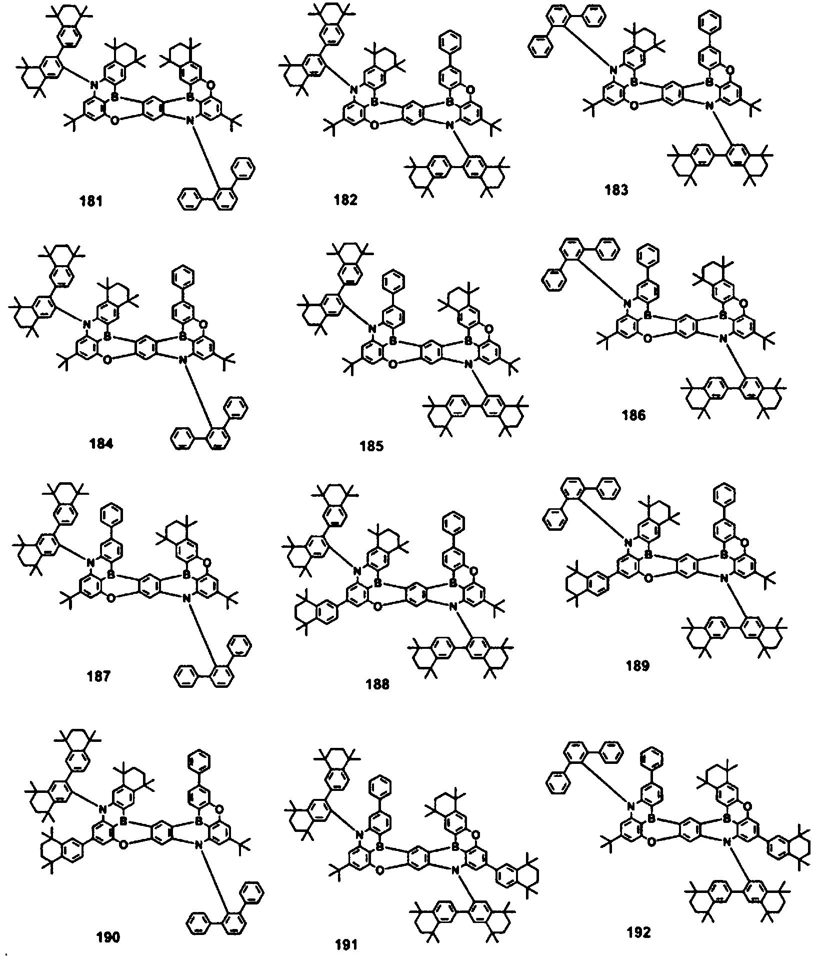 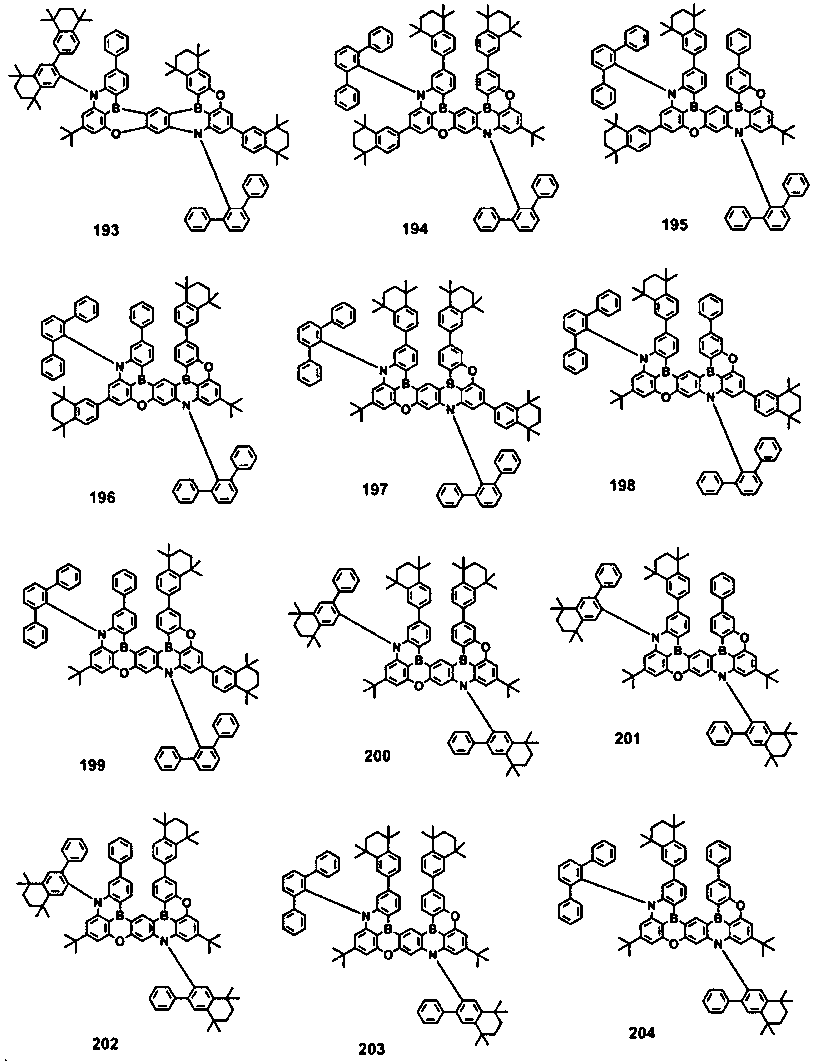 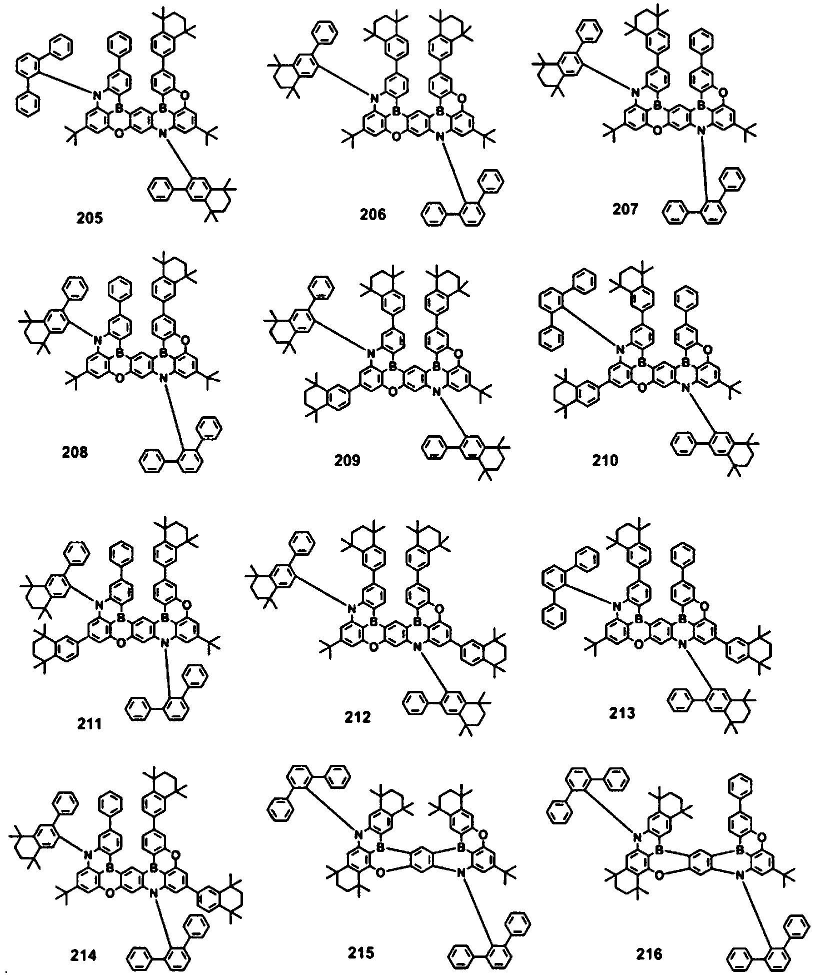 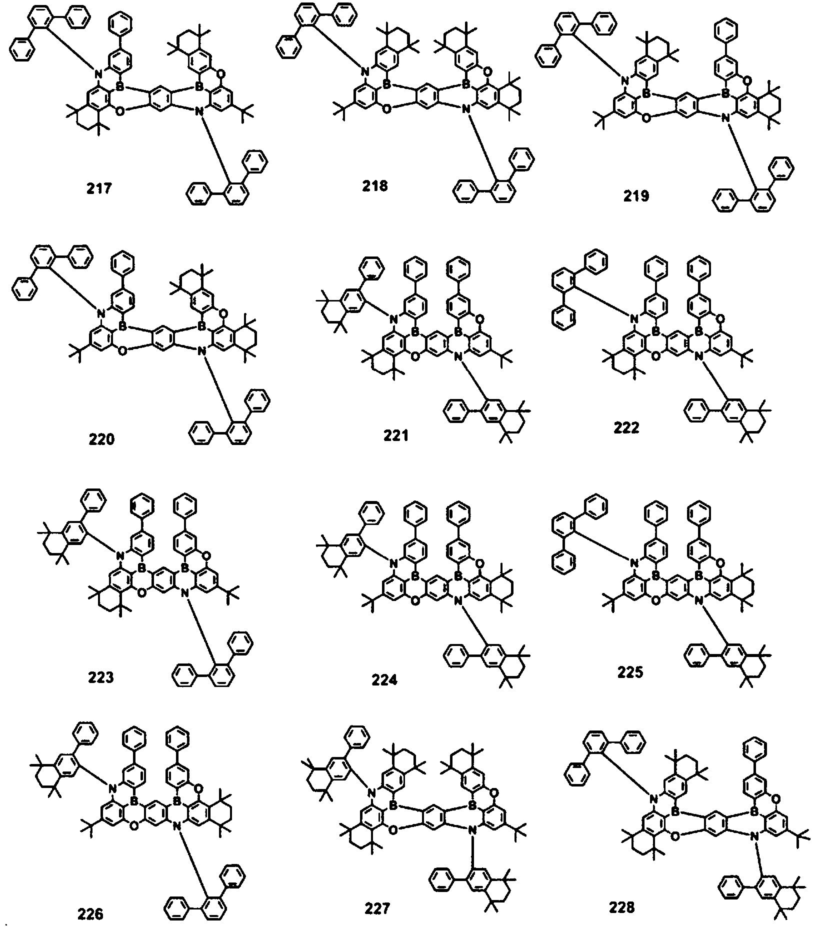 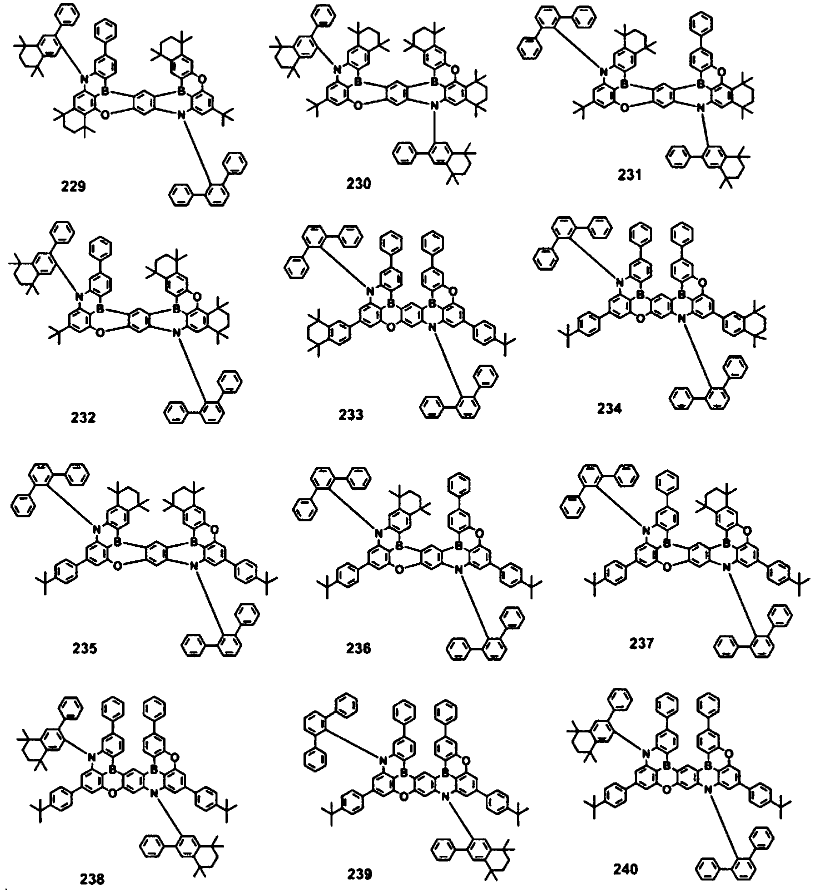 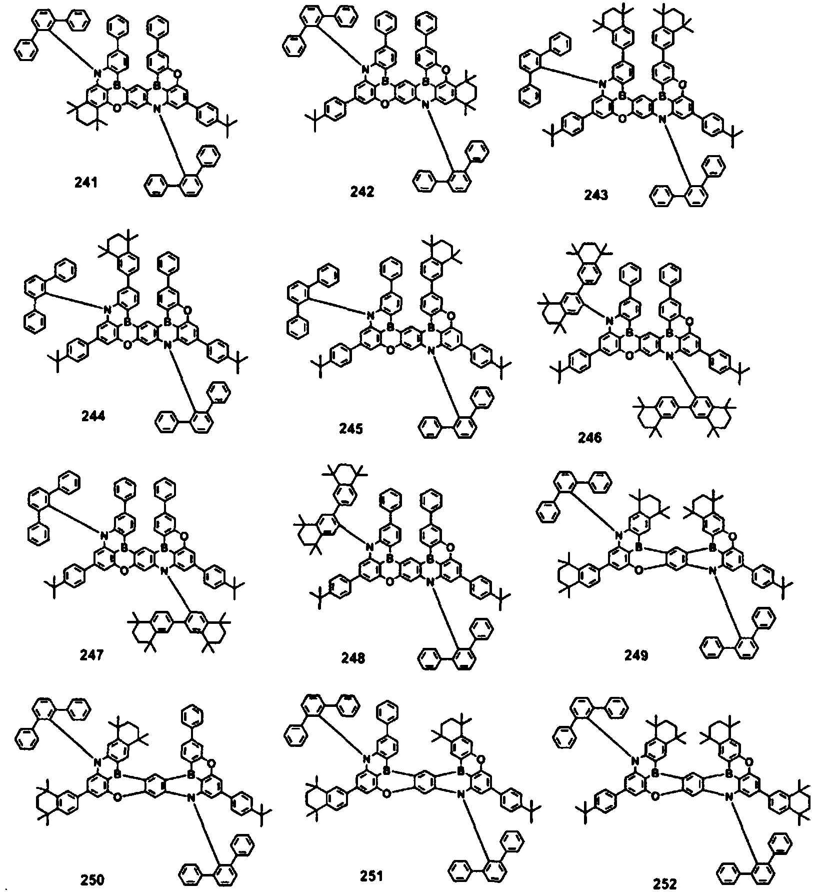 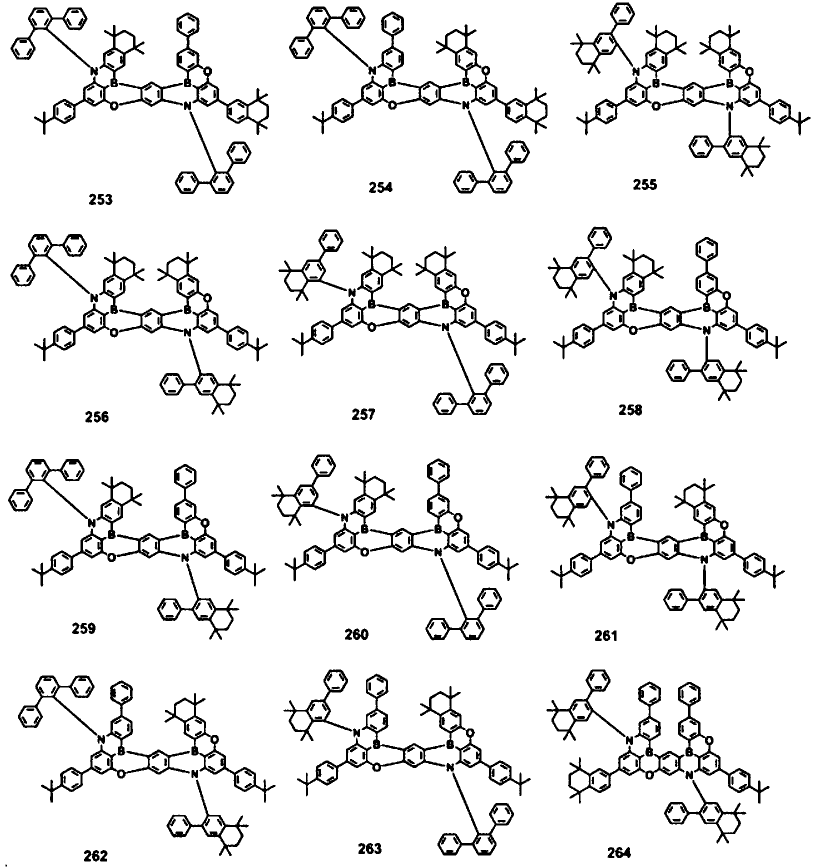 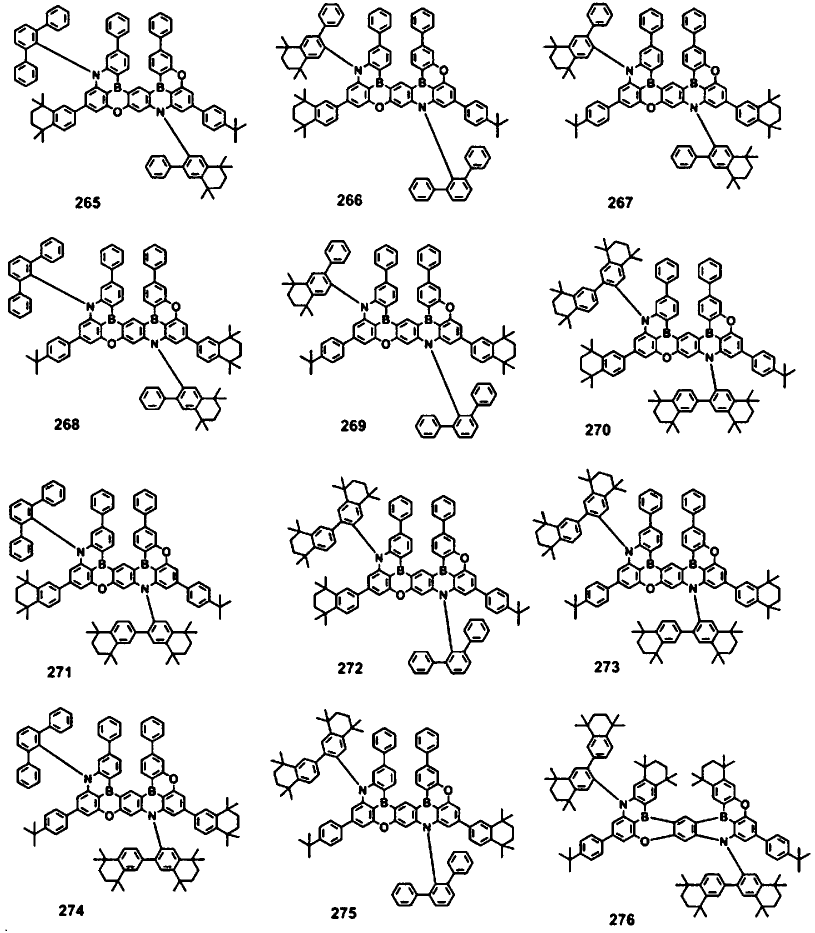 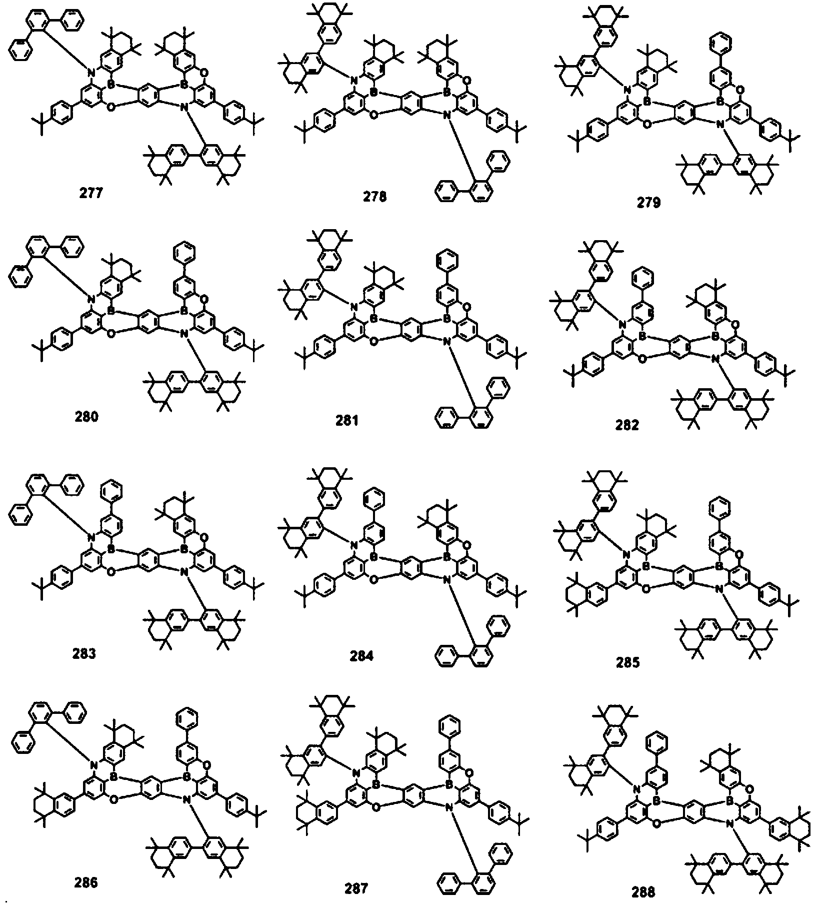 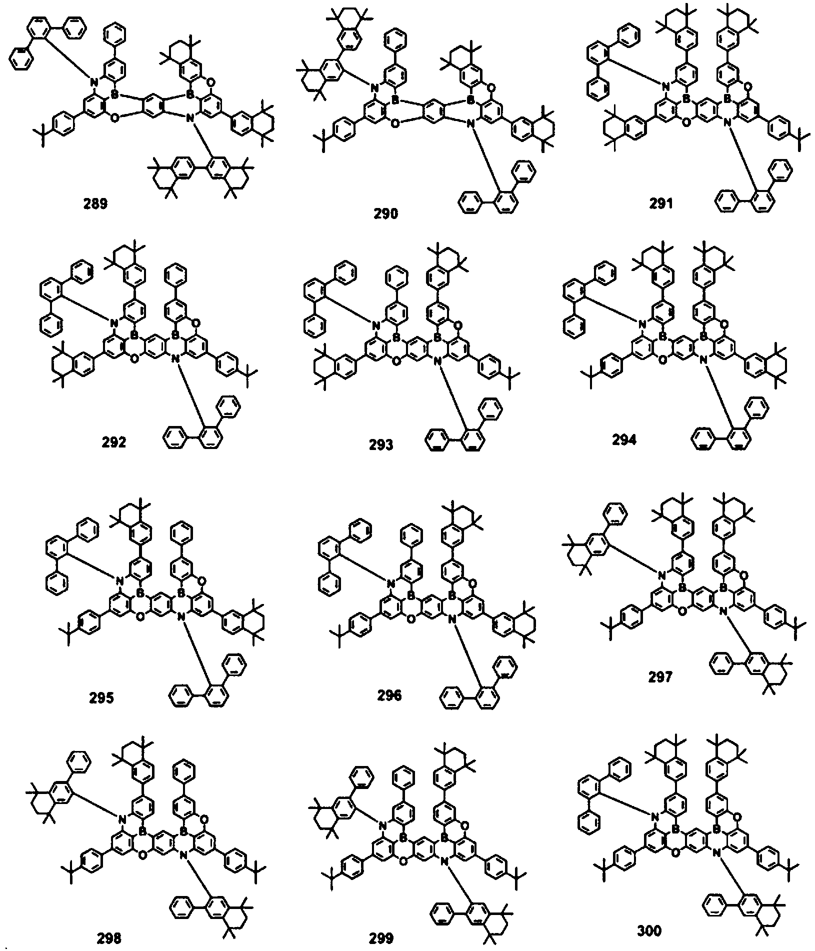 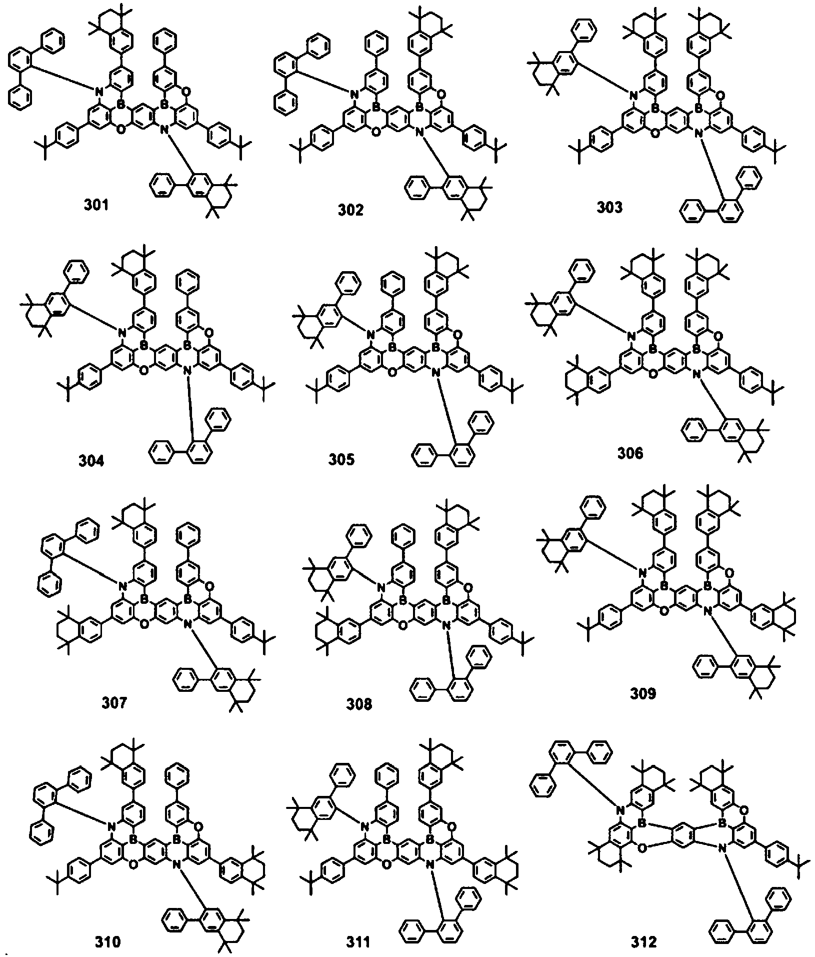 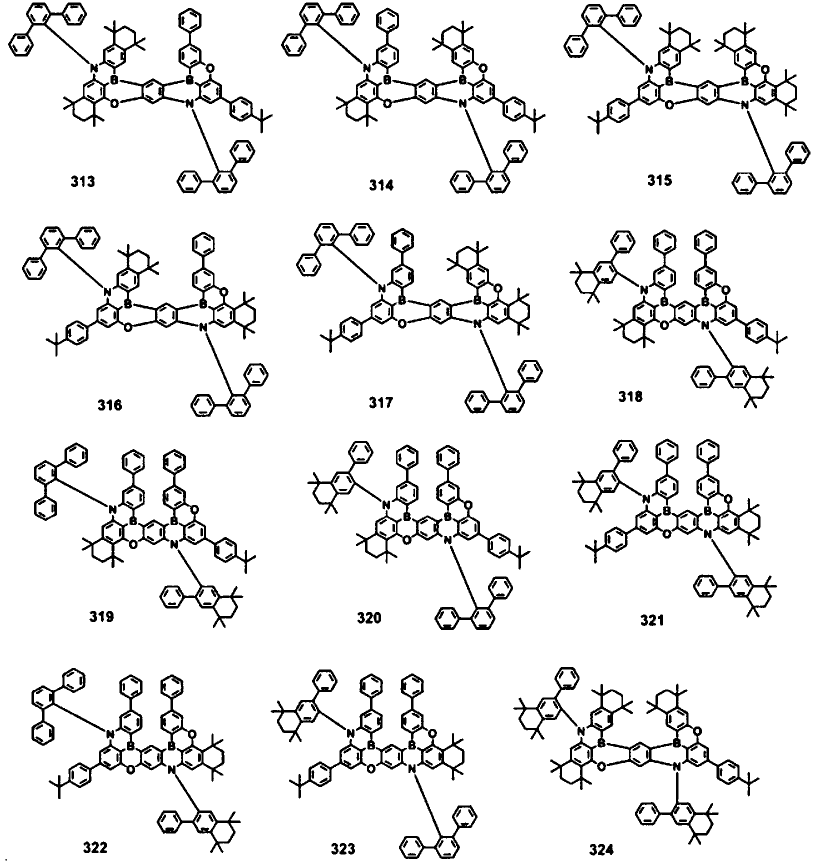 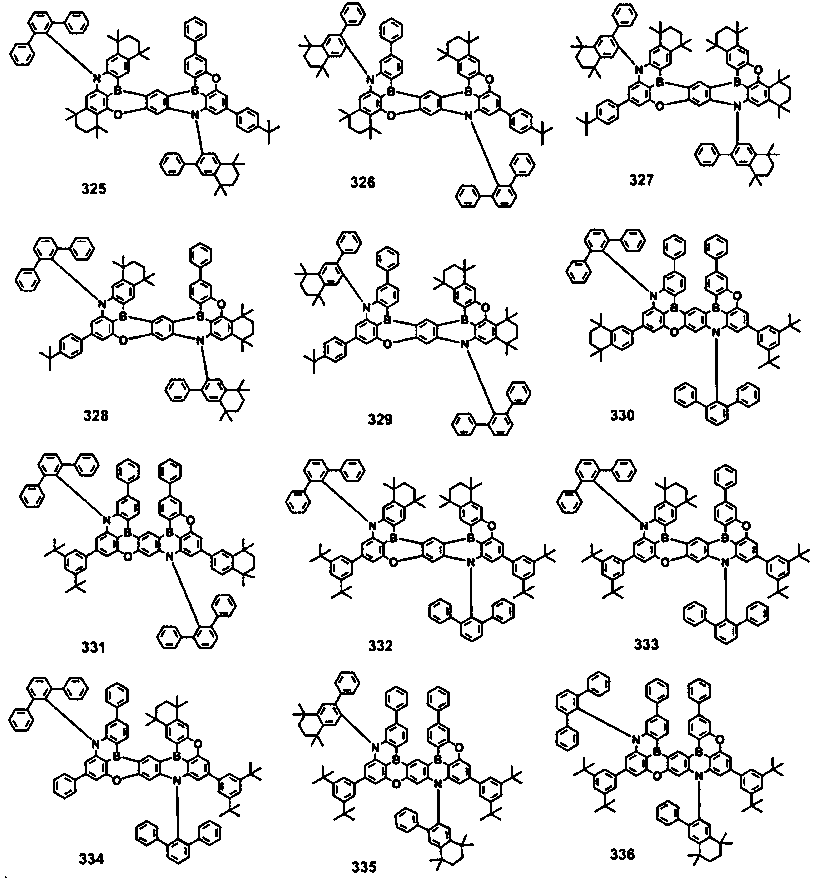 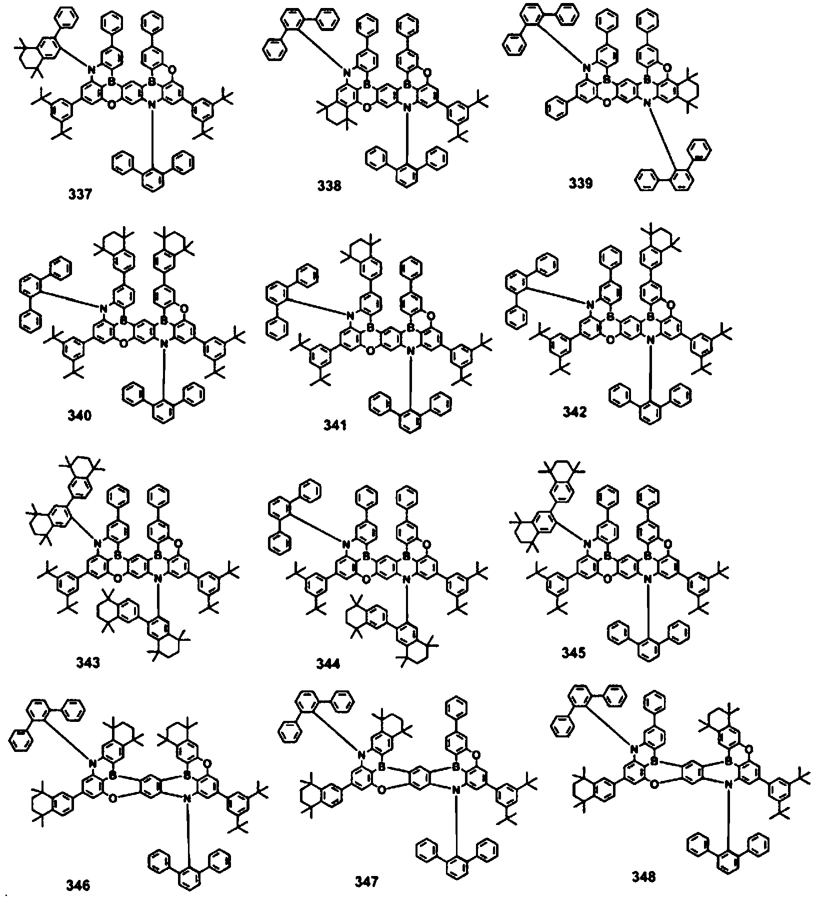 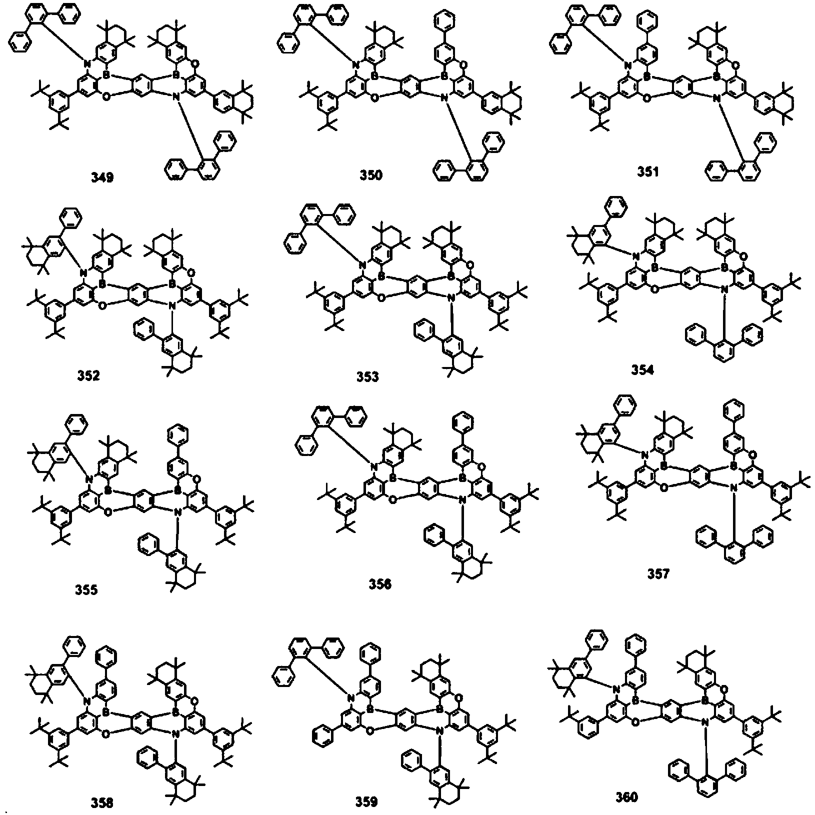 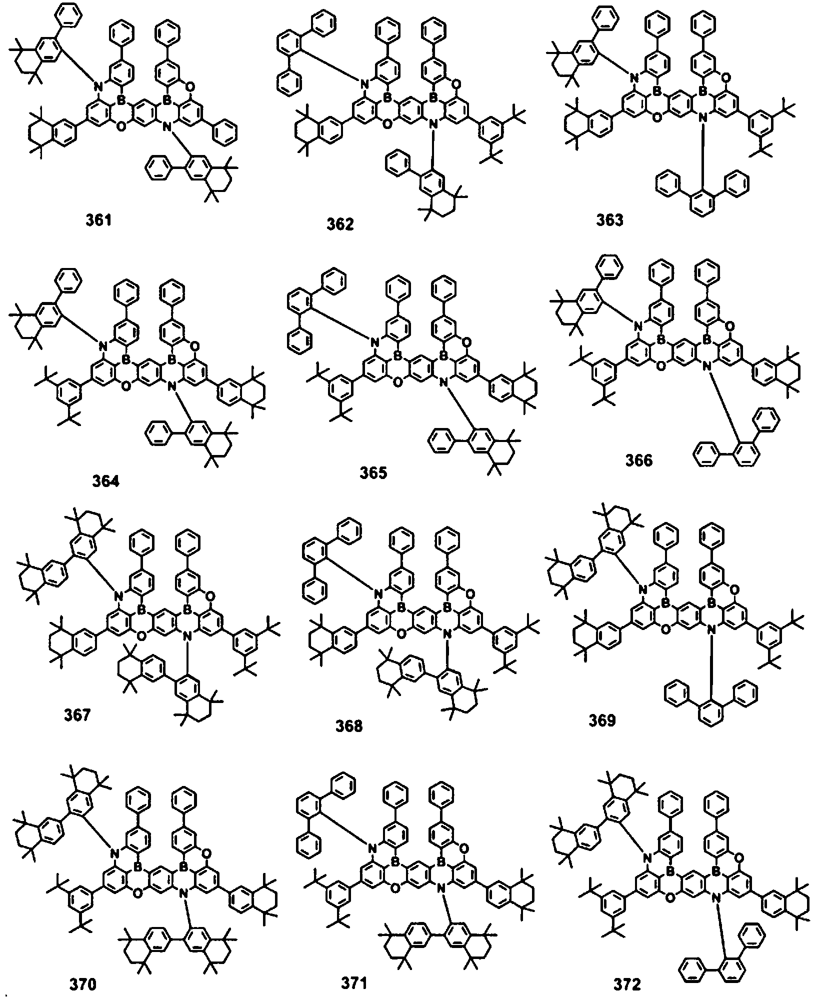 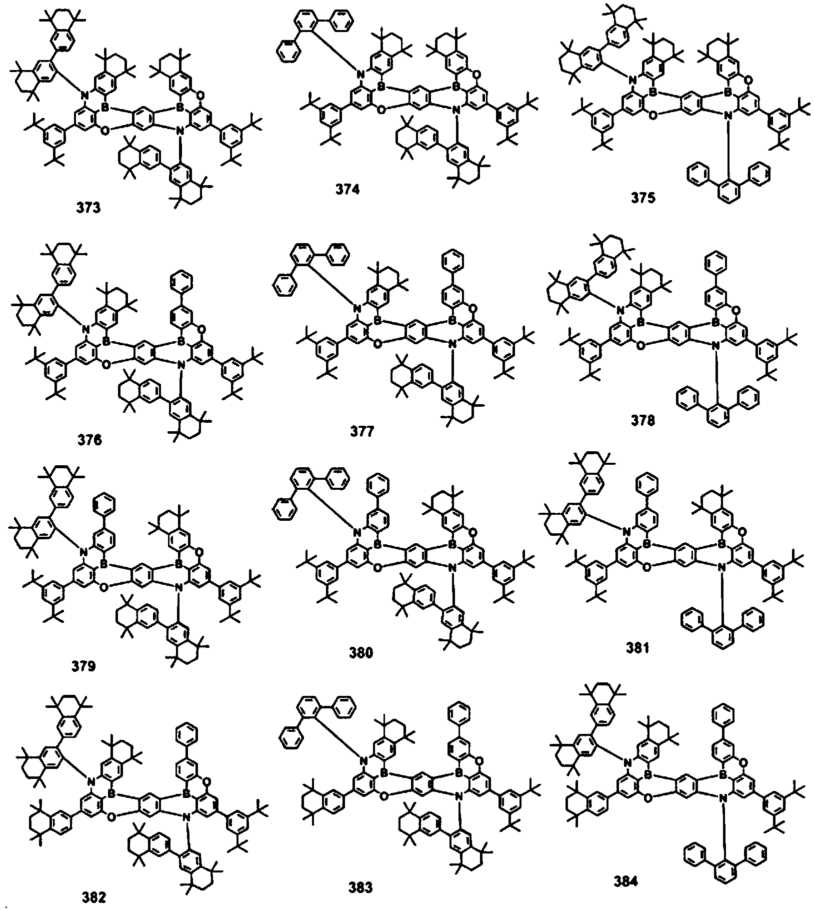 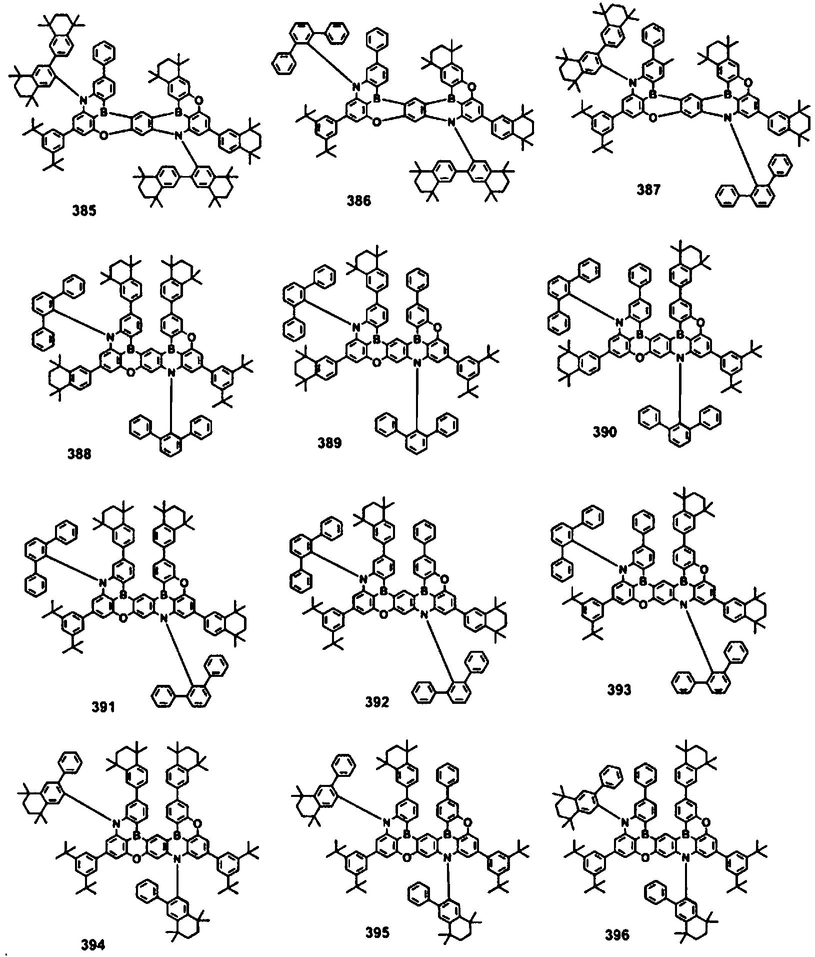 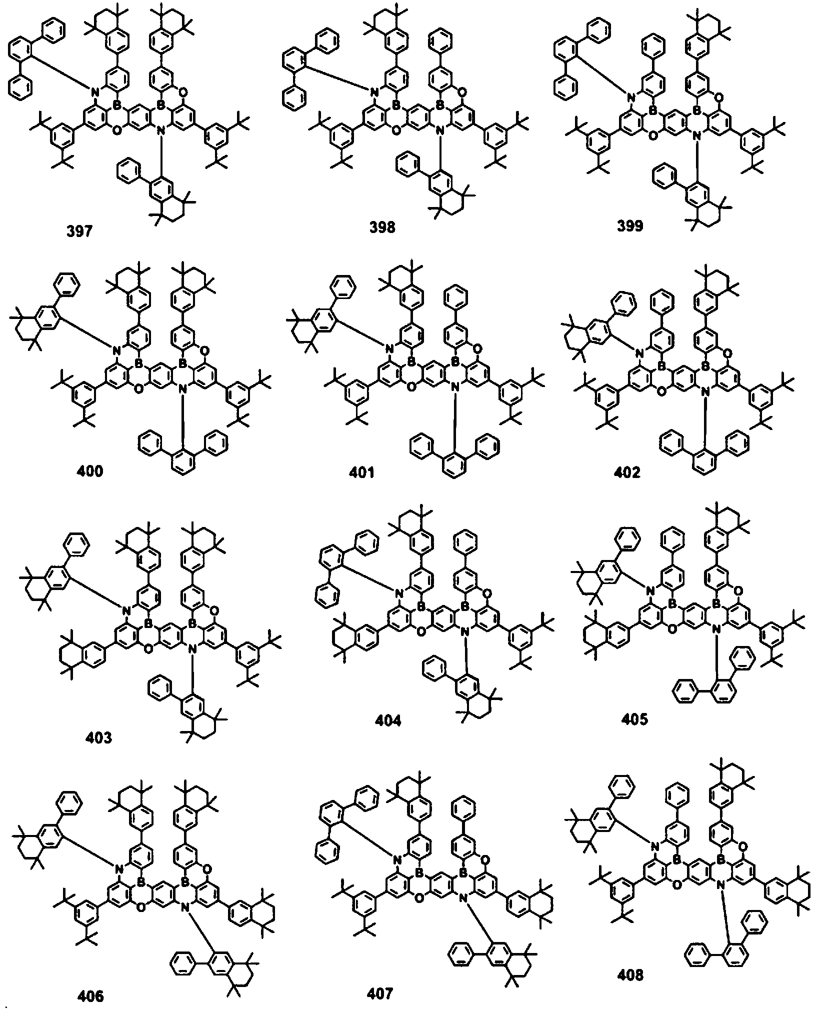 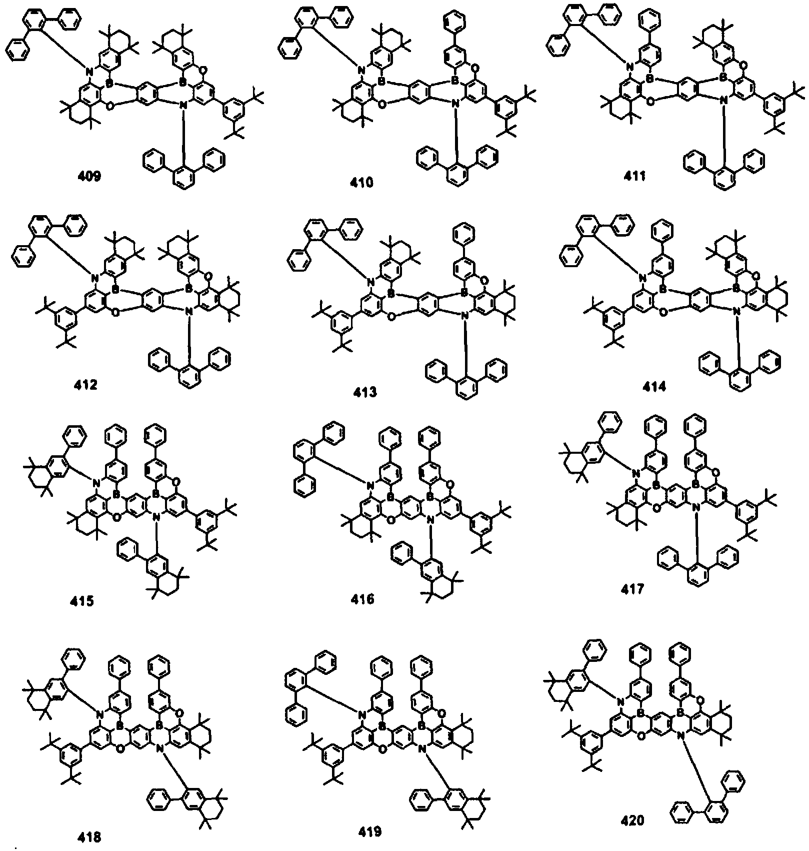 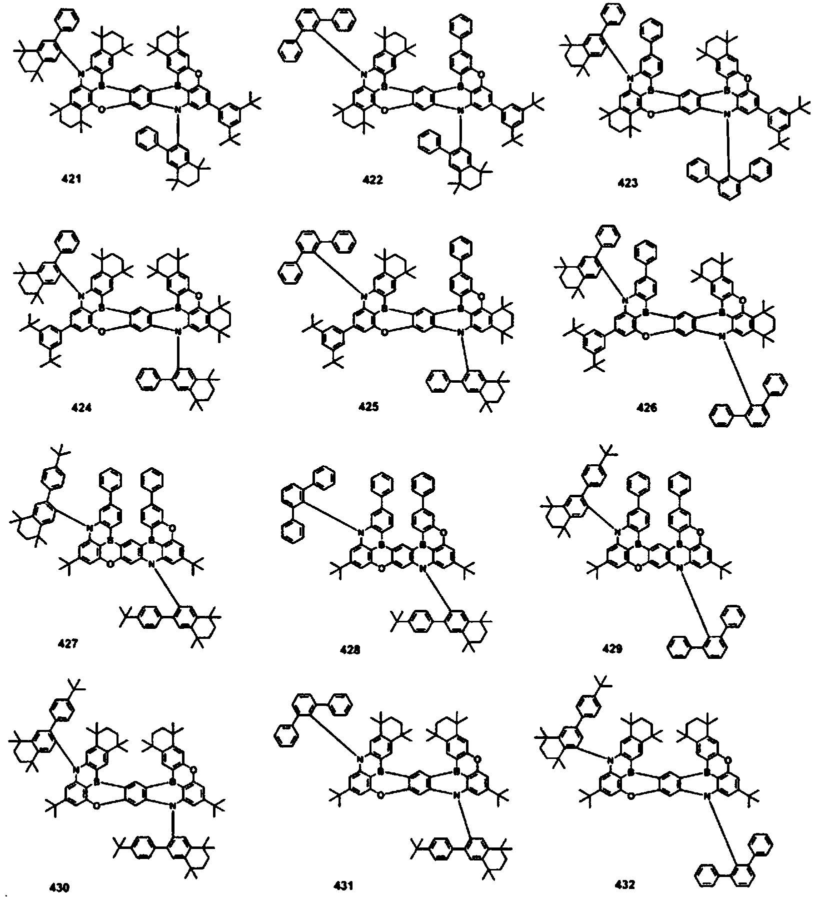 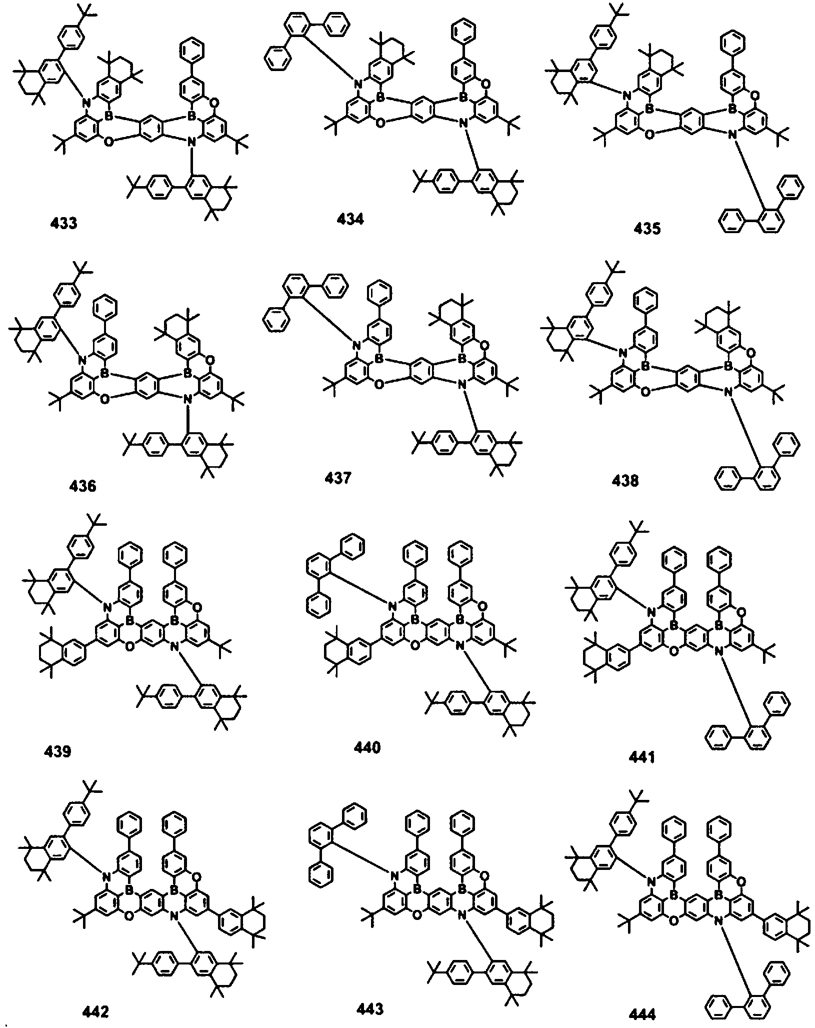 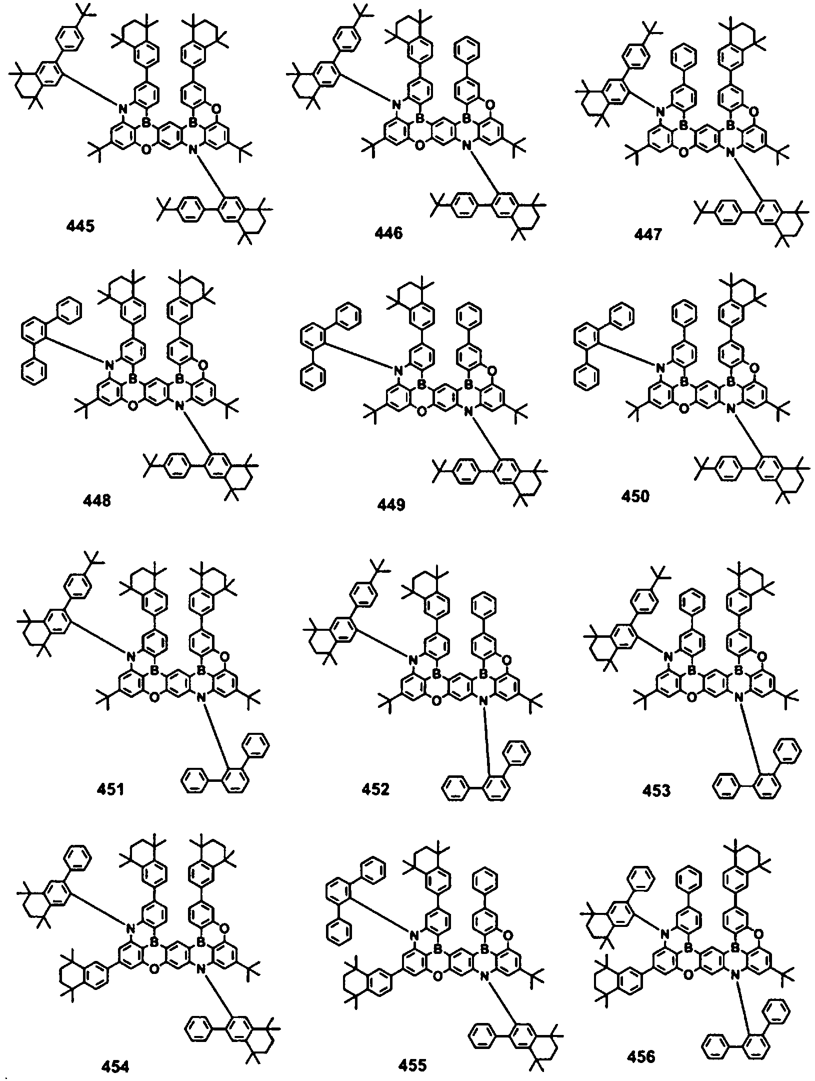 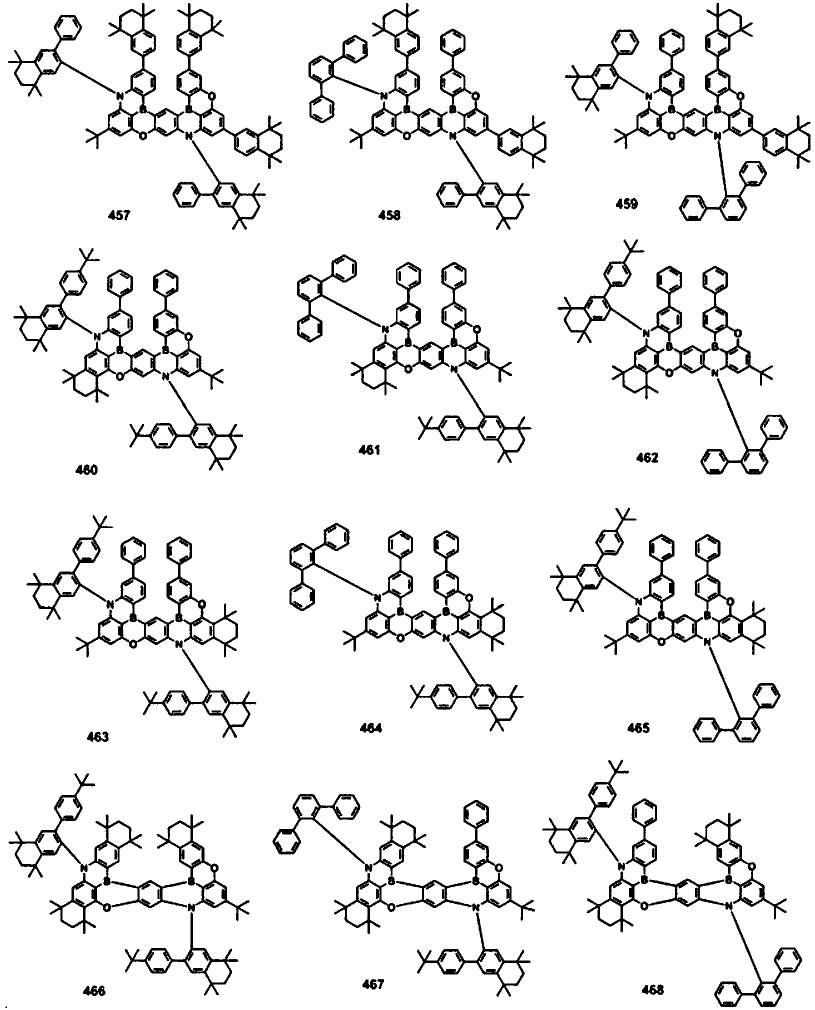 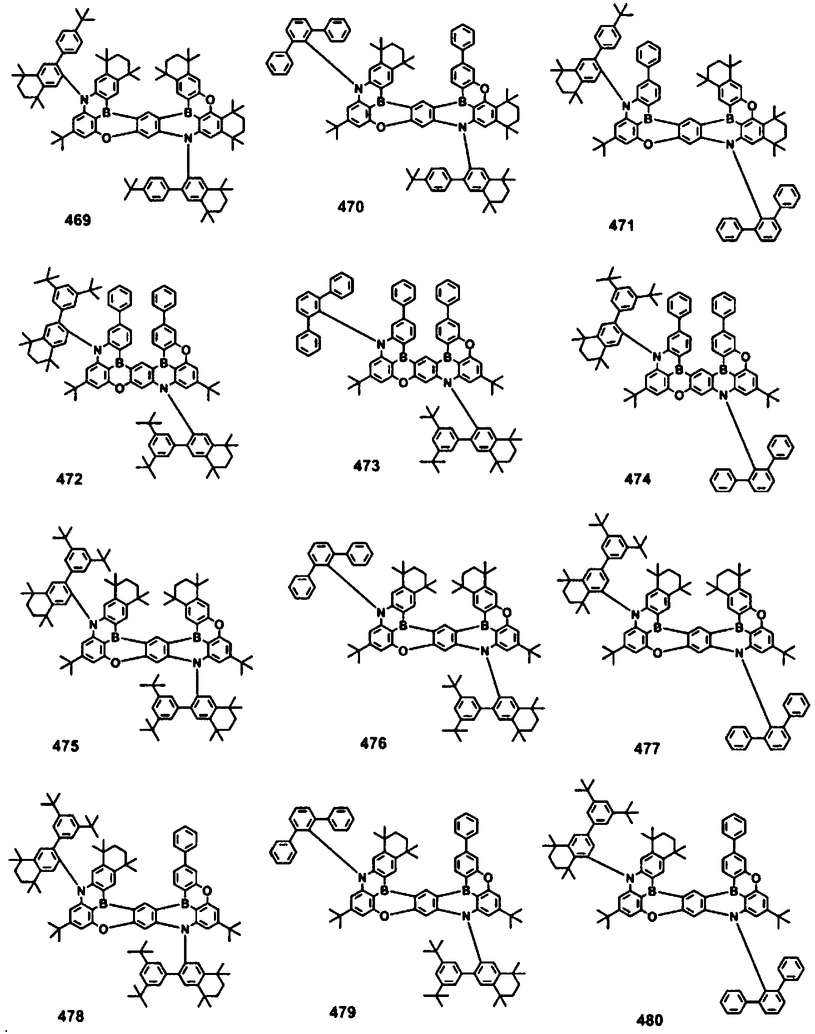 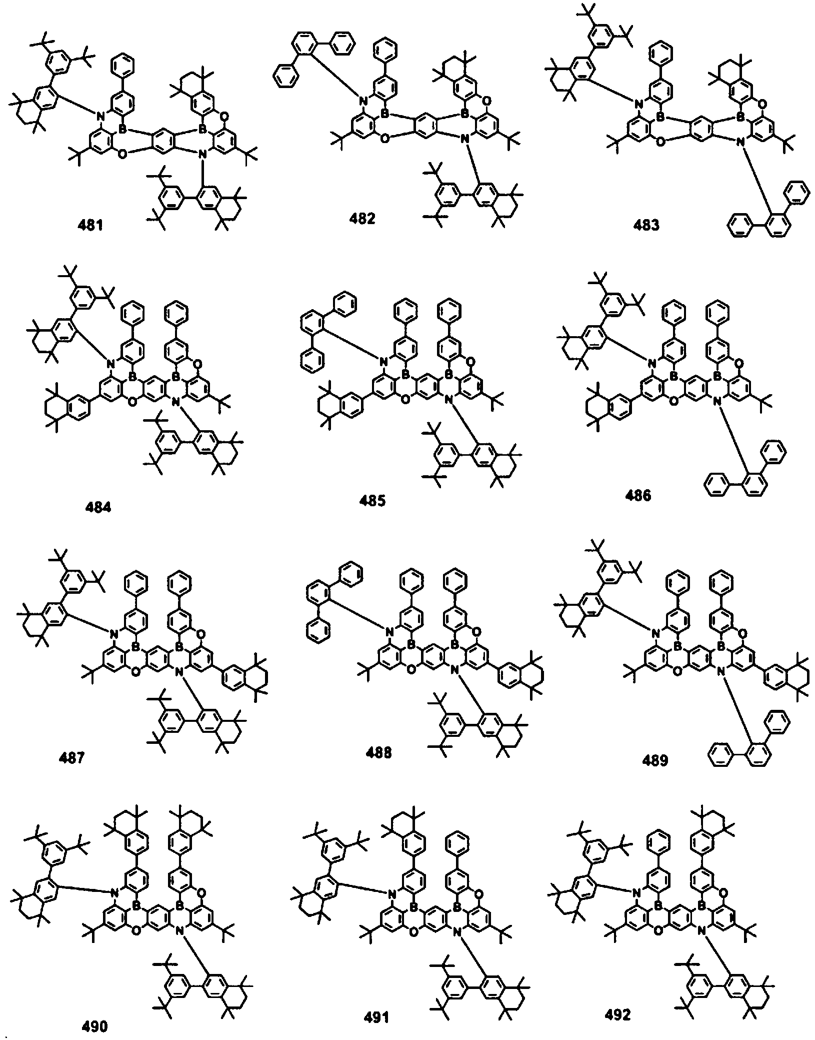 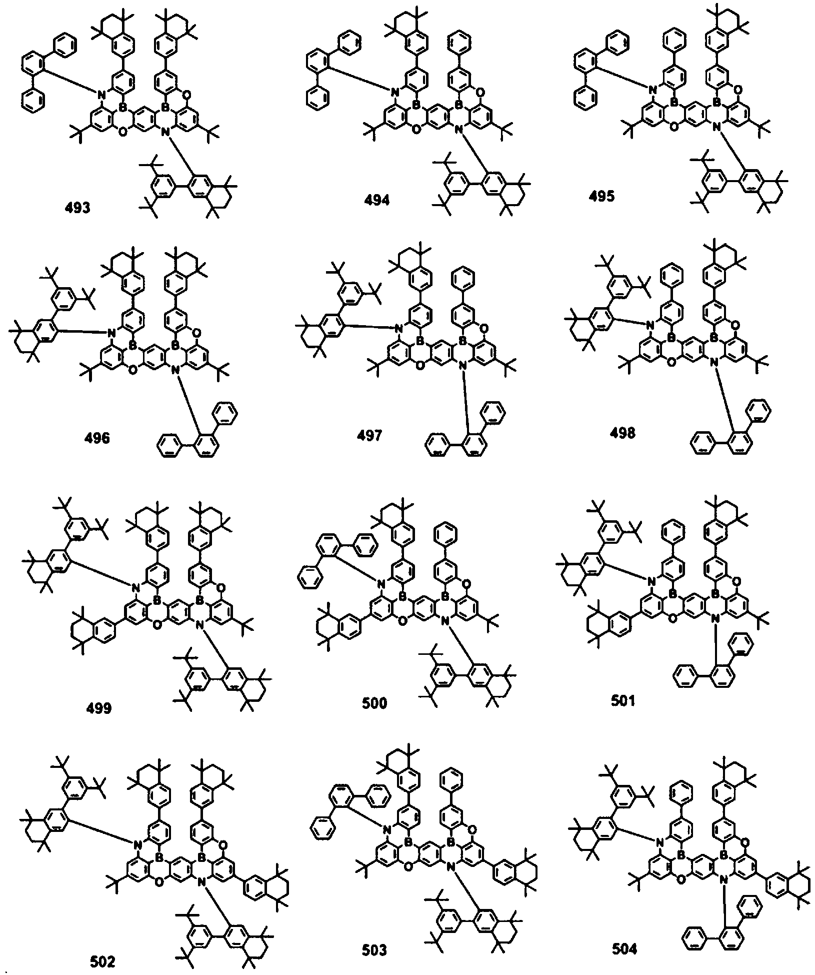 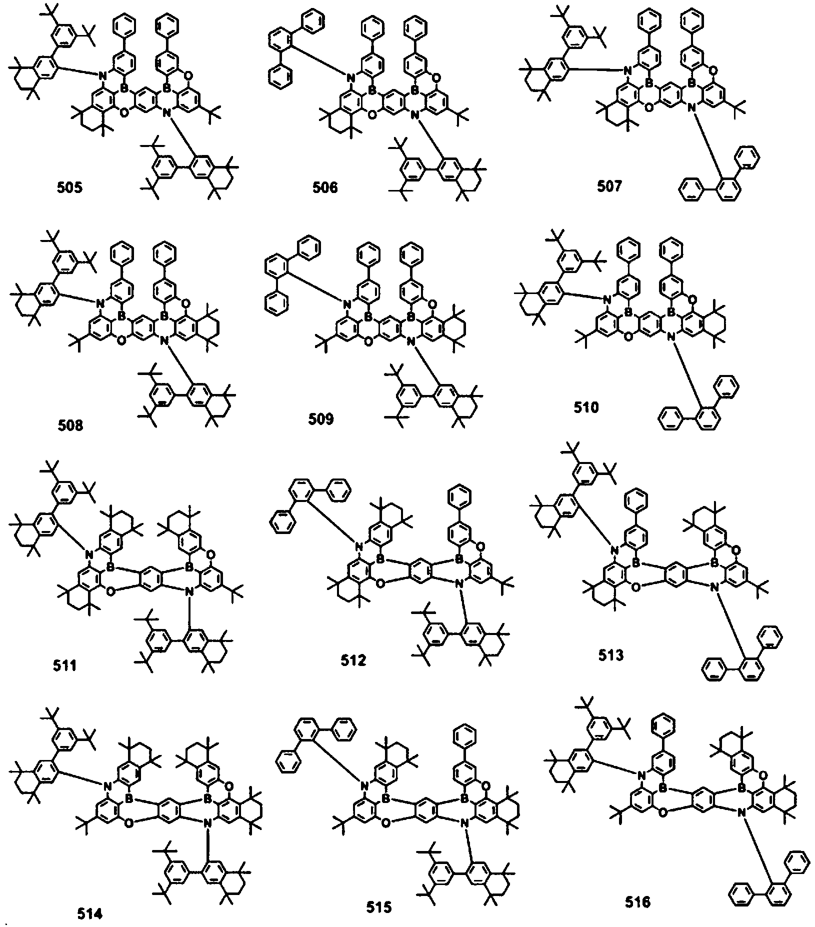 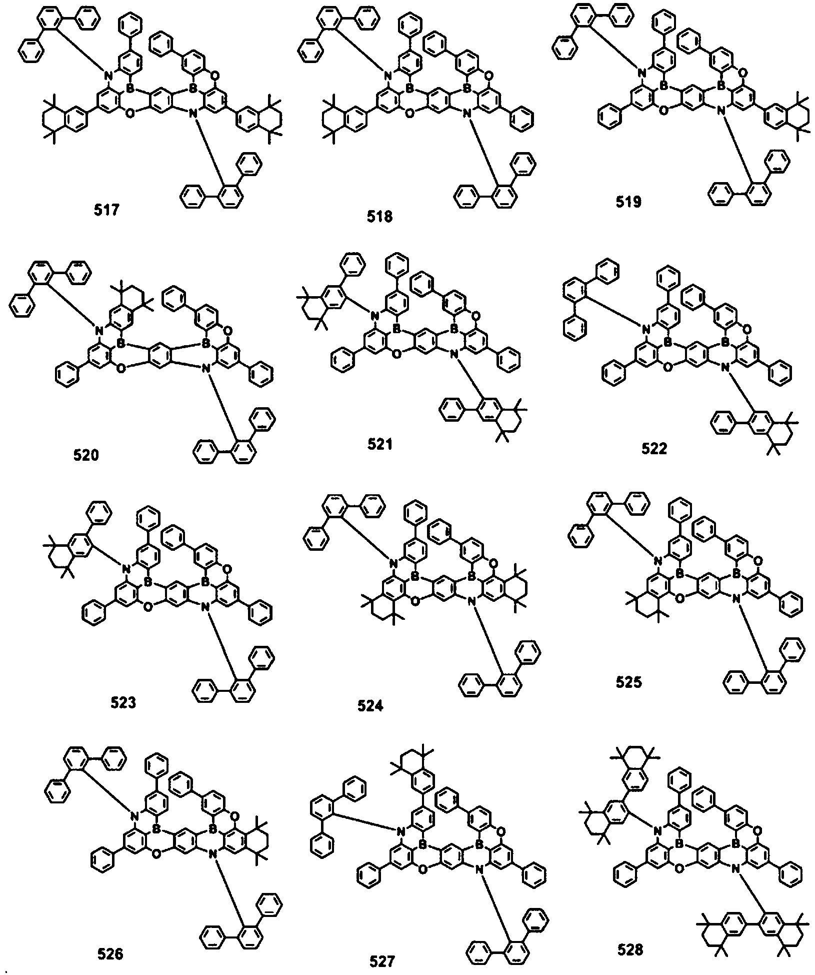 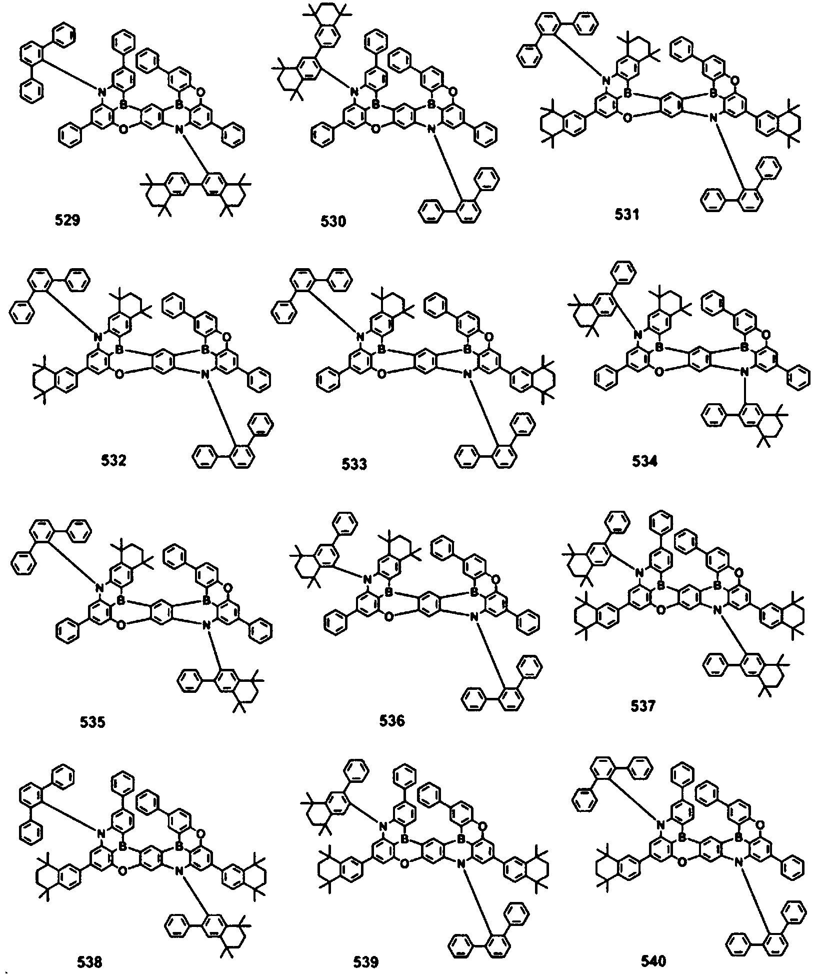 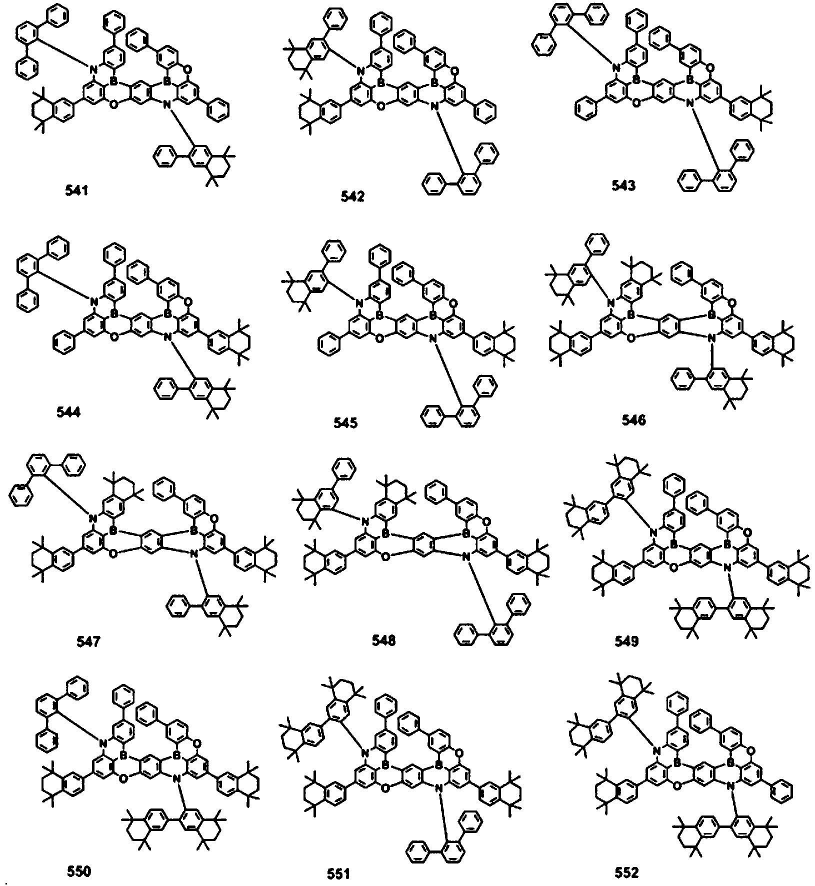 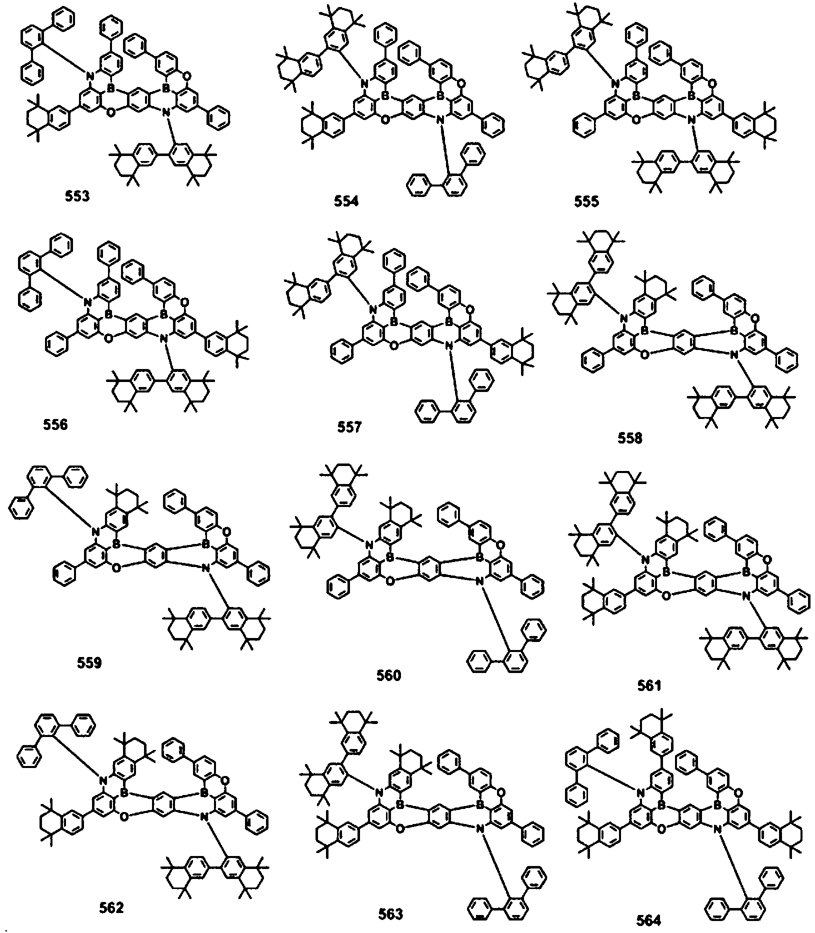 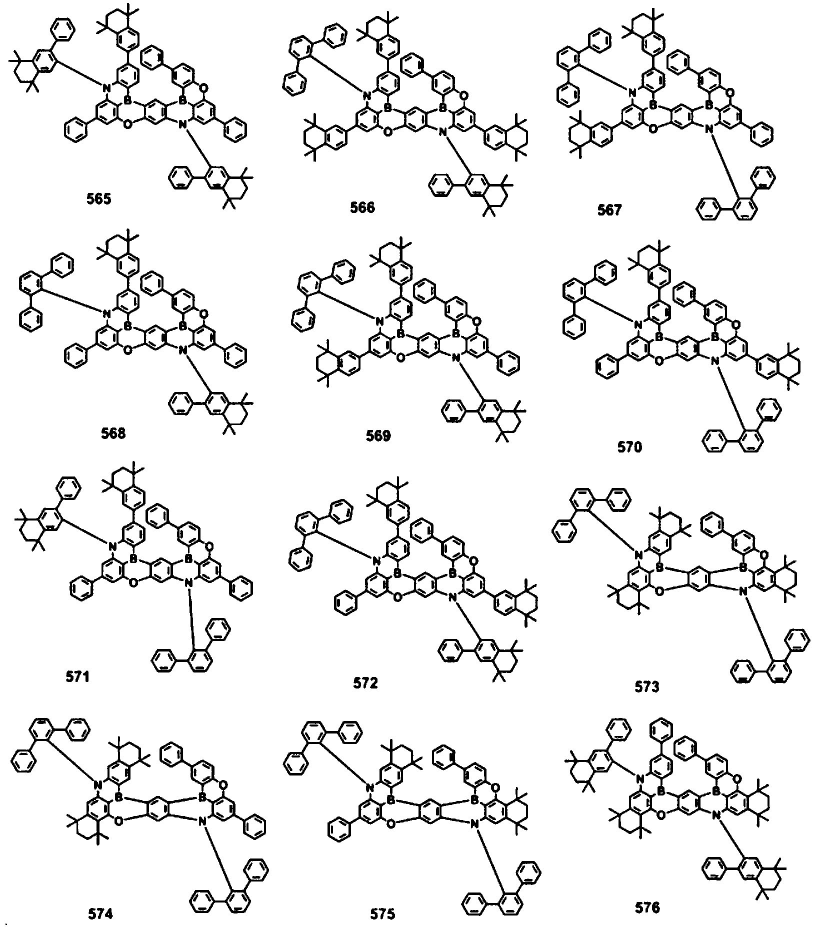 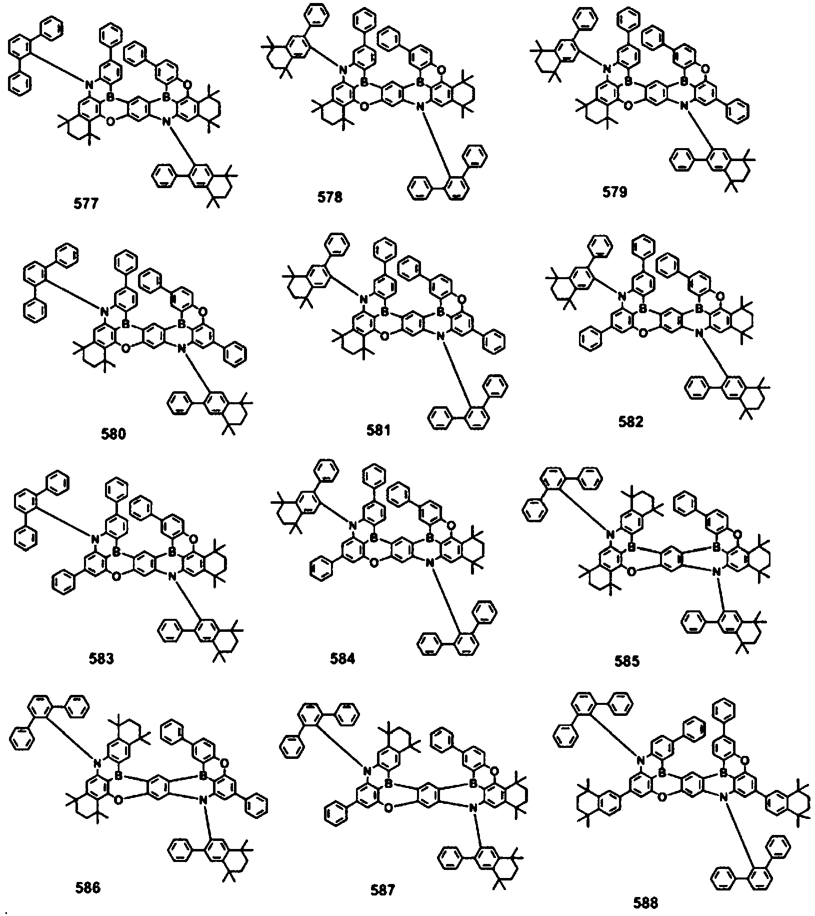 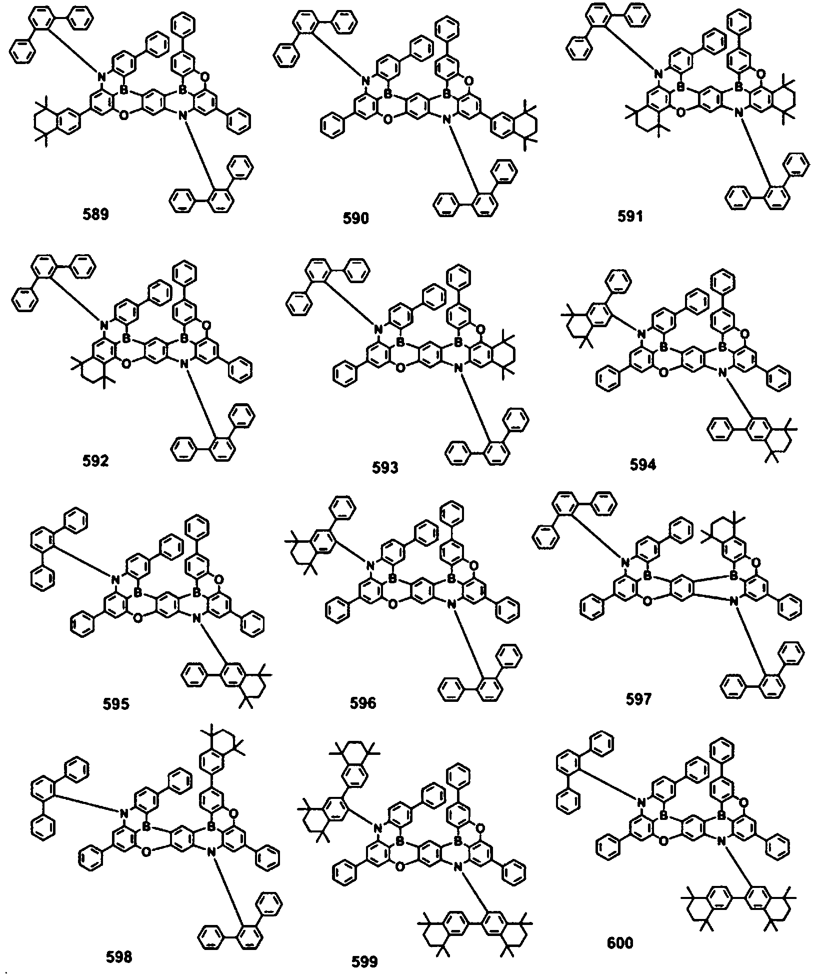 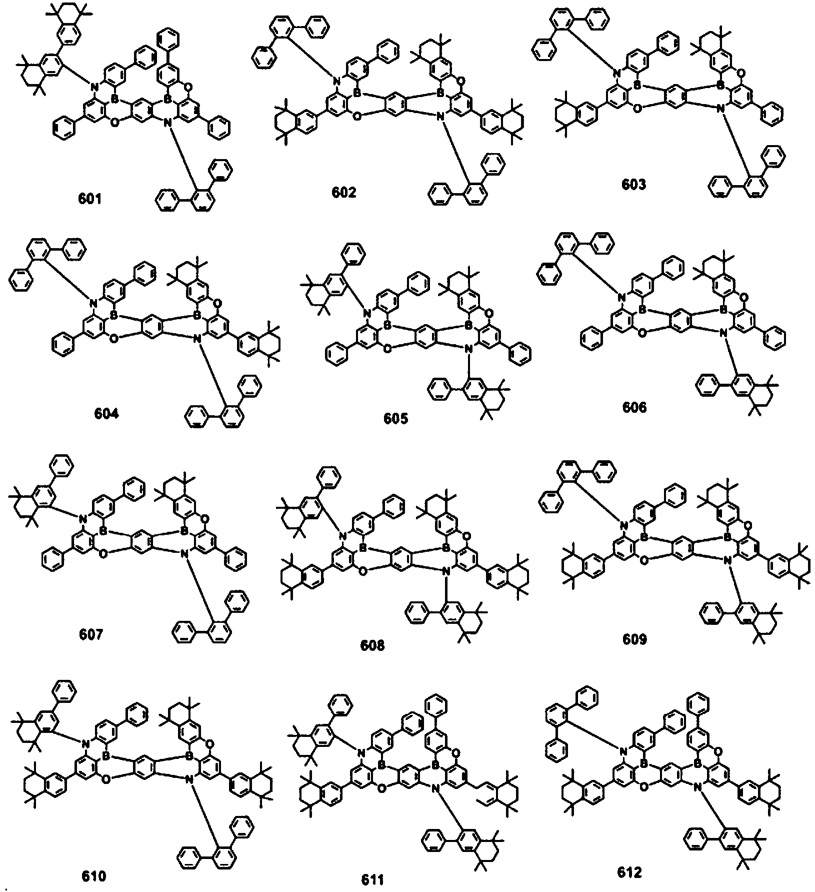 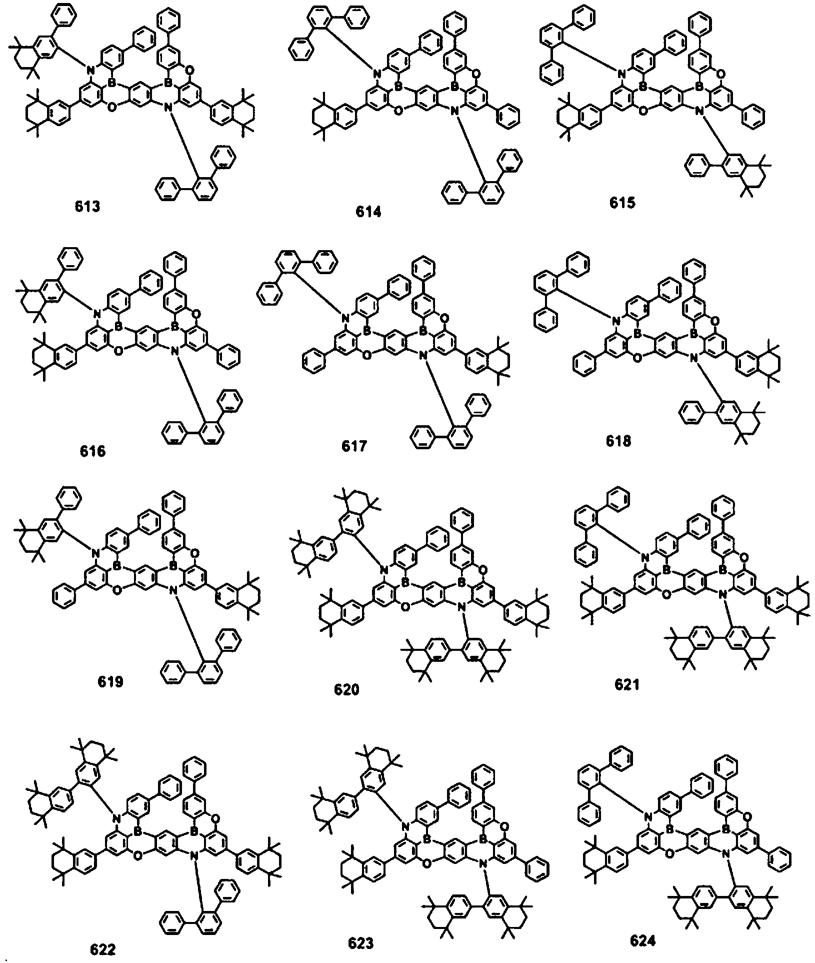 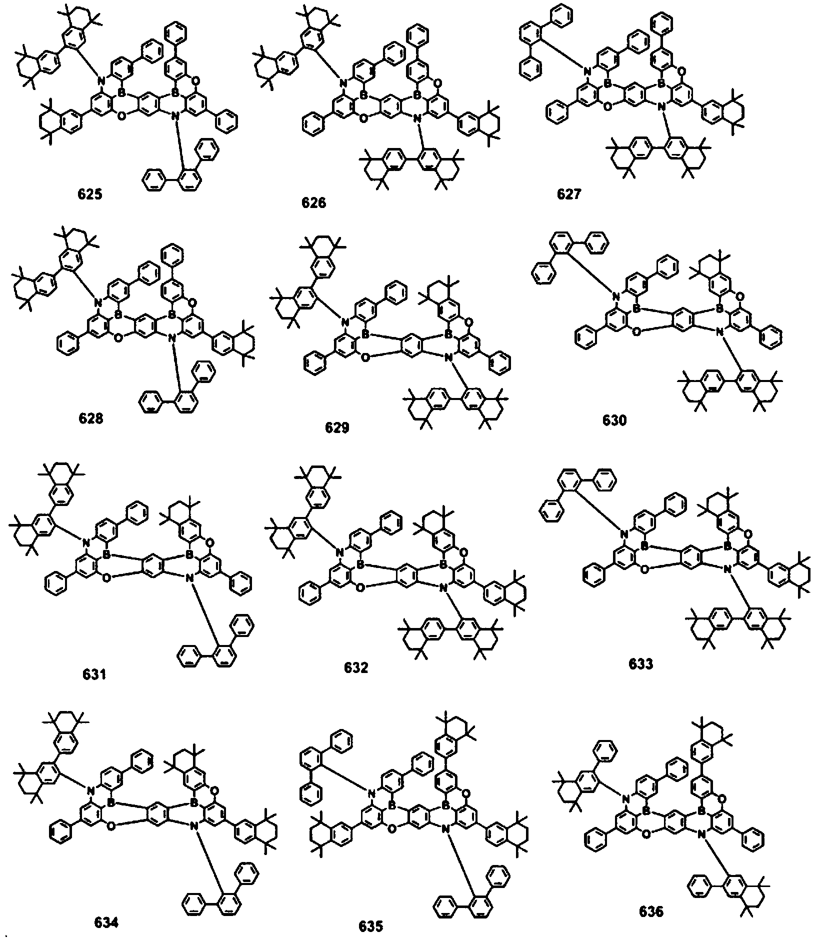 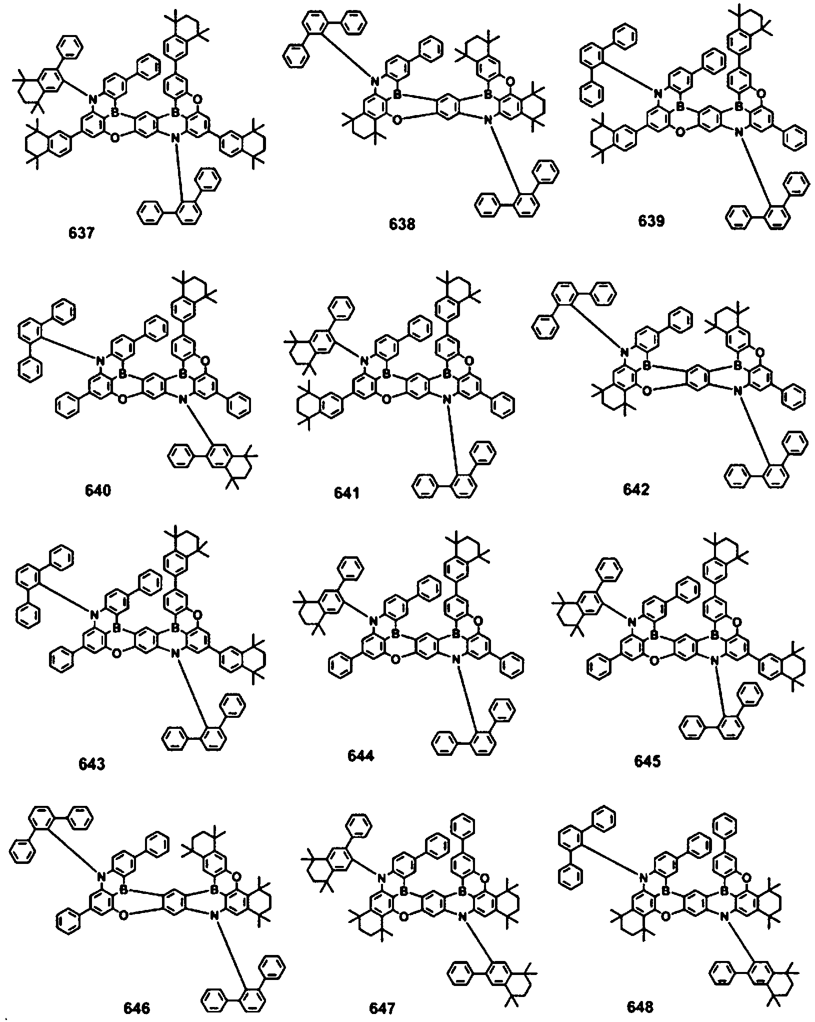 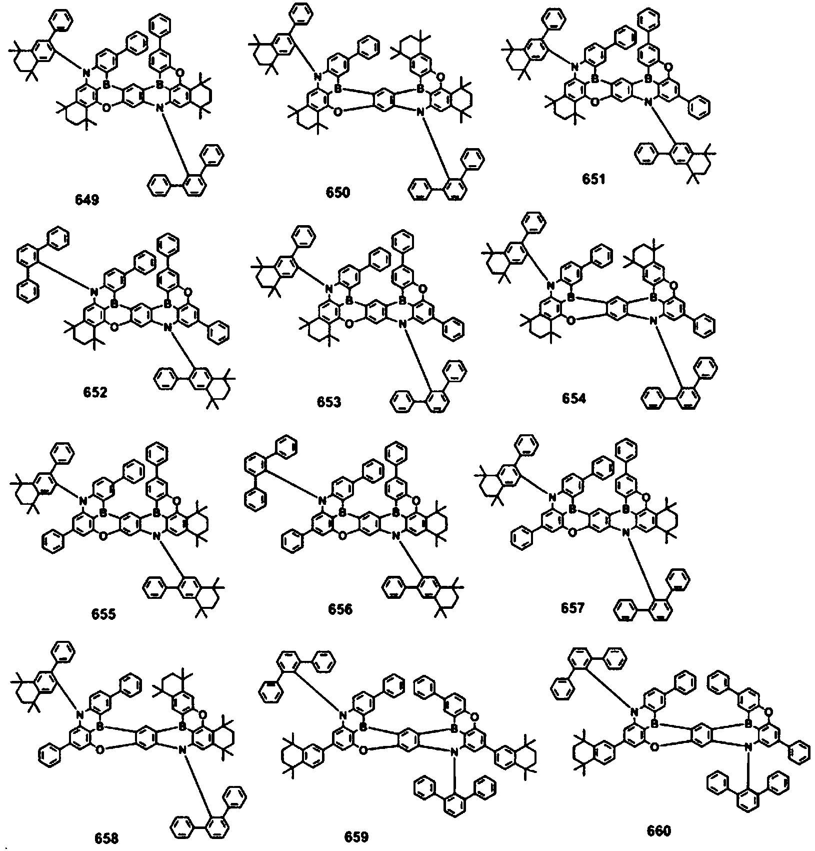 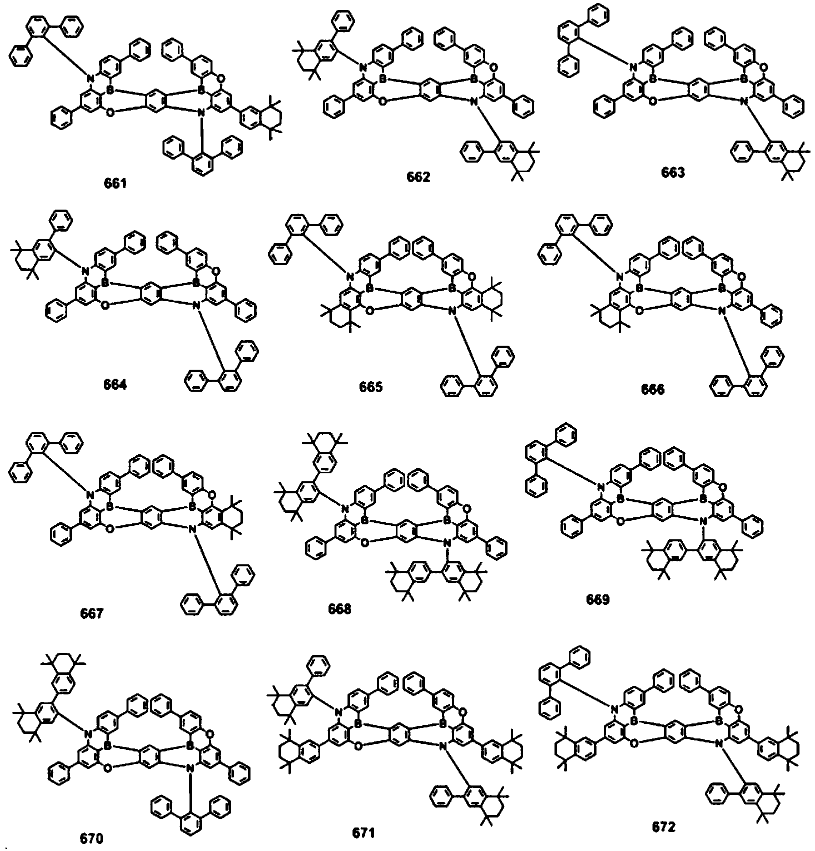 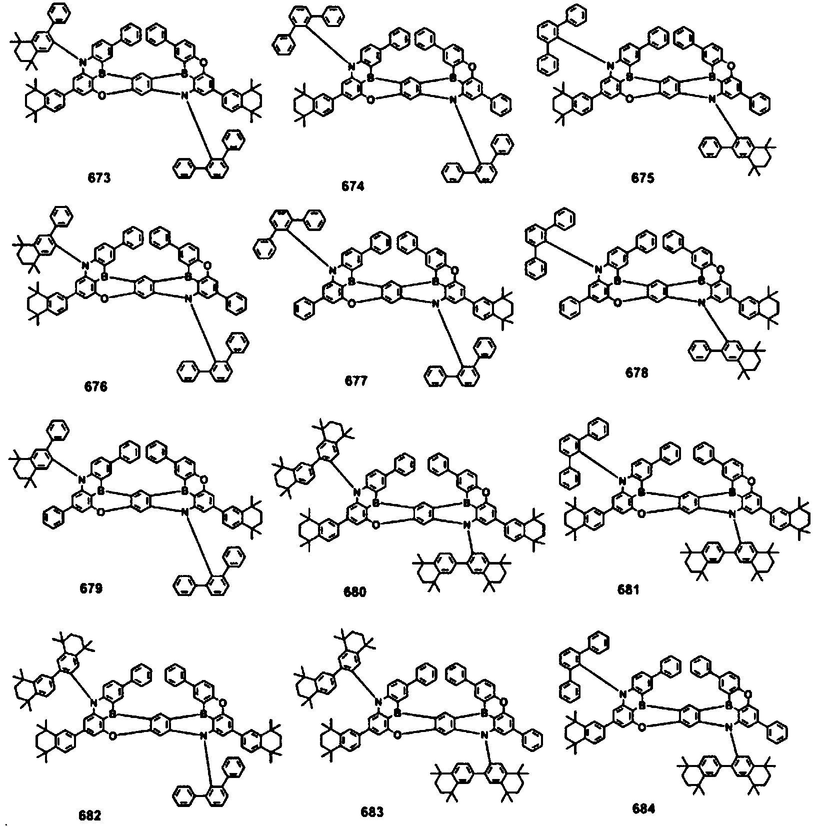 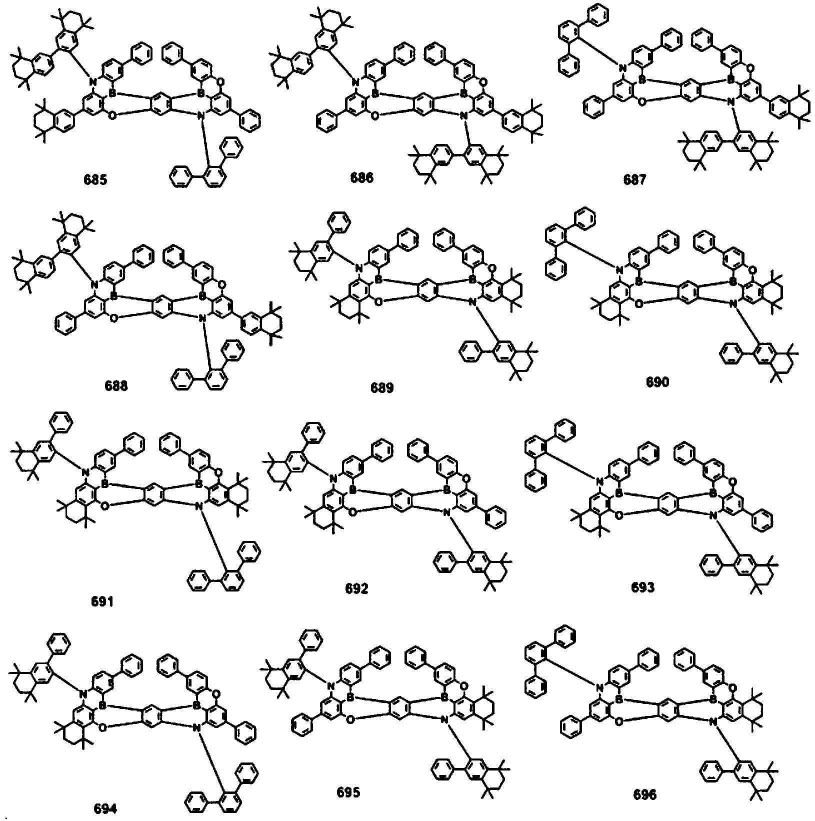 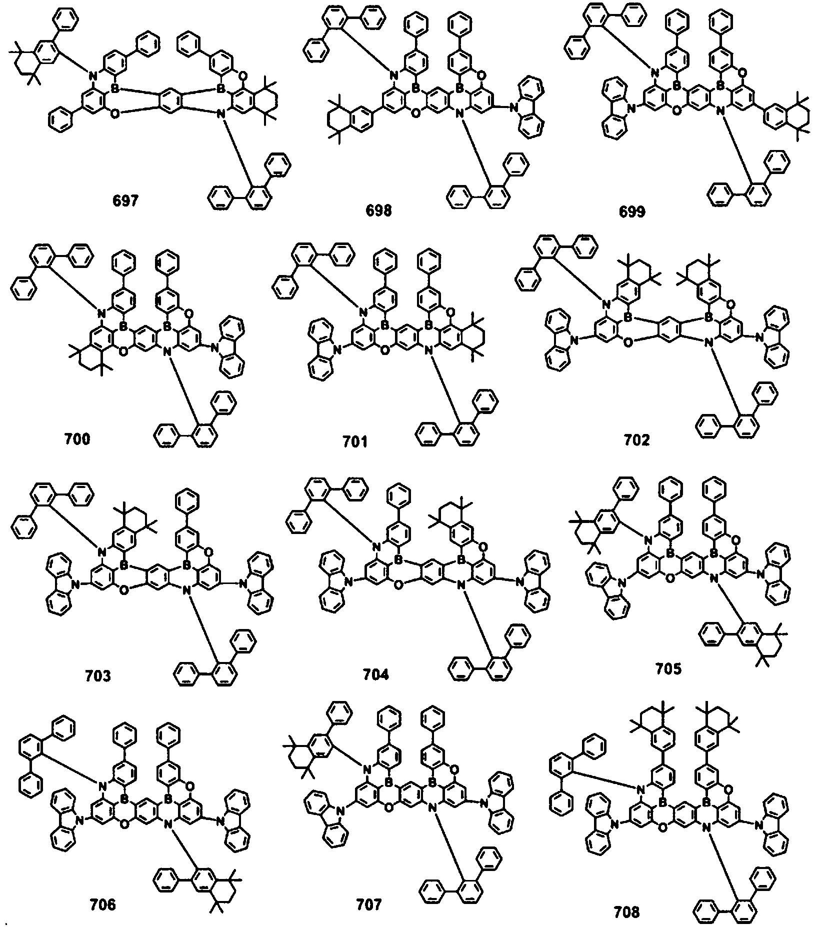 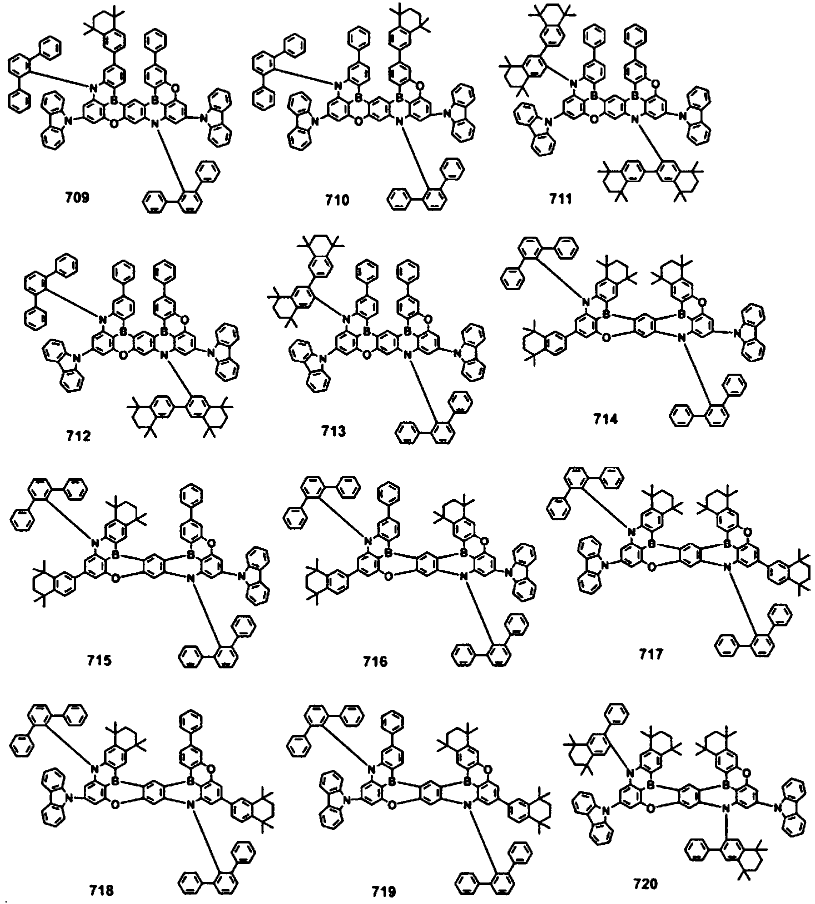 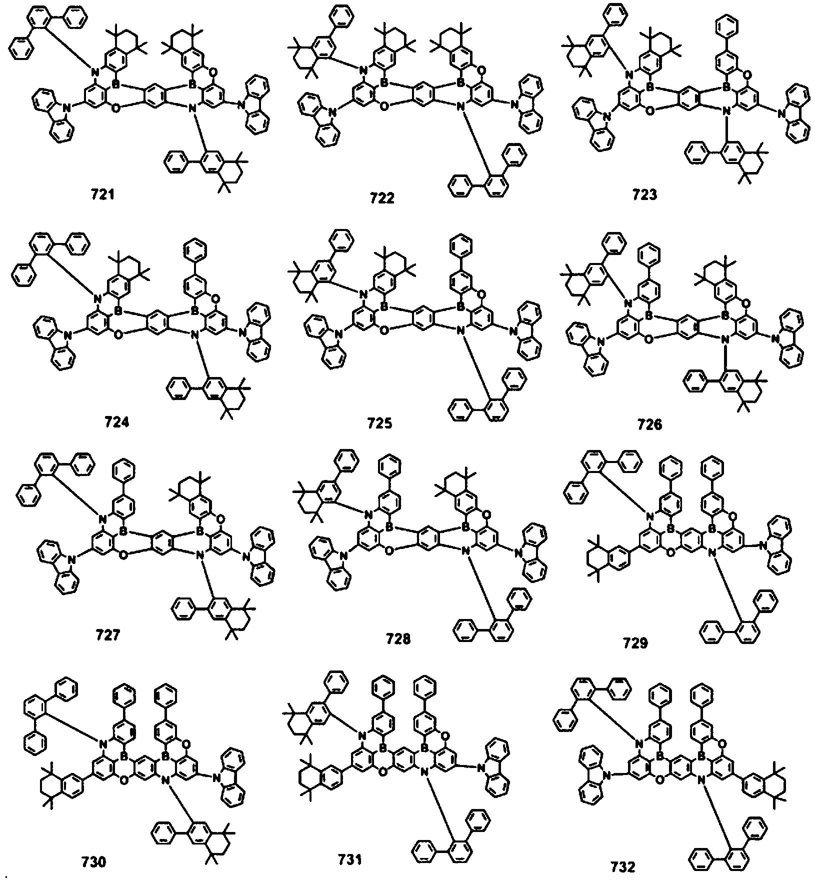 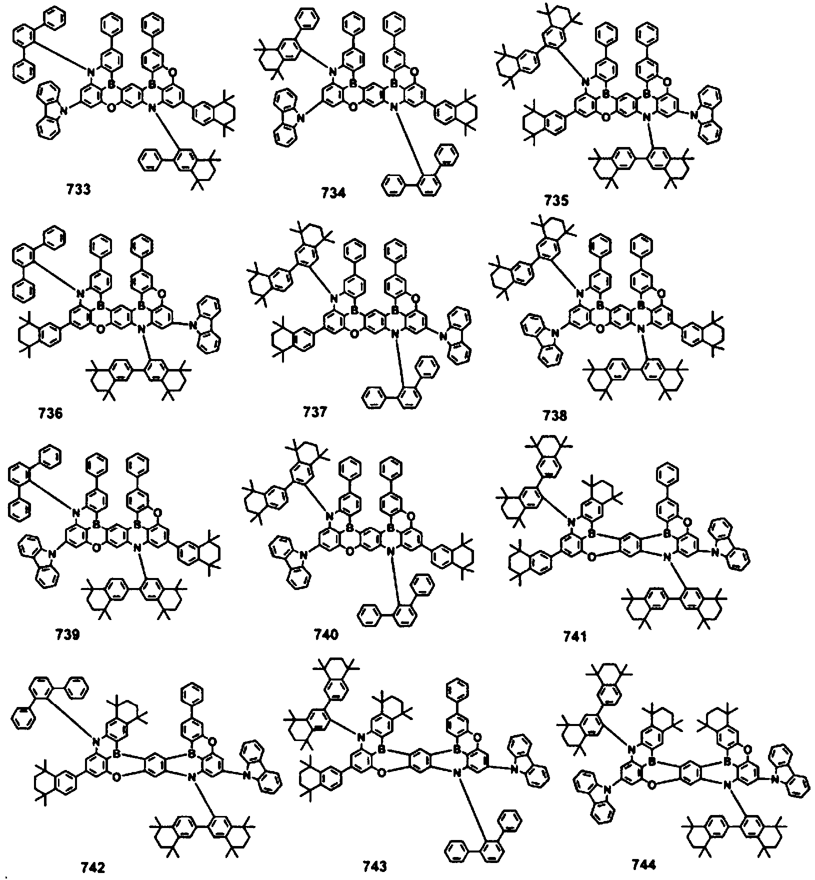 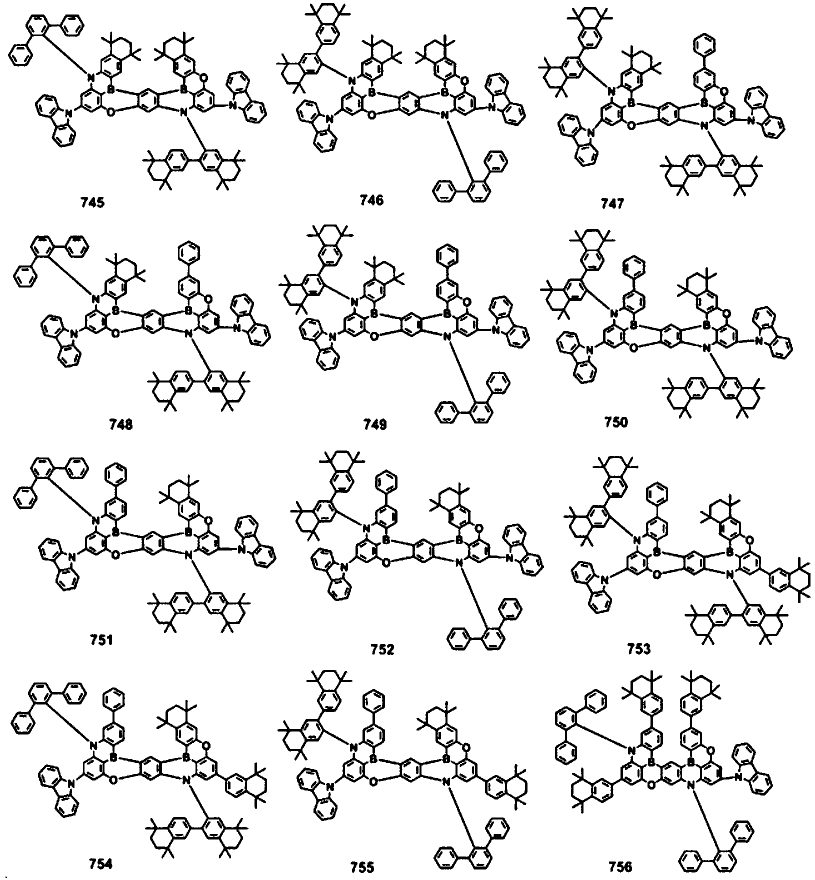 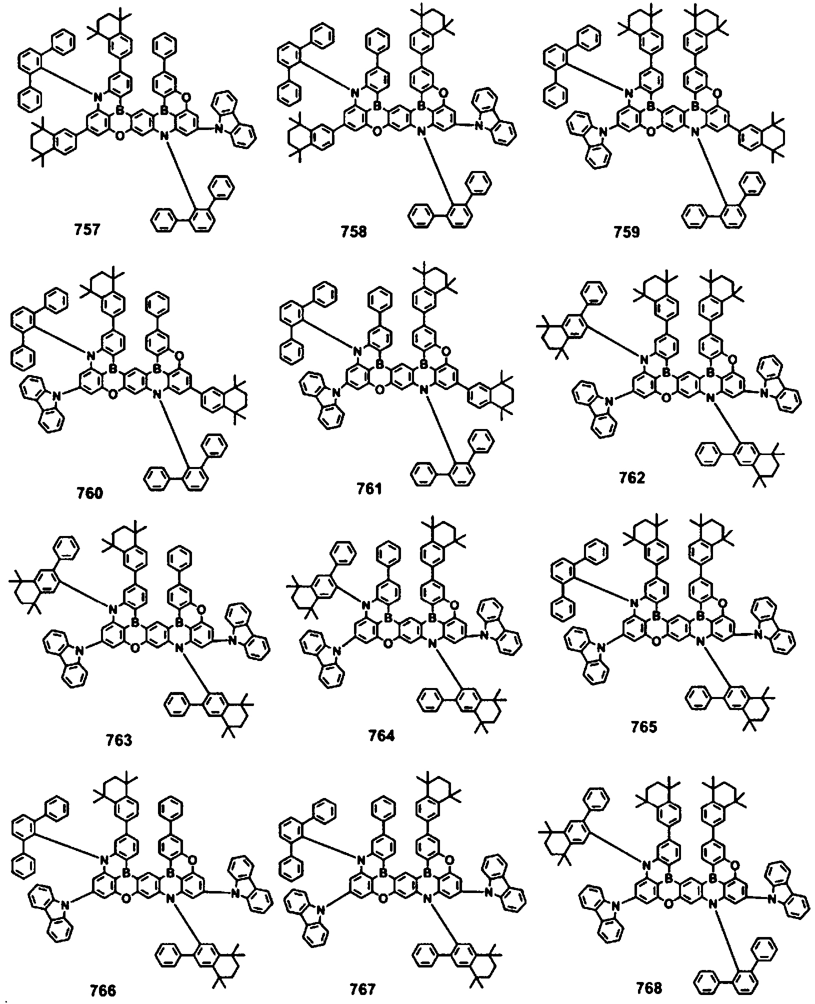 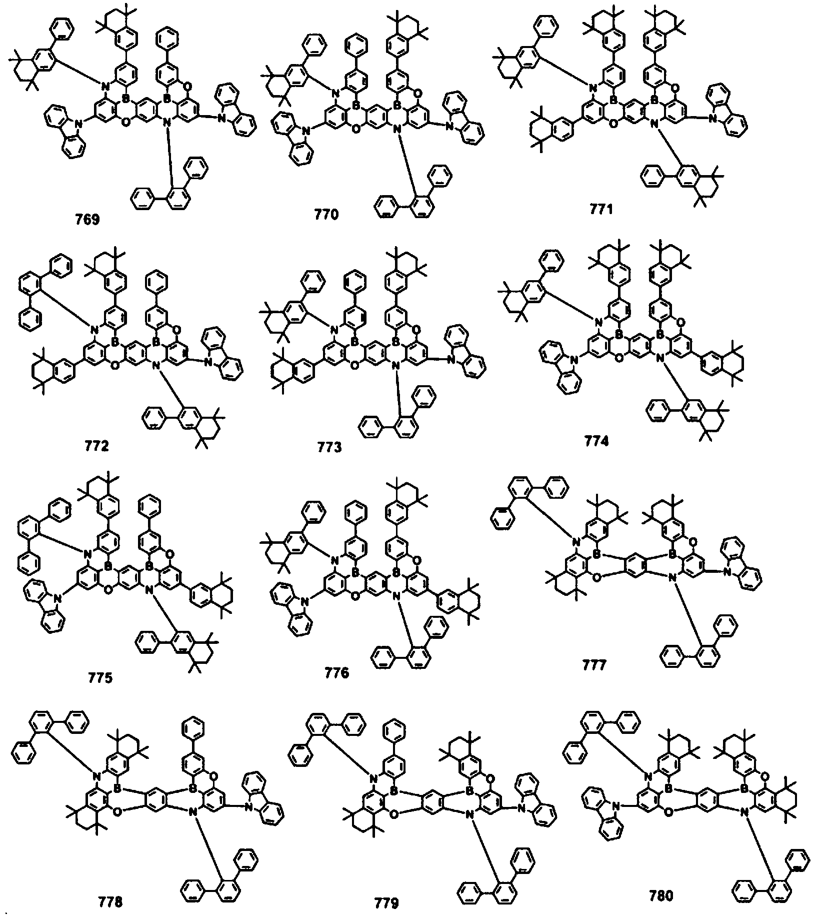 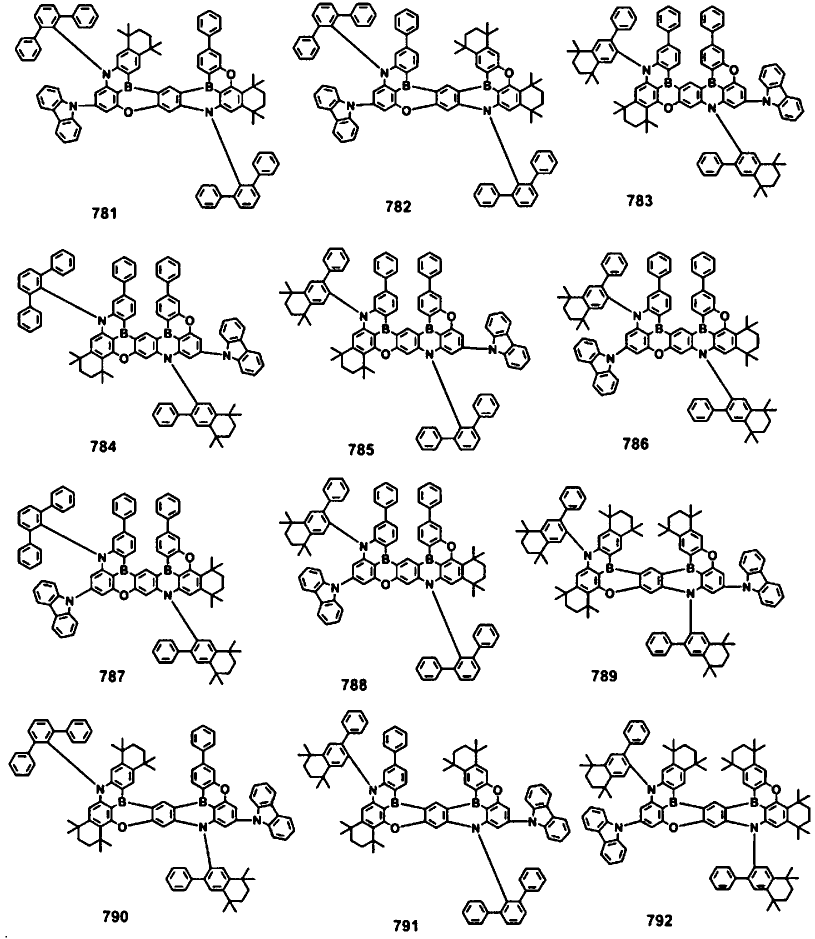 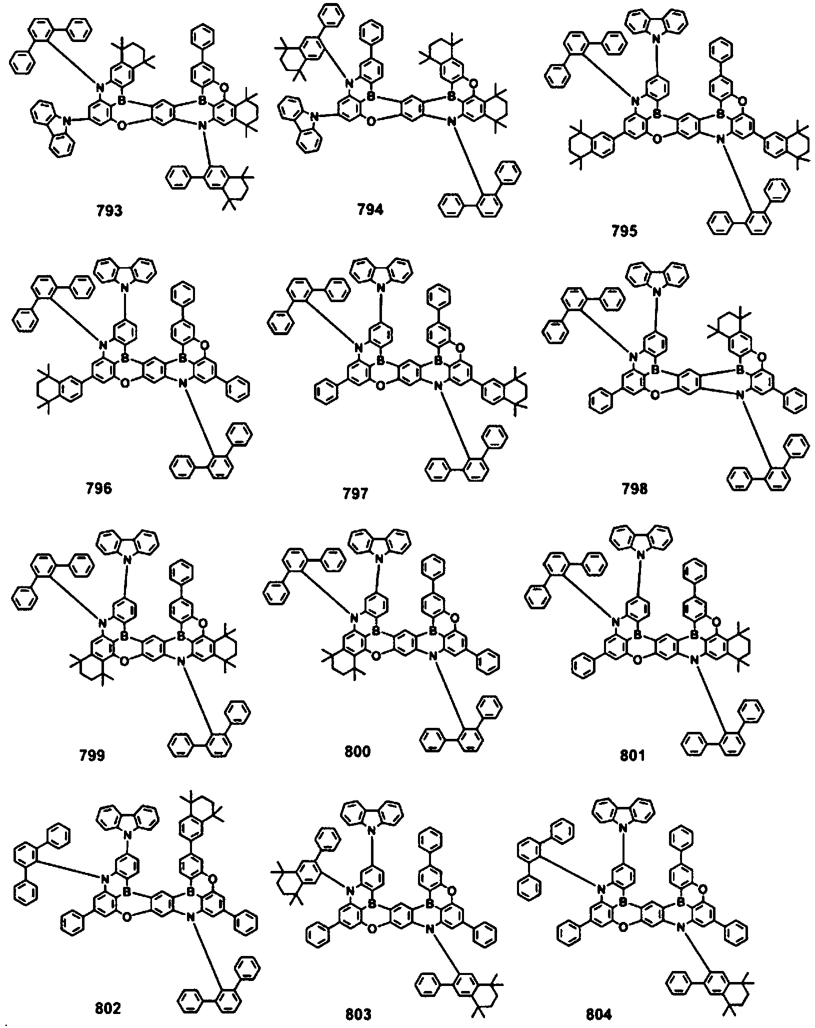 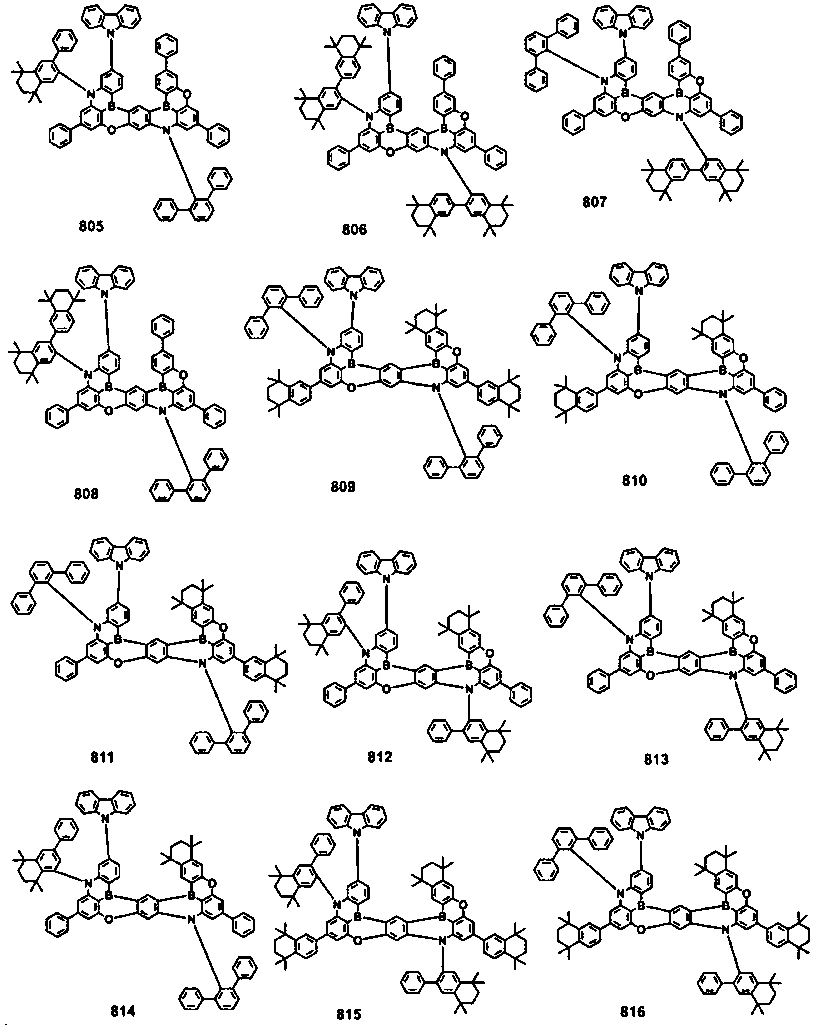 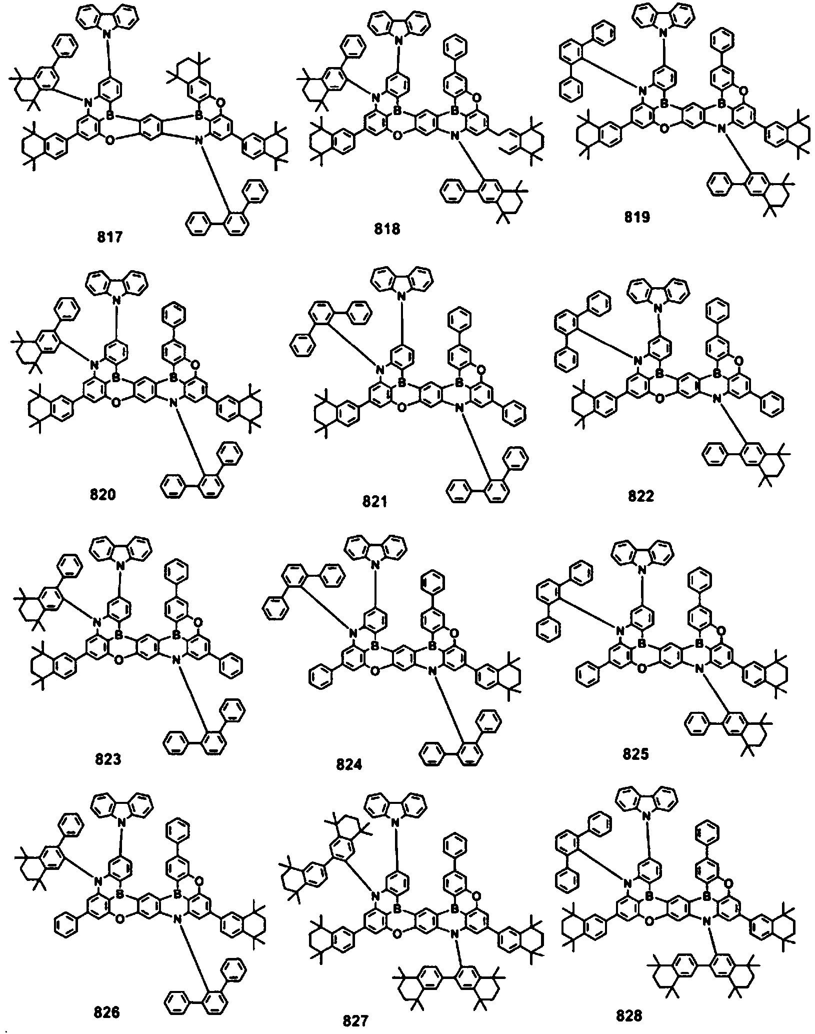 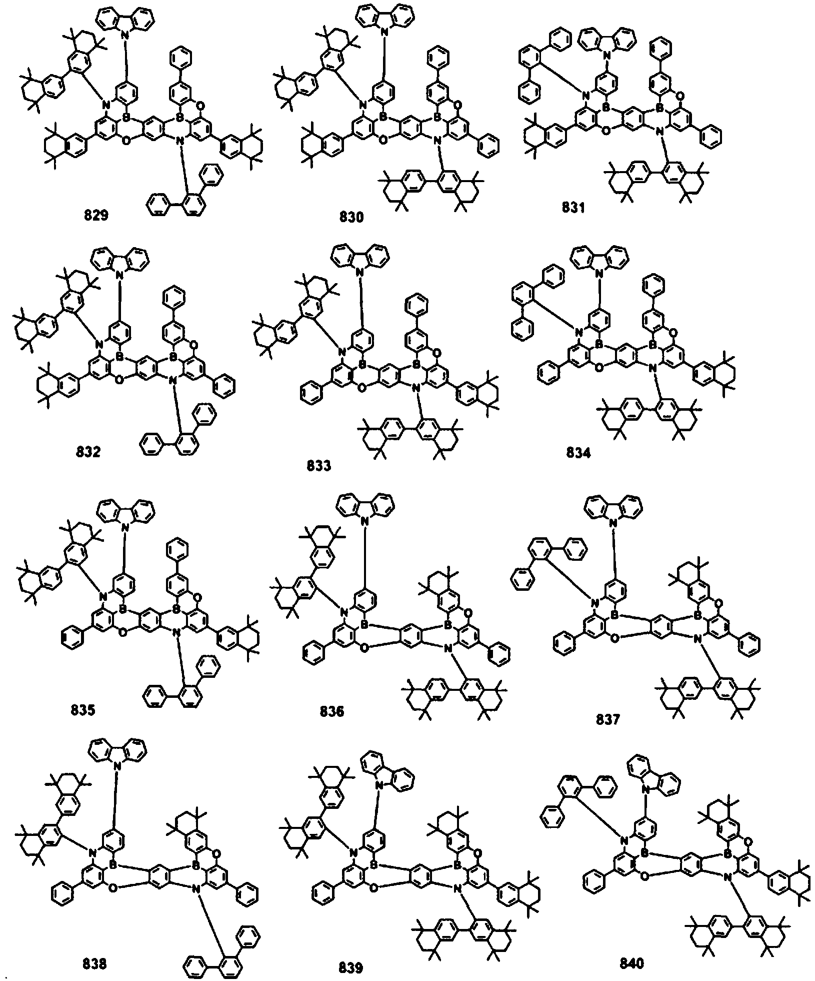 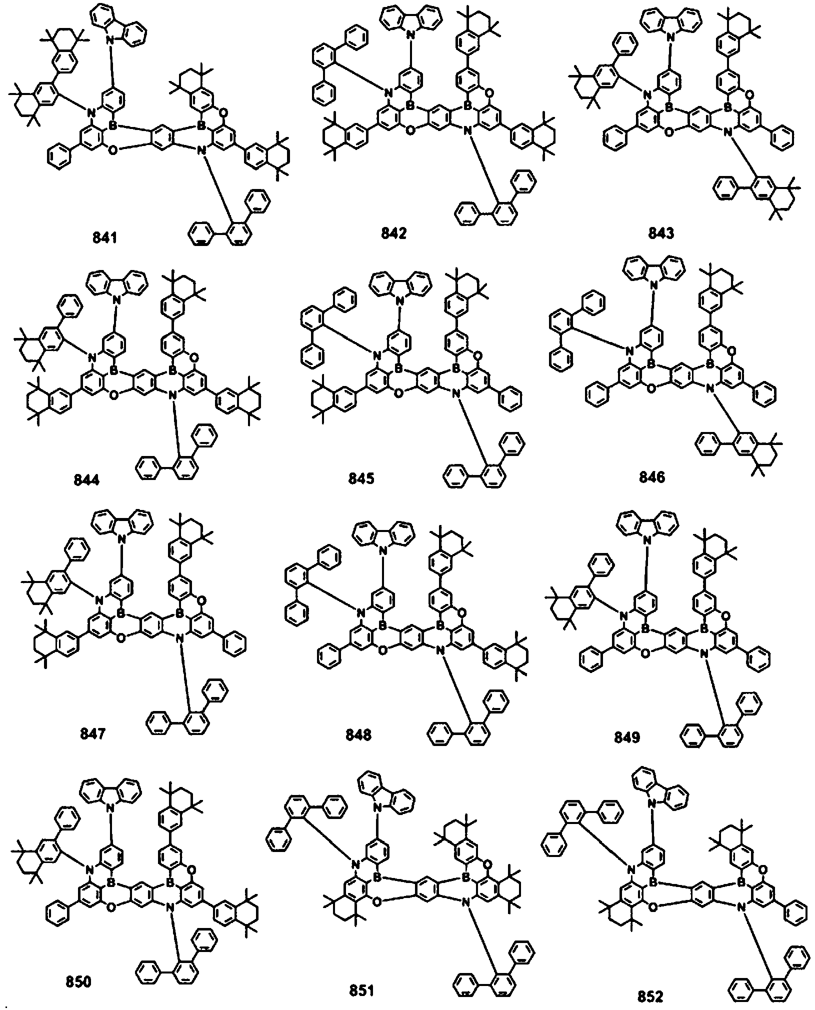 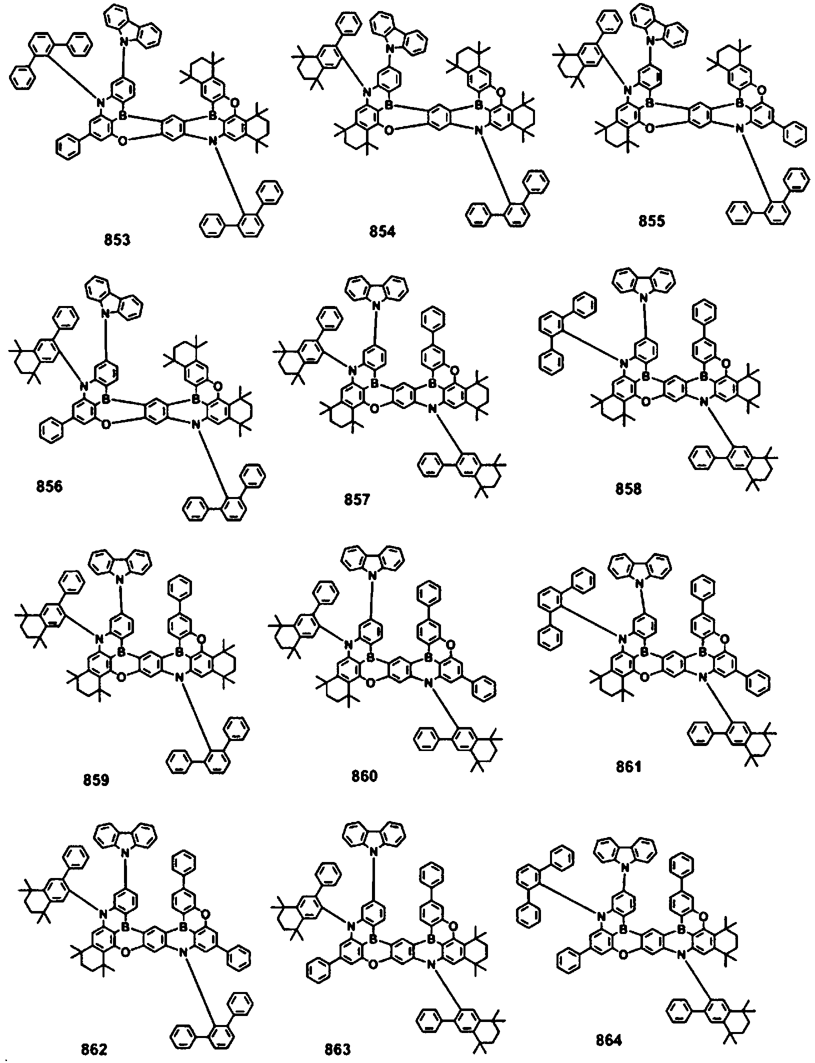 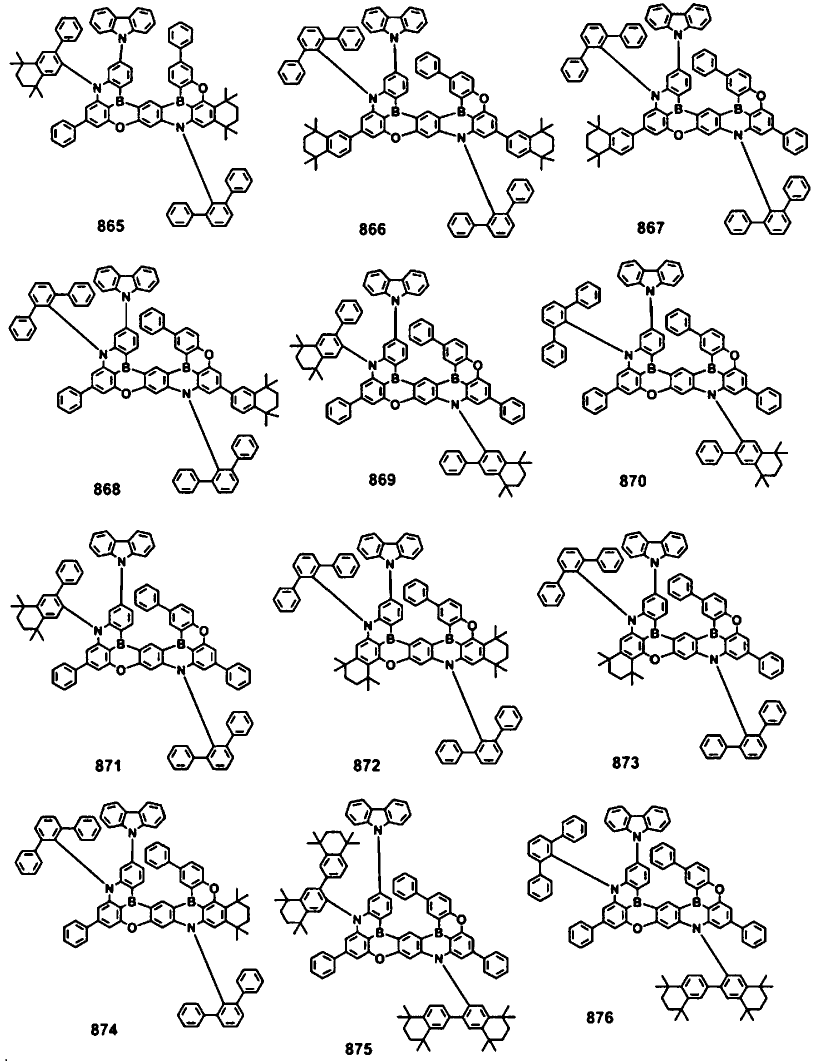 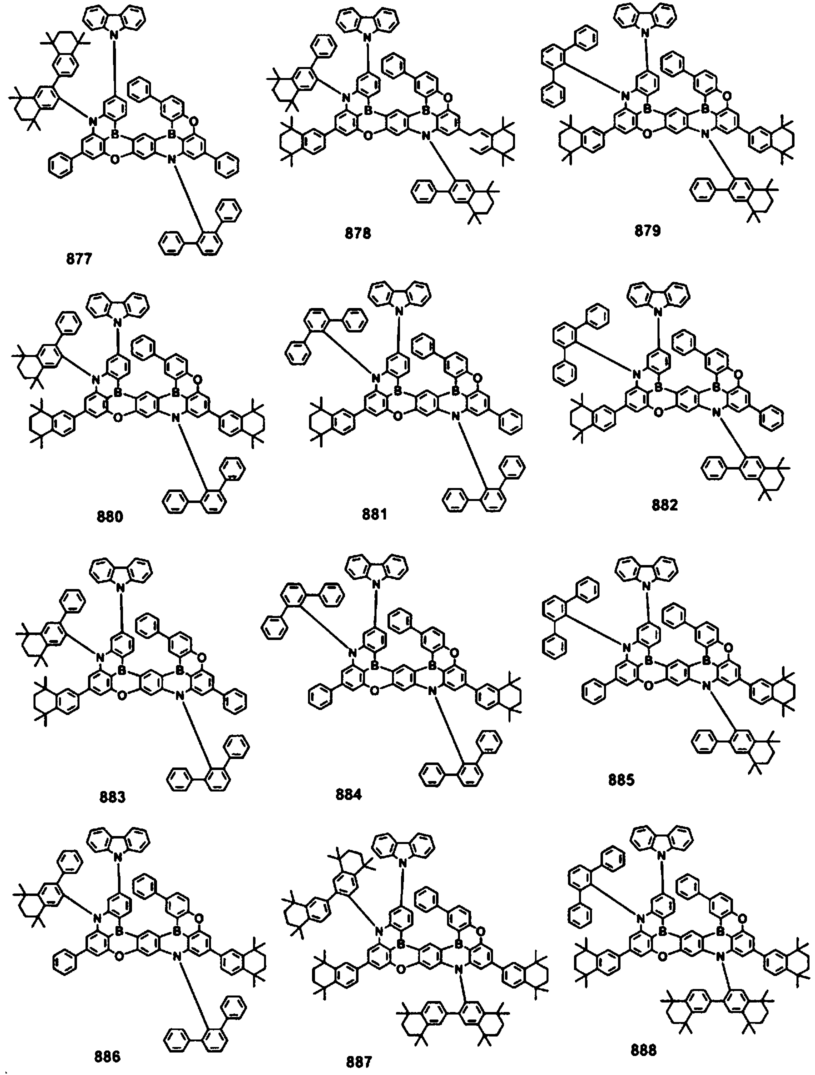 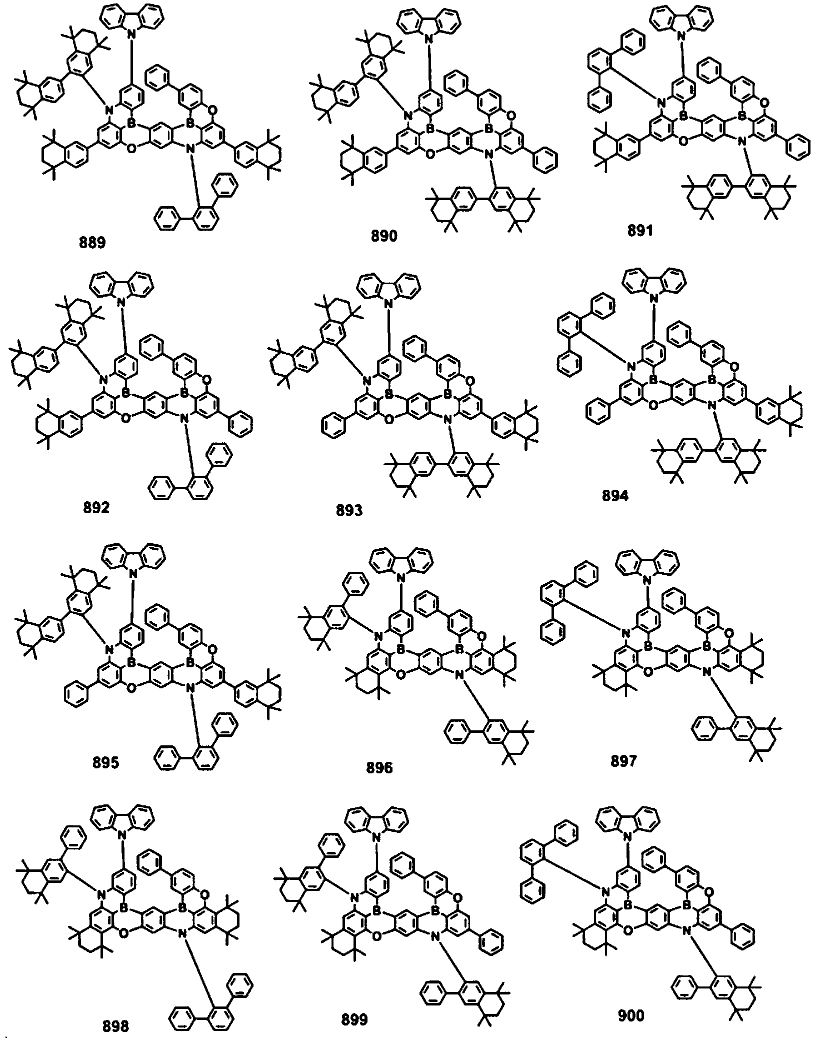 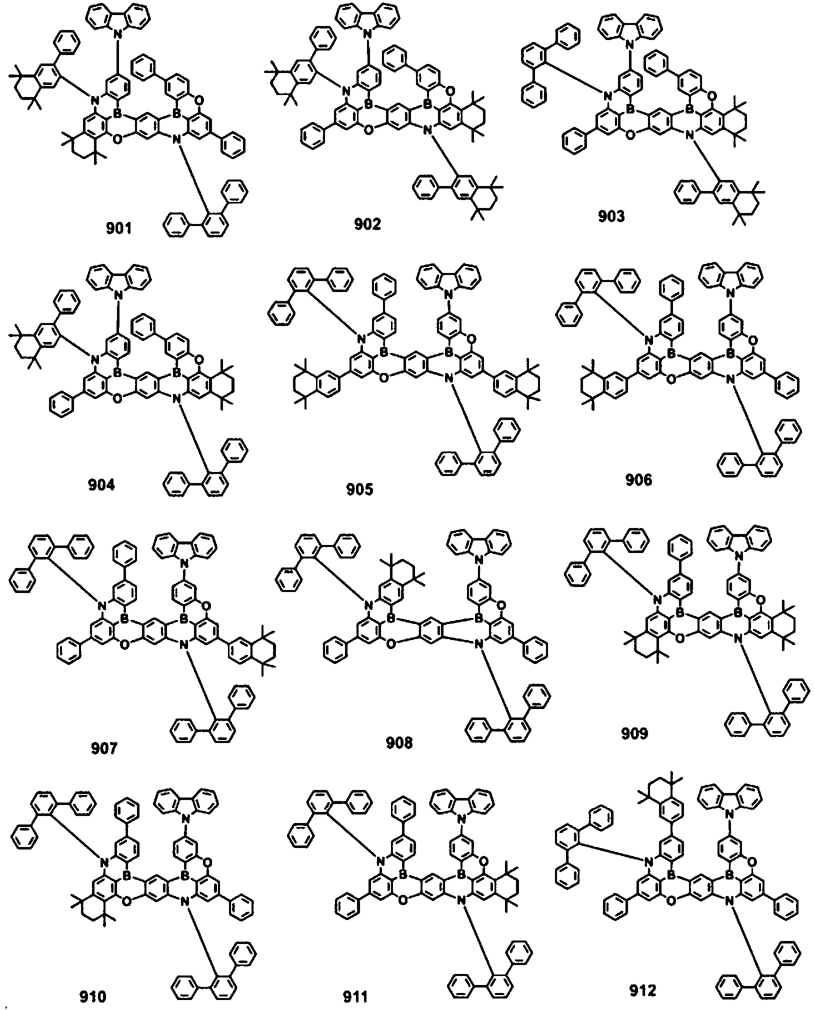 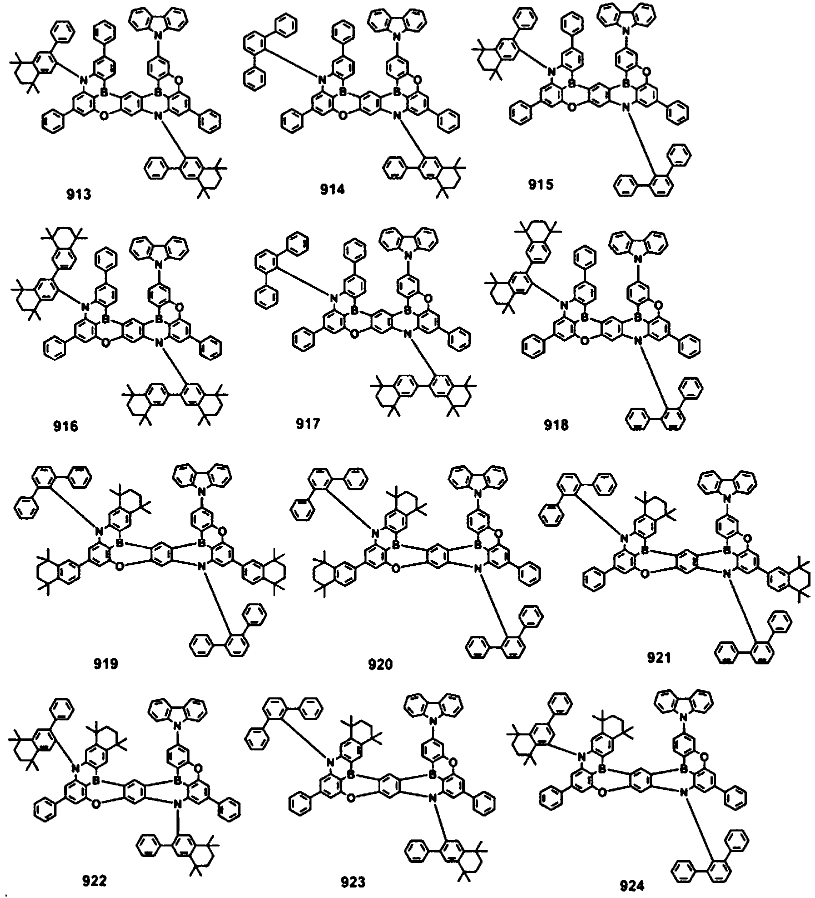 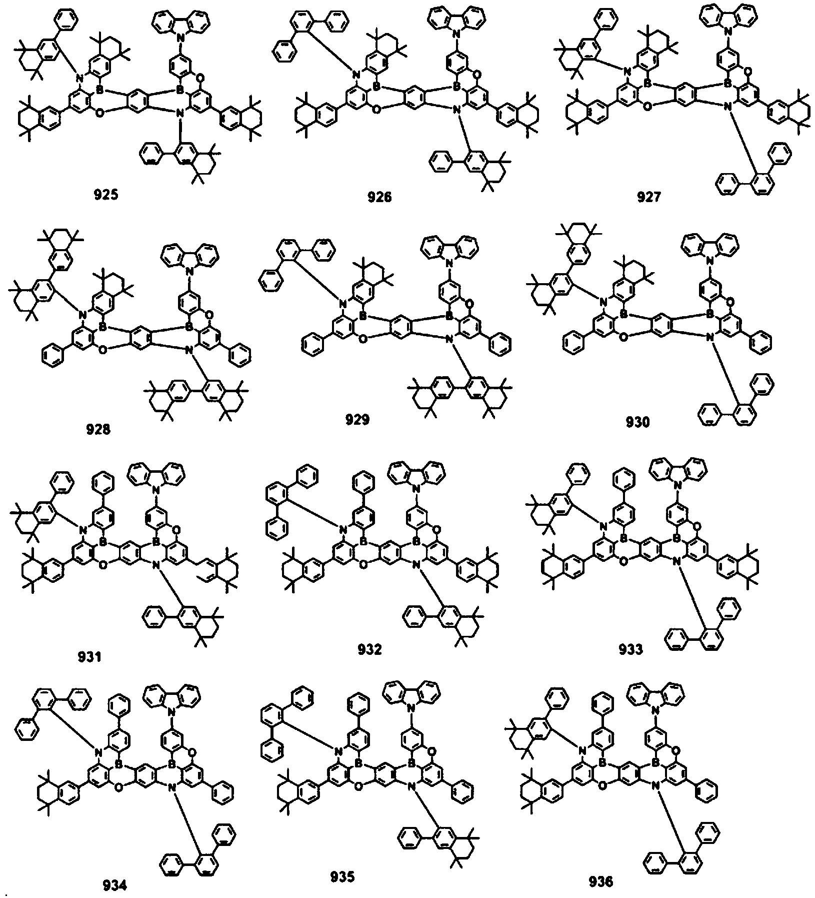 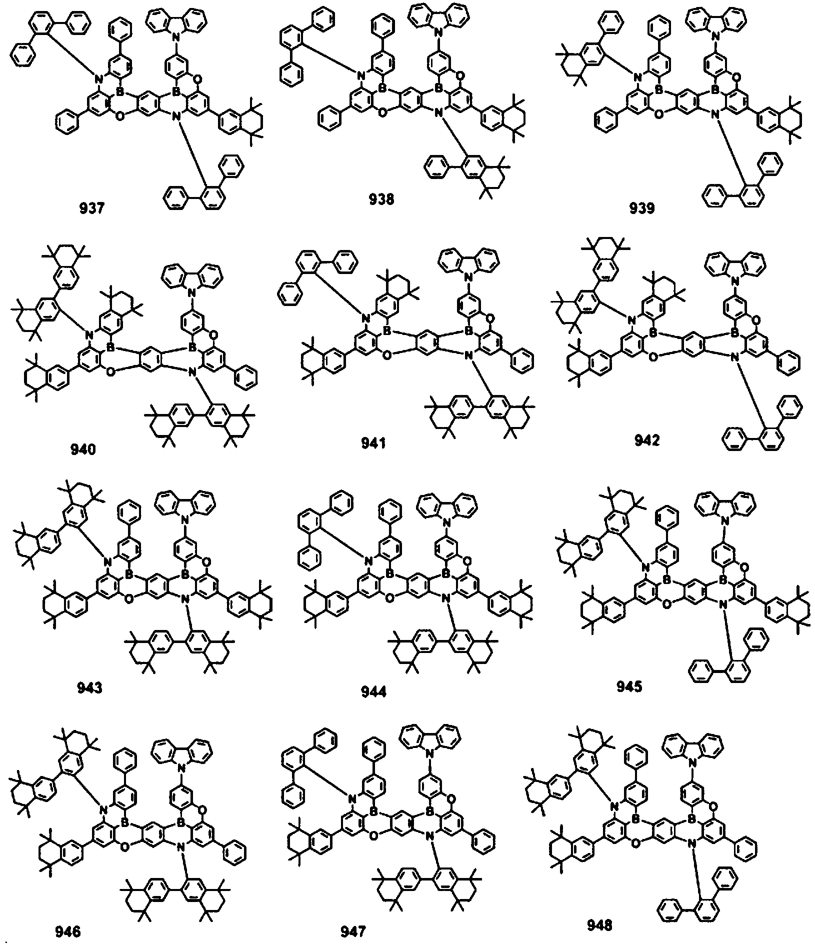 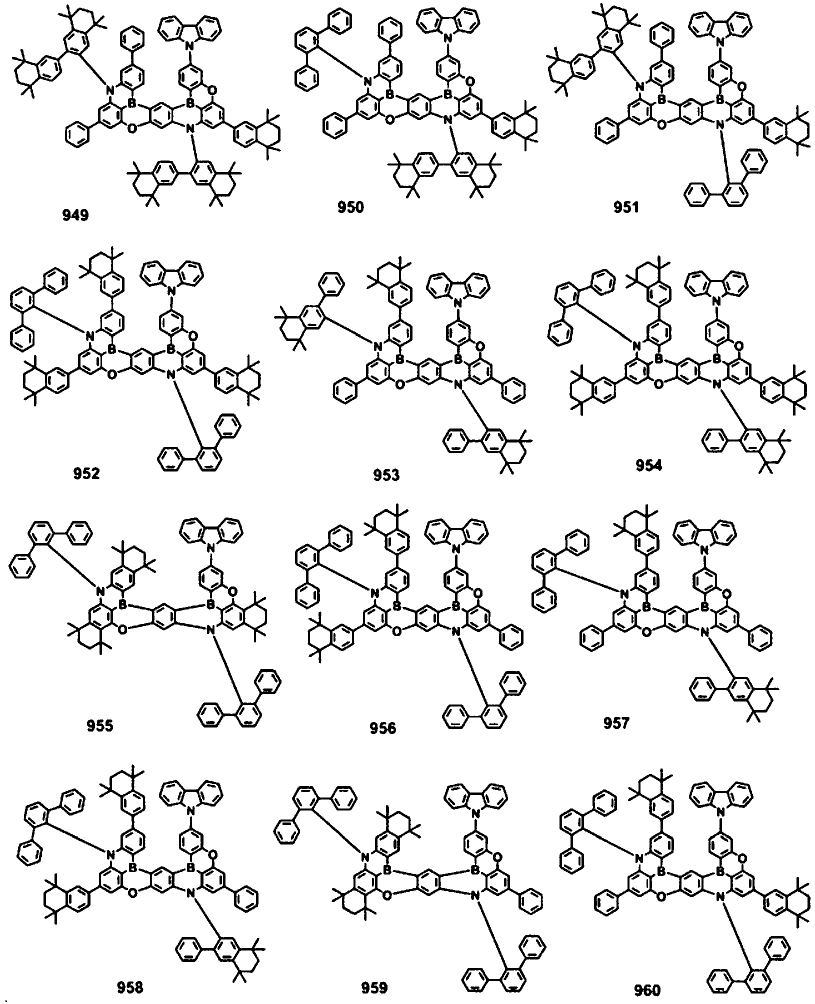 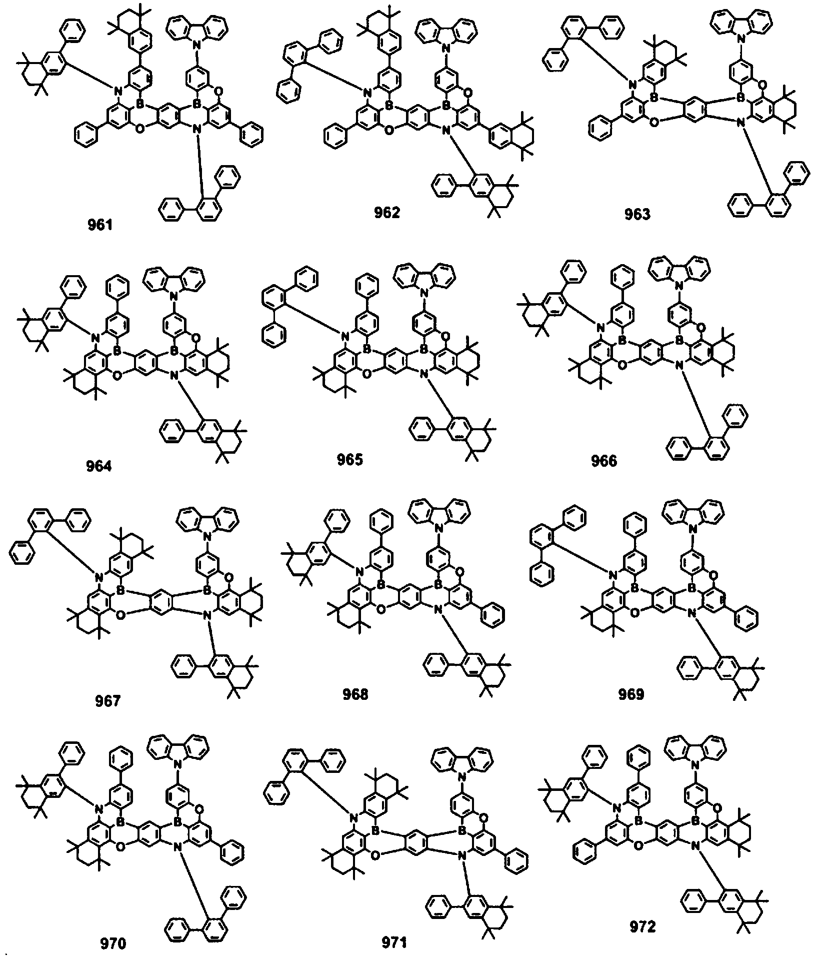 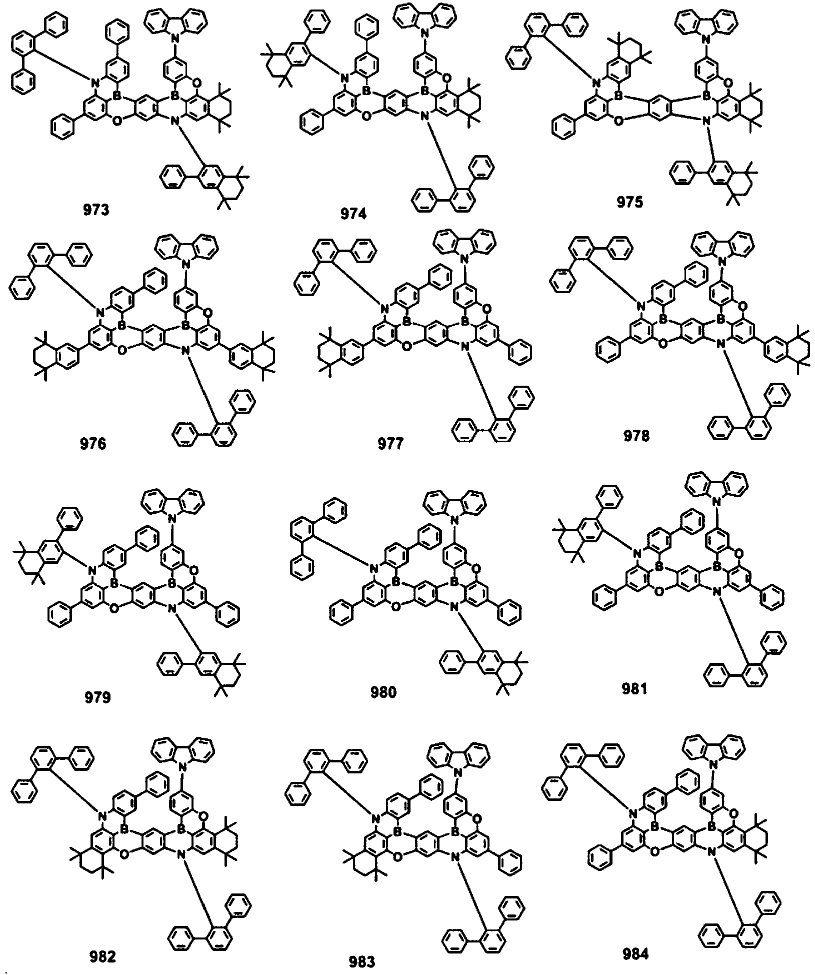 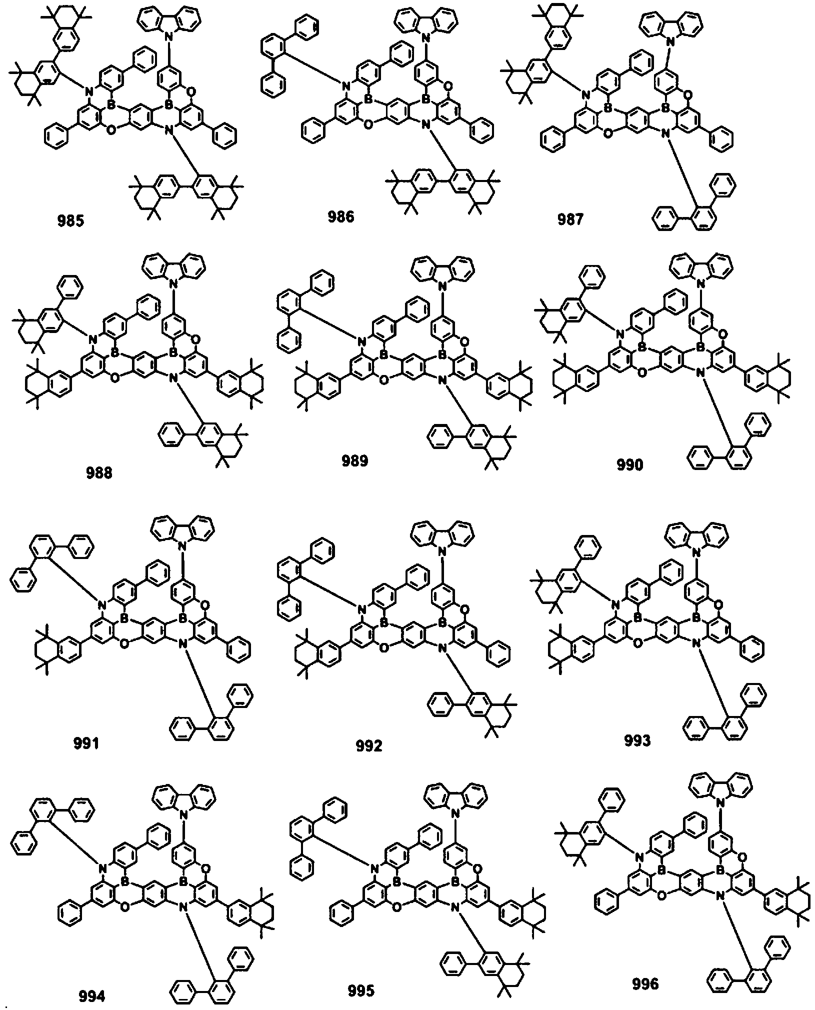 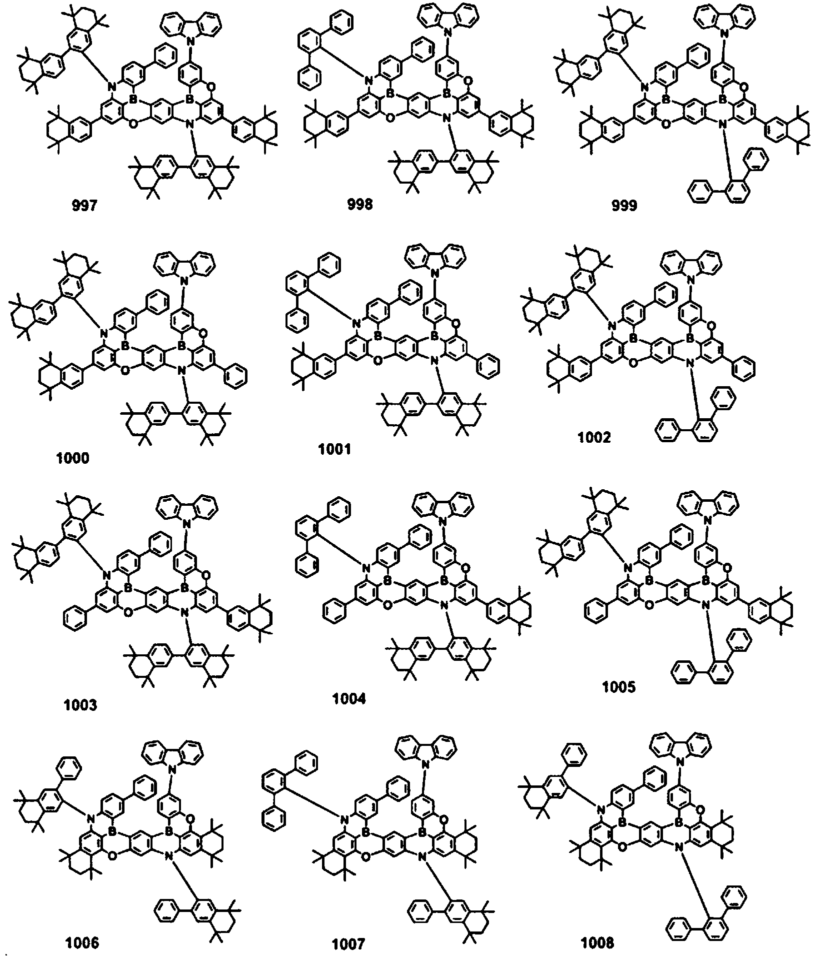 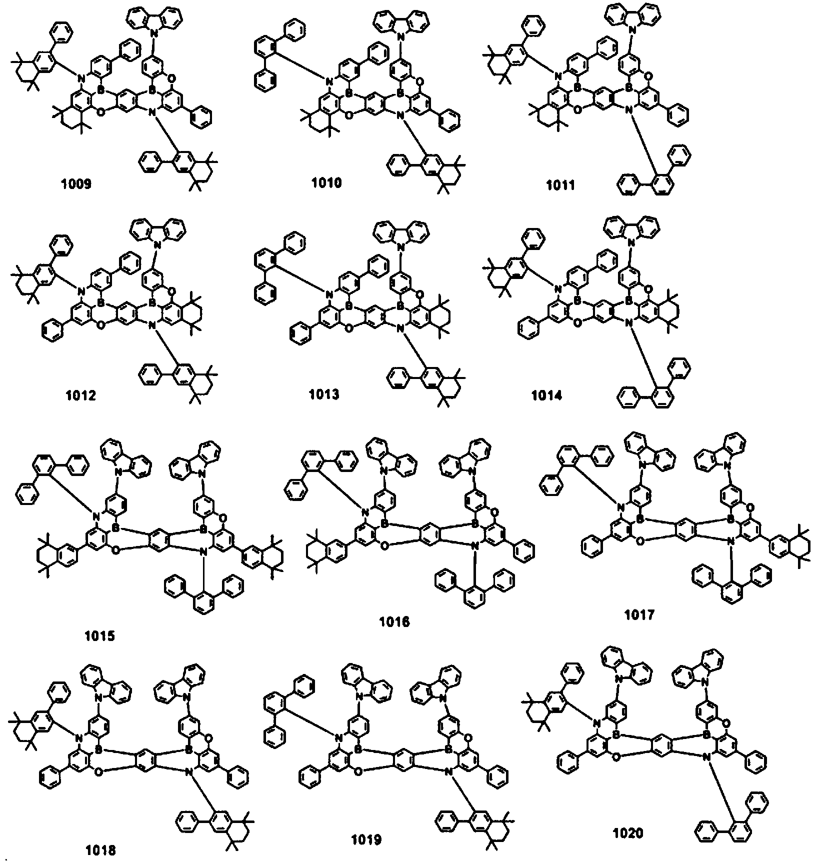 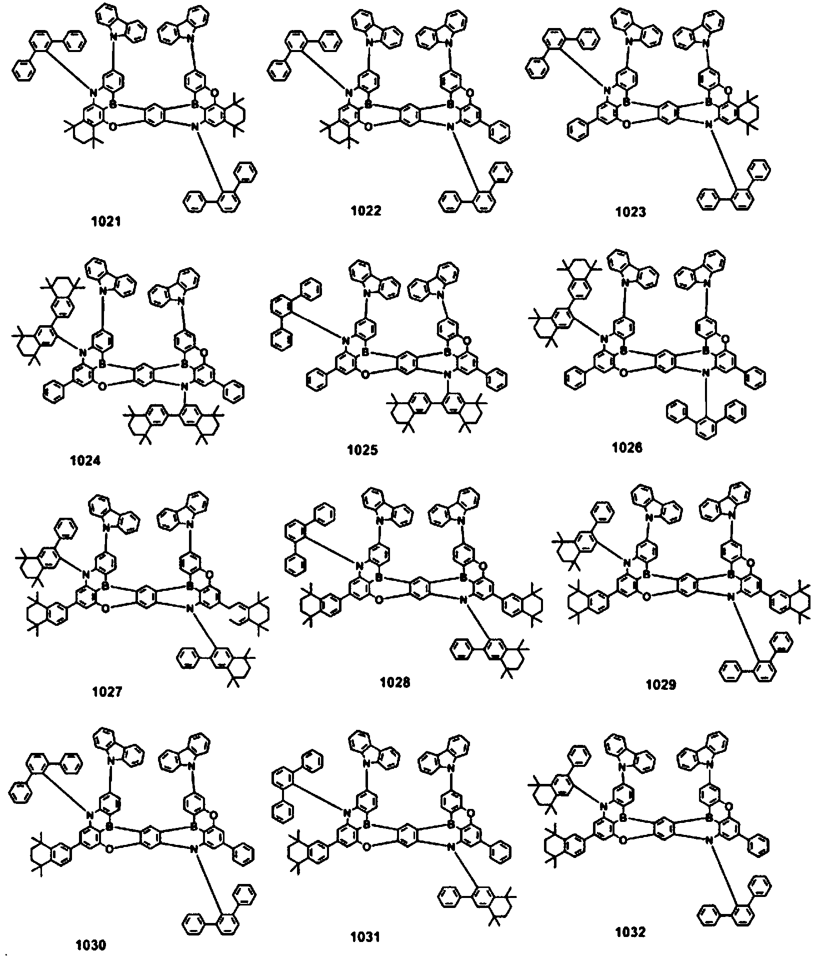 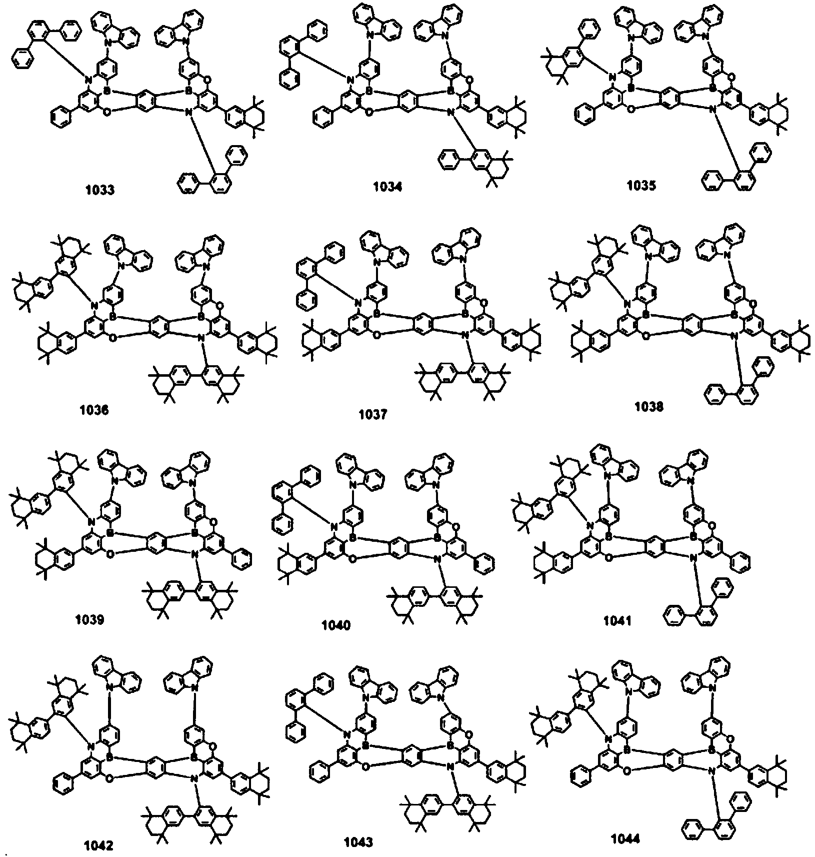 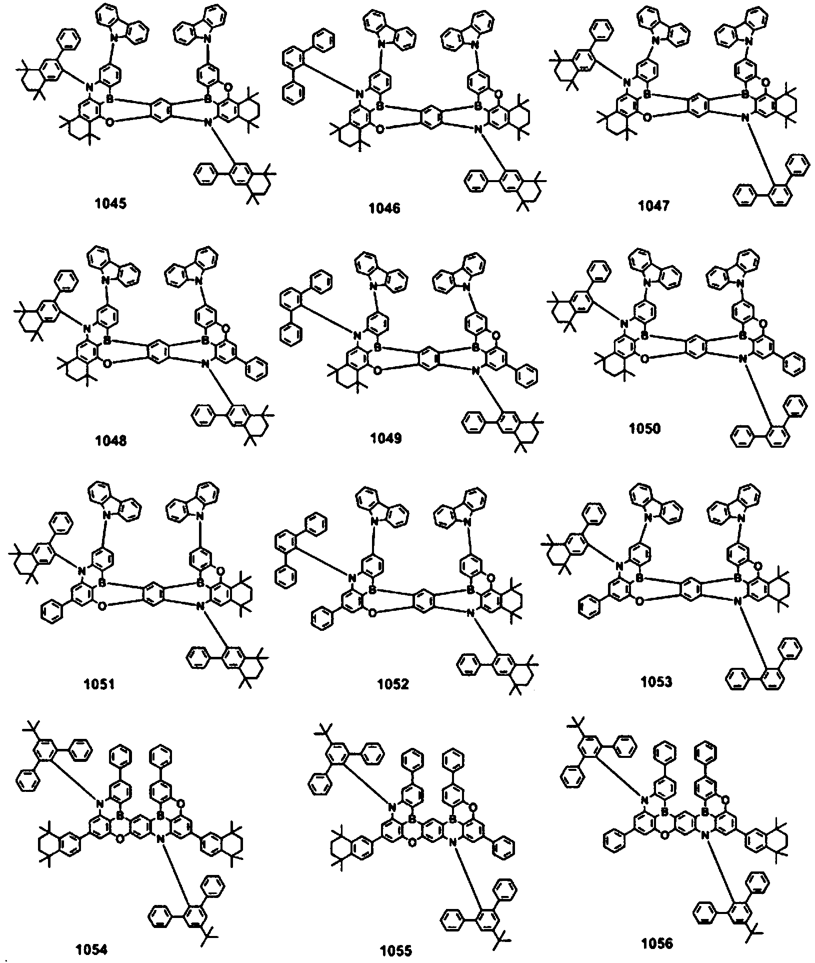 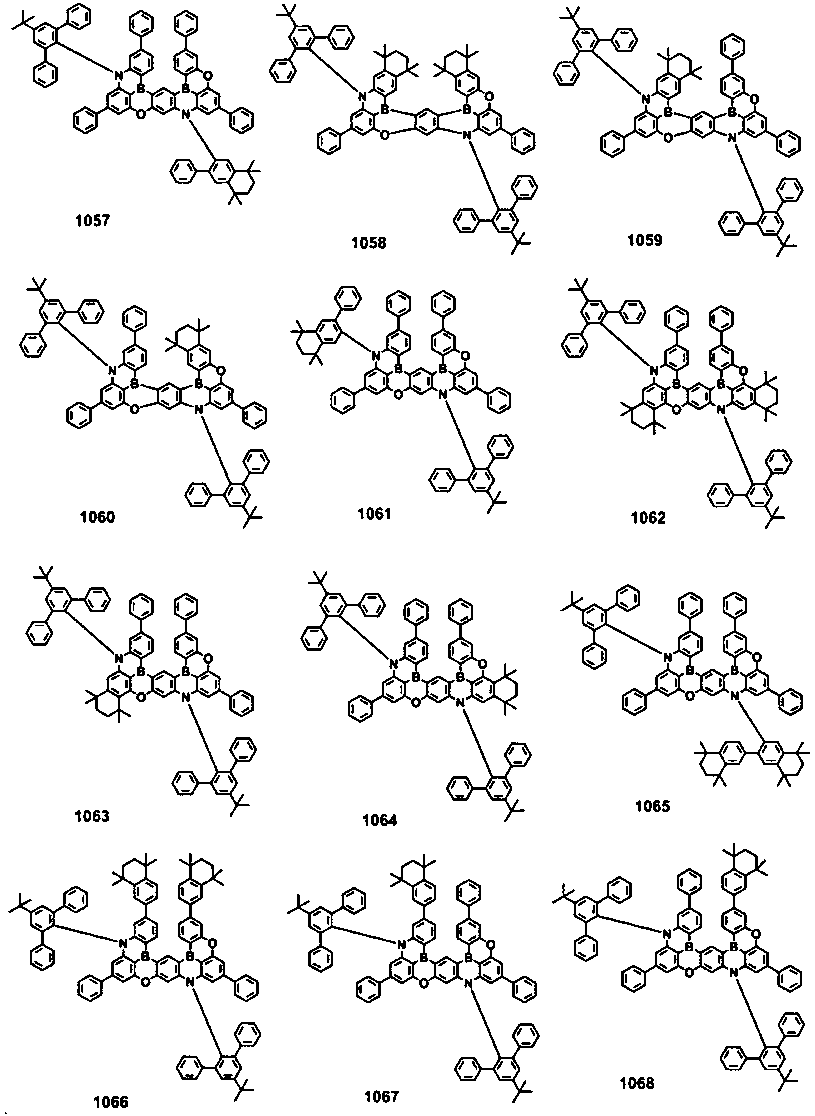 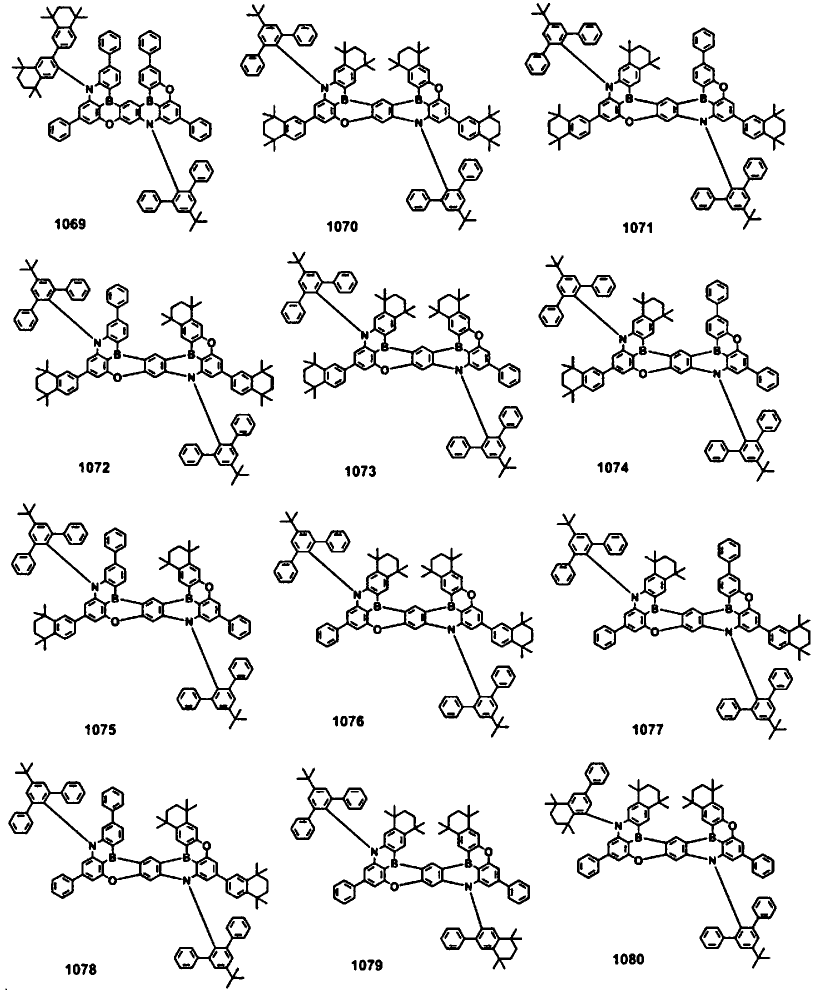 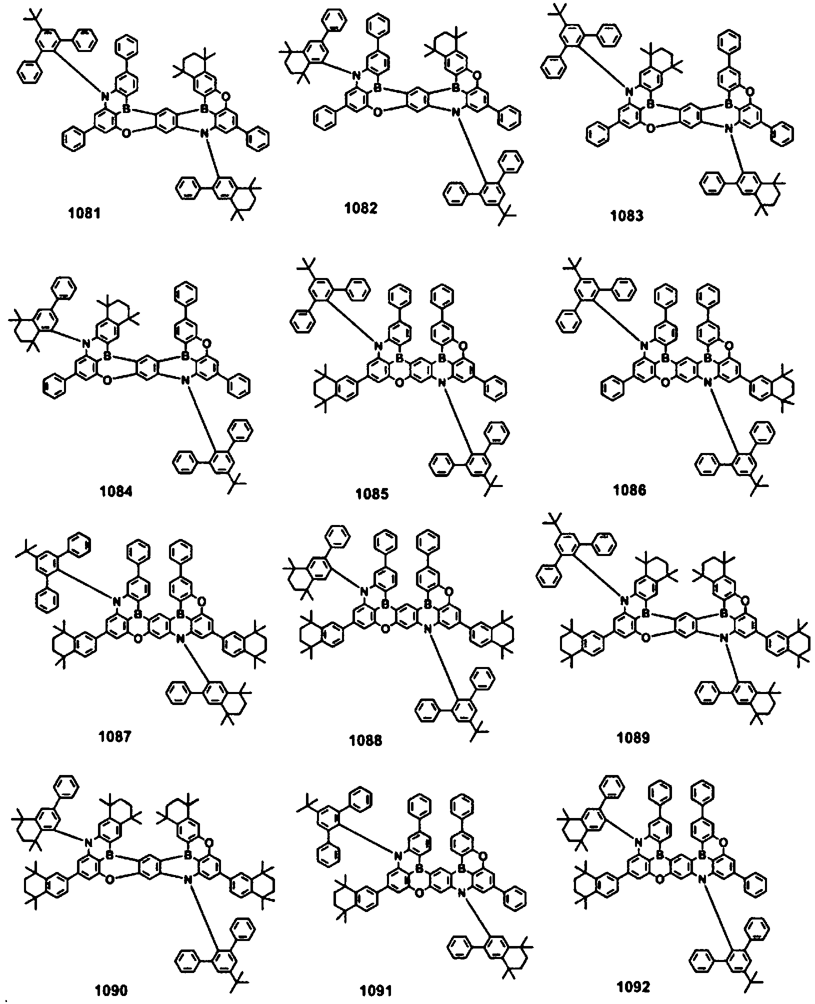 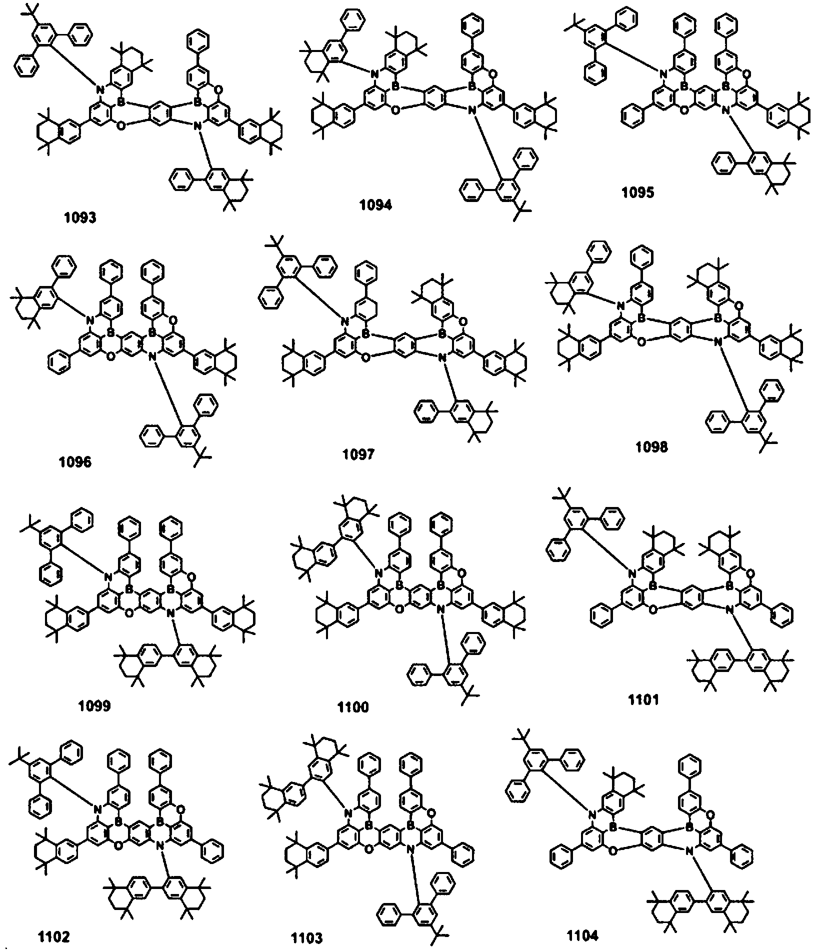 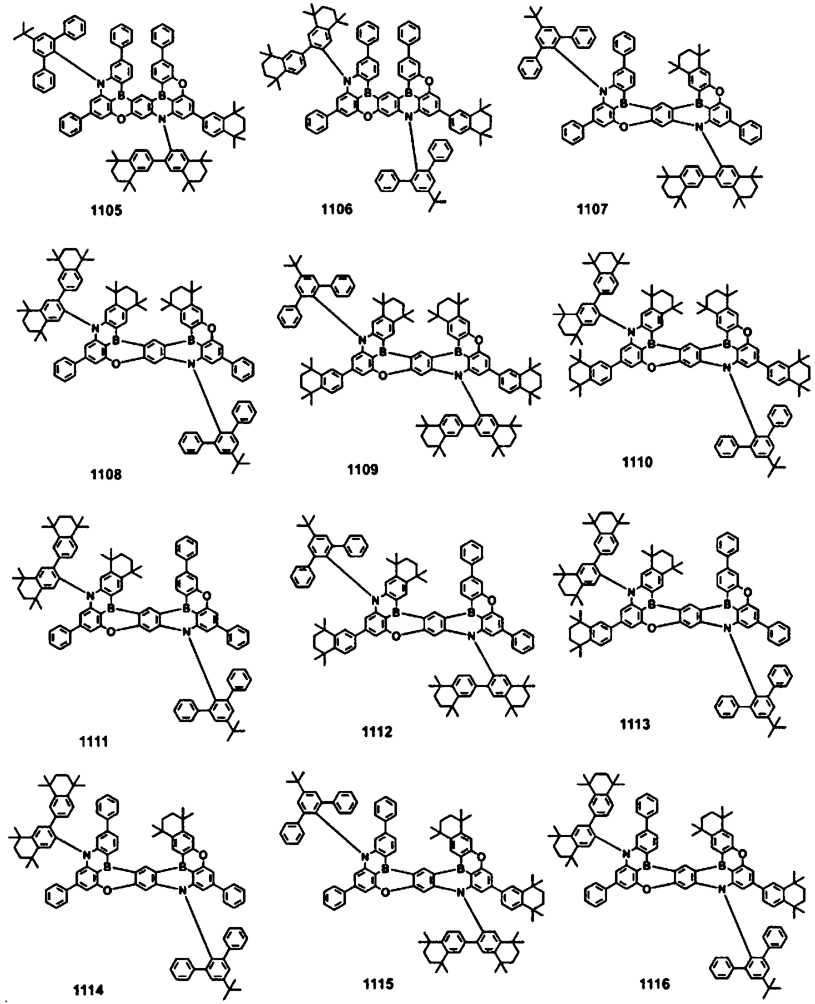 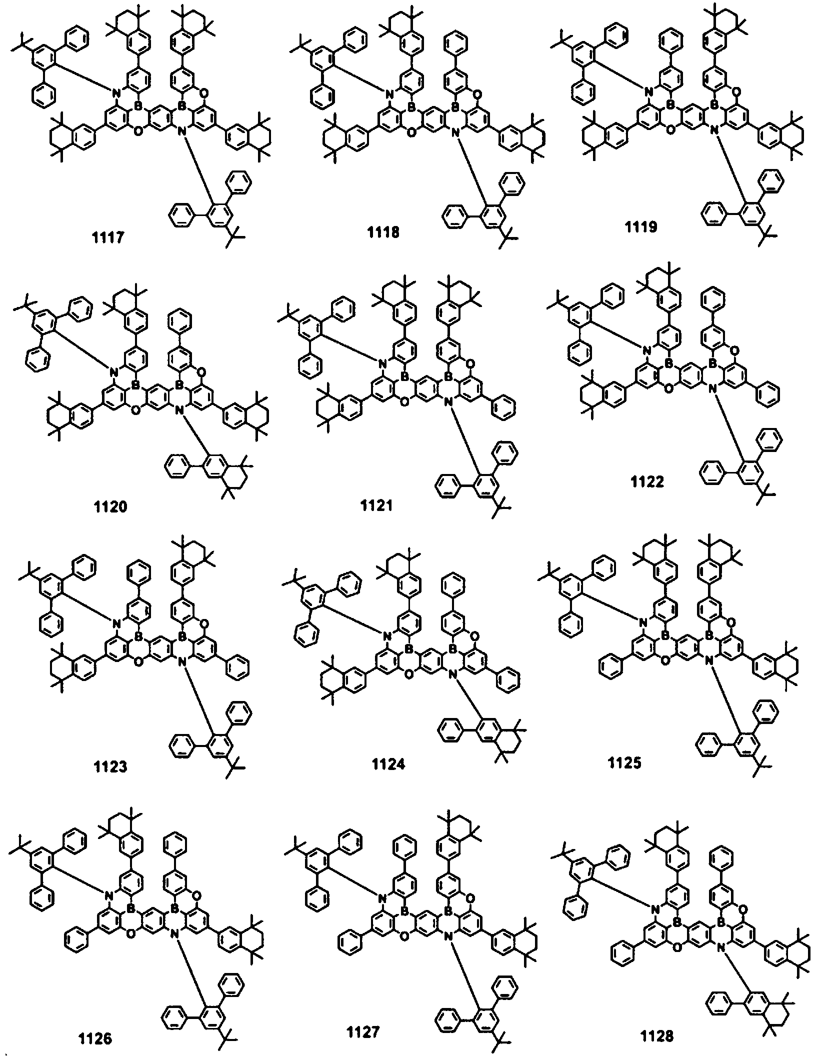 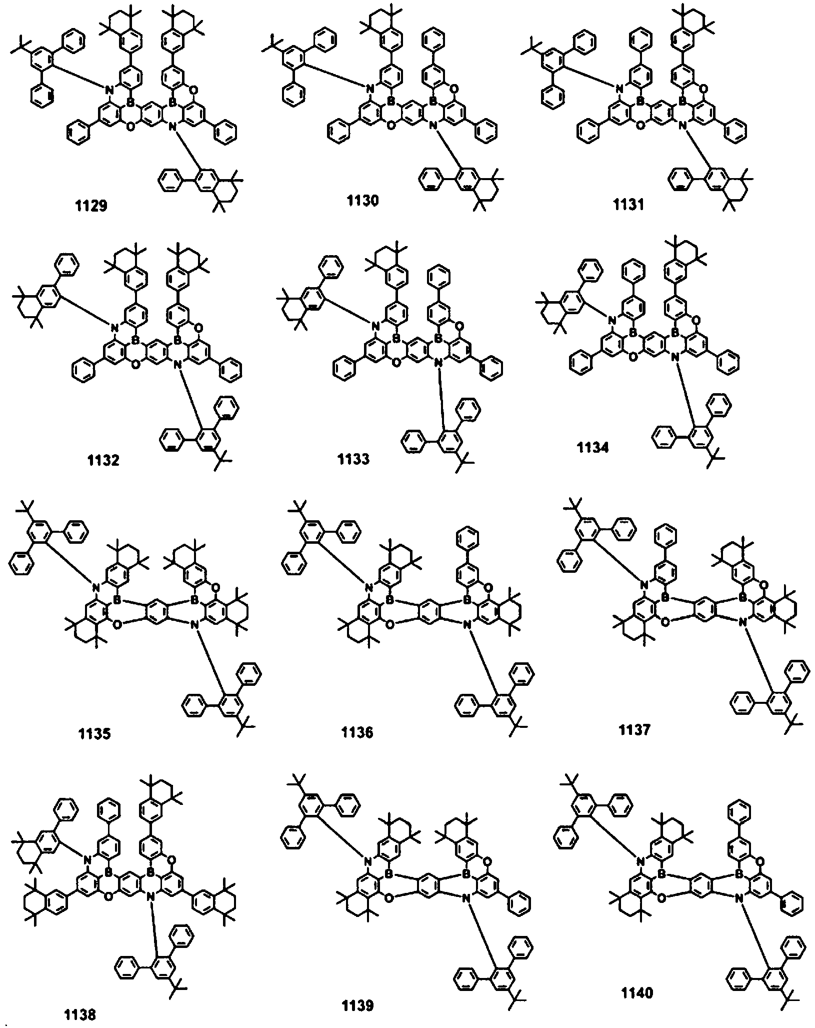 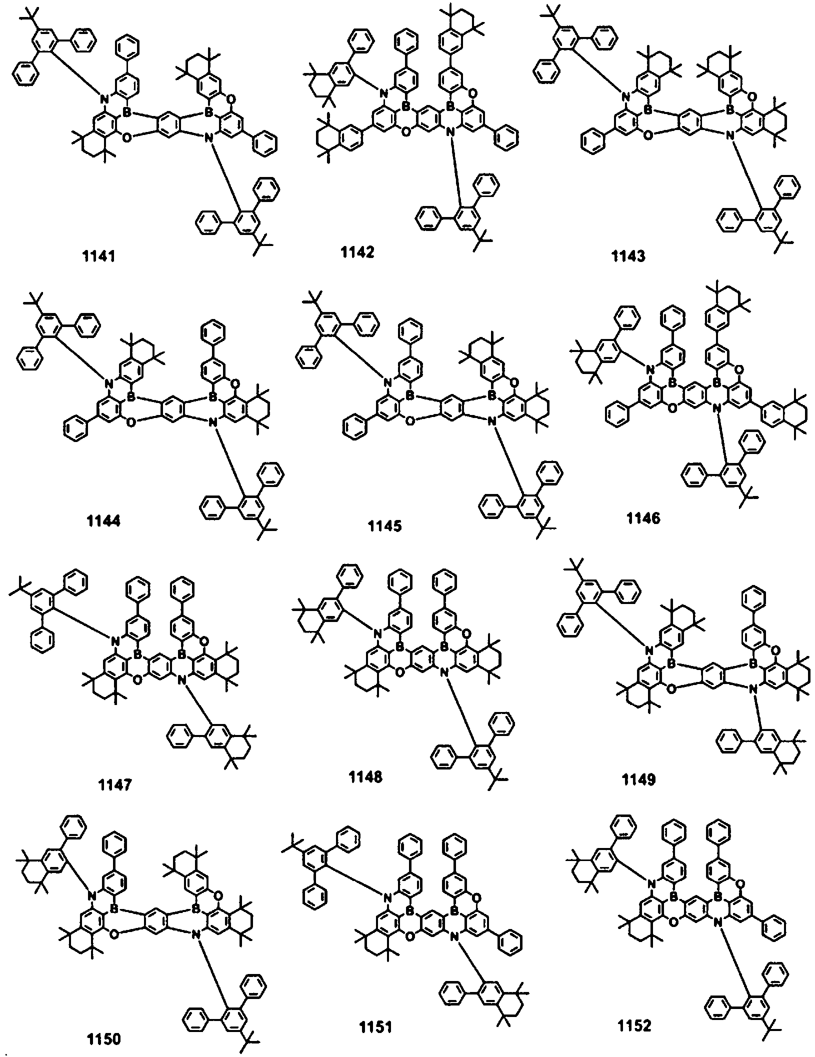 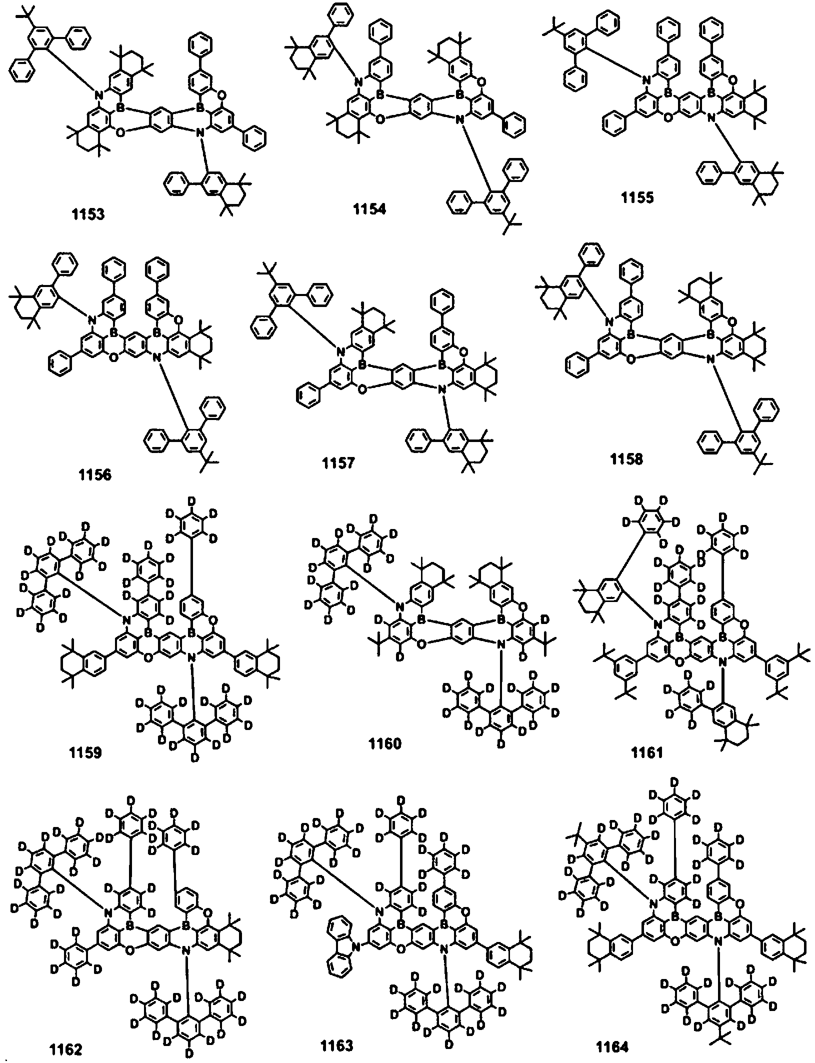 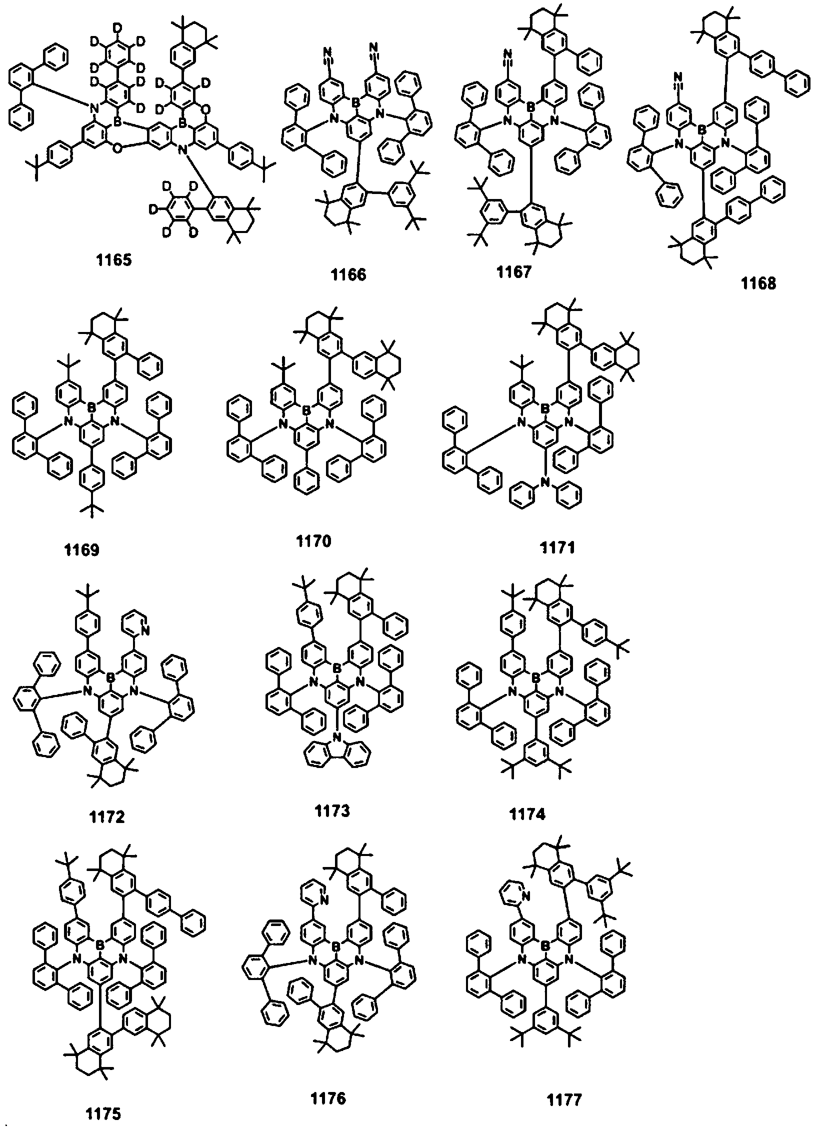 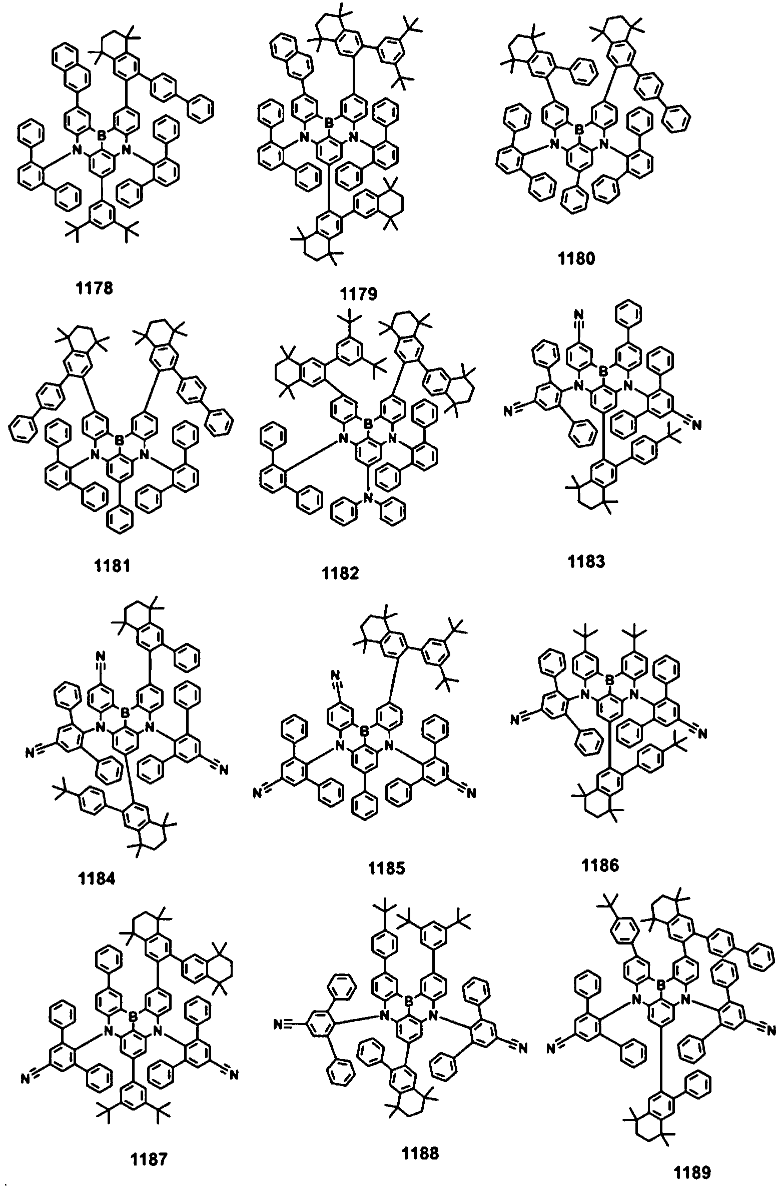 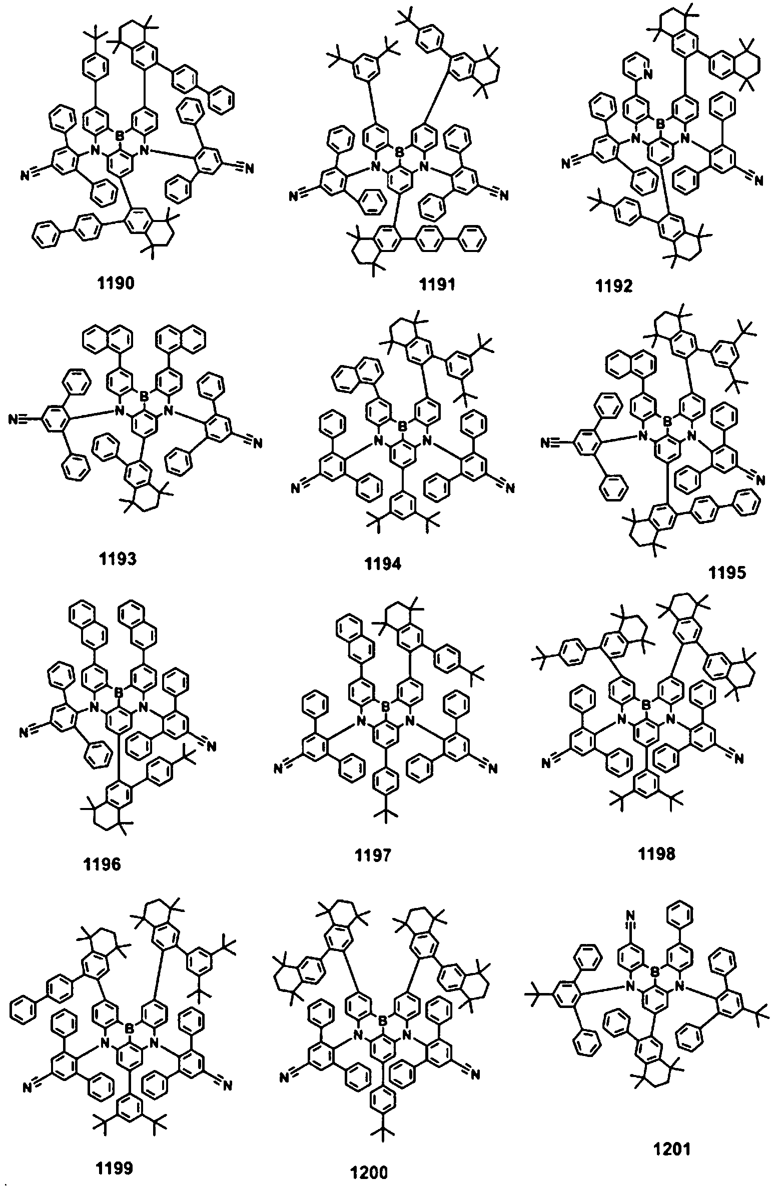 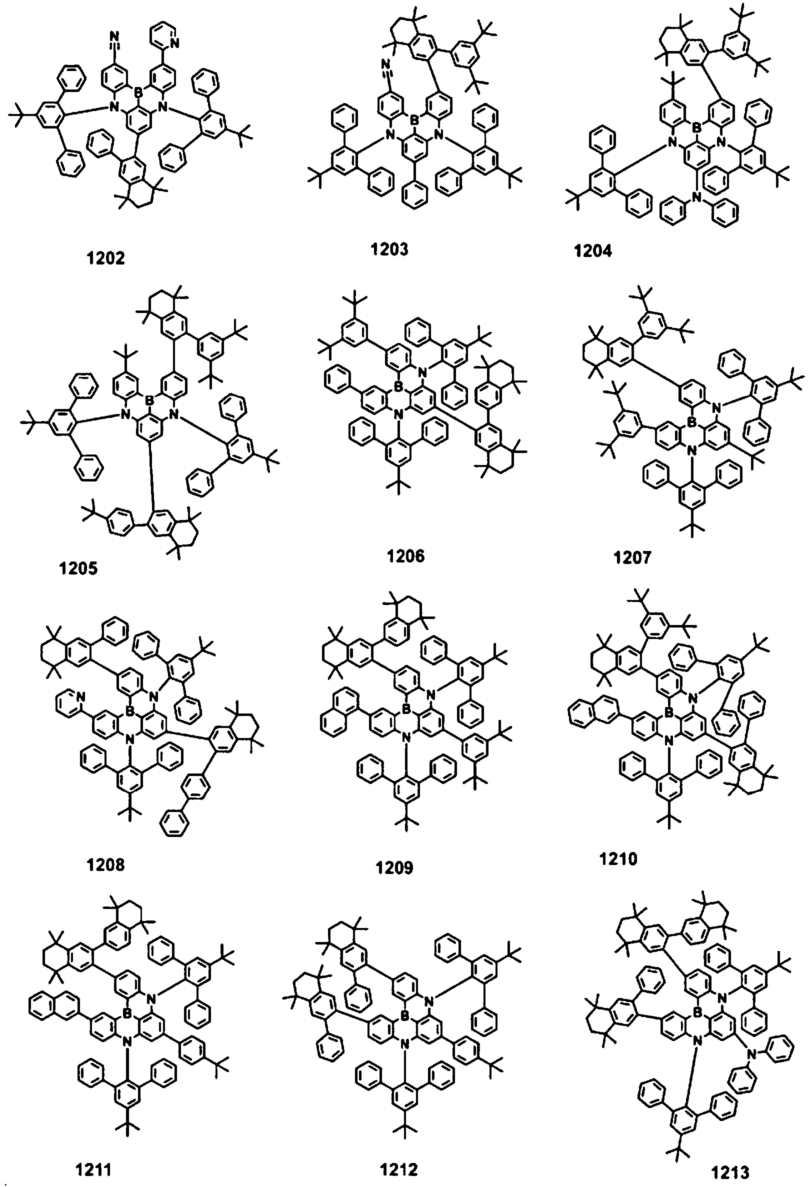 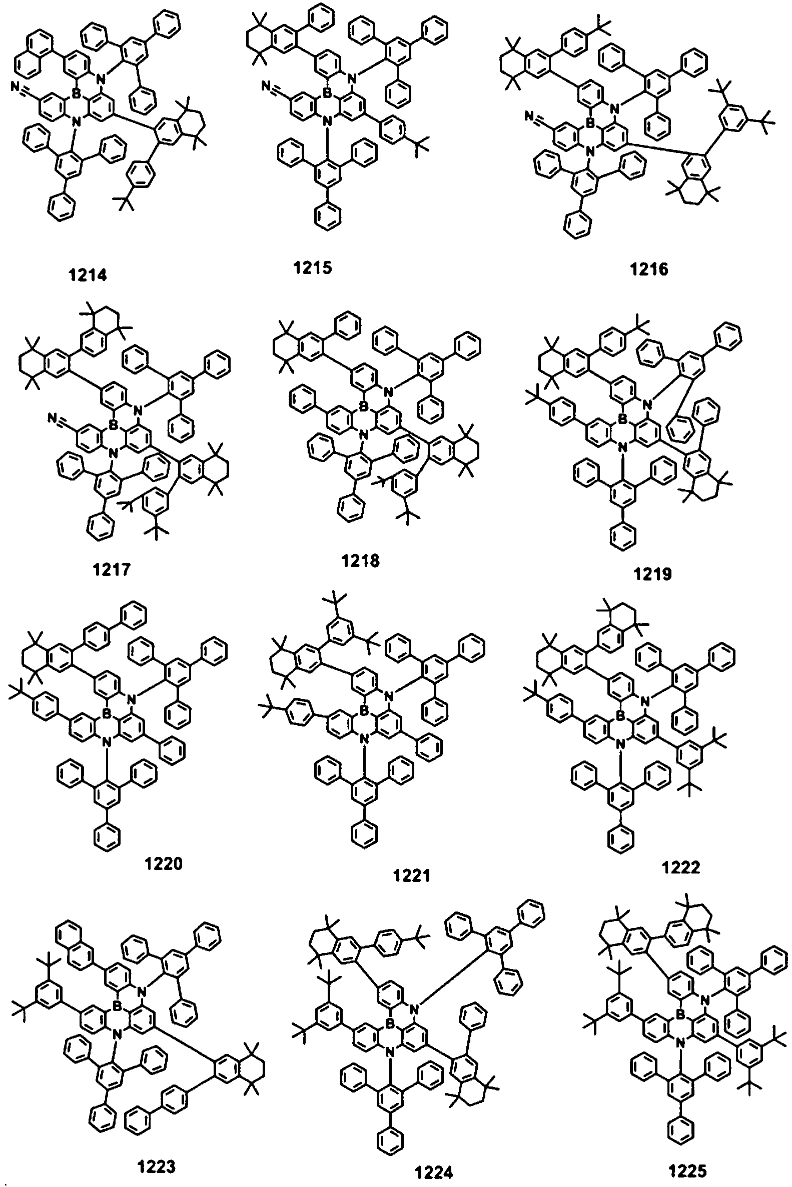 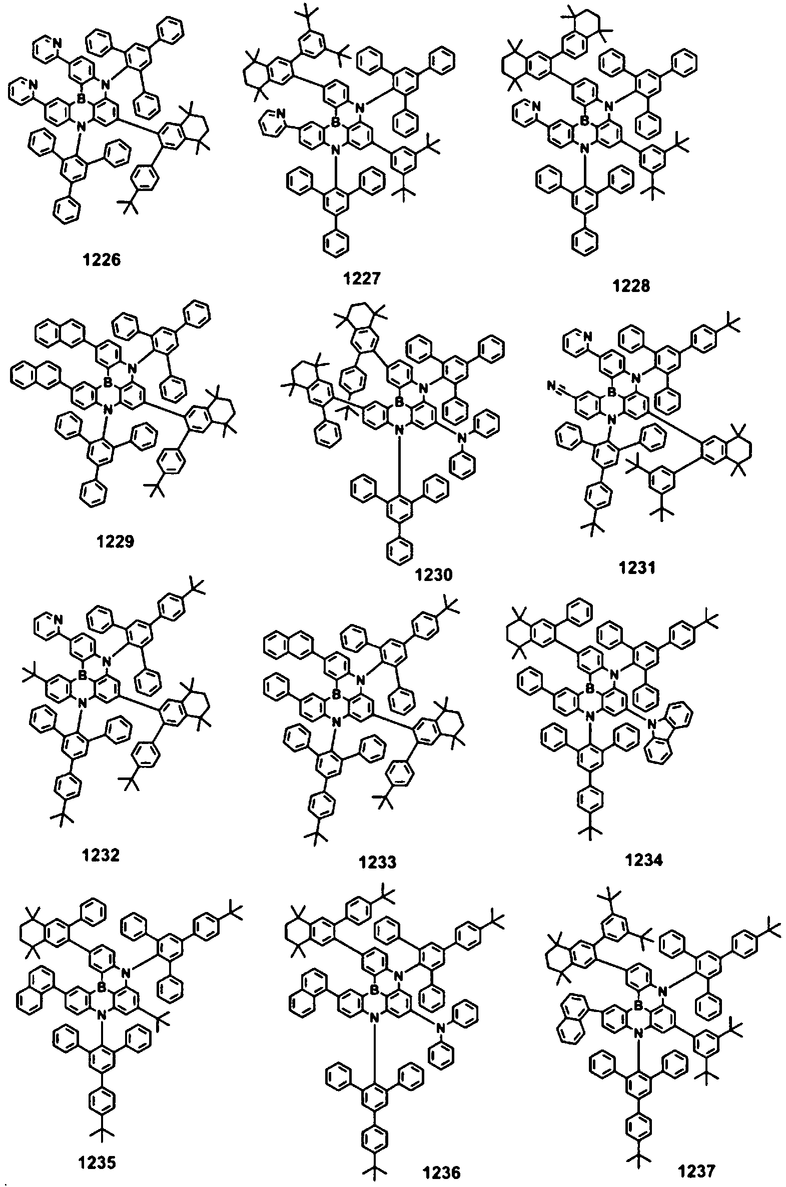 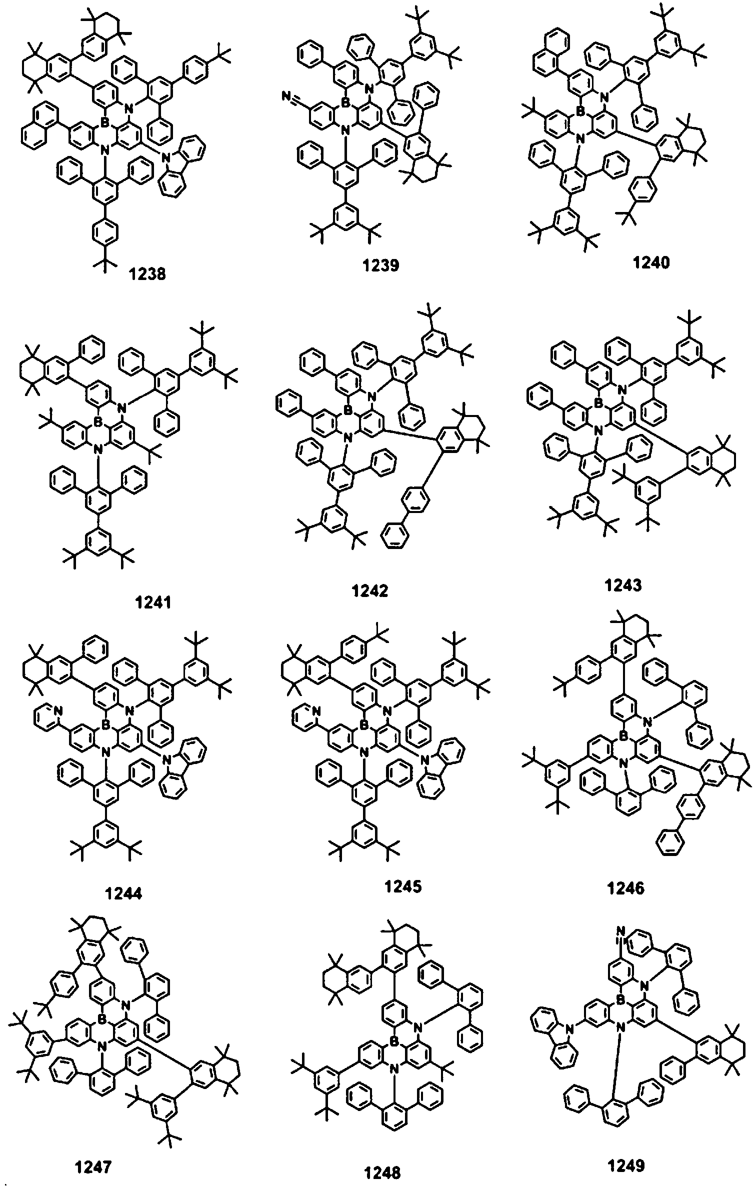 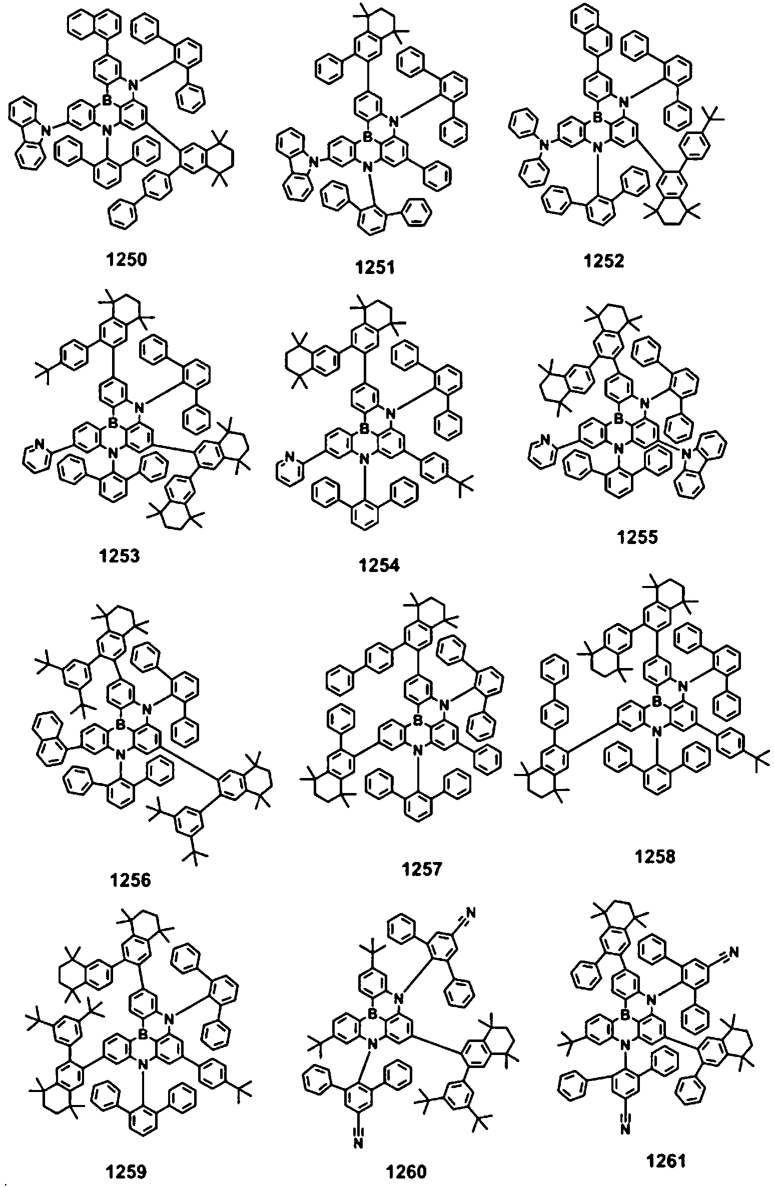 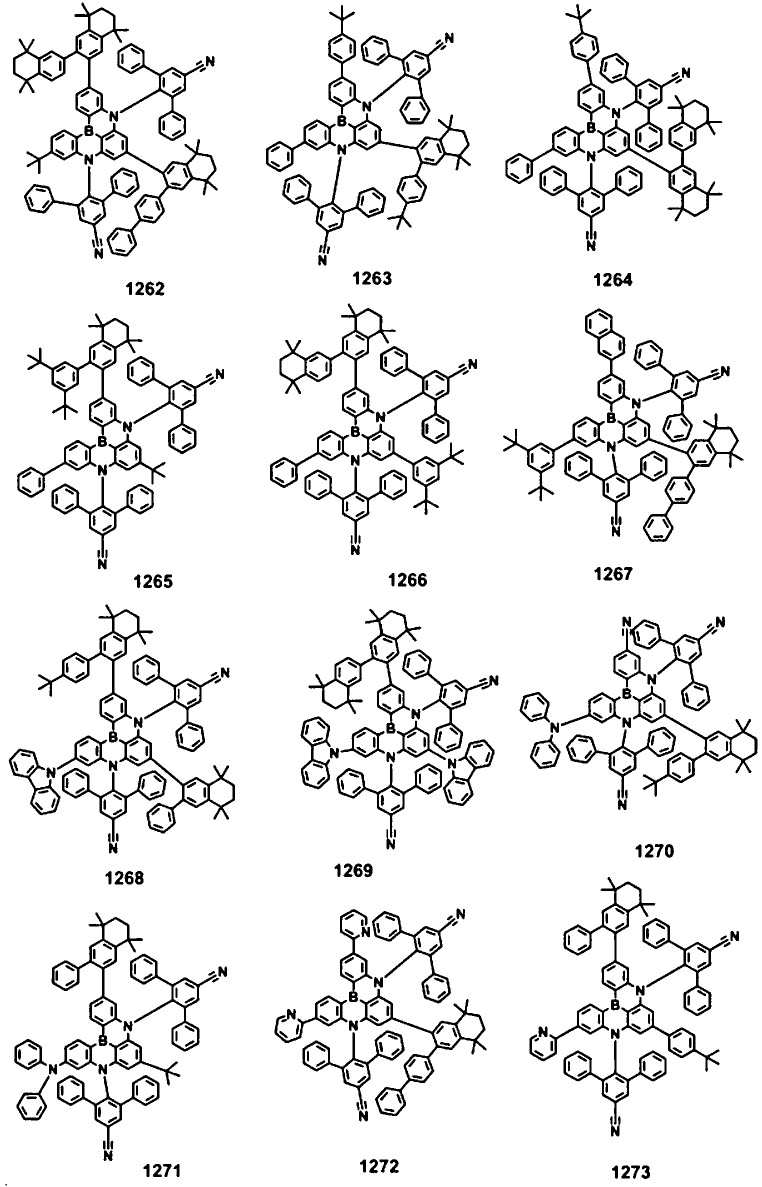 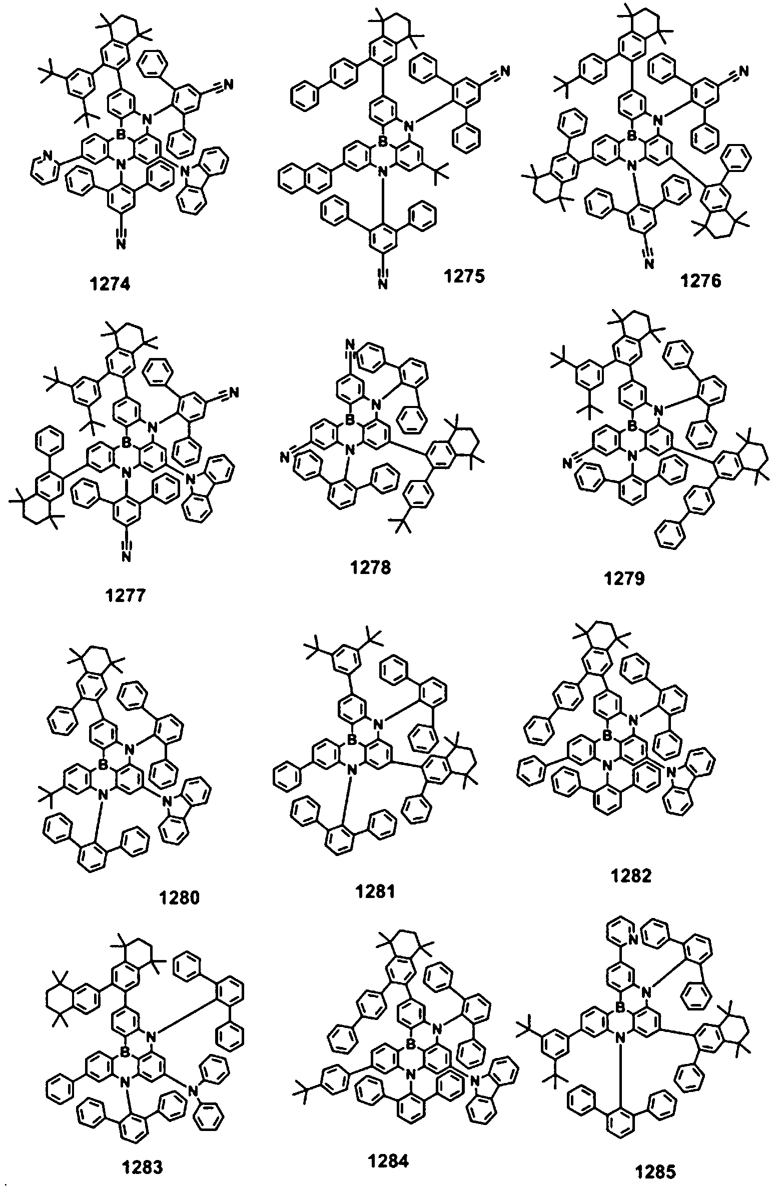 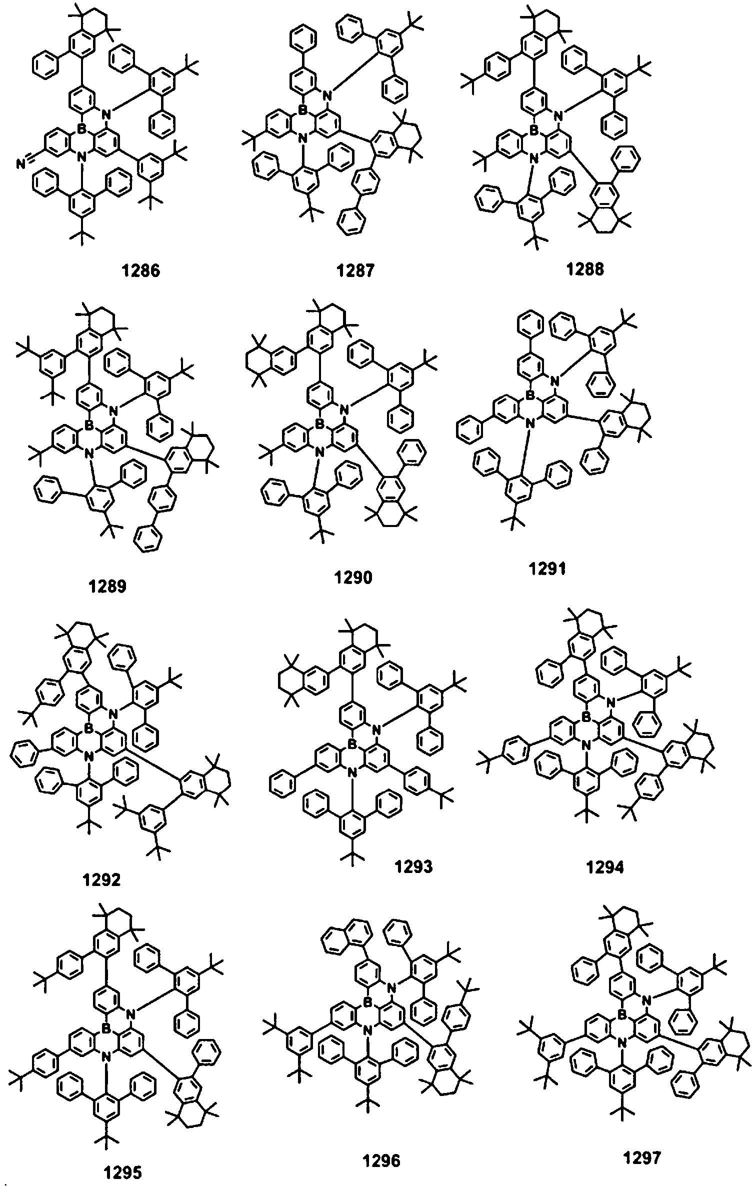 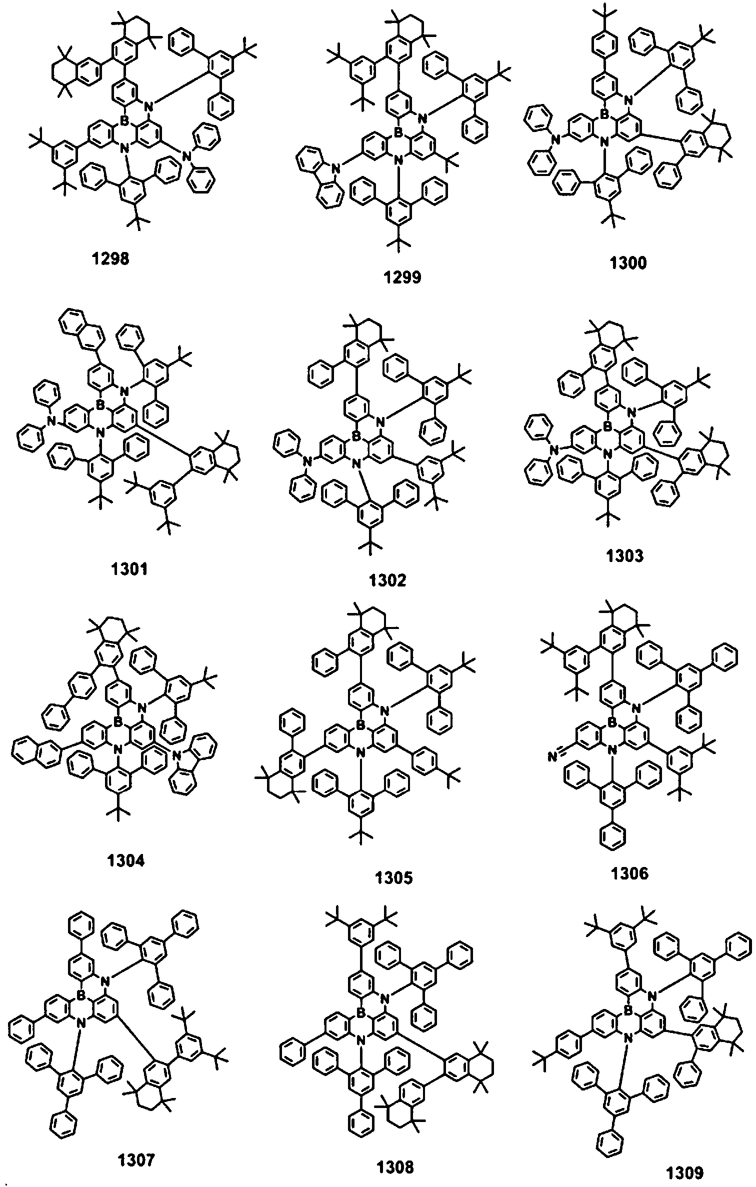 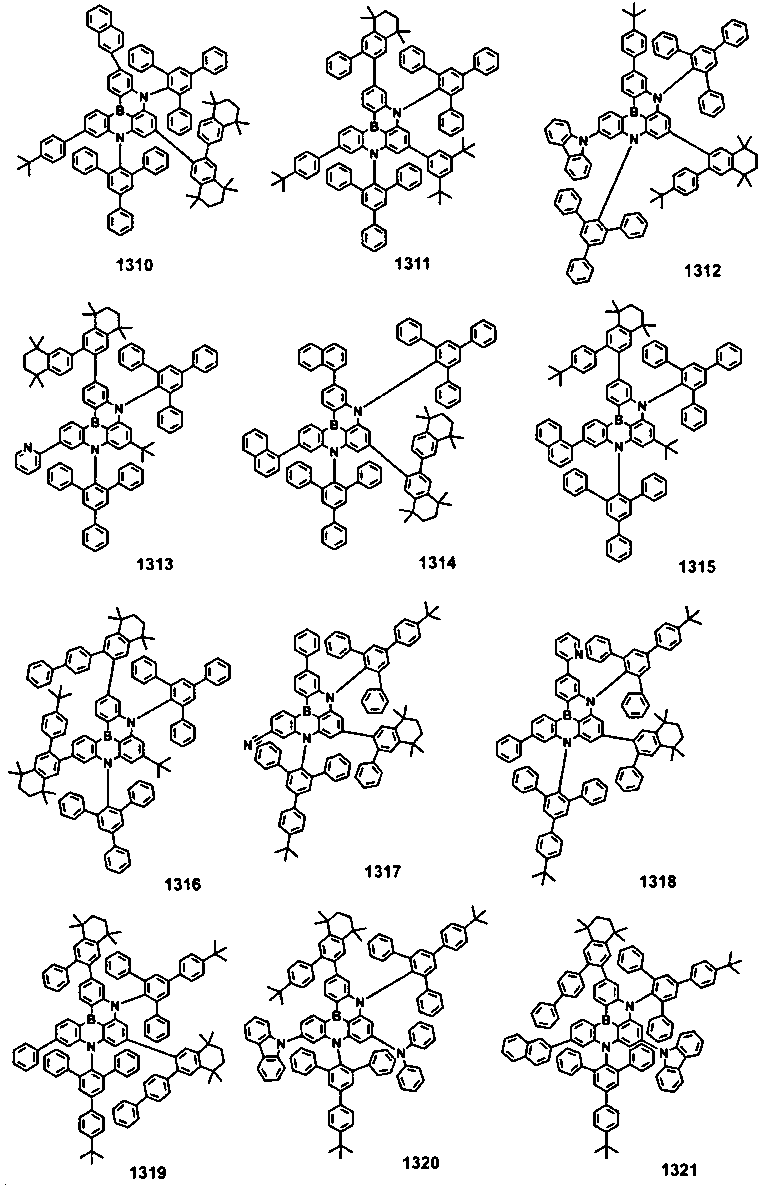 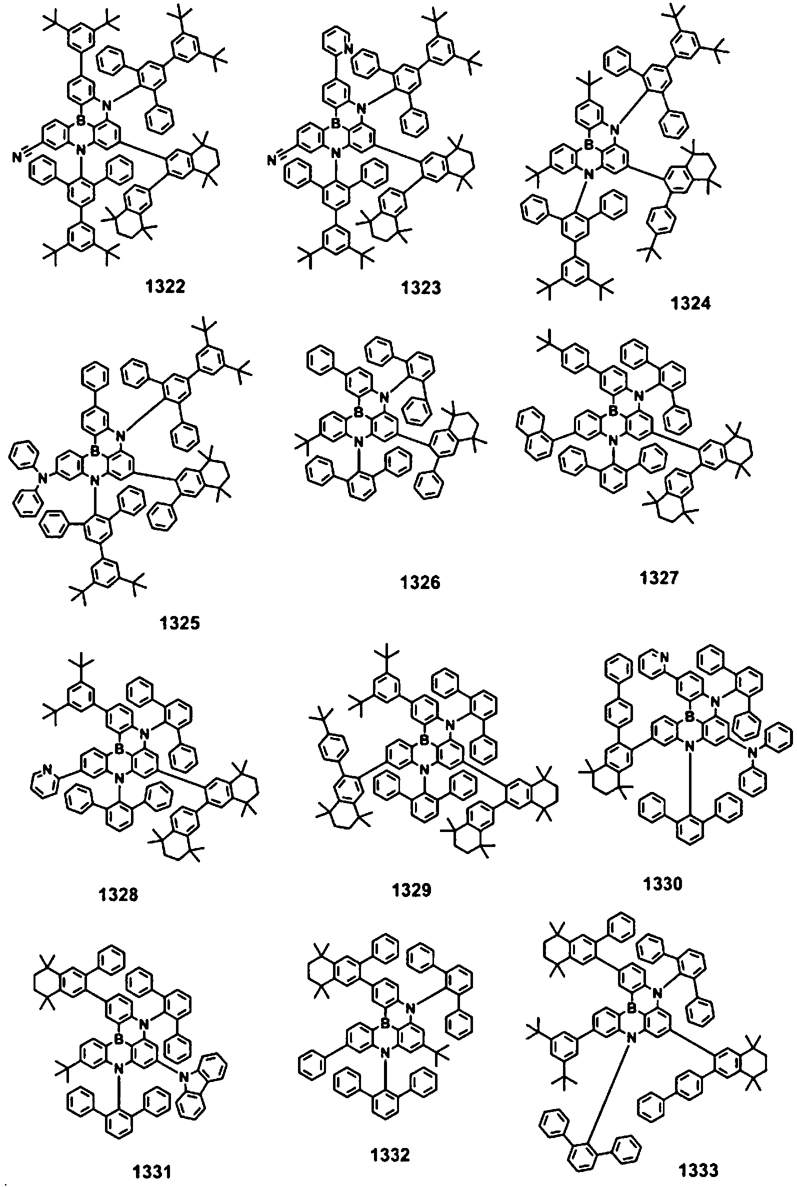 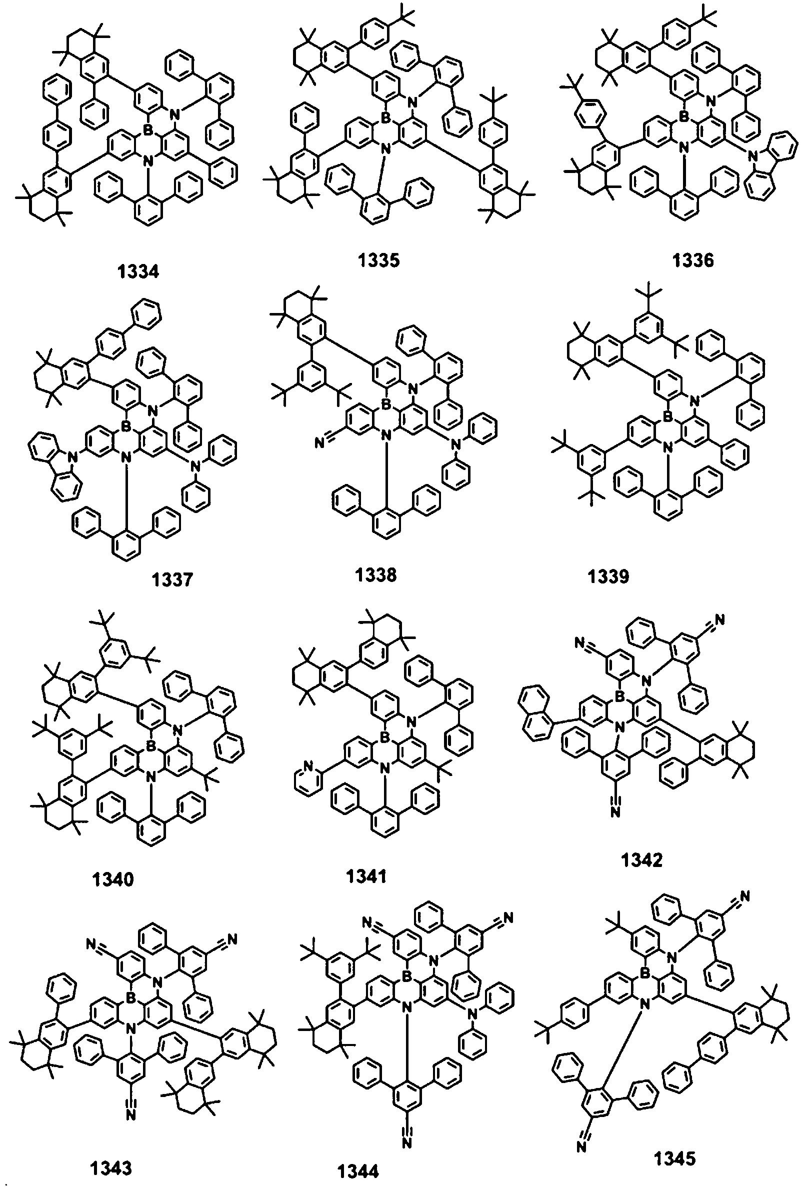 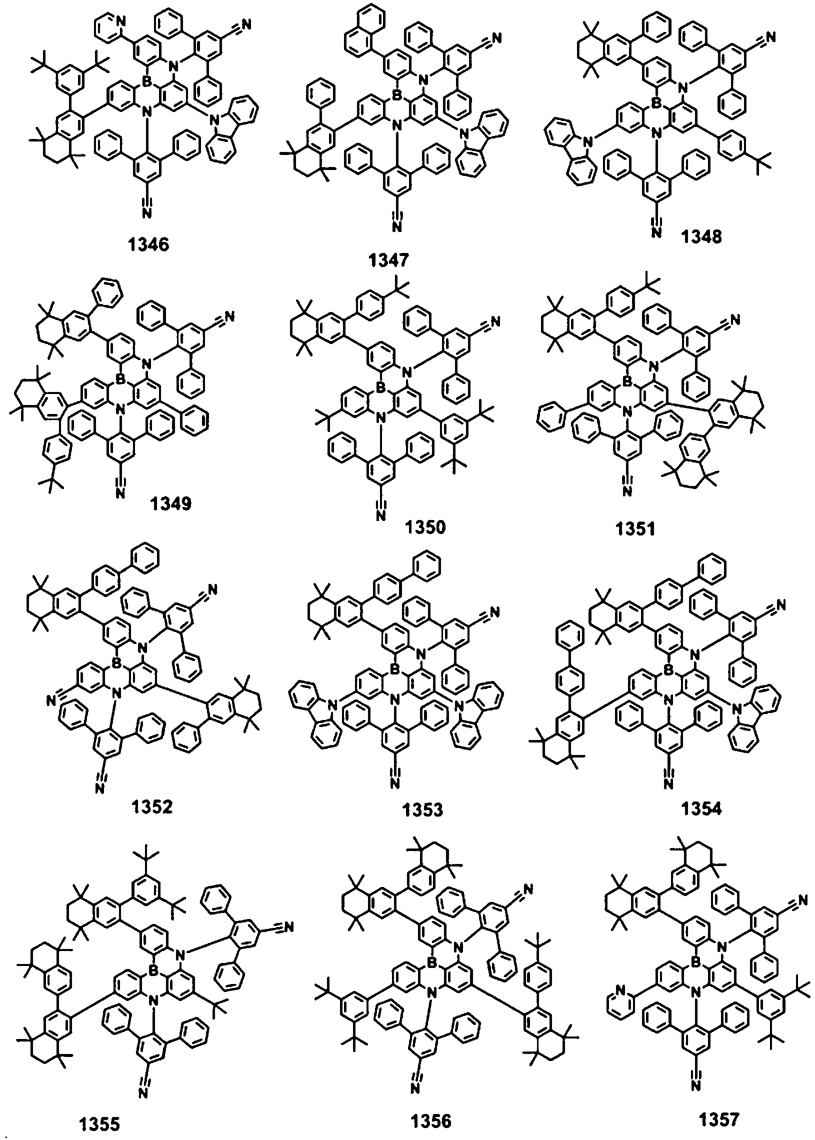 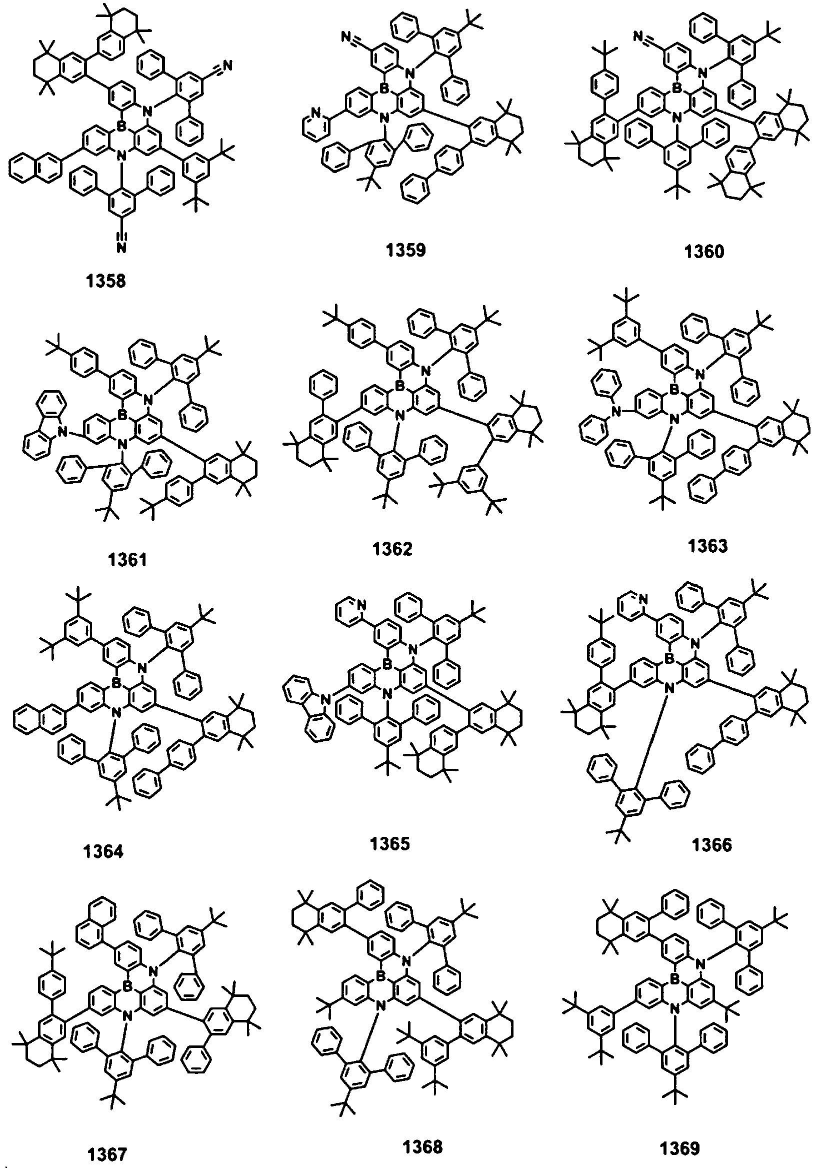 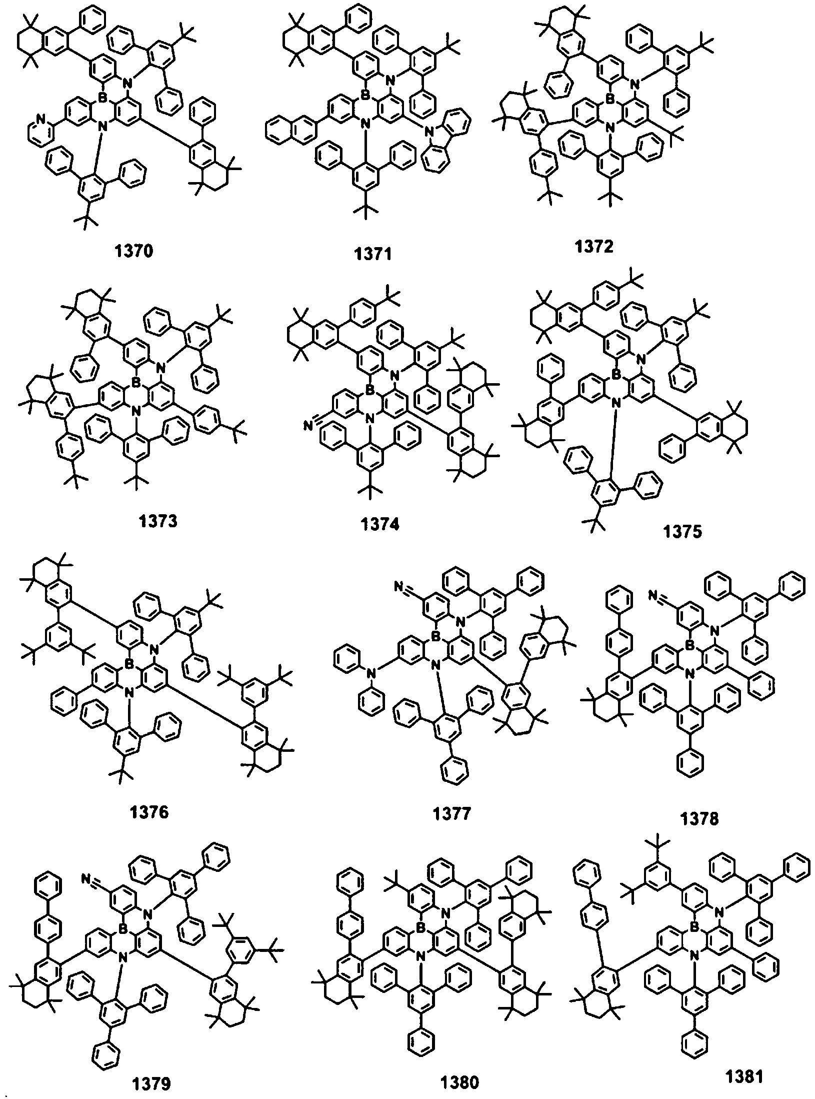 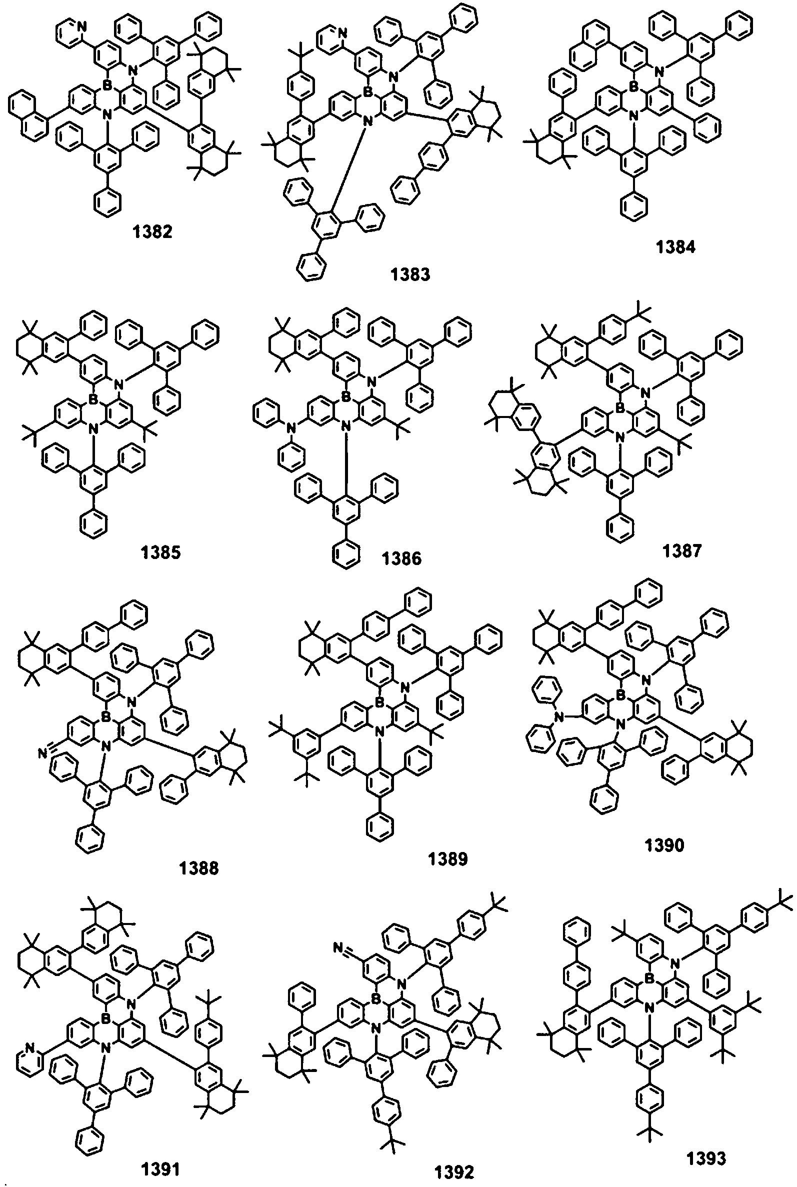 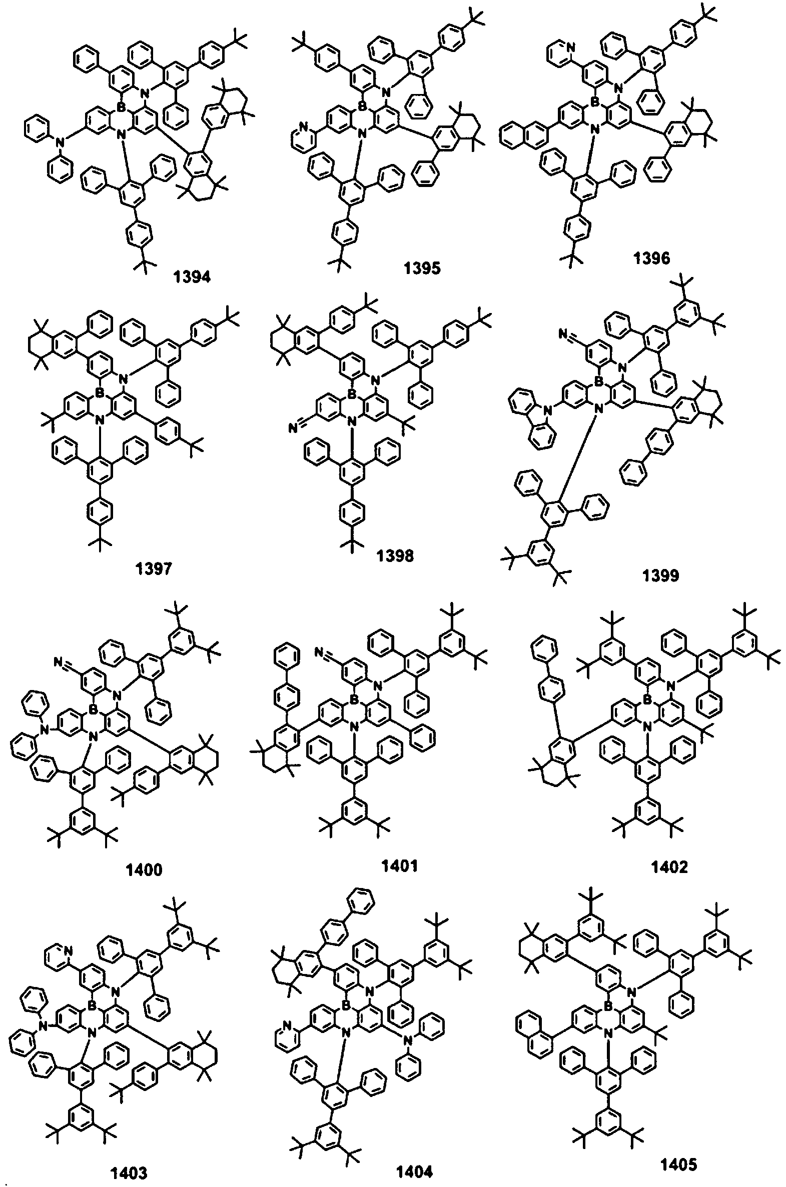 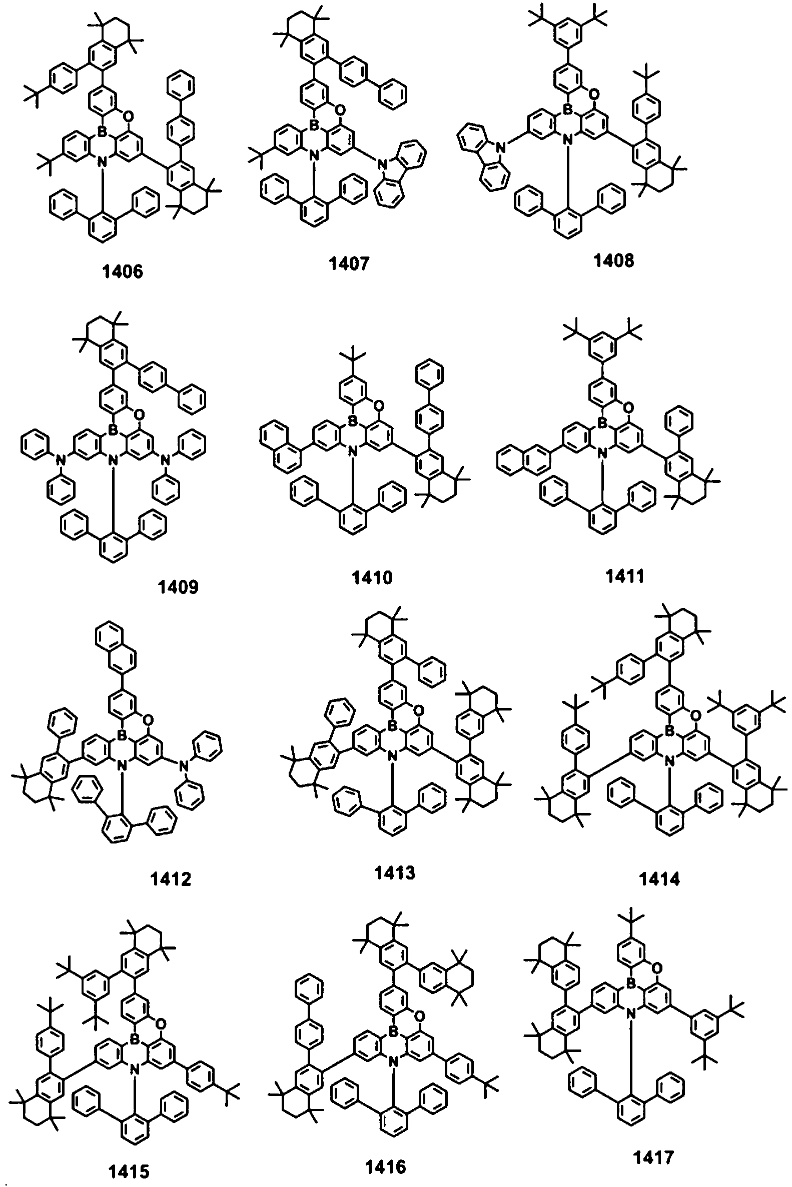 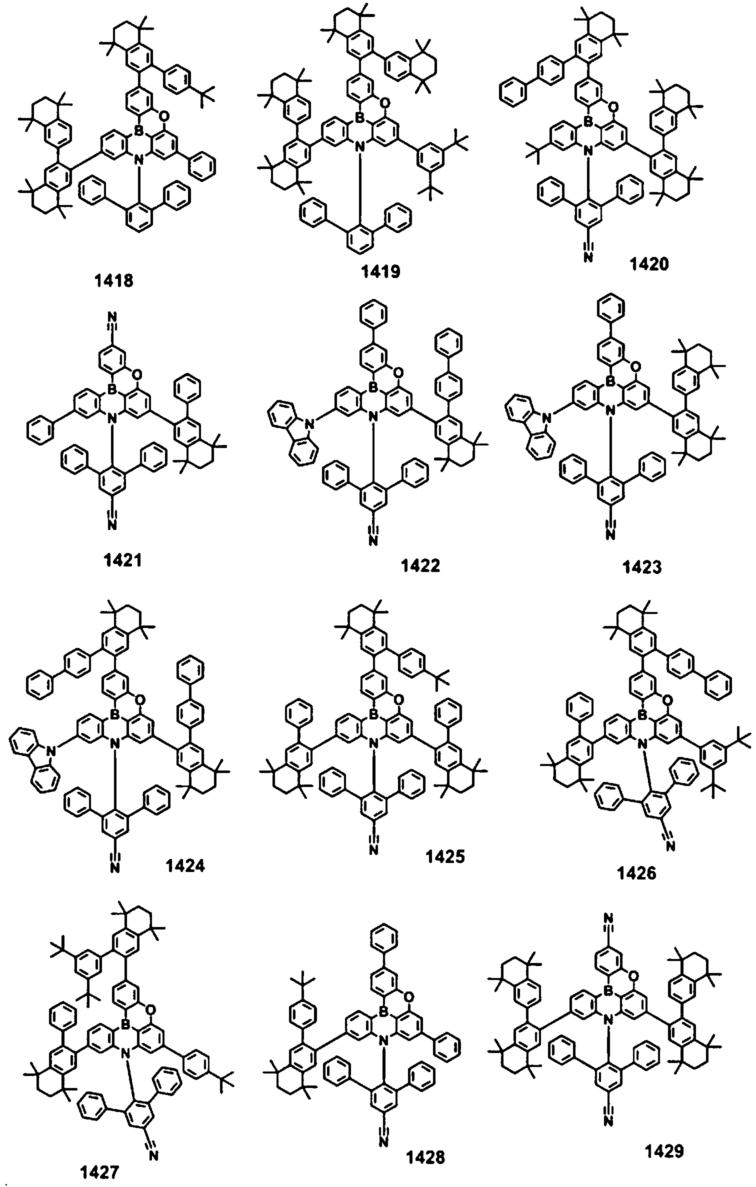 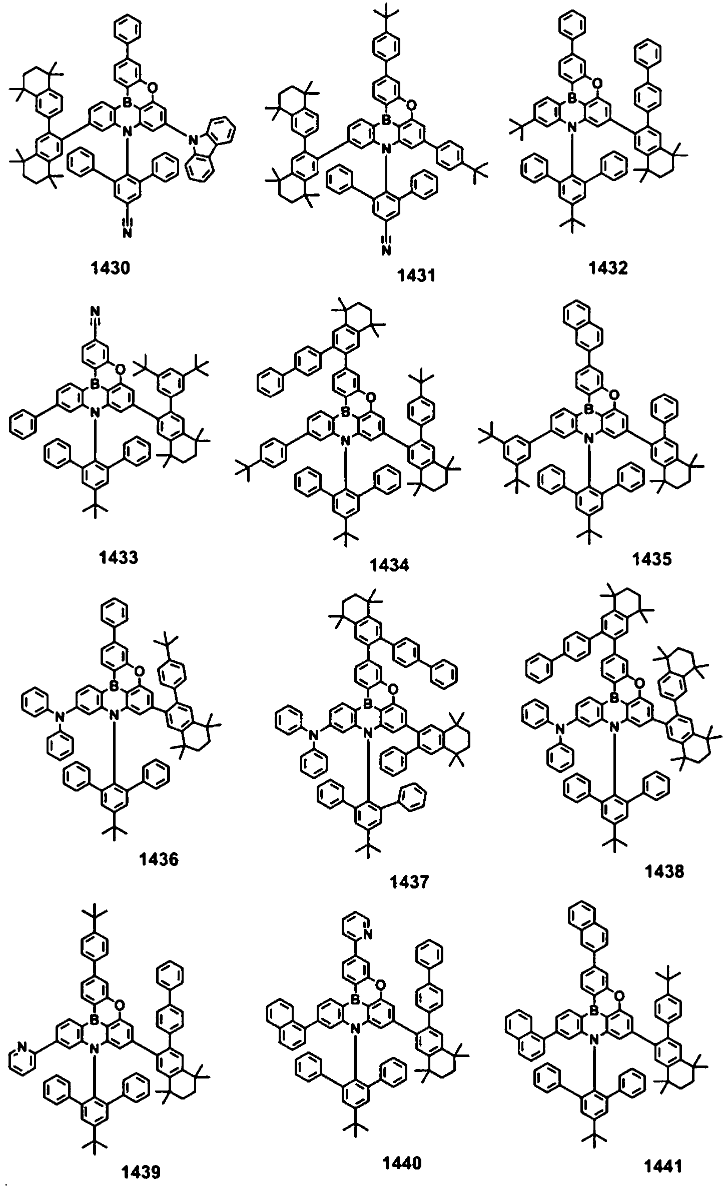 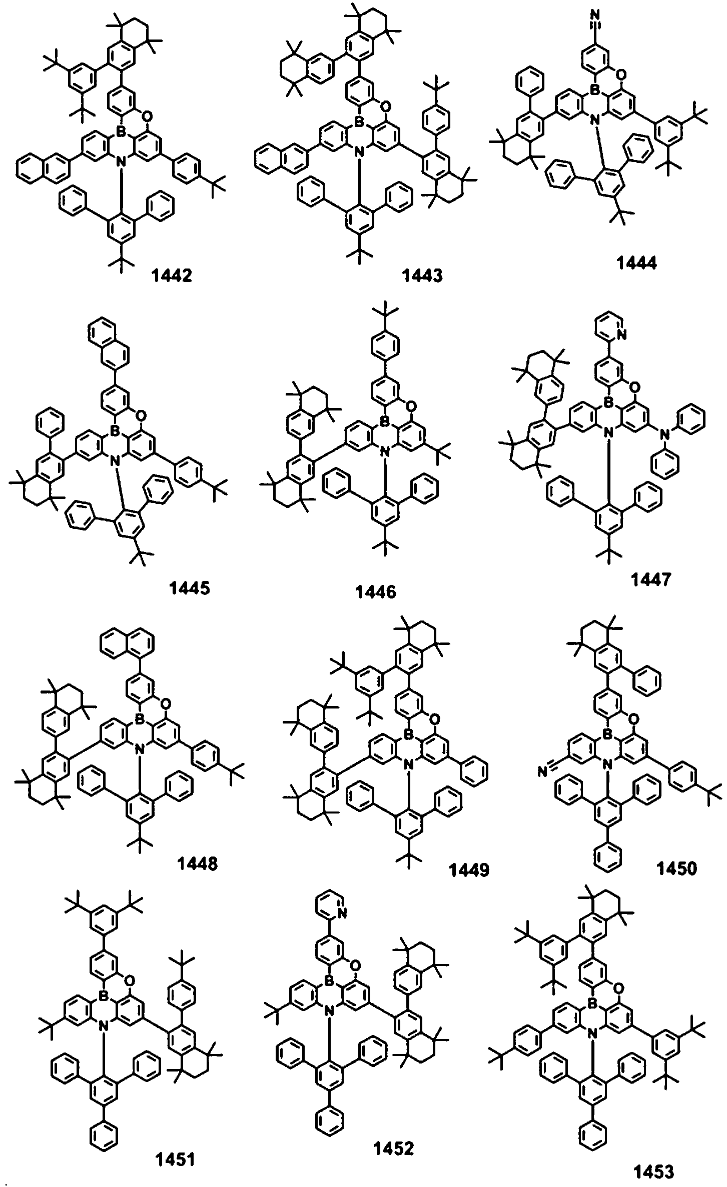 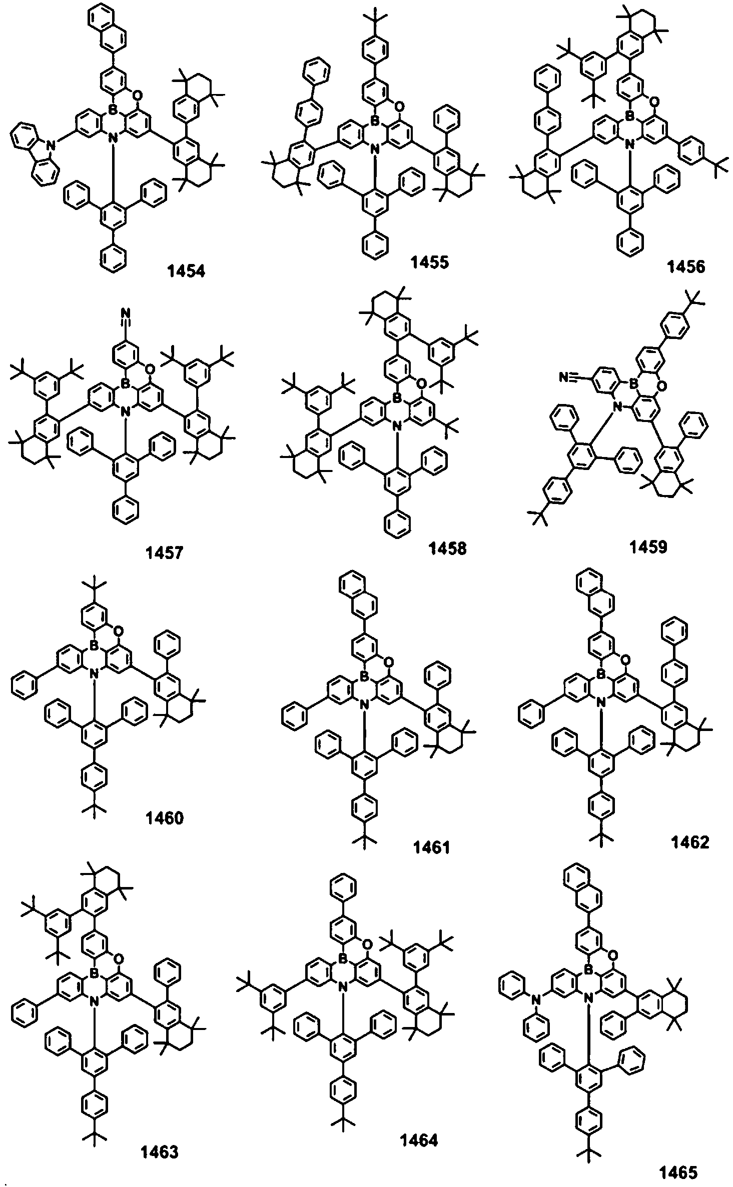 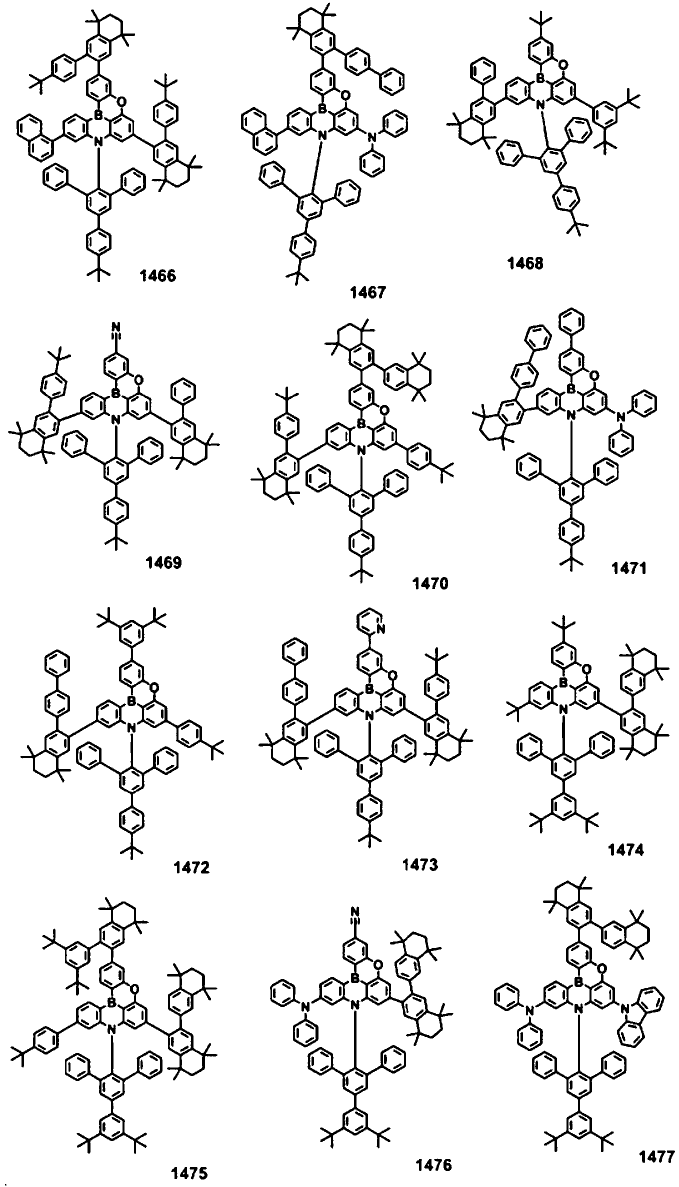 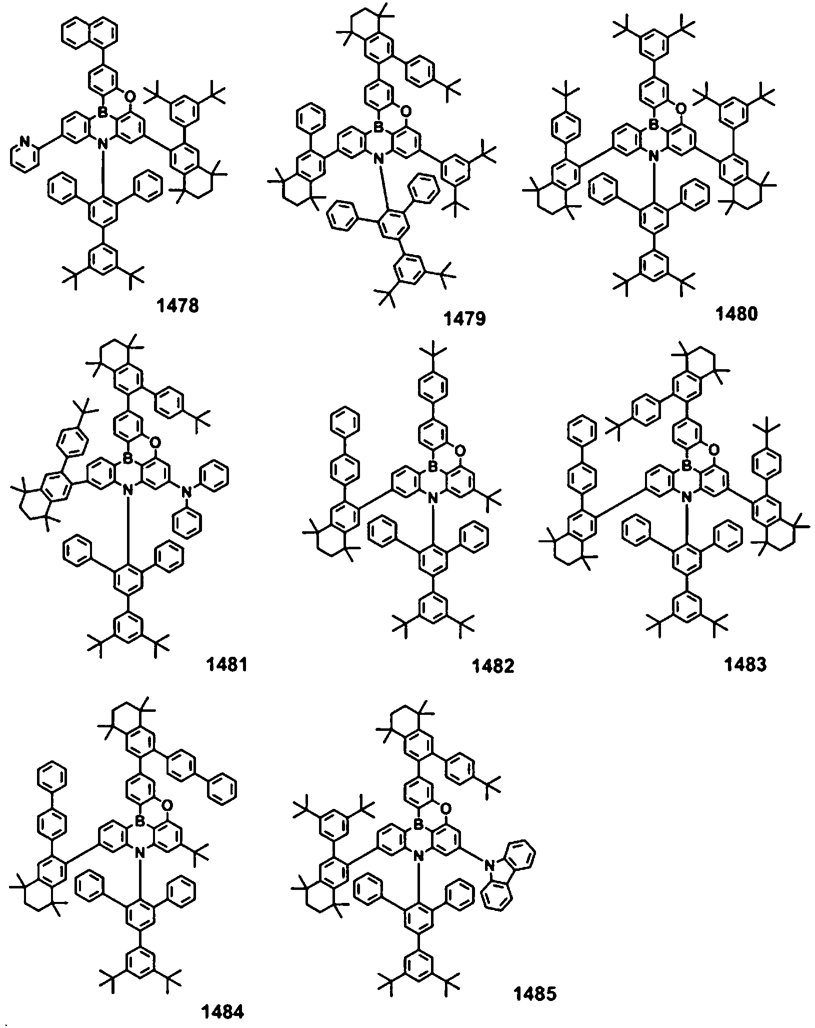 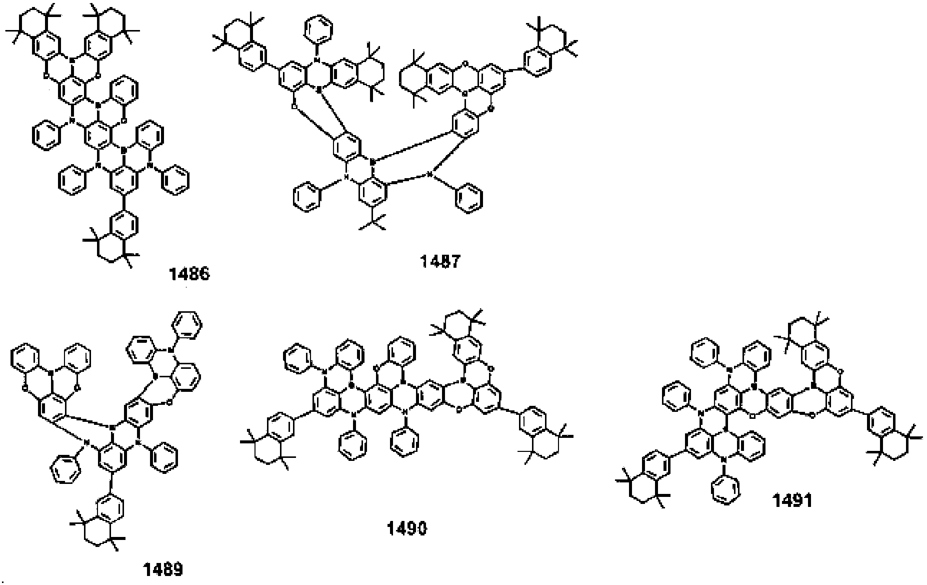 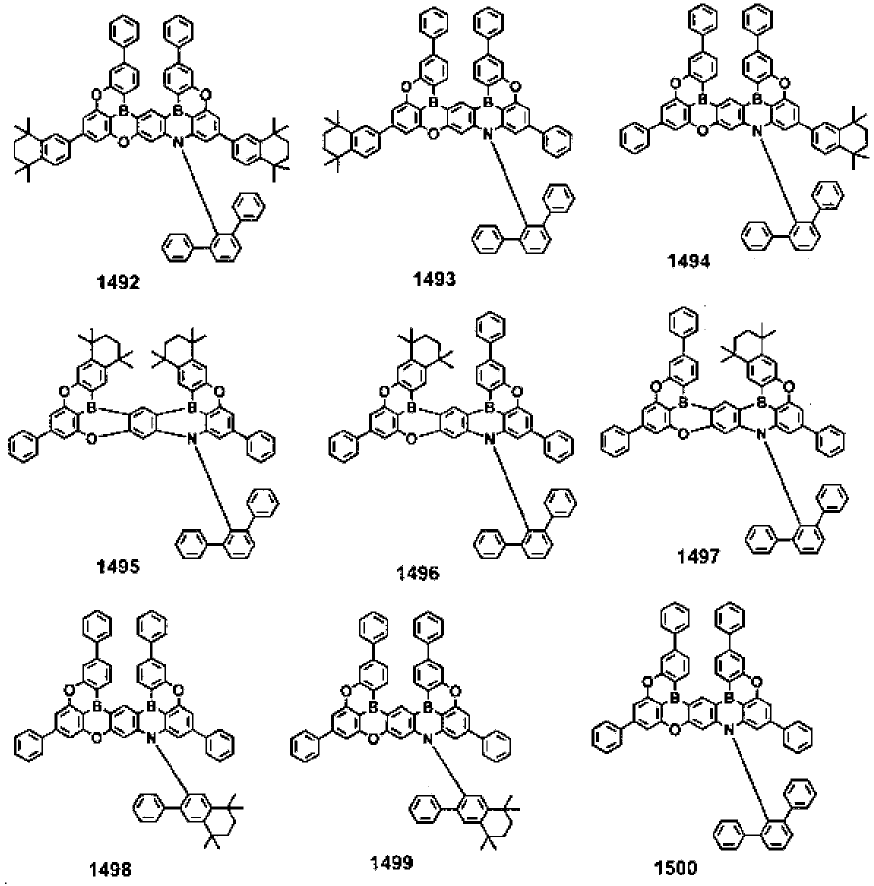 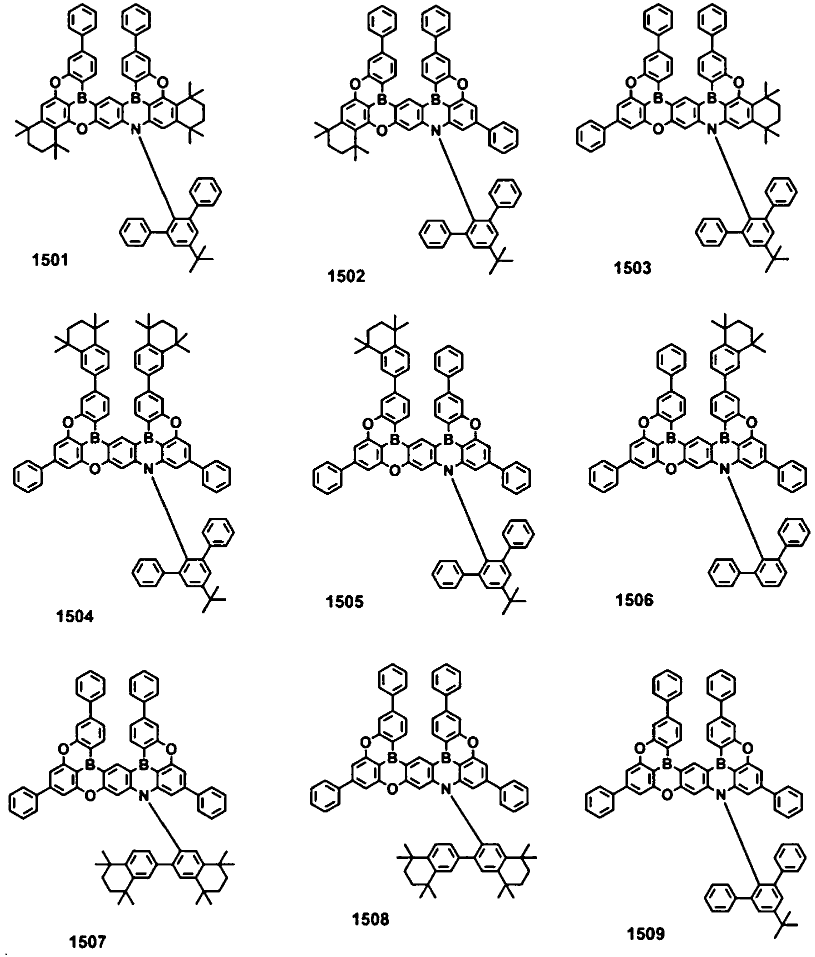 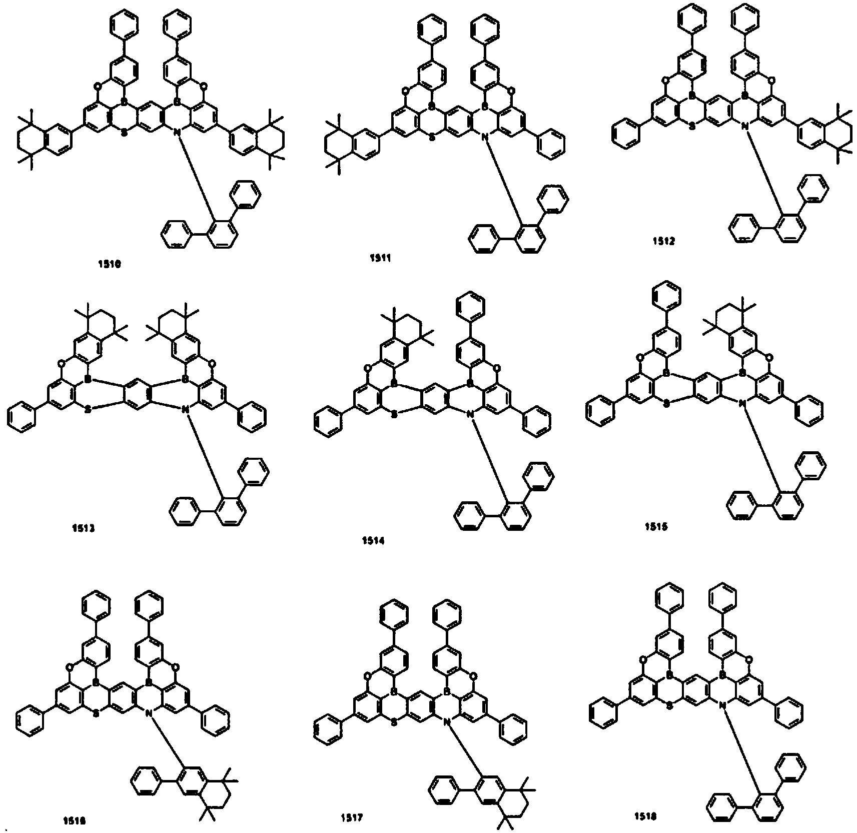 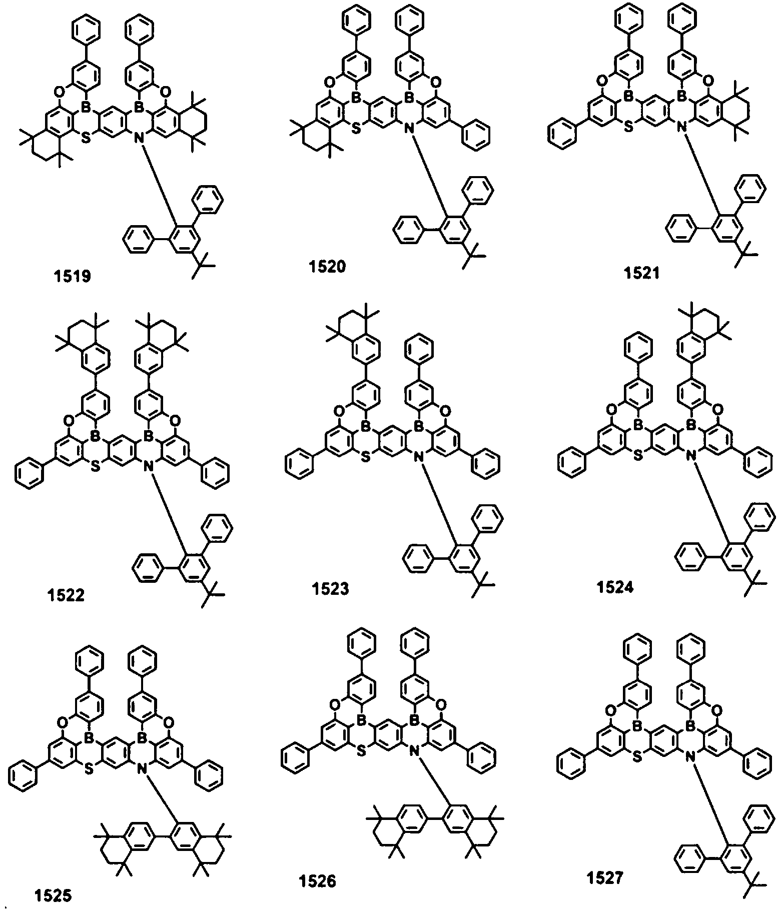 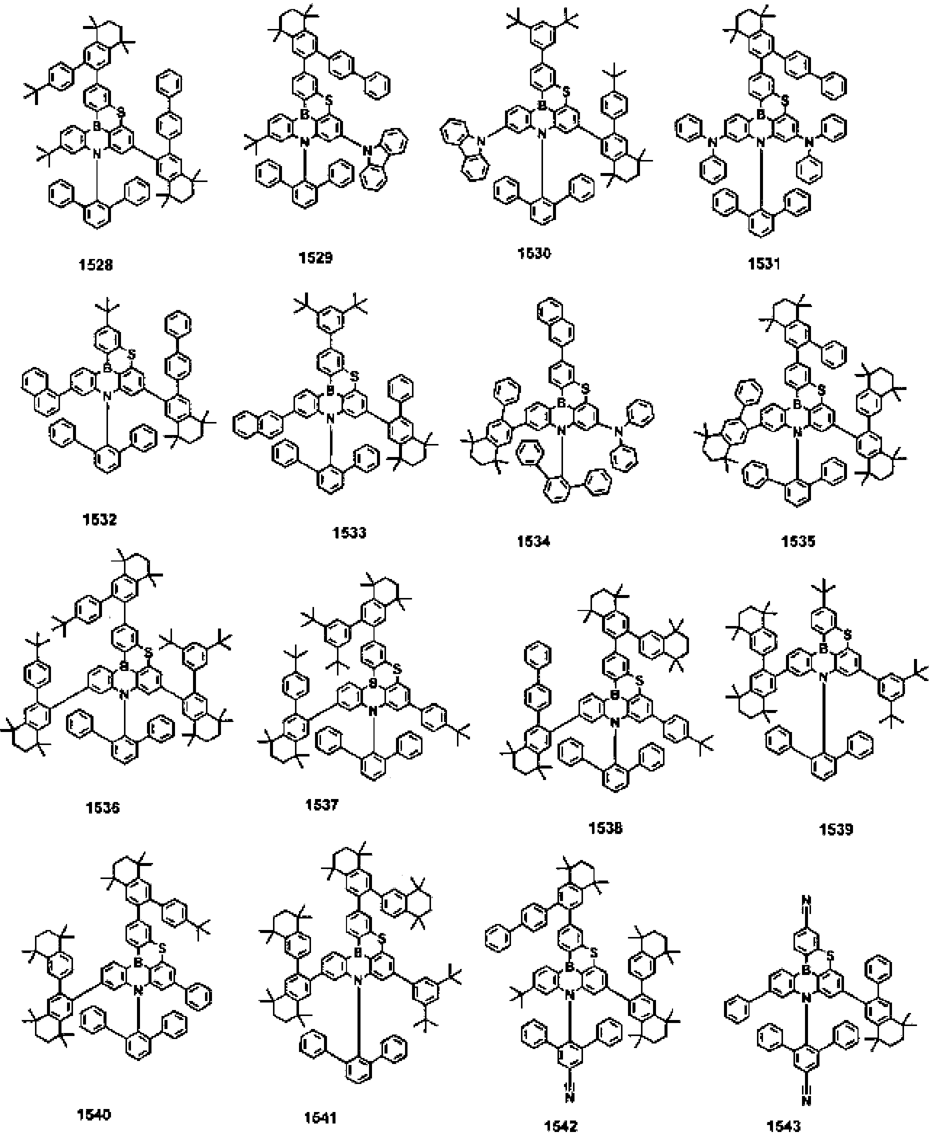 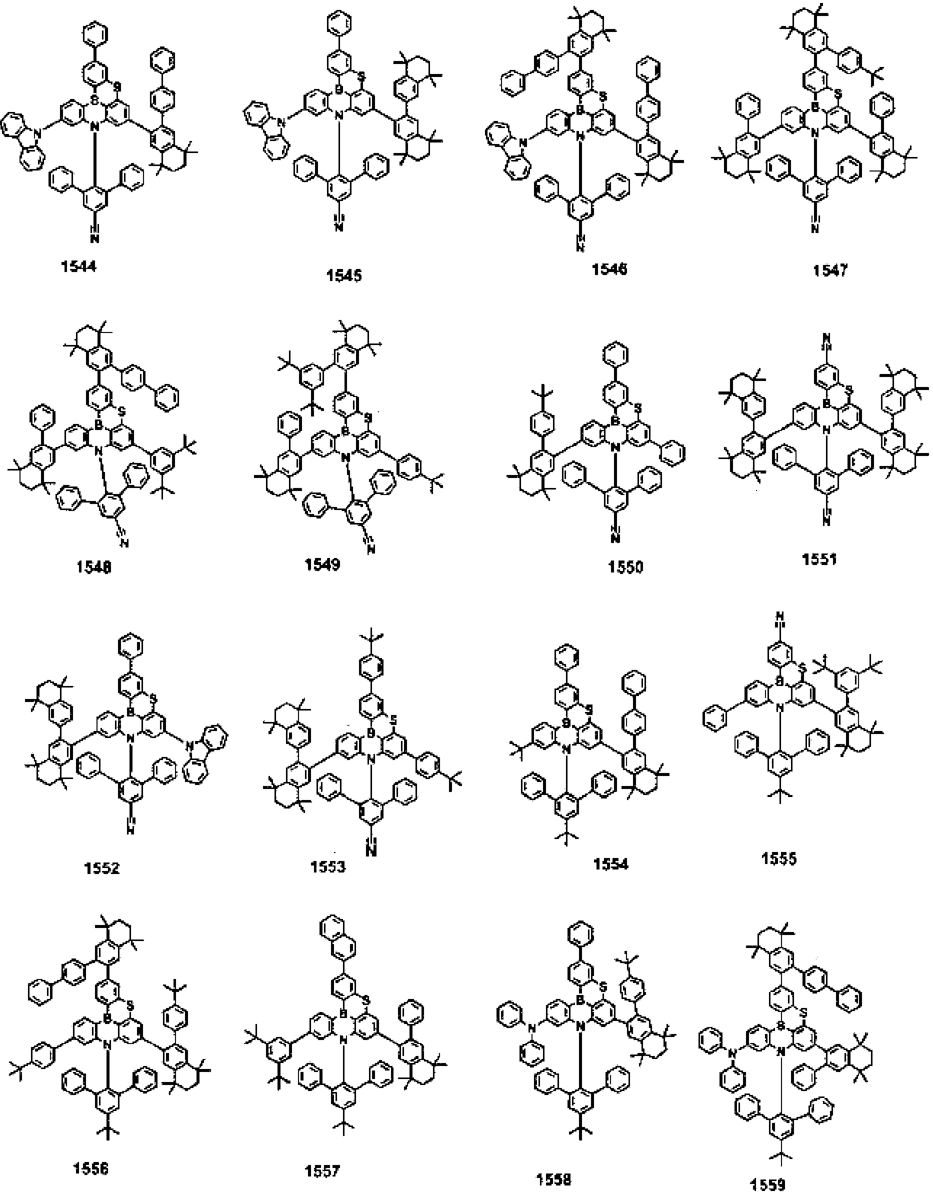 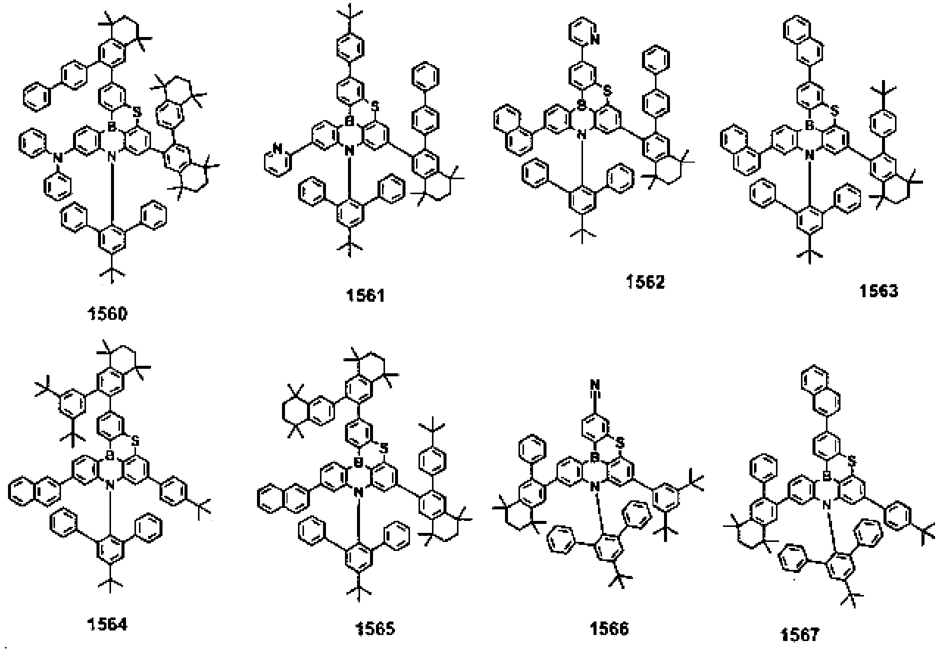 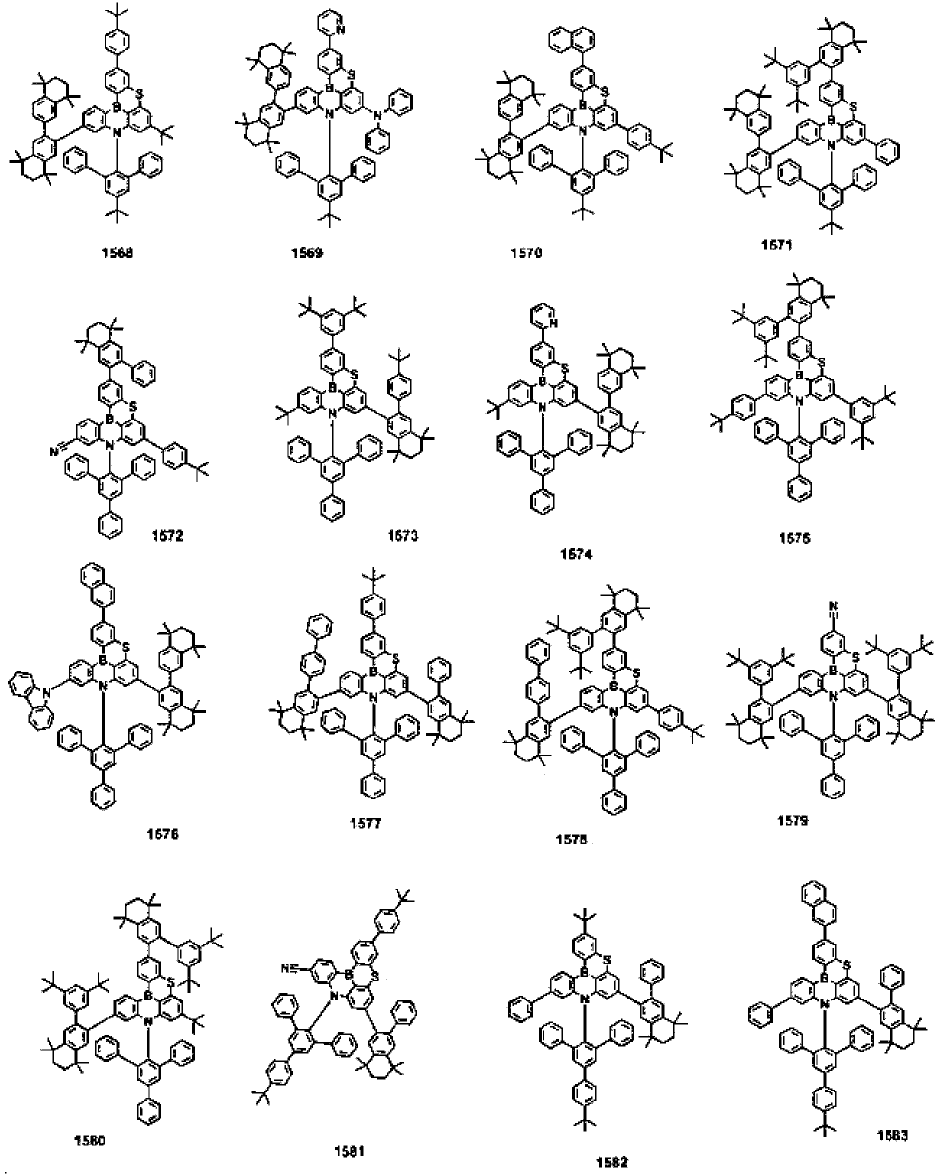 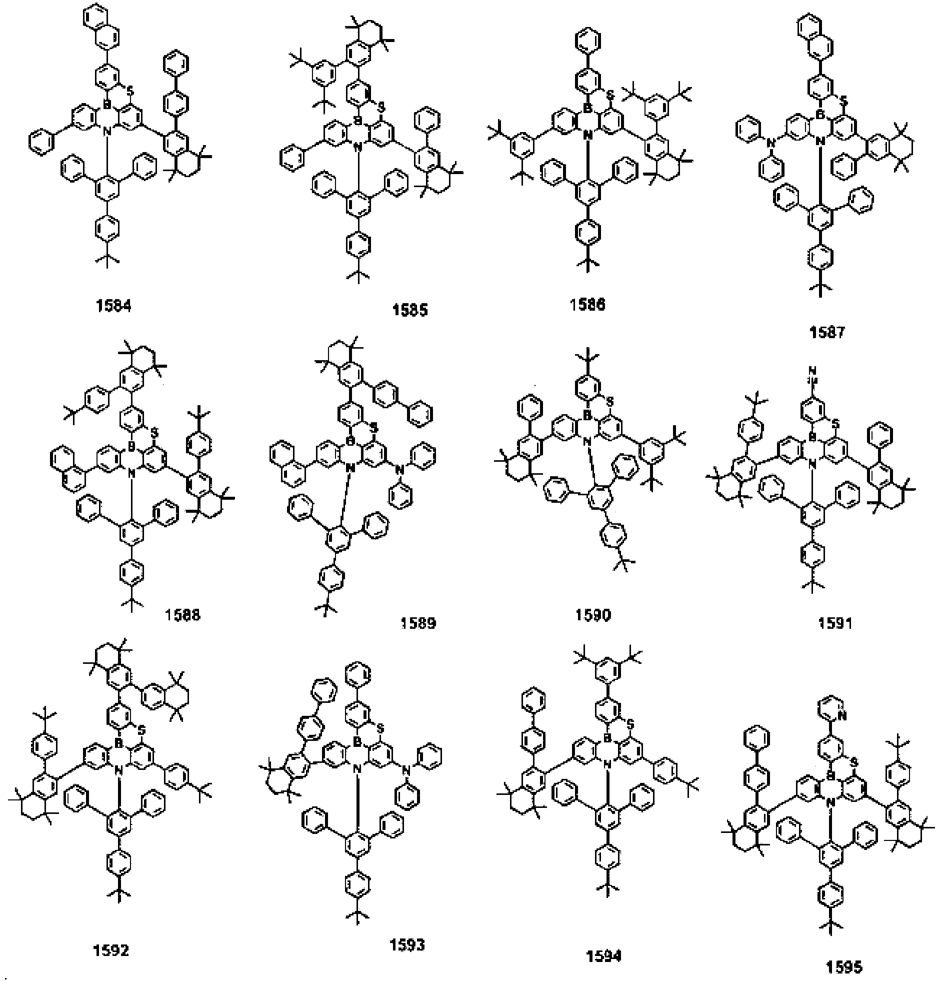 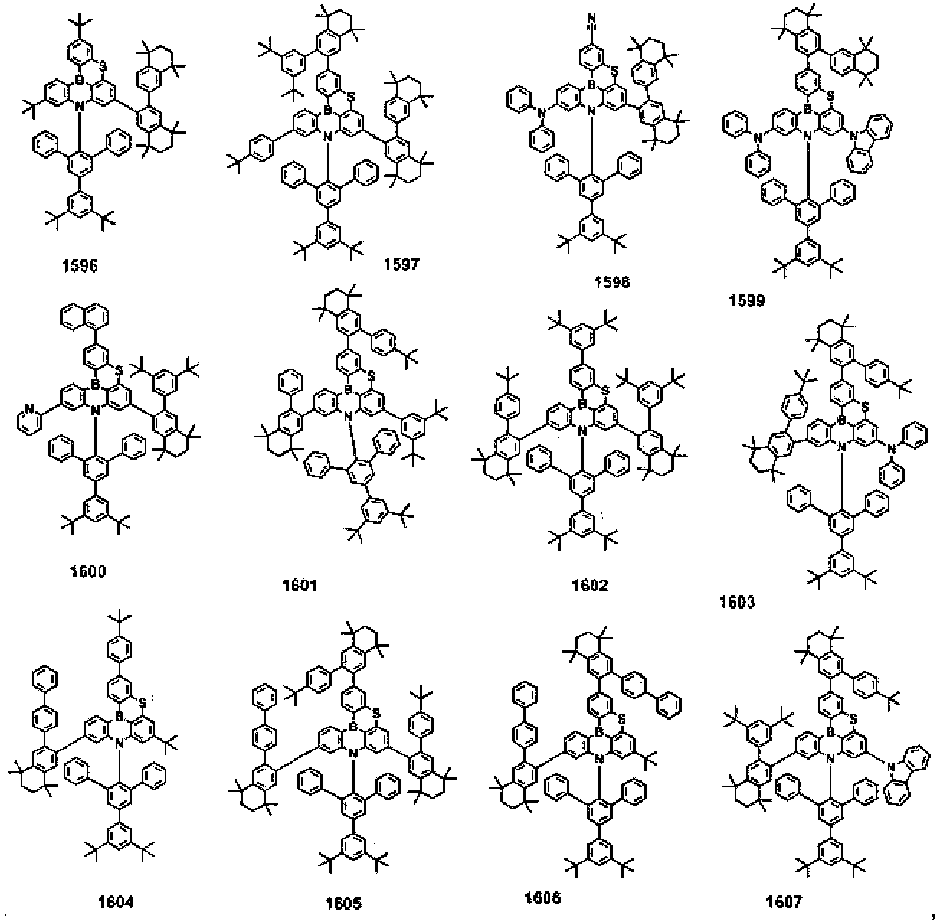 where, in Compound Group 1, D is a deuterium atom.

13. A light-emitting element (ED-1, ED-2, ED-3) comprising:
a first electrode (EL1);
a second electrode (EL2) on the first electrode (EL1); and
a light emitting layer (EML-R, EML-G, EML-B) between the first electrode (EL1) and the second electrode (EL2) and comprising a first compound, wherein the first compound is a polycyclic compound according to any one of claims 1 to 12.

14. The light-emitting element (ED-1, ED-2, ED-3) of claim 13, wherein:
(i) the light emitting layer (EML-R, EML-G, EML-B) further comprises at least one selected from among a second compound represented by Formula HT-1 and a third compound represented by Formula ET-1: 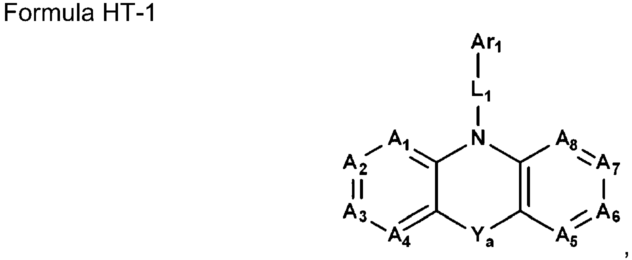 wherein, in Formula HT-1,
A₁ to A₈ are each independently N or CR₅₁,
L₁ is a direct linkage, a substituted or unsubstituted arylene group having 6 to 30 ring-forming carbon atoms, or a substituted or unsubstituted heteroarylene group having 2 to 30 ring-forming carbon atoms,
Yₐ is a direct linkage, CR₅₂R₅₃, or SiR₅₄R₅₅,
Ar₁ is a substituted or unsubstituted aryl group having 6 to 30 ring-forming carbon atoms or a substituted or unsubstituted heteroaryl group having 2 to 30 ring-forming carbon atoms, and
R₅₁ to R₅₅ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 ring-forming carbon atoms, a substituted or unsubstituted aryl group having 6 to 60 ring-forming carbon atoms, or a substituted or unsubstituted heteroaryl group having 2 to 60 ring-forming carbon atoms, or are bonded to an adjacent group to form a ring; and 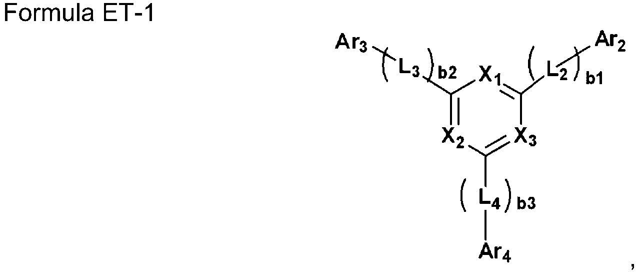
wherein, in Formula ET-1,
at least one selected from among X₁ to X₃ is N, and the others are CR₅₆,
R₅₆ is a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms,
b1 to b3 are each independently an integer of 0 to 10,
Ar₂ to Ar₄ are each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and
L₂ to L₄ are each independently a direct linkage, a substituted or unsubstituted arylene group having 6 to 30 ring-forming carbon atoms, or a substituted or unsubstituted heteroarylene group having 2 to 30 ring-forming carbon atoms; and/or
(ii) the light emitting layer (EML-R, EML-G, EML-B) further comprises a fourth compound represented by Formula D-1: 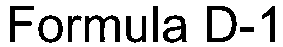 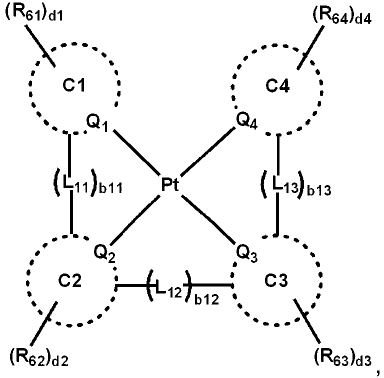 wherein, in Formula D-1,
Q₁ to Q₄ are each independently C or N,
C1 to C4 are each independently a substituted or unsubstituted hydrocarbon ring having 5 to 30 ring-forming carbon atoms or a substituted or unsubstituted heterocycle having 2 to 30 ring-forming carbon atoms,
L₁₁ to L₁₃ are each independently a direct linkage, *-O-*, *-S-*, 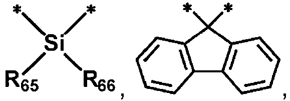 a substituted or unsubstituted alkylene group having 1 to 20 carbon atoms, a substituted or unsubstituted arylene group having 6 to 30 ring-forming carbon atoms, or a substituted or unsubstituted heteroarylene group having 2 to 30 ring-forming carbon atoms,
b11 to b13 are each independently 0 or 1,
R₆₁ to R₆₆ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 ring-forming carbon atoms, a substituted or unsubstituted aryl group having 6 to 60 ring-forming carbon atoms, or a substituted or unsubstituted heteroaryl group having 2 to 60 ring-forming carbon atoms, and
d1 to d4 are each independently an integer of 0 to 4; and/or
(iii) the light emitting layer (EML-R, EML-G, EML-B) emits delayed fluorescence; and/or
(iv) the light emitting layer (EML-R, EML-G, EML-B) emits blue light.

15. An electronic apparatus (EA) comprising a display module (DM) comprising a plurality of light-emitting elements (ED-1, ED-2, ED-3),
wherein at least one selected from among the plurality of light-emitting elements (ED-1, ED-2, ED-3) comprises a first electrode (EL1), a second electrode (EL2) on the first electrode (EL1), and a light emitting layer (EML-R, EML-G, EML-B) between the first electrode (EL1) and the second electrode (EL2) and comprising a polycyclic compound according to any one of claims 1 to 12;
optionally wherein the electronic apparatus (EA) further comprises at least one selected from among a processor (PR), a memory (MR), and a power module (PM).
